# EUROPEAN PATENT SPECIFICATION

(11) **EP 4 467 554 B1**
(45) Date of publication and mention of the grant of the patent: **15.07.2026**
(21) Application number: 24167775.6
(22) Date of filing: 28.03.2024
(51) Int. Cl.: C07F 15/00, C09K 11/06, H10K 50/11, C07B 59/00, H10K 85/30

(54) **FLUORINATED TETRADENTATE PLATINUM (II) COMPLEX, ELECTRONIC DEVICE, EQUIPMENT AND APPLICATION THEREOF**
FLUORIERTER VIERZÄHNIGER PLATIN(II)-KOMPLEX, ELEKTRONISCHE VORRICHTUNG, AUSRÜSTUNG UND ANWENDUNG DAVON
COMPLEXE DE PLATINE TÉTRADENTATE (II) FLUORÉ, DISPOSITIF ÉLECTRONIQUE, ÉQUIPEMENT ET APPLICATION ASSOCIÉS

(30) Priority: 23.05.2023 CN 202310601853
(43) Date of publication of application: 27.11.2024
(73) Proprietor: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, 310014 (CN); CHU, Qingshan, Hangzhou, 310014 (CN); SHE, Yuanbin, Hangzhou, 310014 (CN); GAO, Chunji, Hangzhou, 310014 (CN)
(74) Representative: Barker Brettell LLP

(56) References cited:
- US-A1- 2023 139 906

## Description

### FIELD OF THE INVENTION

The present application belongs to the field of organic electroluminescence and specifically relates to a fluorinated tetradentate platinum (II) complex, an electronic device, an equipment and application of the fluorinated tetradentate platinum (II) complex.

### BACKGROUND OF THE INVENTION

Organic light-emitting diode (OLED) is a new generation of full-color display and lighting technology. Compared with LCD displays which have the drawbacks such as slow response speed, small viewing angle, need for backlight, and high energy consumption, etc., OLED, as an autonomous light-emitting device, does not require backlight and is energy-saving, and its driving voltage is low, response speed is fast, resolution and contrast are high, viewing angle is wide, and low-temperature performance is outstanding; OLED devices can be made thinner and can be made into flexible structures. In addition, it also has the advantages of low production cost, simple production process, and the ability to carry out large-scale production, etc. Therefore, OLED has broad and enormous application prospects in high-end electronic products and aerospace. With the gradual increase of investment, further deepening of research and development, and upgrading of production equipment, OLEDs have a very wide range of application scenarios and development prospects in the future.

The development core of OLED is the design and development of luminescent materials. In current applied OLED devices, almost all of the light-emitting layers use the host-guest light-emitting system mechanism, that is, doping the guest light-emitting material in the host material, the energy system of the host material is generally greater than that of the guest light-emitting material, which transfers energy from the host material to the guest material, causing the guest material to be excited and emit light. The commonly used organic phosphorescent guest materials are generally heavy metal atoms such as iridium (III), platinum (II), Pd (II), etc. The commonly used phosphorescent organic materials mCBP (3, 3'-bis(9-carbazolyl)-biphenyl) and 2,6-mCPy (2,6-bis(9-carbazolyl)-pyridine) have high efficiency and high triplet energy levels. When used as organic materials, the triplet energy can be effectively transferred from the luminescent organic material to the guest phosphorescent material. However, due to the easy hole transport and difficult electron flow characteristics of mCBP, and the poor hole transport of 2,6-mCPy, the charge imbalance of the luminescent layer is caused, resulting in a decrease in the current efficiency of the device. Moreover, the currently used heavy metal phosphorescent organic complex molecules are cyclic metal iridium (III) complex molecules, and the quantity is limited. The content of platinum element in the crust and the annual production worldwide are about ten times of that of metal iridium element. The price of IrCl₃·H₂O used for preparing iridium (III) complex phosphorescent materials is also much higher than that of PtCl₂ used for preparing platinum (II) complex phosphorescent materials. In addition, the preparation of iridium (III) complex phosphorescent materials involves four steps: iridium (III) dimer, iridium (III) intermediate ligand exchange, synthesis of mer-iridium (III) complex, and *mer-* to *fac-* iridium (III) complex isomer conversion, which greatly reduces the overall yield, greatly reduces the utilization rate of the raw material IrCl₃·H₂O, and increases the preparation cost of iridium (III) complex phosphorescent materials. In contrast, the preparation of platinum (II) complex phosphorescent materials only involves the final step of ligand metallization design platinum salt reaction, resulting in high utilization of platinum elements, which can further reduce the preparation cost of platinum (II) complex phosphorescent materials. In summary, the preparation cost of platinum (II) complex phosphorescent materials is much lower than that of iridium (III) complex phosphorescent materials. However, there are still some technical difficulties in the development of platinum complex materials and devices, and how to improve device efficiency and lifespan is an important research issue. Therefore, there is an urgent need to develop new phosphorescent metal platinum (II) complexes.

US 2023/139906 discloses embodiments related to an organometallic compound and a light-emitting device including the organometallic compound.

### SUMMARY OF THE INVENTION

The purpose of the present application is to provide a fluorinated tetradentate platinum (II) complex, an electronic device, an equipment, and application of the fluorinated tetradentate platinum (II) complex. The fluorinated tetradentate platinum (II) complex of the present application as the guest phosphorescent material of the luminescent layer can enable the device to have excellent performance. Furthermore, combining it with specific host materials can improve the current efficiency of electronic devices, especially organic electroluminescent devices, improve device lifespan, and also reduce the operating voltage of the elements and devices.

The scope of the invention is defined by the claims. The present application provides a fluorinated tetradentate platinum (II) complex, which has a structure as shown in Formula (I) or Formula (II):

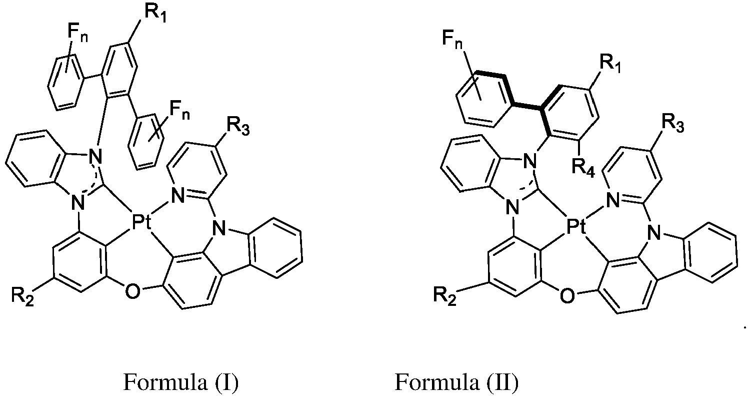

In Formula (I) or Formula (II), Fₙ represents one or more F substitutions on the benzene ring where it is (they are) located, where n is a positive integer from 1 to 5;
R₁, R₂, R₃, and R₄ are each independently selected from the group consisting of hydrogen, deuterium, a C1-C30 alkyl, a C1-C30 cycloalkyl, a C6-C60 aryl, a C1-C30 heterocycloalkyl, a C6-C18 arylamine group and a C6-C18 heterocyclic amine group.

The invention further provides a fluorinated tetradentate platinum (II) complex, wherein the fluorinated tetradentate platinum (II) complex has any one of the following chemical structures, where "D" represents deuterium:

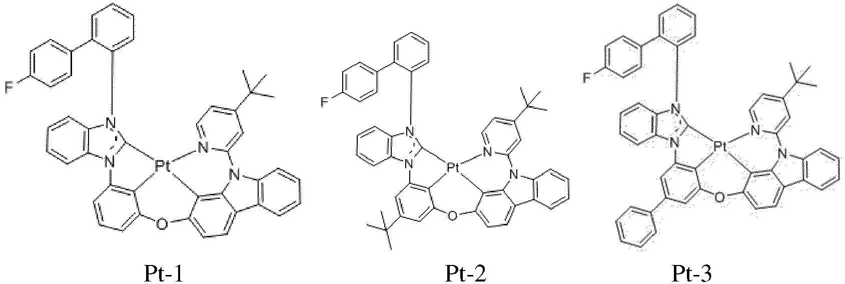

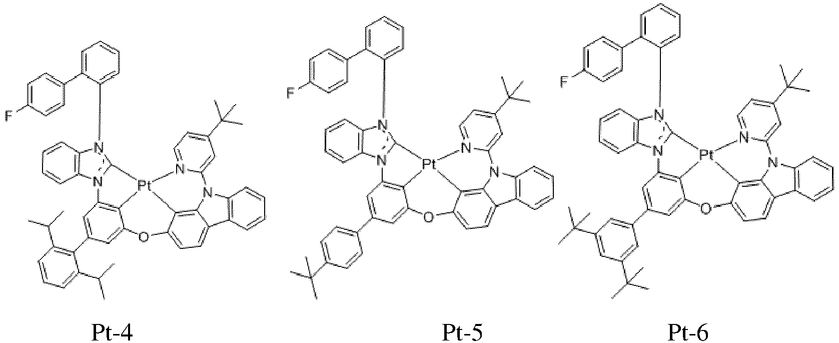

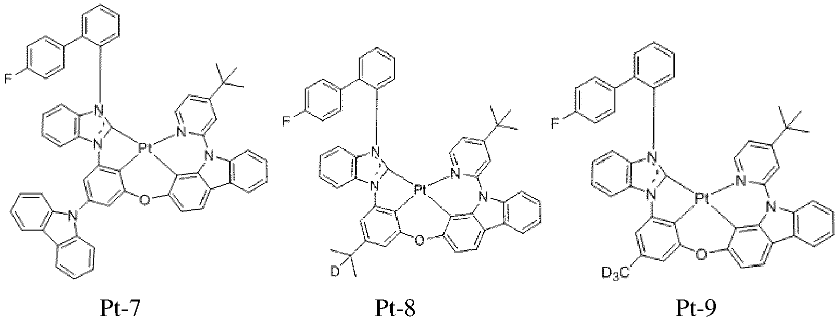

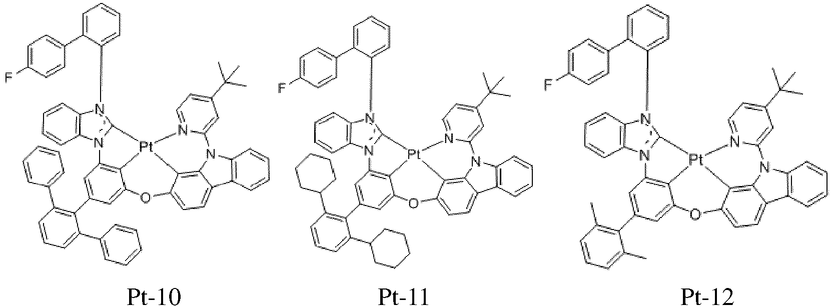

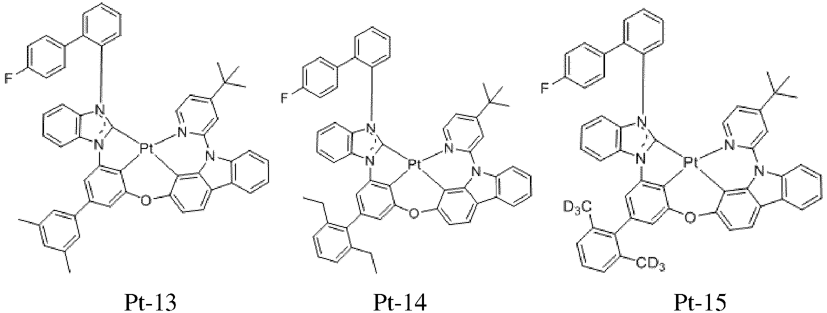

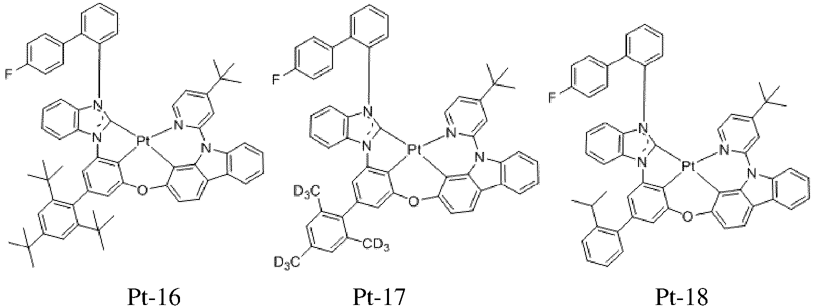

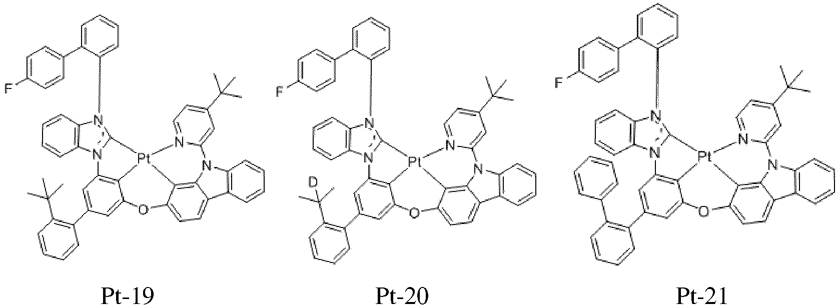

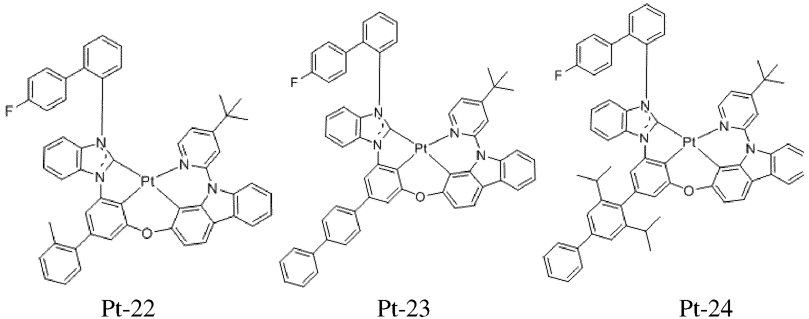

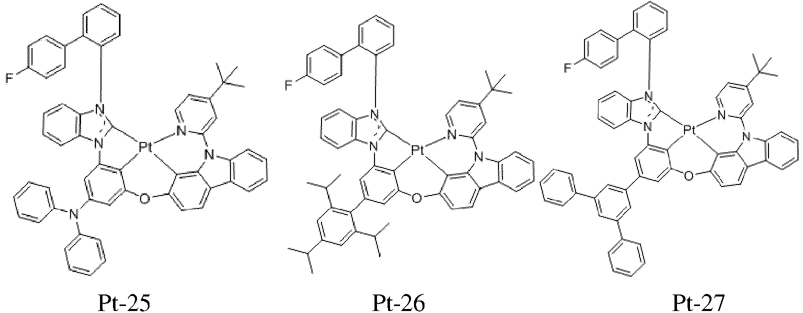

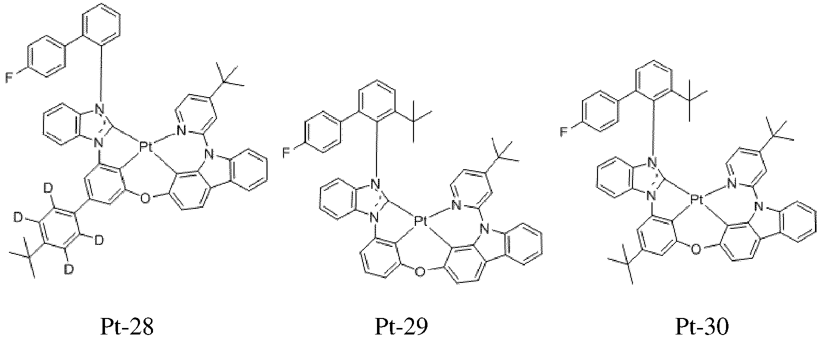

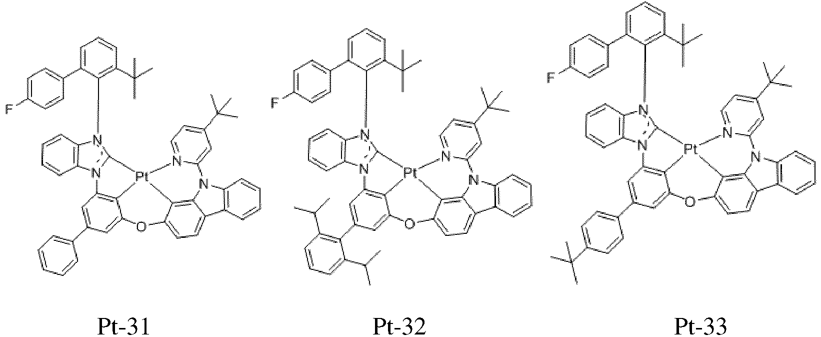

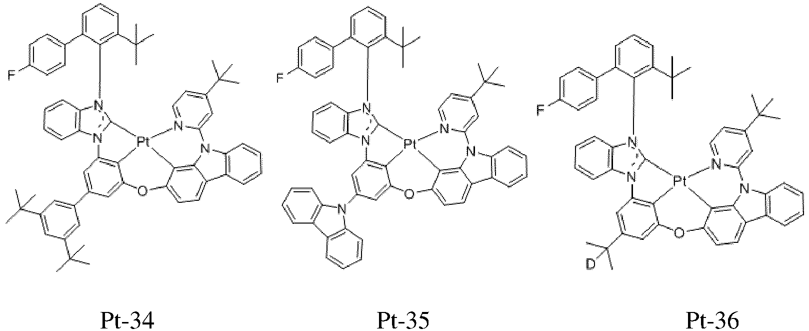

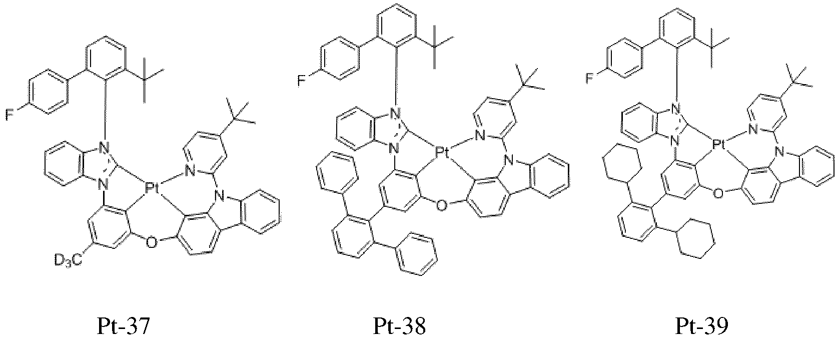

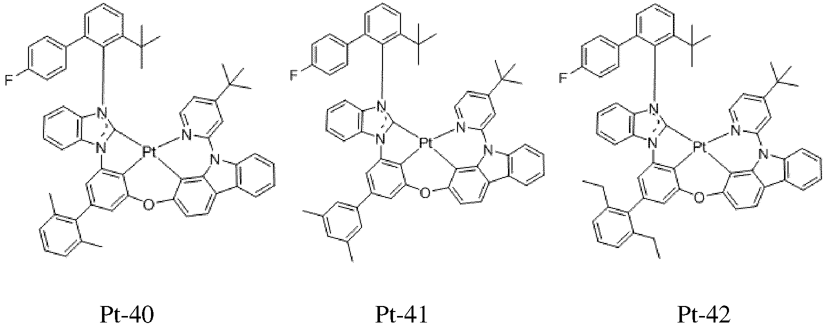

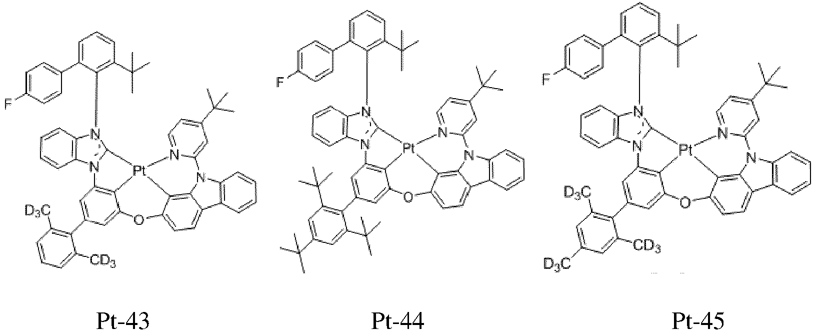

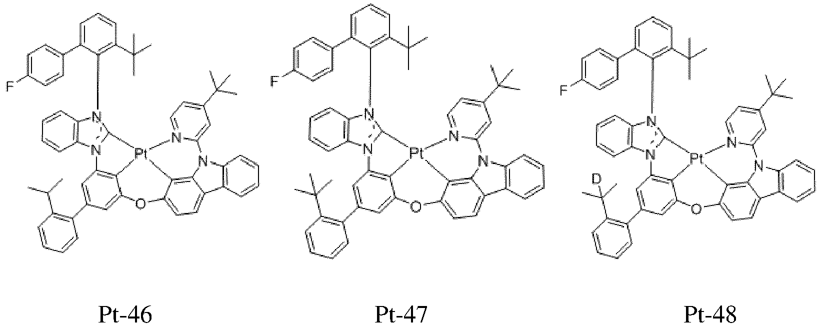

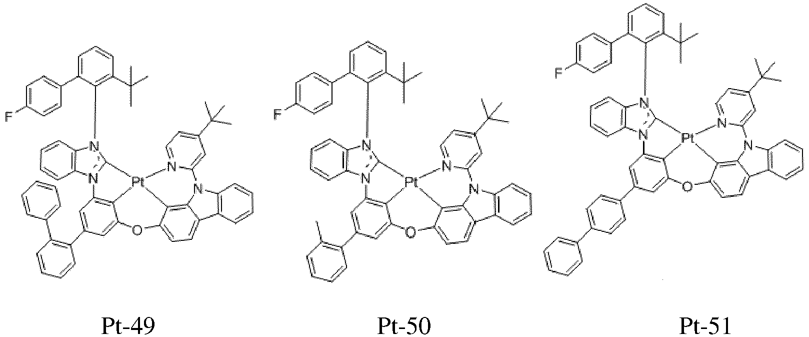

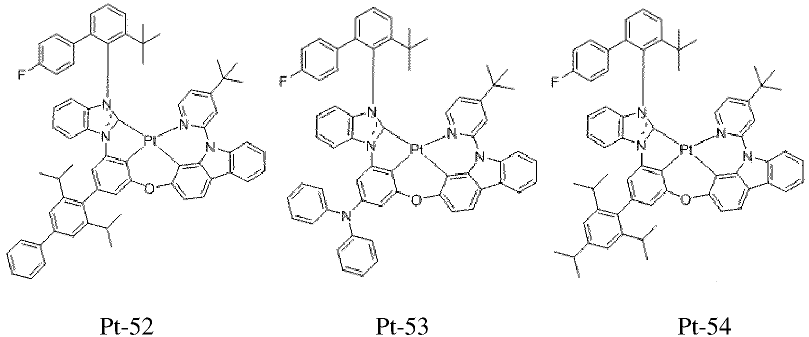

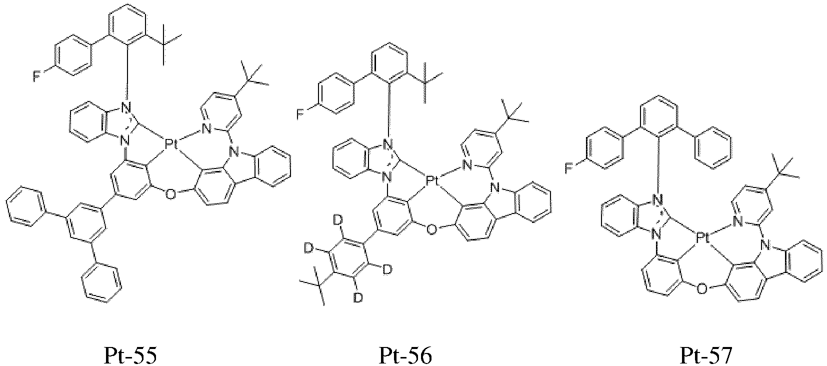

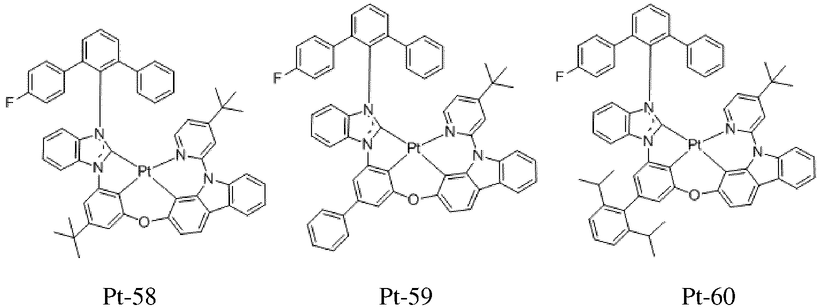

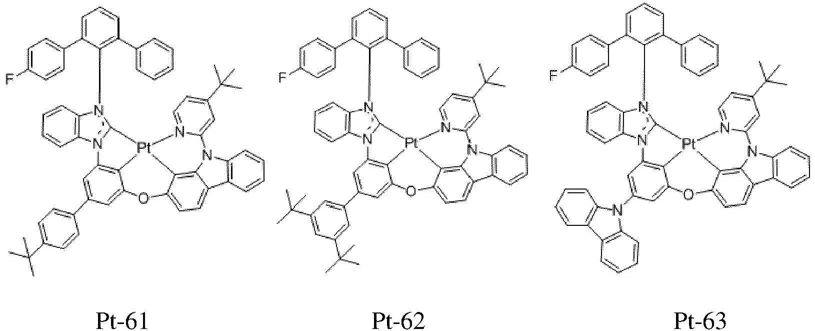

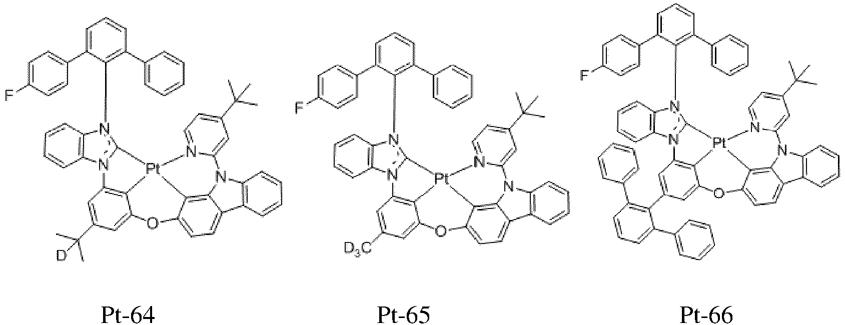

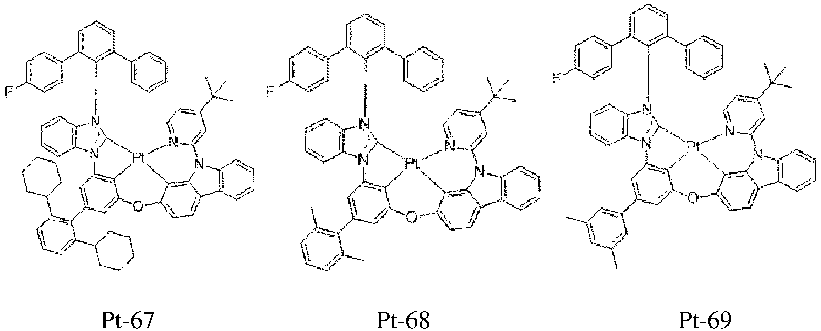

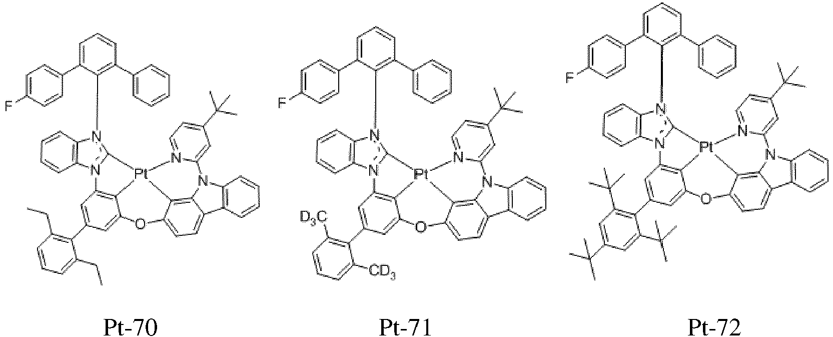

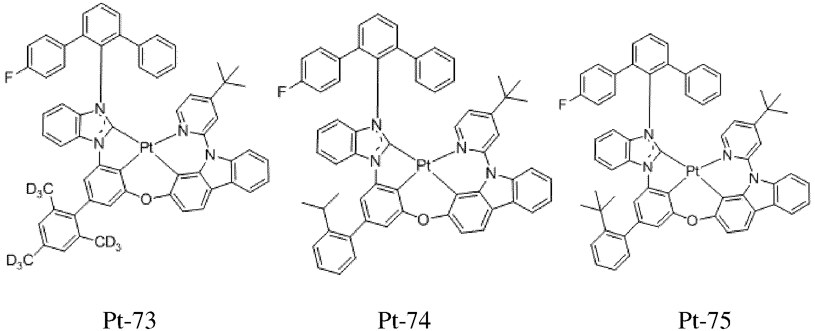

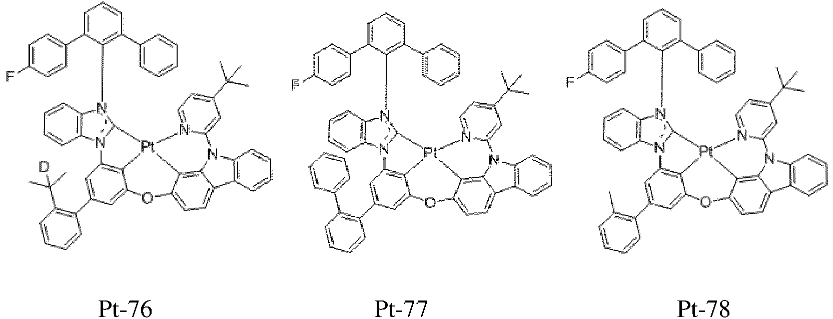

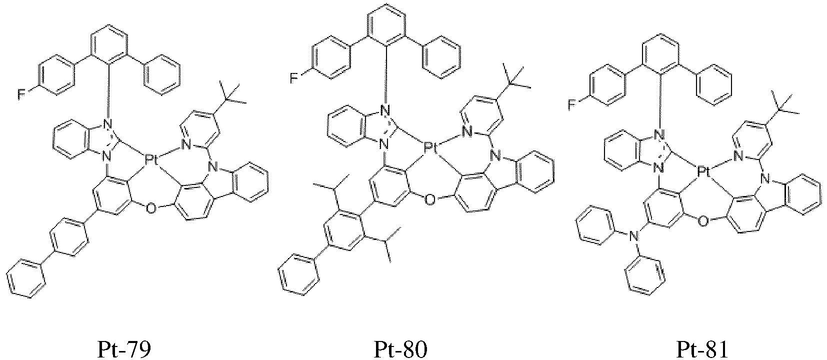

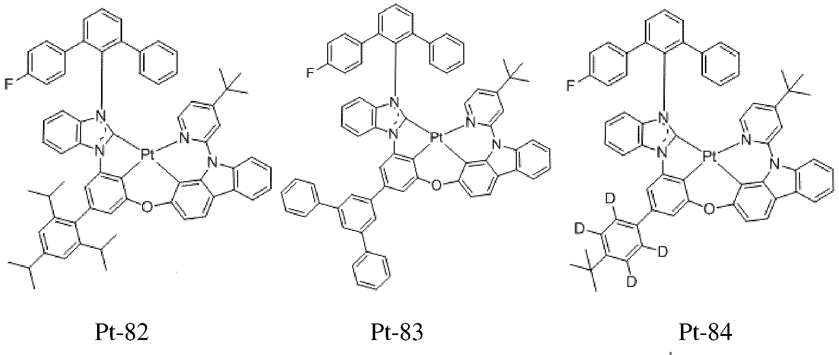

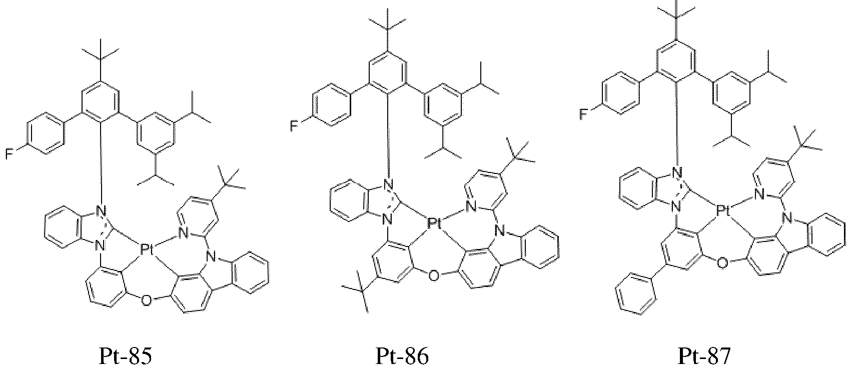

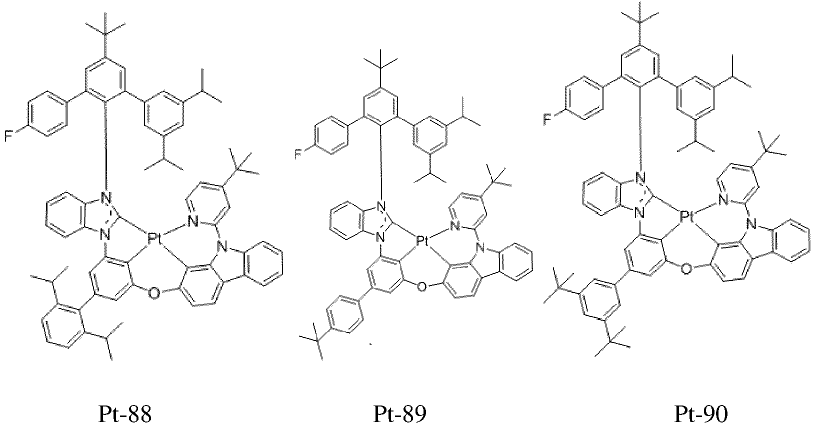

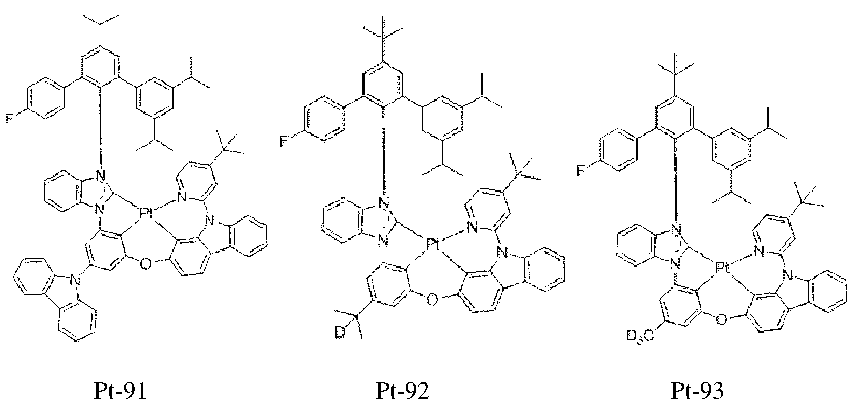

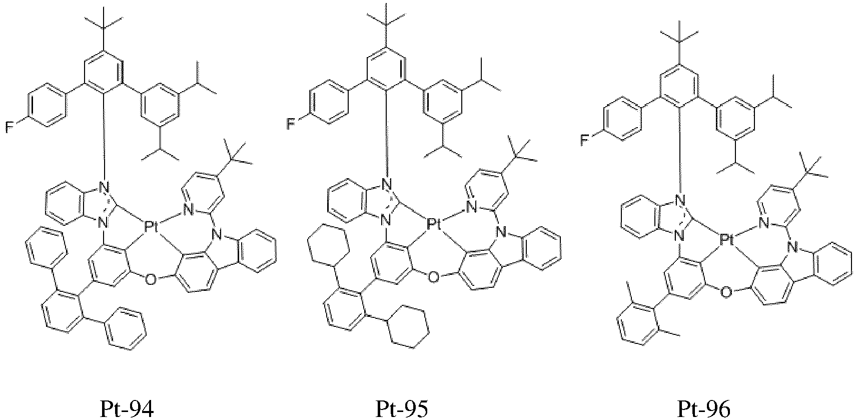

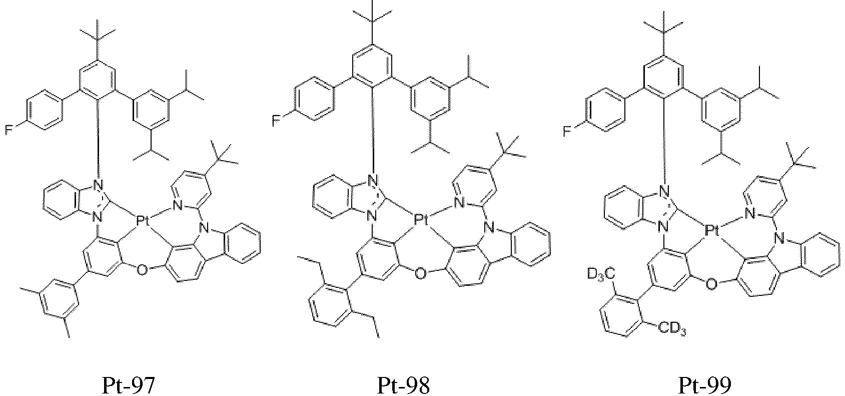

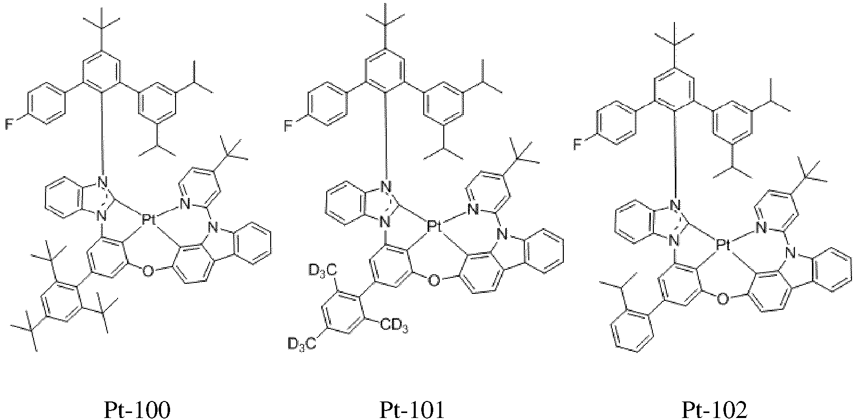

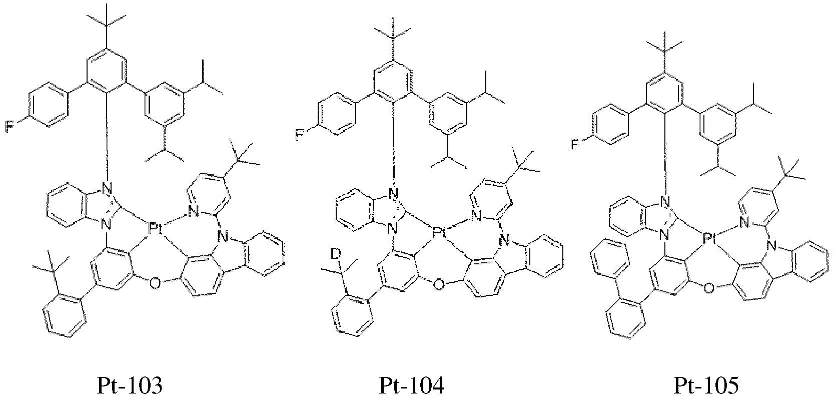

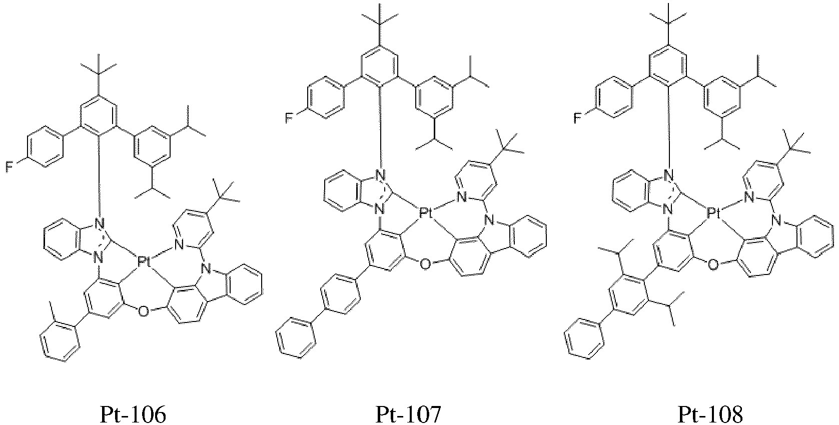

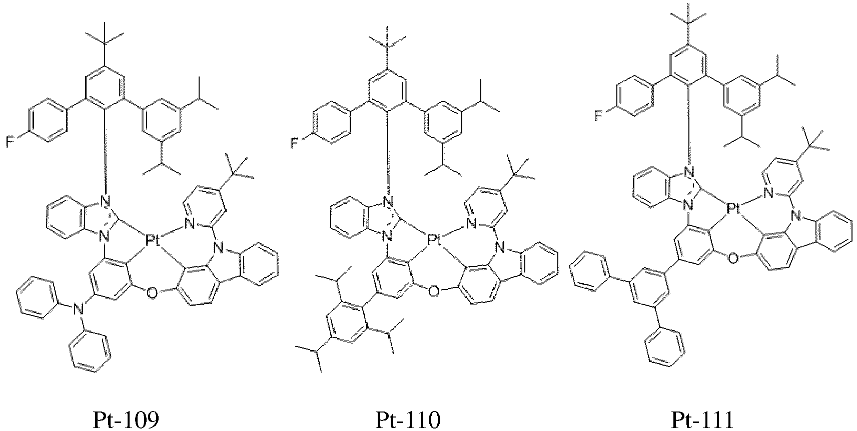

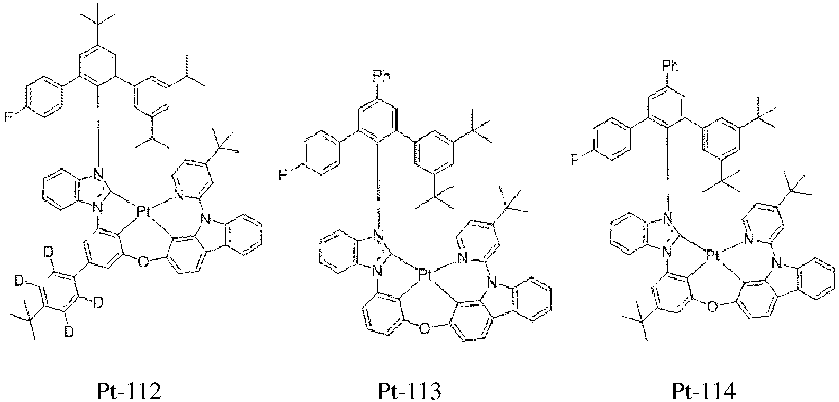

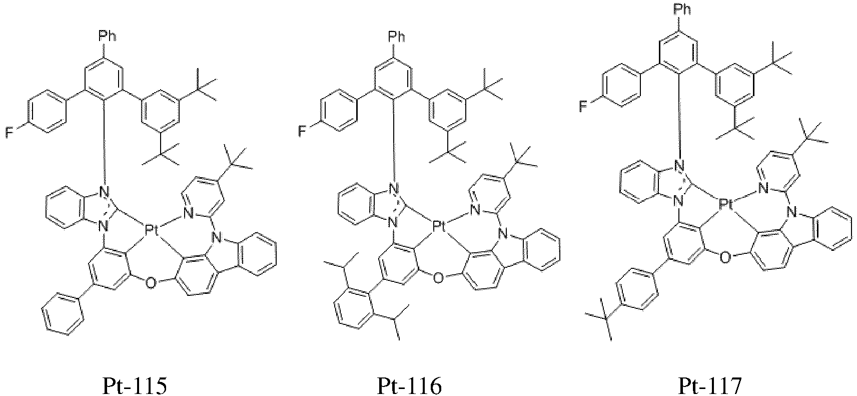

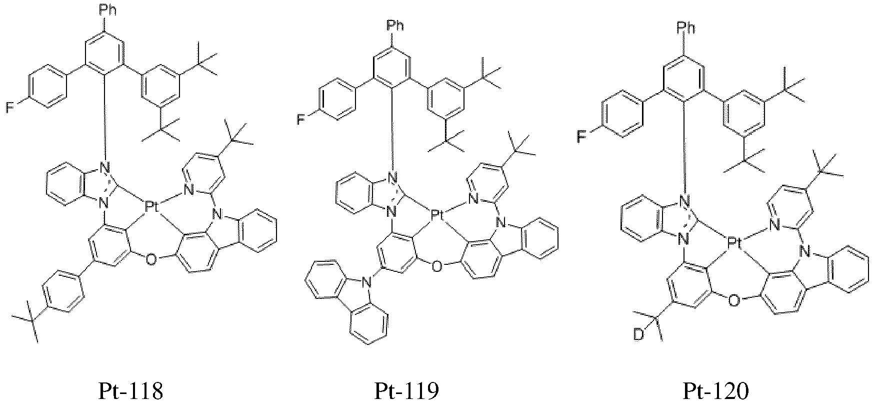

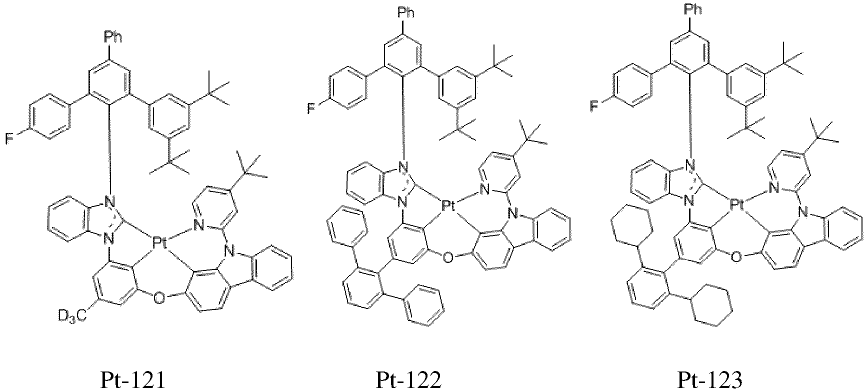

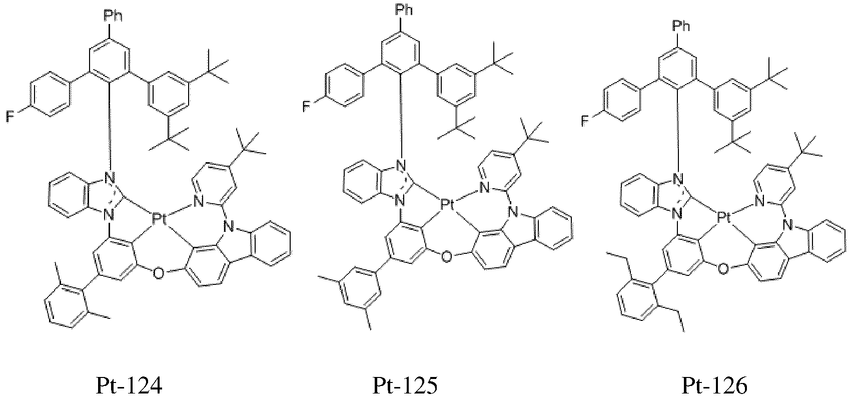

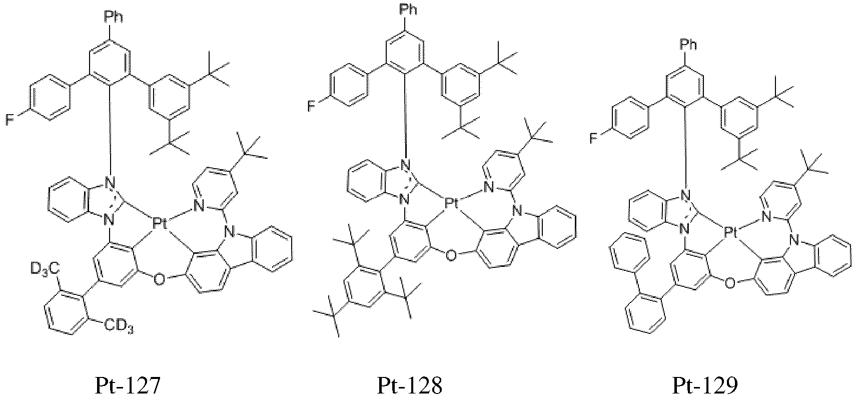

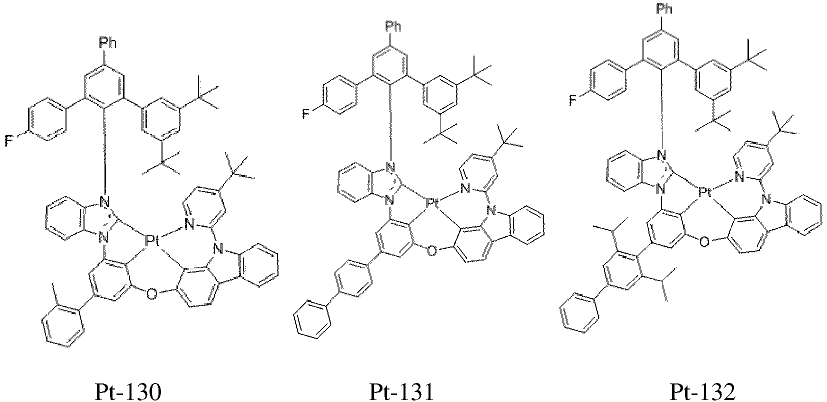

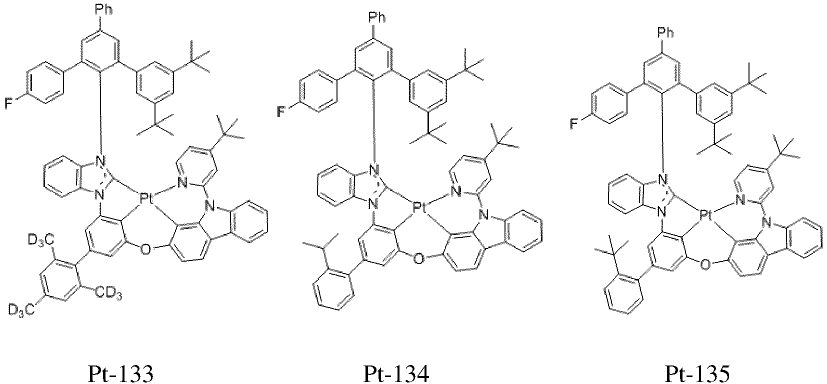

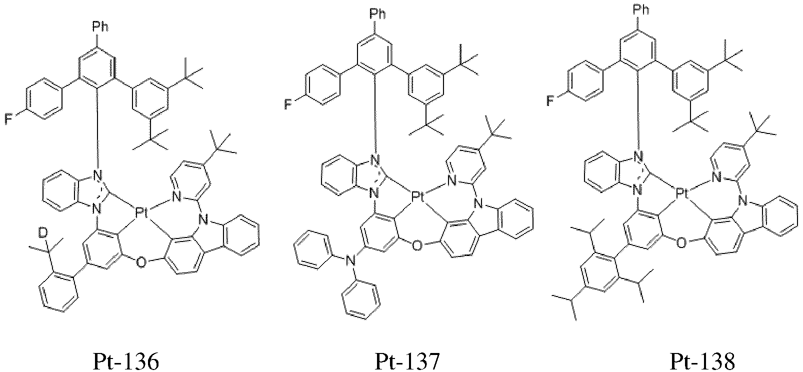

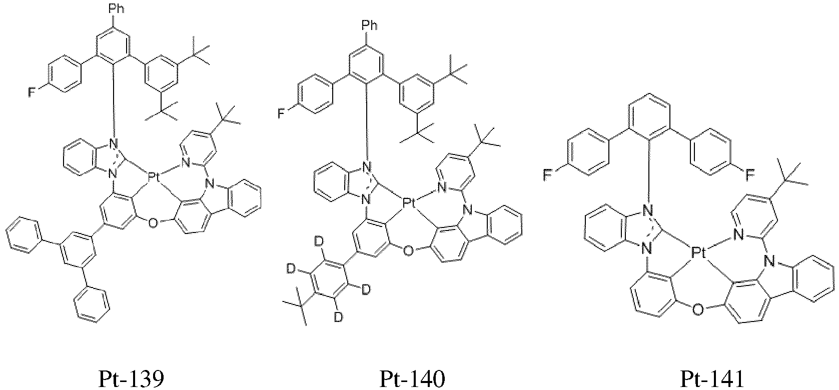

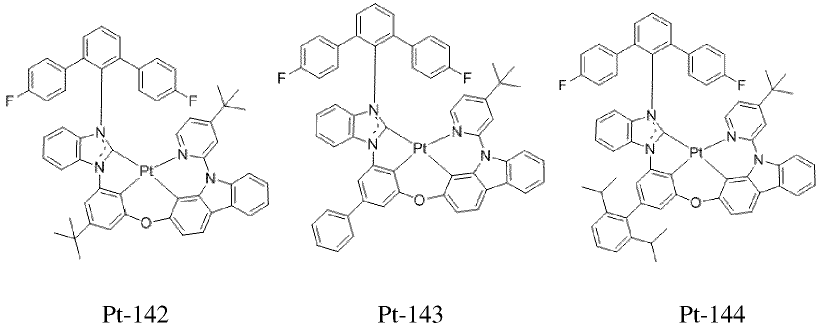

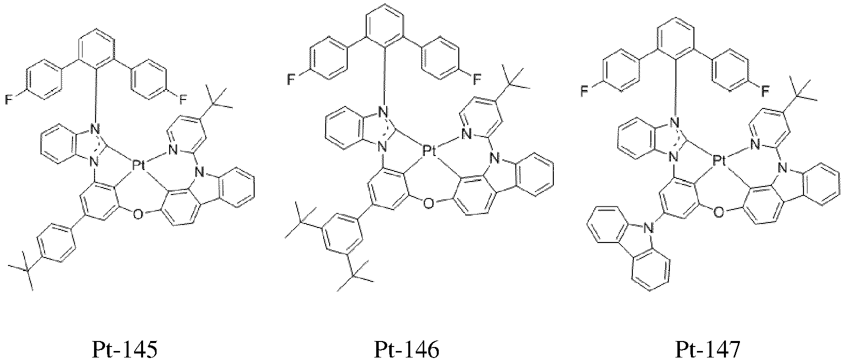

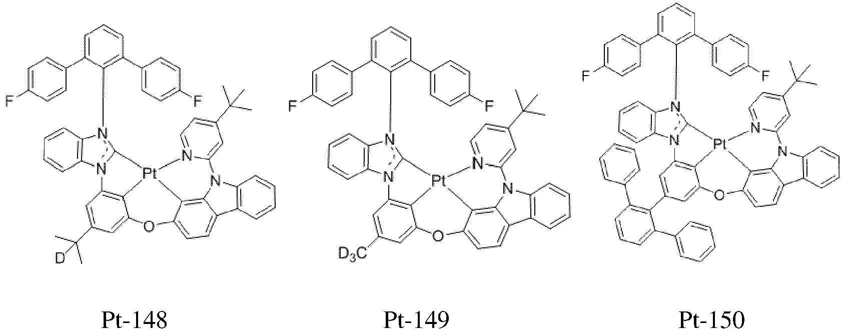

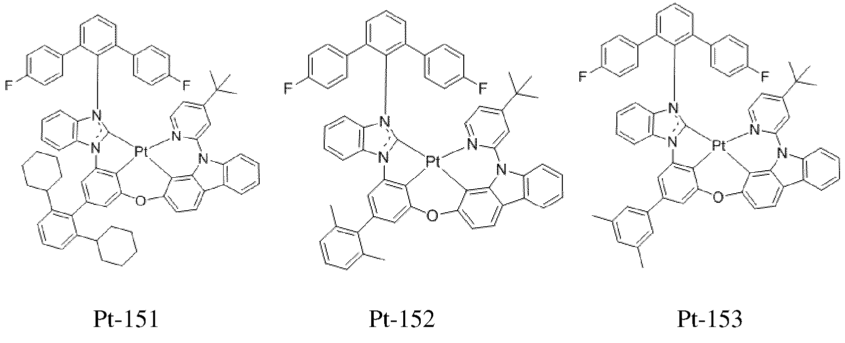

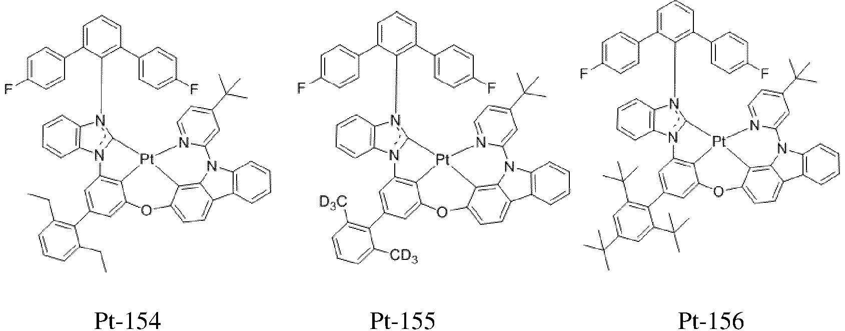

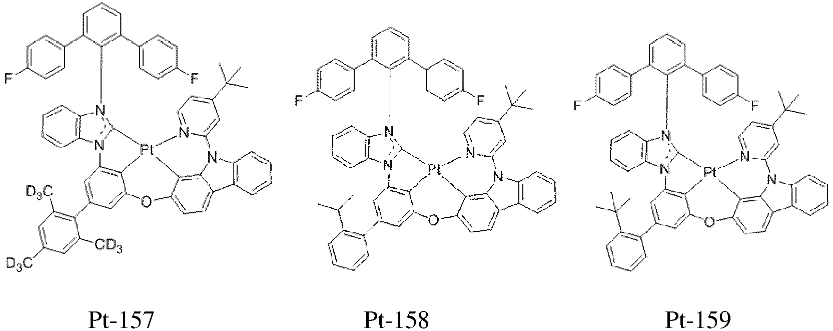

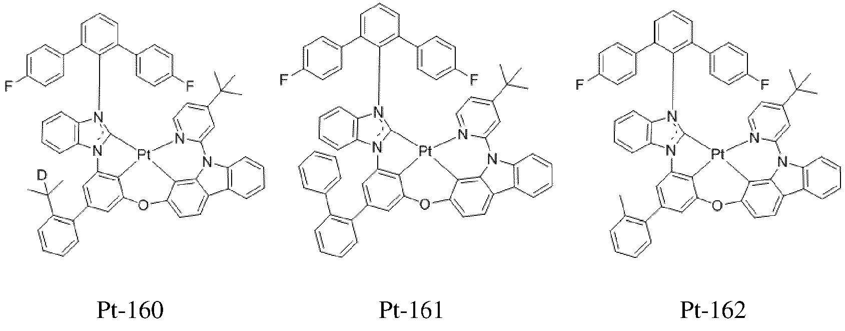

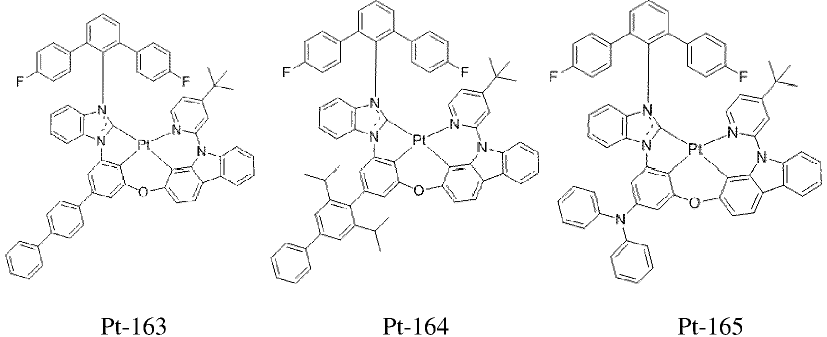

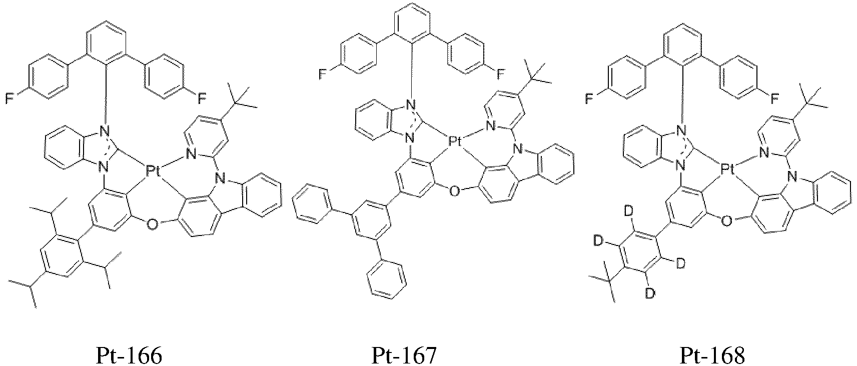

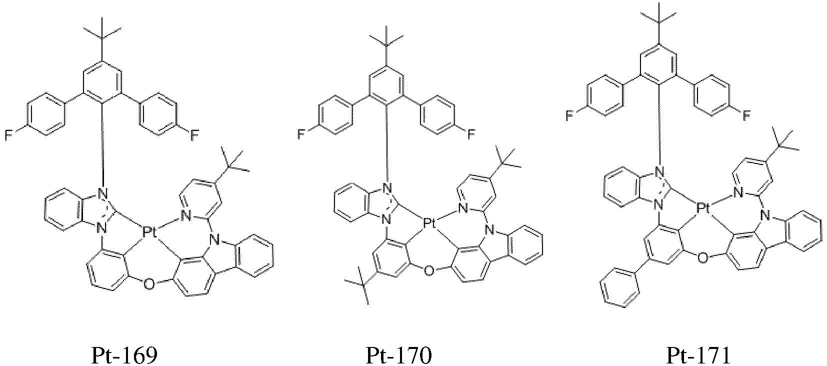

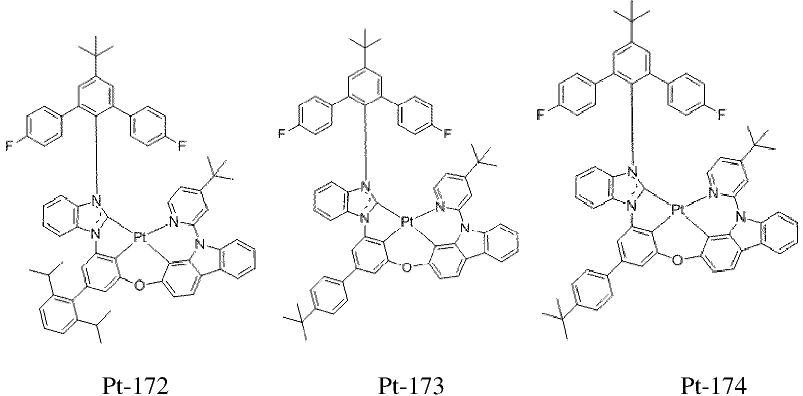

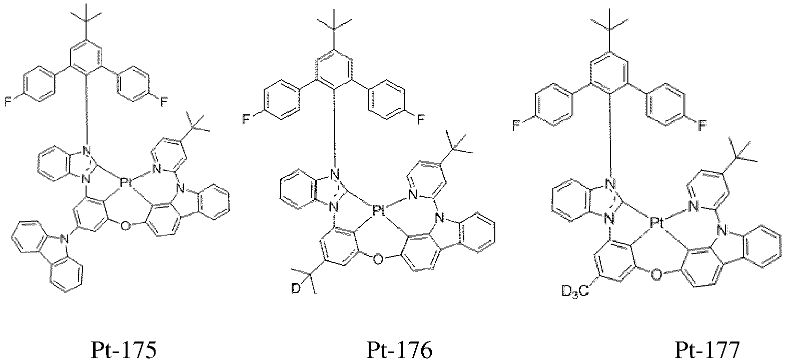

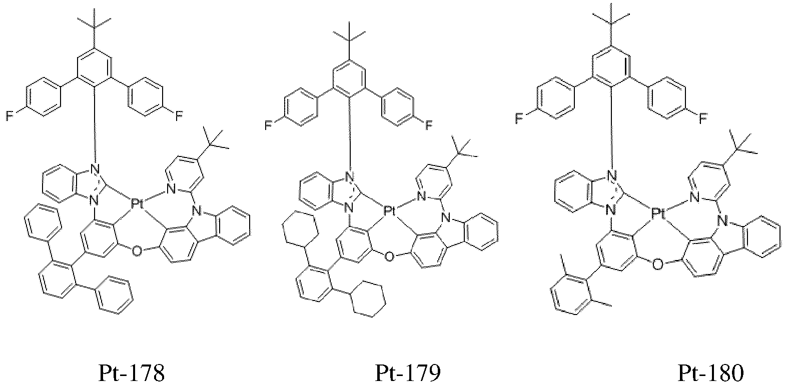

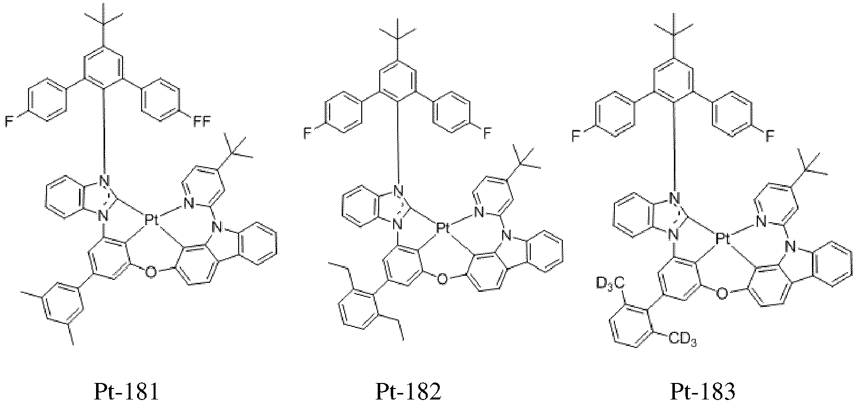

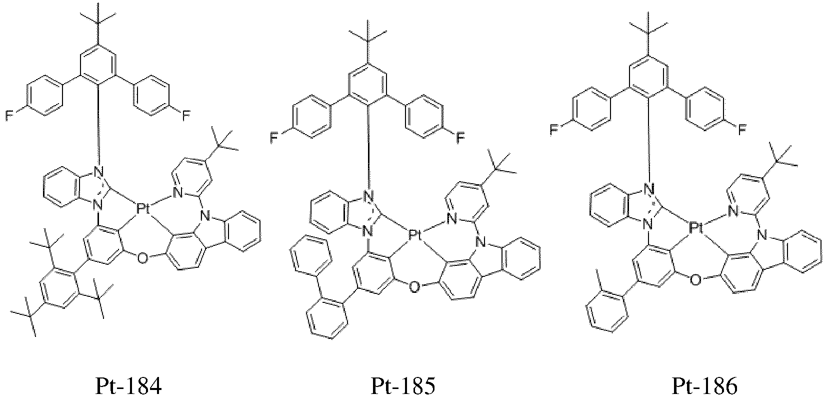

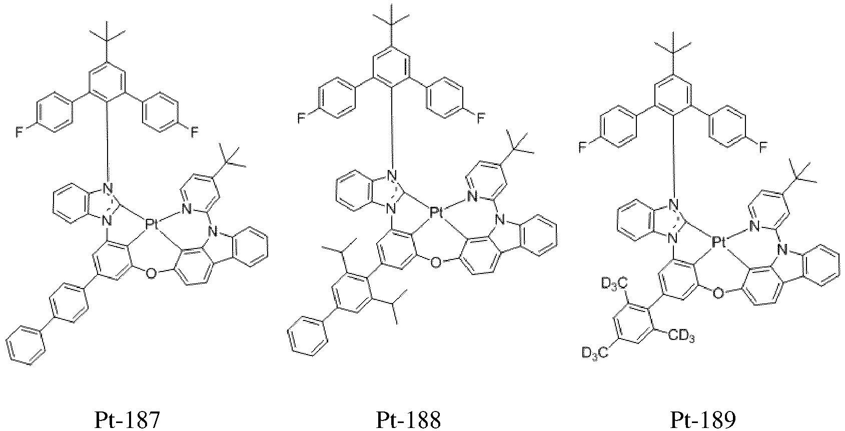

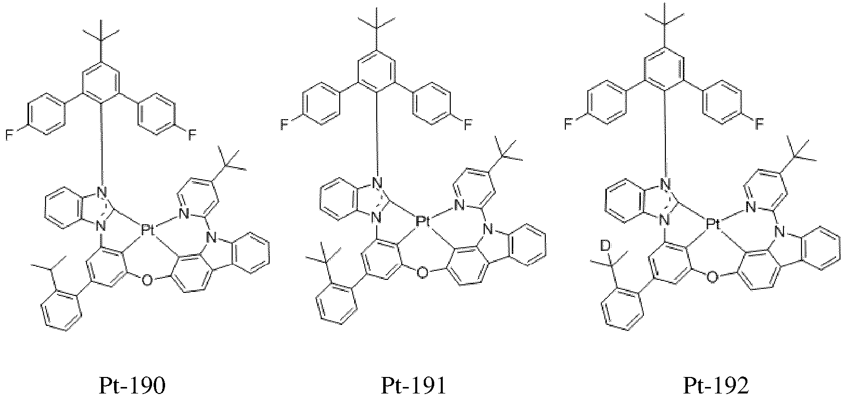

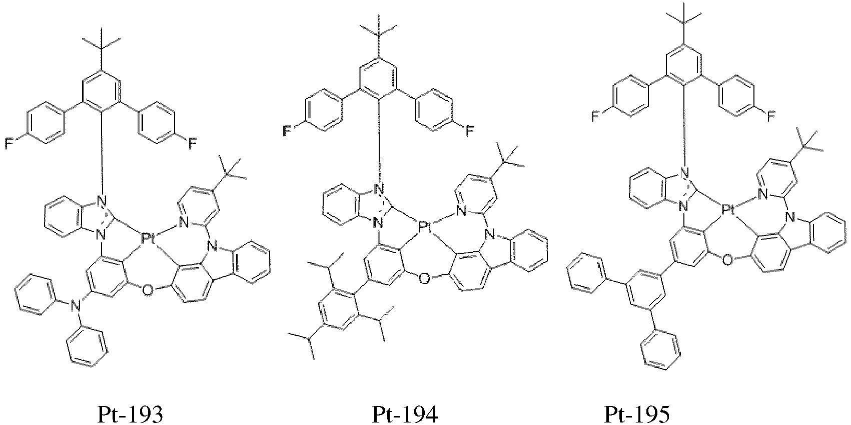

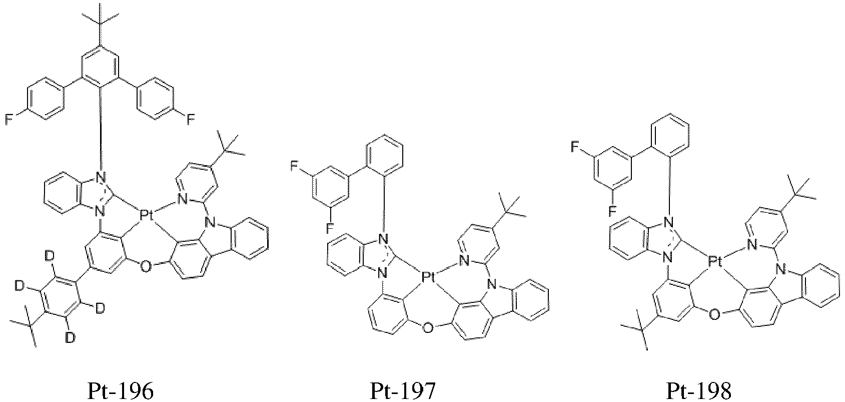

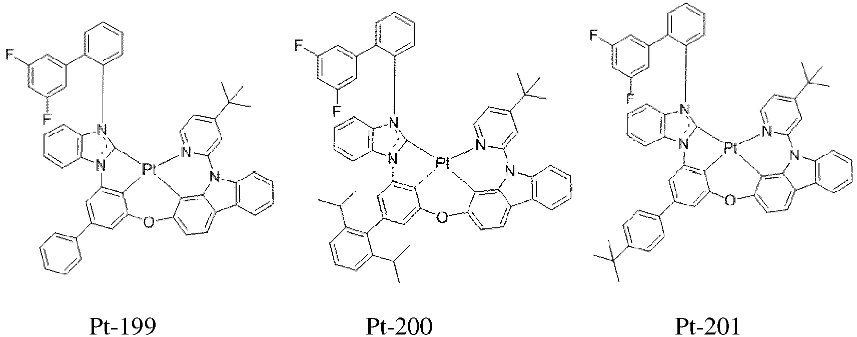

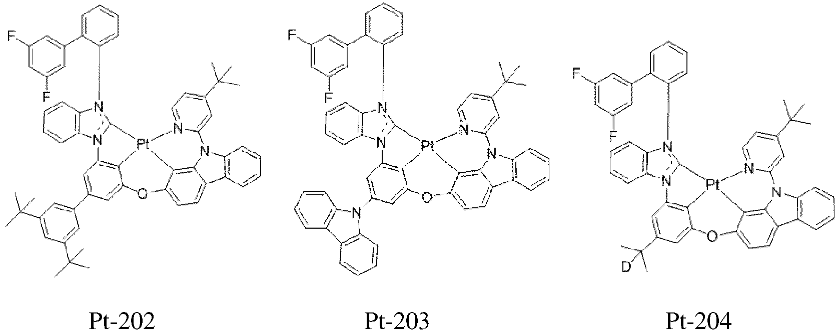

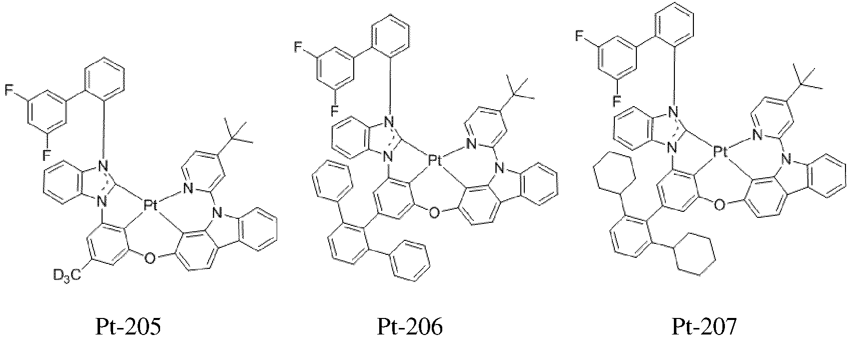

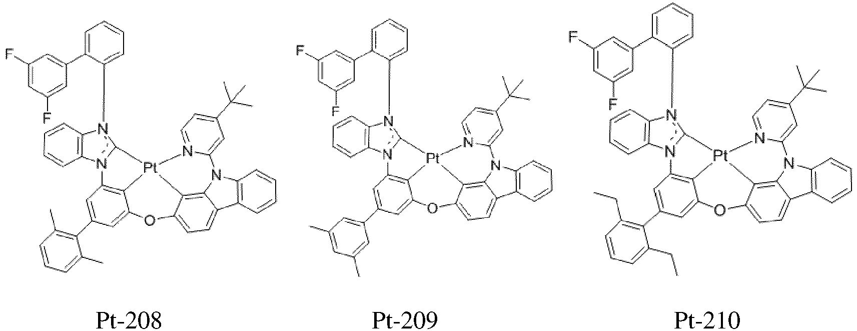

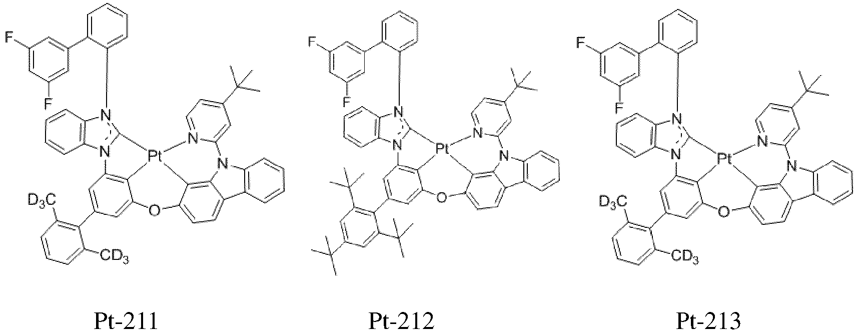

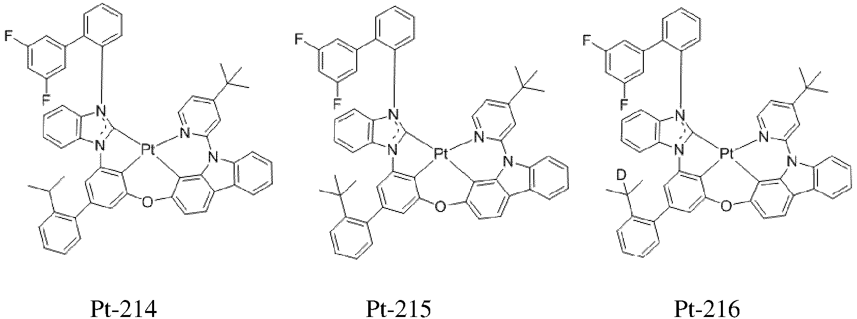

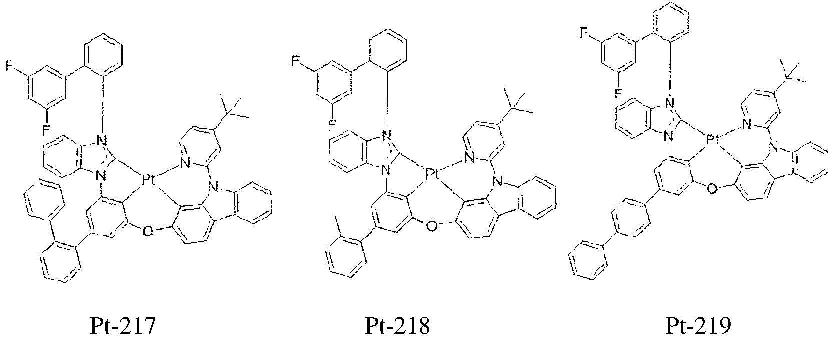

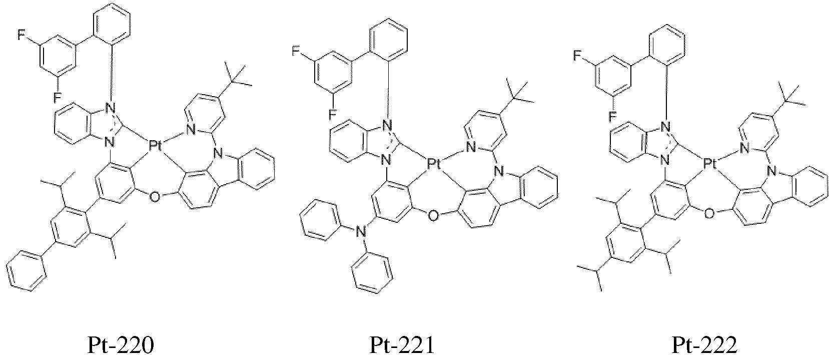

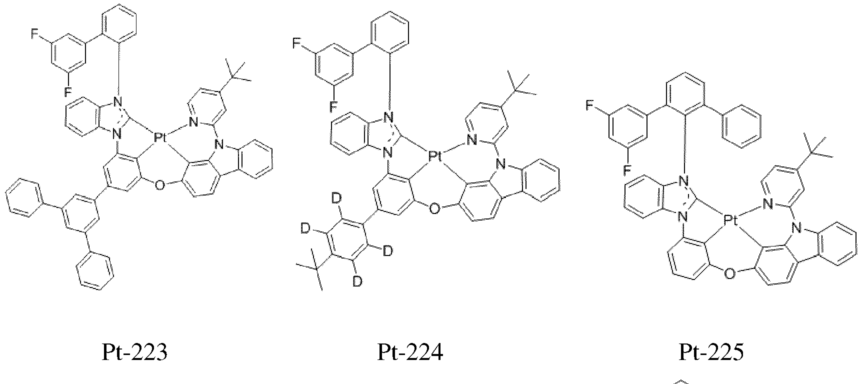

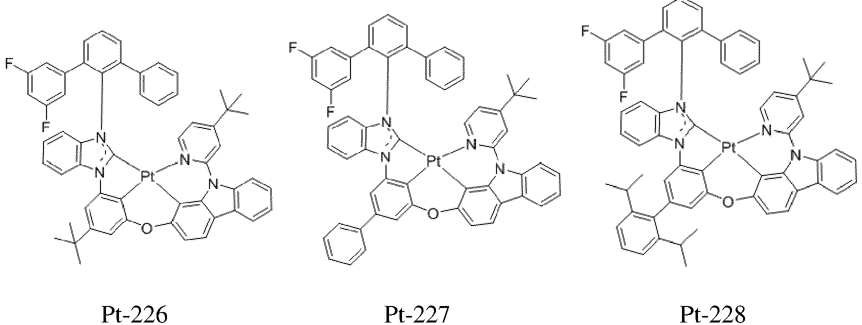

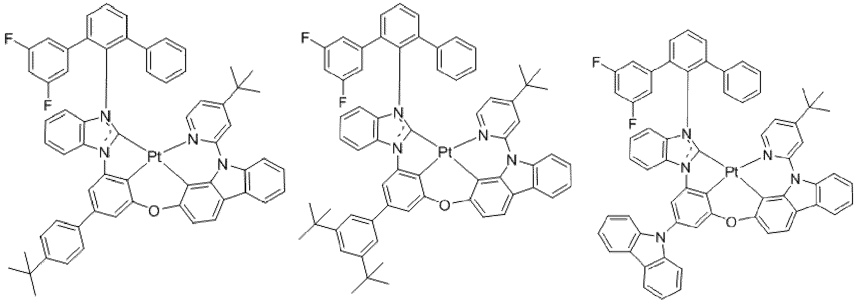

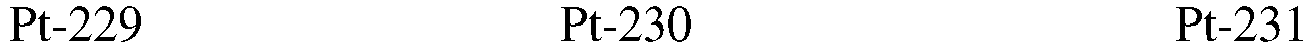

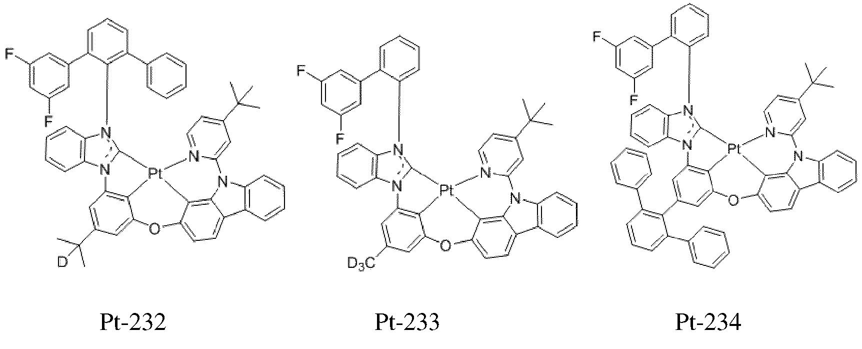

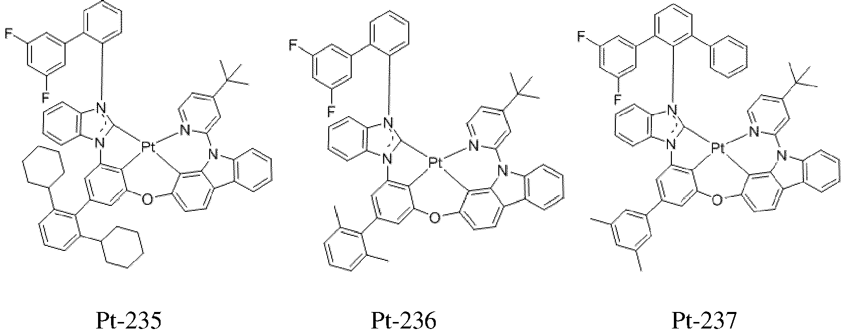

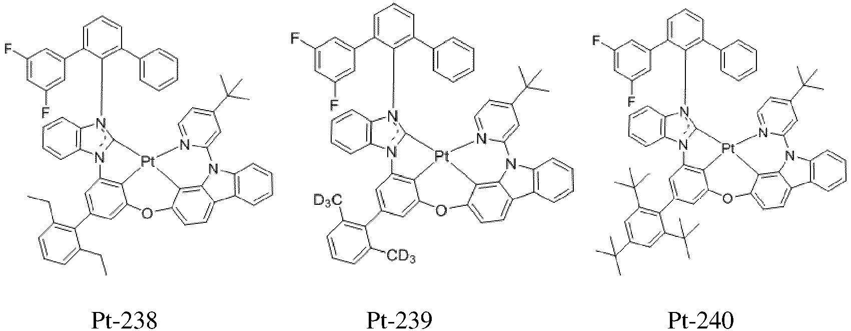

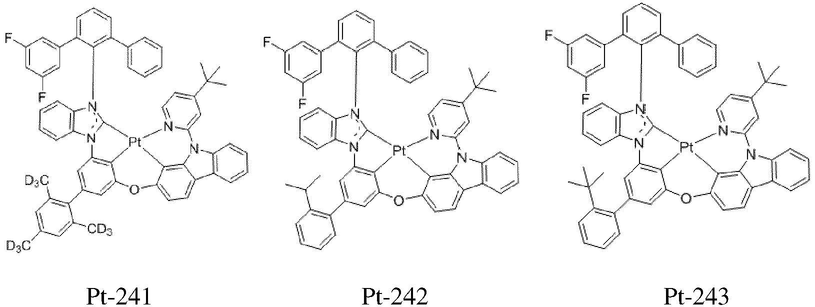

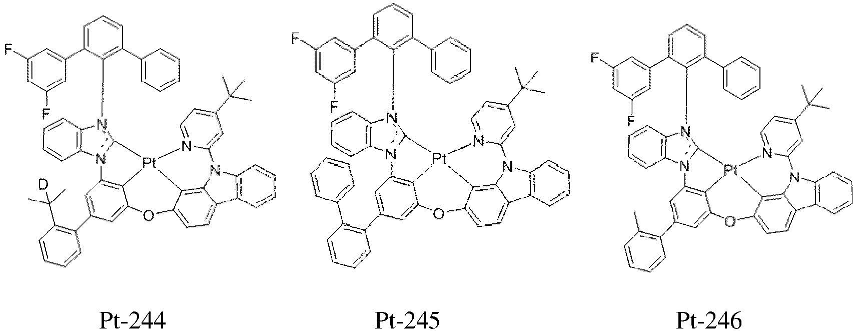

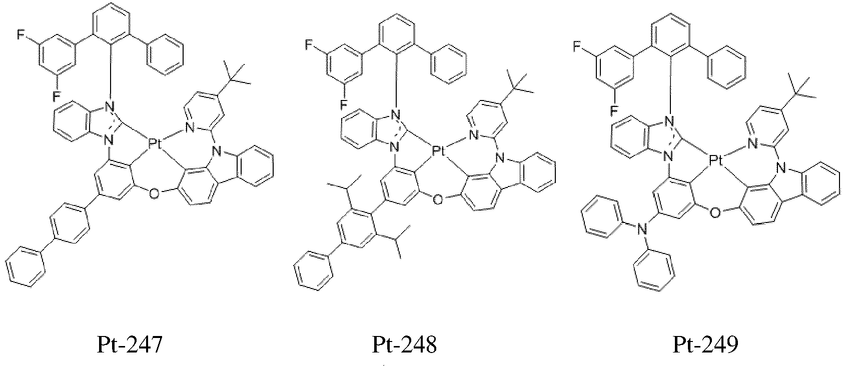

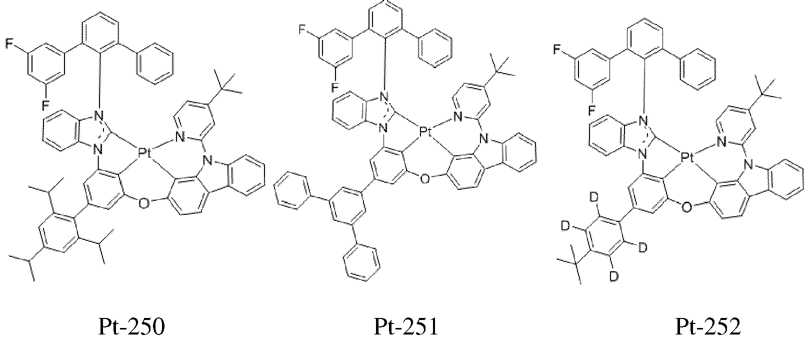

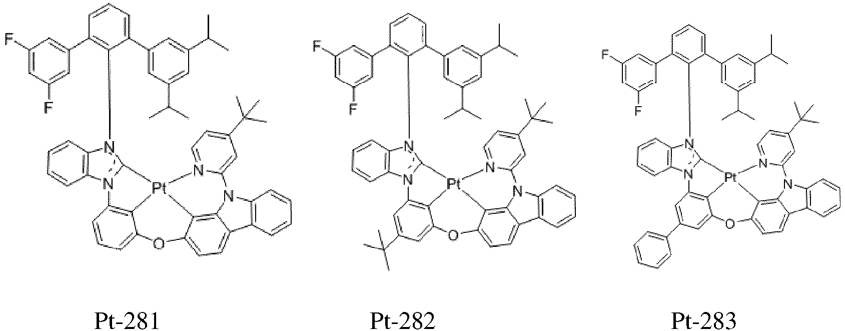

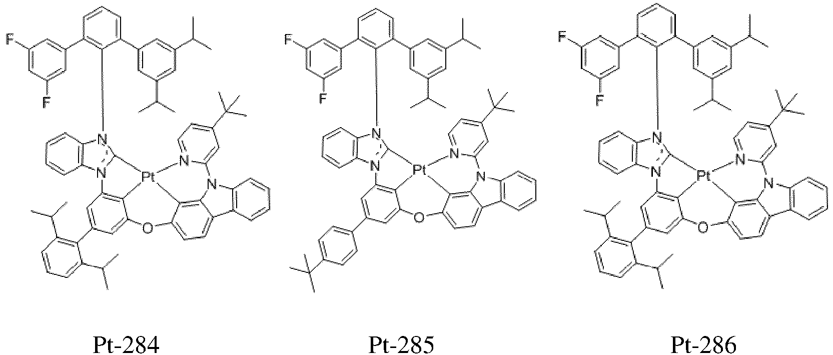

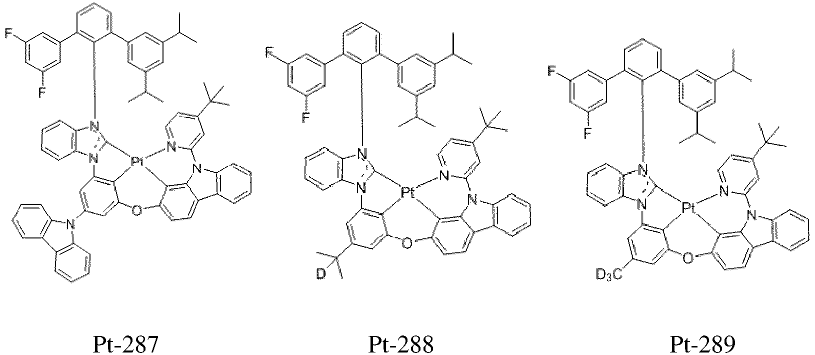

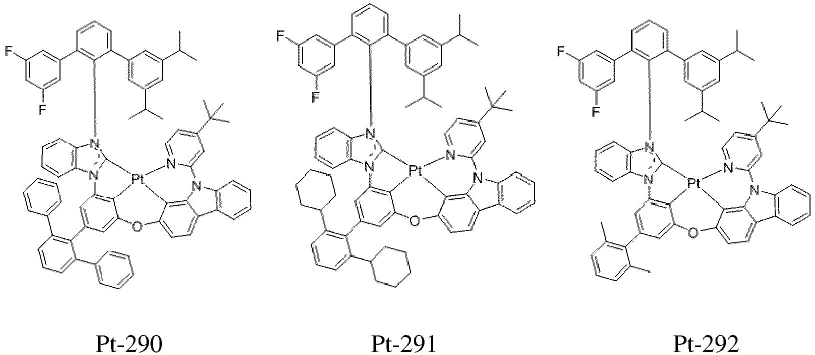

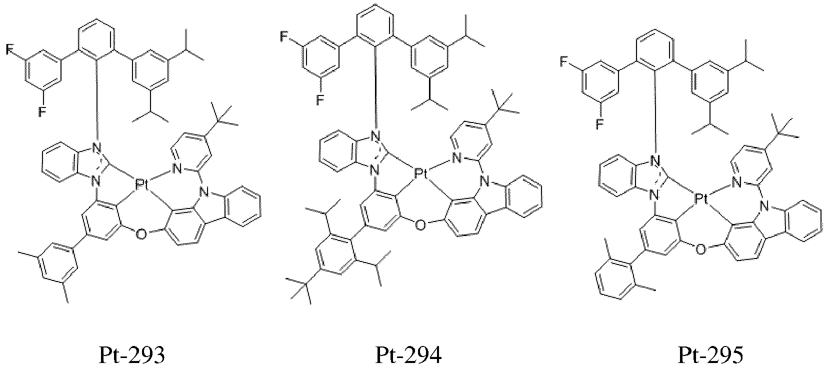

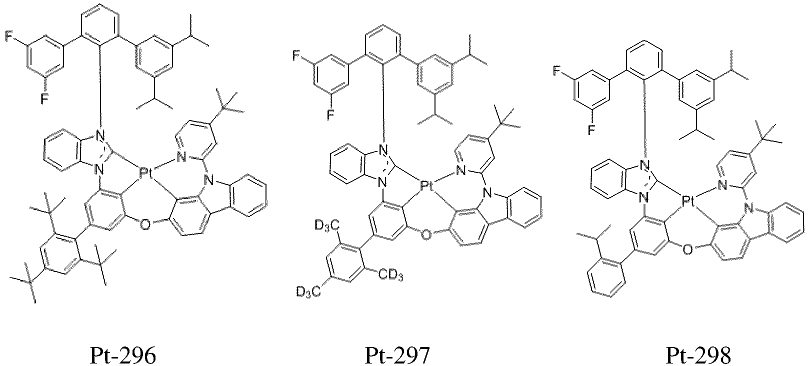

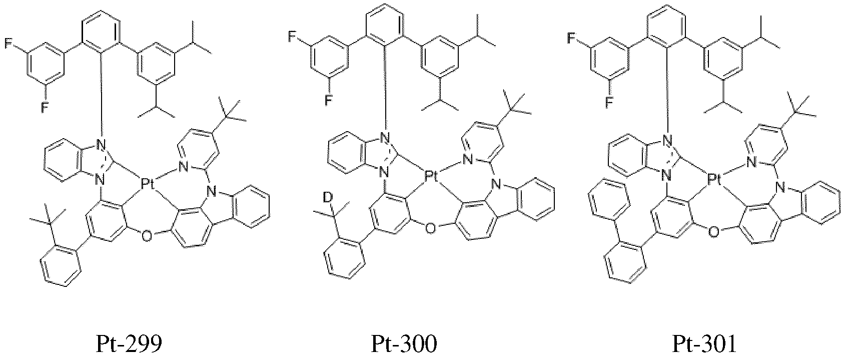

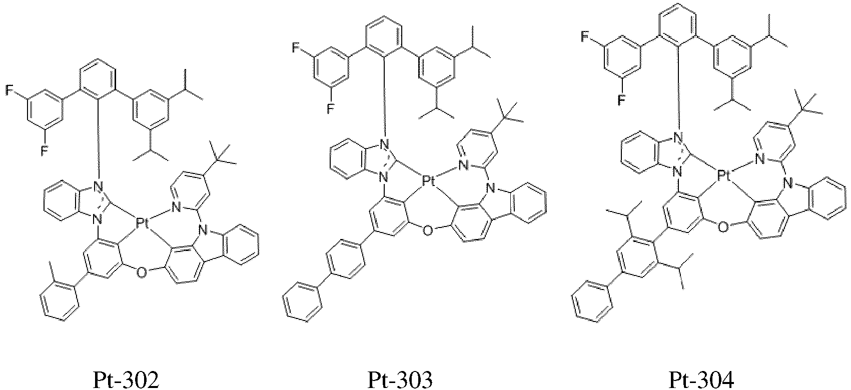

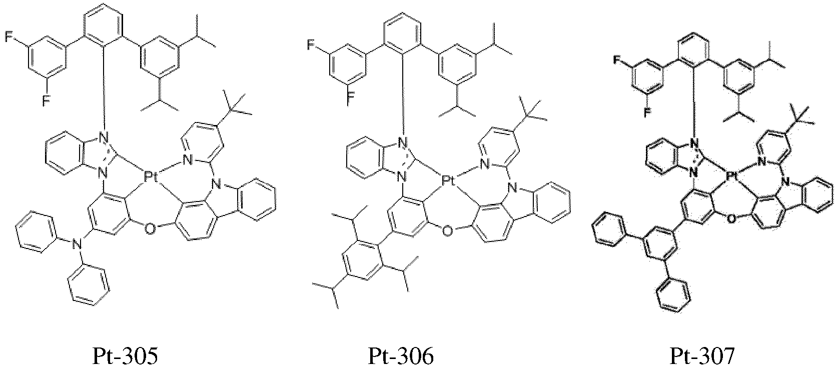

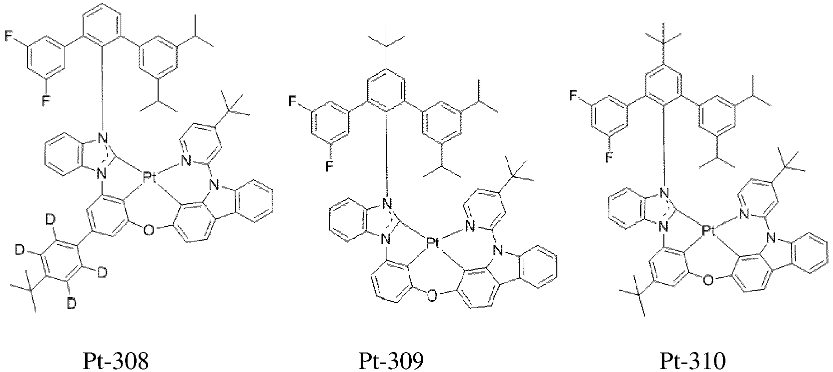

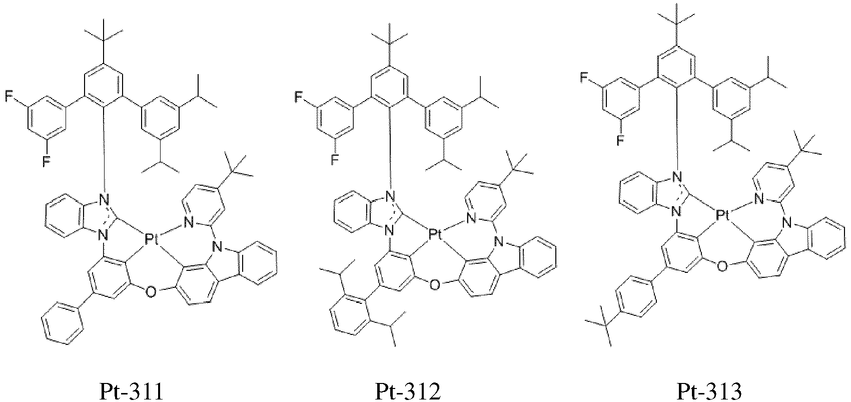

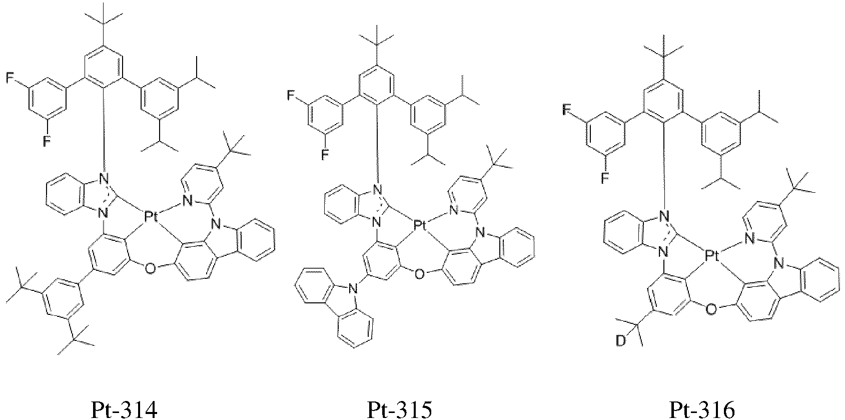

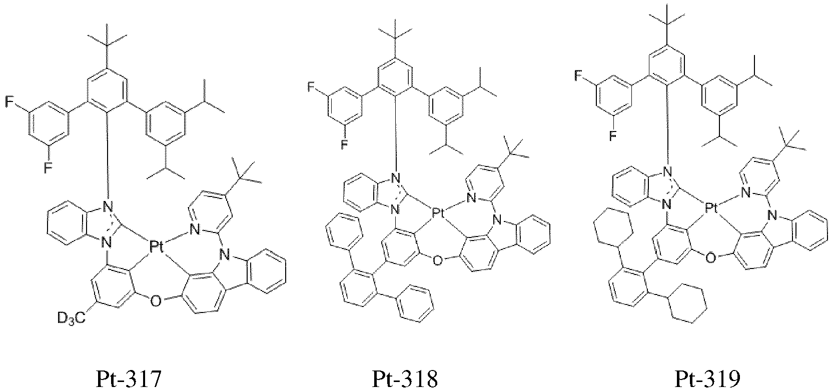

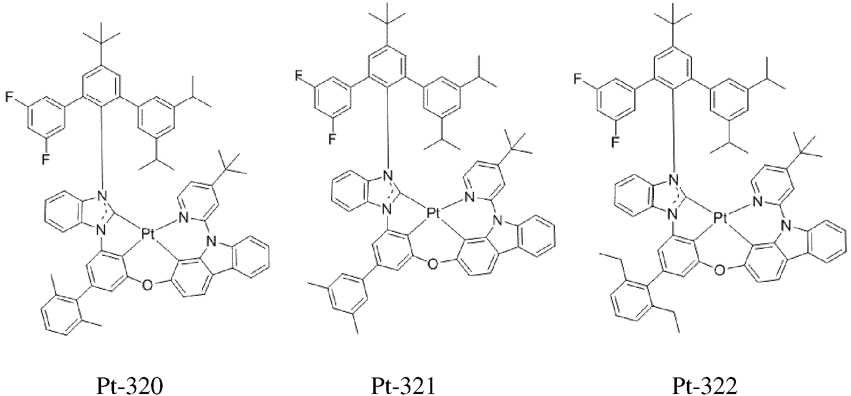

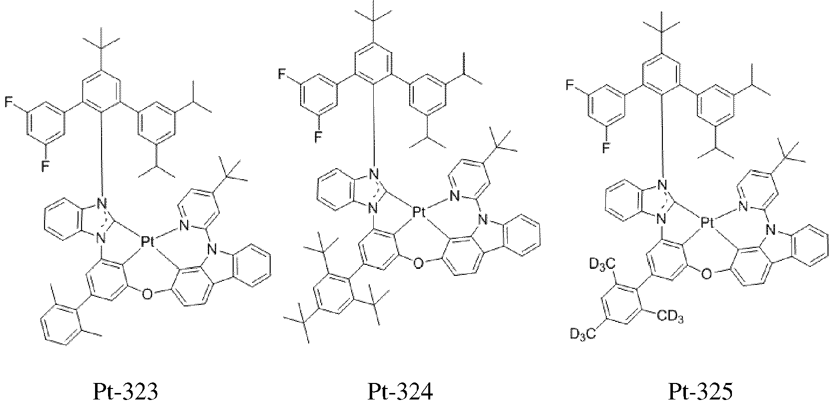

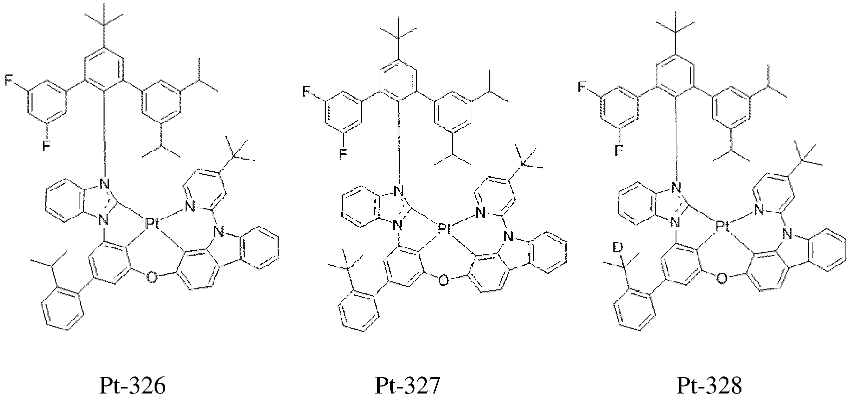

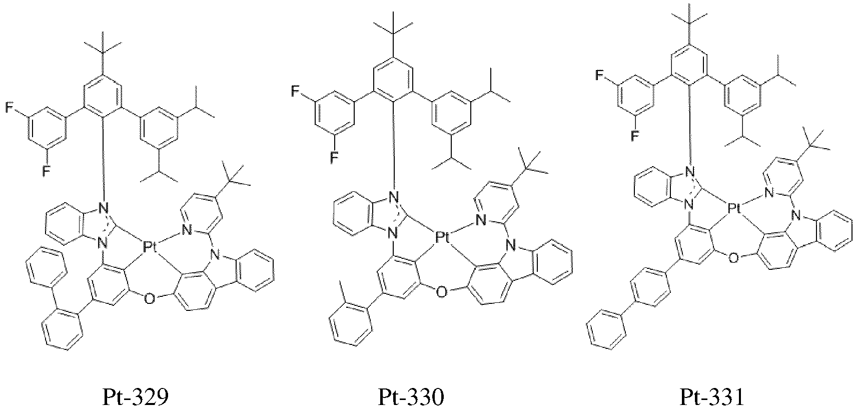

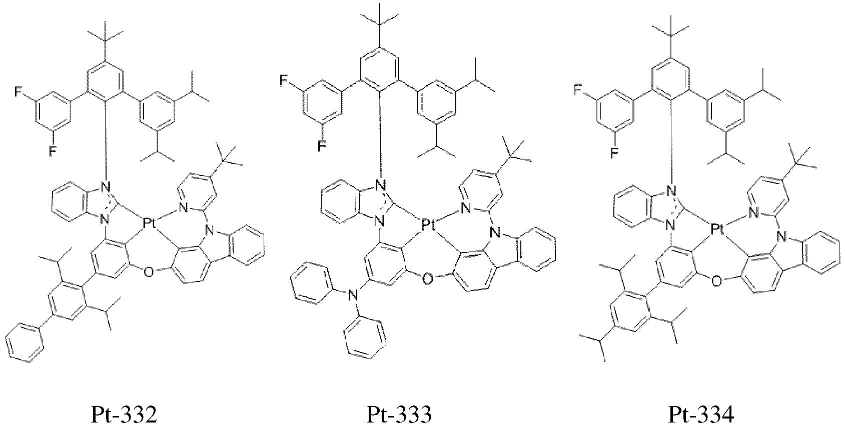

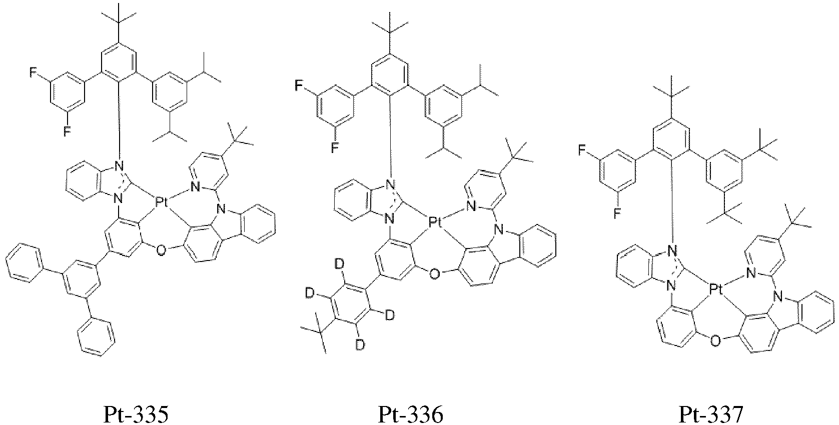

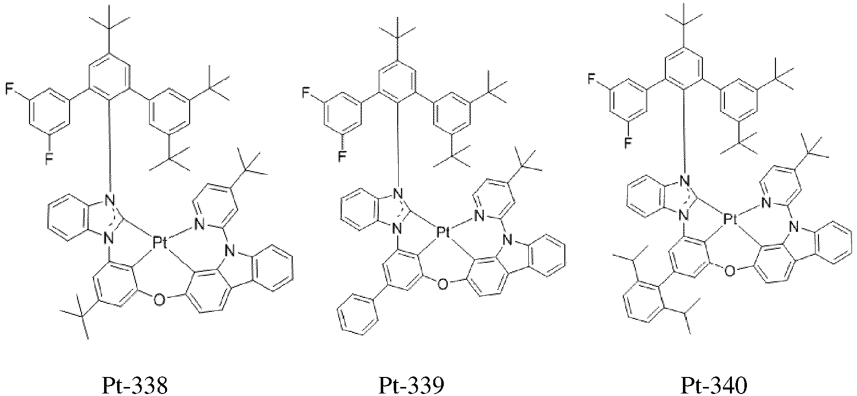

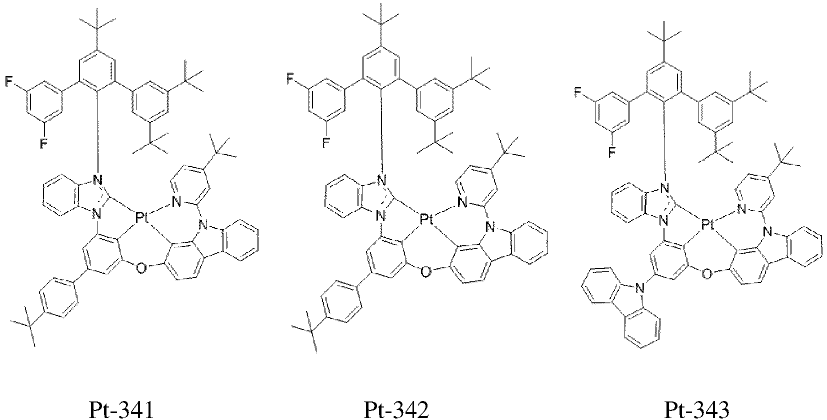

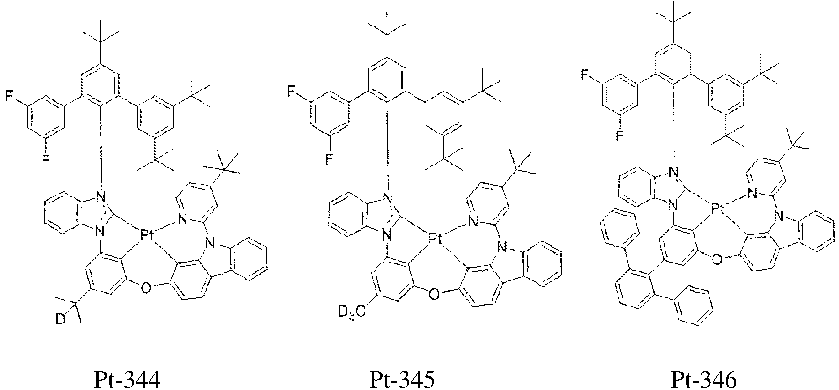

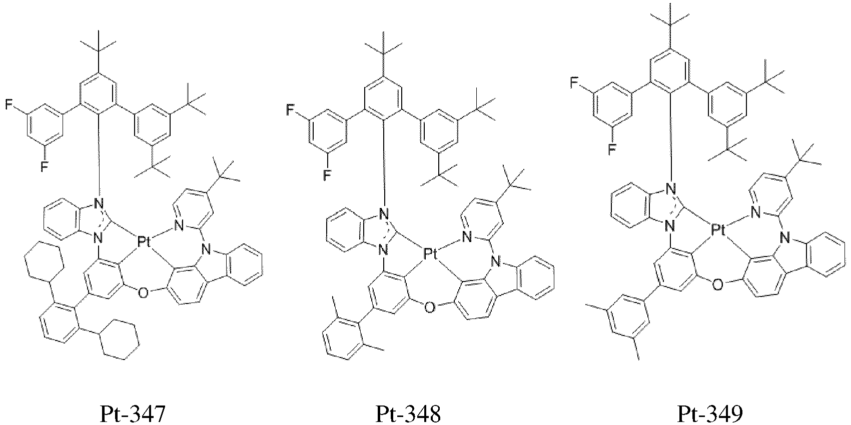

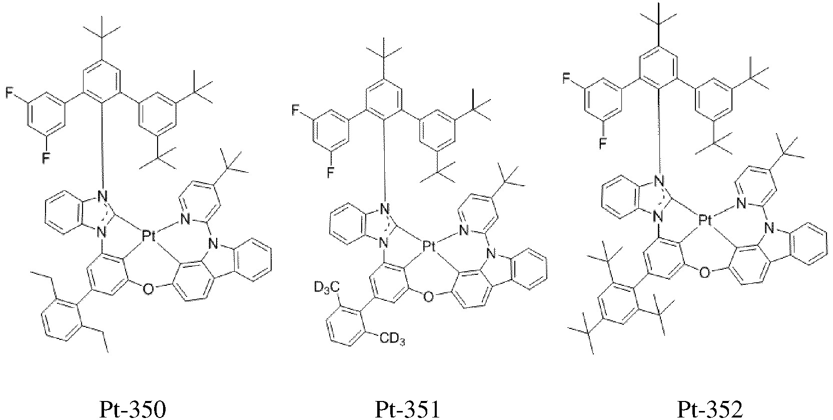

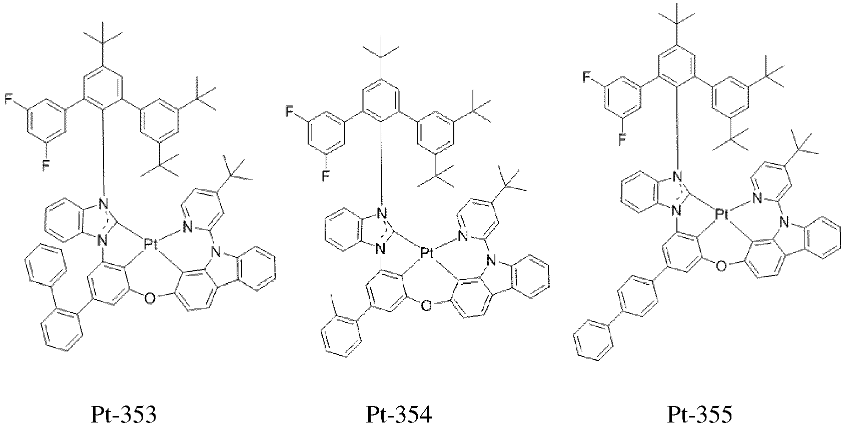

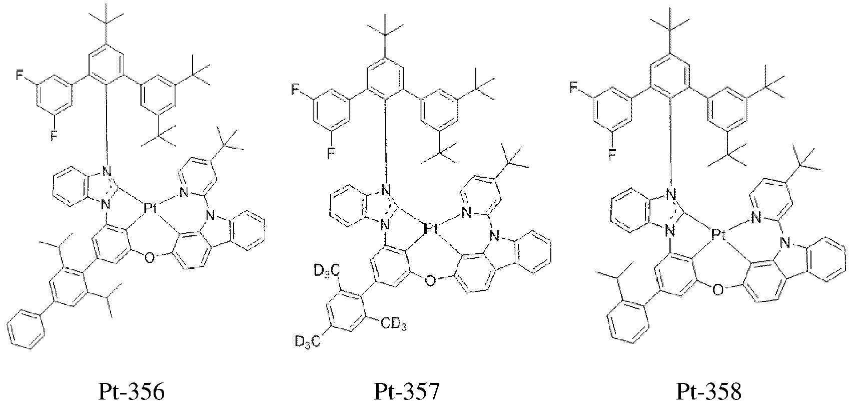

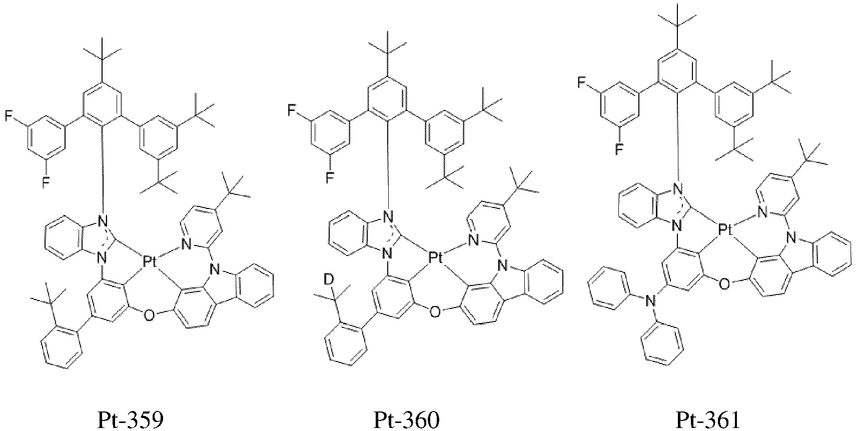

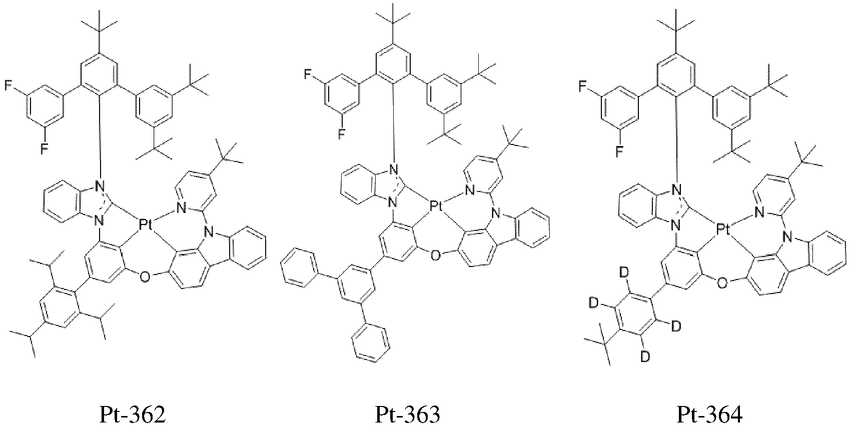

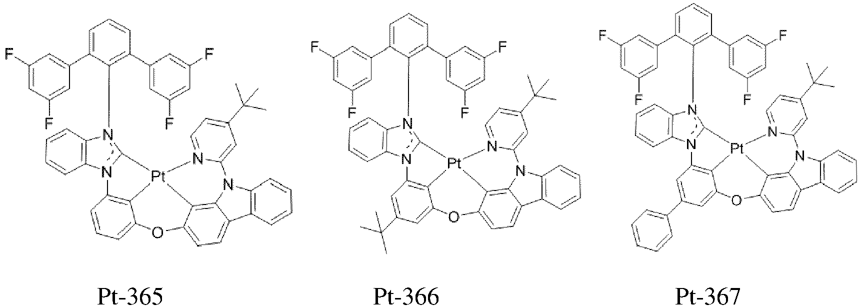

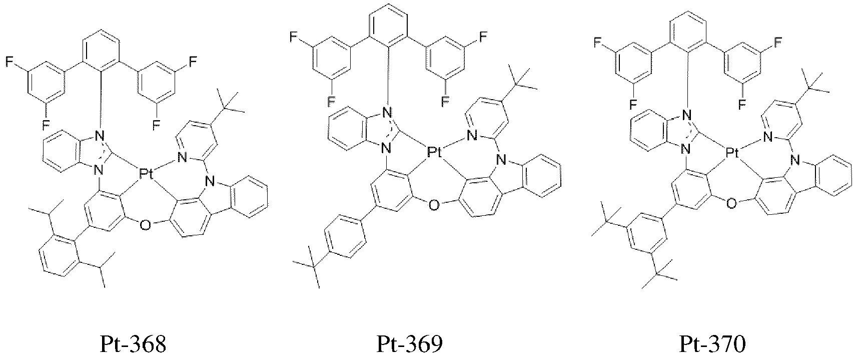

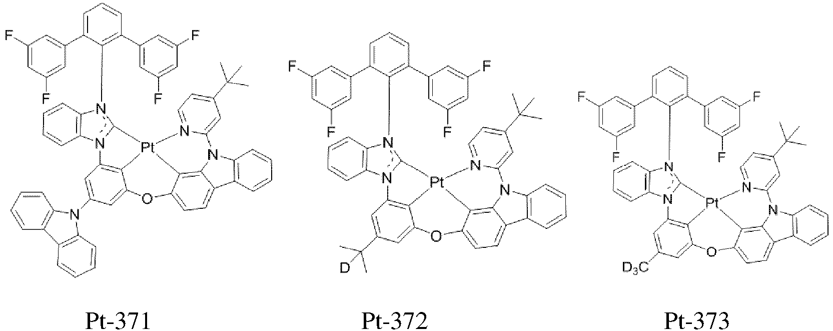

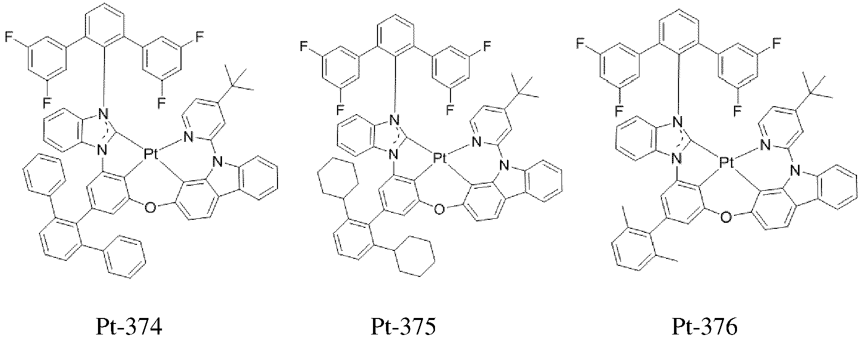

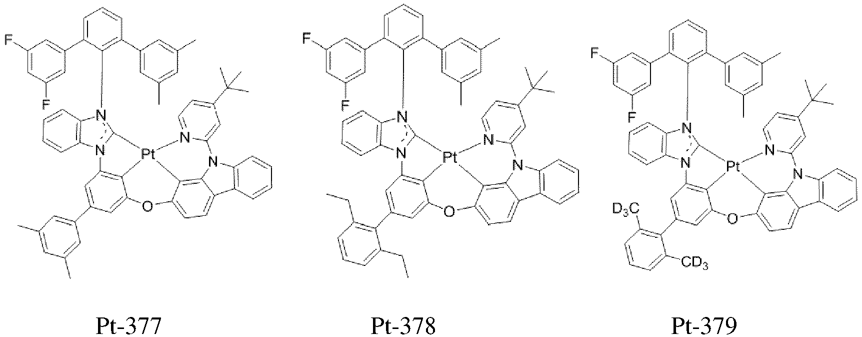

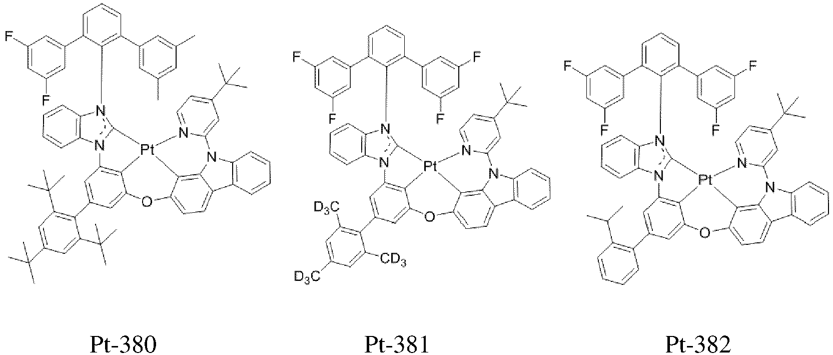

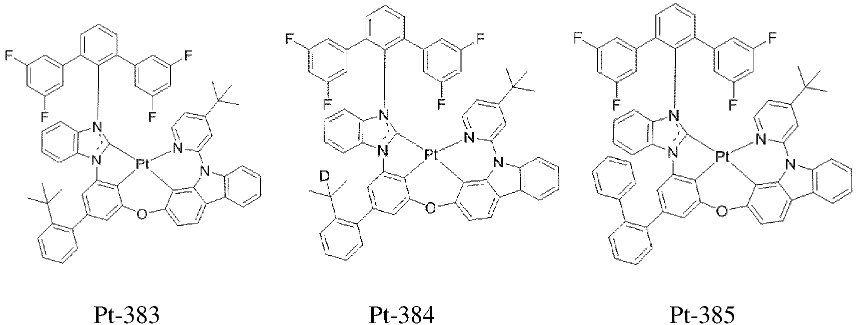

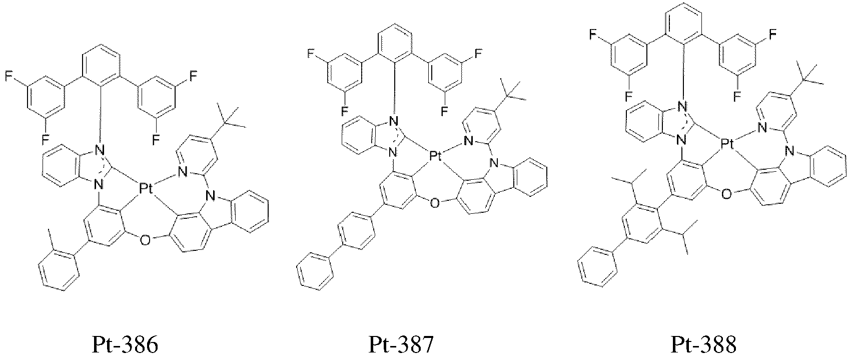

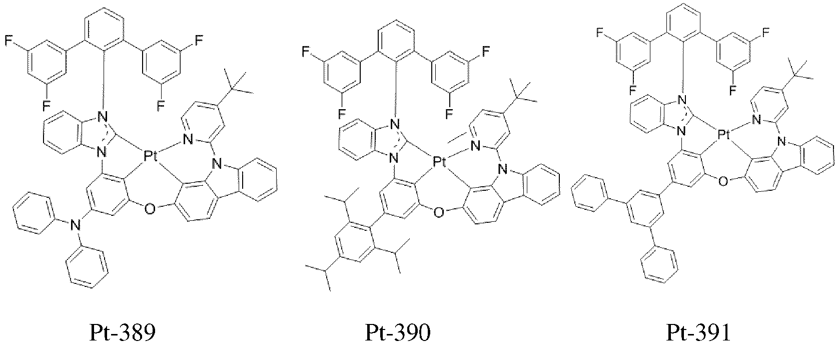

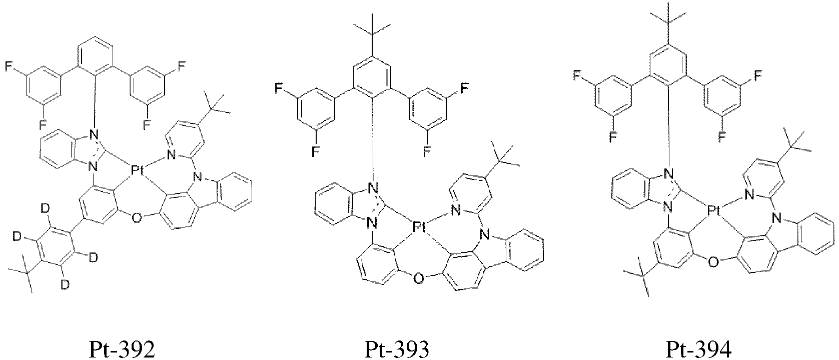

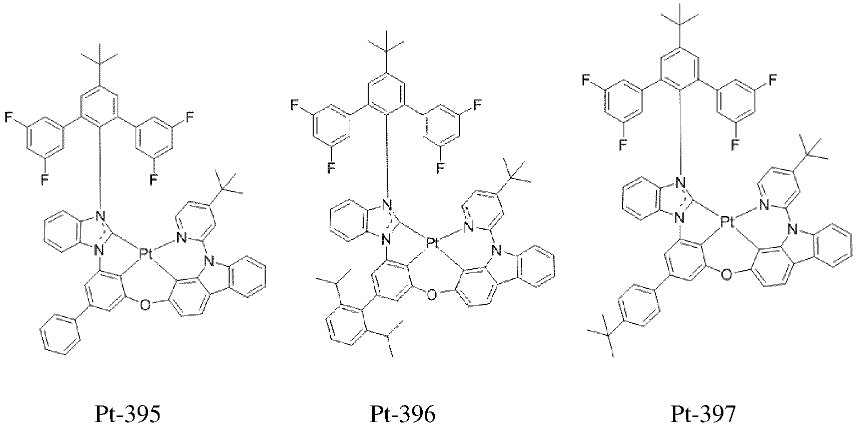

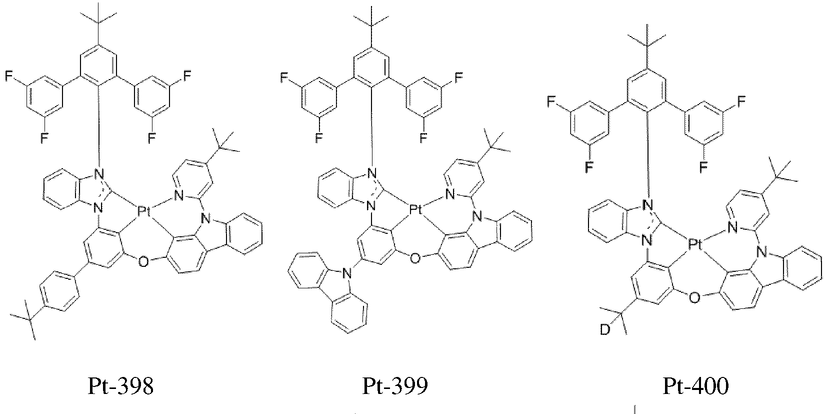

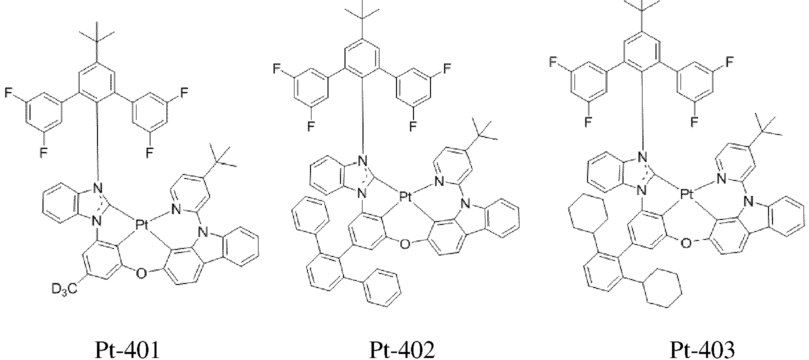

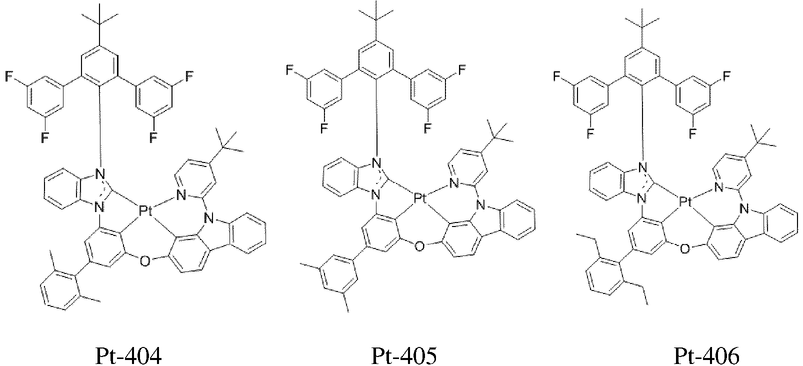

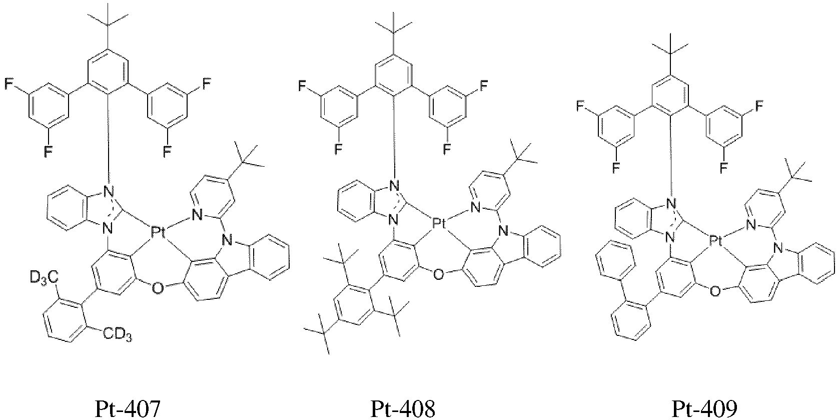

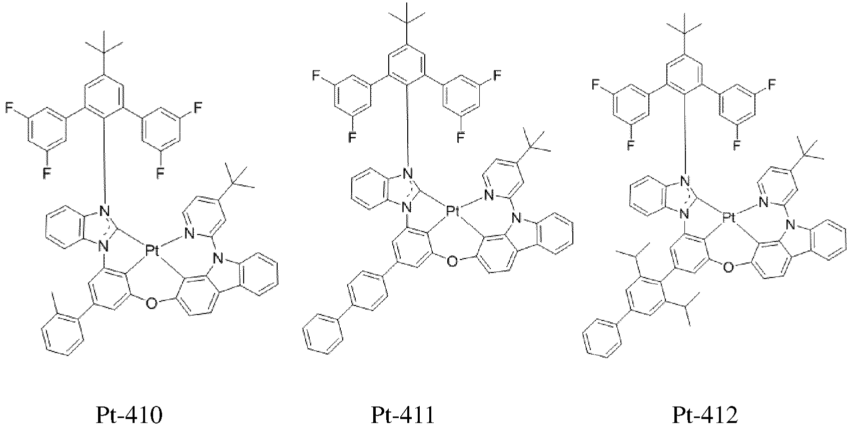

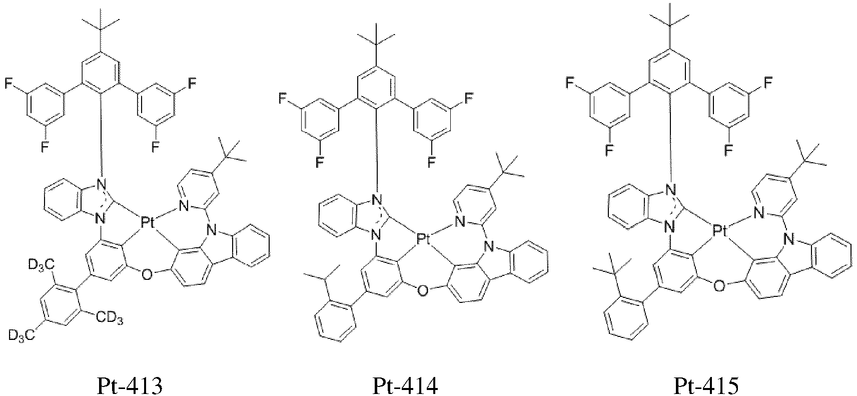

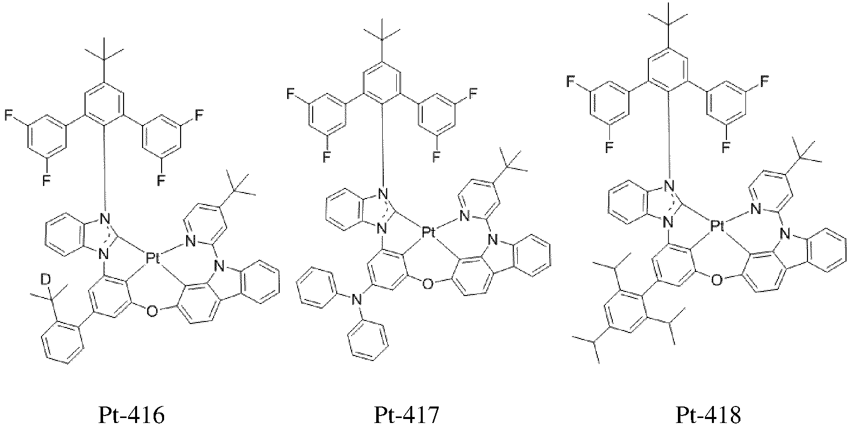

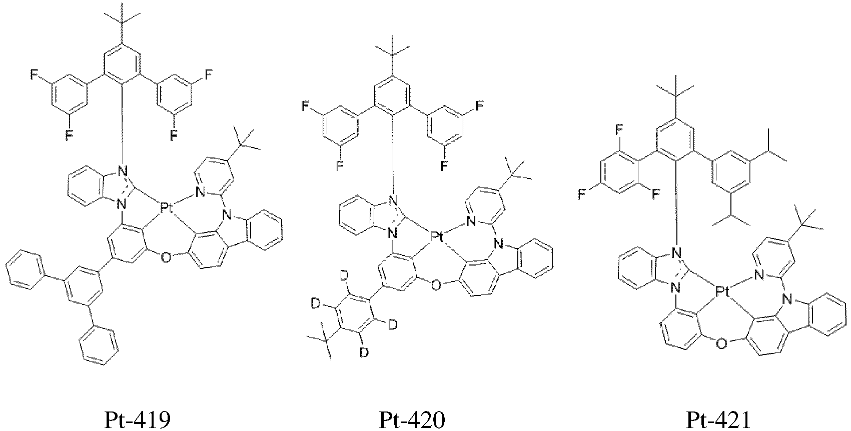

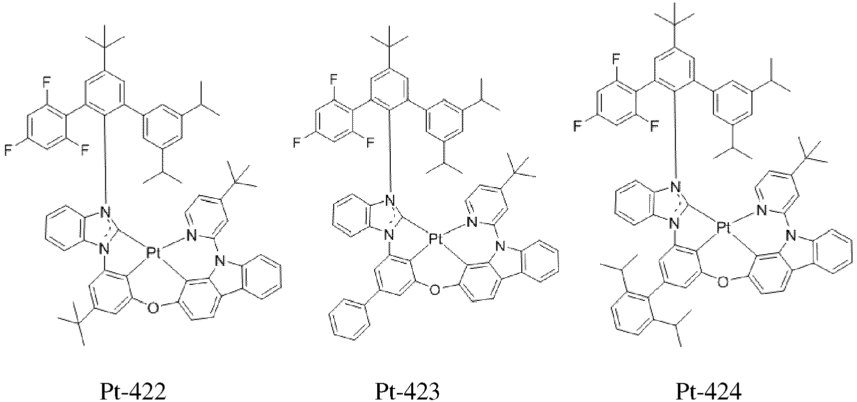

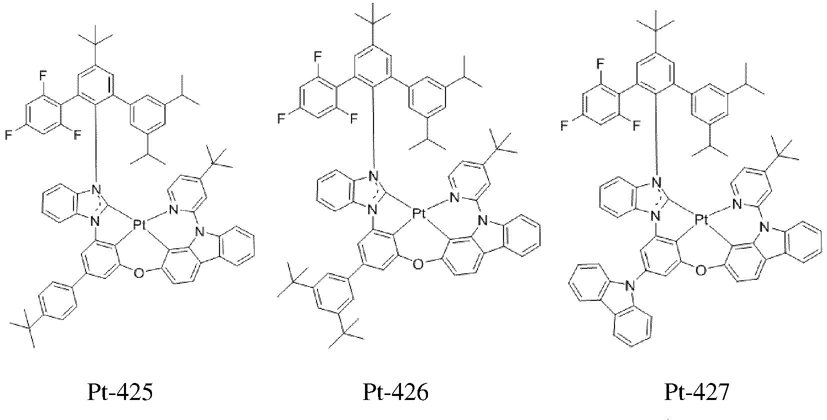

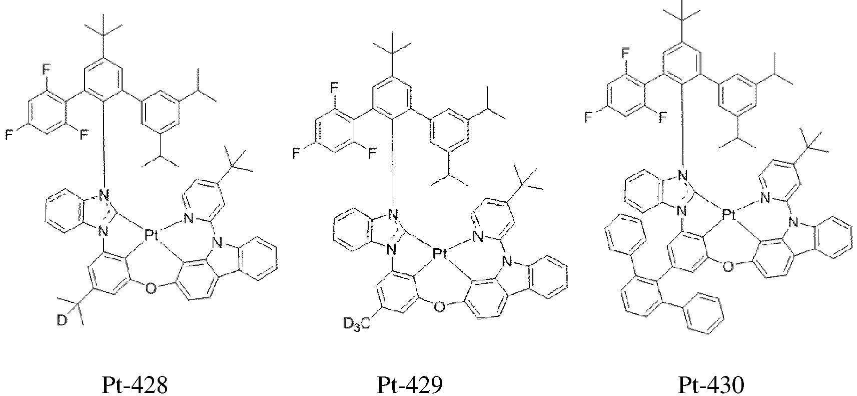

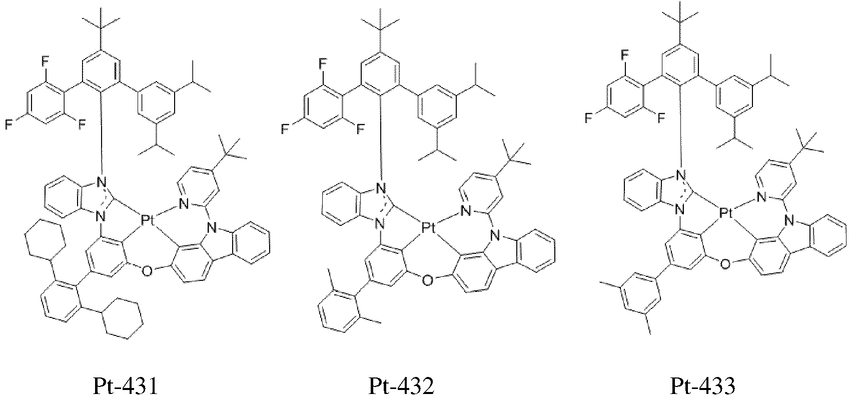

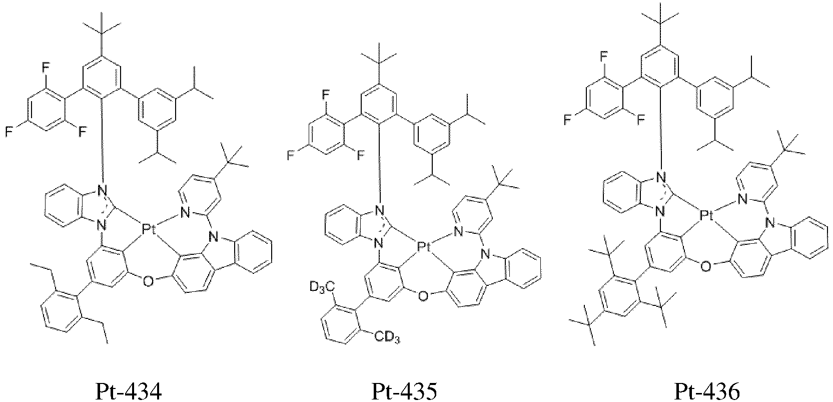

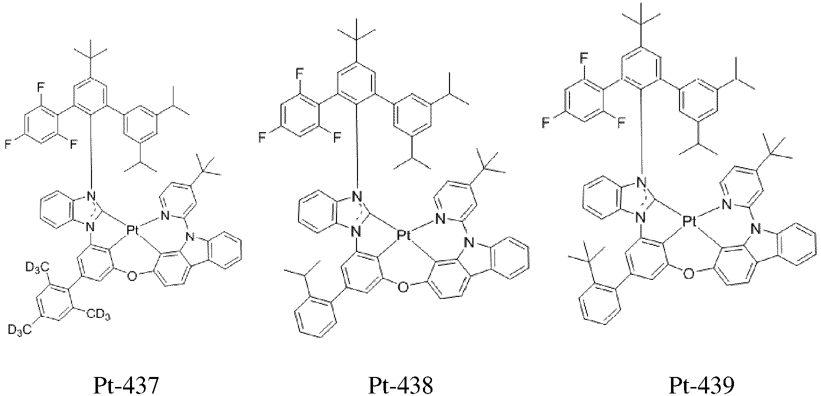

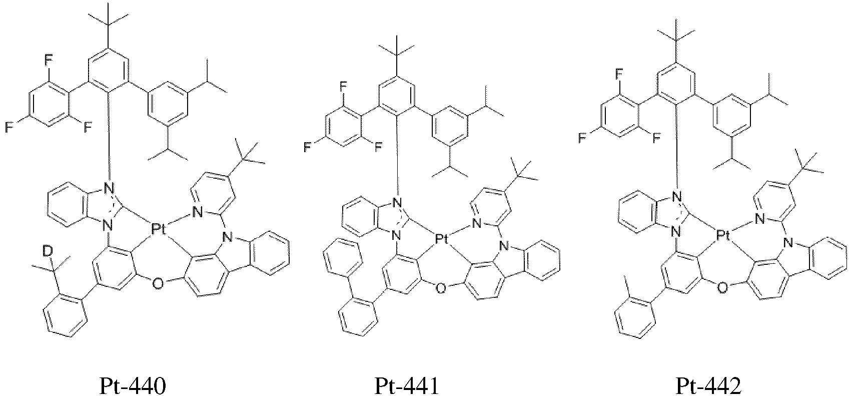

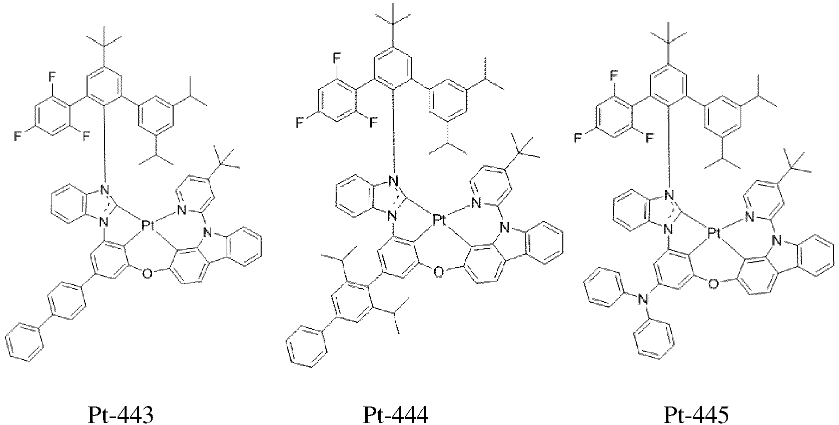

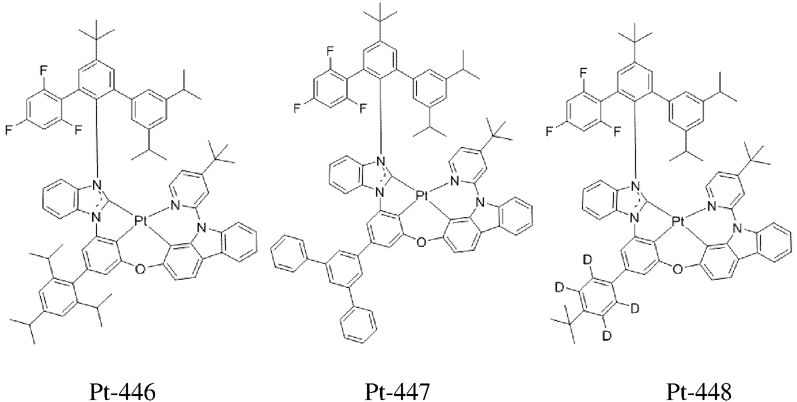

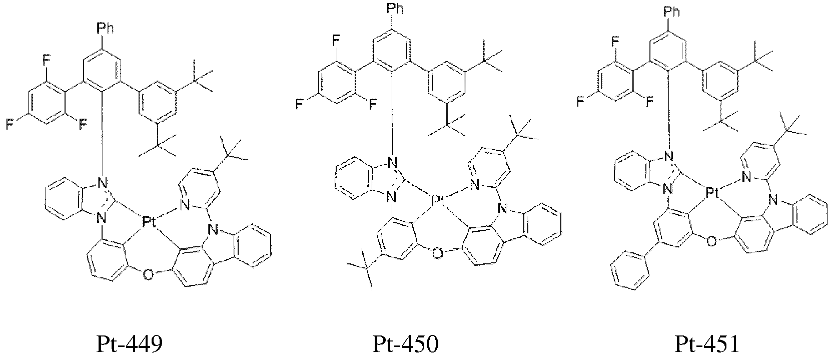

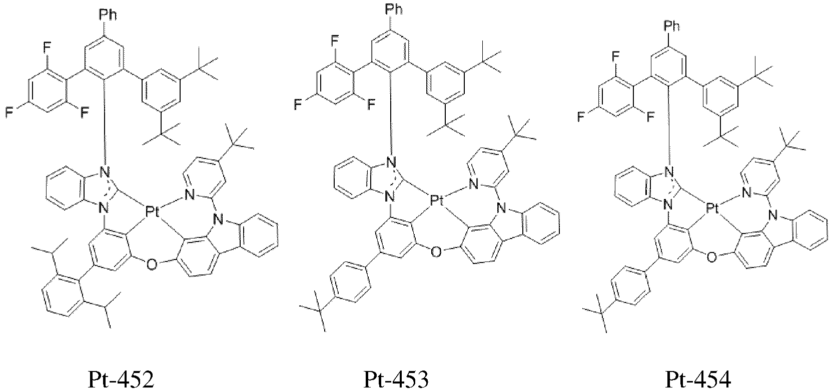

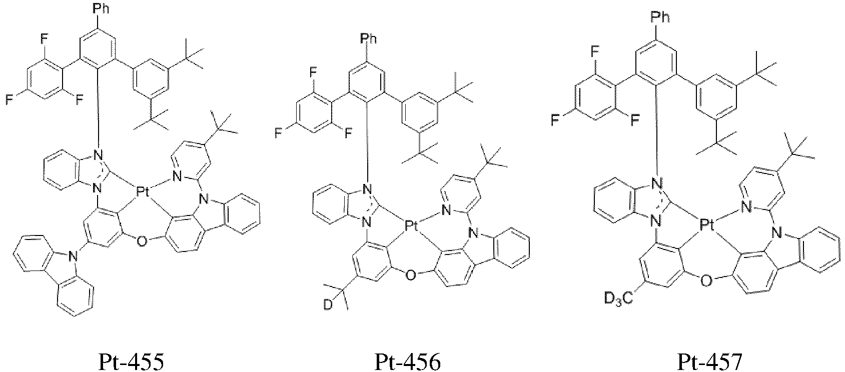

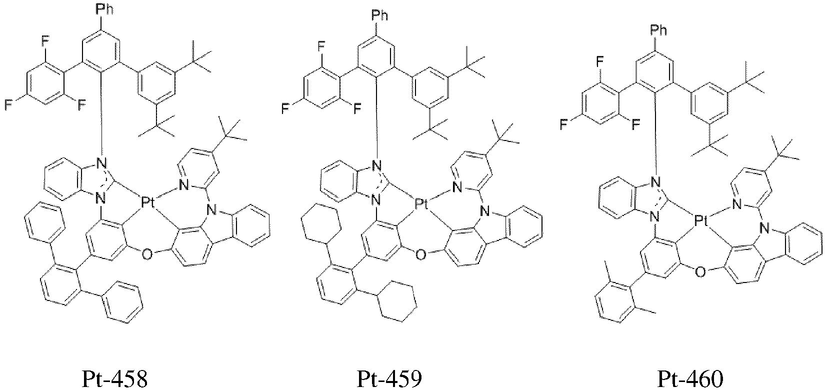

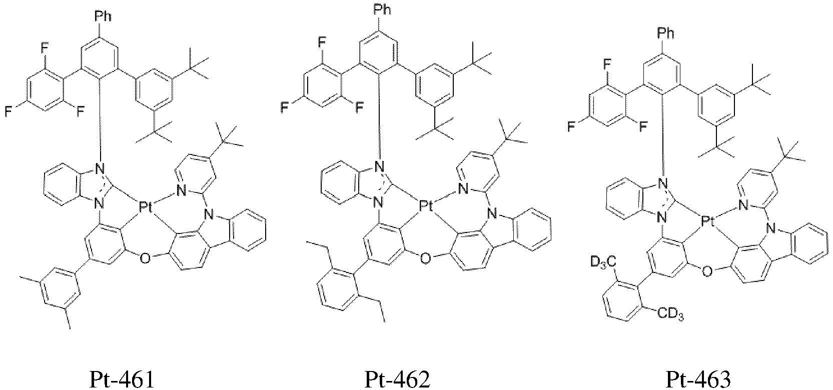

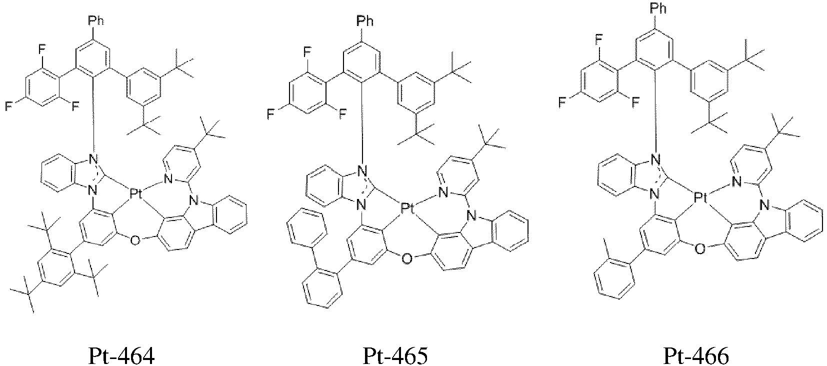

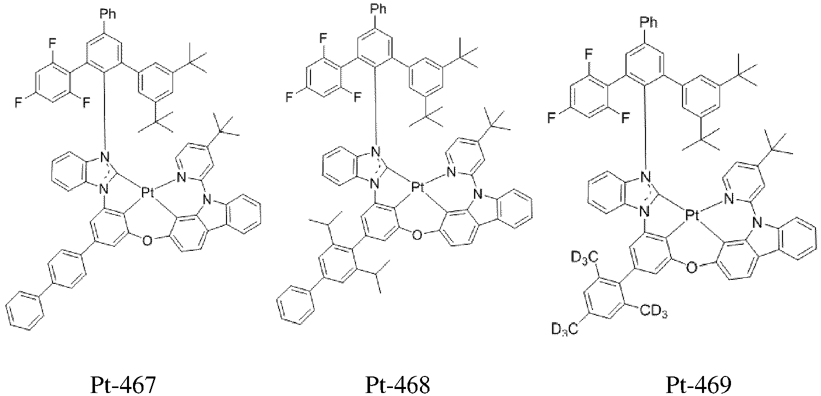

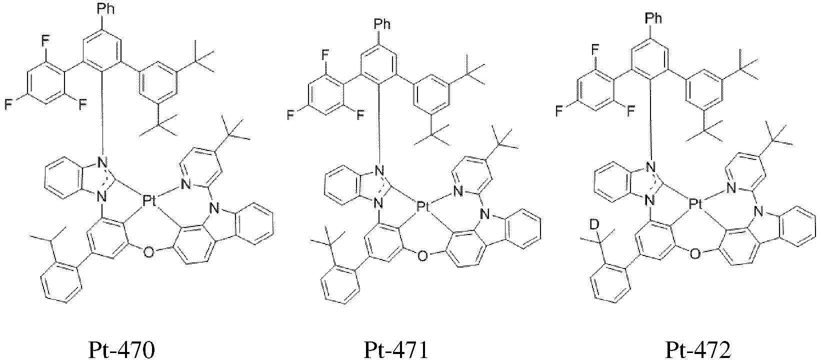

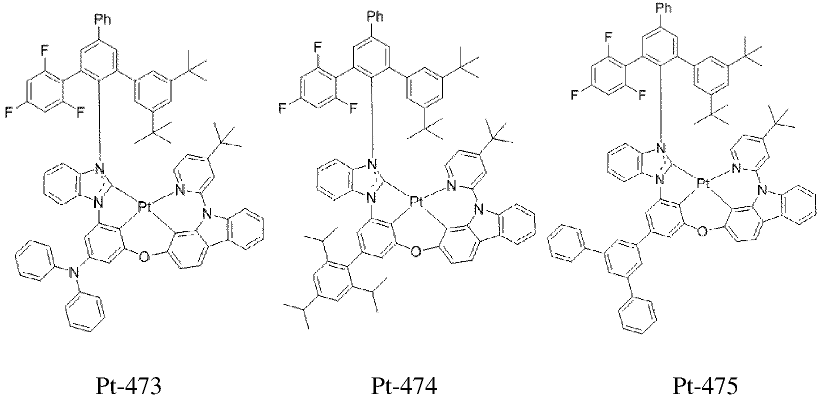

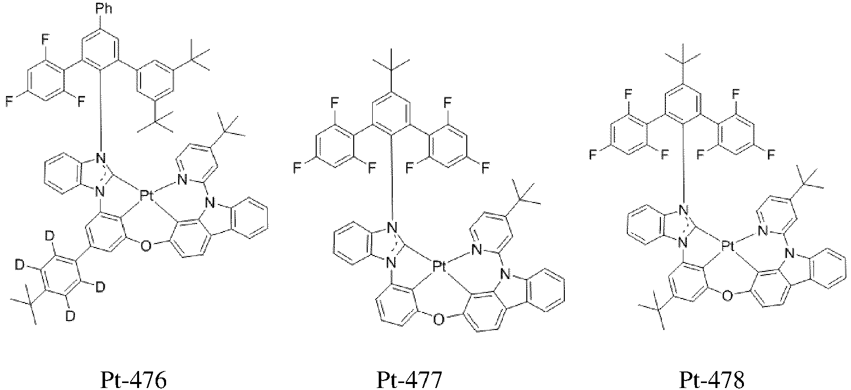

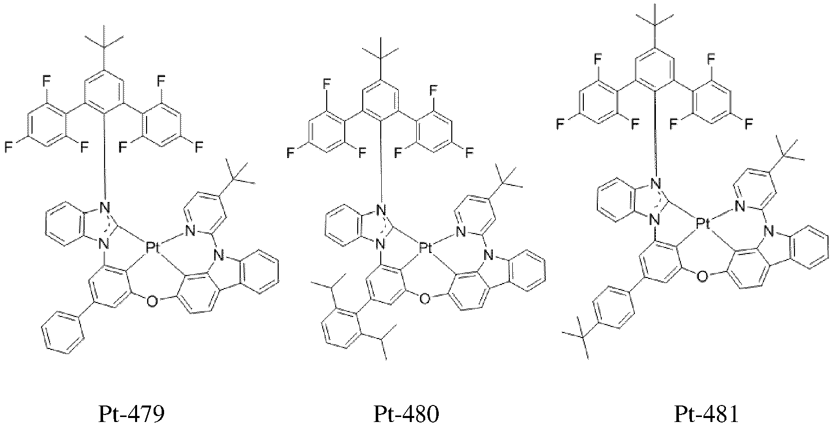

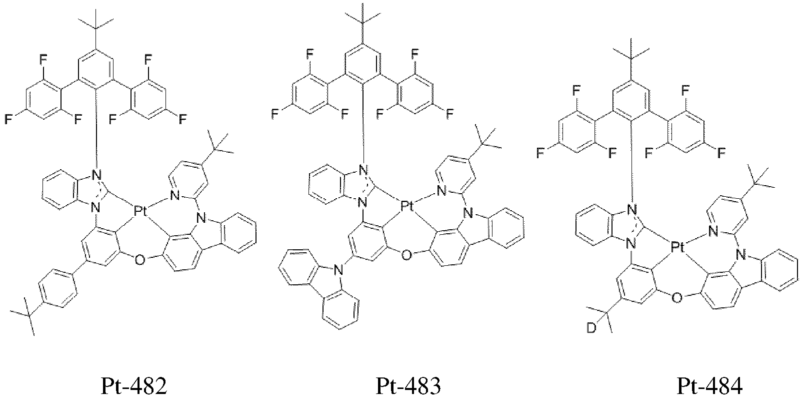

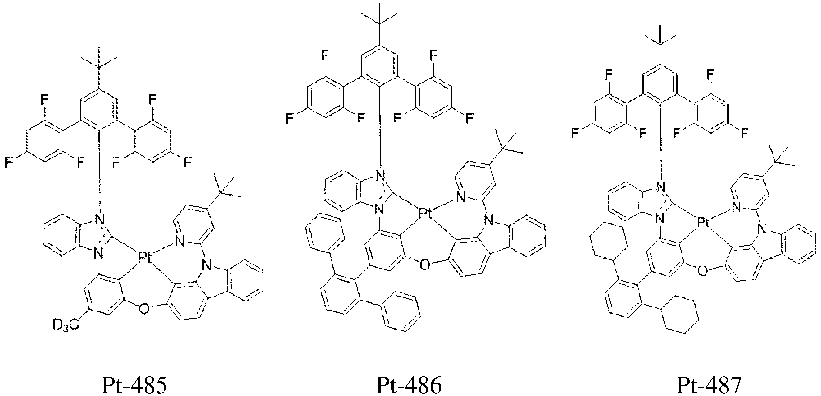

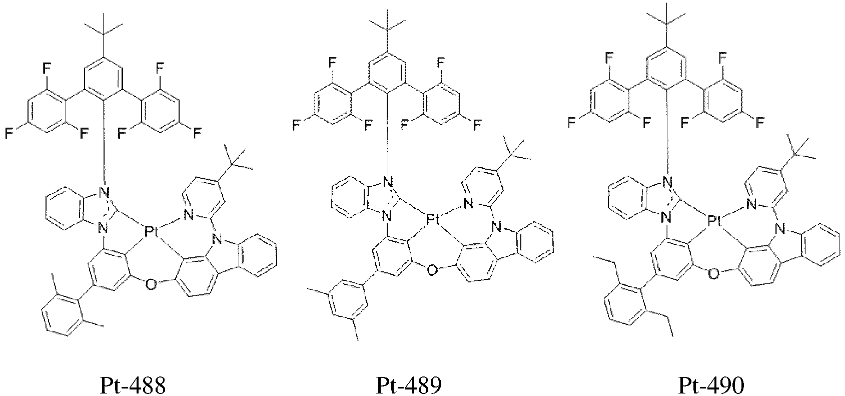

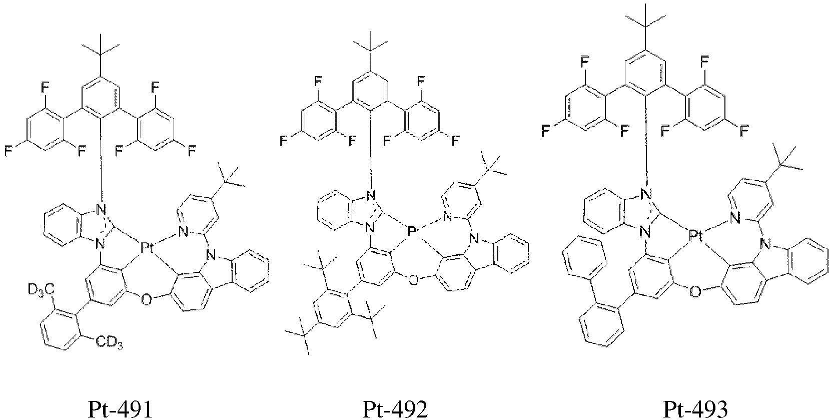

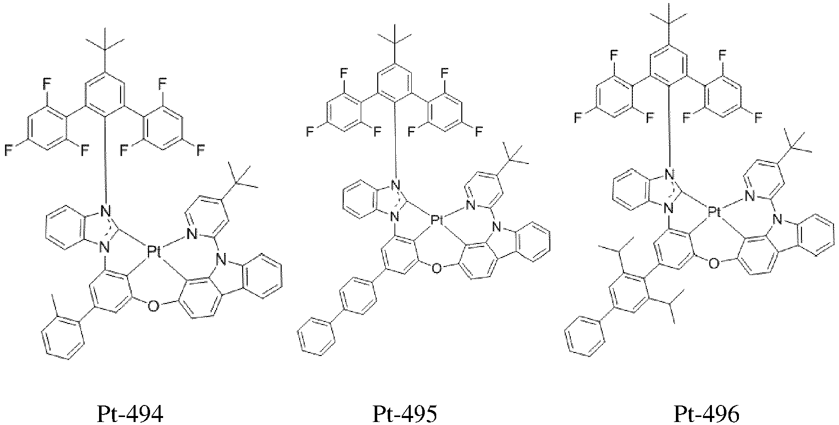

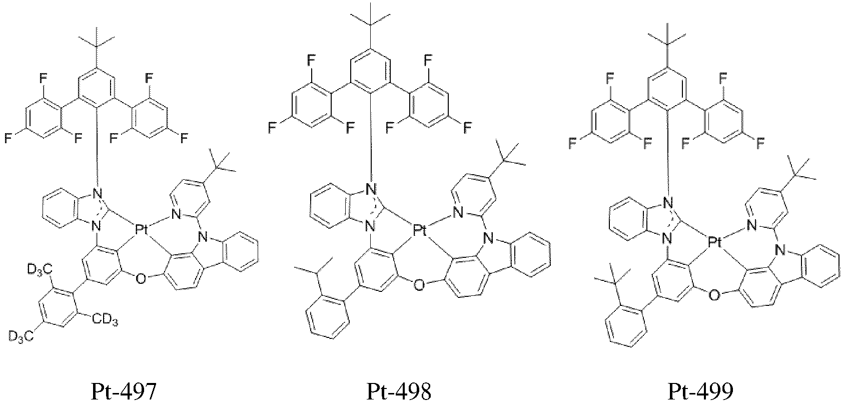

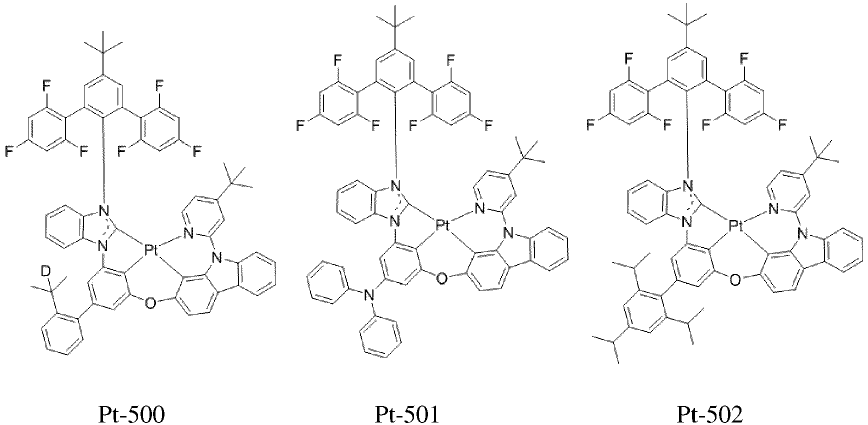

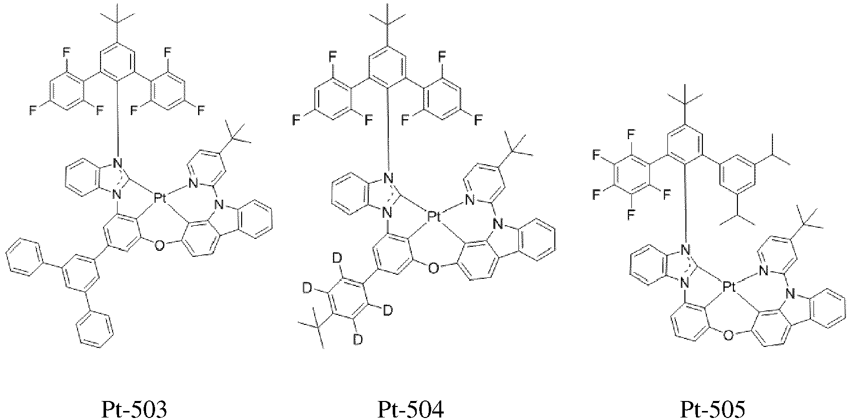

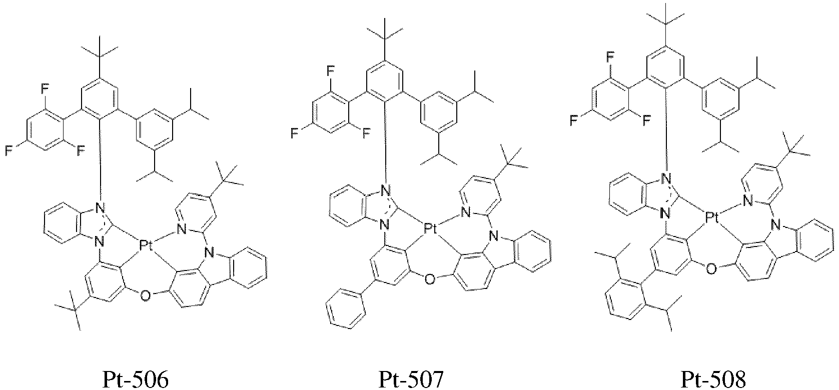

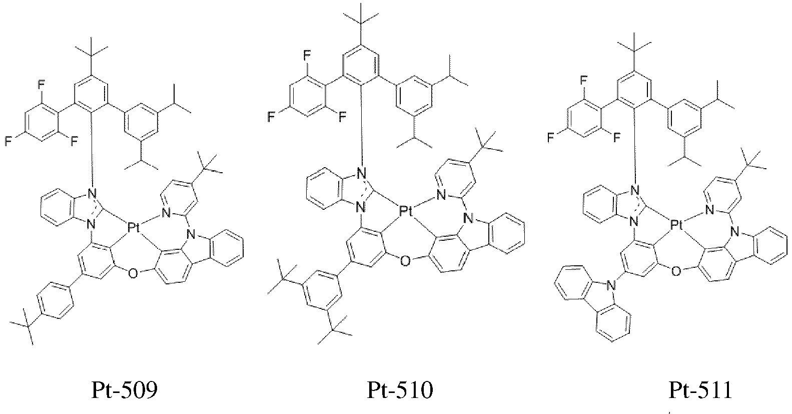

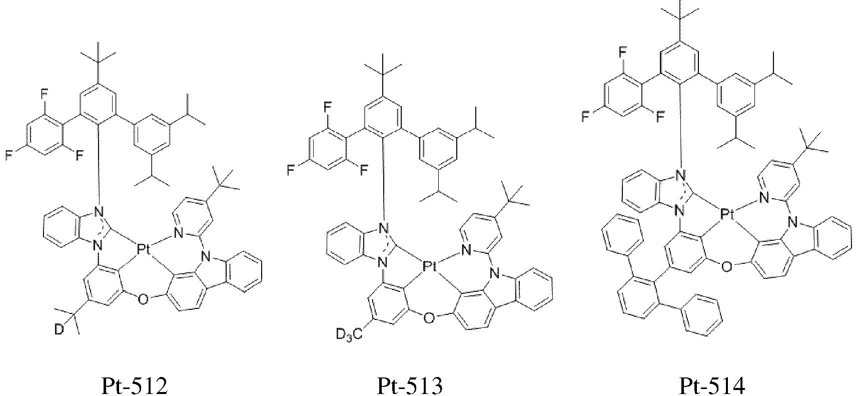

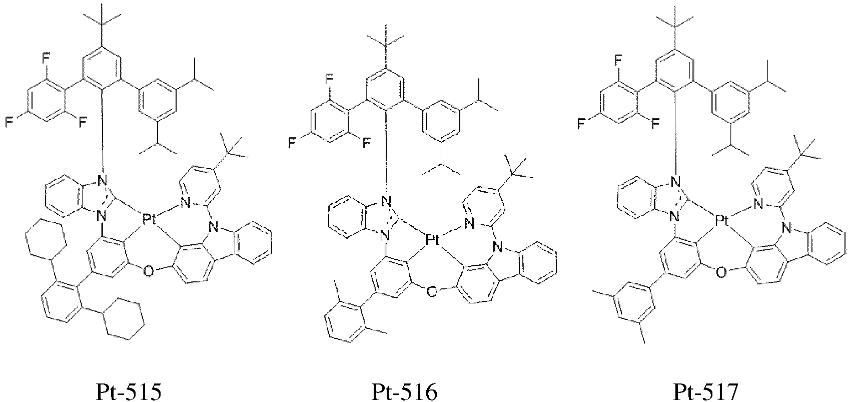

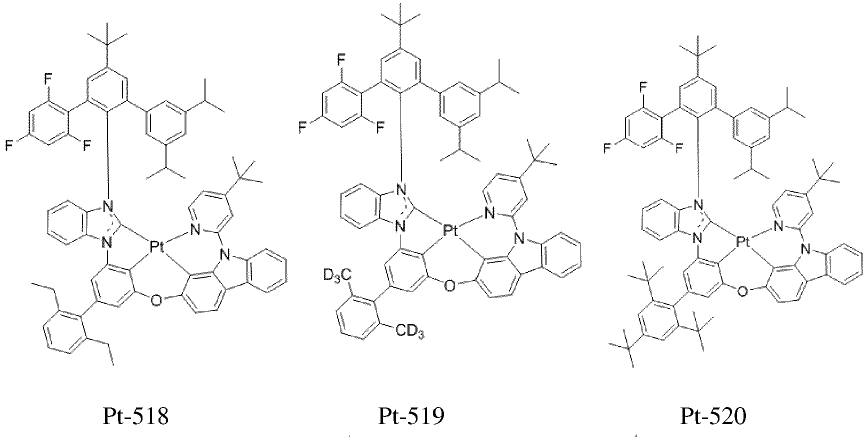

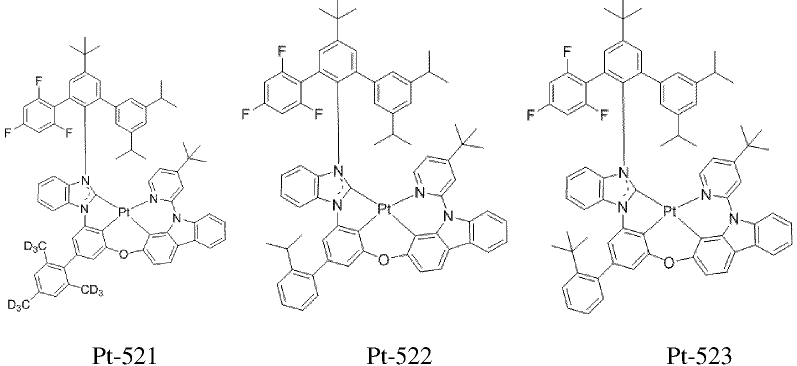

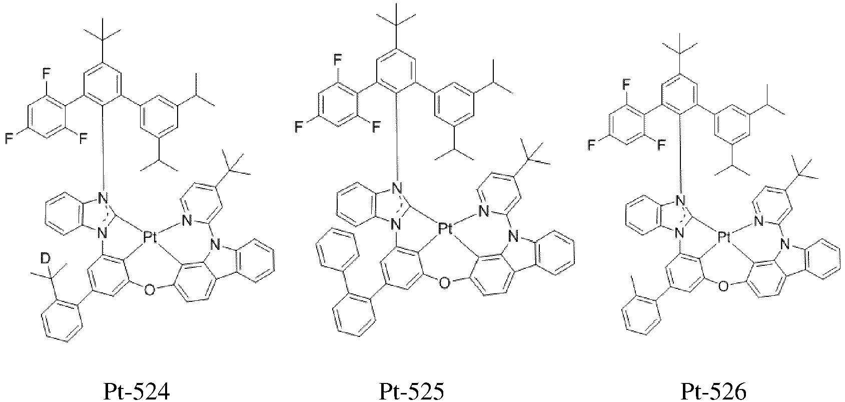

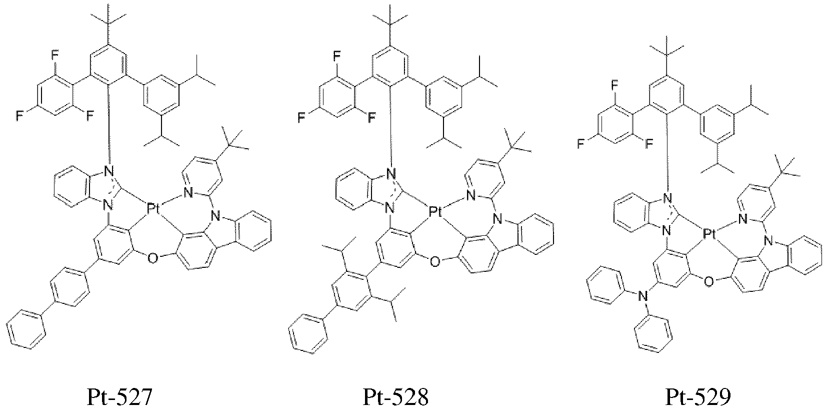

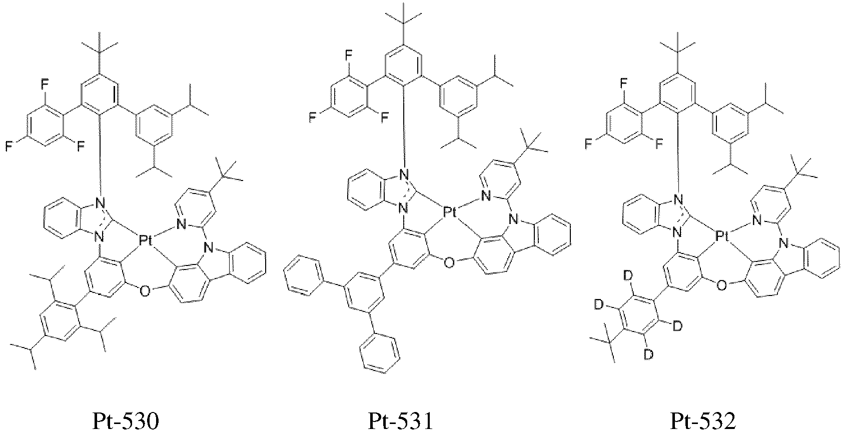

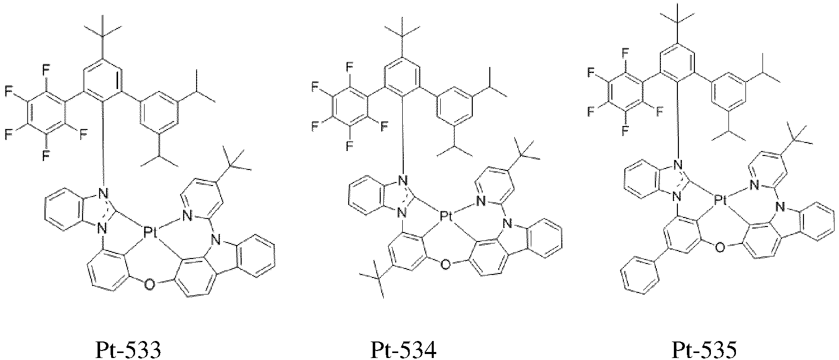

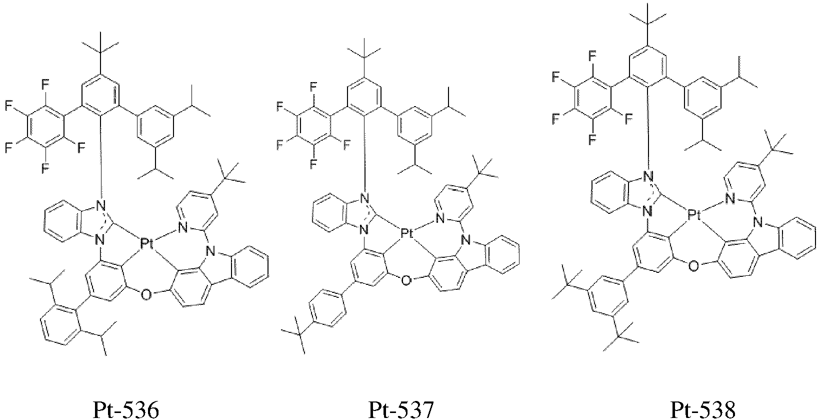

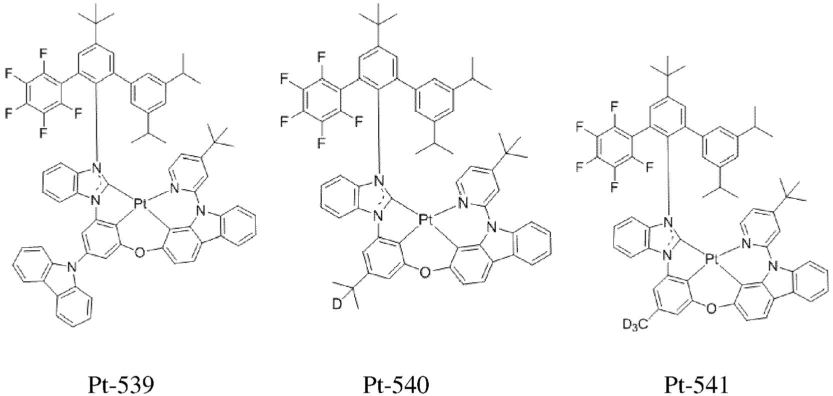

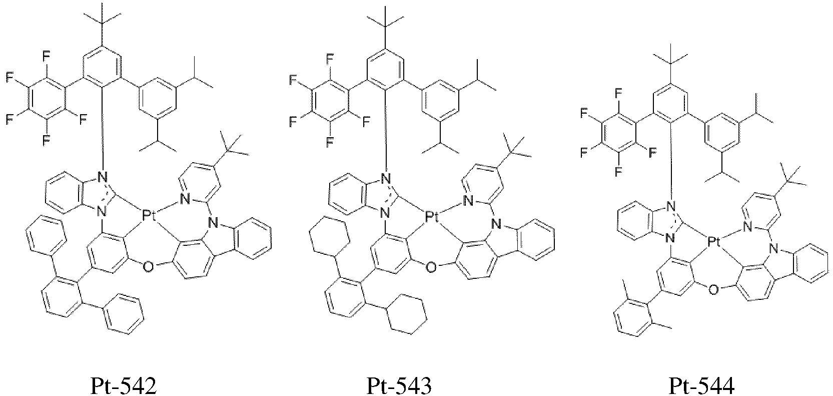

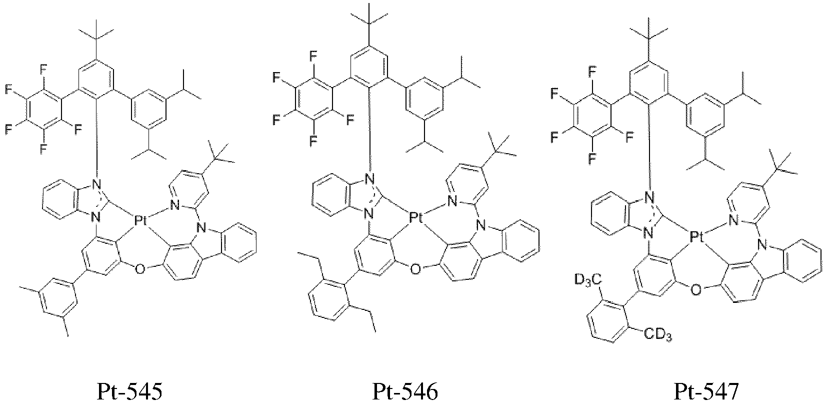

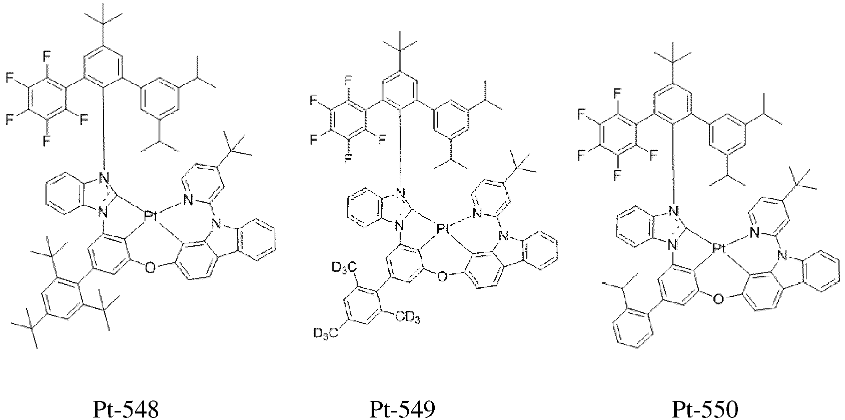

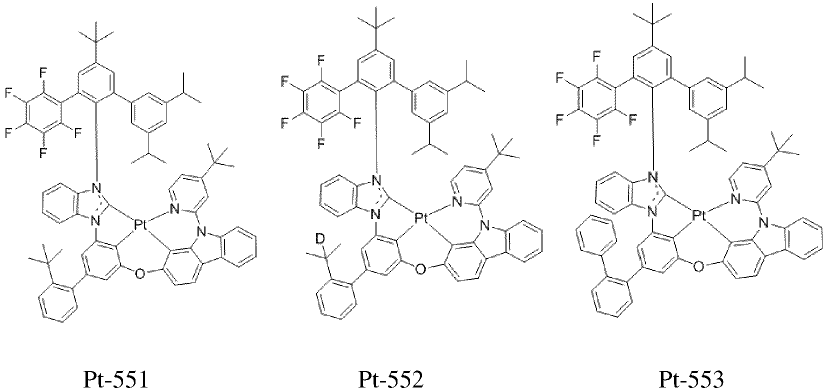

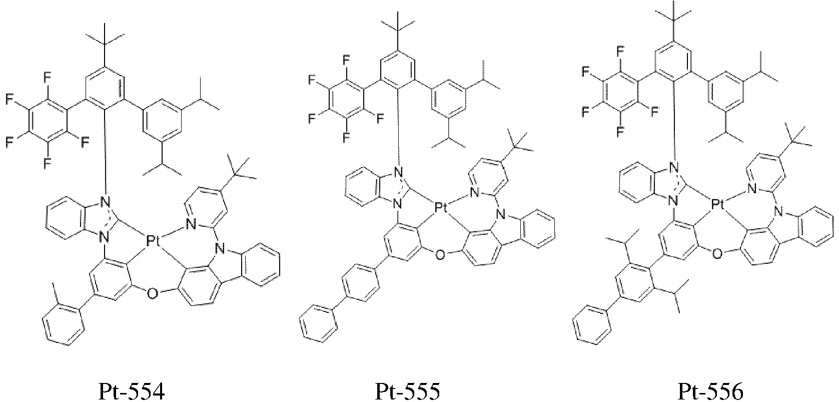

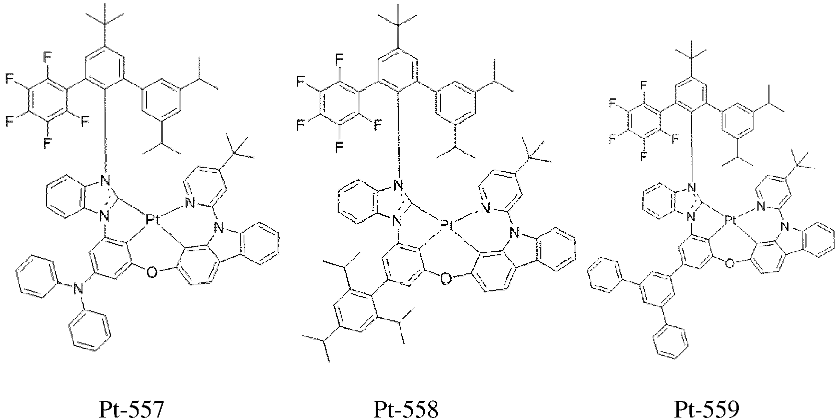

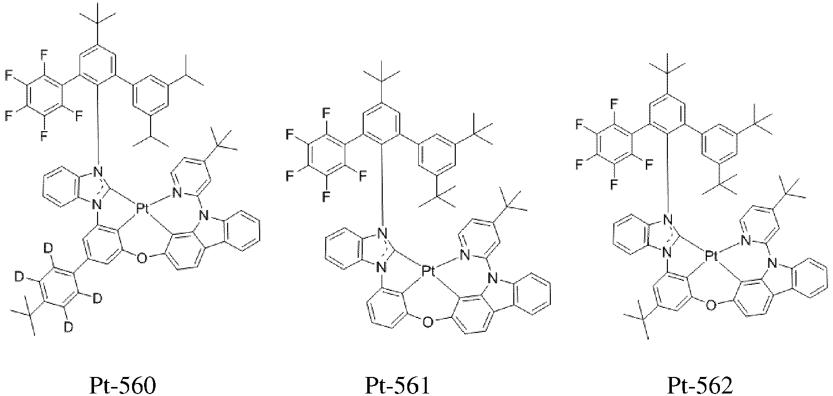

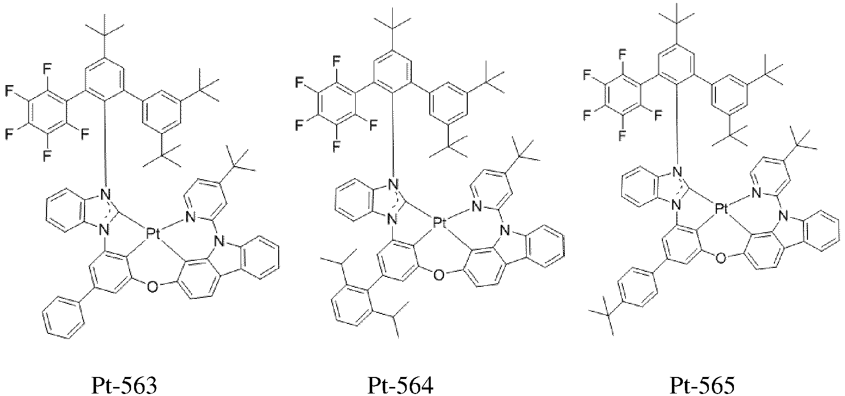

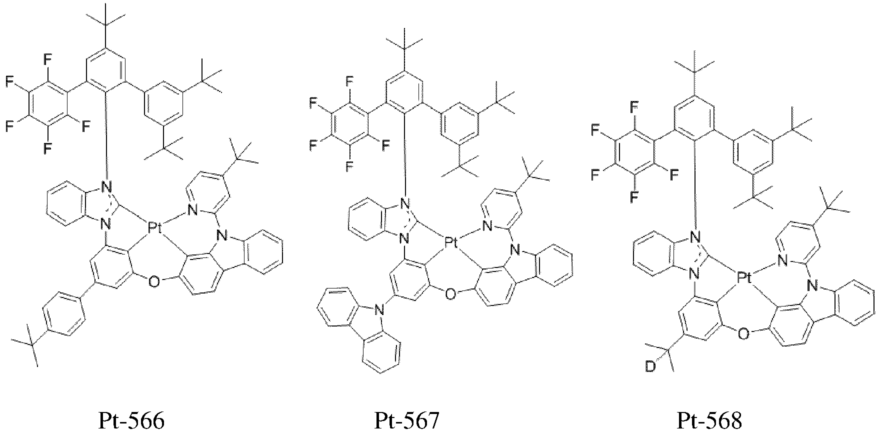

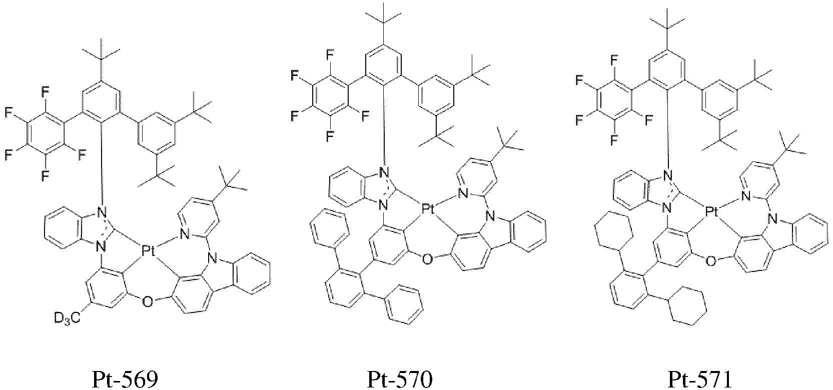

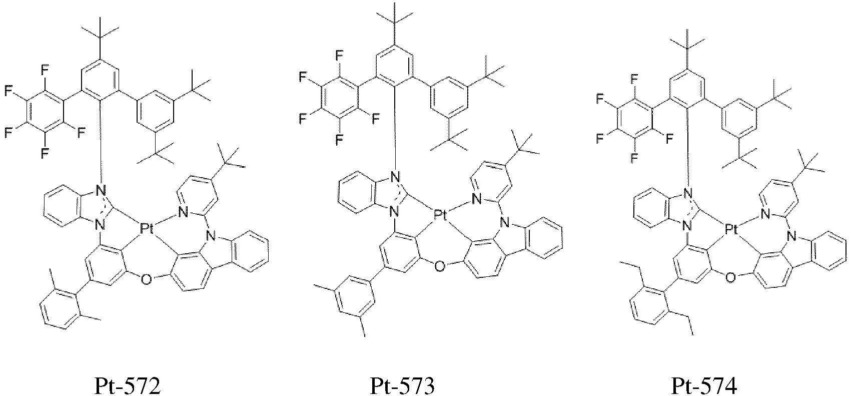

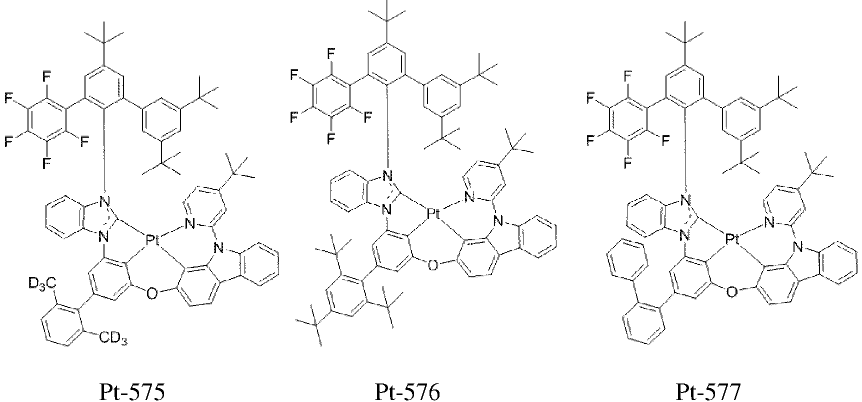

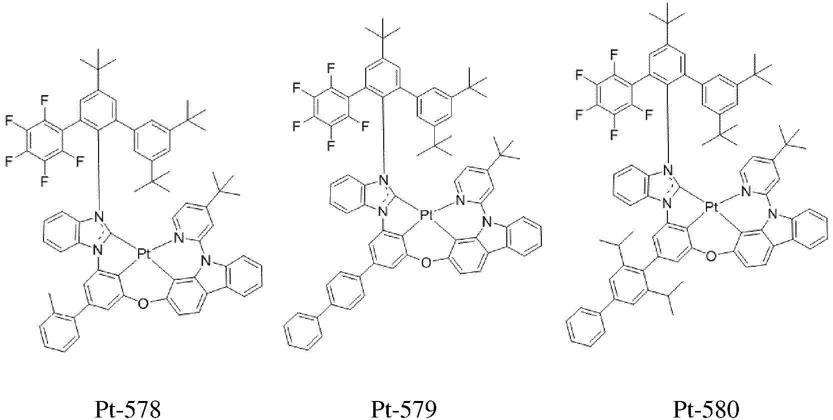

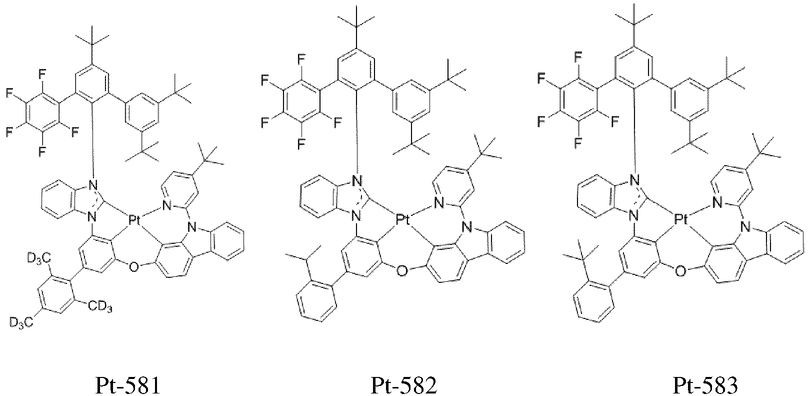

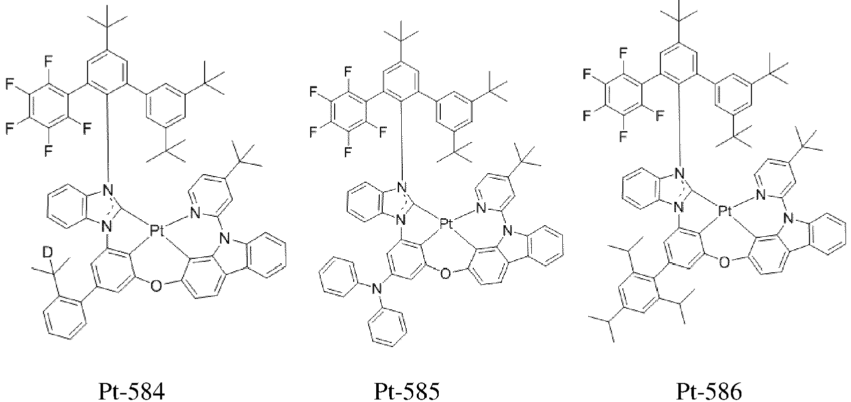

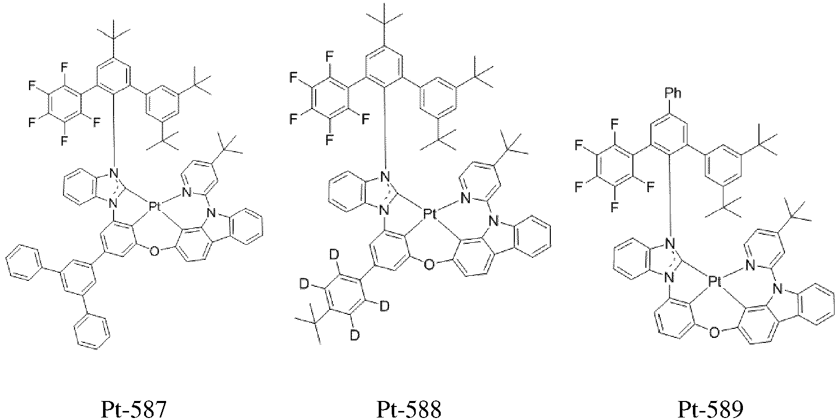

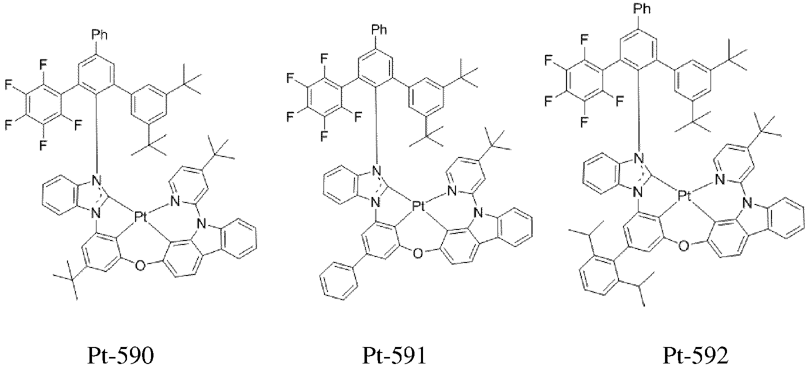

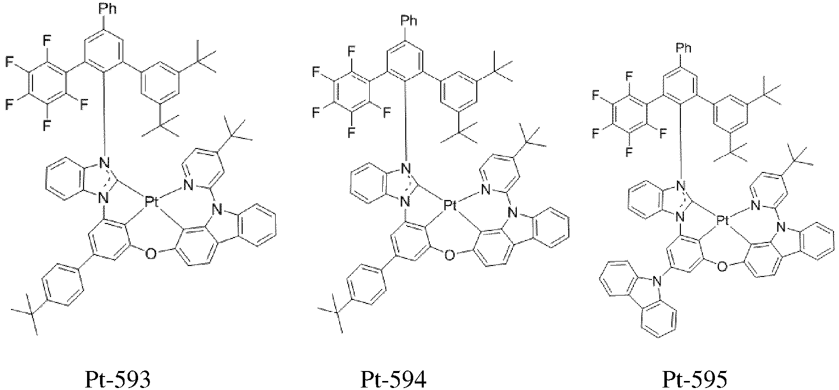

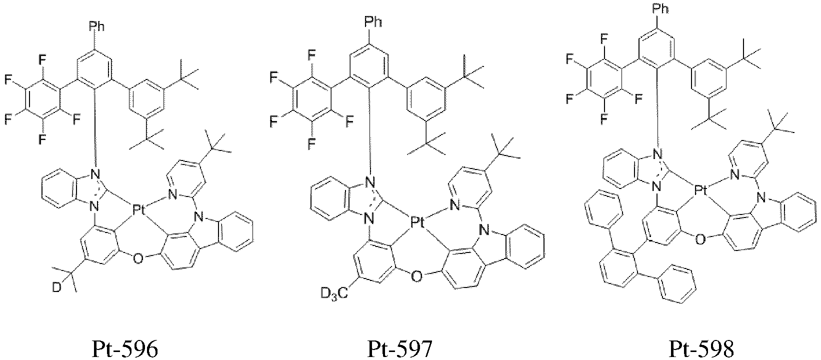

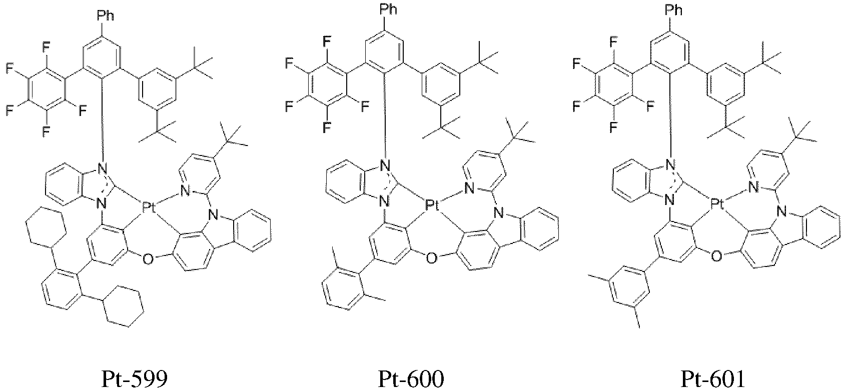

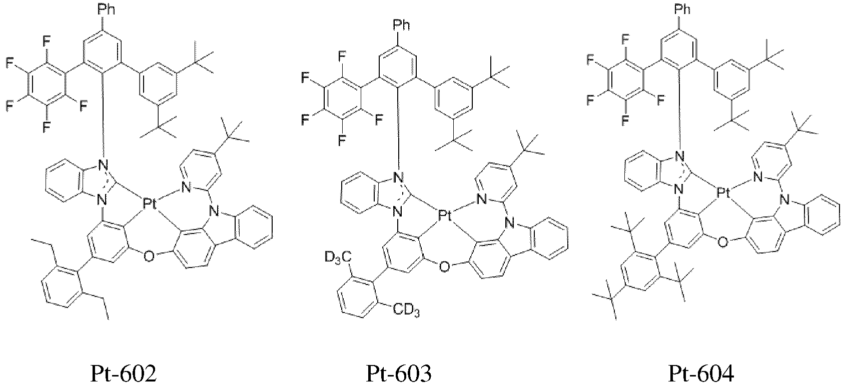

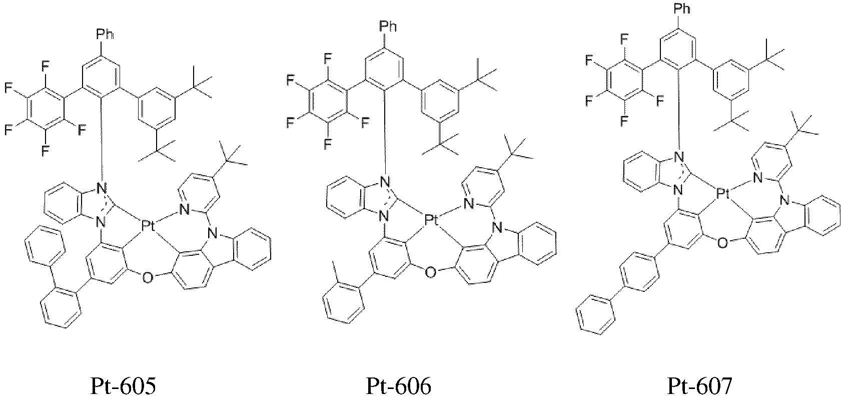

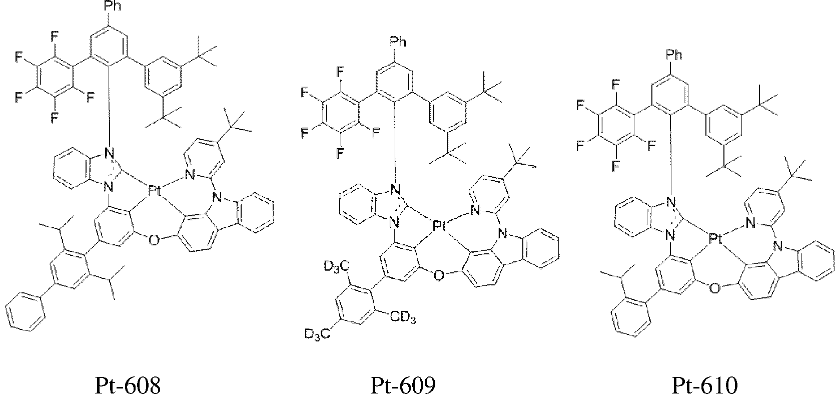

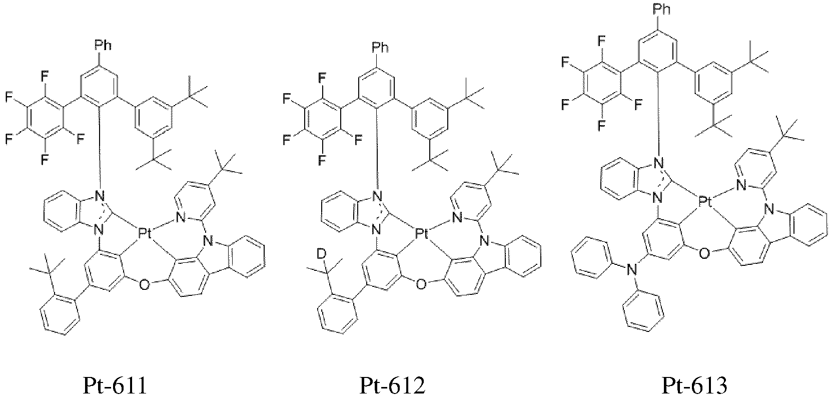

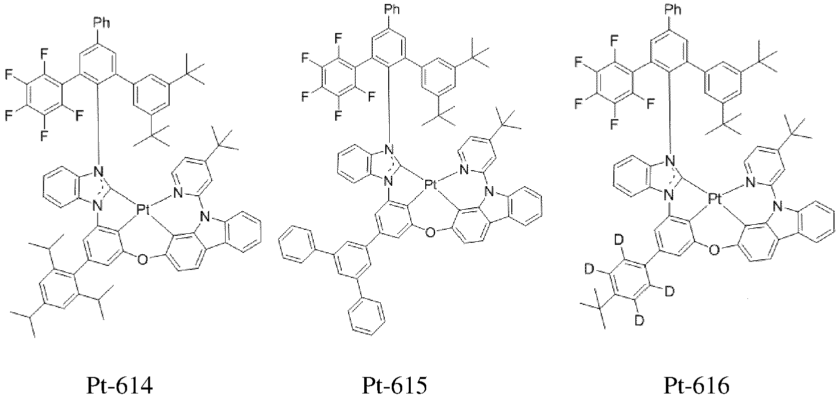

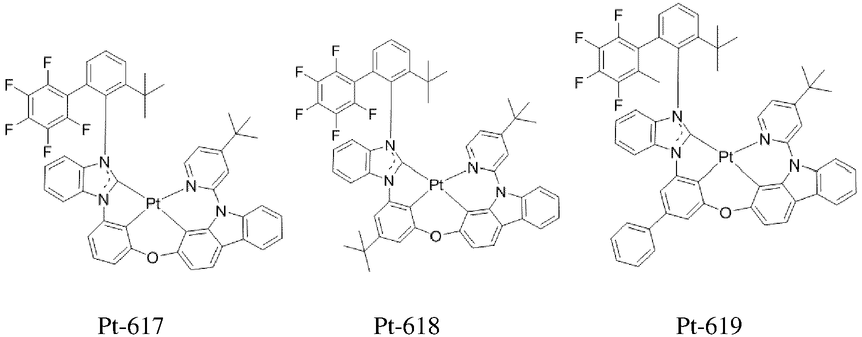

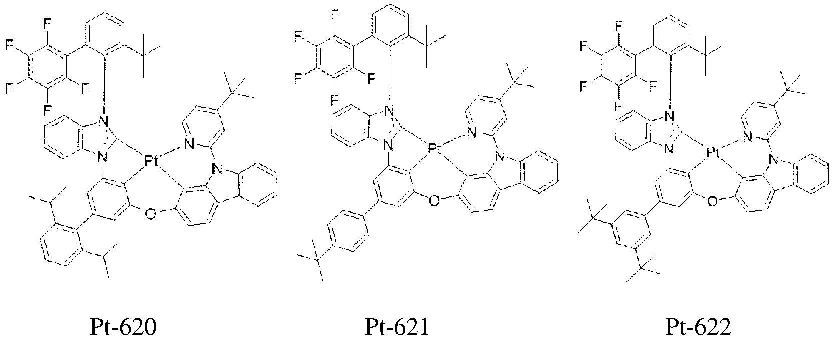

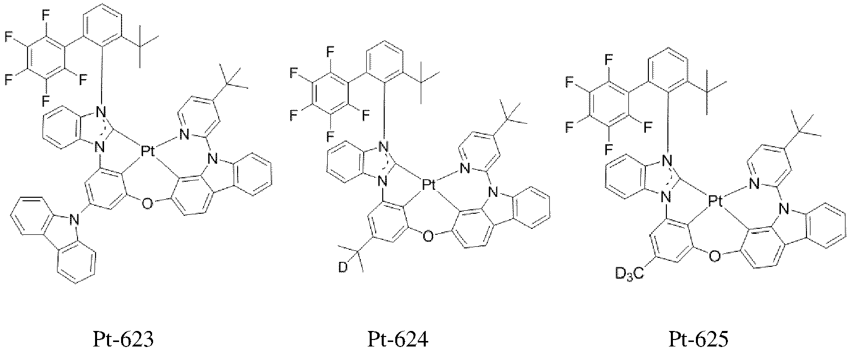

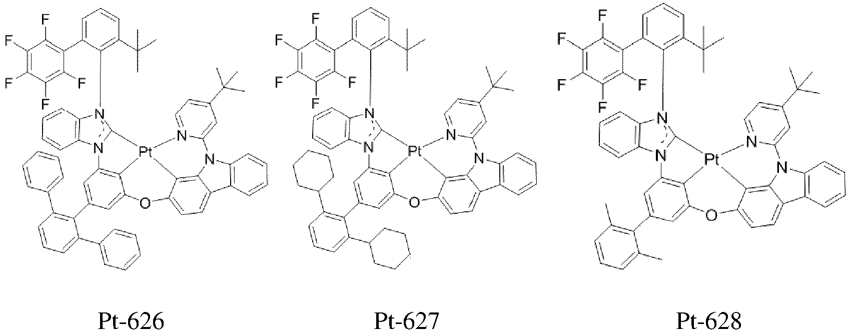

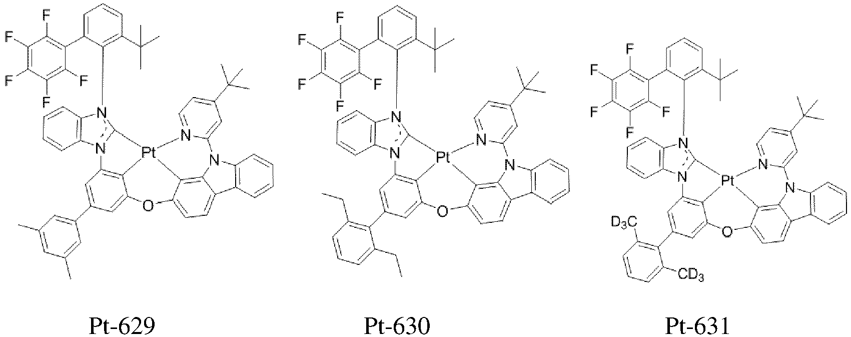

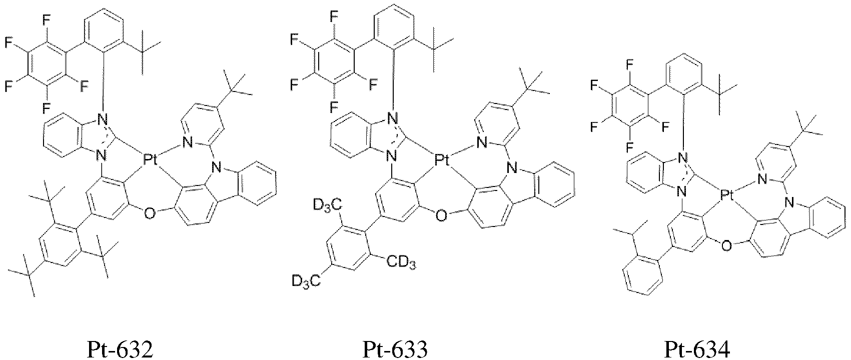

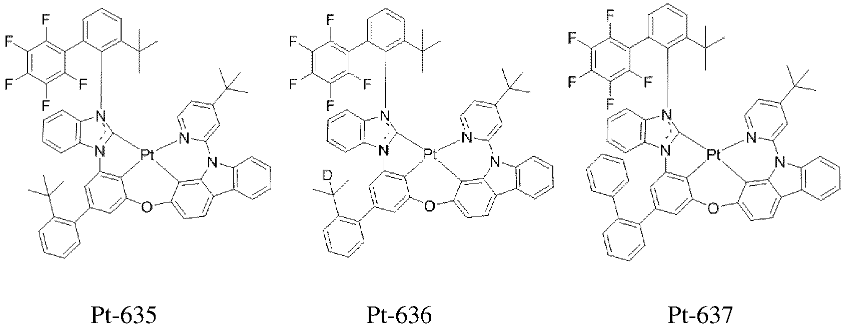

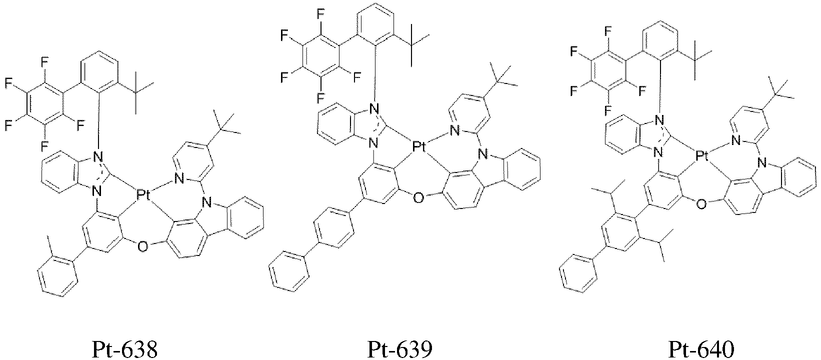

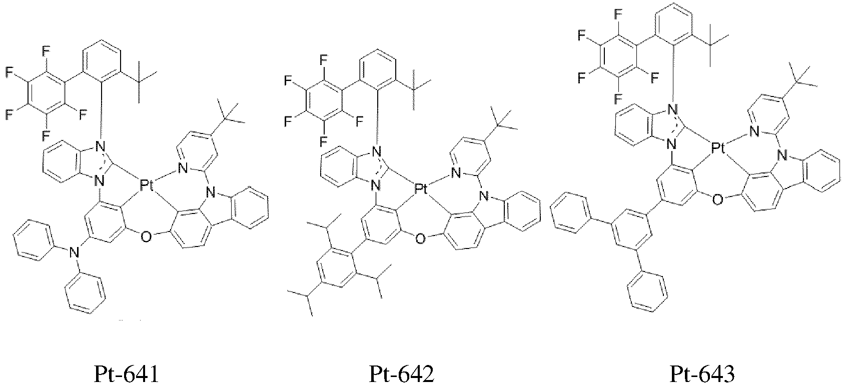

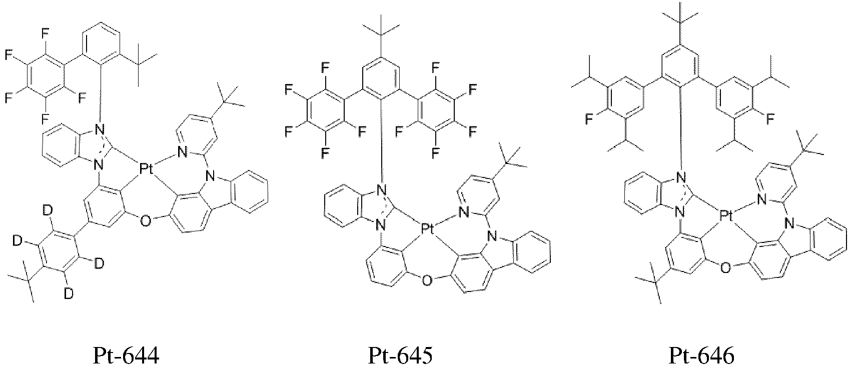

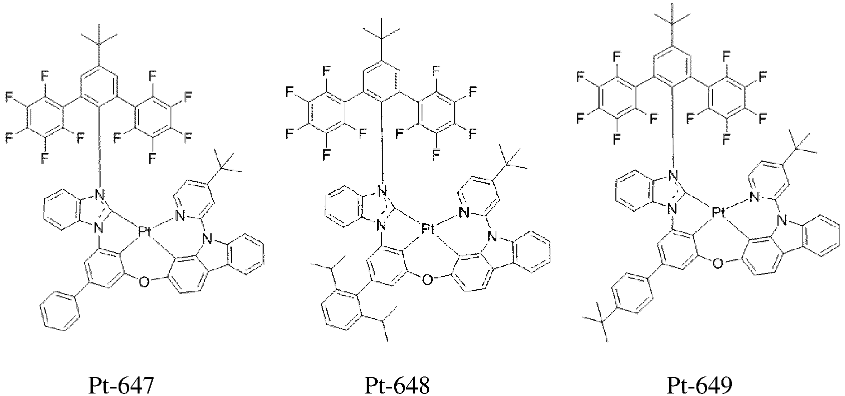

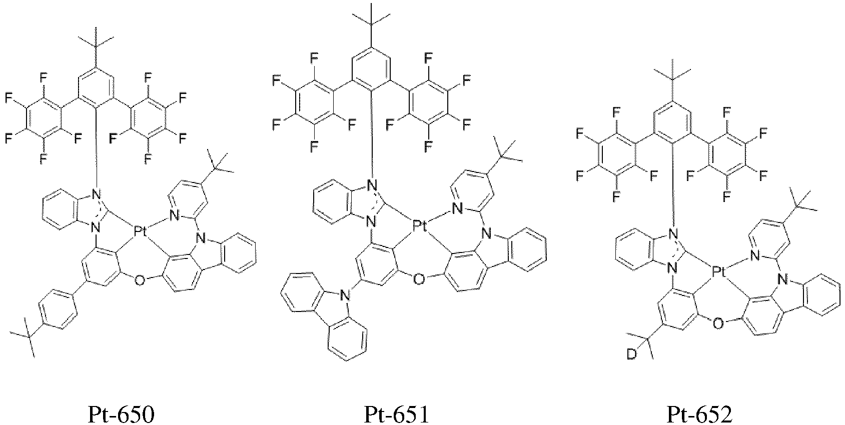

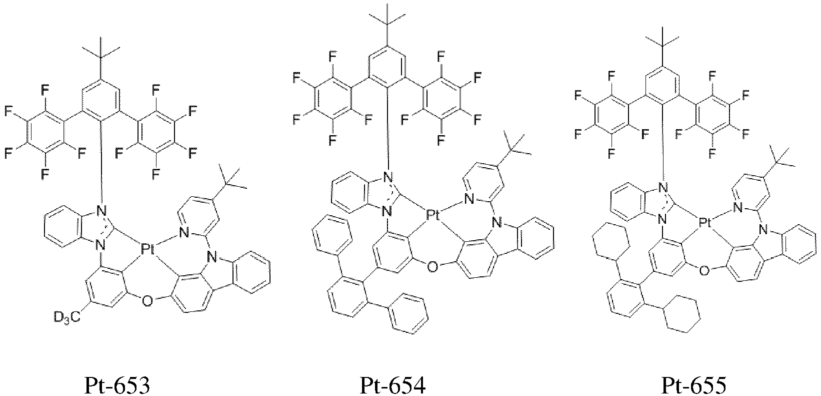

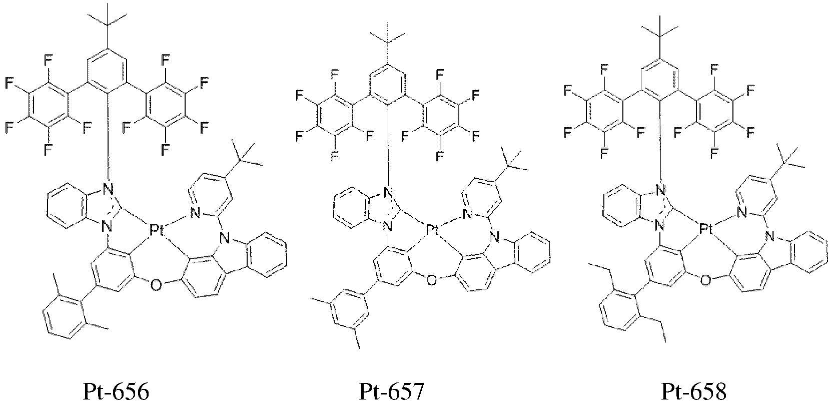

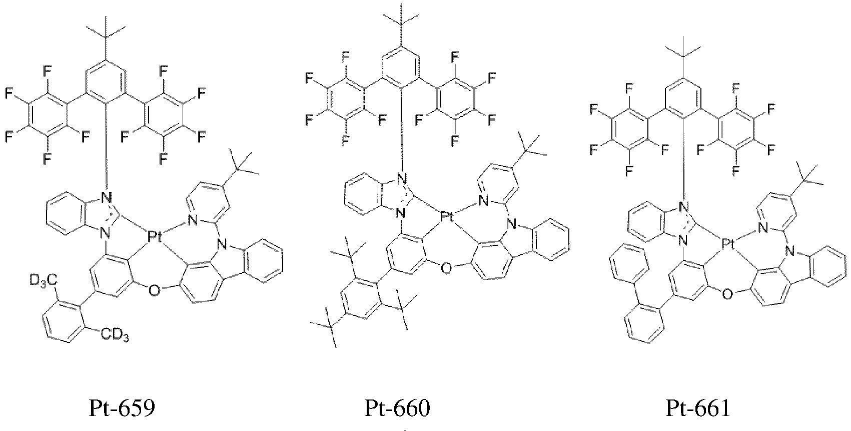

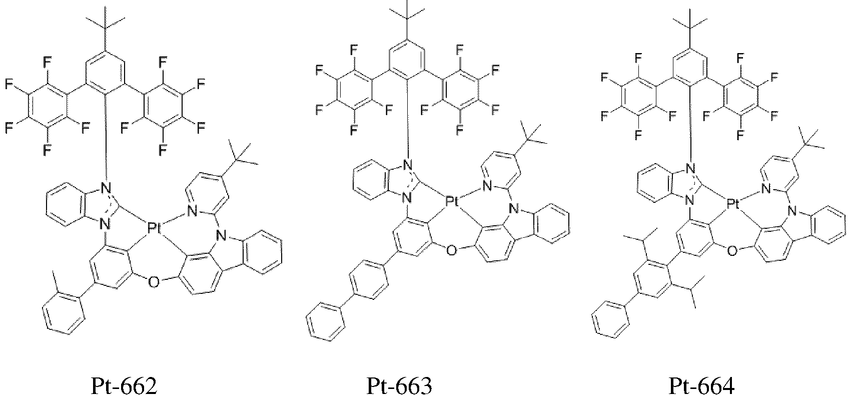

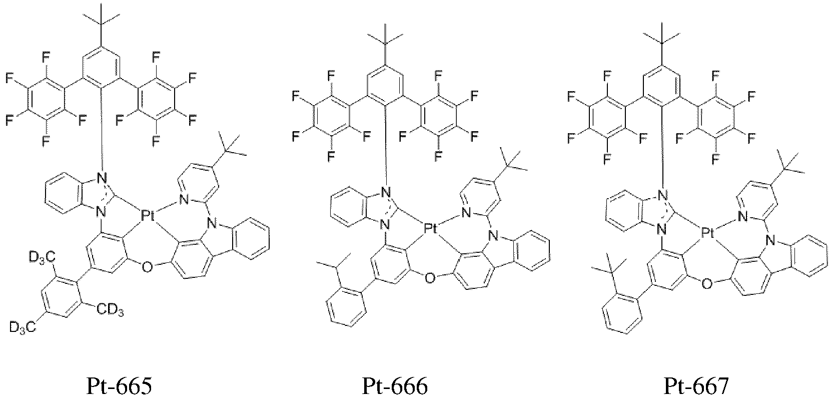

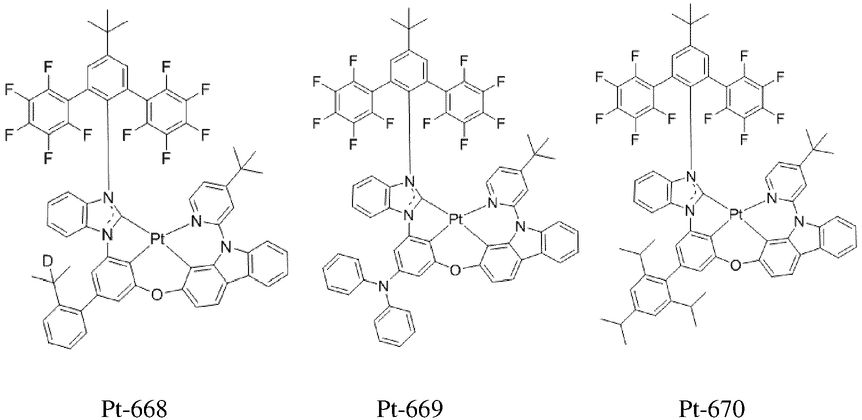

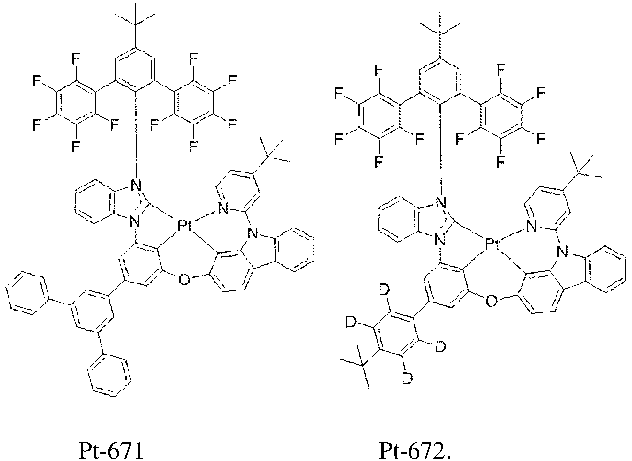

Furthermore, the present application also provides an application of the fluorinated tetradentate platinum (II) complexes with the structure shown in Formula (I) or Formula (II) or the structure of one of Pt-1 to Pt-672, in electronic devices.

Furthermore, the electronic devices include organic electroluminescent devices (OLEDs), organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field quenching devices (O-FQDs), luminescent electrochemical cells (LECs), and organic laser diodes (O-laser).

On the other hand, the present application also provides an organic electroluminescent device, wherein the organic electroluminescent device comprises a cathode, an anode, and an organic functional layer between the cathode and the anode; the organic functional layer contains the fluorinated tetradentate platinum (II) complex with the structure shown in Formula (I) or Formula (II), or the structure of one of Pt-1 to Pt-672, as described above.

Furthermore, the organic functional layer comprises a luminescent layer, wherein the luminescent layer comprises the fluorinated tetradentate platinum (II) complex with the structure shown in Formula (I) or Formula (II), or the structure of one of Pt-1 to Pt-672, as described above.

Furthermore, the luminescent layer further comprises a fluorescent doped material; the fluorescent doped material is a compound represented by Formula (BN1) or Formula (BN2): 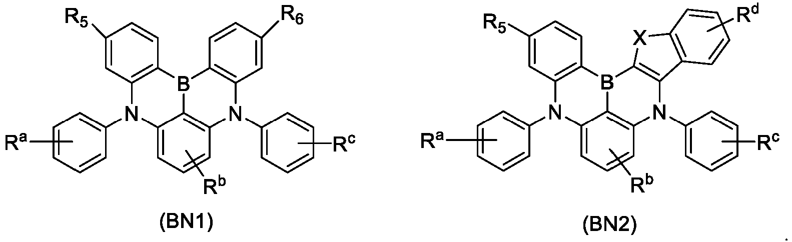
Where, X represents O, S, Se or NR³⁰⁰, and X₁ represents Se or N;
R^{a}-R^{d} are each independently represented as mono-substitution, bi-substitution, tri-substitution, tetra-substitution, or unsubstitution; R^{a}-R^{d} are each independently selected from the group consisting of hydrogen, deuterium, N, a C1-C30 alkyl, and a C6-C60 aryl;
R₅ and R₆ are each independently selected from the group consisting of a substituted or unsubstituted diphenylamine group, and a substituted or unsubstituted carbazole group; when a substituent is present, the substituent is selected from deuterium, a C1-C30 alkyl, and a C6-C30 aryl.

Furthermore, the fluorescent doped material has any one of the following chemical structures, where Ph represents a phenyl group:

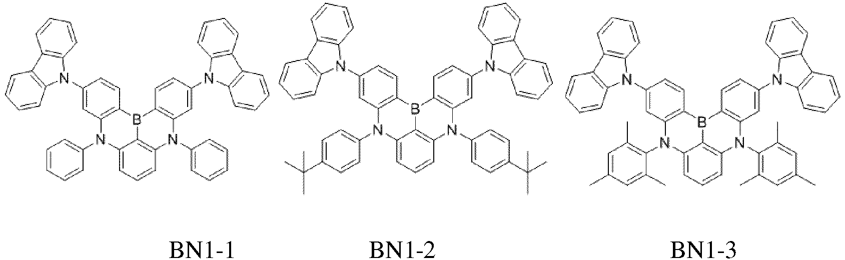

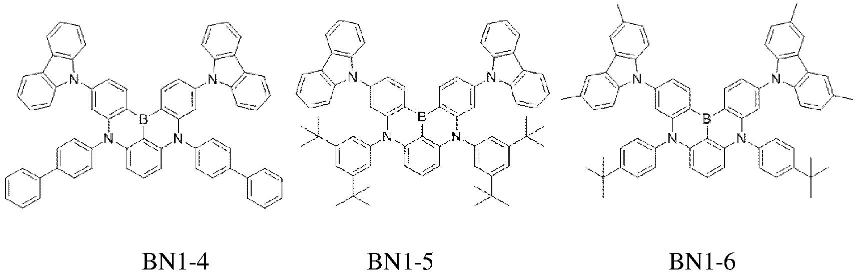

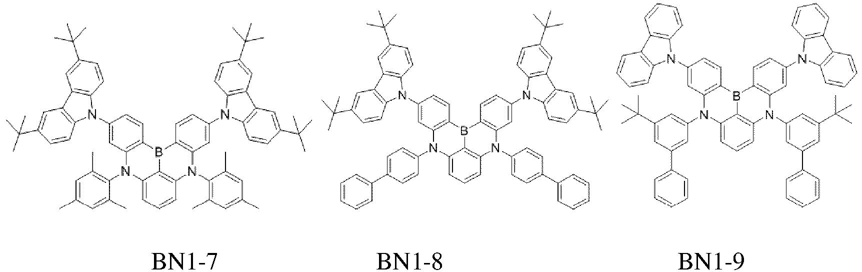

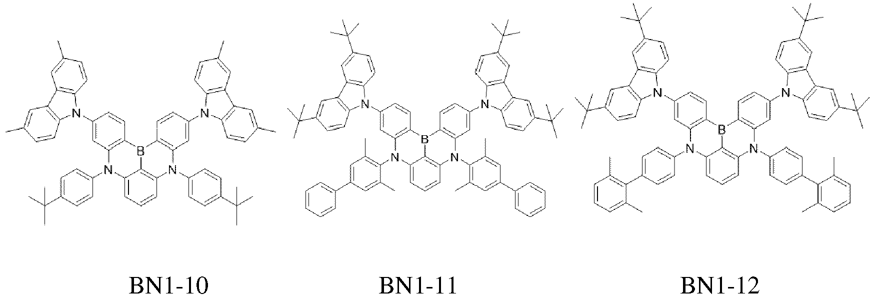

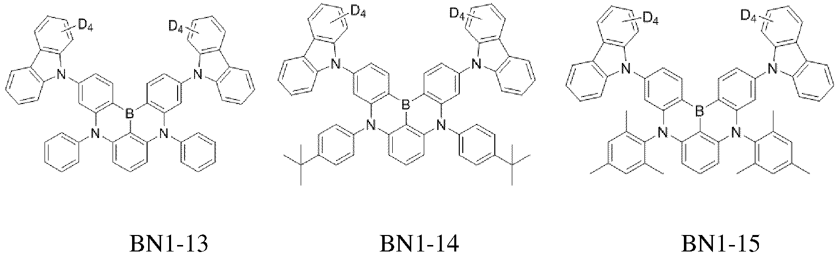

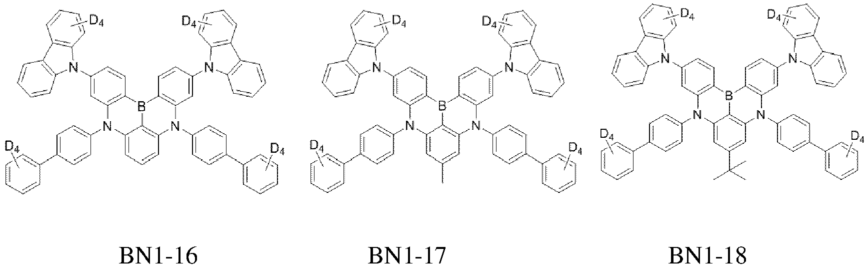

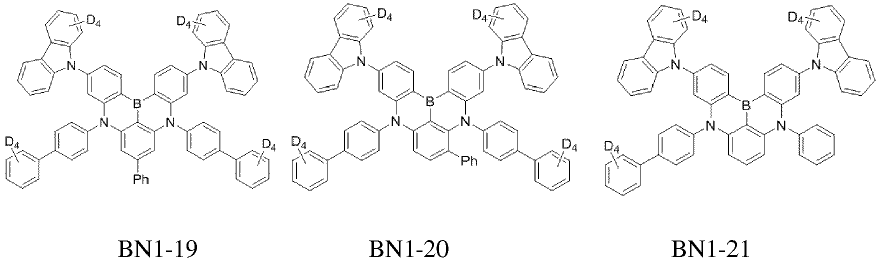

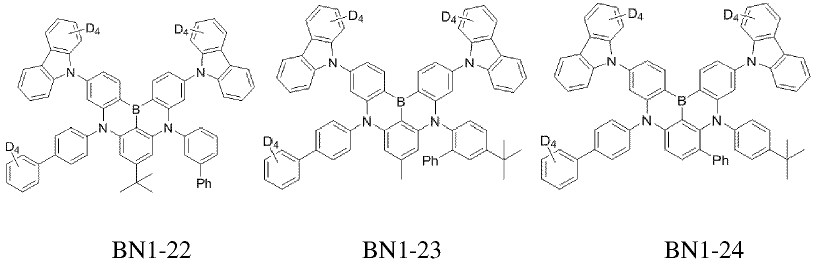

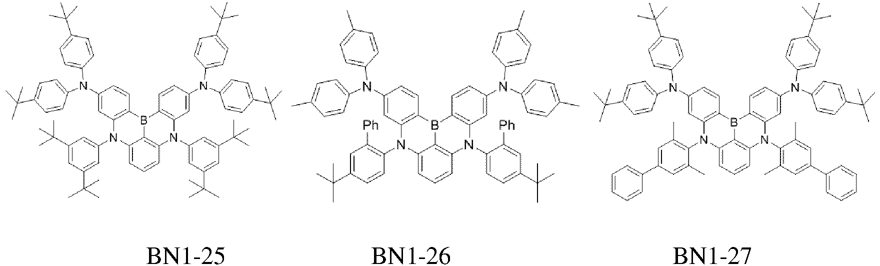

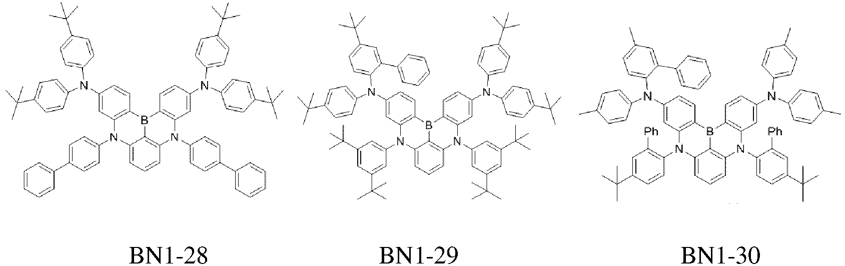

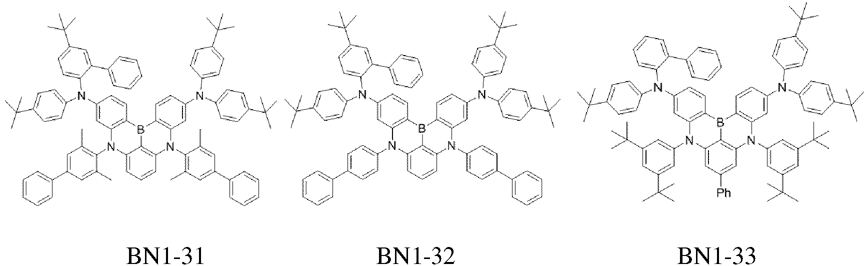

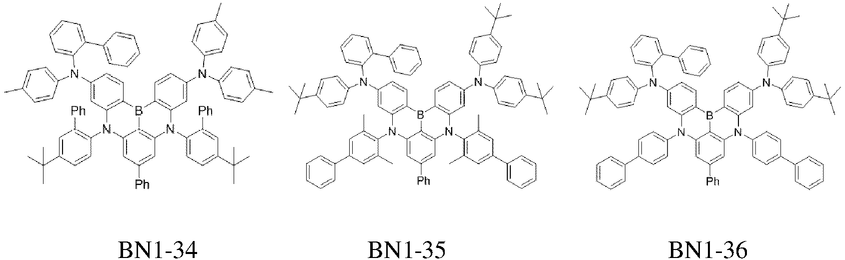

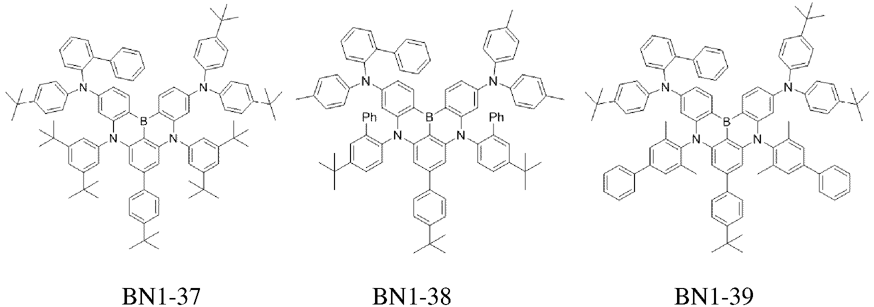

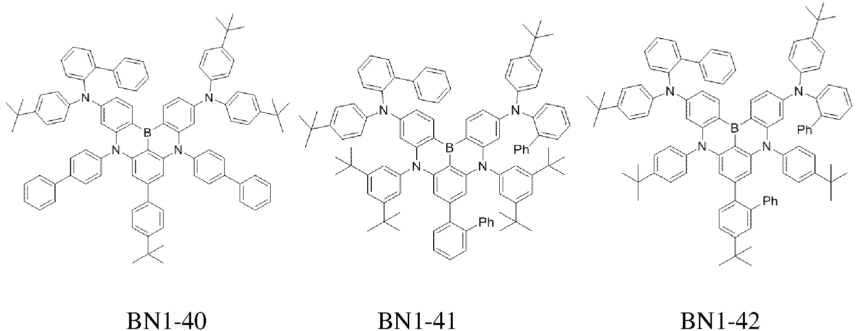

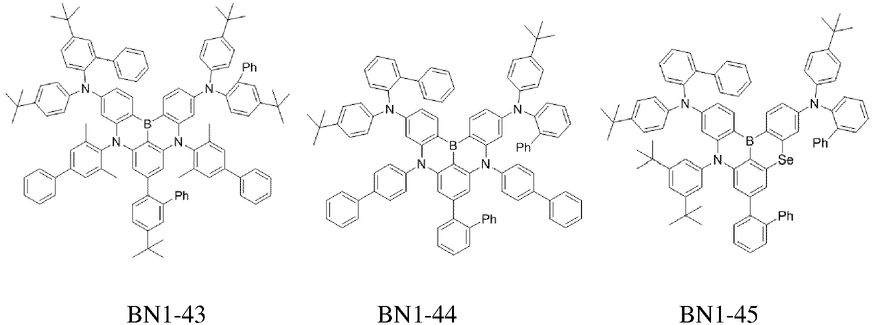

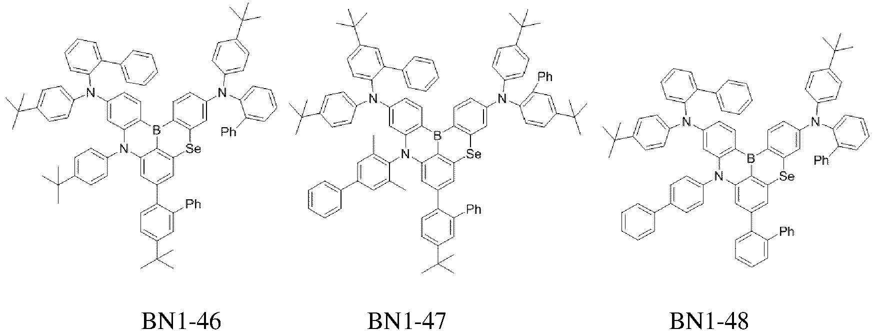

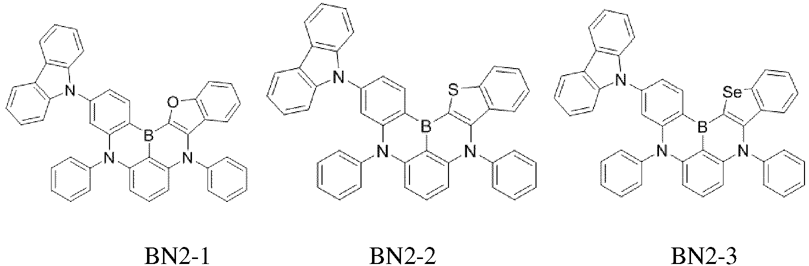

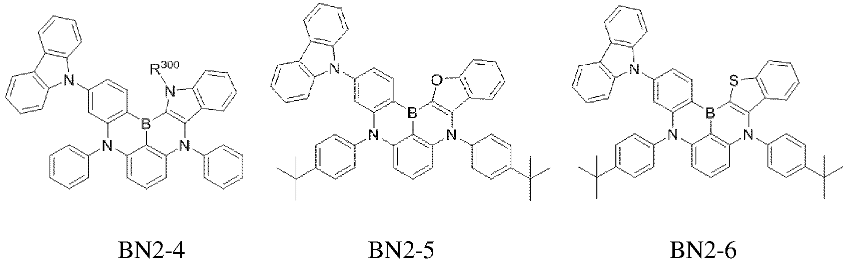

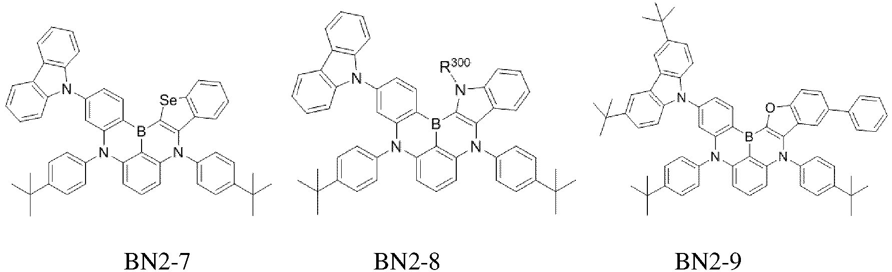

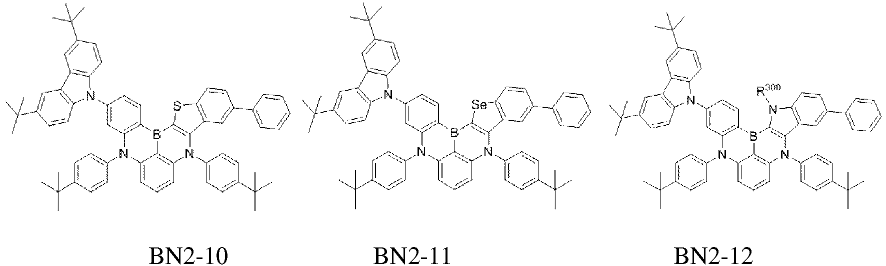

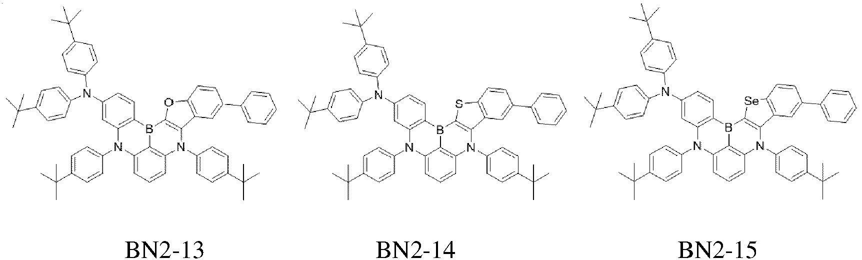

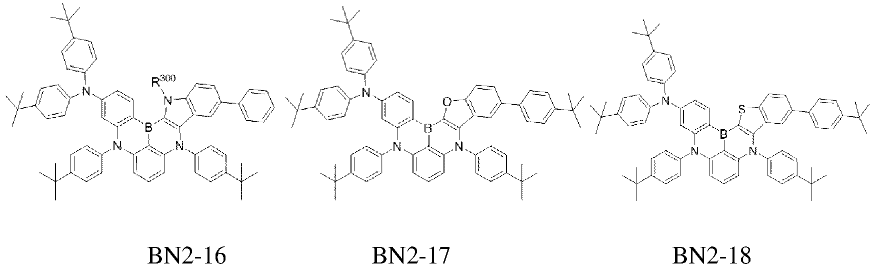

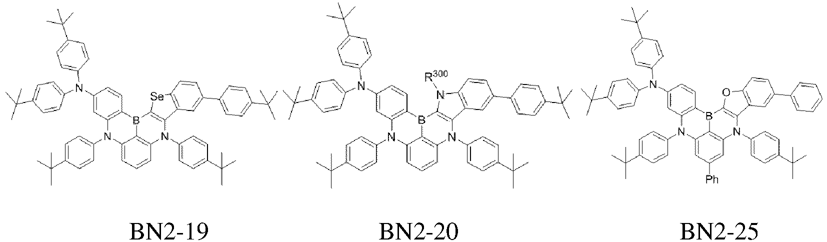

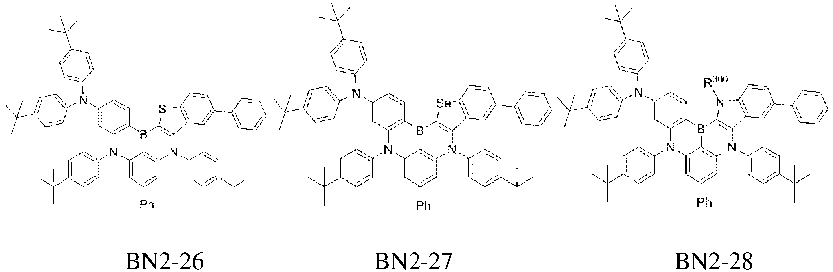

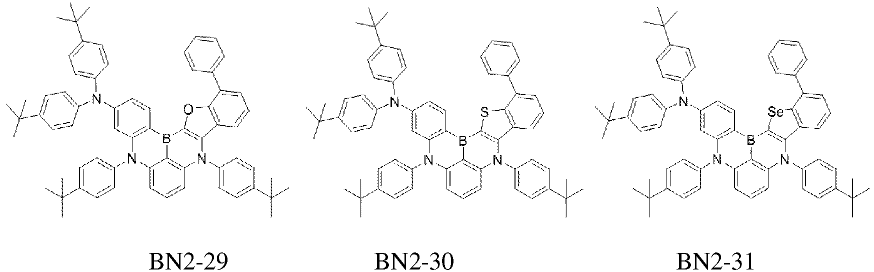

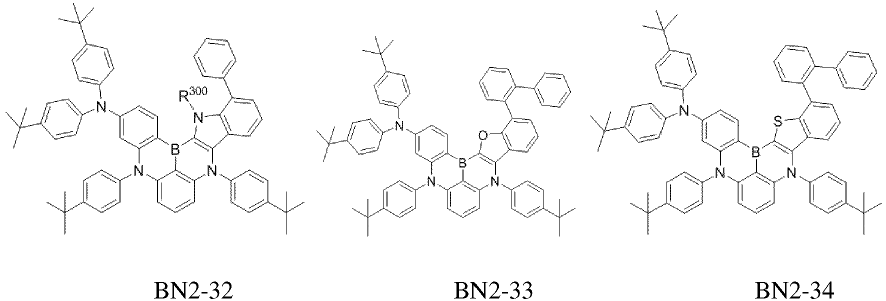

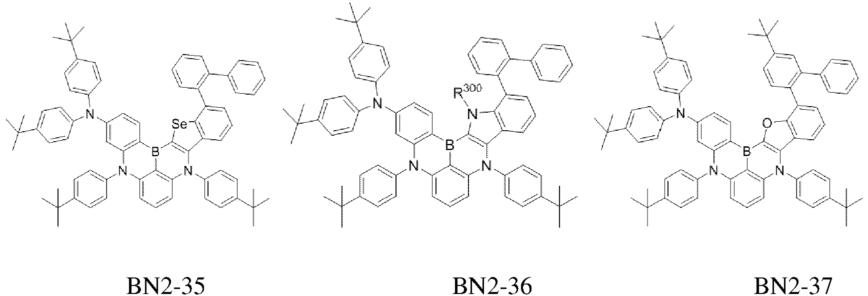

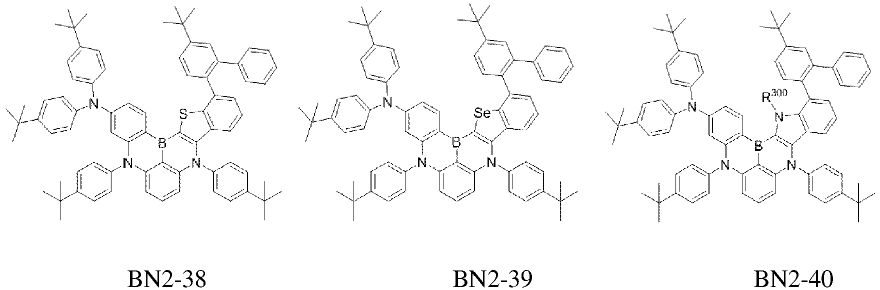

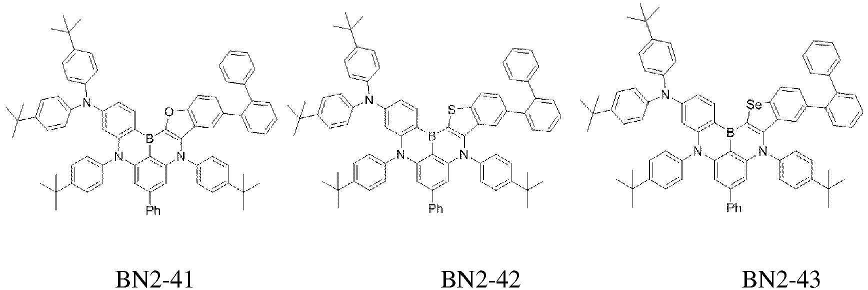

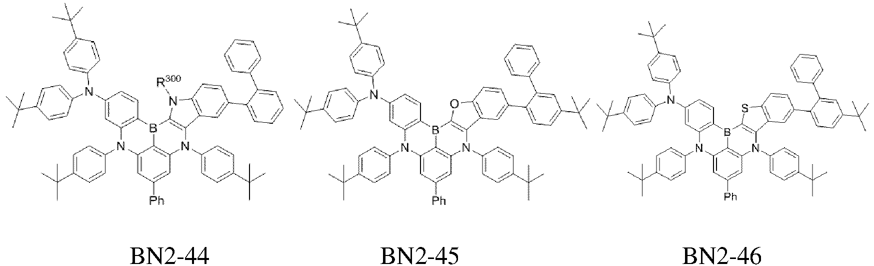

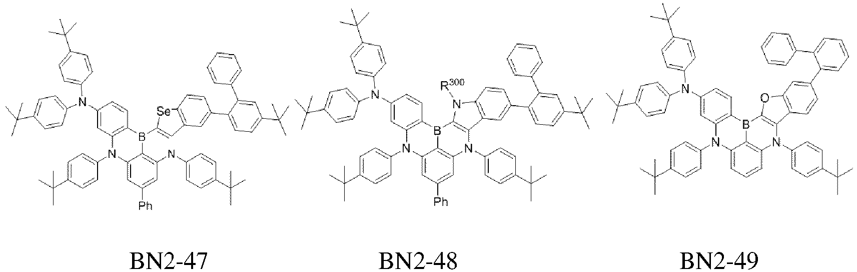

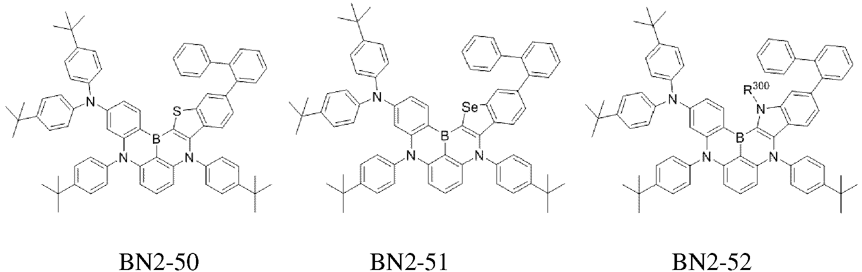

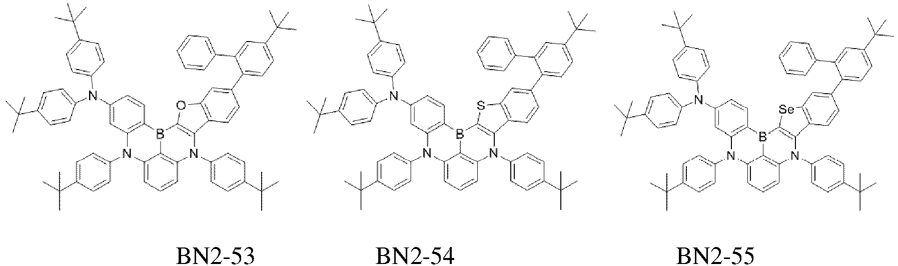

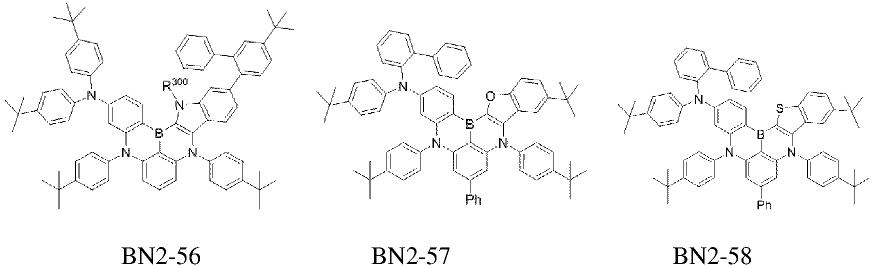

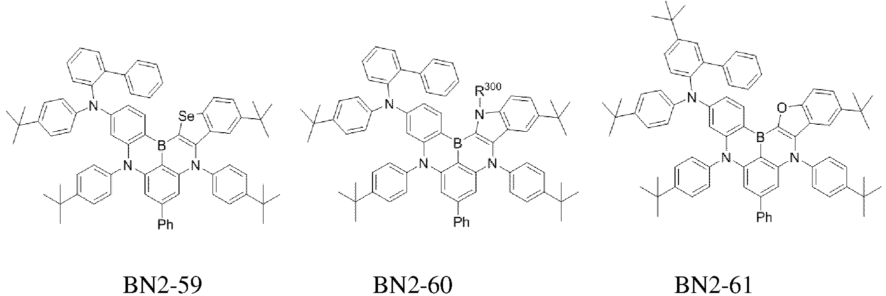

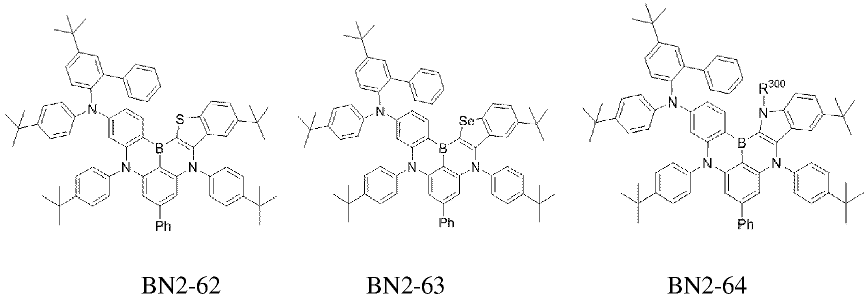

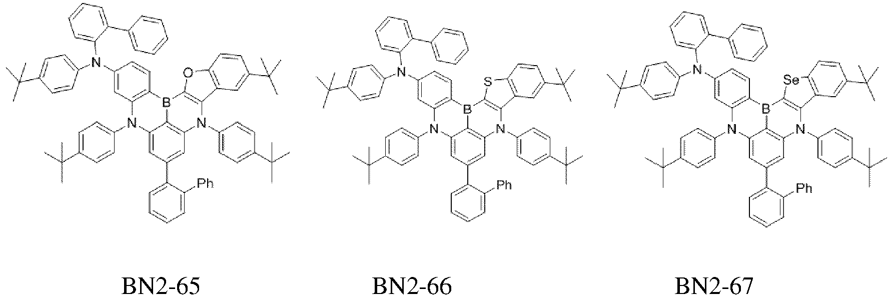

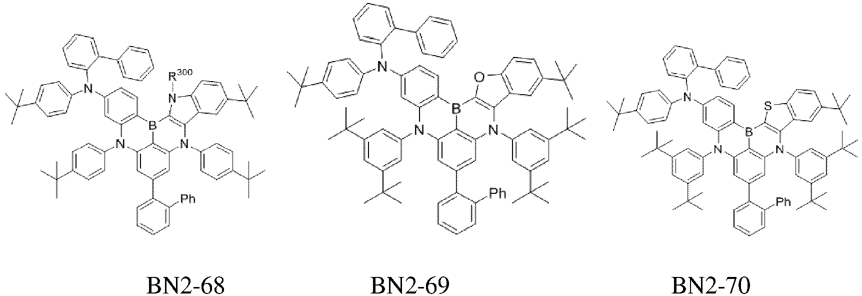

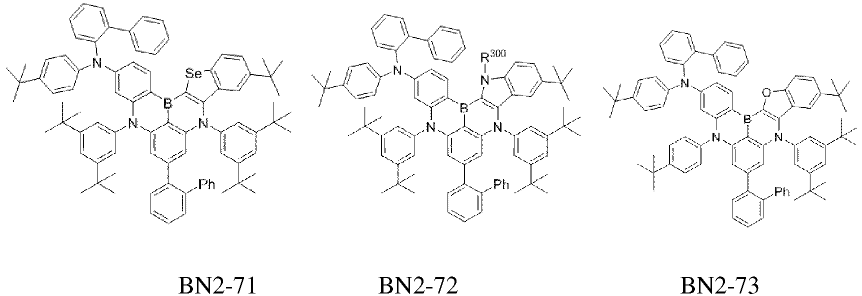

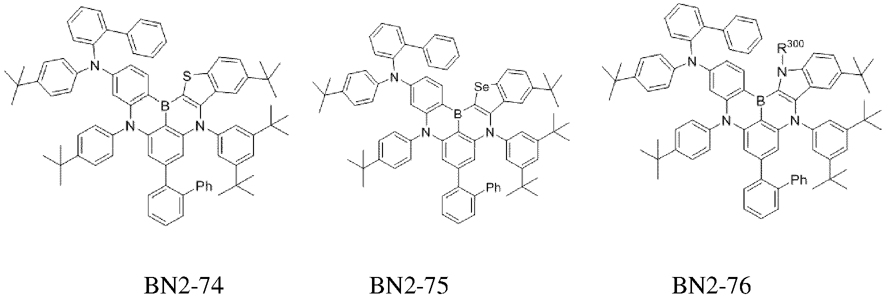

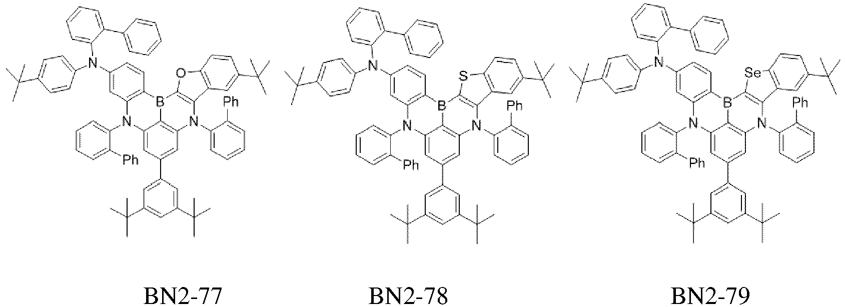

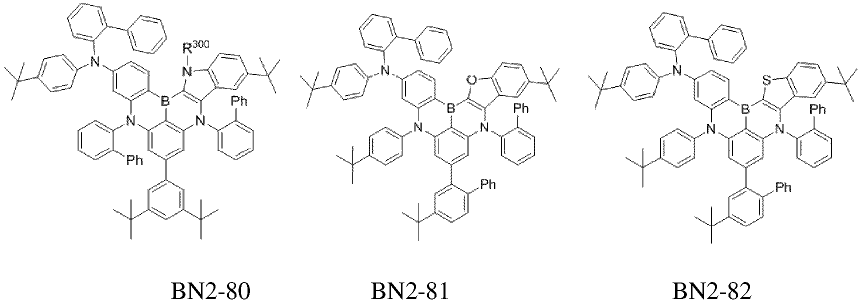

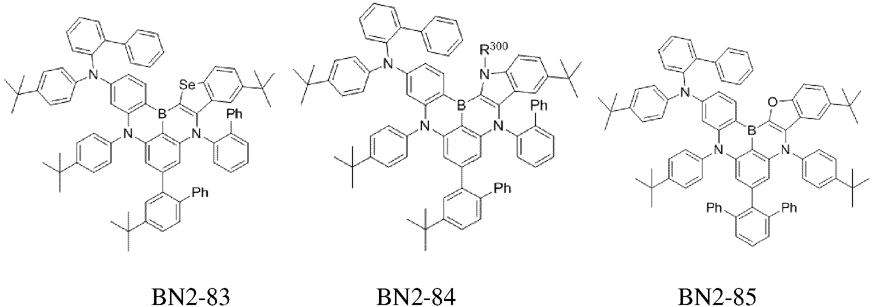

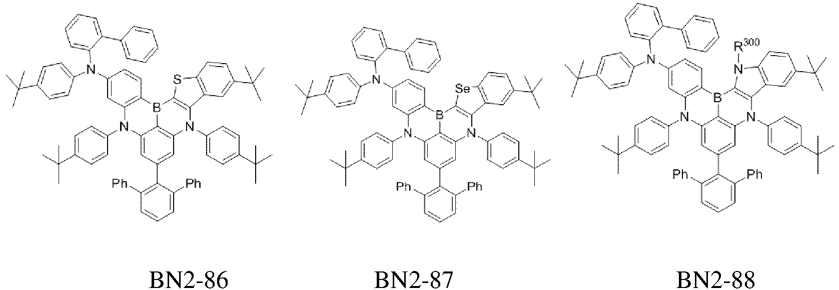

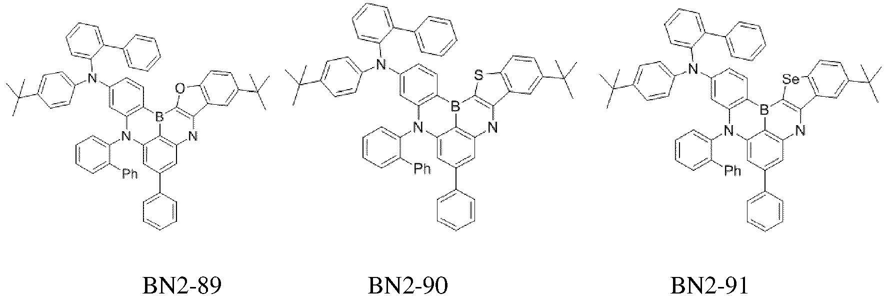

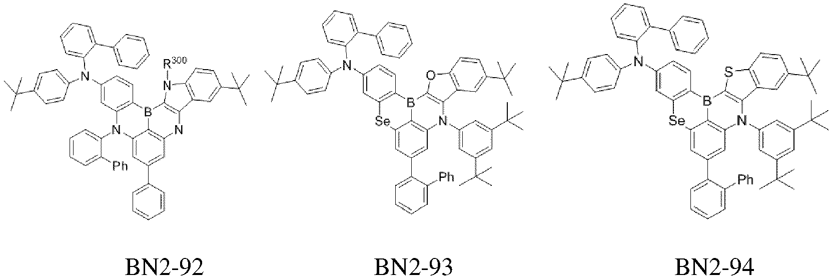

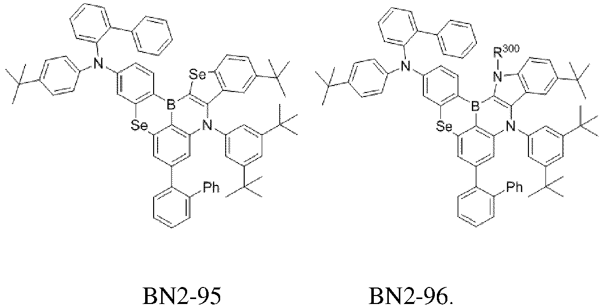

On the other hand, the present application also provides an organic optoelectronic device, which comprises: a substrate layer; a first electrode, wherein the first electrode is above the substrate; an organic luminescent functional layer, wherein the organic luminescent functional layer is above the first electrode; a second electrode, wherein the second electrode is above the organic luminescent functional layer; wherein, the organic luminescent functional layer comprises the fluorinated tetradentate platinum (II) complex with the structure shown in Formula (I) or Formula (II), or the structure of one of Pt-1 to Pt-672, as described above. For example, platinum (II) complexes can be included as luminescent materials in the organic luminescent functional layer.

Furthermore, the organic luminescent functional layer also includes the fluorescent doped material represented by the Formula (BN1) or Formula (BN2) as described above.

The present application also provides a composition comprising the fluorinated tetradentate platinum (II) complex with the structure shown in Formula (I) or Formula (II), or the structure of one of Pt-1 to Pt-672, as described above. Preferably, the composition further comprises the fluorescent doped material represented by the Formula (BN1) or Formula (BN2) as described above.

The present application also provides a preparation comprising the fluorinated tetradentate platinum (II) complex with a structure as shown in Formula (I) or Formula (II), or the structure of one of Pt-1 to Pt-672, as described above, or the composition as described above and at least one solvent. There are no special restrictions on the solvent used, and unsaturated hydrocarbon solvents such as toluene, xylene, mesitylene, tetrahydronaphthalene, decahydronaphthalene, dicyclohexane, n-butylbenzene, sec-butylbenzene, tert-butylbenzene, etc., halogenated saturated hydrocarbon solvents such as carbon tetrachloride, chloroform, dichloromethane, dichloroethane, chlorobutane, bromobutane, chloropentane, bromopenane, chlorohexane, bromohexane, chlorocyclohexane, bromocyclohexane, etc., halogenated unsaturated hydrocarbon solvents such as chlorobenzene, dichlorobenzene, trichlorobenzene, etc., ether solvents such as tetrahydrofuran, tetrahydropyran, etc., as well as ester solvents such as alkyl benzoate, etc., that are familiar to those skilled in the art can be used.

Preferably, the composition further comprises the fluorescent doped material represented by the Formula (BN1) or Formula (BN2) as described above.

The present application also provides a display or lighting equipment comprising one or more of the organic optoelectronic devices as described above.

Compared with the prior art, the present application has the following beneficial effects.

The present application provides a fluorinated tetradentate platinum (II) complex phosphorescent material. By introducing fluorine atoms at appropriate positions in its ligand, the charge distribution of its excited state can be improved, resulting in more metal to pyridocarbene charge transfer states (³MLCT) in its material excited state, which is beneficial for increasing its radiation rate and thus enhancing the device lifetime. The materials involved in the present application have good chemical stability and thermal stability, making it easy to prepare vapor deposited OLED devices. When combined with fluorescent doped materials, it can balance the transfer of holes and electrons, making energy transfer between the host and guest more efficient. The organic electroluminescent device made with the compound of the present application as the luminescent layer has significant improvements in current efficiency and lifetime, and significantly reduces the turn-on voltage. Especially when applied in conjunction with phosphorescence sensitized boron-containing compounds, it can improve the optical purity and color purity of the device.

### BRIEF DESCRIPTION OF THE DRAWINGS

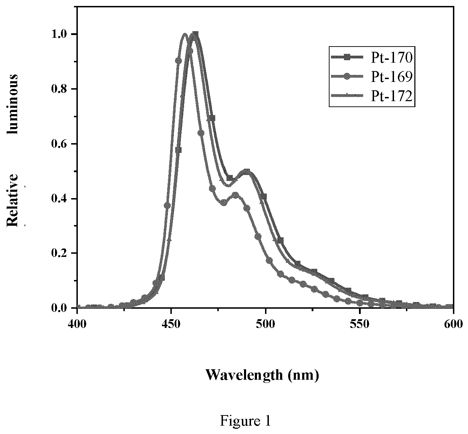

Figure 1 shows the emission spectra of platinum complexes Pt-169, Pt-170, and Pt-172 in dichloromethane solution at room temperature.

### DETAILED DESCRIPTION OF THE PREFERRED EMBODIMENTS

The following provides a detailed explanation of the content of the present application. The description of the constituent elements recorded below is sometimes based on representative embodiments or specific examples of the present application, but the present application is not limited to such embodiments or specific examples.

The term "substituted" used in the present application is expected to include all allowed substituents of organic compounds. In terms of wide range, allowed substituents include non-cyclic and cyclic, branched and non-branched, carbocyclic and heterocyclic, as well as aromatic and non-aromatic substituents of organic compounds. Explanatory substituents include, for example, those described below. For suitable organic compounds, the allowed substituents can be one or more, the same or different. For the purpose of the present application, a heteroatom (such as nitrogen) can have a hydrogen substituent and/or any allowed substituent of the organic compound described in the present application, which satisfies the valence bond of the heteroatom. The present application does not intend to impose any limitations in any way using substituents allowed by organic compounds. Similarly, the terms "substituted" or "substituted with" contain implicit conditions that the substitution matches the allowed valence bond of the substituted atom and the substituent, and that the substitution leads to stable compounds (e.g. compounds that do not undergo spontaneous transformation (e.g. through rearrangement, cyclization, elimination, etc.)). It is also expected that in certain aspects, unless explicitly stated to the contrary, individual substituents can be further optionally substituted (i.e., further substituted or unsubstituted).

When defining various terms, "R₁"-"R₆" are used as a general symbol in the present application to represent various specific substituents. These symbols can be any substituent, not limited to those disclosed in the present application, and when they are limited to certain substituents in one case, they can be limited to some other substituents in other cases.

The "R₁", "R₂", "R₃"... "Rₙ" (where n is an integer) used in the present application can independently have one or more of the groups listed above. For example, if R₁ is a linear alkyl group, one hydrogen atom of the alkyl group can be optionally substituted with hydroxyl, alkoxy, alkyl, halogen, etc. Depending on the chosen groups, the first group can be bound to the second group, or alternatively, the first group can be suspended, i.e., connected, to the second group. For example, for the phrase "alkyl group containing amino group", the amino group can bind within the main chain of the alkyl group. Optionally, the amino group can be connected to the main chain of the alkyl group. The properties of the chosen group will determine whether the first group is embedded in or connected to the second group.

The term "alkyl" used in the present application refers to branched or unbranched saturated hydrocarbon groups with 1 to 60 carbon atoms, such as methyl, ethyl, n-propyl, isopropyl, n-butyl, isobutyl, sec-butyl, tert-butyl, n-amyl, isopentyl, sec-pentyl, neo-pentyl, hexyl, heptyl, octyl, nonyl, decyl, dodecyl, tetradecyl, hexadecyl, eicosyl, tetracosyl, etc. The alkyl can be branched or non-branched. The alkyl group can also be substituted or unsubstituted. For example, the alkyl group may be substituted with one or more groups, including but not limited to the optionally substituted alkyl, cycloalkyl, alkoxy, amino, halogen, hydroxyl, nitro, silyl, sulfo-oxo, or thiol groups as described in the present application.

The term "aryl" used in the present application refers to any carbon based aromatic group containing 5 to 60 carbon atoms, including but not limited to phenyl, naphthyl, phenyl, biphenyl, phenoxyphenyl, anthracyl, phenanthryl, etc. The term "aryl" also includes "heteroaryl", which is defined as a group containing an aromatic group with at least one heteroatom introduced into the ring of the aromatic group. Examples of heteroatoms include but are not limited to nitrogen, oxygen, sulfur, and phosphorus. Similarly, the term "non-heteroaryl" (also included in the term "aryl") defines groups containing aromatic groups that do not contain heteroatoms. The aryl group can be substituted or unsubstituted. Aromatic groups can be substituted with one or more groups, including but not limited to alkyl, cycloalkyl, alkoxy, alkenyl, cycloalkenyl, alkynyl, cycloalkynyl, aryl, heteroaryl, aldehyde group, amino, carboxyl, ester group, halogen, hydroxyl, carbonyl, azide group, nitro, silyl, sulfur-oxo, or thiol groups as described in the present application.

The compound of the present application may contain an "optionally substituted" moiety. Usually, the term "substituted" (regardless of whether the term "optional" is present together) means that one or more hydrogen atoms in the indicated moiety have been substituted by suitable substituents. Unless otherwise specified, "optionally substituted" groups may have suitable substituents at each substitutable position of the group, and when there is more than one substituent selected from a specified group at more than one position in any given structure, the substituents at each position may be the same or different. The preferred substituent combinations envisioned in the present application are those that form stable or chemically feasible compounds. In some aspects, unless clearly indicated to the contrary, it also covers that each substituent can be further optionally substituted (i.e. further substituted or unsubstituted).

The structure of a compound can be represented by the following Formula: 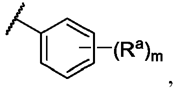 which is understood as equivalent to the following Formula: 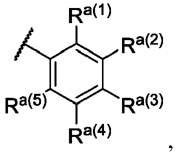 where m is usually an integer. That is to say, R^{a} is understood as representing five individual substituents R^{a(1)}, R^{a(2)}, R^{a(3)}, R^{a(4)}, and R^{a(5)}. The "individual substituents" means that each R substituent that can be independently defined. For example, if R^{a(m)} is a halogen in a case, then in this case R^{a(n)} may not necessarily be a halogen.

The compounds disclosed herein can exhibit desired properties and have emission and/or absorption spectra that can be adjusted by selecting appropriate ligands. On the other hand, the present application may exclude any one or more compounds, structures, or moieties thereof specifically described herein.

The compounds of the present application can be prepared using various methods, including but not limited to those described in the examples provided herein.

It should be pointed out that the general explanation above and the detailed explanation below are only exemplary and explanatory, and do not have any limitations.

This application can be more easily understood by referring to the following specific implementations and the examples included therein.

Before disclosing and describing the compounds, devices, and/or methods of the present application, it should be understood that they are not limited to specific synthesis methods (otherwise specified separately), or specific reagents (otherwise specified separately), as this is certainly variable. It should also be understood that the terms used in the present application are only for the purpose of describing specific aspects and are not intended to be restrictive. Although any methods and materials similar or equivalent to those described in the present application can be used in this practice or experiment, exemplary methods and materials are described below. All raw materials and solvents used in the synthesis examples can be commercially purchased if there is no special explanation. The solvents are used directly and have not been further processed.

The substrate of the present application can be any substrate used in typical organic optoelectronic devices. It can be a glass or transparent plastic substrate, an opaque material such as silicon or stainless steel substrate, or a flexible PI film. Different substrates have different mechanical strength, thermal stability, transparency, surface smoothness, and waterproofness. Depending on the properties of the substrate, the direction of use varies. As a material in the hole injection layer, hole transport layer, and electron injection layer, any material can be selected from the known relevant materials for OLED devices for use, and the present application does not impose specific limitations on it.

### Synthetic Examples

The following examples of compound synthesis, composition, devices or methods are only intended to provide a general method for the industry field and are not intended to limit the scope of protection of the patent as defined in the claims. For the data mentioned in the patent (quantity, temperature, etc.), they are tried to ensure accuracy as much as possible, but there may also be some errors. Unless otherwise specified, weighing is done separately, at a temperature unit of °C or at room temperature, with pressure close to normal pressure.

The following examples provide a method for preparing new compounds, but the preparation of such compounds is not limited by this method. In this professional technical field, due to the ease of modification and preparation of the protected compound in the present application, its preparation can be carried out using the methods listed below or other methods. The following examples are only for implementation purposes and are not intended to limit the scope of protection of the patent as defined in the claims. Temperature, catalyst, concentration, reactants, and reaction process can all be changed to prepare the compounds under different conditions for different reactants.

¹H NMR (500 MHz), ¹H NMR (400 MHz), and ¹³C NMR (126 MHz) spectra were measured on the ANANCE III (500M) nuclear magnetic resonance spectrometer. Unless otherwise specified, DMSO-*d₆* or CDCl₃ containing 0.1% TMS is used as the solvent for nuclear magnetic resonance. Wherein, if CDCl₃ is used as the solvent for ¹H NMR spectra, TMS (δ= 0.00 ppm) is used as internal standard; when DMSO-*d₆* is used as a solvent, TMS (δ = 0.00 ppm) or residual DMSO peak (δ= 2.50 ppm) or residual water peak (δ = 3.33 ppm is used as the internal standard. In the ¹³C NMR spectrum, CDCl₃ (δ= 77.00 ppm) or DMSO-*d₆* (δ = 39.52 ppm) is used as the internal standard. HPLC-MS Agilent 6210 TOF LC/MS mass spectrometer is used for measurement. HRMS spectra were determined on Agilent 6210 TOF LC/MS liquid chromatography-time-of-flight mass spectrometer. In the ¹H NMR spectrum data, s=singlet, d=doublet, t=triplet, q=quartet, p=quintet, m=multiplet, br=broad.

### Example 1: Synthesis of intermediate dF-NH₂

The synthesis route of intermediate dF-NH₂ is as follows:

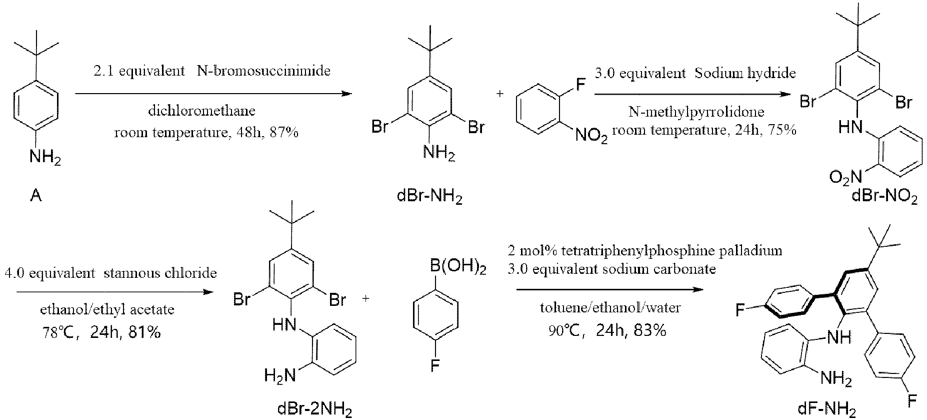

Synthesis of intermediate (dBr-NH₂): A (15.0g, 100 mmoL, 1.0 equivalent) was added into a single necked flask with a magnetic stirrer and dissolved with dichloromethane (200 mL). N-bromosuccinimide (37.7g, 210 mmoL, 2.1 equivalent) was slowly added therein at low temperature, and finally the mixture reacted at room temperature for 48 hours. After removing the solvent through vacuum distillation, the crude product was separated using a silica gel chromatography column. The eluent was petroleum ether/ethyl acetate=80:1, resulting in a red liquid of 28.69g with a yield of 87%. The product was not subjected to structural characterization, and directly used for the next step.

Synthesis of intermediate (dBr-NO₂): dBr-NH₂ (13.3g, 43.3 mmoL, 1.0 equivalent) was added into a three necked flask with a magnetic stirrer and dissolved with N-methylpyrrolidone (100 mL). Sodium hydride (5.20g, 130 mmoL, 3.0 equivalent) was slowly added at low temperature. Finally, o-fluoronitrobenzene (7.95g, 56.3 mmoL, 1.3 equivalent) was slowly added and moved to room temperature for reaction for 48 hours. After removing the solvent through vacuum distillation, the crude product was separated using a silica gel chromatography column. The eluent was petroleum ether/ethyl acetate=50:1, resulting in a yellow solid of 13.61 g with a yield of 75%. The product was not subjected to structural characterization, and directly used for the next step.

Synthesis of intermediate (dBr-2NH₂): dBr-NO₂ (29.6g, 69.2 mmoL, 1.0 equivalent) was added into a three necked flask with a magnetic stirrer, followed by the addition of stannous chloride (29.6g, 277 mmoL, 4.0 equivalent), followed by nitrogen purging and replacing three times, and the addition of ethyl acetate (250mL) and ethanol (250mL) under nitrogen protection. After 24 hours of reaction at 78 °C in an oil bath, the crude product was separated by silica gel chromatography column after vacuum distillation to remove the solvent. The eluent was petroleum ether/ethyl acetate=30:1-20:1, resulting in a white solid of 22.4g with a yield of 81%. The product was not subjected to structural characterization, and directly used for the next step.

Synthesis of intermediate (dF-NH₂): dBr-2NH₂ (15.0g, 37.7 mmoL, 1.0 equivalent) was added into a three necked flask with a magnetic stirrer. Then, p-fluorophenylboronic acid (15.8g, 113 mmoL, 3.0 equivalent), tetratriphenylphosphine palladium (871 mg, 0.75 mmoL, 0.02 equivalent), and sodium carbonate (12g, 113 mmoL, 3.0 equivalent) were added, followed by nitrogen purging and replacing three times. Under nitrogen protection, toluene (150mL), ethanol (60 mL), and water (15 mL) were added. After reacting at 90°C in an oil bath for 24 hours, the material was cooled to room temperature. After vacuum distillation to remove the solvent, the crude product was separated using a silica gel chromatography column. The eluent was petroleum ether/ethyl acetate=30:1-20:1, resulting in a white solid of 13.41g with a yield of 83%. ¹H NMR (400 MHz, DMSO) δ 7.43 (dd, J=8.4, 5.6 Hz, 4H), 7.28 (s, 2H), 7.07 (t, J=8.8 Hz, 4H), 6.35-6.27 (m, 2H), 6.14 (t, J=7.6 Hz, 1H), 6.02 (d, J=7.6 Hz, 1H), 5.65 (s, 1H), 4.48 (s, 2H), 1.34 (s, 9H).

It should be noted that the above only provides a feasible preparation scheme for one of the intermediates of the present application, and the required intermediates in various examples can be prepared by reference to the synthesis process of intermediate dF-NH₂. The preparation of such intermediate compounds is not limited by this method. Its preparation can be carried out using the methods listed above or other methods known in the art. It is not used to limit the scope of protection of the present application.

### Example 2: Synthesis of Pt-169

The synthesis route of tetradentate platinum (II) complex phosphorescent luminescent material Pt-169 is as follows:

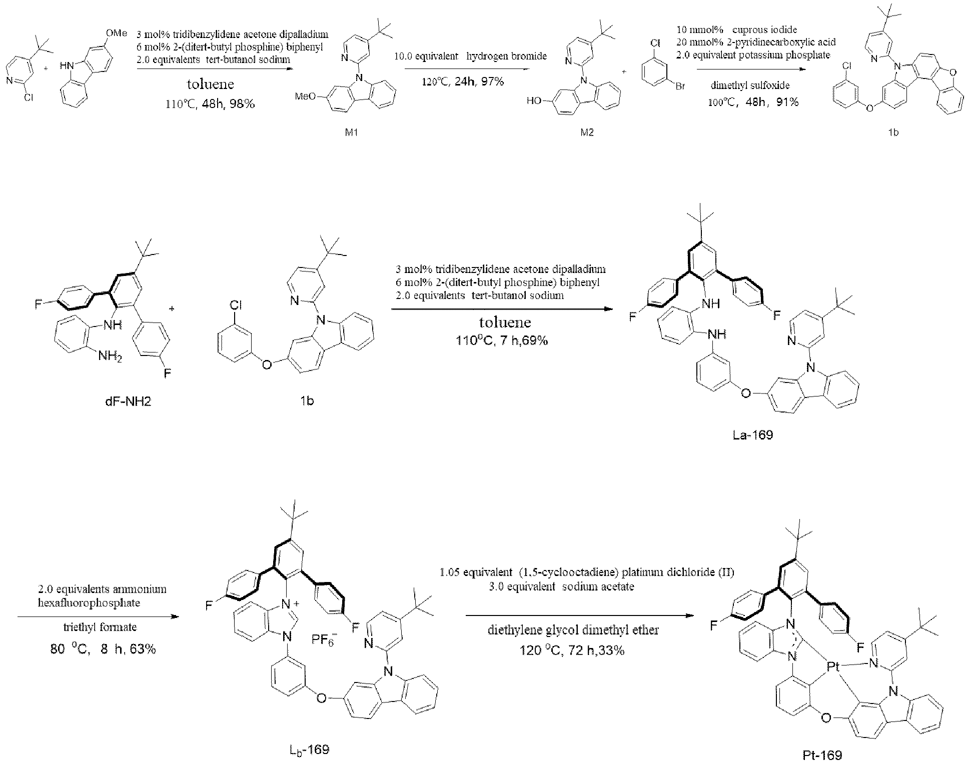

Synthesis of intermediate (**M1**): 2-methoxycarbazole (20g, 101 mmol, 1.0 equivalent), 4-(tert butyl)-2-chloropyridine (20.6 g, 121.2 mmol, 1.2 equivalents), tridibenzylidene acetone dipalladium (925mg, 1.01 mmol, 3 mol%), 2-(ditert-butyl phosphine) biphenyl (904mg, 3.03 mmol, 6 mol%) and tert-butanol sodium (19.41 g, 202 mmol, 2.0 equivalents) were added into a reaction flask, and toluene (200 mL) was added therein. The reaction was carried out at 110 °C for 48 hours and then stopped, the material was cooled to room temperature, the organic phase was separated and concentrated, and a white solid of 32.7g was obtained after silica gel column chromatography, with a yield of 98%. The product was not subjected to structural characterization, and directly used for the next step.

Synthesis of intermediate **(M2): M1** (32.7g, 2.5 mmol, 1.0 equivalent) and hydrogen bromide (80.1g, 990 mmol, 10.0 equivalent) to was added into a reaction flask. The reaction was carried out at 120 °C for 24 hours and then stopped, the material was cooled to room temperature, the organic phase was separated and concentrated, and a white solid of 862g was obtained after silica gel column chromatography, with a yield of 97%. The product was not subjected to structural characterization, and directly used for the next step.

Synthesis of intermediate (**1b**): **M2** (8.0g, 25.3 mmol, 1.0 equivalent), m-chlorobromobenzene (5.34g, 27.8 mmol, 1.1 equivalent), 2-pyridinecarboxylic acid (623 mg, 5.06 mmol, 20 mmol%), cuprous iodide (481mg, 2.53 mmol, 10 mmol%) and potassium phosphate (10.74g, 50.6 mmol, 2.0 equivalent) were added into a reaction flask, and dimethyl sulfoxide (80 mL) was added therein. The reaction was carried out at 100 °C for 48 hours and then stopped, the material was cooled to room temperature, the organic phase was separated and concentrated, and a white solid of 10.0g was obtained after silica gel column chromatography, with a yield of 93%. The product was not subjected to structural characterization, and directly used for the next step.

Synthesis of intermediate (**Lₐ-169**₂ (1.96mg, 4.60 mmoL, 1.0 equivalents) was added to a Schlenk tube with a magnetic stirrer, followed by the addition of **1b** (2.32mg, 5.52 mmoL, 1.2 equivalents), tridibenzylidene acetone dipalladium (126mg, 0.14 mmoL, 3 mol%), 2-(di-tert-butylphosphine)biphenyl (82mg, 0.28 mmoL, 6 mol%), and tert-butanol sodium (884mg, 9.20 mmoL, 2.0 equivalents), followed by nitrogen purging and replacing three times, and the addition of toluene (5 mL) under nitrogen protection. After 12 hours of reaction at 110°C in an oil bath, the material was cooled to room temperature; the crude product was separated by silica gel chromatography column after vacuum distillation to remove the solvent. The eluent was petroleum ether/ethyl acetate=60:1-20:1, resulting in a white solid of 2.60g with a yield of 69%.

Synthesis of ligand (**L_{b}-169Lₐ**-**169** (1.10g, 1.30 mmoL, 1.0 equivalent) was added into a Schlenk tube with a magnetic stirrer, followed by the addition of ammonium hexafluorophosphate (423mg, 2.6 mmoL, 2.0 equivalents), and followed by nitrogen purging and replacing three times and the addition of triethyl formate (5 mL) under nitrogen protection. After 8 hours of reaction at 80°C in an oil bath, the material was cooled to room temperature; the crude product was separated by silica gel chromatography column after vacuum distillation to remove the solvent. The eluent was petroleum ether/dichloromethane 1:1~dichloromethane, resulting in a white solid of 806g with a yield of 63%. ¹H NMR (500 MHz, DMSO-*d₆*) δ 1.28 (s, 9H) 1.44 (s, 9H), 7.02 (t, J=8.5 Hz, 4H), 7.18 (td, J=7.5, 8.0, 5.5 Hz, 2H), 7.23-7.25 (m, 5H), 7.34-7.39 (m, 2H), 7.45-7.50 (m, 4H), 7.53-7.59 (m, 2H), 7.67-7.78 (m, 6H), 8.26 (d, J=7.5 Hz, 1H), 8.34 (d, J=8.5 Hz, 1H), 8.58 (d, J=5.0 Hz, 1H), 10.31 (s, 1H).

Synthesis of **Pt-169: Lₐ-169** tube with a magnetic stirrer, followed by the addition of (1,5-cyclooctadiene) platinum dichloride (II) (271mg, 0.78 mmoL, 1.05 equivalent) and sodium acetate (182mg, 2.22 mmoL, 3.0 equivalent). Then, nitrogen purging and replacing was conducted for three times, and diethylene glycol dimethyl ether (10mL) was added under nitrogen protection, and the nitrogen gas was introduced to bubble for 30 minutes to remove oxygen. After 72 hours of reaction at 120°C in an oil bath, the material was cooled to room temperature; the crude product was separated by silica gel chromatography column after vacuum distillation to remove the solvent. The eluent was petroleum ether/dichloromethane 4:1, resulting in a bluish yellow solid of 250mg with a yield of 33%. ¹H NMR (500 MHz, CDCl₃) δ 1.21 (s, 9H), 1.41 (s, 9H), 6.28 (dd, J=6.0, 4.0 Hz, 1H), 6.86 (d, J=8.0 Hz, 1H), 7.06-7.09 (m, 5H), 7.25-7.29 (m, 5H), 7.34 (d, J=8.0 Hz, 1H), 7.41-7.50 (m, 7H), 7.81 (d, J=8.0 Hz, 1H), 7.85 (d, J=7.5 Hz, 1H), 7.92 (d, J=2.0 Hz, 1H), 8.02 (d, J=8.0 Hz, 1H), 8.11-8.13 (m, 1H), 9.00 (d, J=6.0 Hz, 1H).

### Example 3: Synthesis of Pt-170

The synthesis route of tetradentate platinum (II) complex phosphorescent material Pt-170 is as follows:

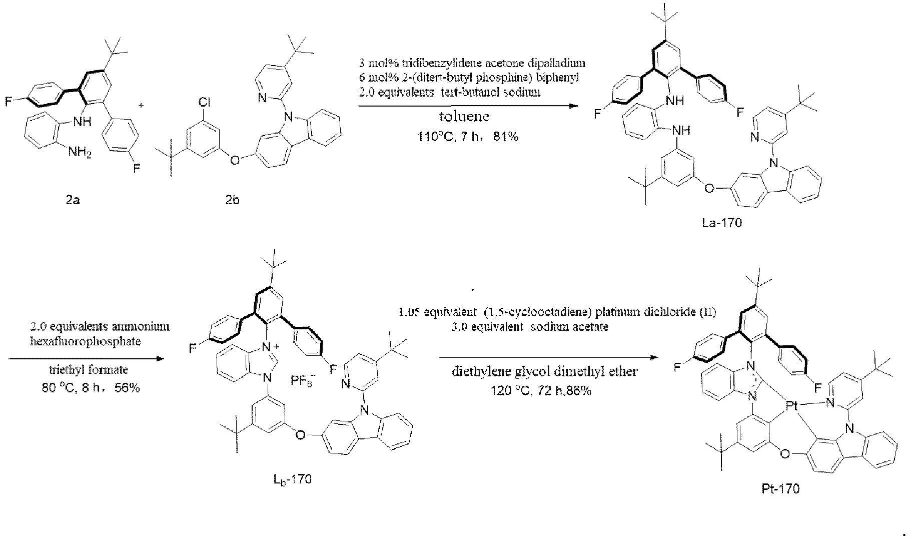

Synthesis of intermediate (**Lₐ-1702a** ₂, 850mg, 1.98 mmoL, 1.0 equivalent) was added into a Schlenk tube with a magnetic stirrer, followed by the addition of 2b (1.15mg, 2.38 mmoL, 1.2 equivalents), tridibenzylidene acetone dipalladium (55mg, 0.06 mmoL, 3 mol%), 2-(di-tert-butyl phosphine)biphenyl (36mg, 0.12 mmoL, 6 mol%), and tert-butanol sodium (380mg, 3.96 mmoL, 2.0 equivalents). Then nitrogen purging and replacing was conducted for three times, and toluene (5 mL) was added under nitrogen protection. After 12 hours of reaction at 110 °C in an oil bath, the material was cooled to room temperature, and the crude product was separated by silica gel chromatography column after vacuum distillation to remove the solvent. The eluent was petroleum ether/ethyl acetate=60:1-20:1, resulting in a white solid of 1.40g with a yield of 81%.

Synthesis of ligand (**L_{b}-170Lₐ-170** into a Schlenk tube with a magnetic stirrer, followed by the addition of ammonium hexafluorophosphate (586mg, 3.6 mmoL, 2.0 equivalents). Then nitrogen purging and replacing was conducted for three times, and triethyl formate (5 mL) was added under nitrogen protection. After 8 hours of reaction at 80 °C in an oil bath, the material was cooled to room temperature, and the crude product was separated by silica gel chromatography column after vacuum distillation to remove the solvent. The eluent was petroleum ether/dichloromethane 1:1~dichloromethane, resulting in a white solid of 1.04g with a yield of 56%. ¹H NMR (500 MHz, DMSO-d6) δ 1.27 (s, 9H) 1.28 (s, 9H), 1.44 (s, 9H), 6.88 (t, J=3.5 Hz, 1H), 7.01 (t, J=9.0 Hz, 4H), 7.11 (t, J=2.0 Hz, 1H), 7.16-7.18 (m, 1H), 7.21-7.24 (m, 4H), 7.33-7.36 (m, 1H), 7.45-7.58 (m, 7H), 7.66 (d, J=1.5 Hz, 1H), 7.72-7.76 (m, 4H), 1H), 8.25 (d, J=8.0 Hz, 1H), 8.33 (d, J=8.5 Hz, 1H), 8.57 (d, J=5.5 Hz, 1H), 10.27 (s, 1H).

Synthesis of **Pt-170: Lₐ-170** tube with a magnetic stirrer, followed by the addition of (1,5-cyclooctadiene) platinum dichloride (II) (142mg, 0.41 mmoL, 1.05 equivalent) and sodium acetate (96mg, 1.17 mmoL, 3.0 equivalent). Then nitrogen purging and replacing was conducted for three times, and diethylene glycol dimethyl ether (10mL) was added under nitrogen protection, and the nitrogen gas was introduced to bubble for 30 minutes to remove oxygen. After 72 hours of reaction at 120 °C in an oil bath, the material was cooled to room temperature, and the crude product was separated by silica gel chromatography column after vacuum distillation to remove the solvent. The eluent was petroleum ether/dichloromethane 4:1, resulting in a bluish yellow solid of 372mg with a yield of 86%. x¹H NMR (500 MHz, DMSO-*d₆*) δ 1.21 (s, 9H), 1.39 (s, 9H), 1.42 (s, 9H), 5.97-6.24 (m, 2H), 6.58 (dd, J=6.5, 4.5 Hz, 1H), 6.90-7.19 (m, 8H), 7.35-7.62 (m, 8H), 7.84 (d, J=8.5 Hz, 1H), 7.90 (d, J=1.5 Hz, 1H), 8.04 (d, J=8.5 Hz, 1H), 8.16 (d, J=8.5 Hz, 1H), 8.21 (d, J=8.01 Hz, 1H), 8.86 (d, J=6.0 Hz, 1H).

### Example 4: Synthesis of Pt-172

The synthesis route of tetradentate platinum (II) complex phosphorescent material Pt-172 is as follows:

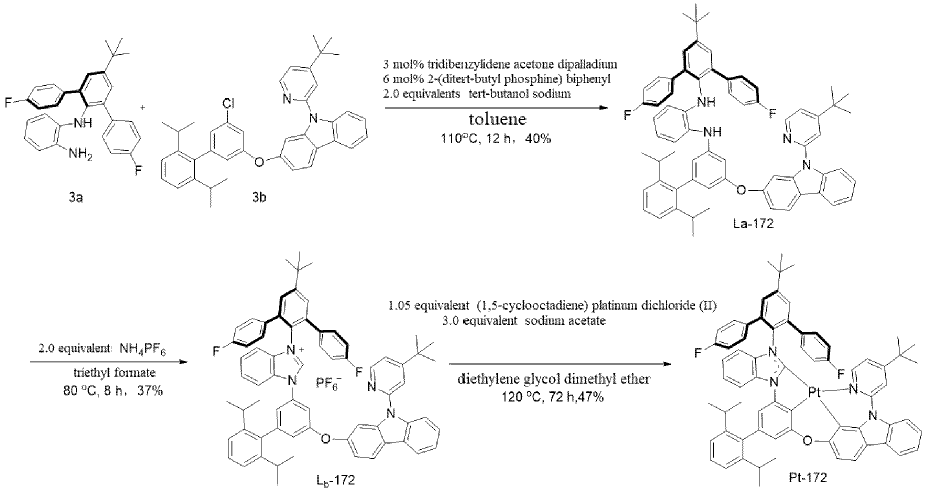

Synthesis of intermediate (**Lₐ-172**₂, 500mg, 1.17 mmoL, 1.0 equivalent) was added into a Schlenk tube with a magnetic stirrer, followed by the addition of 3b (687mg, 1.17 mmoL, 1.2 equivalent), tridibenzylidene acetone dipalladium (32mg, 0.04 mmoL, 3 mol%), 2-(di-tert-butylphosphine) biphenyl (20mg, 0.07 mmoL, 6 mol%), and sodium tert-butanol (224mg, 2.34 mmoL, 2.0 equivalent). Then nitrogen purging and replacing was conducted for three times, and toluene (5 mL) was added under nitrogen protection. After 12 hours of reaction at 110 °C in an oil bath, the material was cooled to room temperature, and the crude product was separated by silica gel chromatography column after vacuum distillation to remove the solvent. The eluent was petroleum ether/ethyl acetate=60:1-20:1, resulting in a white solid of 358g with a yield of 40%.

Synthesis of ligand (**L_{b}-172Lₐ-172** into a Schlenk tube with a magnetic stirrer, followed by the addition of ammonium hexafluorophosphate (83mg, 0.52 mmoL, 2.0 equivalents). Then nitrogen purging and replacing was conducted for three times, and triethyl formate (5 mL) was added under nitrogen protection. After 8 hours of reaction at 80 °C in an oil bath, the material was cooled to room temperature, and the crude product was separated by silica gel chromatography column after vacuum distillation to remove the solvent. The eluent was petroleum ether/dichloromethane 1:1~dichloromethane, resulting in a white solid of 110mg with a yield of 37%. ¹H NMR (500 MHz, DMSO-*d₆*) δ 1.04-1.12 (m, 12H) 1.28 (s, 9H), 1.45 (s, 9H), 6.86 (s, 1H), 7.00 (t, J=8.5 Hz, 5H), 7.19-7.23 (m, 3H), 7.24-7.27 (m, 4H), 7.32-7.35 (m, 2H), 7.44-7.49 (m, 3H), 7.53-7.59 (m, 2H), 7.62-7.66 (m, 2H), 7.69-7.70 (m, 1H), 7.73-7.76 (m, 3H), 7.81 (d, J=8.5 Hz), 1H), 8.24 (d, J=7.5 Hz, 1H), 8.33 (d, J=8.5 Hz, 1H), 8.55 (d, J=5.0 Hz, 1H), 10.34 (s, 1H).

Synthesis of **Pt-172: Lₐ-172** tube with a magnetic stirrer, followed by the addition of (1,5-cyclooctadiene) platinum dichloride (II) (19mg, 0.06 mmoL, 1.05 equivalent) and sodium acetate (13mg, 1.17 mmoL, 3.0 equivalent). Then nitrogen purging and replacing was conducted for three times, and diethylene glycol dimethyl ether (10mL) was added under nitrogen protection, and the nitrogen gas was introduced to bubble for 30 minutes to remove oxygen. After 72 hours of reaction at 120 °C in an oil bath, the material was cooled to room temperature, and the crude product was separated by silica gel chromatography column after vacuum distillation to remove the solvent. The eluent was petroleum ether/dichloromethane 4:1, resulting in a bluish yellow solid of 29mg with a yield of 47%. ¹H NMR (500 MHz, Chloroform-d) δ 1.15-1.17 (m, 12H) 1.22 (s, 9H), 1.42 (s, 9H), 6.29 (dd, J=6.5, 4.5 Hz, 1H), 6.86-6.90 (m, 2H), 7.05 (t, J=7.5 Hz, 1H), 7.17-7.20 (m, 2H), 7.24-7.26 (m, 9H), 7.34-7.51 (m, 7H), 7.81-7.88 (m, 3H), 7.94 (d, J=2.0 Hz, 1H), 8.12 (d, J=7.0 Hz, 1H), 9.03 (d, J=6.0 Hz, 1H).

Figure 1 shows the emission spectra of the prepared complexes Pt-169, Pt-170, and Pt-172 in dichloromethane solution at room temperature.

From Figure 1, it can be seen that the complexes Pt-169, Pt-170, and Pt-172 all emit deep blue and have high color purity. The maximum emission peak of Pt-169 is 457.4 nm, and its half peak width is 20 nm. By introducing fluorine atoms at appropriate positions in its ligand, the charge distribution of its excited state can be improved, resulting in more metal to pyridocarbene charge transfer states (³MLCT) in its material excited state, which is beneficial for increasing its radiation rate and thus enhancing the device lifetime. This provides an effective way to design platinum (II) complexes for high-quality blue phosphorescent materials.

### Example 5: Synthesis of Pt-4

The synthesis route of tetradentate platinum (II) complex phosphorescent material Pt-4 is as follows:

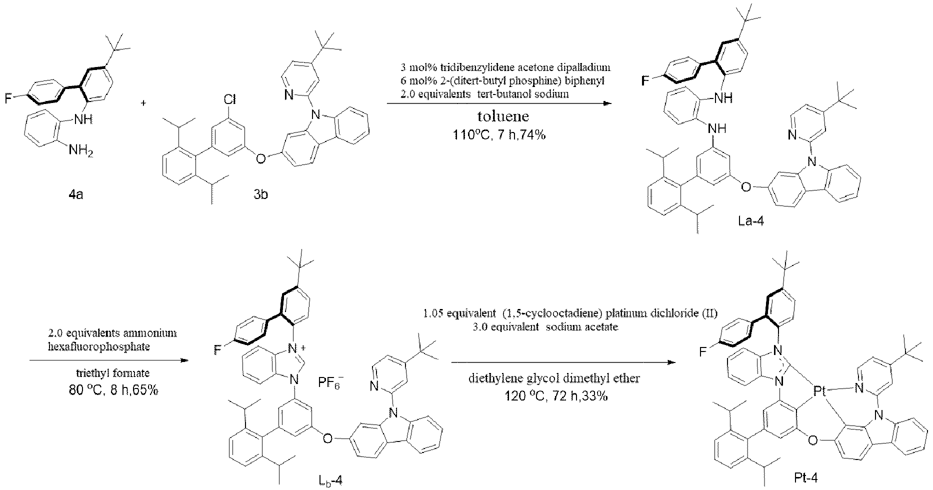

Pt-4 was synthesized by reference to the synthesis steps and reaction conditions of compound Pt-169. The target product Lₐ-4 was synthesized with 1.09 g of light green foam solid in 74% yield. The target product L_{b}-4 was synthesized with 801 mg of light green foam solid in 65% yield. Molecular weight [M]+: 896.3. The target product Pt-4 was synthesized with 325 mg of yellow solid in 33% yield. Molecular weight [M+H]+: 1089.4.

### Example 6: Synthesis of Pt-52

The synthesis route of tetradentate platinum (II) complex phosphorescent material Pt-52 is as follows:

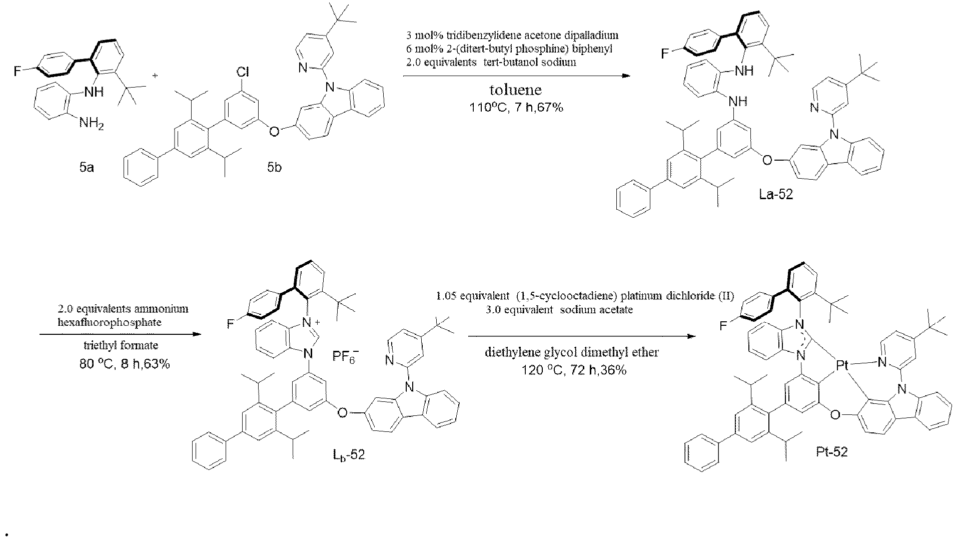

Pt-52 was synthesized by reference to the synthesis steps and reaction conditions of compound Pt-169. The target product Lₐ-52 was synthesized with 1.19 g of light green foam solid in 67% yield. The target product L_{b}-52 was synthesized with 721 mg of light green foam solid in 63% yield. Molecular weight [M]+: 972.4. The target product Pt-52 was synthesized with 335 mg of yellow solid in 36% yield. Molecular weight [M+H]+: 1165.3.

### Example 7: Synthesis of Pt-86

The synthesis route of tetradentate platinum (II) complex phosphorescent material Pt-86 is as follows:

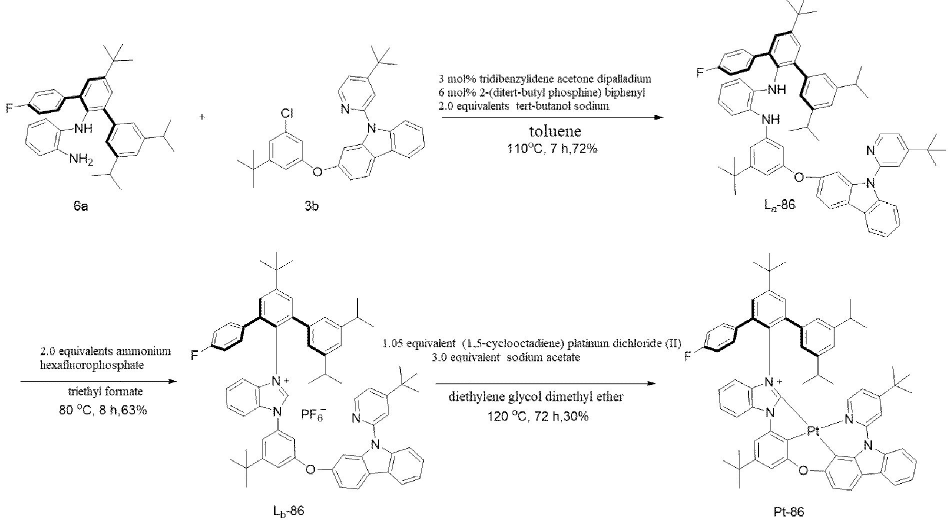

Pt-86 was synthesized by reference to the synthesis steps and reaction conditions of compound Pt-169. The target product Lₐ-86 was synthesized with 1.15 g of light green foam solid in 72% yield. The target product L_{b}-86 was synthesized with 835 mg of light green foam solid in 63% yield. Molecular weight [M]+: 952.4. The target product Pt-86 was synthesized with 319 mg of yellow solid in 30% yield. Molecular weight [M+H]+: 1144.3.

### Example 8: Synthesis of Pt-144

The synthesis route of tetradentate platinum (II) complex phosphorescent material Pt-144 is as follows:

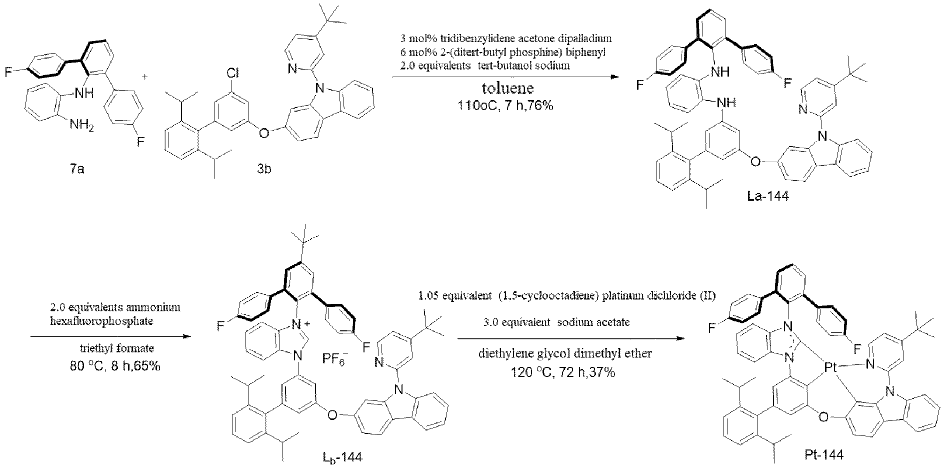

Pt-144 was synthesized by reference to the synthesis steps and reaction conditions of compound Pt-169. The target product Lₐ-144 was synthesized with 1.23 g of light green foam solid in 76% yield. The target product L_{b}-144 was synthesized with 823 mg of light green foam solid in 65% yield. Molecular weight [M]+: 990.4. The target product Pt-144 was synthesized with 349 mg of yellow solid in 37% yield. Molecular weight [M+H]+: 1127.5.

### Example 9: Synthesis of Pt-171

The synthesis route of tetradentate platinum (II) complex phosphorescent material Pt-171 is as follows:

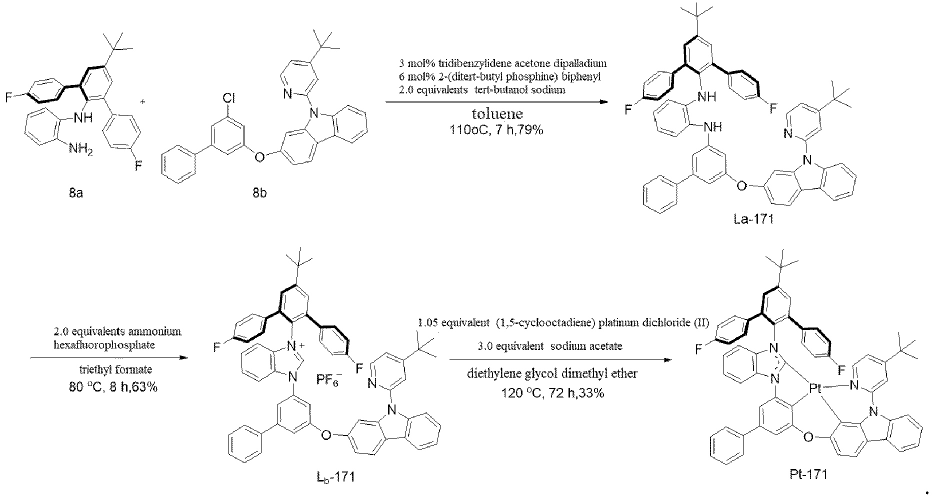

Pt-171 was synthesized by reference to the synthesis steps and reaction conditions of compound Pt-169. The target product Lₐ-171 was synthesized with 1.49 g of light green foam solid in 79% yield. The target product L_{b}-171 was synthesized with 793 mg of light green foam solid in 63% yield. Molecular weight [M]+: 906.3. The target product Pt-171 was synthesized with 325 mg of yellow solid in 33% yield. Molecular weight [M+H]+: 1099.3.

### Example 10: Synthesis of Pt-312

The synthesis route of tetradentate platinum (II) complex phosphorescent material Pt-312 is as follows:

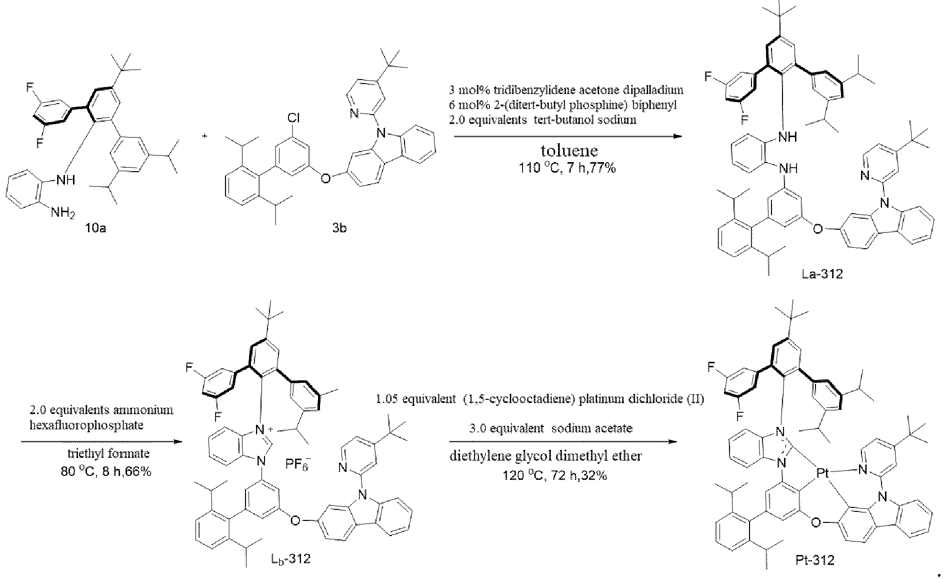

Pt-312 was synthesized by reference to the synthesis steps and reaction conditions of compound Pt-169. The target product Lₐ-312 was synthesized with 1.22 g of light green foam solid in 77% yield. The target product L_{b}-312 was synthesized with 811 mg of light green foam solid in 66% yield. Molecular weight [M]+: 1046.5. The target product Pt-312 was synthesized with 315 mg of yellow solid in 32% yield. Molecular weight [M+H]+: 1267.6.

### Example 11: Synthesis of Pt-338

The synthesis route of tetradentate platinum (II) complex phosphorescent material Pt-338 is as follows:

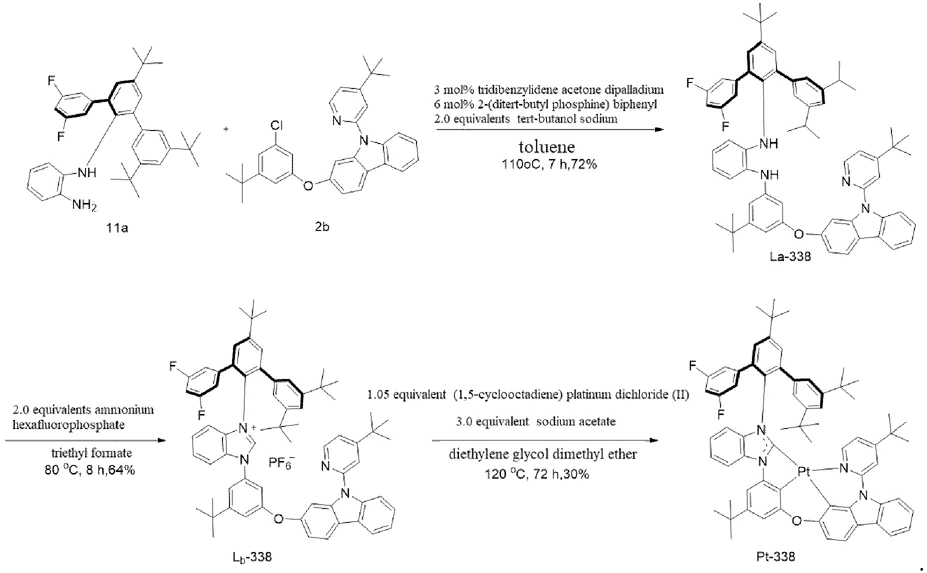

Pt-338 was synthesized by reference to the synthesis steps and reaction conditions of compound Pt-169. The target product Lₐ-338 was synthesized with 1.19 g of light green foam solid in 72% yield. The target product L_{b}-338 was synthesized with 813 mg of light green foam solid in 64% yield. Molecular weight [M]+: 998.2. The target product Pt-338 was synthesized with 319 mg of yellow solid in 30% yield. Molecular weight [M+H]+: 1191.5.

### Example 13: Synthesis of Pt-394

The synthesis route of tetradentate platinum (II) complex phosphorescent material Pt-394 is as follows:

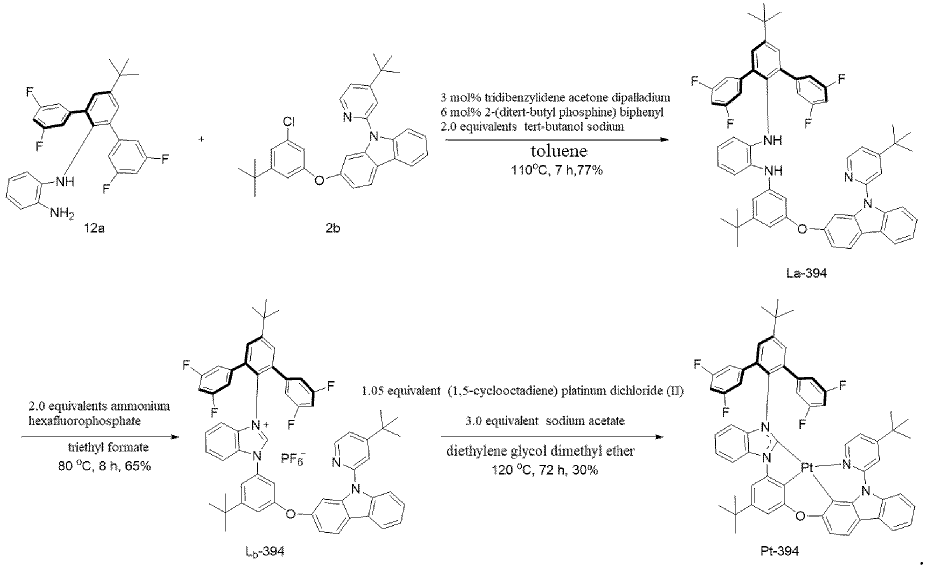

Pt-394 was synthesized by reference to the synthesis steps and reaction conditions of compound Pt-169. The target product Lₐ-394 was synthesized with 1.24 g of light green foam solid in 77% yield. The target product L_{b}-394 was synthesized with 811 mg of light green foam solid in 65% yield. Molecular weight [M]+: 922.3. The target product Pt-394 was synthesized with 309 mg of yellow solid in 30% yield. Molecular weight [M+H]+: 1115.3.

### Example 14: Synthesis of Pt-422

The synthesis route of tetradentate platinum (II) complex phosphorescent material Pt-422 is as follows:

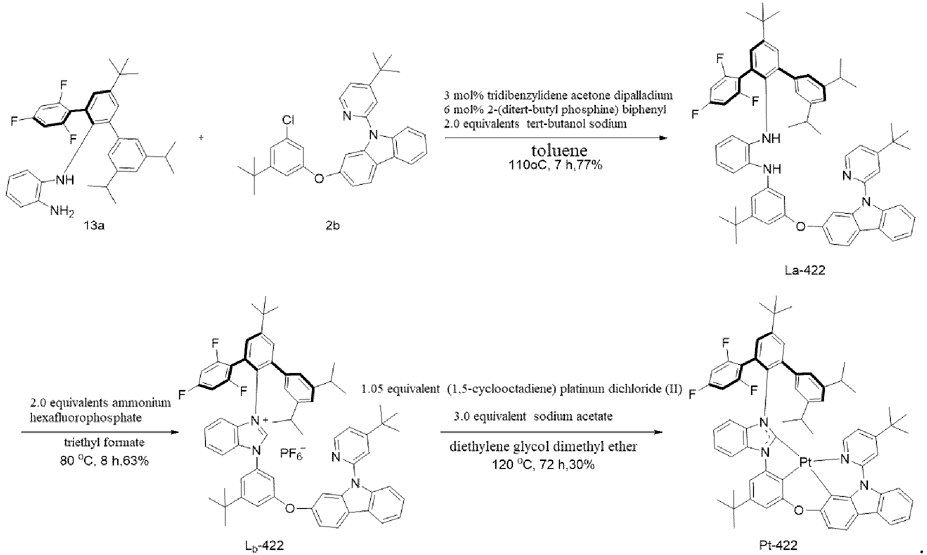

Pt-422 was synthesized by reference to the synthesis steps and reaction conditions of compound Pt-169. The target product Lₐ-422 was synthesized with 1.16 g of light green foam solid in 77% yield. The target product L_{b}-422 was synthesized with 803 mg of light green foam solid in 63% yield. Molecular weight [M]+: 960.3. The target product Pt-422 was synthesized with 315 mg of yellow solid in 30% yield. Molecular weight [M+H]+: 1181.4.

### Example 15: Synthesis of Pt-478

The synthesis route of tetradentate platinum (II) complex phosphorescent material Pt-478 is as follows:

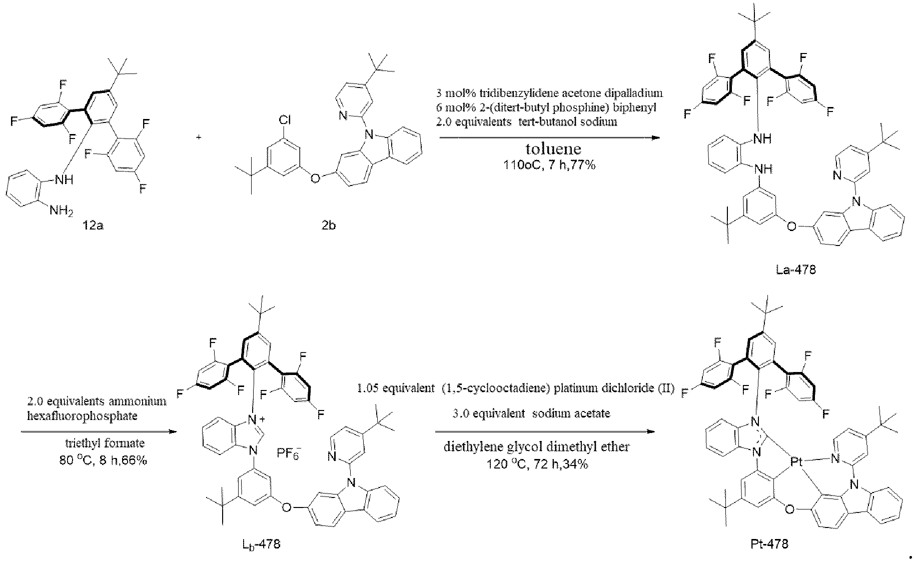

Pt-478 was synthesized by reference to the synthesis steps and reaction conditions of compound Pt-169. The target product Lₐ-478 was synthesized with 1.17 g of light green foam solid in 77% yield. The target product L_{b}-478 was synthesized with 814 mg of light green foam solid in 66% yield. Molecular weight [M]+: 958.2. The target product Pt-478 was synthesized with 326 mg of yellow solid in 34% yield. Molecular weight [M+H]+: 1151.3.

### Example 16: Synthesis of Pt-646

The synthesis route of tetradentate platinum (II) complex phosphorescent material Pt-646 is as follows:

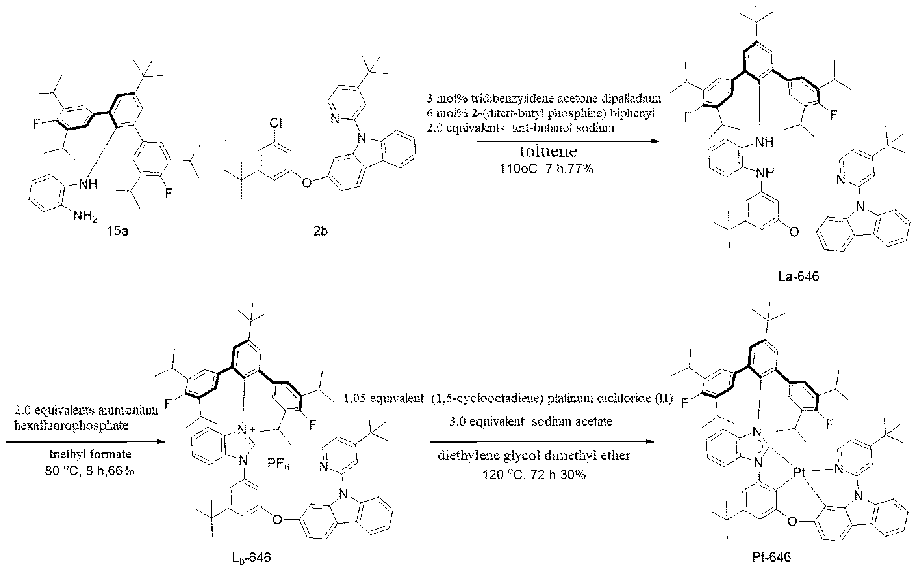

Pt-646 was synthesized by reference to the synthesis steps and reaction conditions of compound Pt-169. The target product Lₐ-646 was synthesized with 1.19 g of light green foam solid in 77% yield. The target product L_{b}-646 was synthesized with 823 mg of light green foam solid in 66% yield. Molecular weight [M]+: 1030.2. The target product Pt-646 was synthesized with 314 mg of yellow solid in 30% yield. Molecular weight [M+H]+: 1246.6.

### Theoretical Calculation Explanation

The geometric structure of ground state (S0) molecules was optimized using density functional theory (DFT). B3LYP functional was used for DFT calculation, where C, H, O, and N atoms use 6-31G (d) basis set, and Pt atom use LANL2DZ basis set.

**Table 1. Frontier orbital energy levels of some metal complexes of the present application**

| Complex | LUMO/eV | HOMO/eV | GAP |
|---|---|---|---|
| 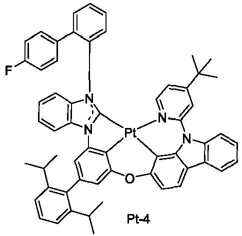 | 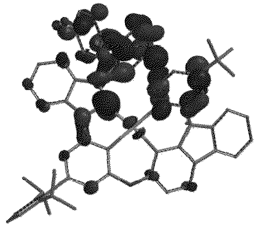 -1.45eV | 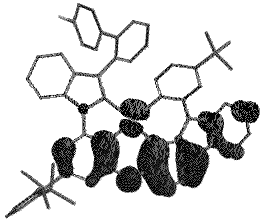 -4.63eV | 3.18eV |
| 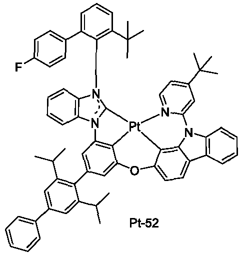 | 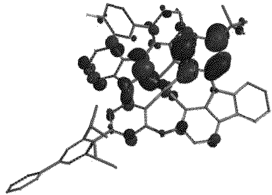 -1.40eV | 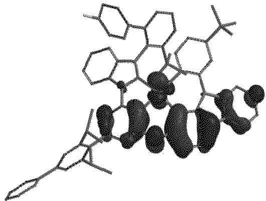 -4.69eV | 3.29eV |
| 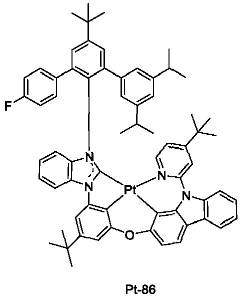 | 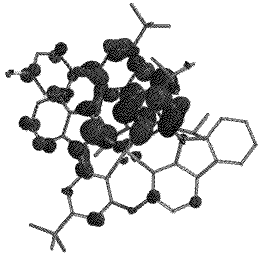 -1.30eV | 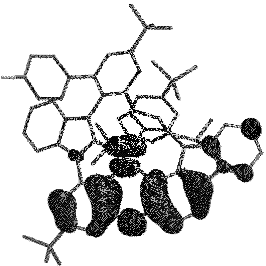 -4.50eV | 3.2eV |
| 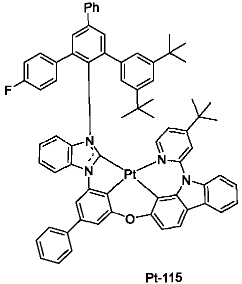 | 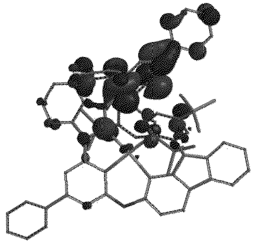 -1.50eV | 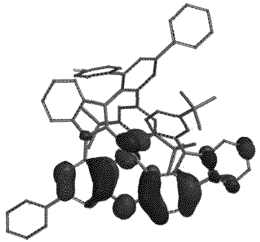 -4.58eV | 3.08eV |
| 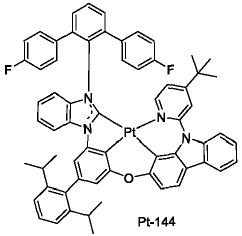 | 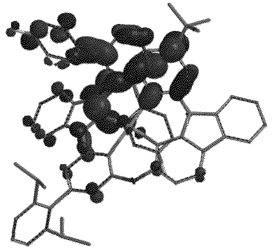 -1.45eV | 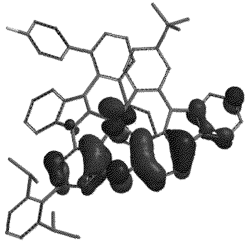 -4.63eV | 3.18eV |
| 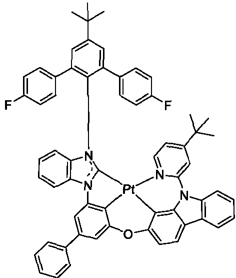 Pt-171 | 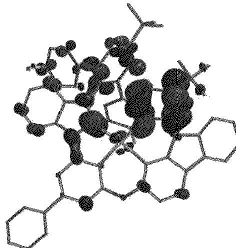 -1.40eV | 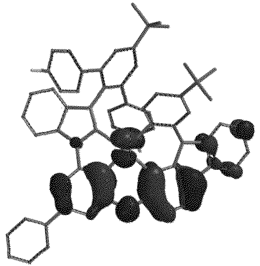 -4.59eV | 3.19eV |
| 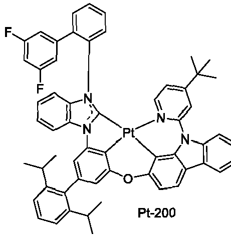 | 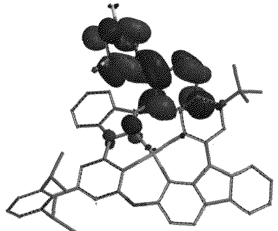 -1.62eV | 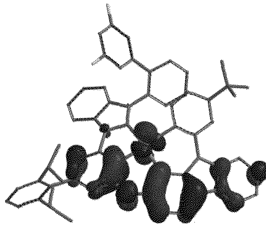 -4.66eV | 3.04eV |
| 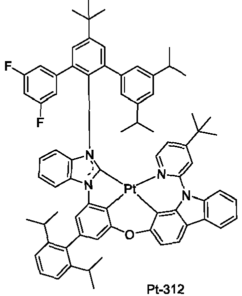 | 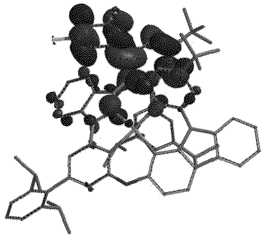 -1.50eV | 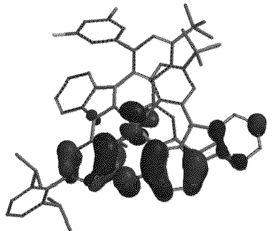 -4.60eV | 3.10eV |
| 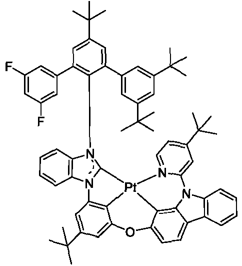 Pt-338 | 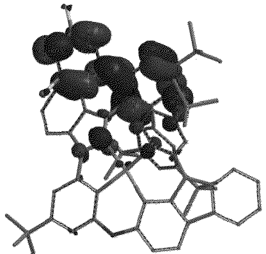 -1.45eV | 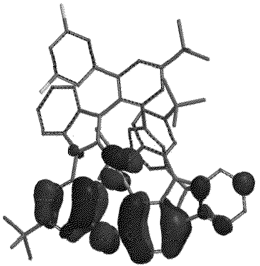 -4.54eV | 3.09eV |
| 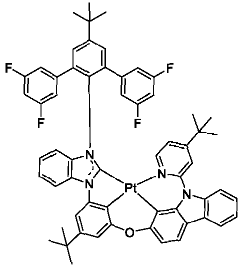 Pt-394 | 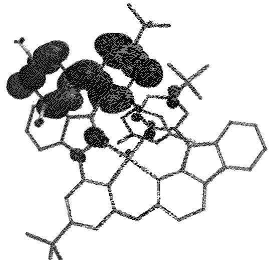 -1.54eV | 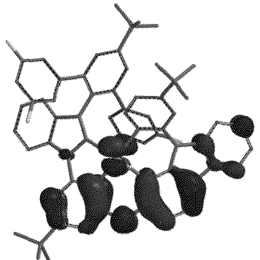 -4.55eV | 3.01eV |
| 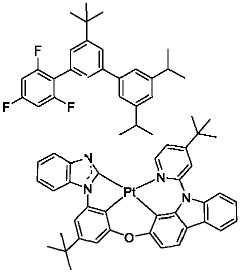 Pt-422 | 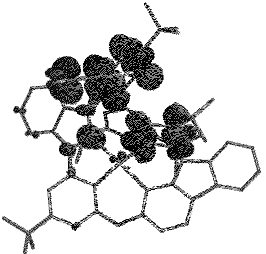 -1.32eV | 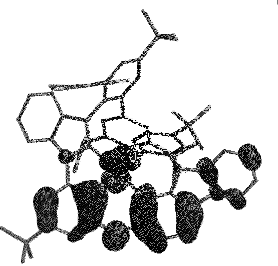 -4.48eV | 3.16eV |
| 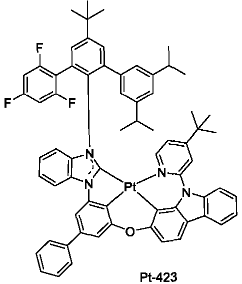 | 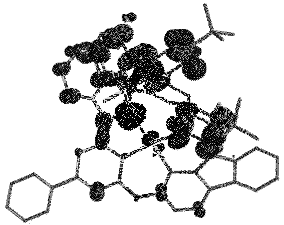 -1.30eV | 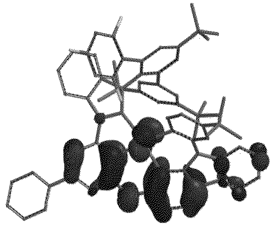 -4.51eV | 3.21eV |
| 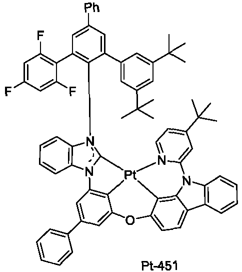 | 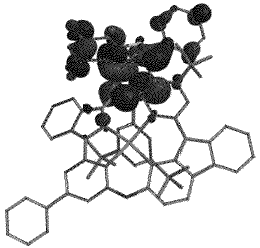 -1.56eV | 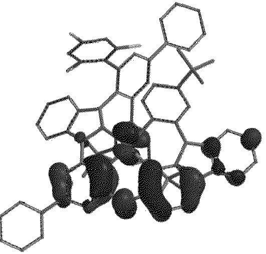 -4.55eV | 3.09eV |
| 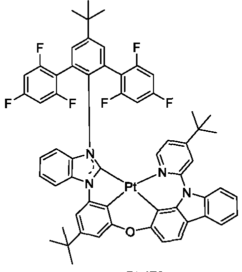 Pt-478 | 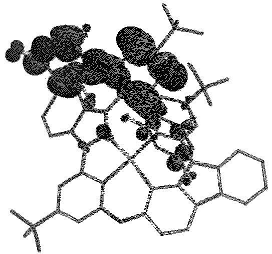 -1.32eV | 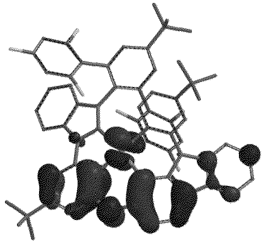 -4.48eV | 3.16eV |
| 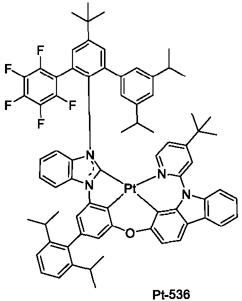 | 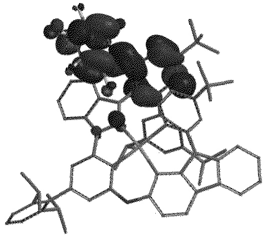 -1.55eV | 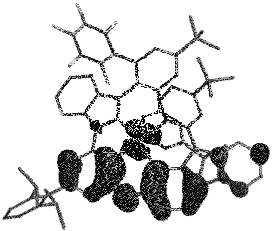 -4.58eV | 3.03eV |
| 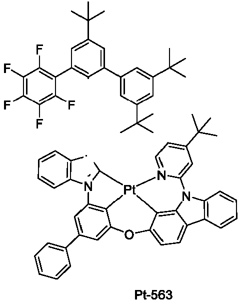 | 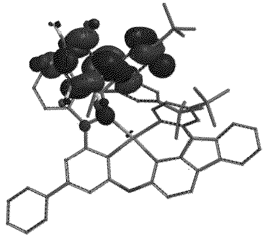 -1.51eV | 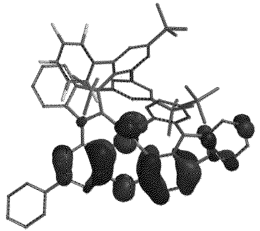 -4.57eV | 3.06eV |
| 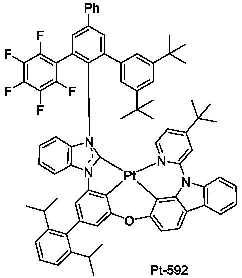 | 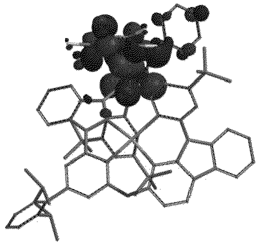 -1.40eV | 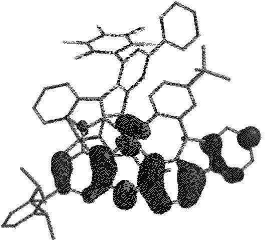 -4.69eV | 3.29eV |
| 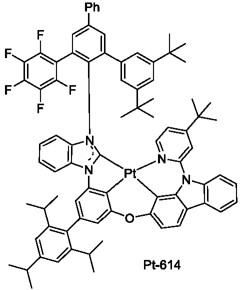 | 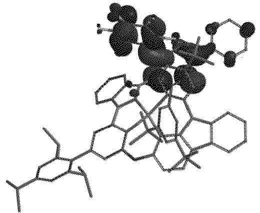 -1.73eV | 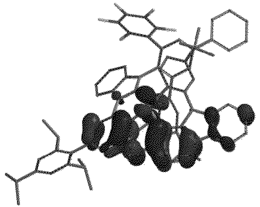 -4.61eV | 2.88eV |
| 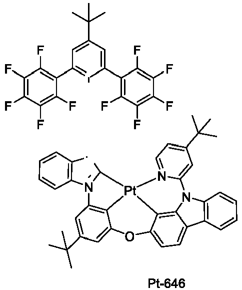 | 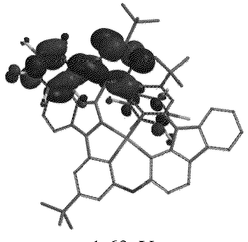 -1.69eV | 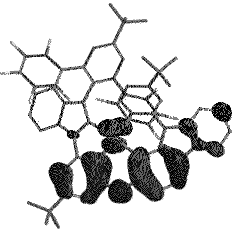 -4.55eV | 2.86eV |

From the above calculation data, it can be seen that the compound materials provided by the present application have a relatively large energy gap (>2.86 eV), which can meet the requirements of blue light materials. In addition, it can be seen that the frontier orbital energy levels (HOMO and LUMO) of platinum (II) complexes can be regulated by adjusting the ligand structure. The majority of the LUMO of the pyridocarbene platinum (II) complex is in the pyridocarbene moiety. The present application introduces fluorine atoms at appropriate positions in its ligand, which can improve the charge distribution of its excited state, resulting in more metal to pyridocarbene charge transfer state (³MLCT) components in the excited state of the material. Moreover, due to the presence of both coordination bonds and π backbonding bonds between carbene and platinum (II), its stability is higher than that of the coordination bonds between pyridine and platinum (II). The above results are beneficial for improving its radiation rate, thereby enhancing the device's lifespan.

### Manufacturing OLED devices

As a reference preparation method for device embodiment, the present application vapor deposited p-doped material on the surface of ITO glass with a luminous area of 2mm×2mm or on the surface of the anode, or co-evaporated this p-doped material at a concentration of 1% to 50% with hole injection material to form a hole injection layer (HIL) of 5nm to 100nm, a hole transport layer (HTL) of 5nm to 200nm, and then form a luminescent layer (EML) (which may contain the compound of the present application) of 10nm to 100nm on the hole transport layer, and form an electron transport layer (ETL) of 20nm to 200nm and a cathode of 50nm to 200nm. If necessary, an electron barrier layer (EBL) is added between the HTL and EML layers, and an electron injection layer (EIL) is added between the ETL and the cathode to manufacture OLED devices. Moreover, the OLED was tested using standard methods. The device materials involved in the present application, unless otherwise specified, can be obtained through known synthesis methods.

In a preferred specific example, the structure of Device Example 1 provided by the present application is: ITO/P-4 (10 nm)/**NPD** (60 nm)/HTH-85 (5 nm)/Platinum (II) complex: HTH-85: ETH-45 (25 nm) (mass ratio of Pt-169: HTH-85: ETH-45 is 10:60:30)/ETH-5 (5 nm)/ET-14 (40 nm)/LiQ (1nm)/Al (100nm).

Device Example 2 to Device Example 15 and Comparative Example 1 were prepared respectively using a structure similar to Device Example 1, with the only difference being that Pt-169 in Device Example 1 was replaced with Pt-170, Pt-172, Pt-4, Pt-52, Pt-86, Pt-144, Pt-171, Pt-394, Pt-312, Pt-338, Pt-394, Pt-422, Pt-478, Pt-646, R₁, respectively. The luminescence characteristics data tested by standard methods of the Comparative Example and various Device Examples prepared above are shown in Table 2. The device structural formulae involved are as follows: in which P-4 refers to HATCN, and ET-14 refers to BPyTP.

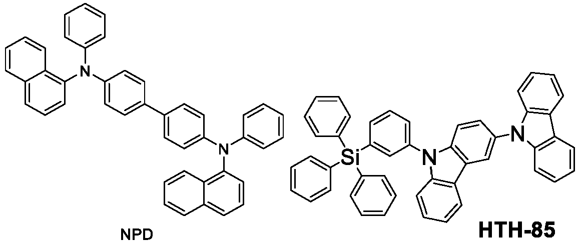

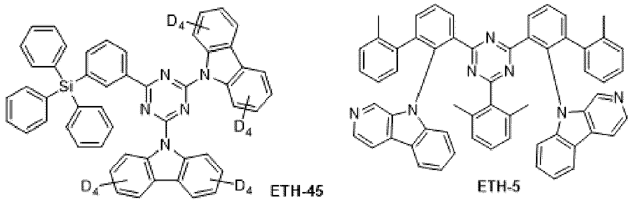

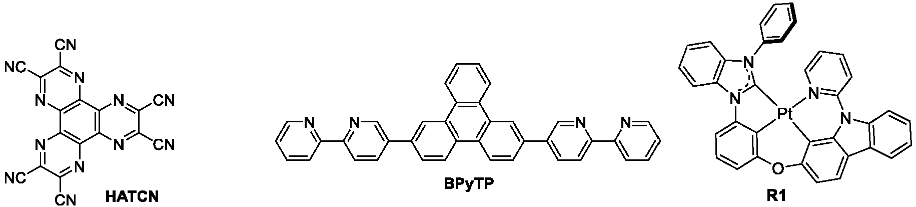

**Table 2. Device Luminescence Characteristics Data Table**

| Example | Driving Voltage (V)@10mA/cm² (Relative value, %) | Current efficiency (cd/A) @1000 cd/m² (Relative value, %) | Device lifespan (h) @1000 cd/m² (Relative value, %) |
|---|---|---|---|
| Comparative Example 1 | 100 | 100 | 100 |
| Device Example 1 | 97 | 113 | 123 |
| Device Example 2 | 95 | 119 | 129 |
| Device Example 3 | 97 | 123 | 133 |
| Device Example 4 | 99 | 115 | 121 |
| Device Example 5 | 98 | 121 | 127 |
| Device Example 6 | 96 | 126 | 130 |
| Device Example 7 | 96 | 125 | 131 |
| Device Example 8 | 95 | 119 | 130 |
| Device Example 9 | 97 | 122 | 128 |
| Device Example 10 | 97 | 123 | 134 |
| Device Example 11 | 96 | 122 | 127 |
| Device Example 12 | 98 | 120 | 127 |
| Device Example 13 | 95 | 125 | 131 |
| Device Example 14 | 95 | 127 | 135 |
| Device Example 15 | 97 | 118 | 125 |

From Table 2, it can be seen that compared with Comparative Example 1, Device Examples 1 to 15 prepared in the present application exhibit good device performance in terms of driving voltage, current efficiency, and device lifetime. The improvement in performance of each device is based on the better electron transfer ability of the specific compound material of the present application. It can be seen that using it as a luminescent layer material to prepare electronic devices has higher current efficiency and device lifespan while reducing the driving voltage. This indicates that the compounds provided by the present application have certain commercial application value.

In a preferred specific example, the structure of Device Example 16 provided by the present application is: ITO/P-4 (10 nm)/NPD (60 nm)/HTH-85 (5 nm)/Platinum (II) complex: boron-containing compound: HTH-85: ETH-45 (25 nm) (mass ratio of Pt169: BN1-8: HTH-85: ETH-45 is 10:1:59:30)/ETH-5 (5 nm)/ET-14 (40 nm)/LiQ (1nm)/Al (100nm).

Devices Examples 17 to 30 were prepared using structures similar to those in Device Example 16, respectively, with the only difference being that the fluorinated tetradentate platinum (II) complex and boron-containing compound in Device Example 16 were replaced with compounds listed in Table 3, respectively. The device structures and luminescence characteristics data are shown in Table 3.

**Table 3. Device Structure and Luminescence Characteristics Data Table**

| Example | Platinum (II) complex: boron-containing compound | driving voltage (V) @10mA/cm² (Relative value, %) | Current efficiency (cd/A) @1000 cd/m² (Relative value, %) | Device lifespan (h) @1000 cd/m² (Relative value, %) |
|---|---|---|---|---|
| Comparative Example 1 | R1 | 100 | 100 | 100 |
| Device Example 16 | Pt-169: BN1-8 | 96 | 115 | 122 |
| Device Example 17 | Pt-170: BN1-10 | 97 | 119 | 131 |
| Device Example 18 | Pt-172: BN1-22 | 97 | 123 | 128 |
| Device Example 19 | Pt-4: BN1-48 | 98 | 116 | 123 |
| Device Example 20 | Pt-52: BN2-2 | 97 | 121 | 128 |
| Device Example 21 | Pt-86: BN2-9 | 96 | 123 | 130 |
| Device Example 22 | Pt-144: BN2-15 | 98 | 129 | 133 |
| Device Example 23 | Pt-171: BN2-28 | 97 | 118 | 126 |
| Device Example 24 | Pt-394: BN2-34 | 97 | 120 | 121 |
| Device Example 25 | Pt-312: BN2-41 | 96 | 125 | 128 |
| Device Example 26 | Pt-338: BN2-54 | 98 | 125 | 134 |
| Device Example 27 | Pt-394: BN2-66 | 98 | 124 | 124 |
| Device Example 28 | Pt-422: BN2-66 | 96 | 127 | 131 |
| Device Example 29 | Pt-478: BN2-90 | 96 | 122 | 130 |
| Device Example 30 | Pt-646: BN3-1 | 97 | 125 | 127 |

As shown in Table 3, when the compounds of the present application is used as a sensitizer and combined with boron-containing compounds as a luminescent material on devices, the performance of each device is also significantly improved. This further indicates that the compounds provided by the present application have certain commercial application value.

In addition, the devices prepared by the present application are all deep blue light devices, with CIEy values all less than 0.20. By adding boron-containing compounds to sensitize the device structure, the CIEy value can be further reduced, thereby improving the luminescence color purity of the device.

The above described are only preferred embodiments of the present application, but the scope of protection of the present application is defined in the claims.

## Claims

1. A fluorinated tetradentate platinum (II) complex, wherein the complex has a structure as shown in Formula (I) or Formula (II): 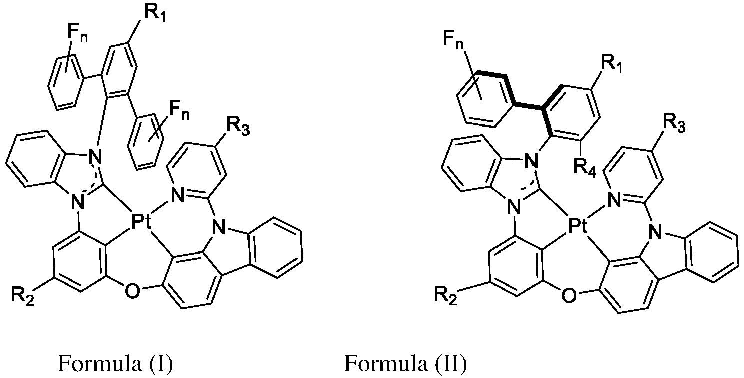 in Formula (I) or Formula (II), Fₙ represents one or more F substitutions on the benzene ring where it is (they are) located, where n is a positive integer from 1 to 5; R₁, R₂, and R₄ are selected from the group consisting of hydrogen, deuterium, a C1-C30 alkyl, a C1-C30 cycloalkyl, a C6-C60 aryl, a C1-C30 heterocycloalkyl, a C6-C18 arylamine group and a C6-C18 heterocyclic amine group, and R₃ is tert -butyl.

2. A fluorinated tetradentate platinum (II) complex, wherein the fluorinated tetradentate platinum (II) complex has any one of the following chemical structures, where "D" represents deuterium:

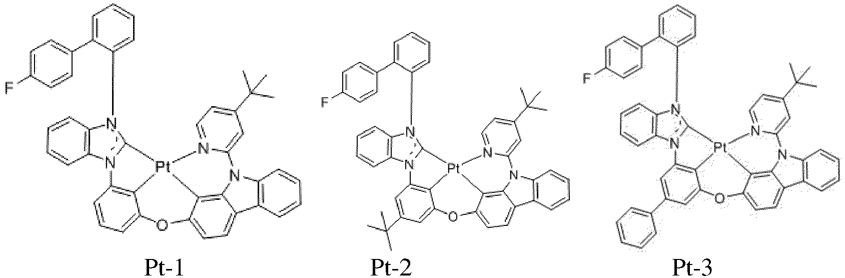

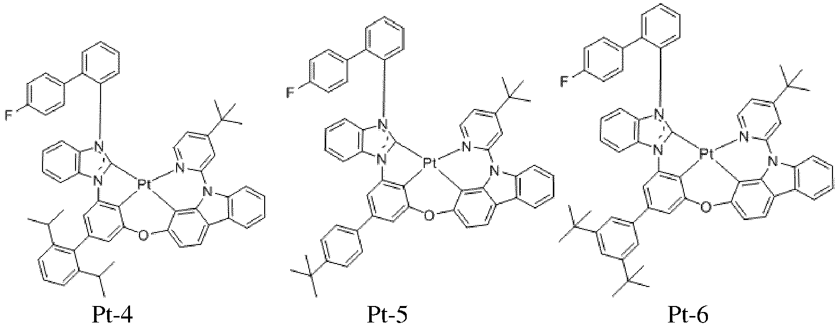

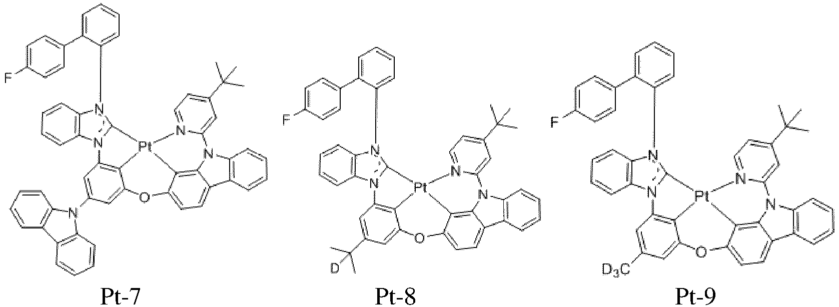

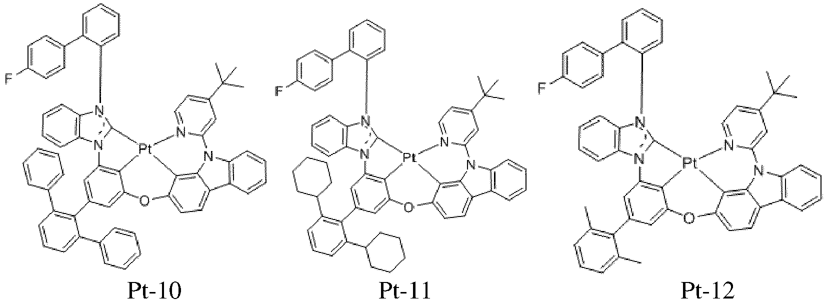

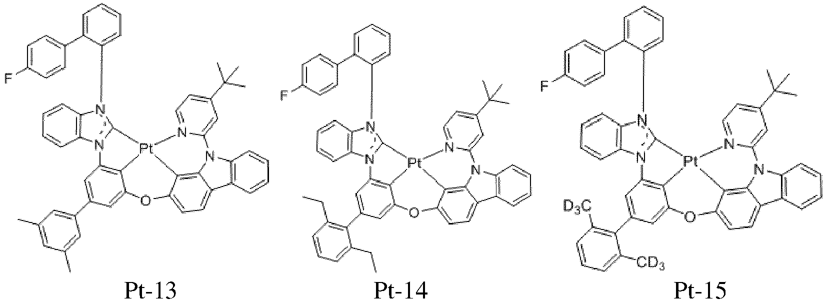

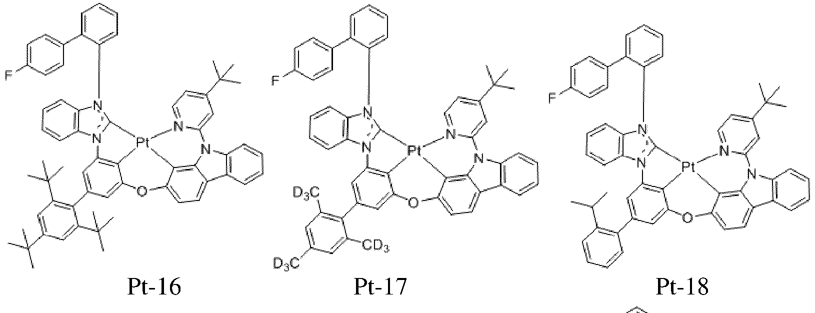

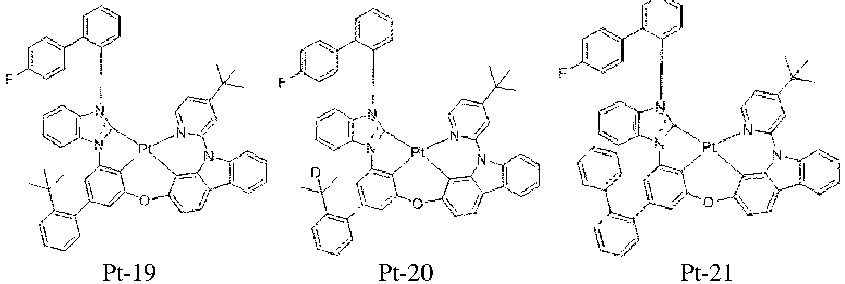

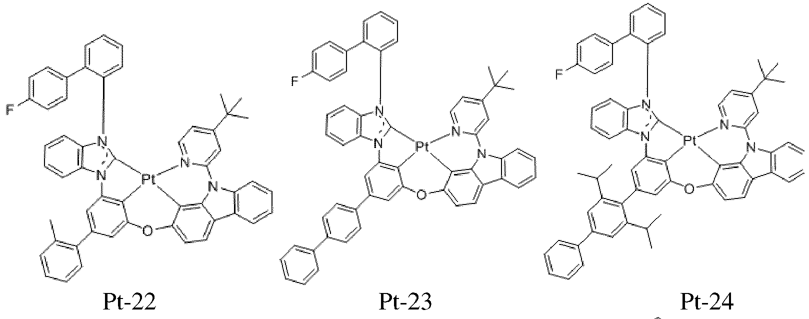

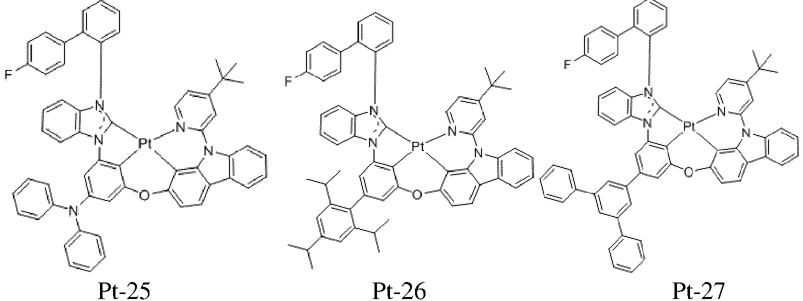

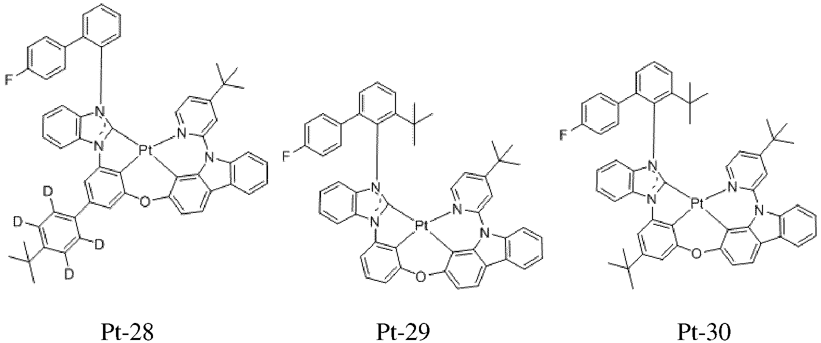

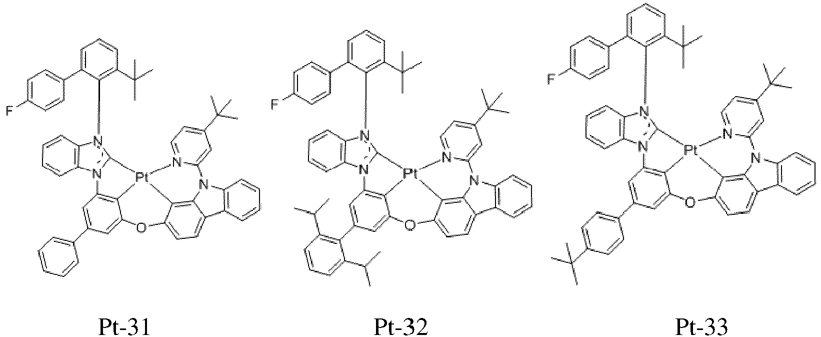

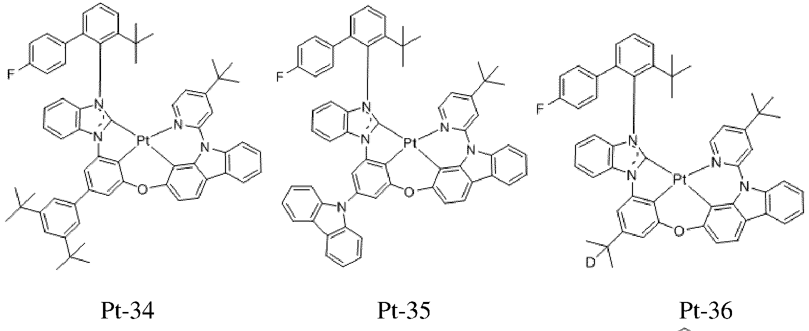

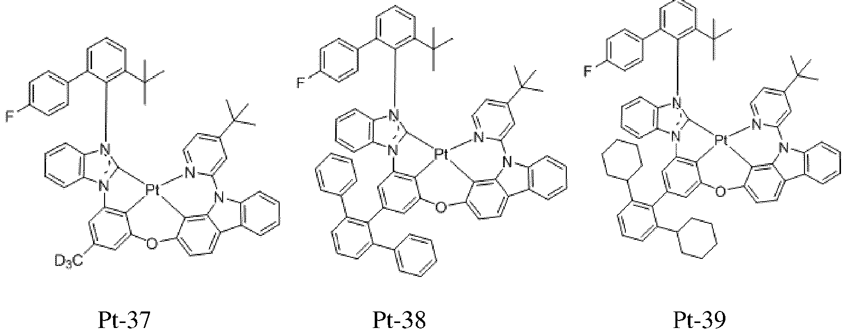

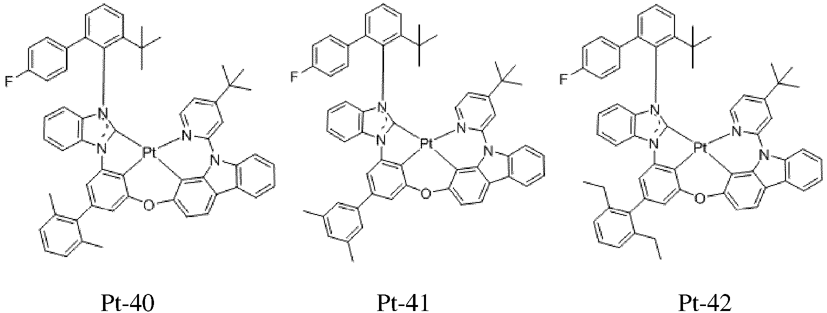

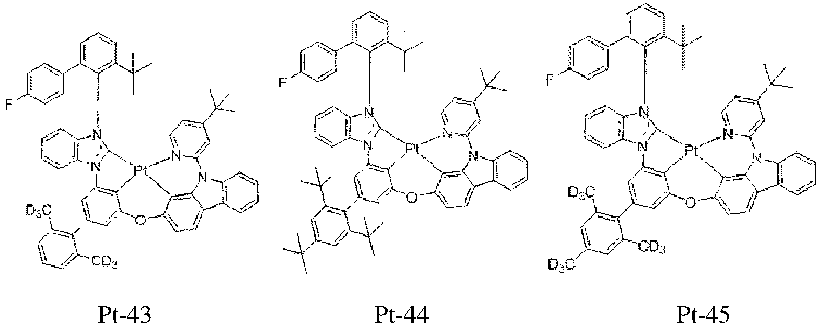

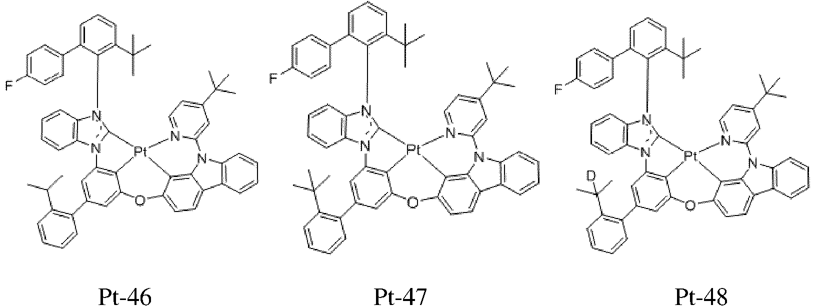

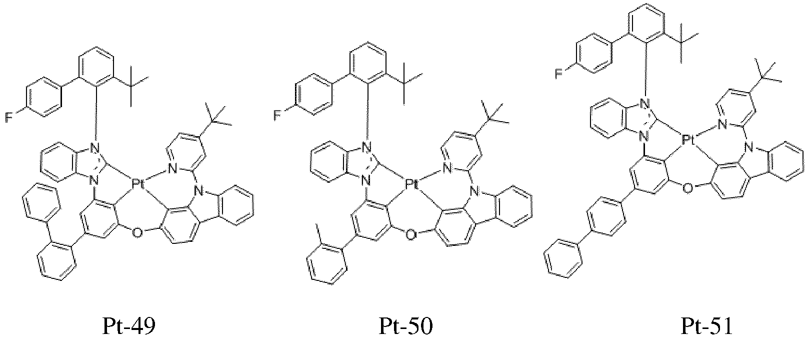

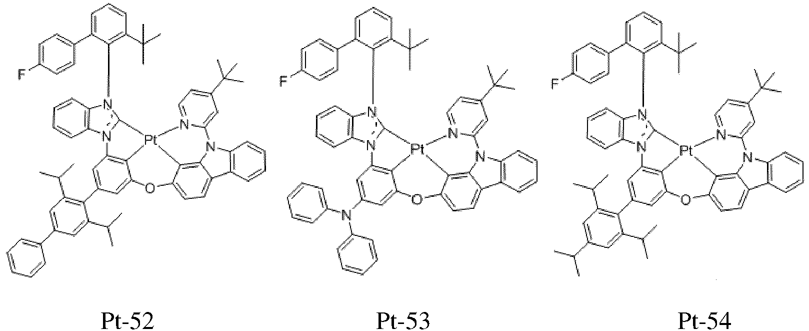

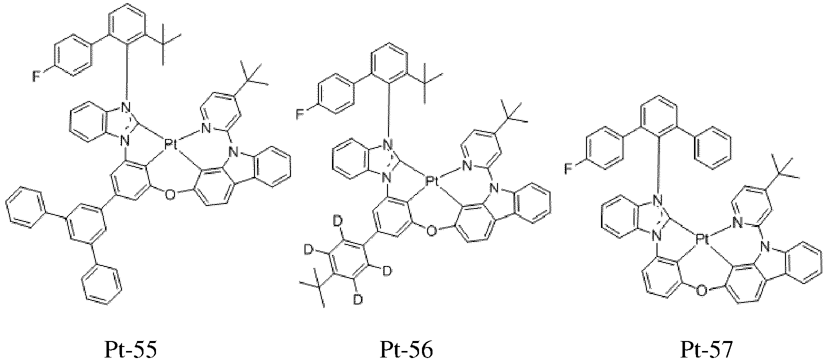

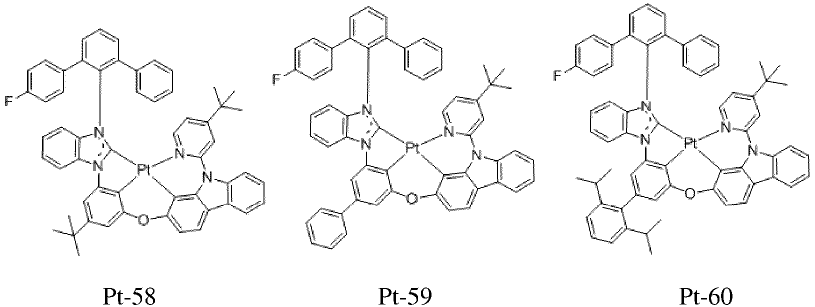

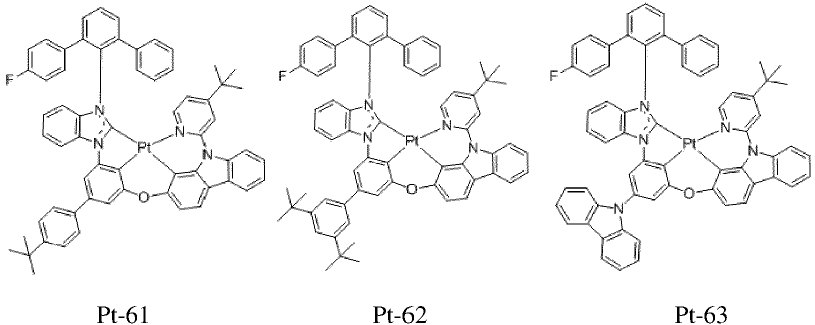

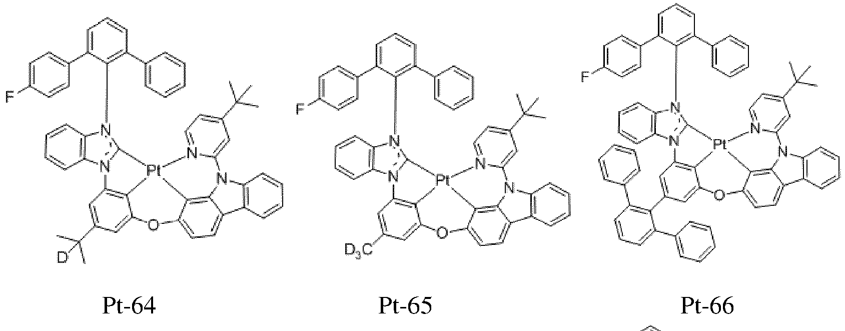

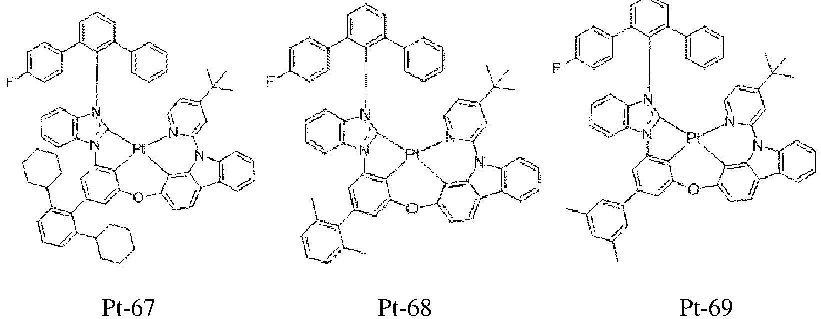

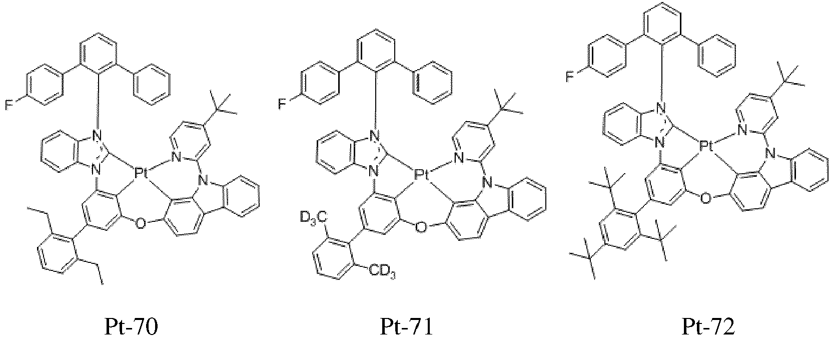

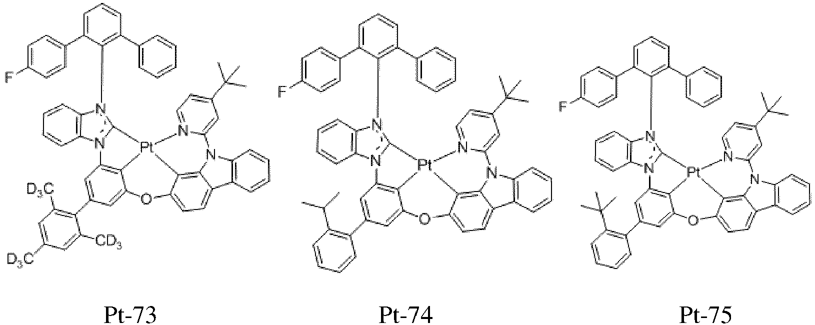

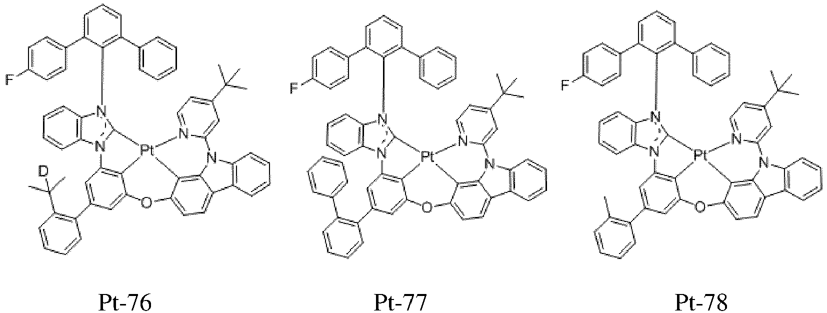

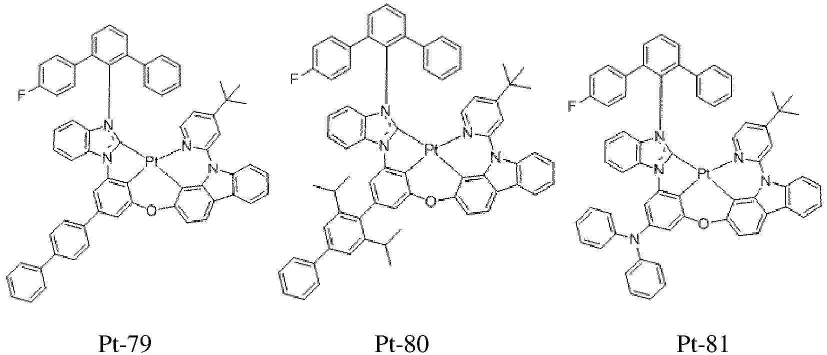

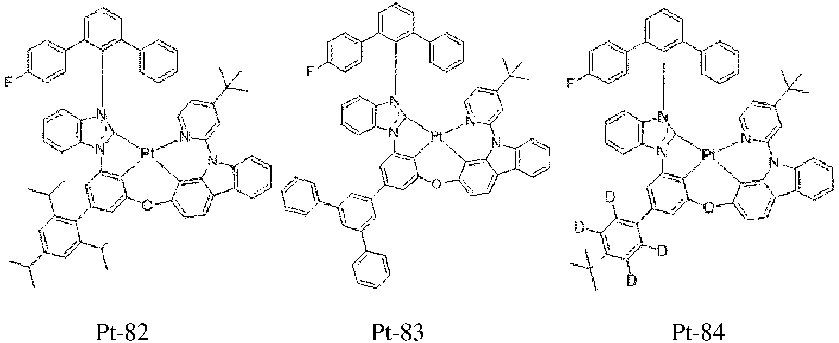

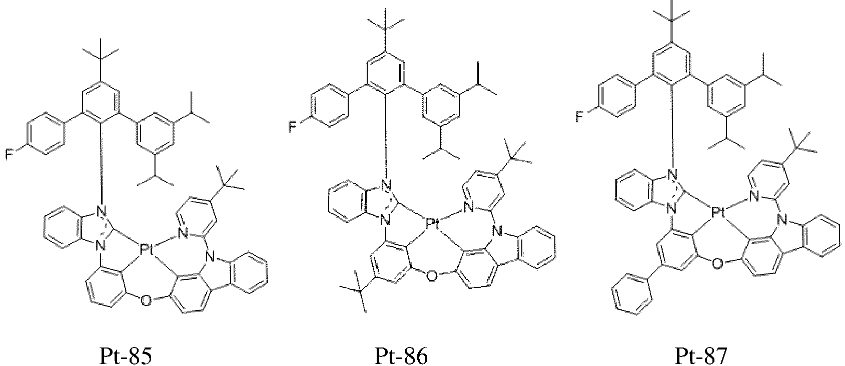

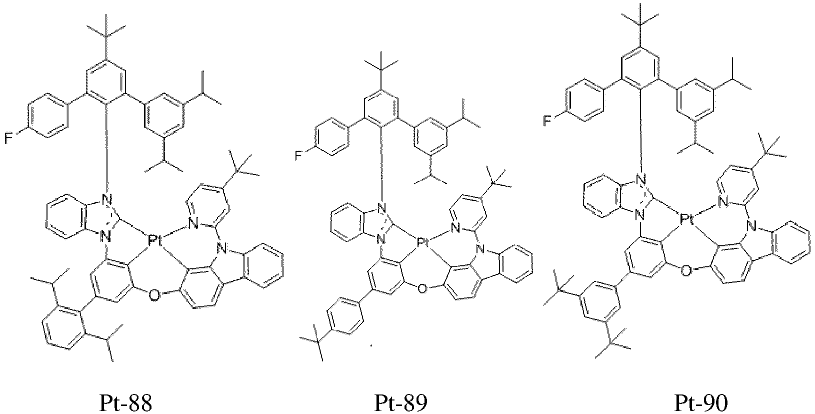

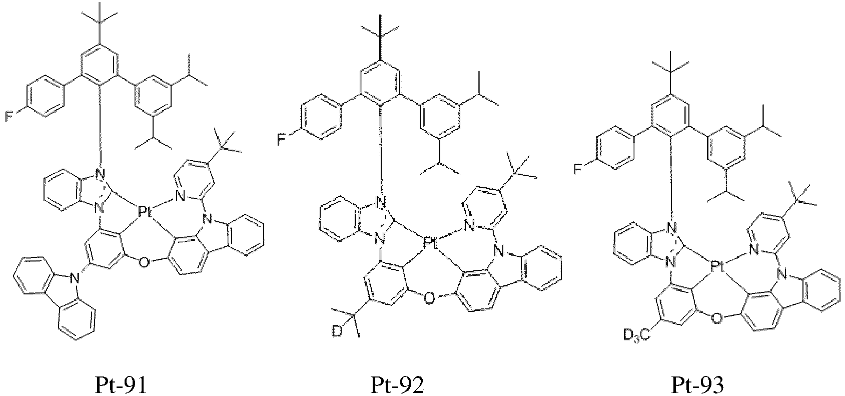

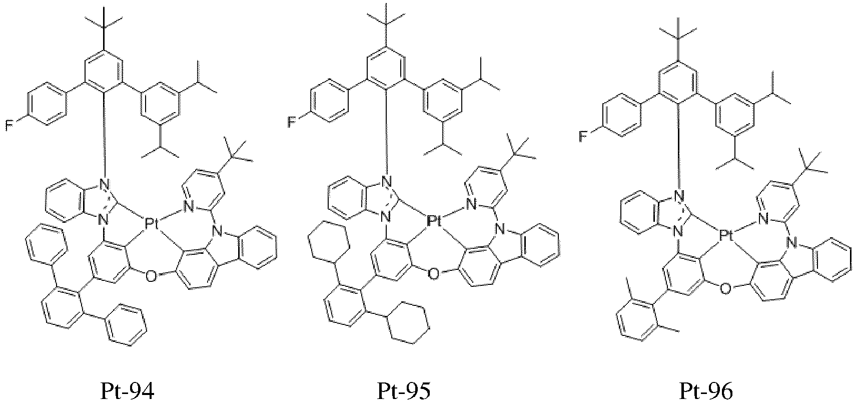

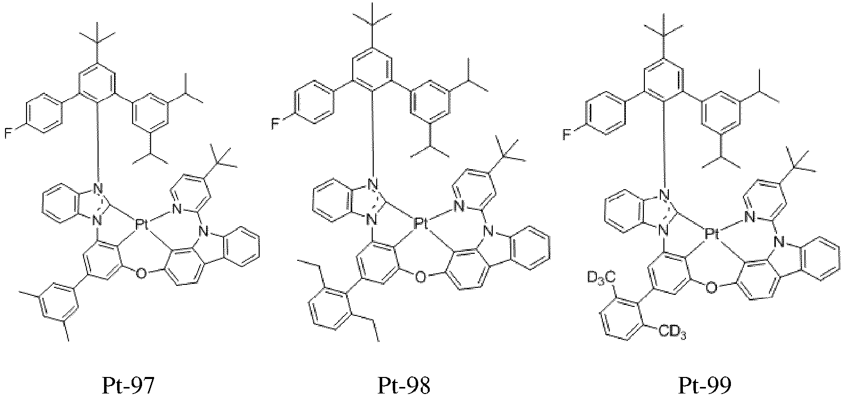

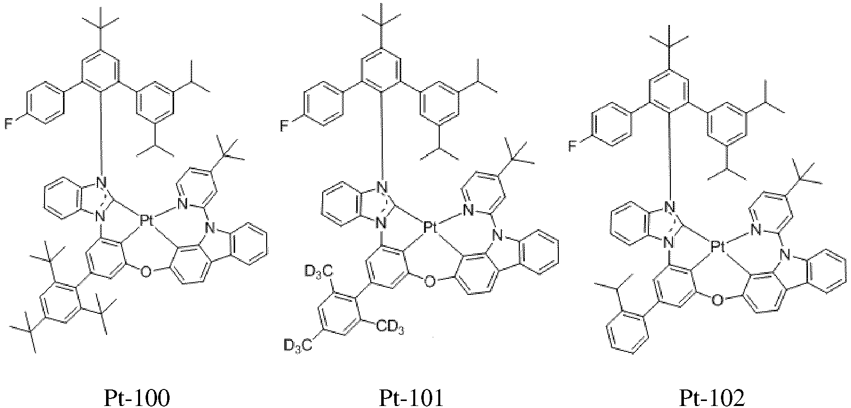

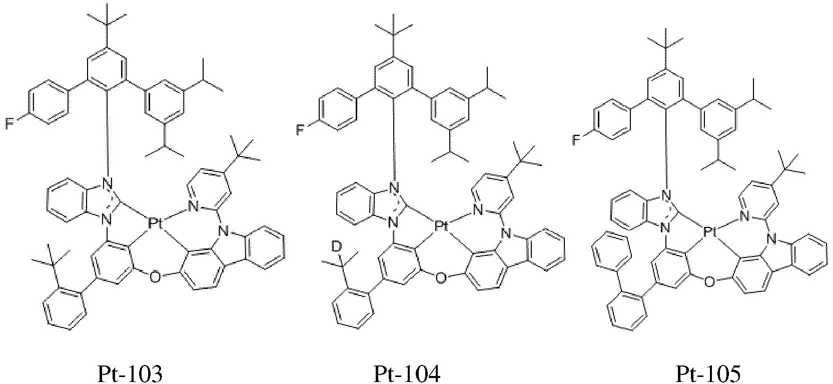

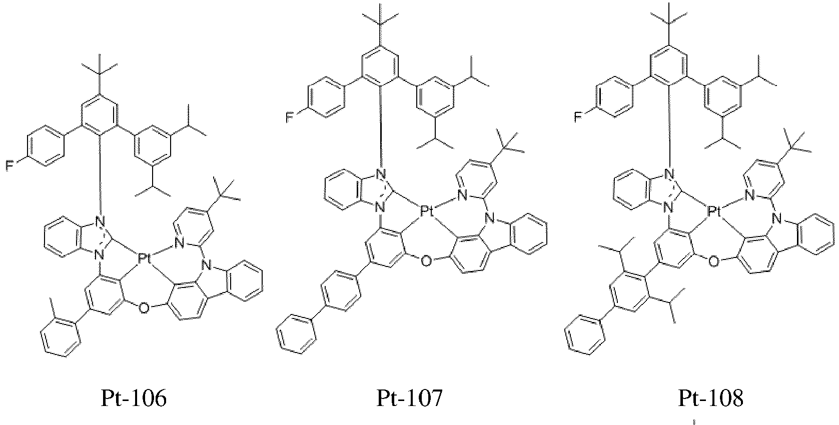

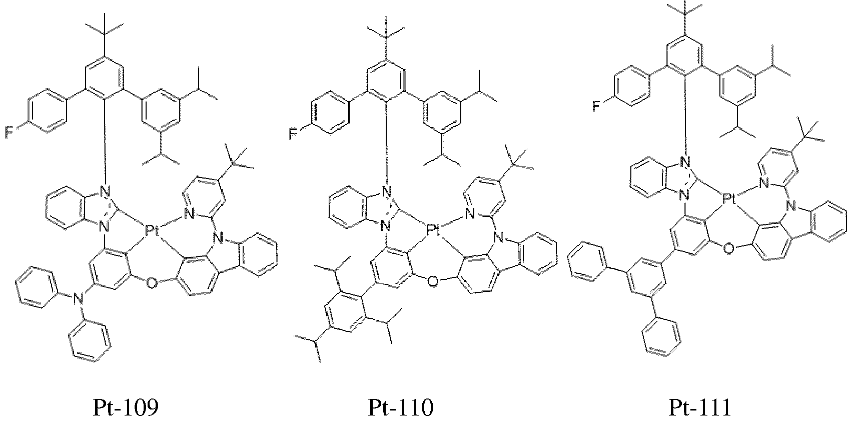

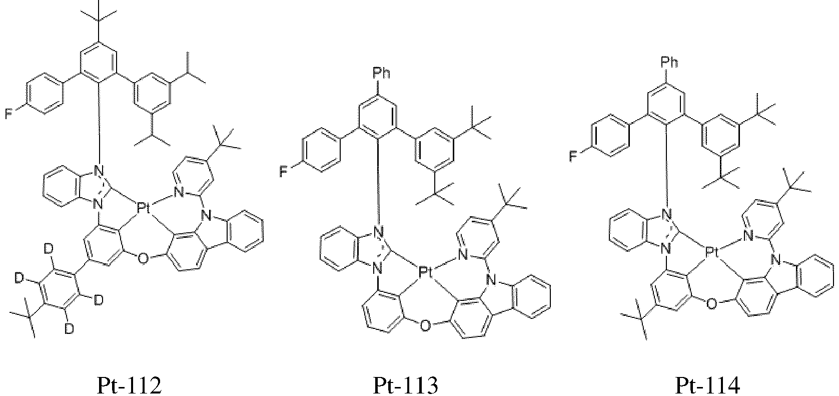

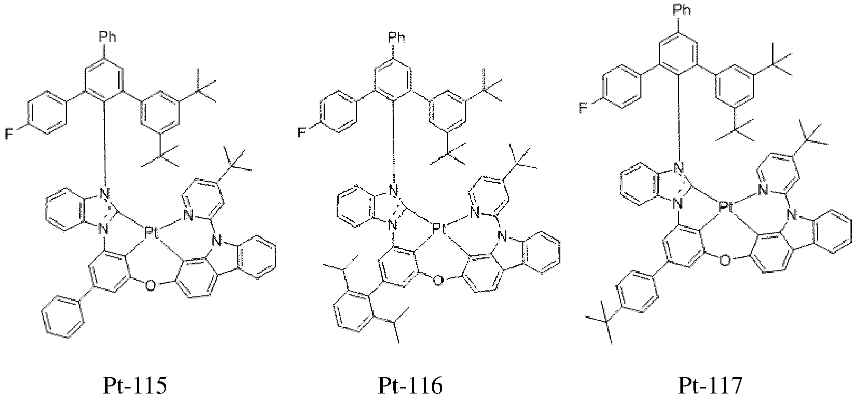

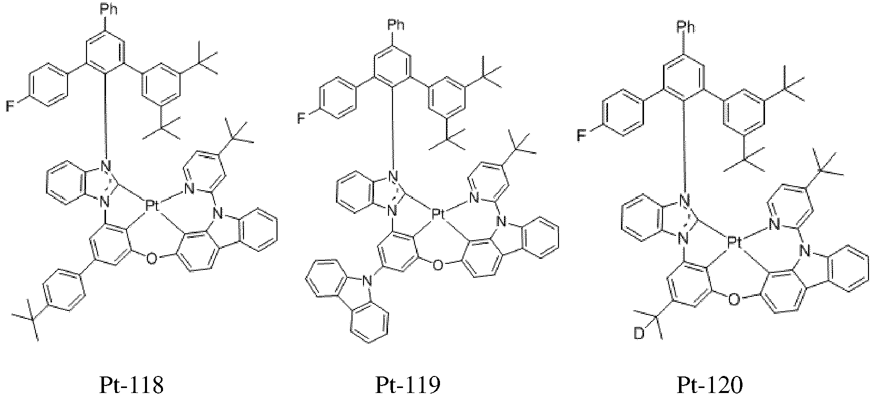

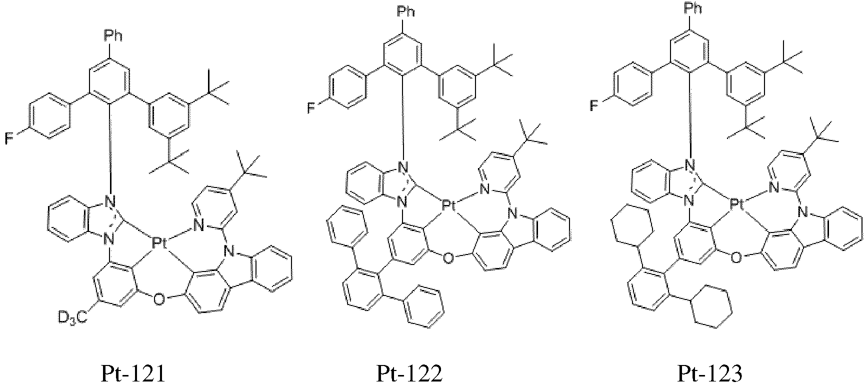

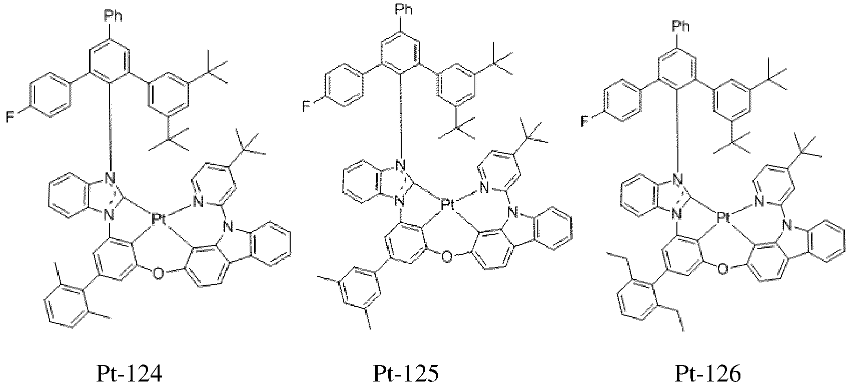

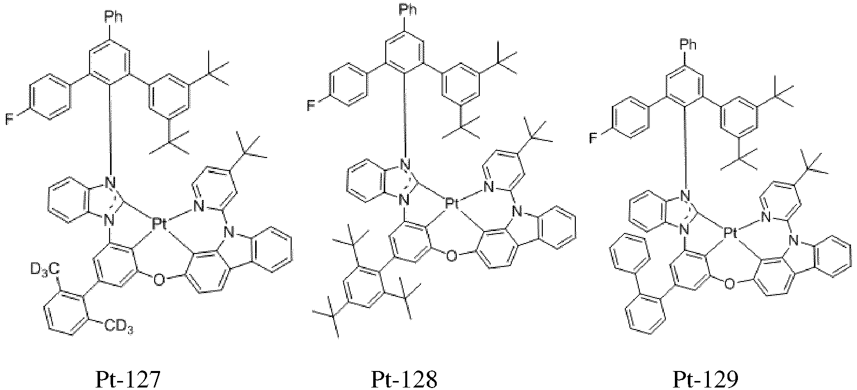

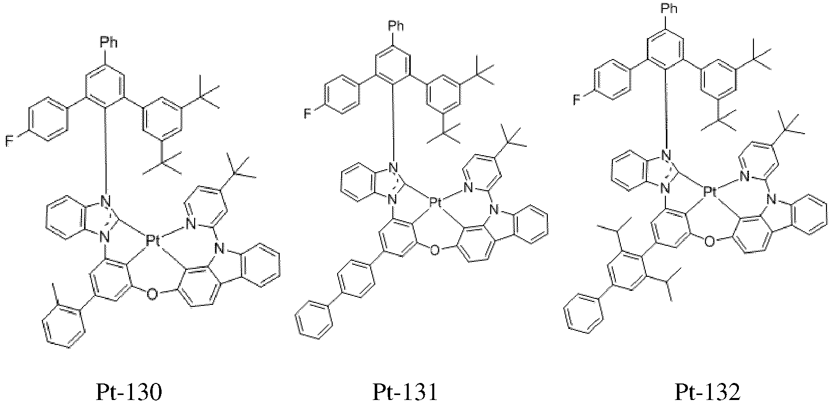

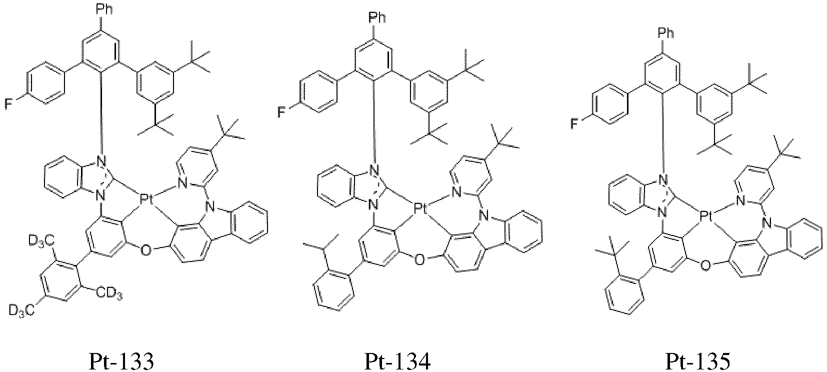

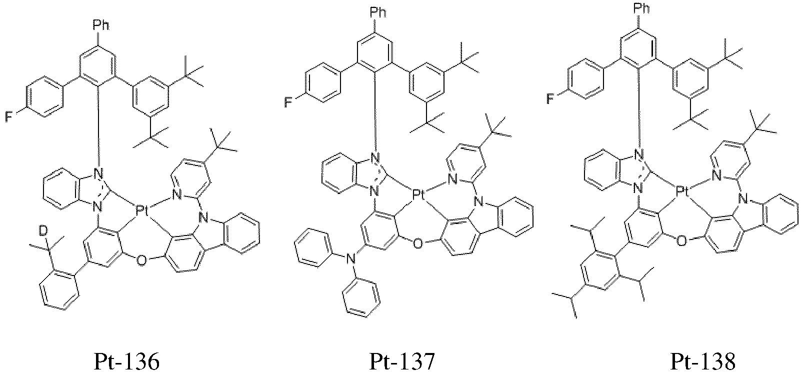

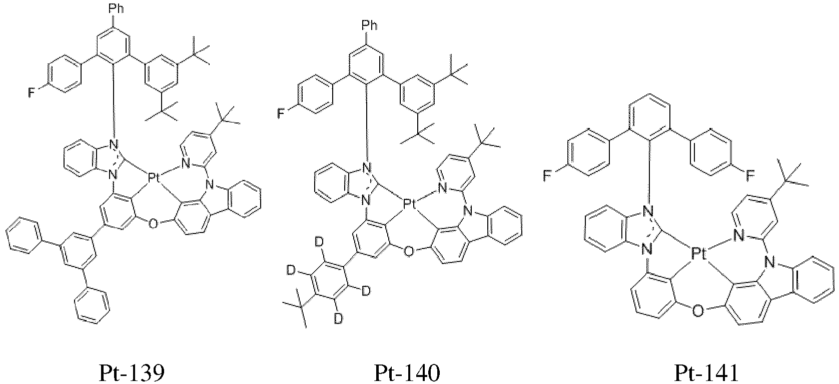

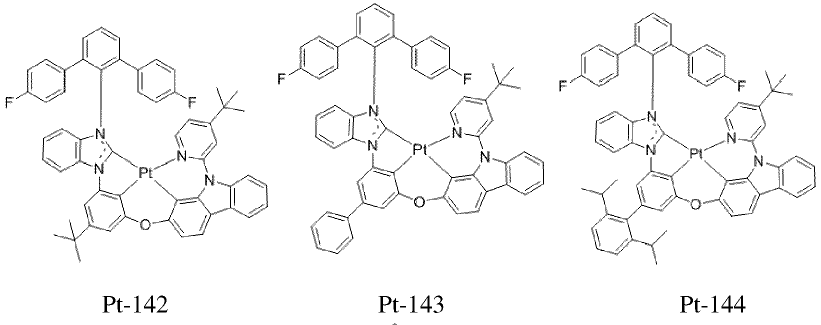

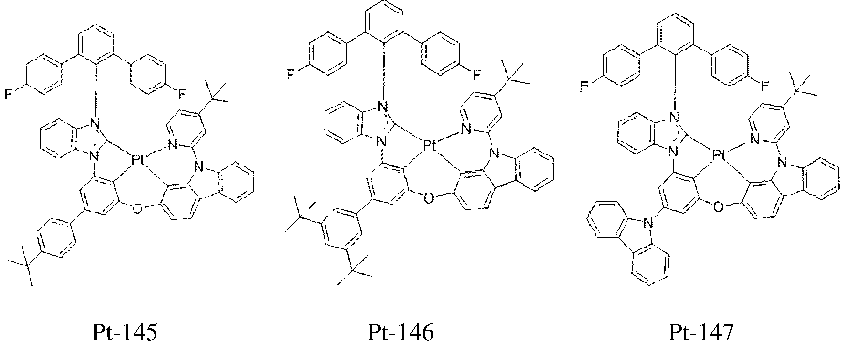

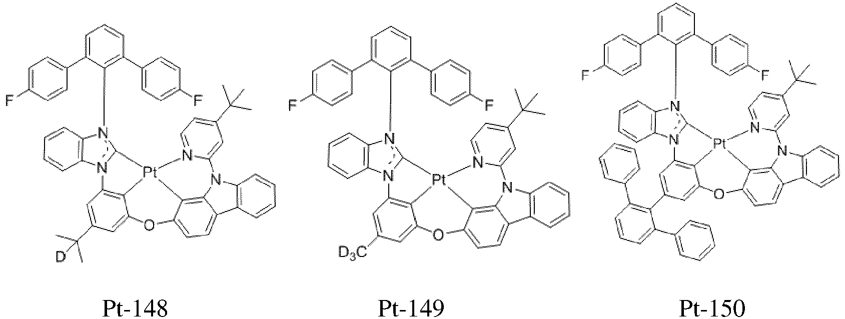

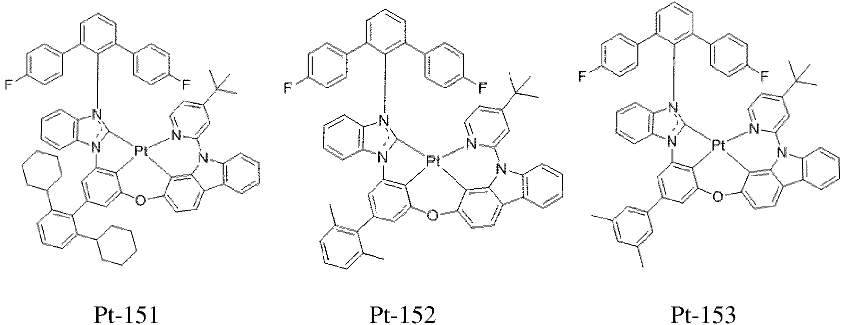

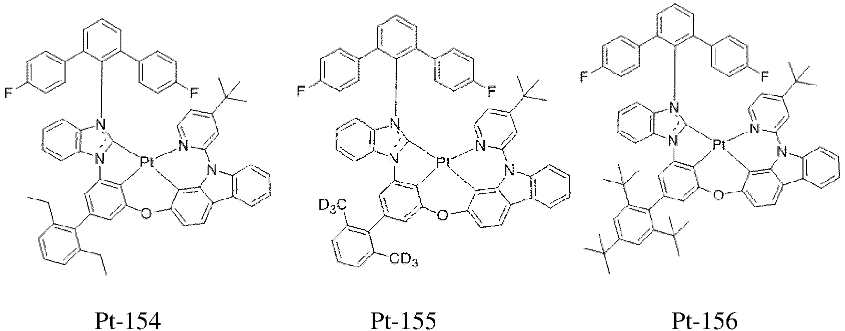

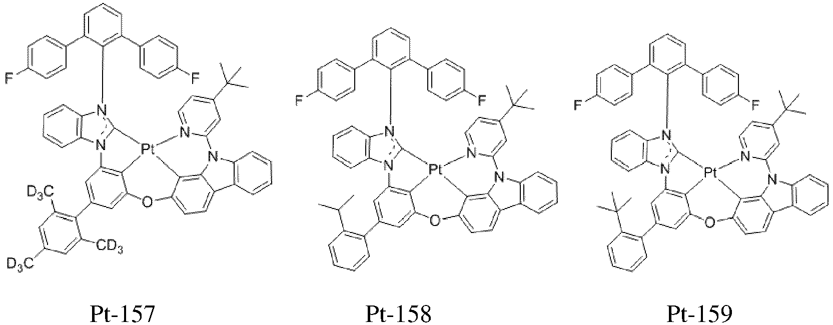

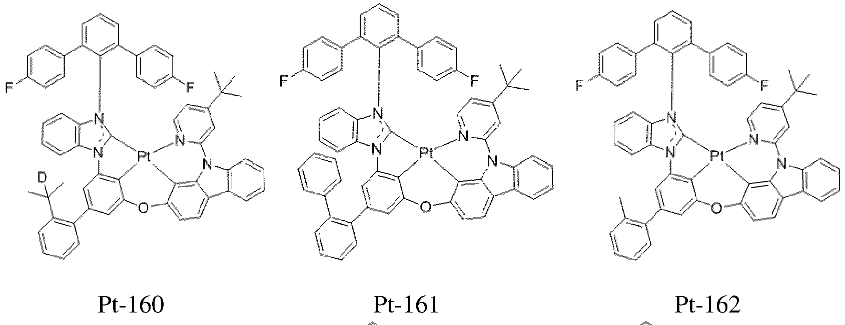

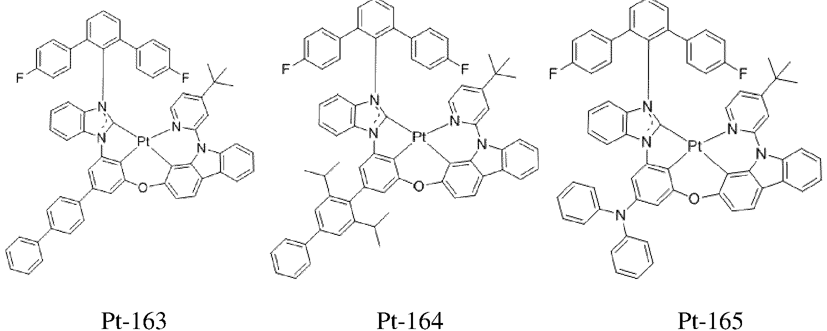

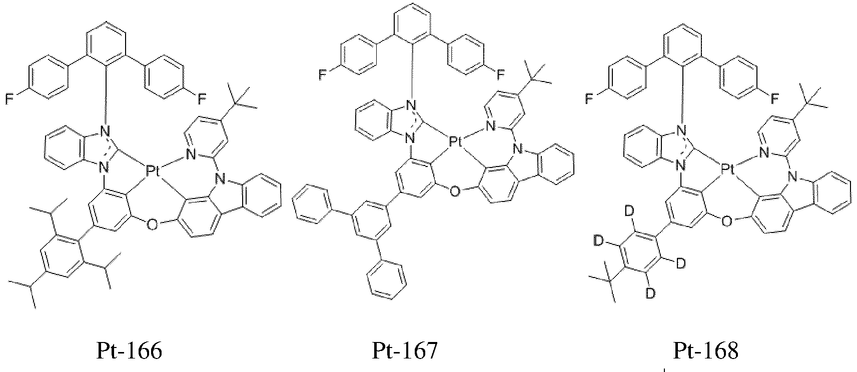

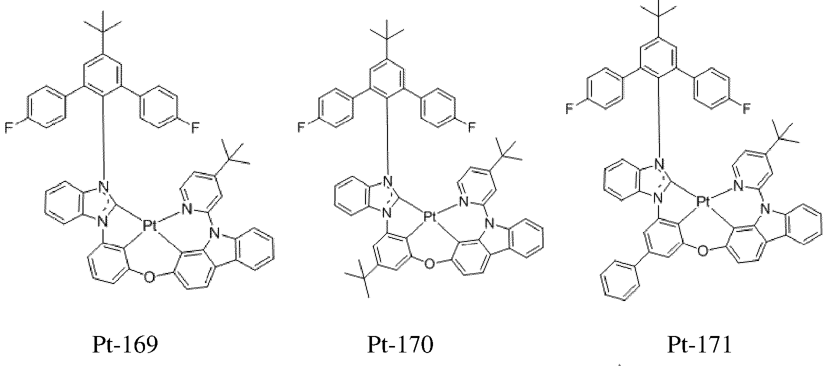

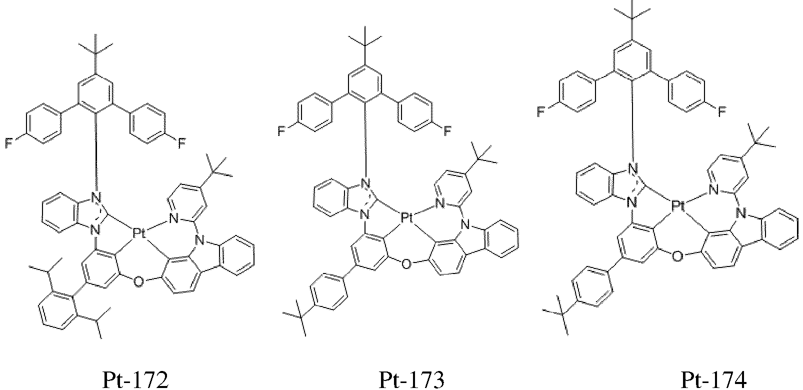

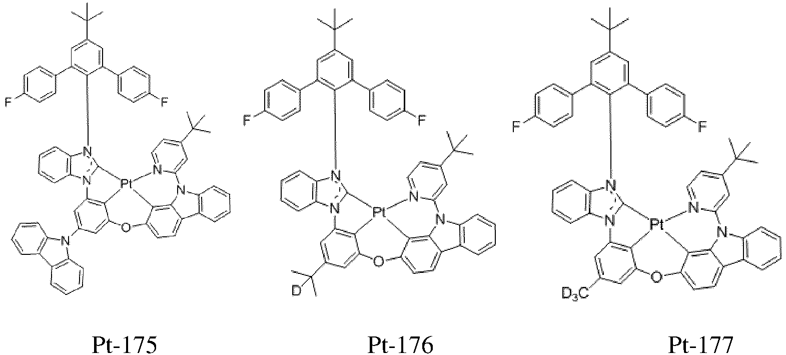

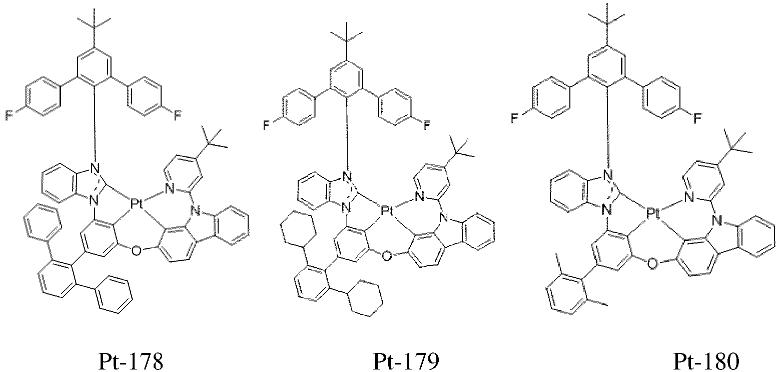

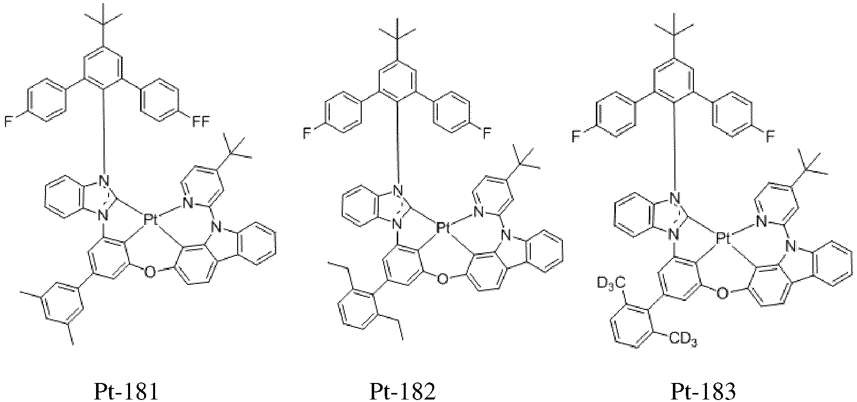

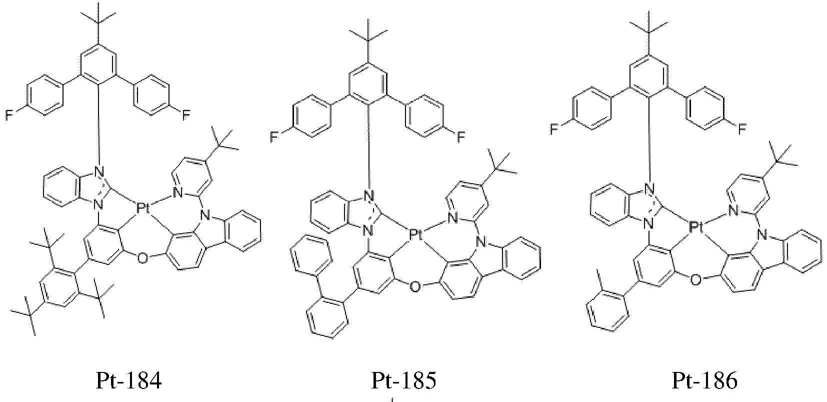

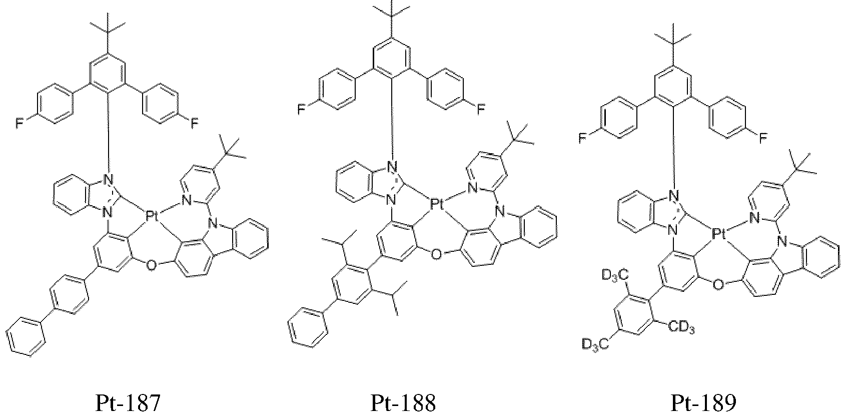

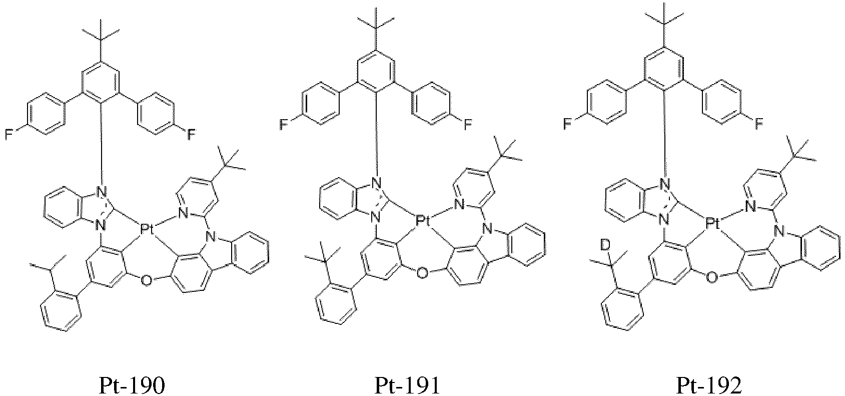

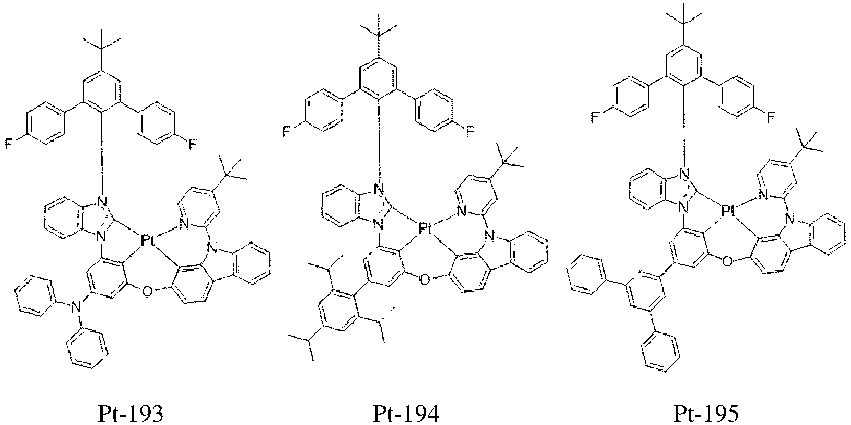

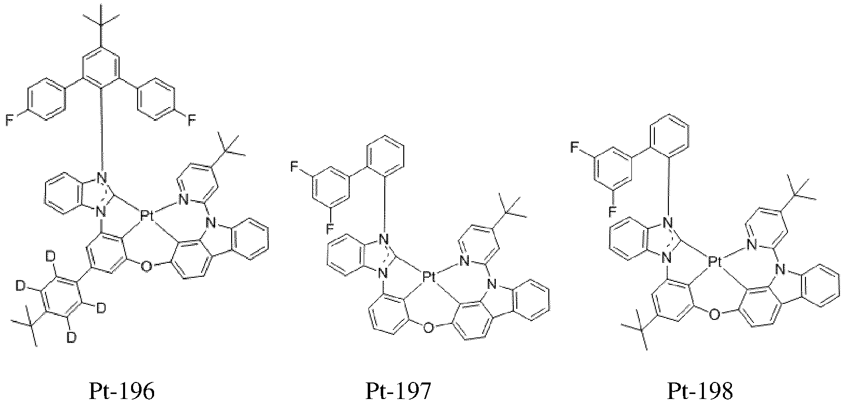

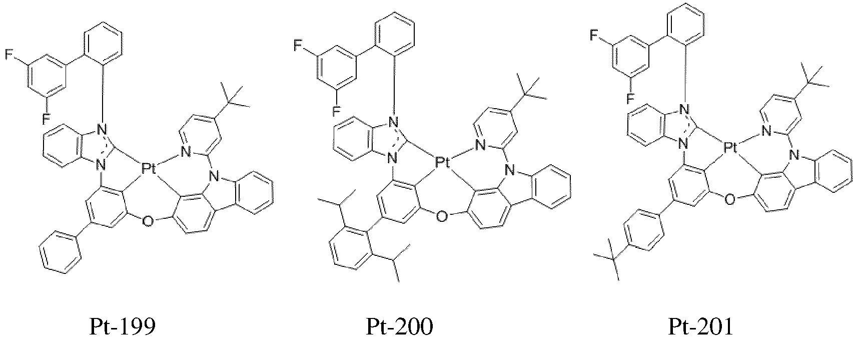

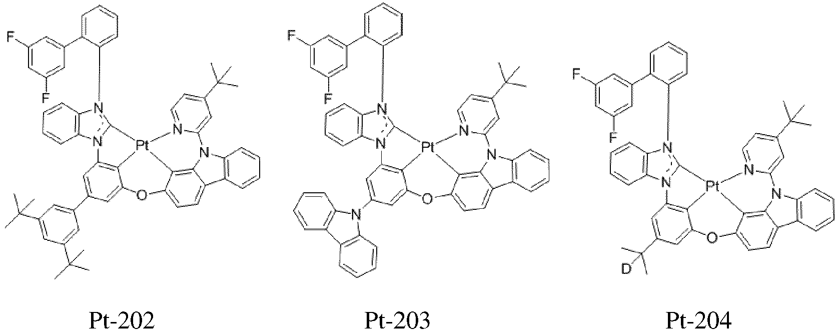

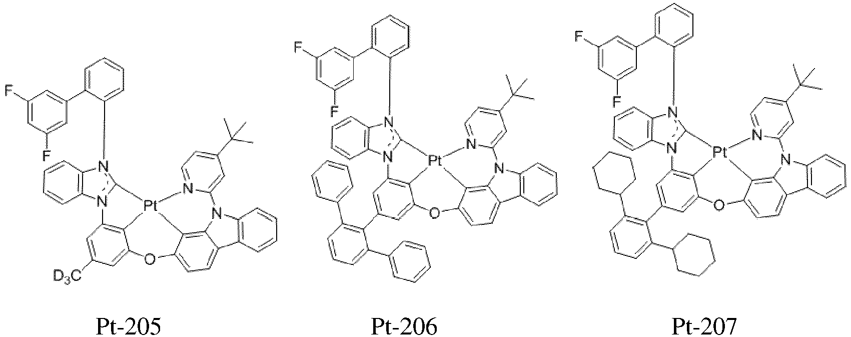

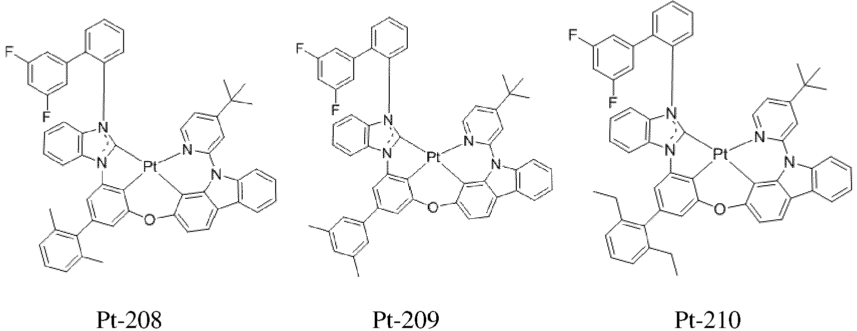

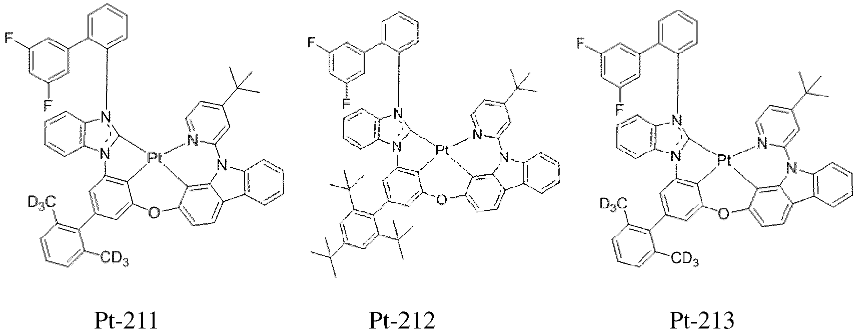

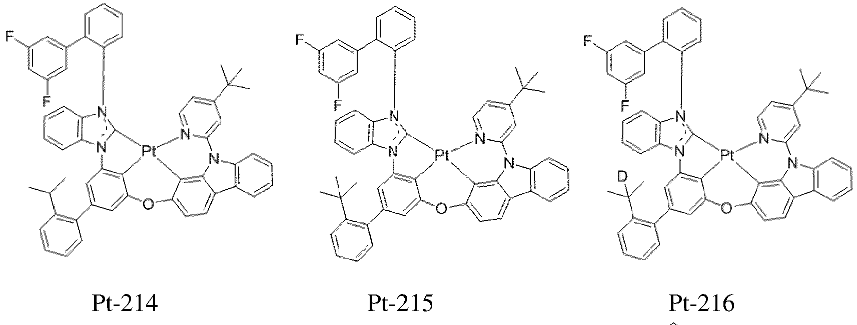

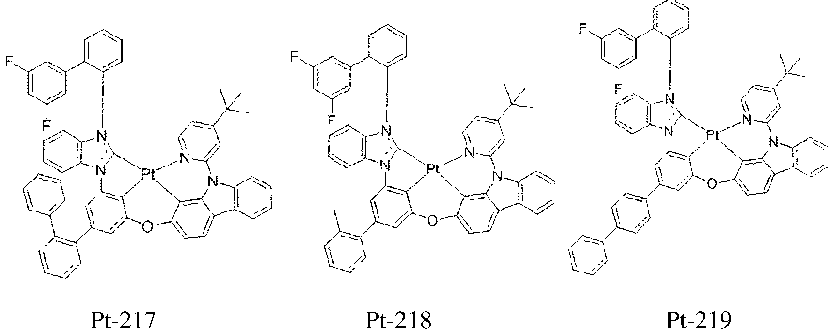

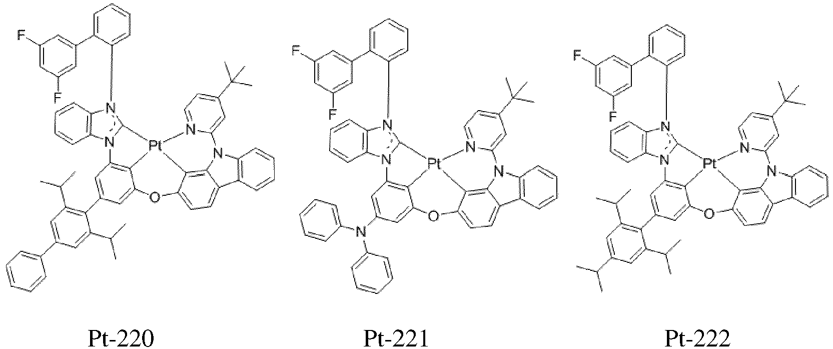

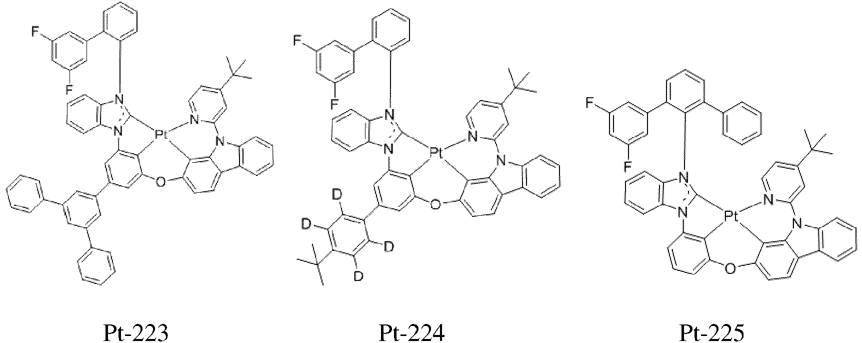

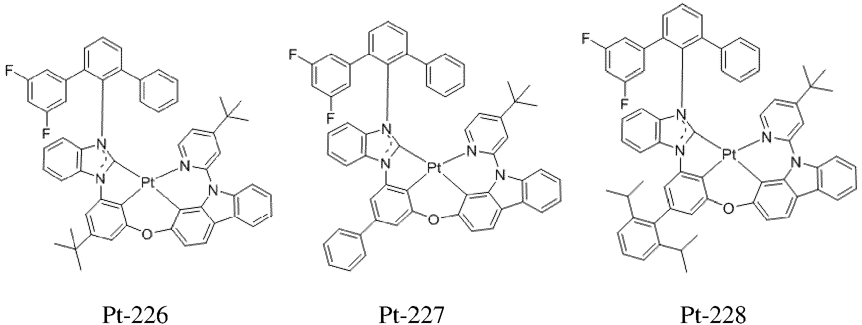

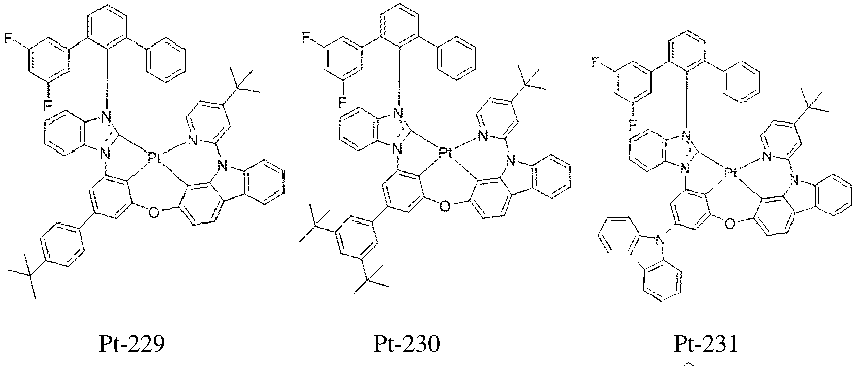

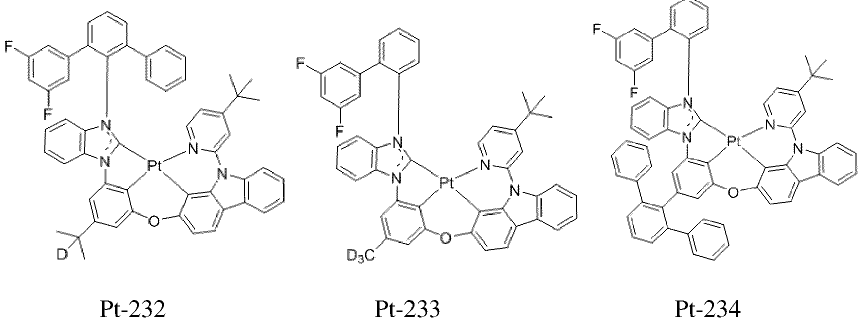

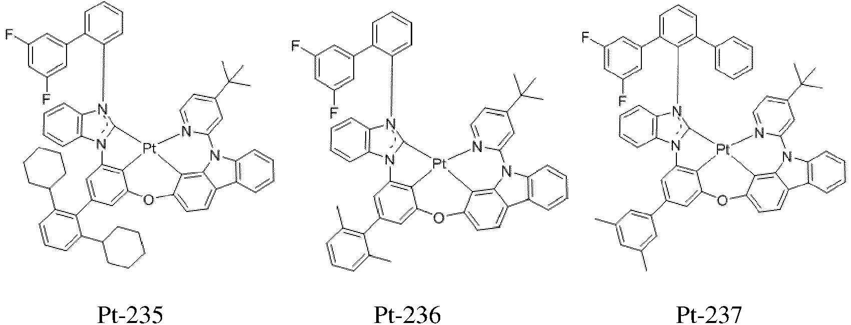

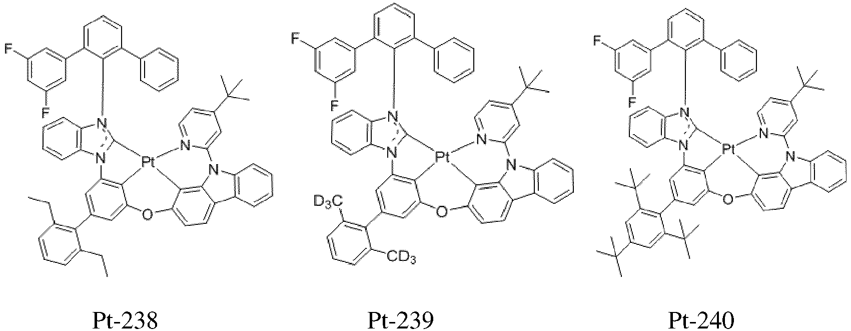

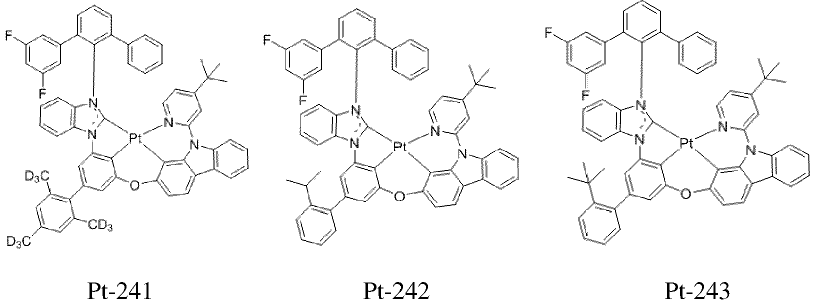

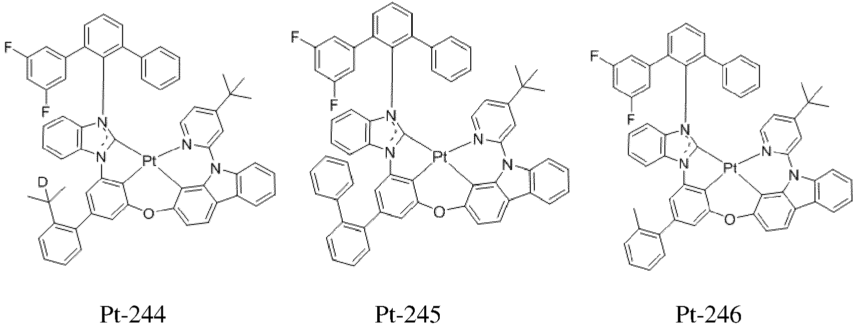

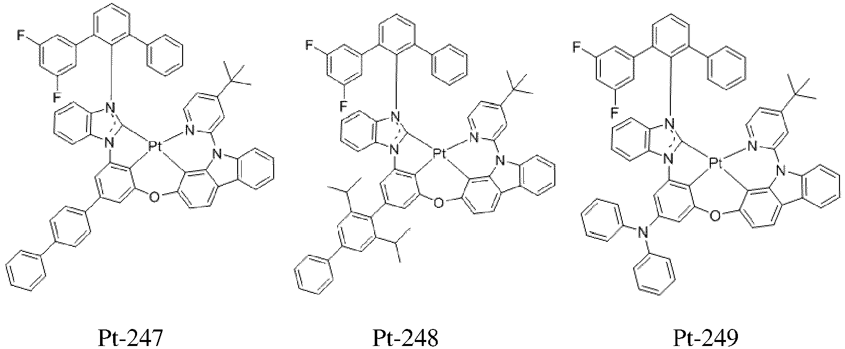

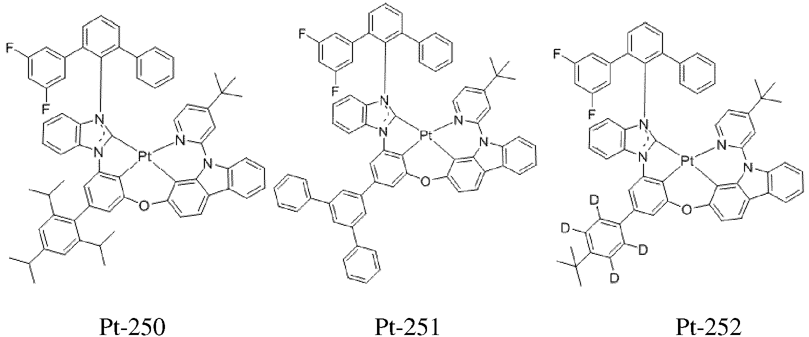

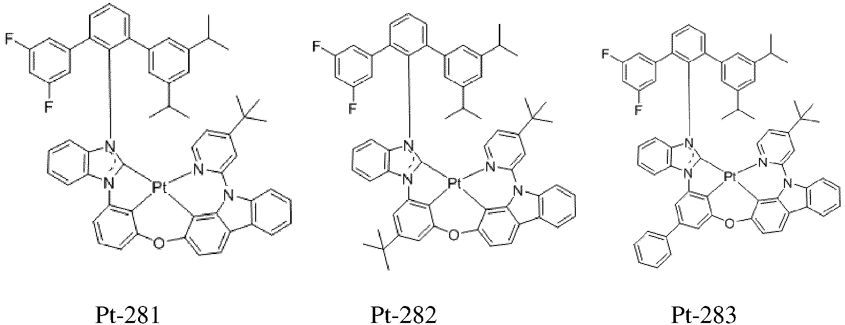

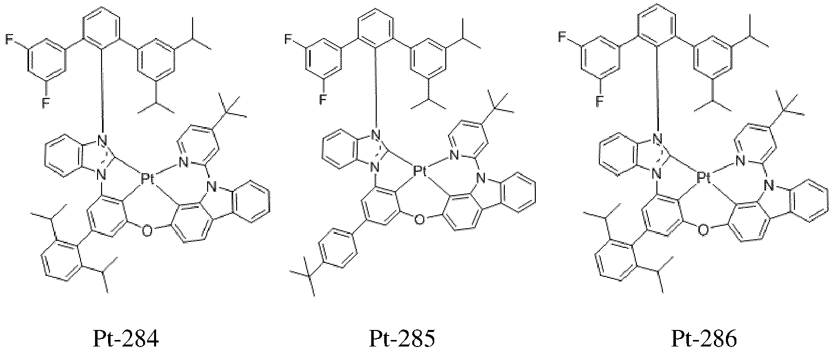

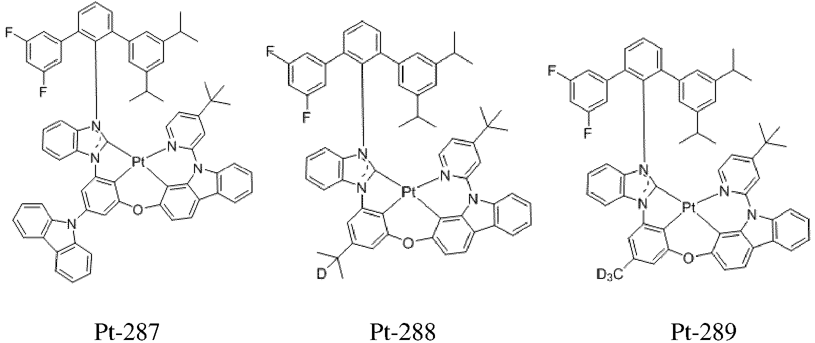

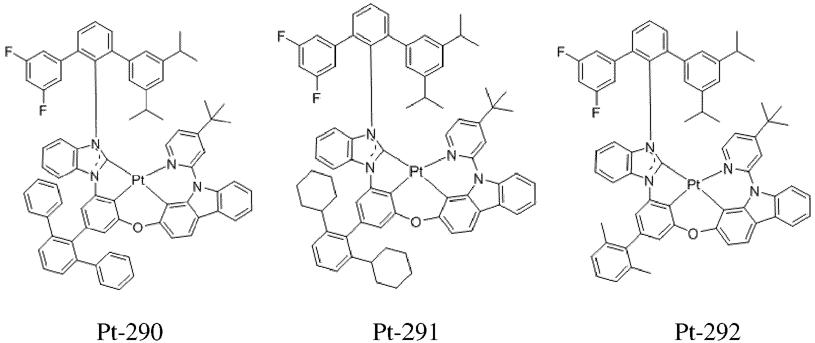

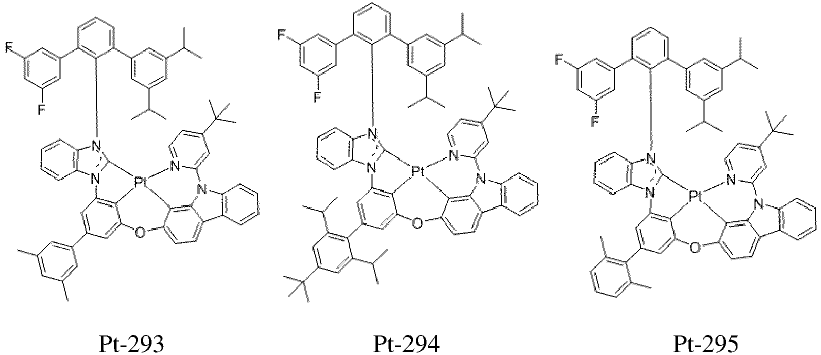

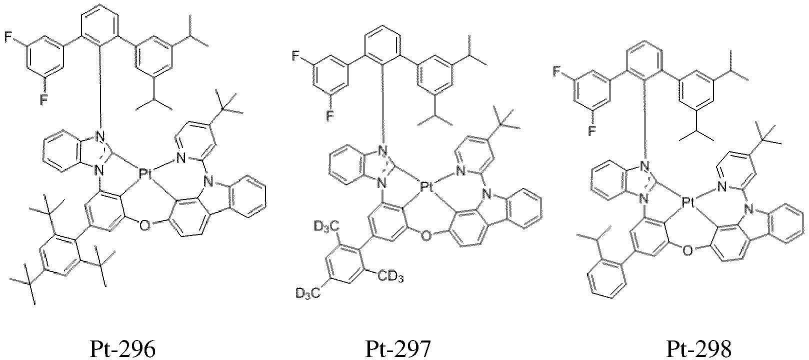

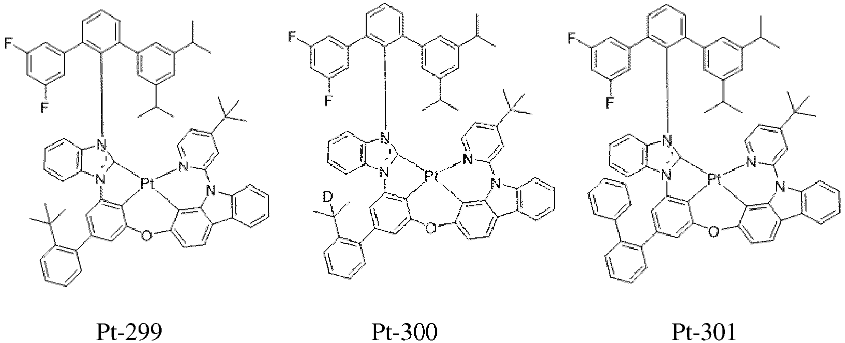

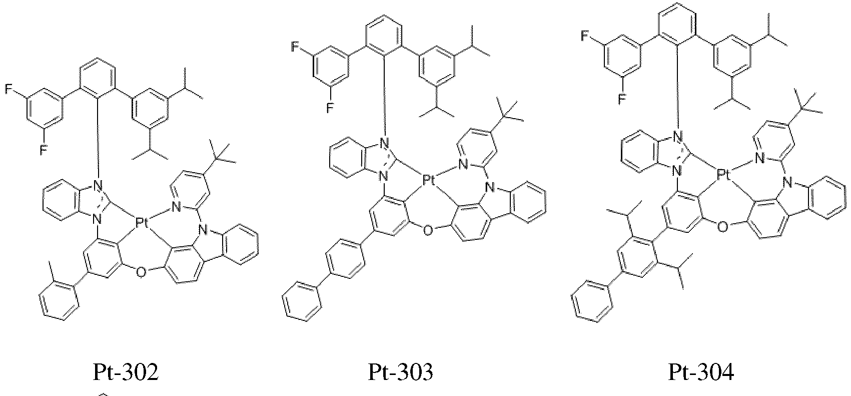

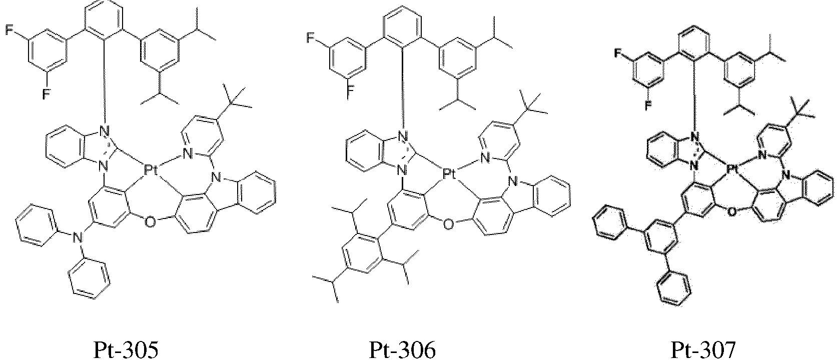

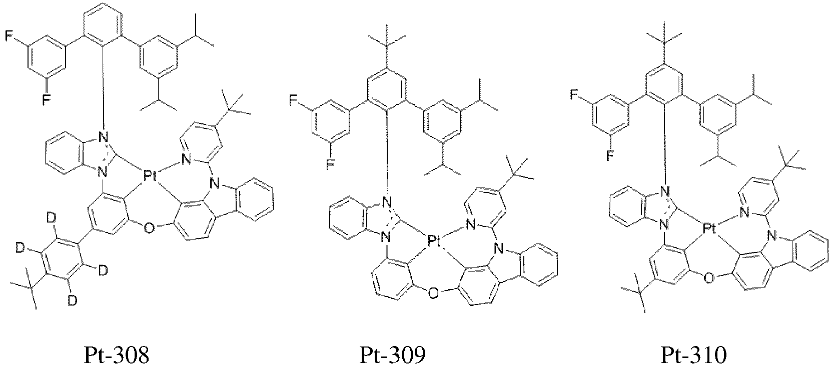

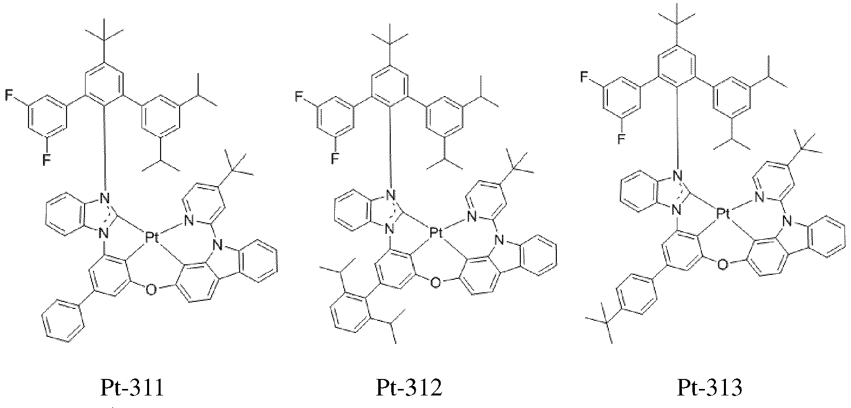

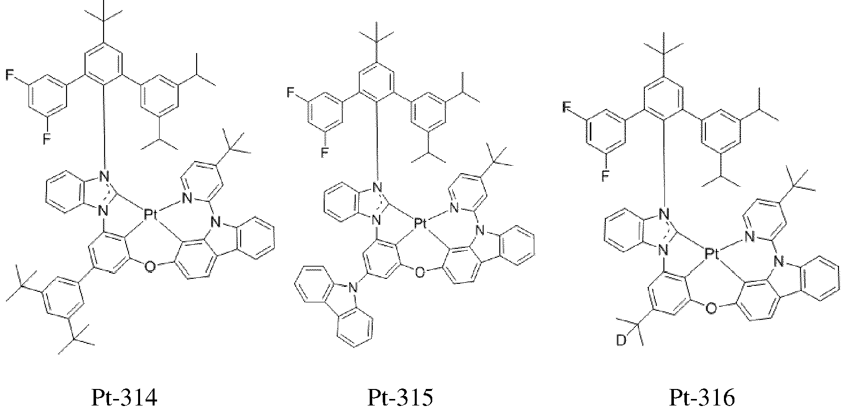

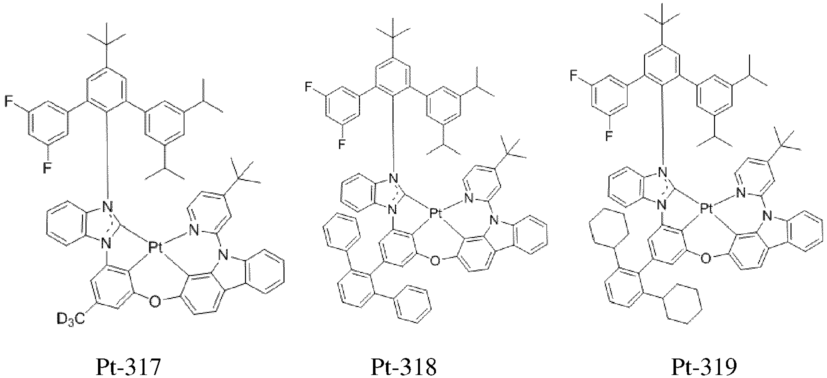

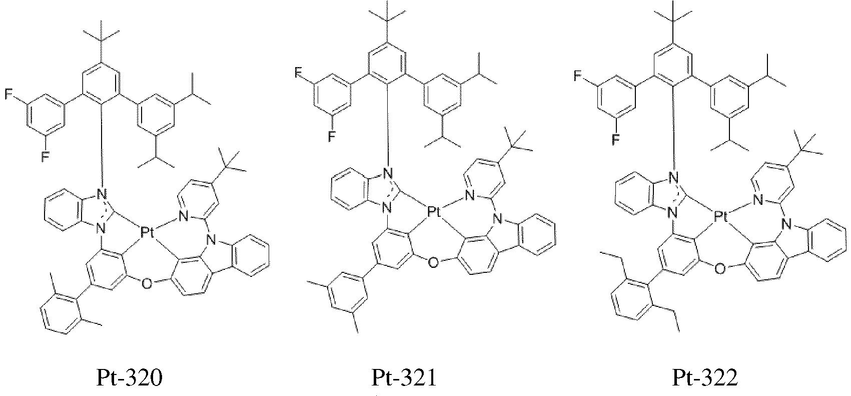

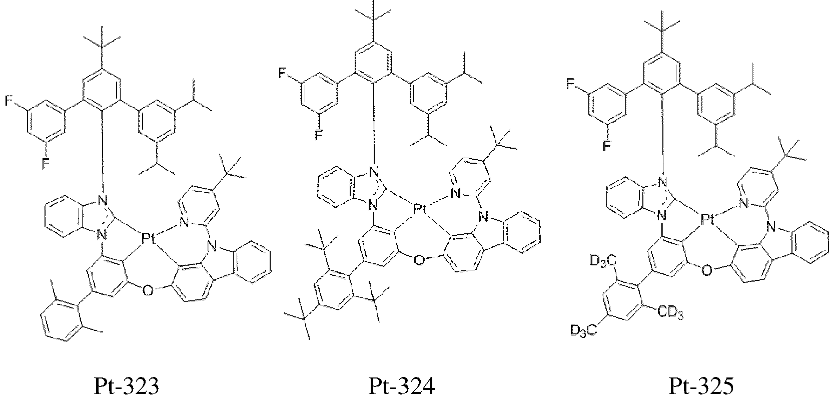

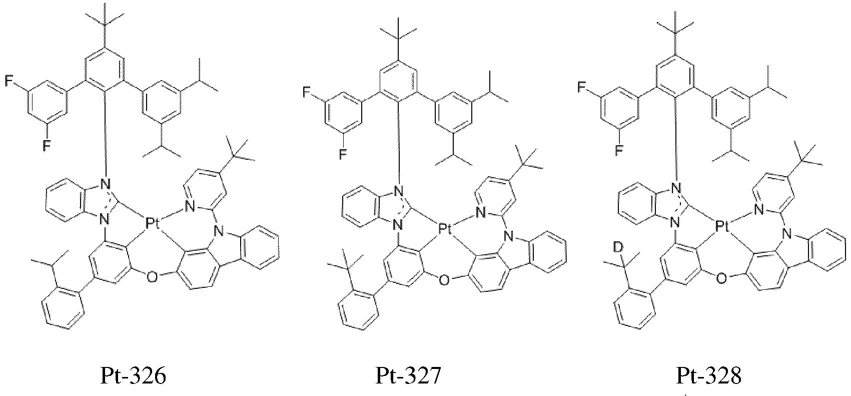

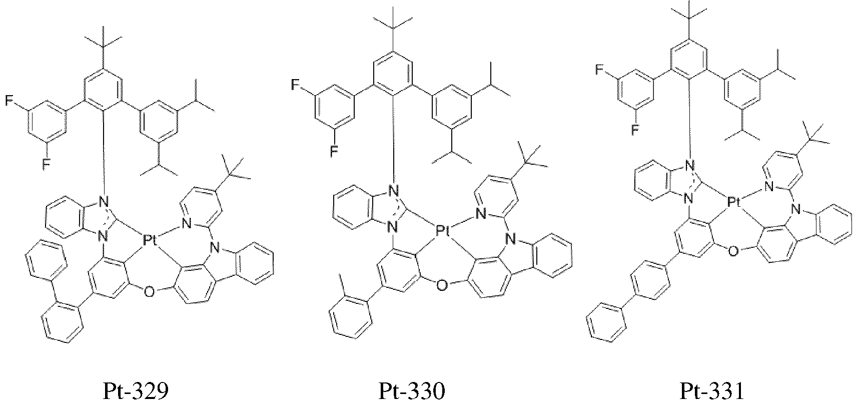

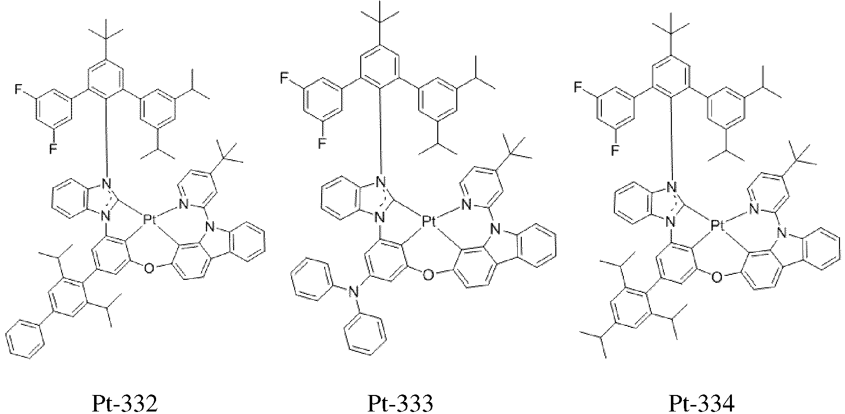

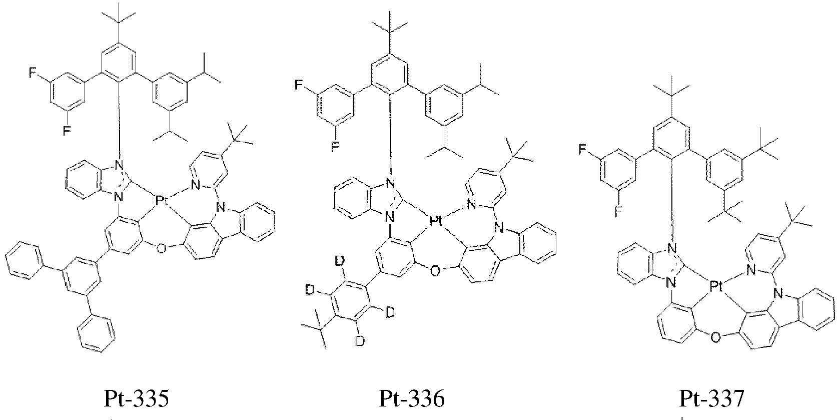

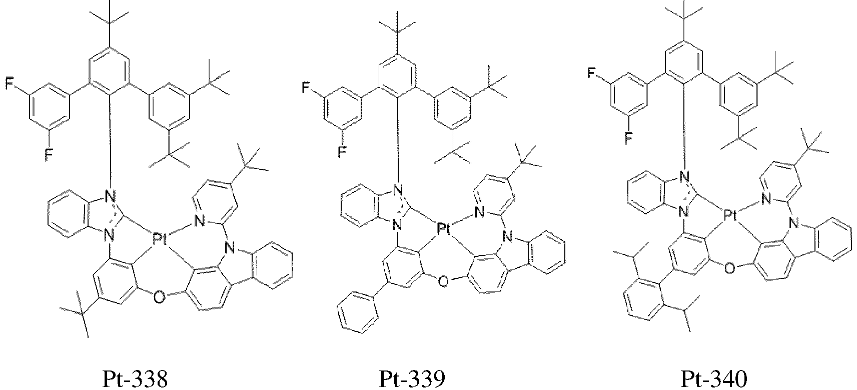

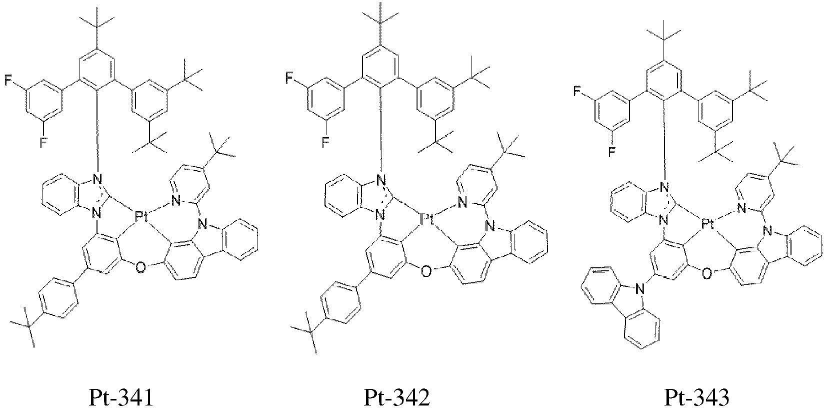

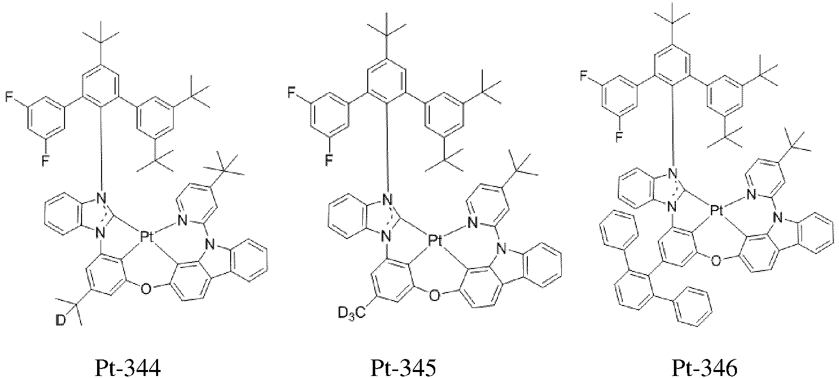

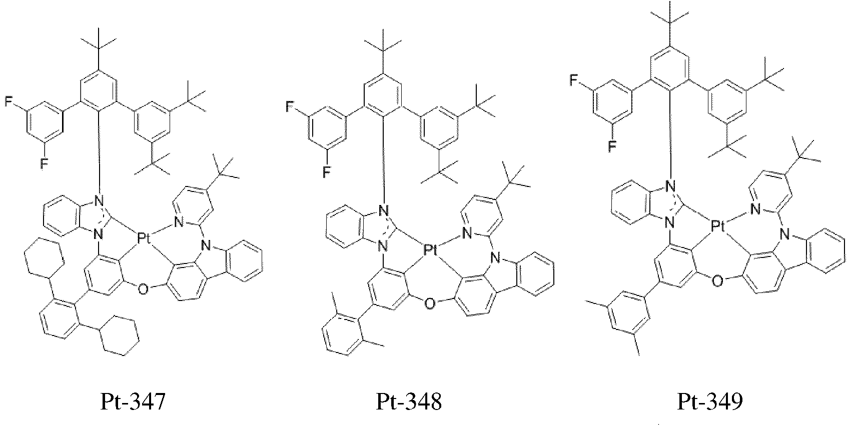

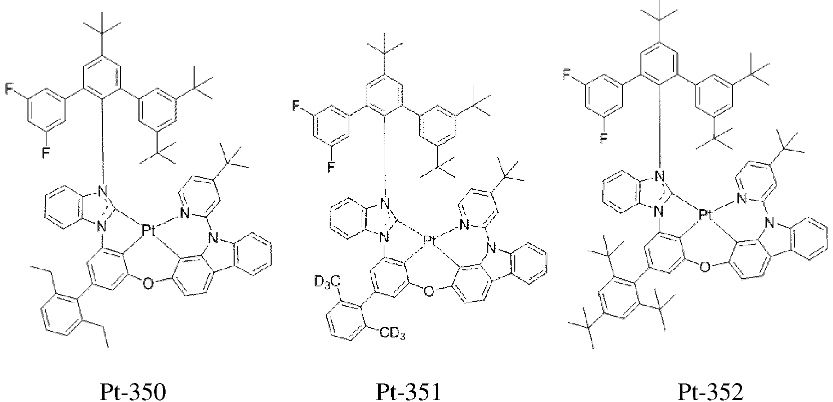

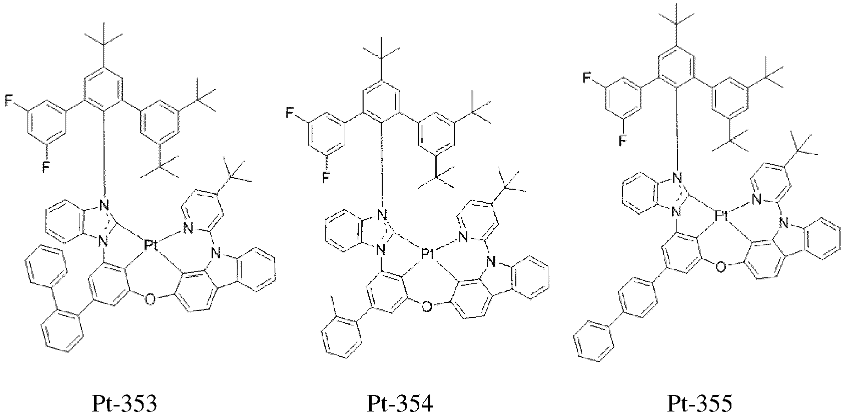

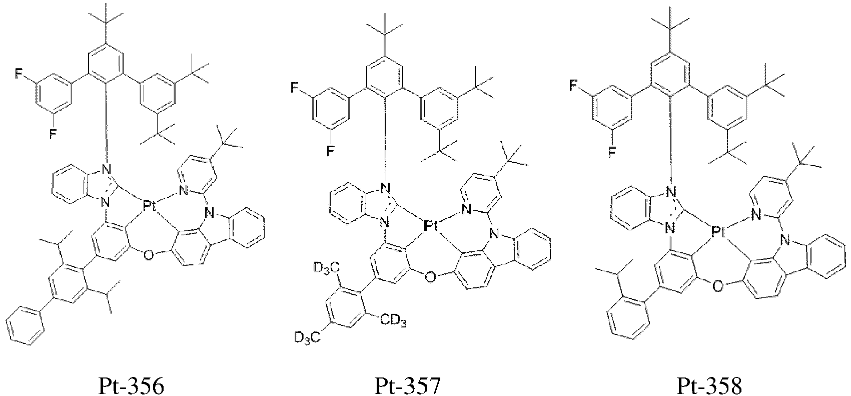

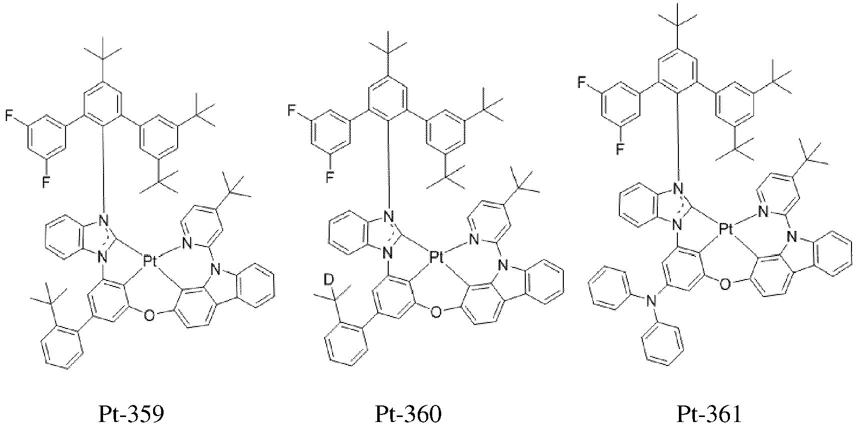

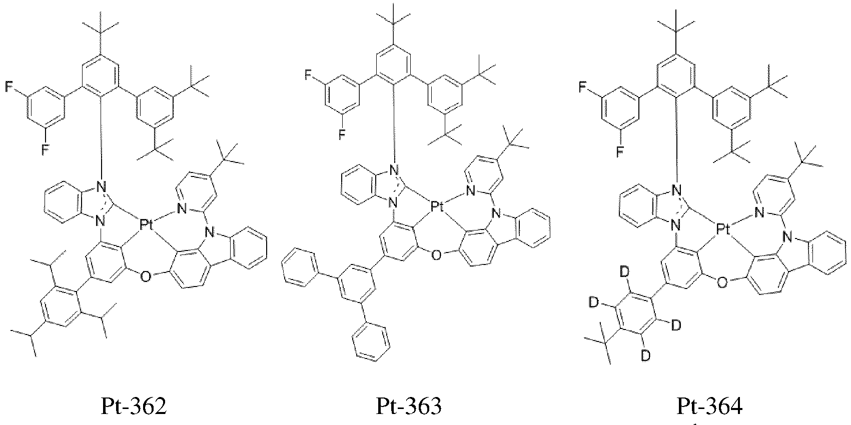

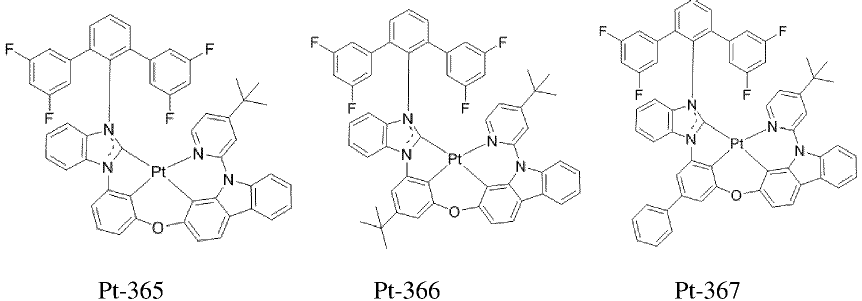

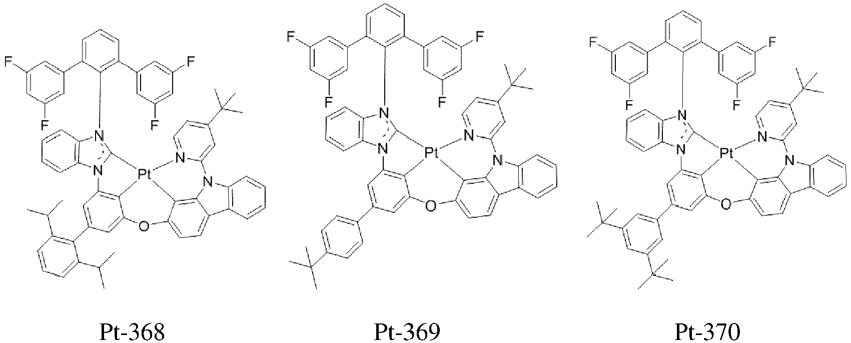

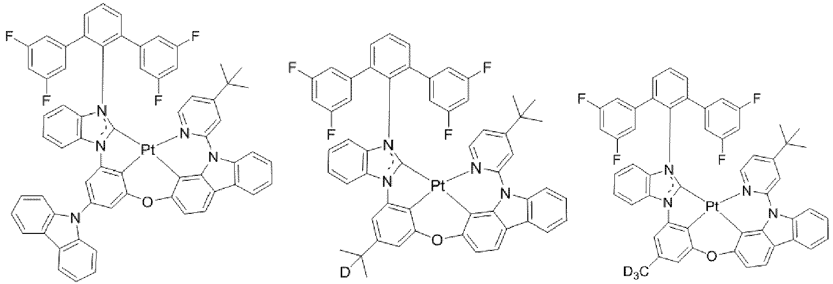

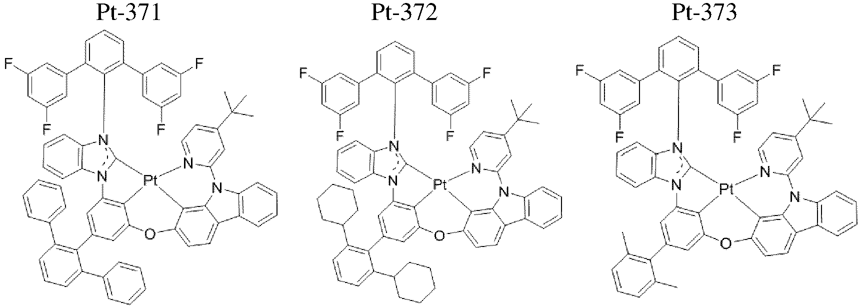

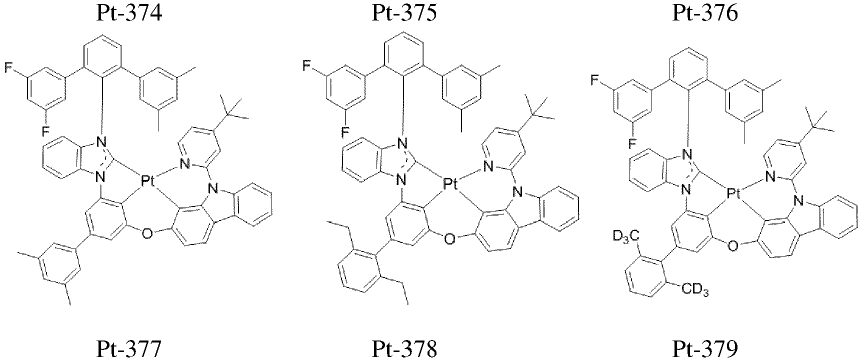

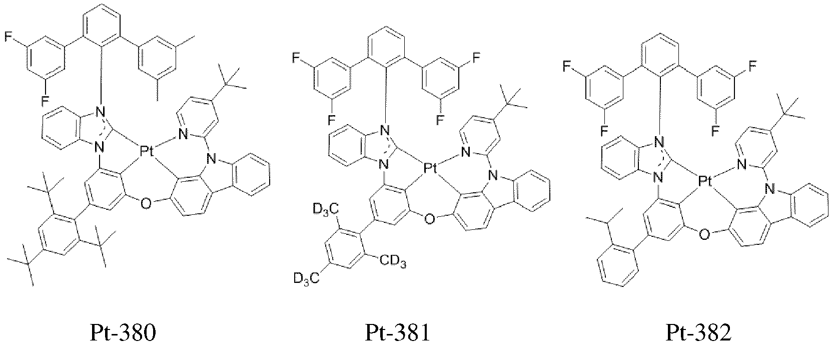

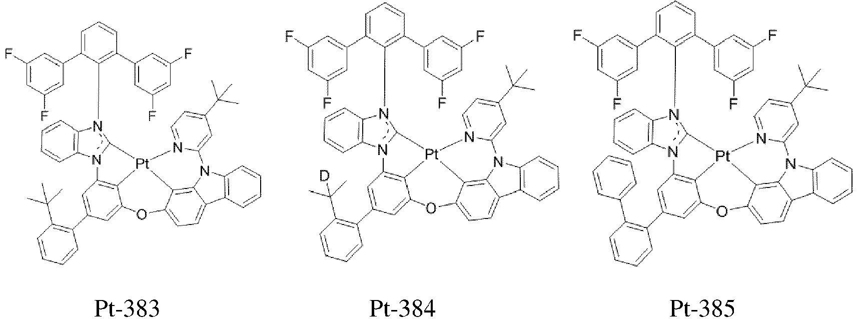

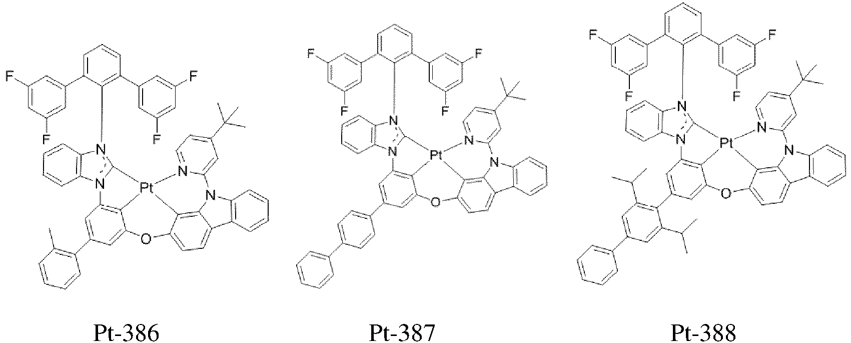

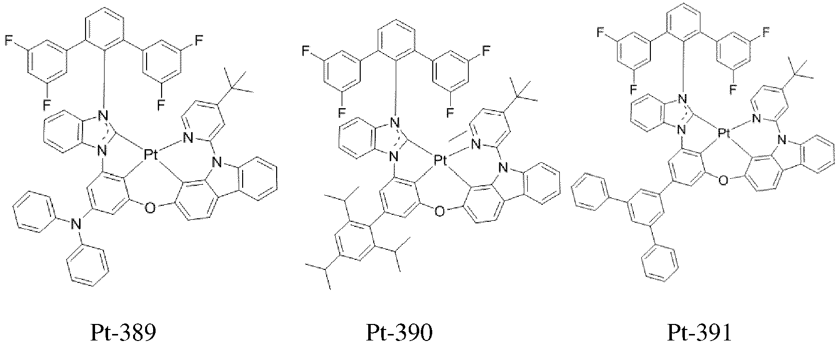

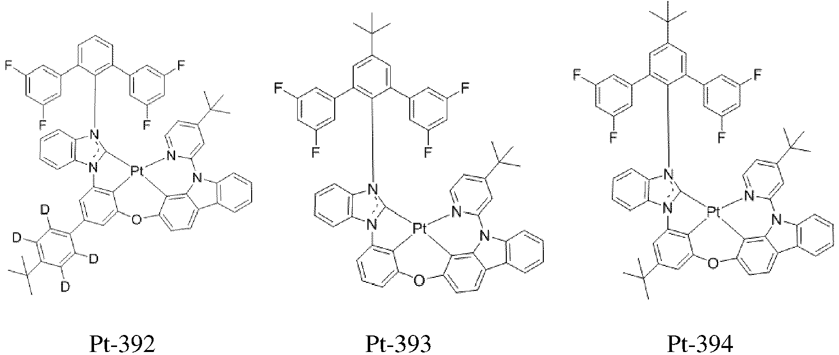

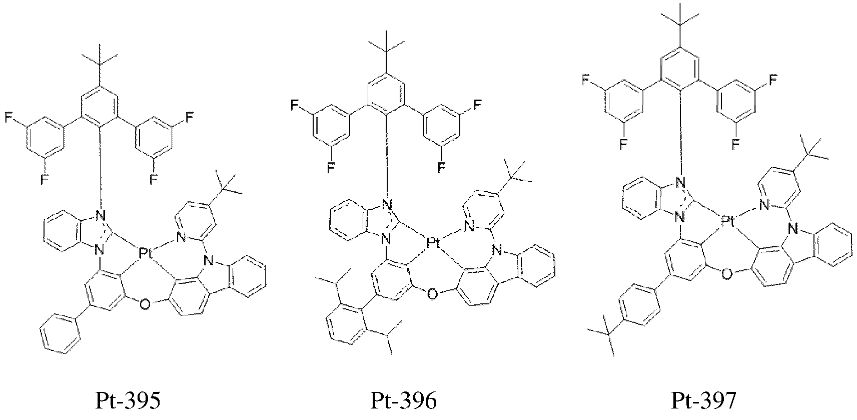

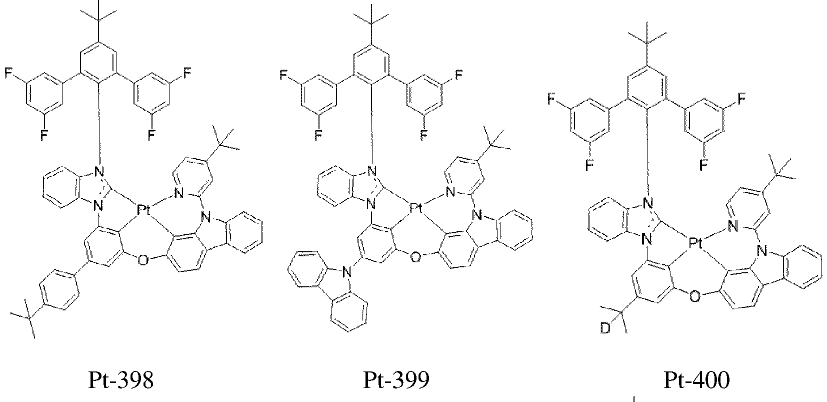

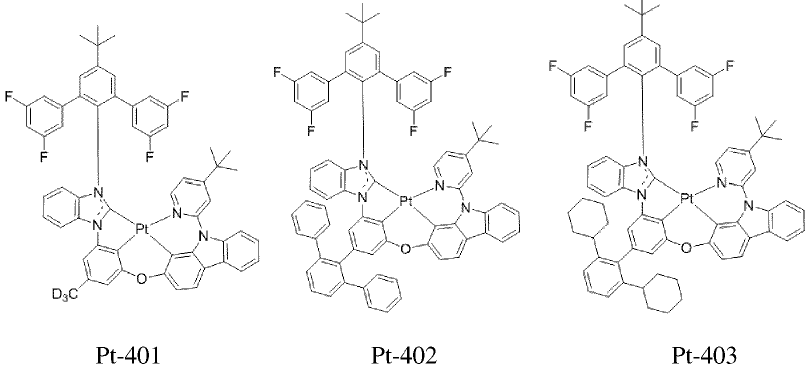

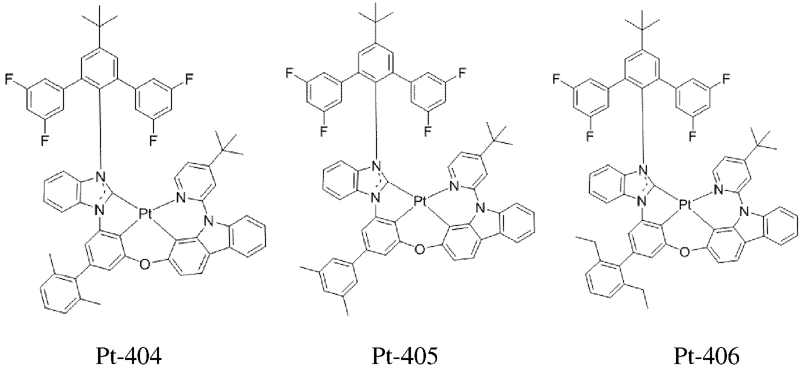

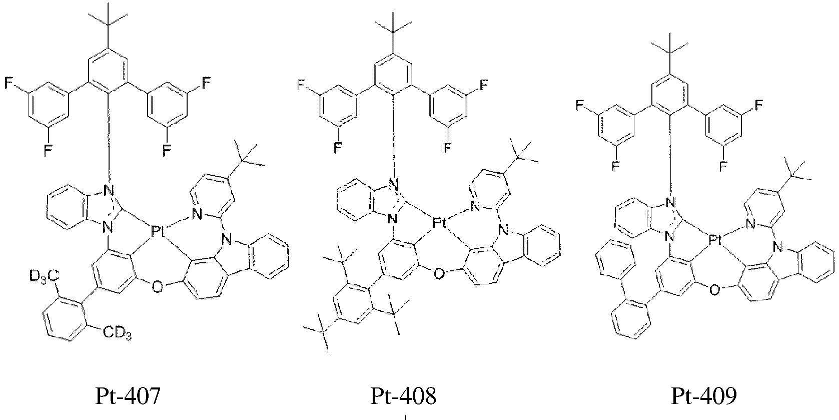

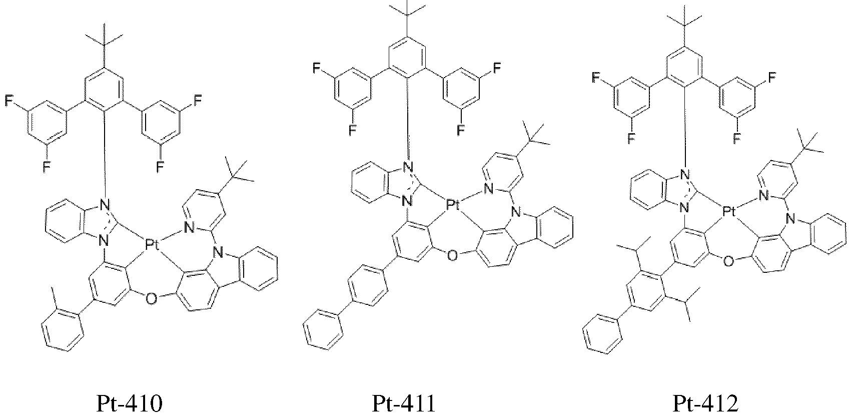

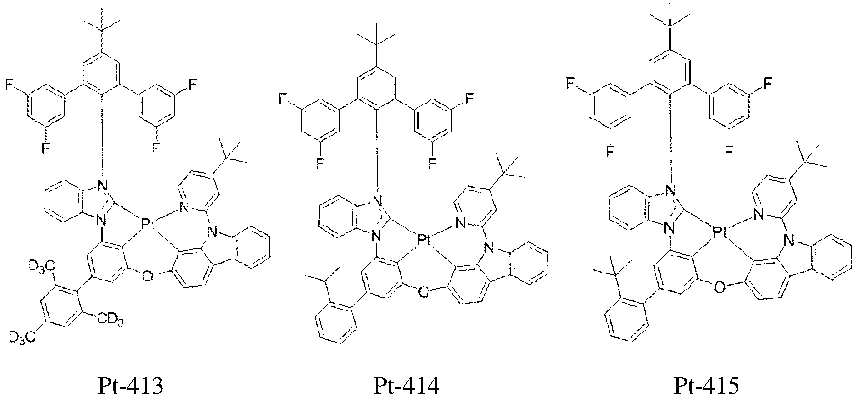

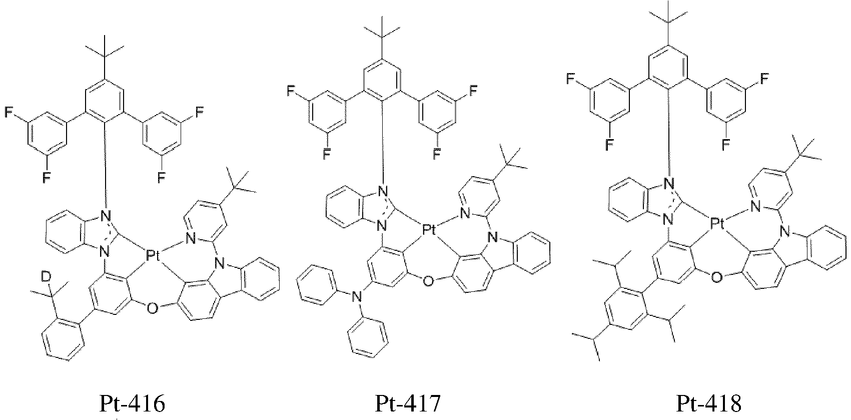

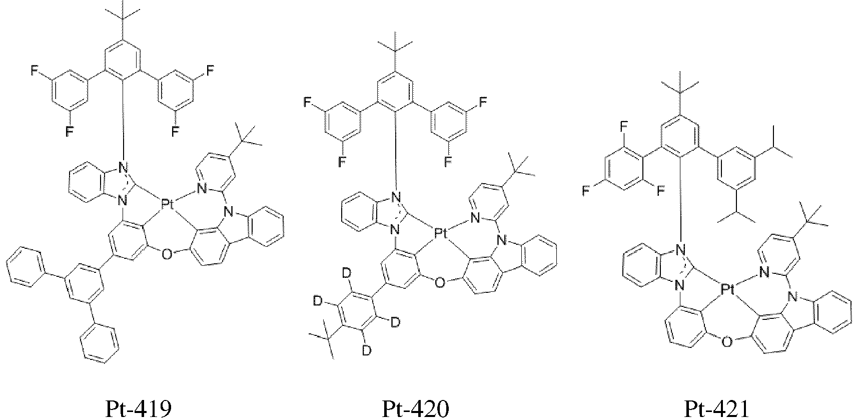

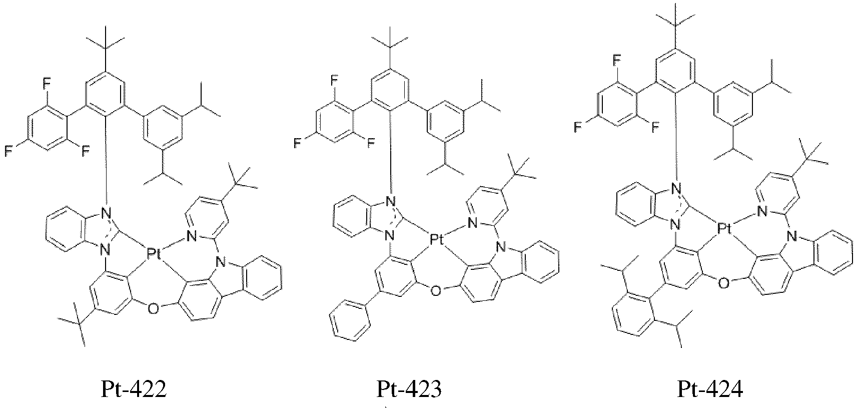

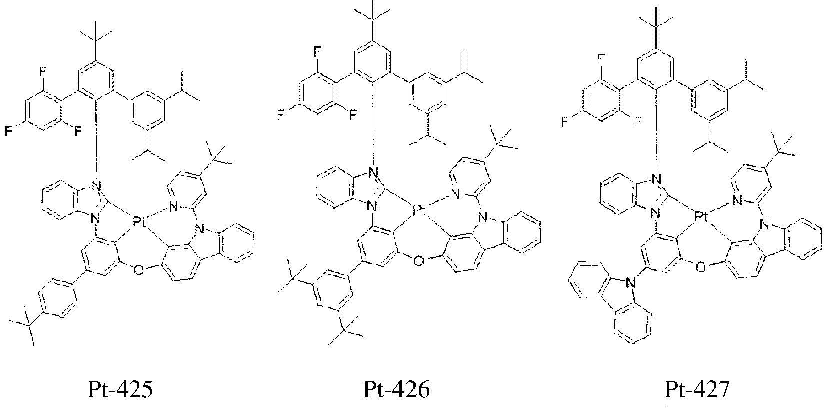

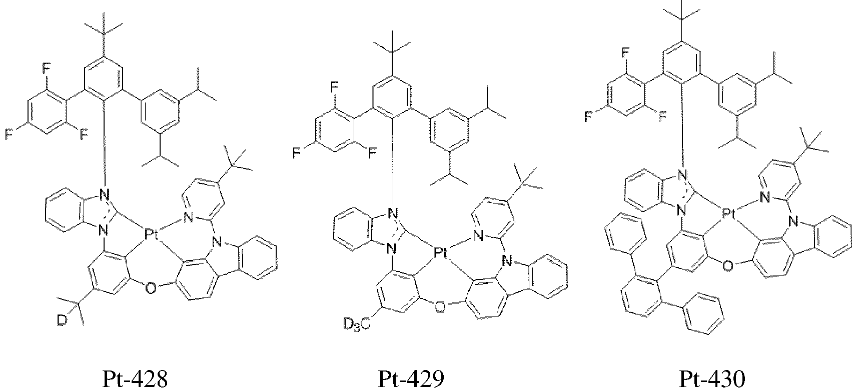

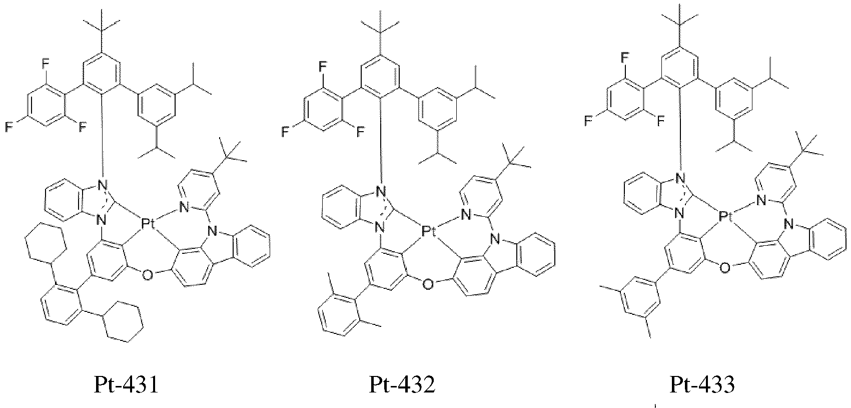

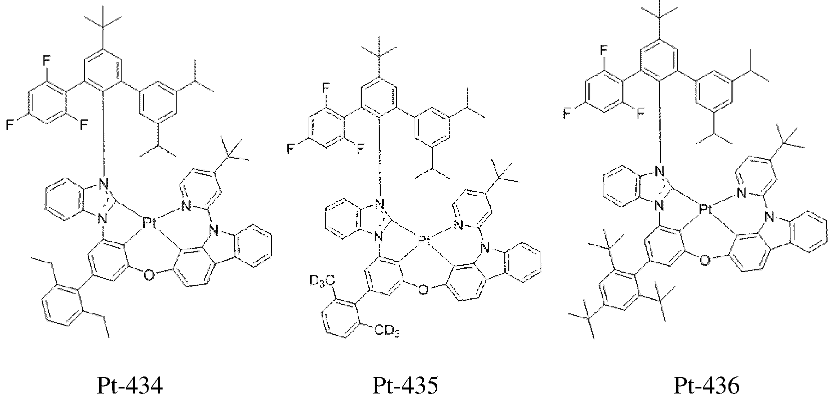

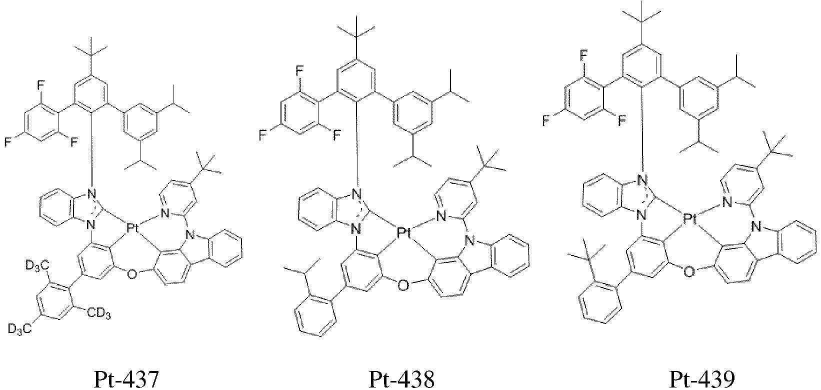

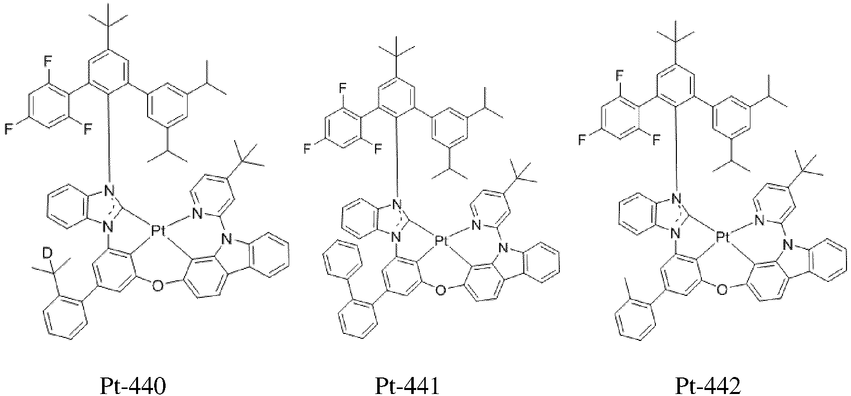

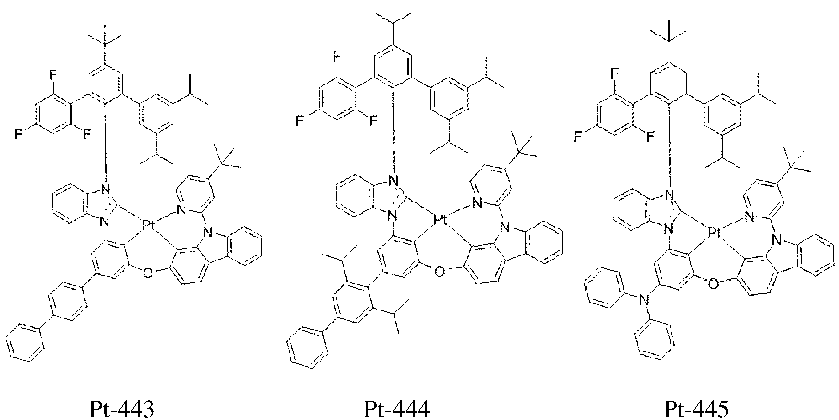

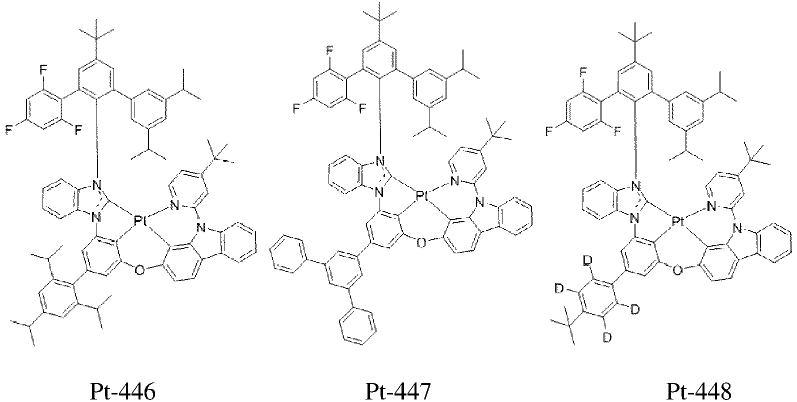

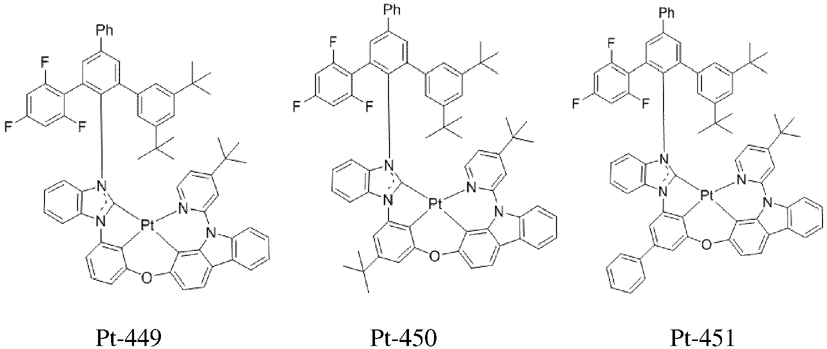

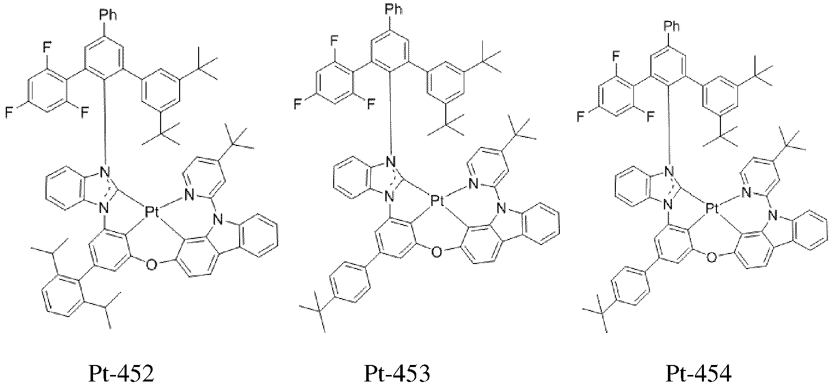

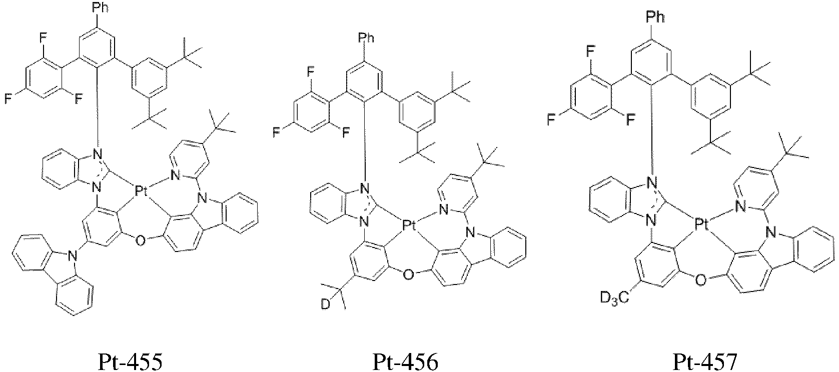

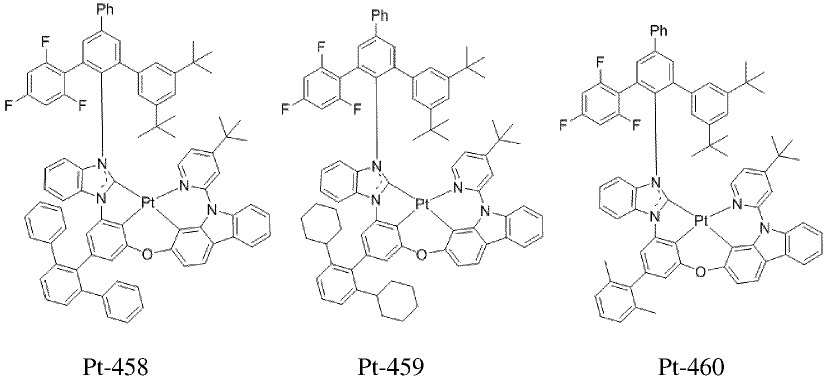

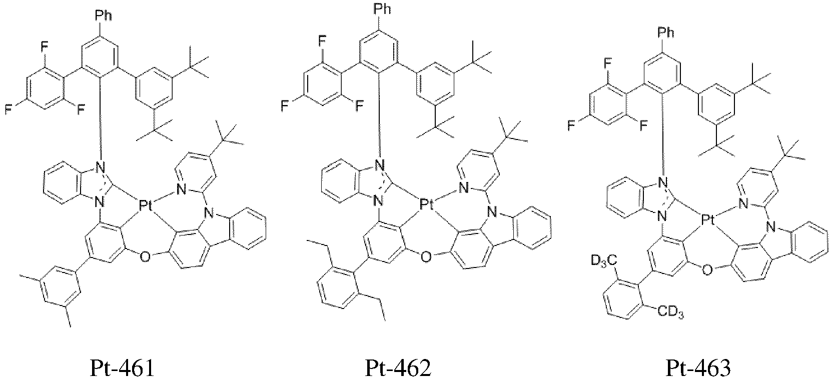

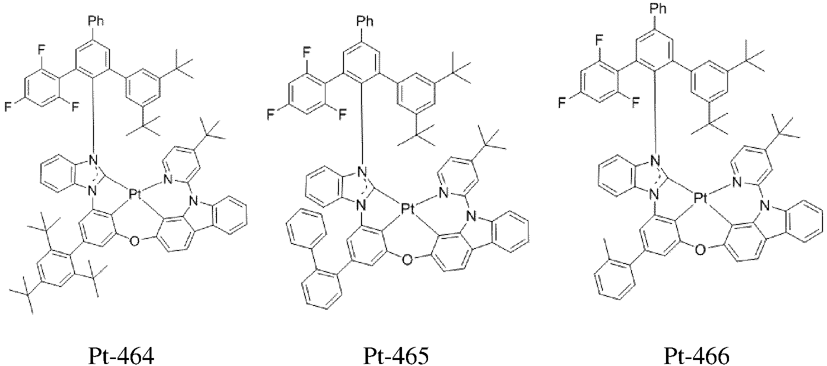

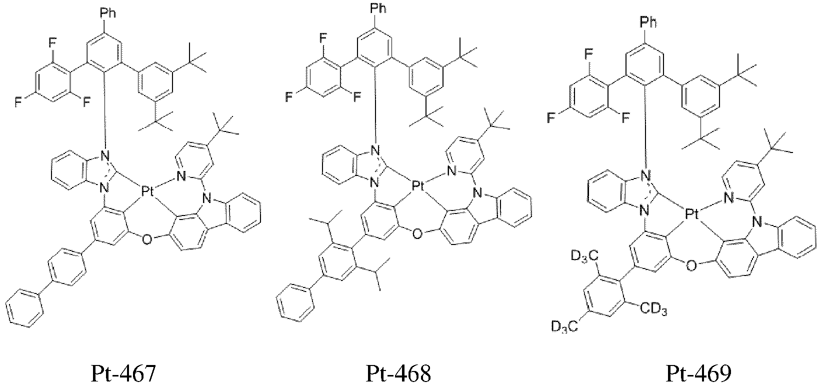

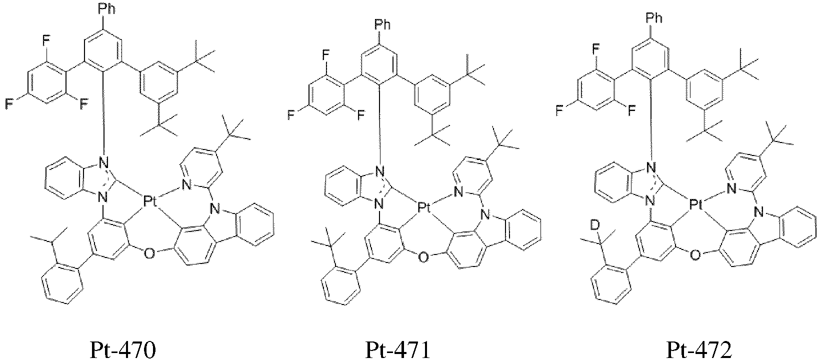

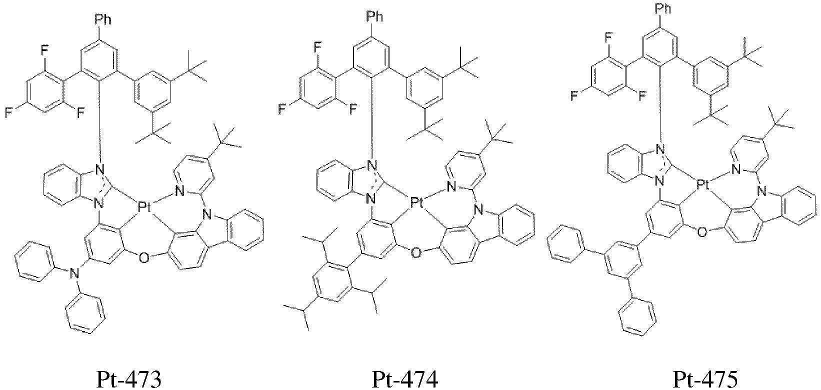

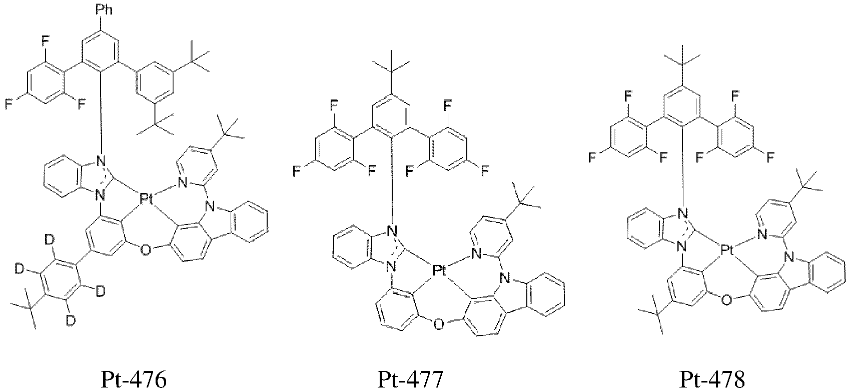

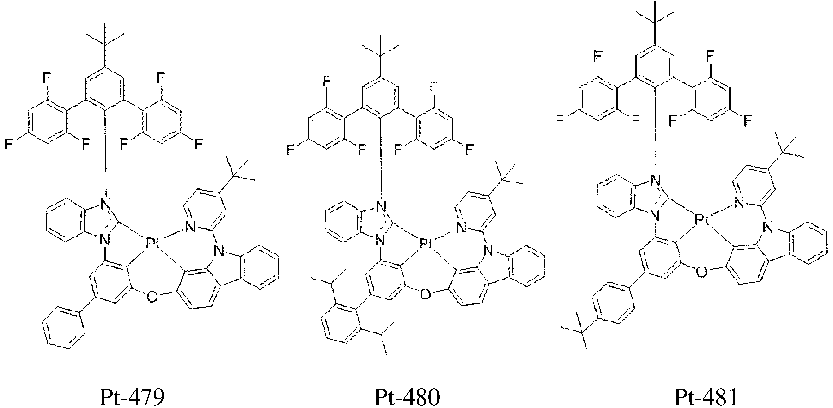

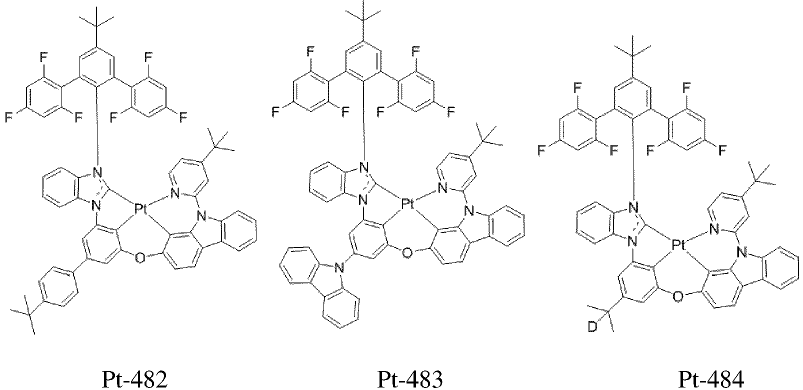

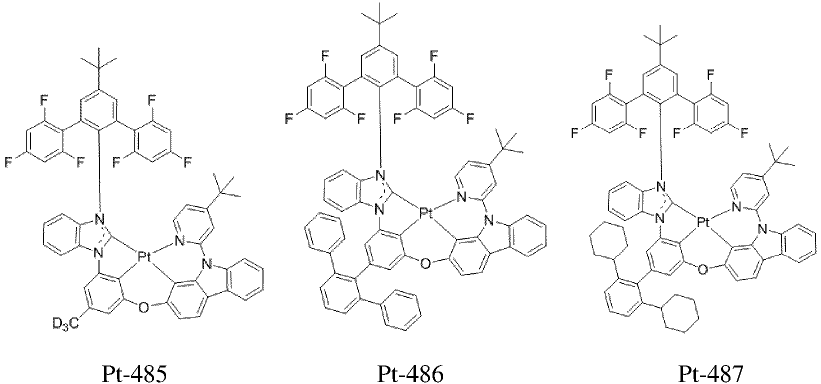

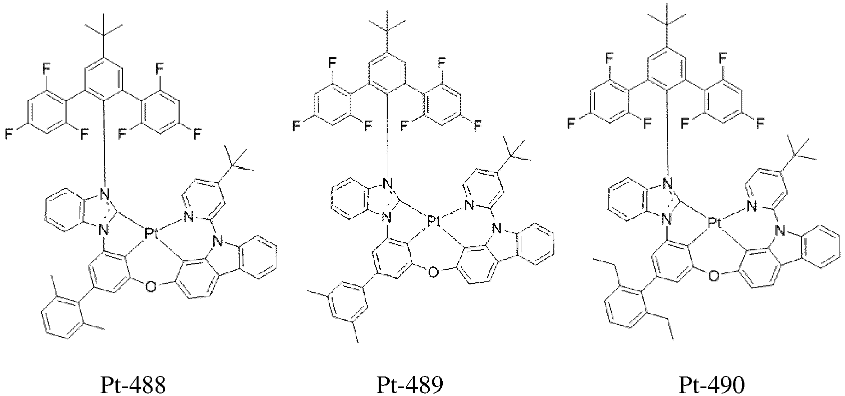

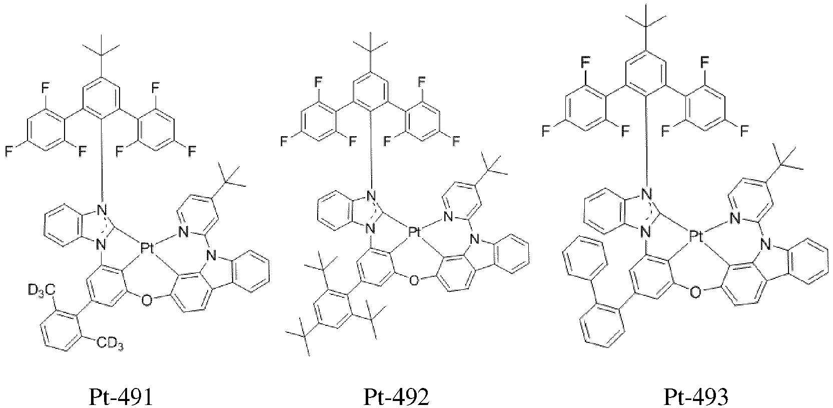

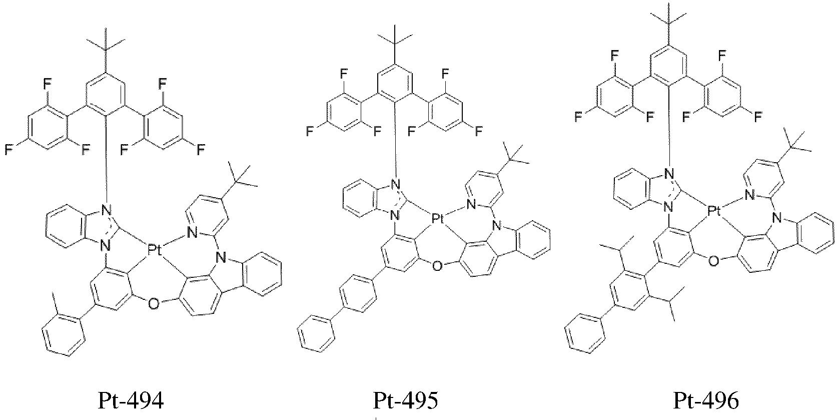

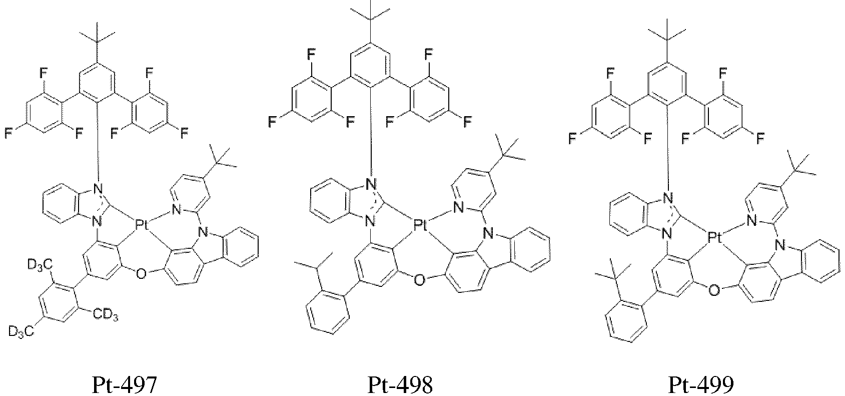

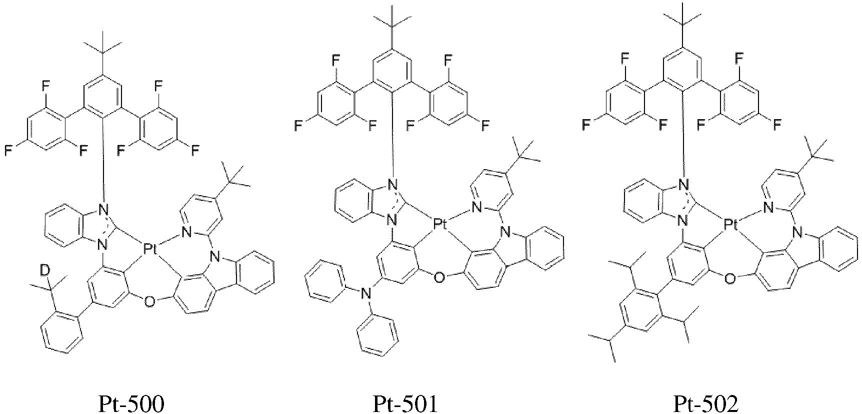

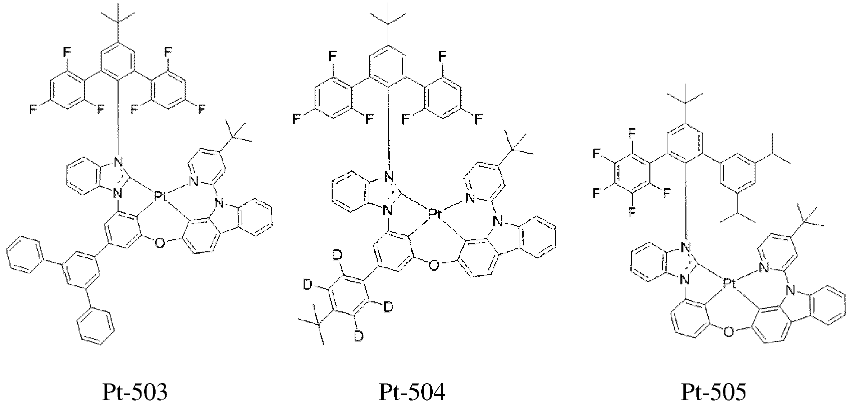

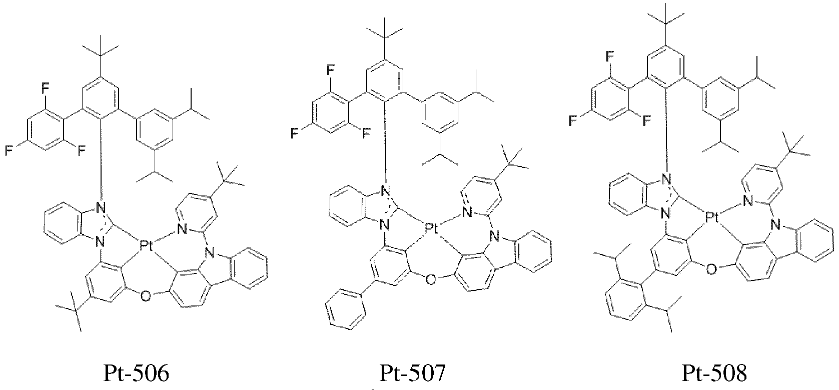

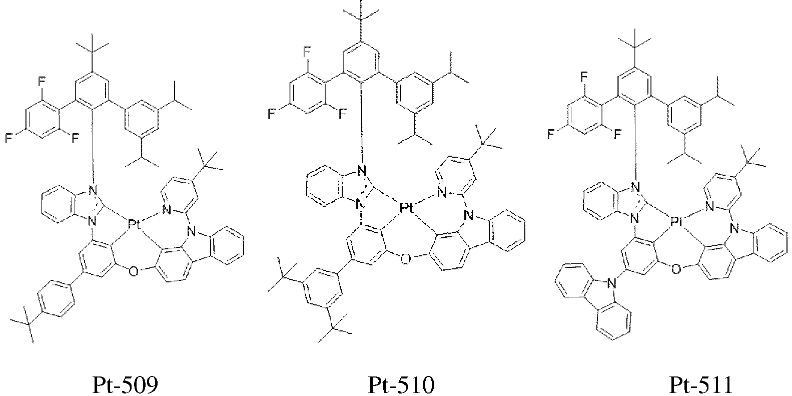

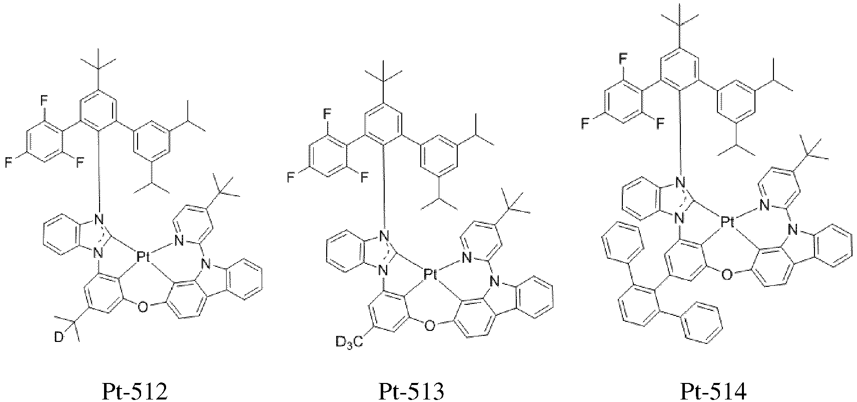

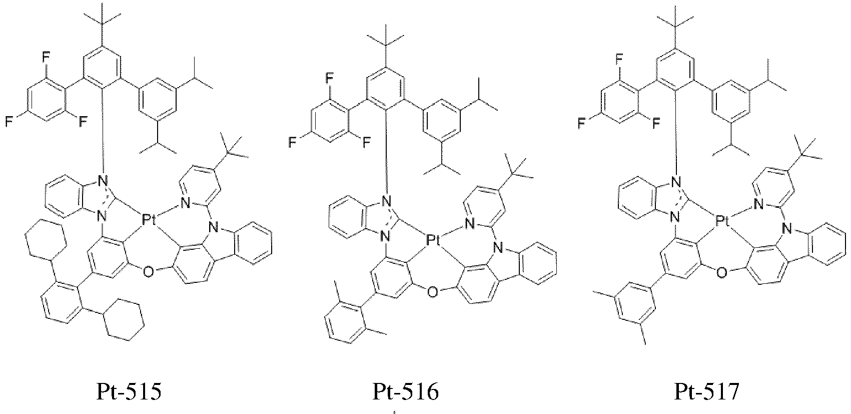

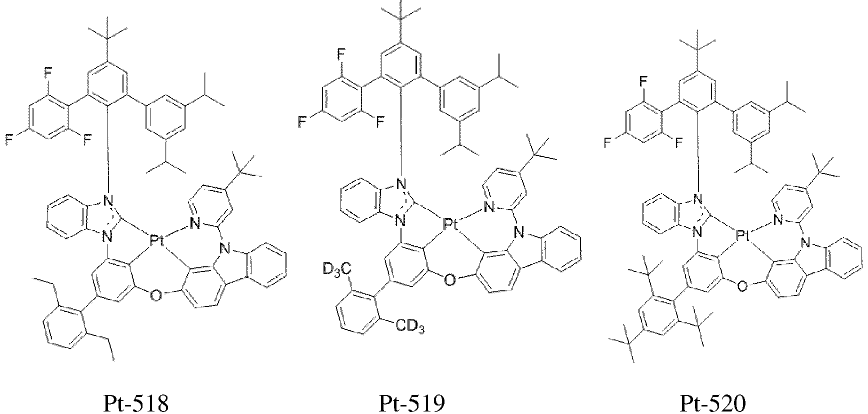

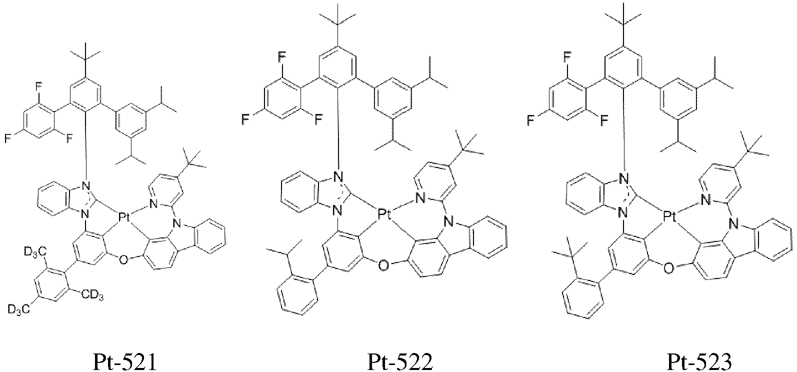

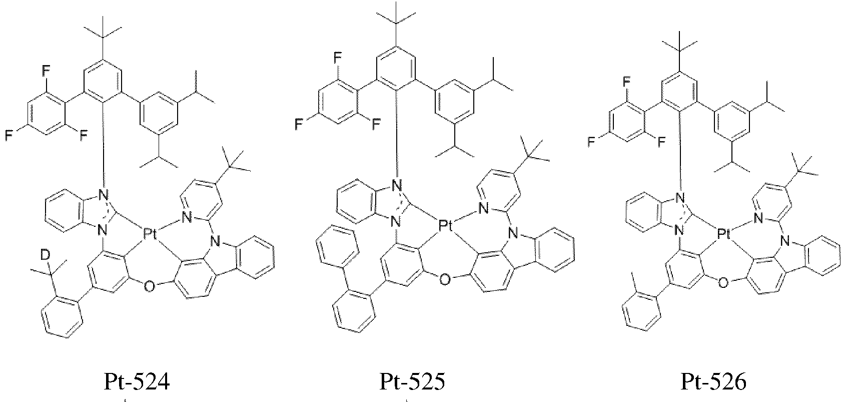

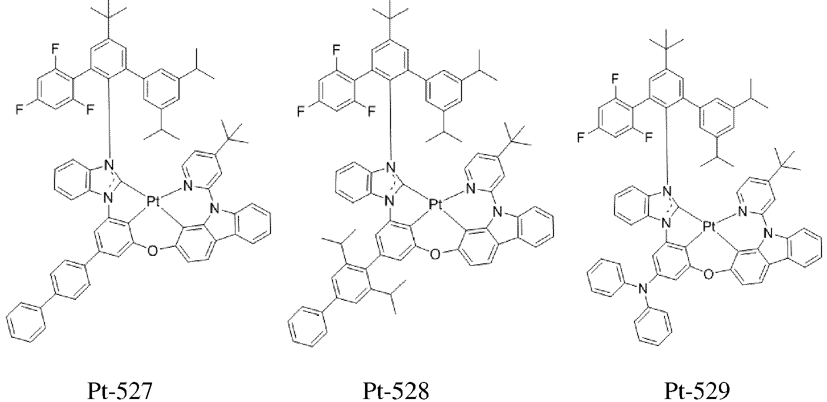

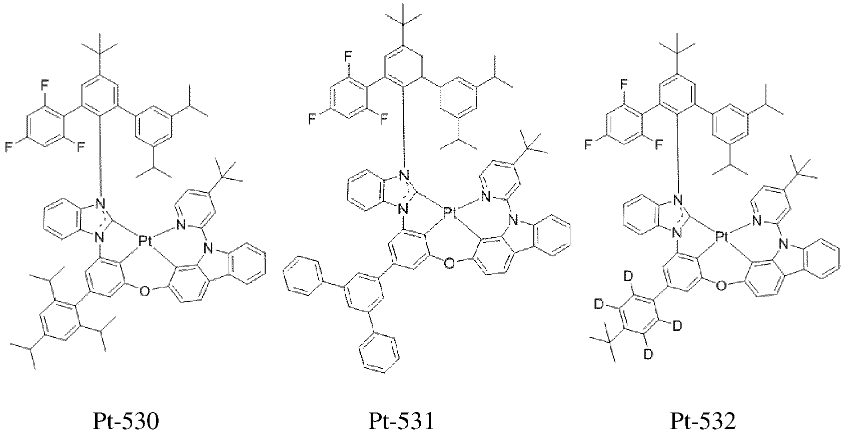

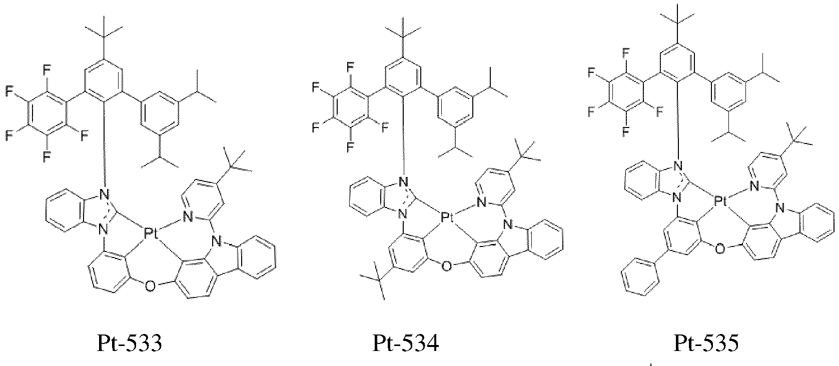

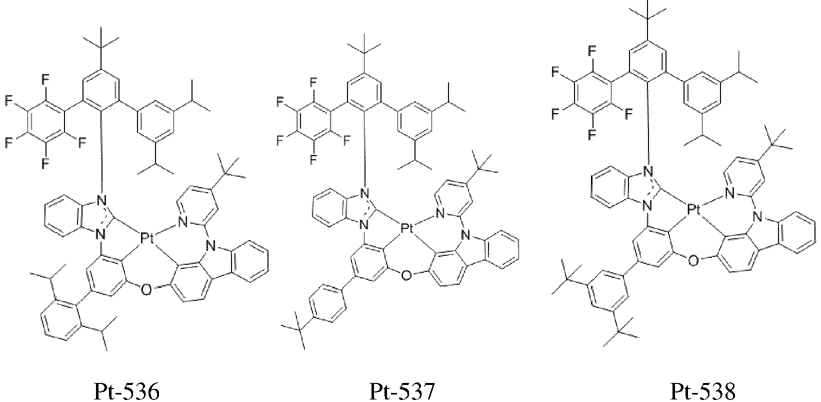

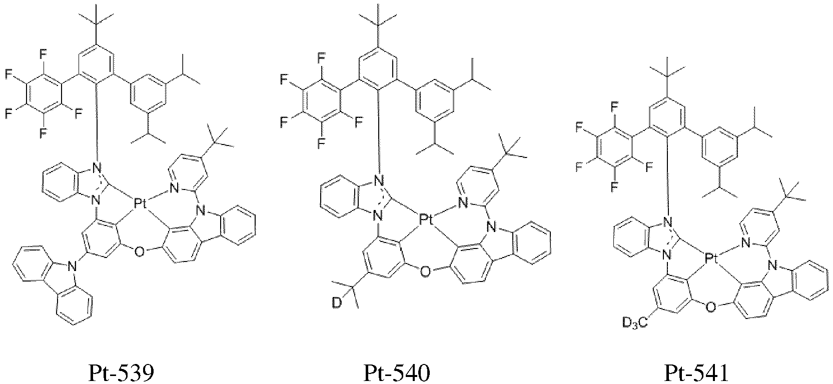

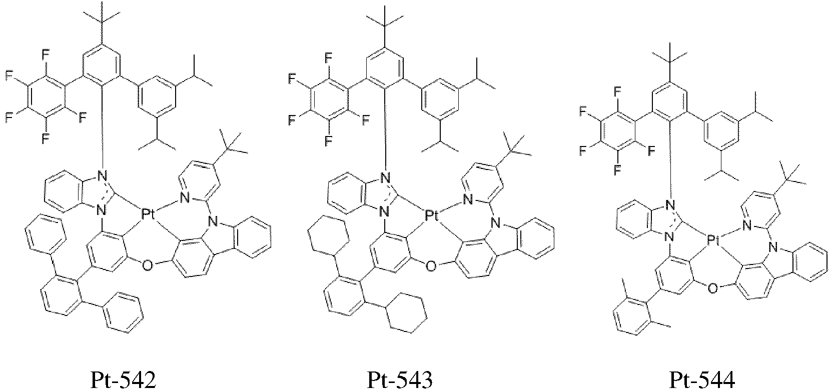

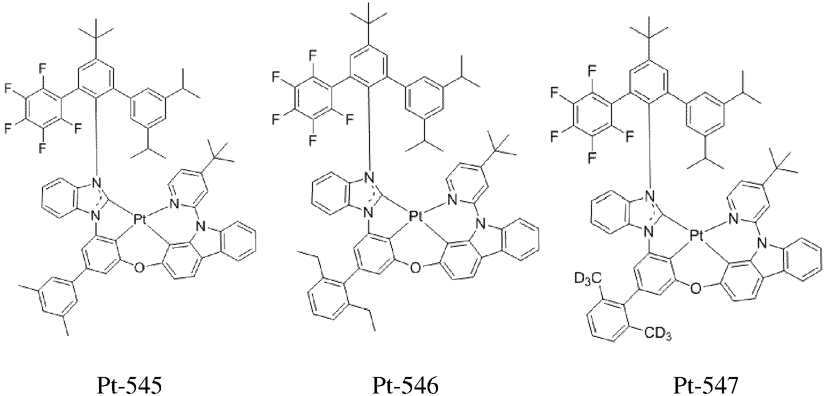

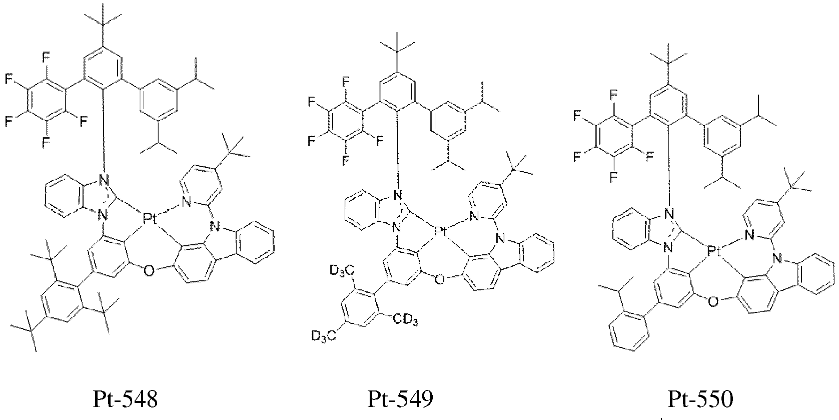

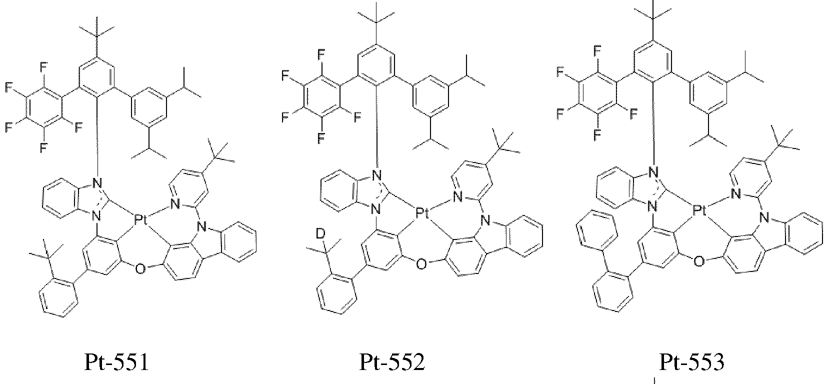

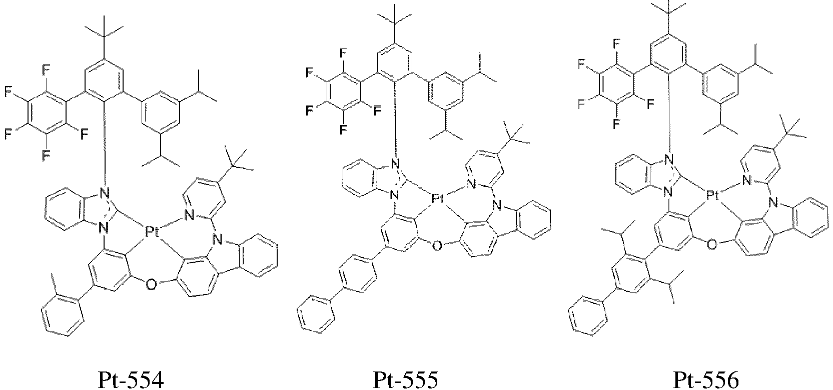

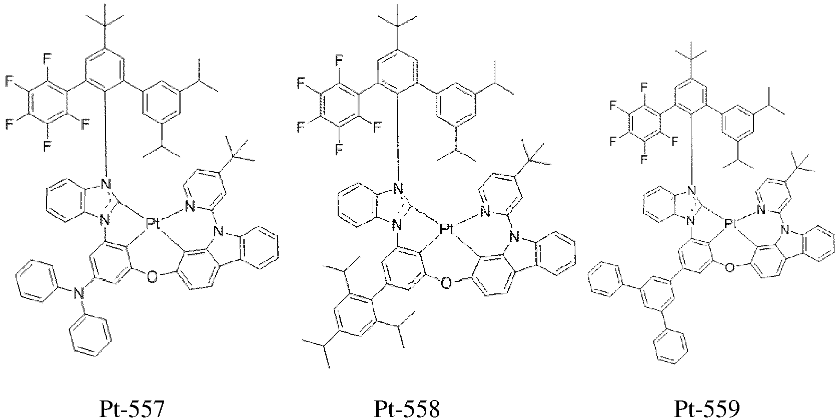

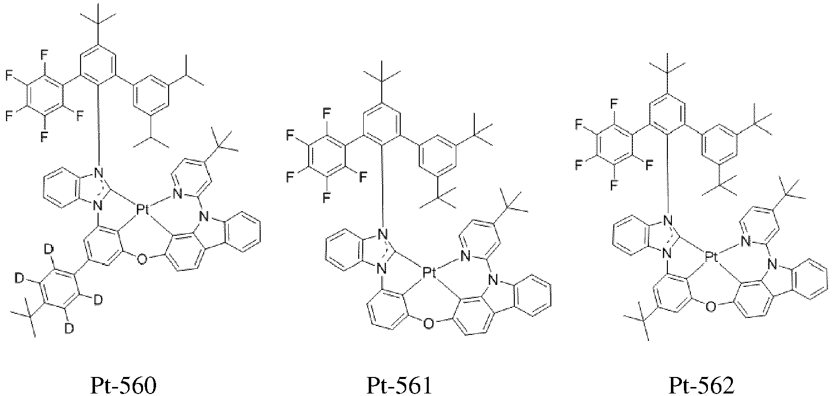

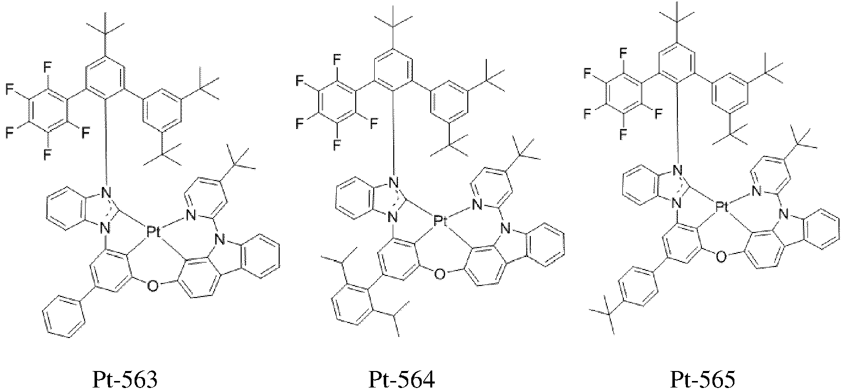

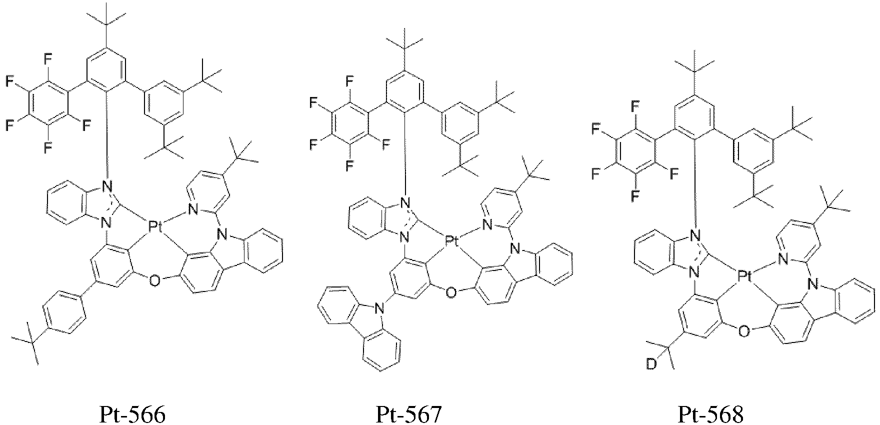

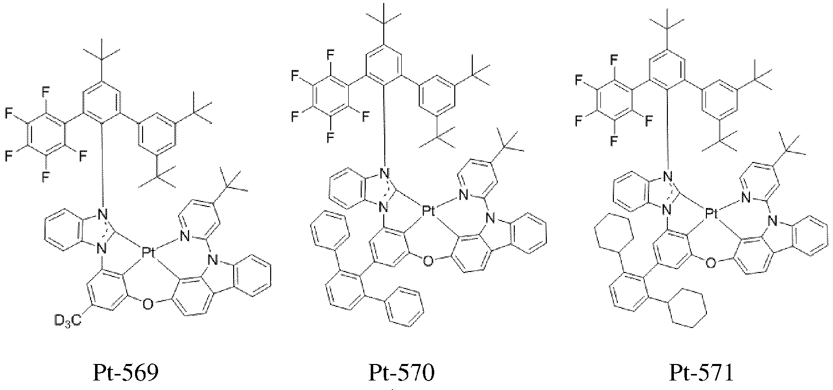

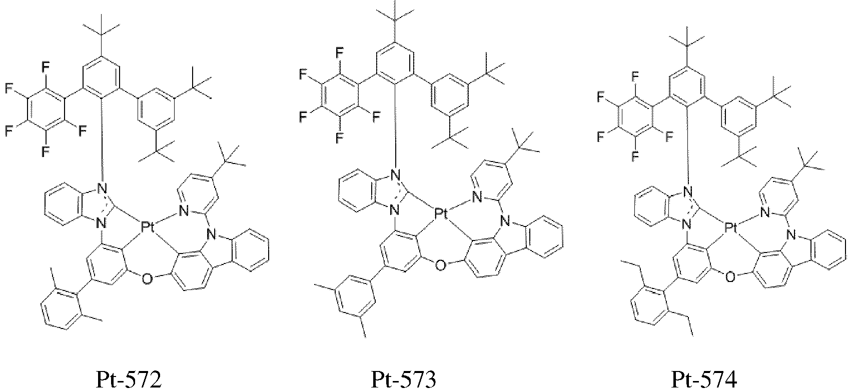

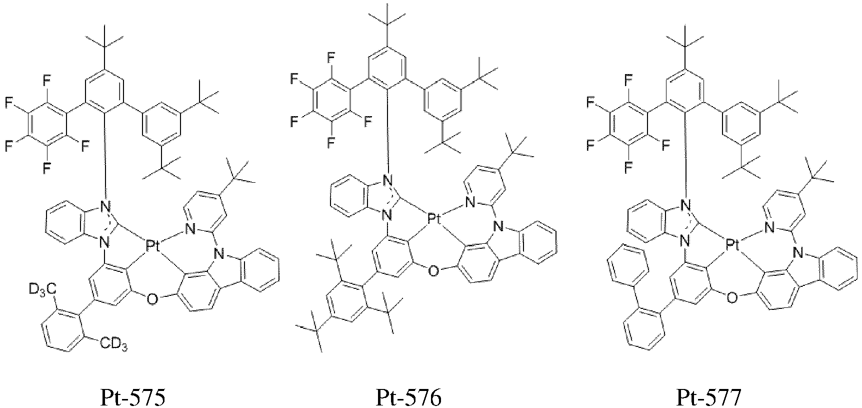

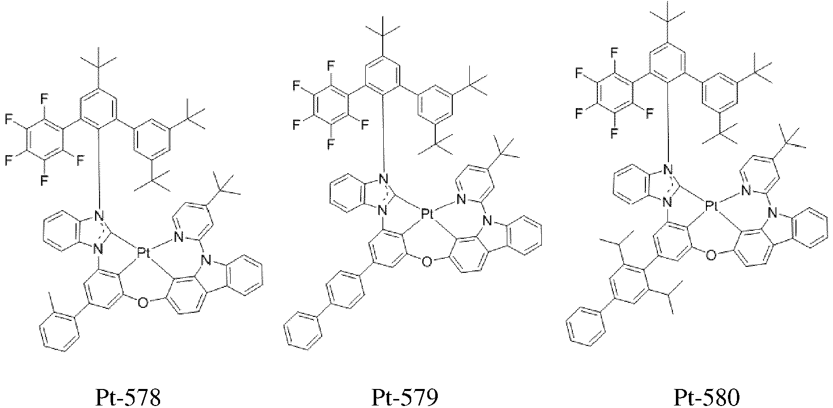

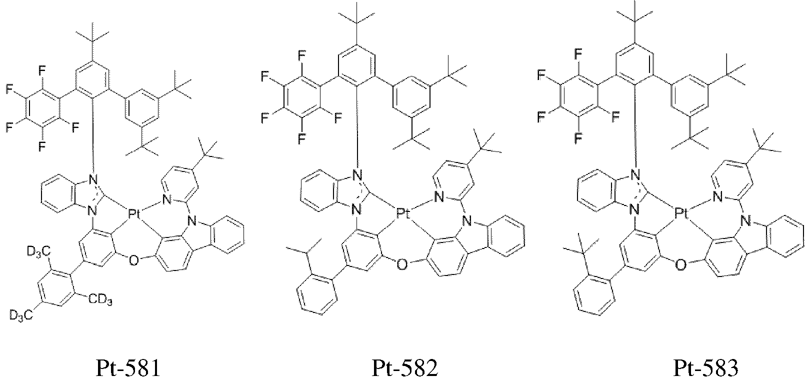

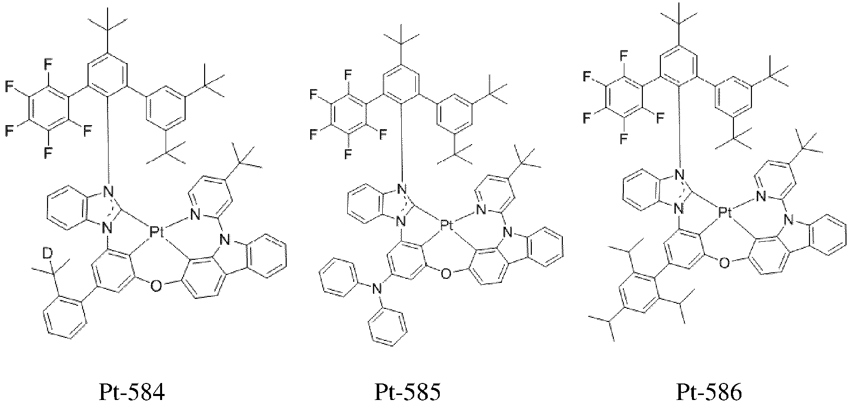

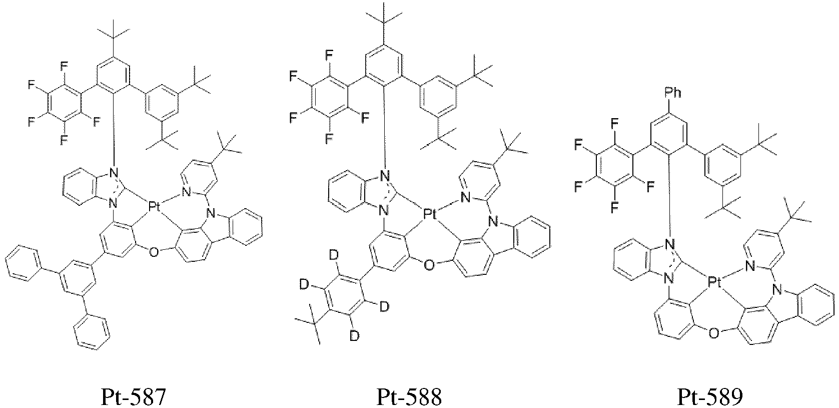

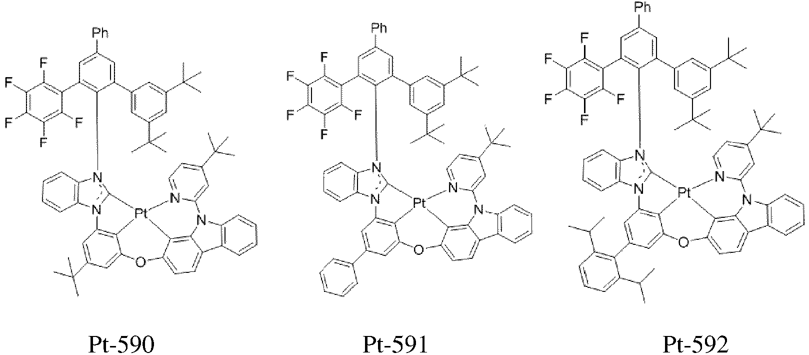

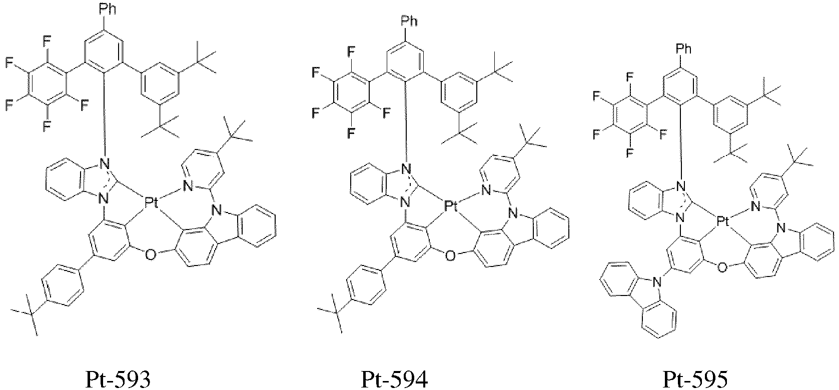

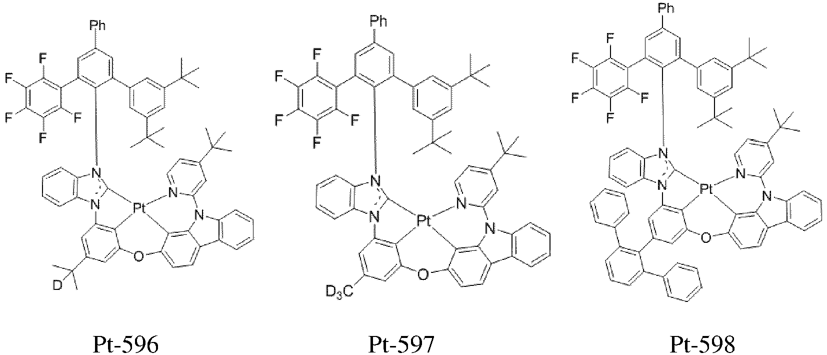

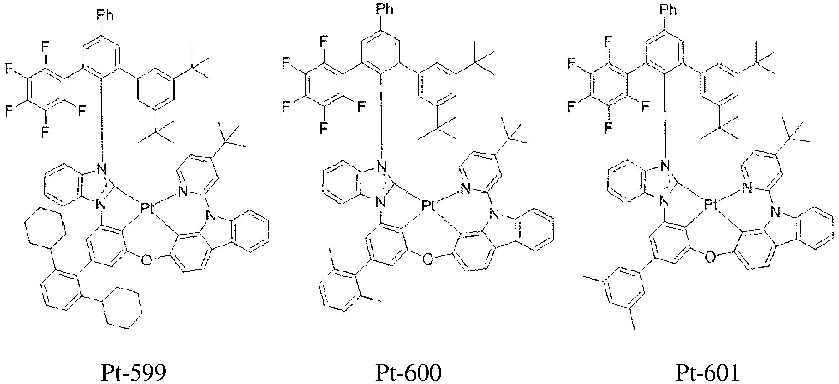

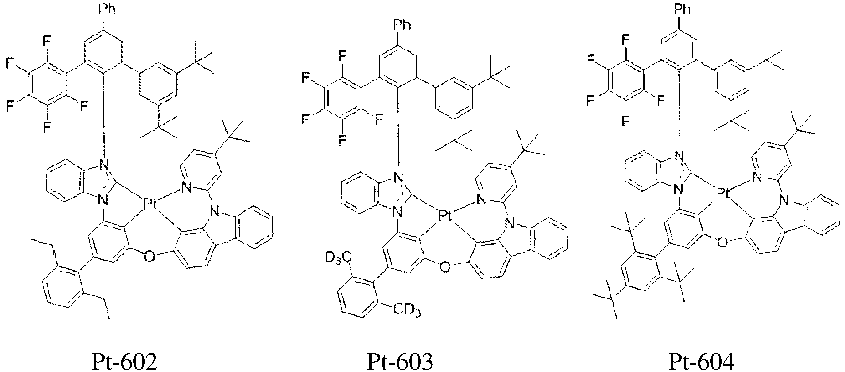

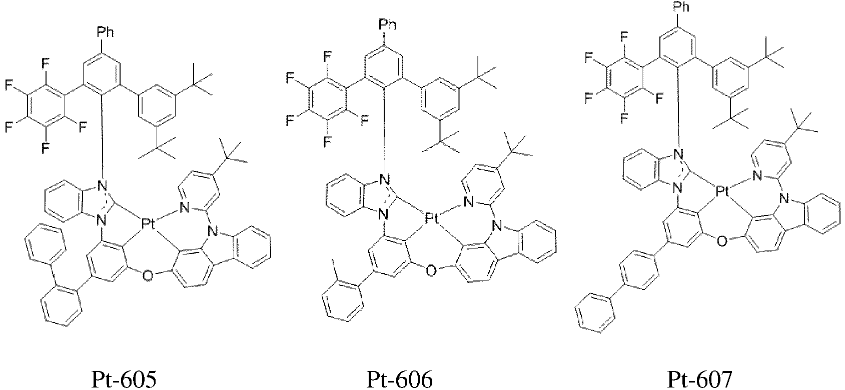

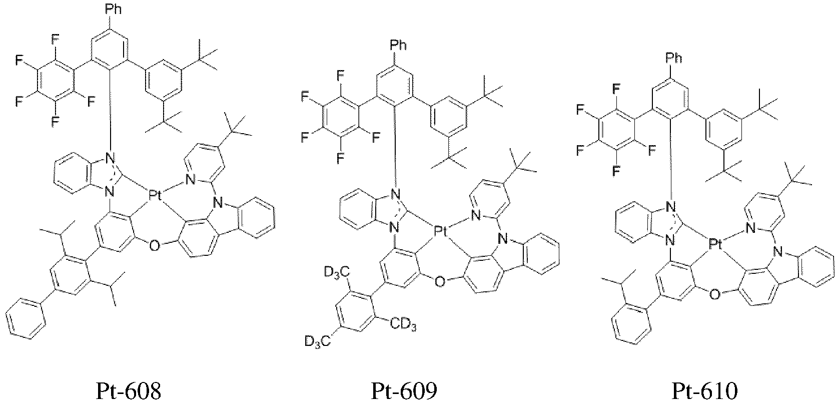

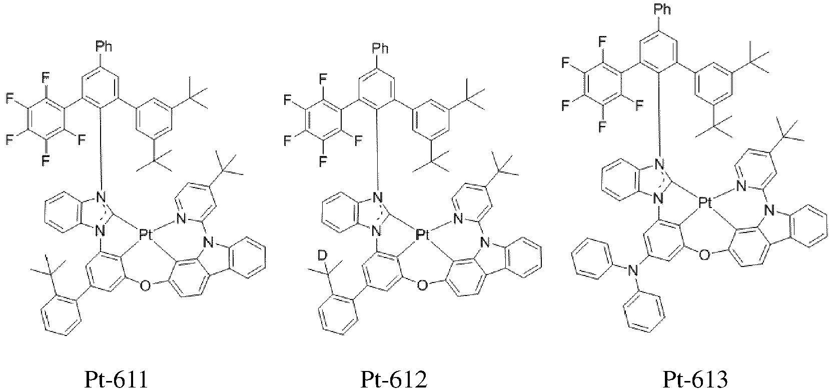

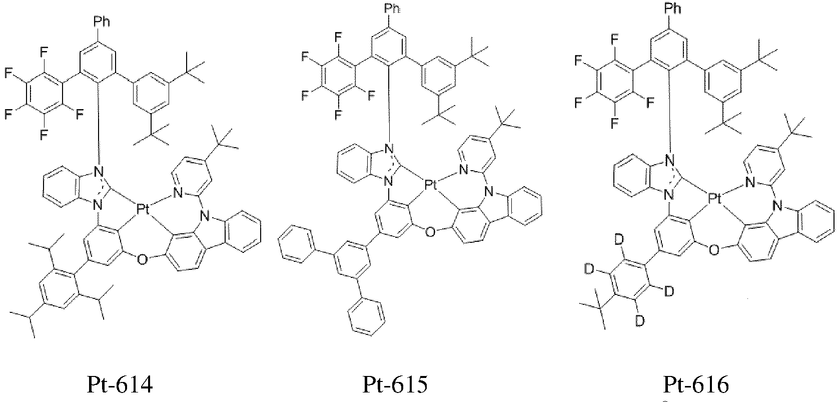

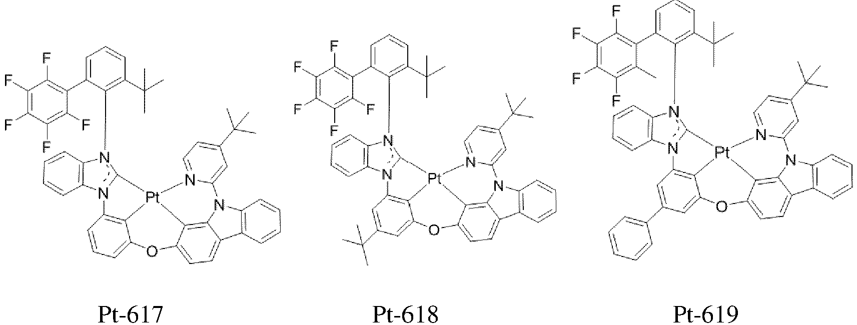

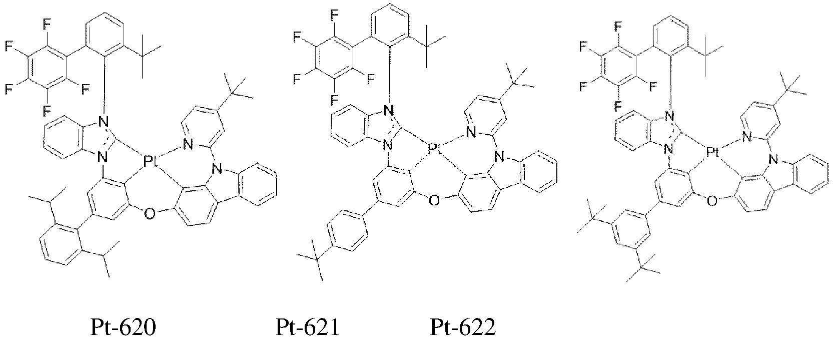

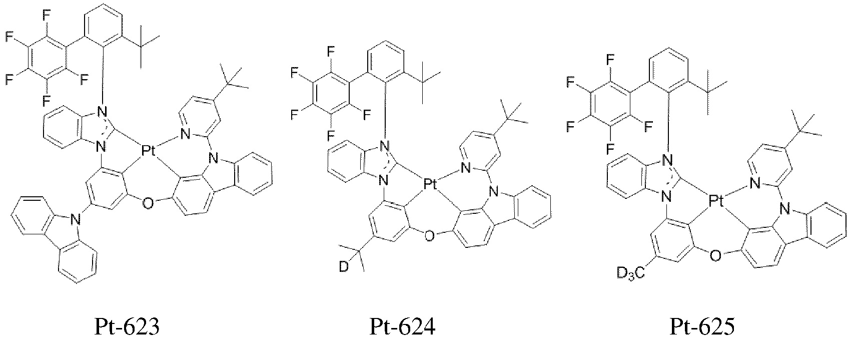

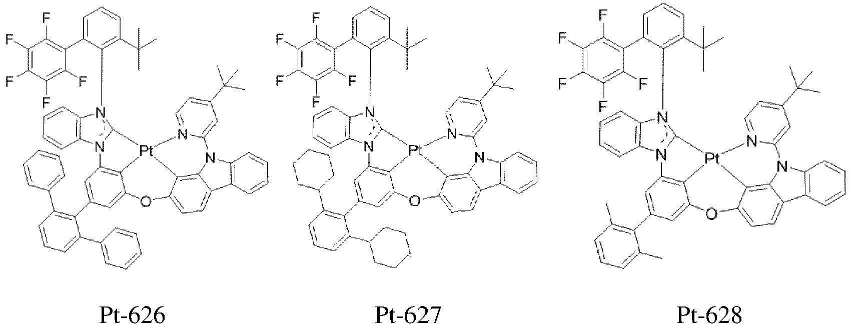

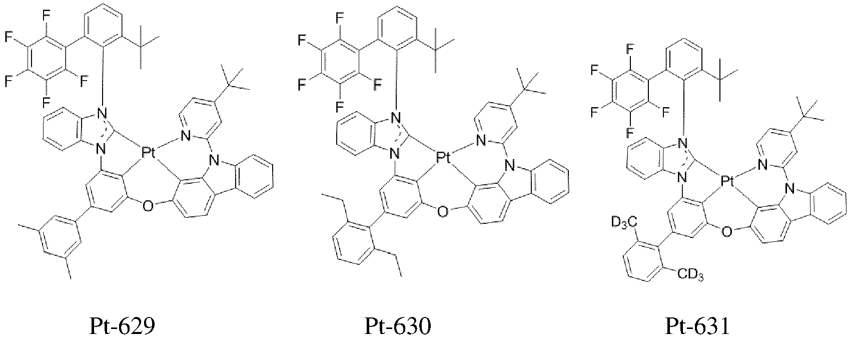

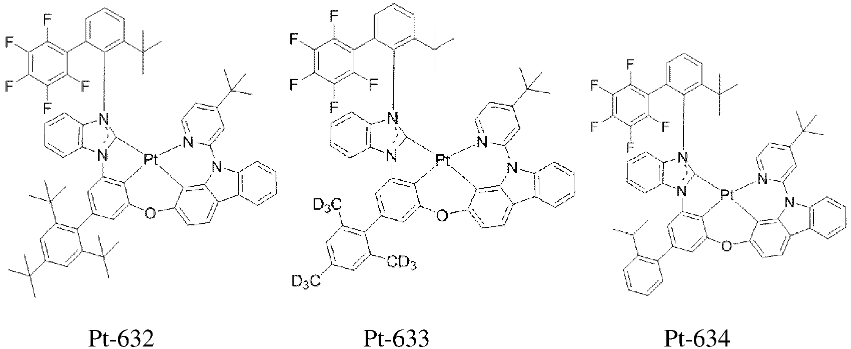

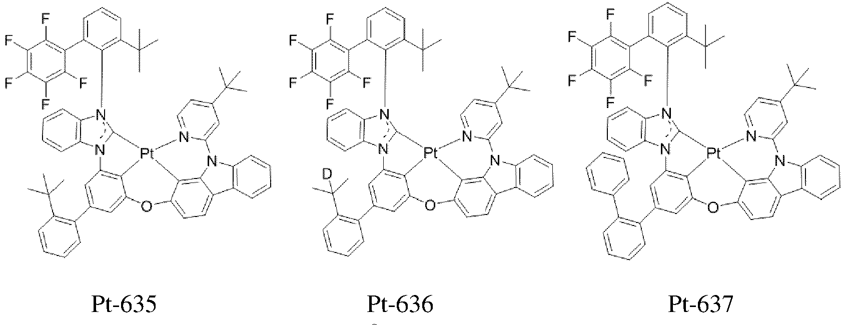

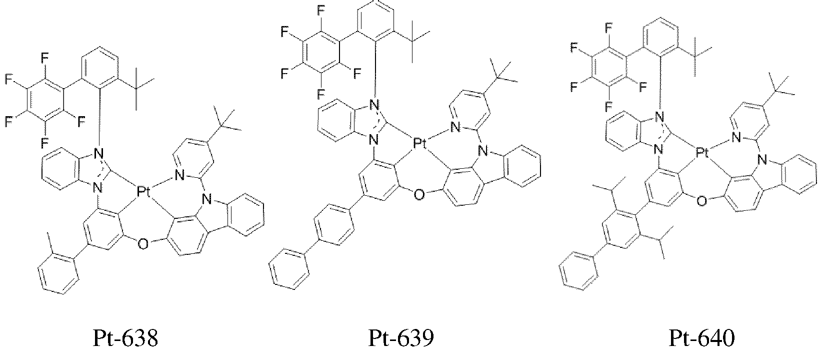

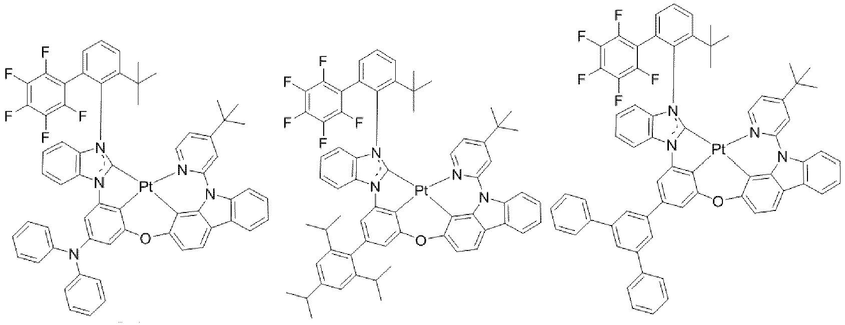

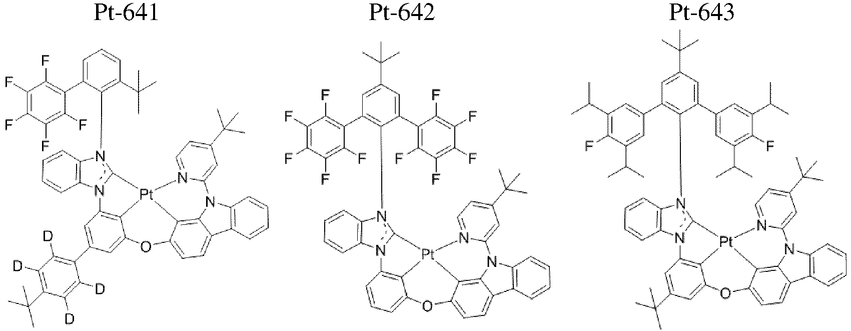

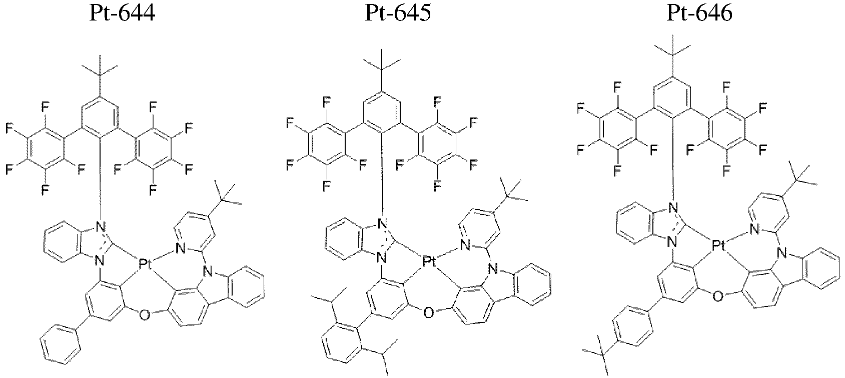

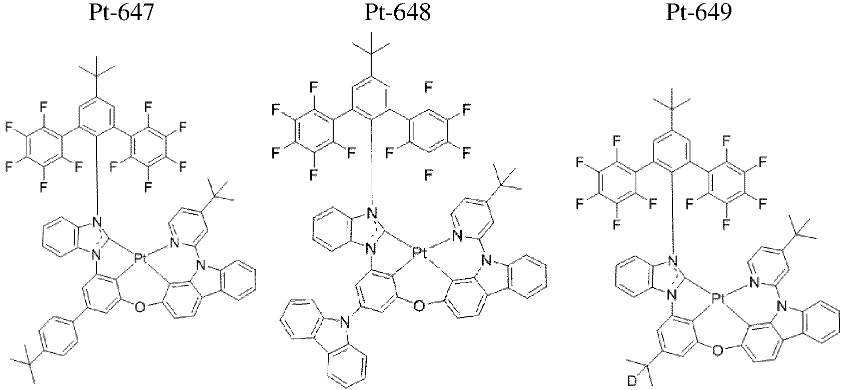

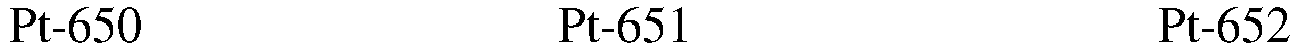

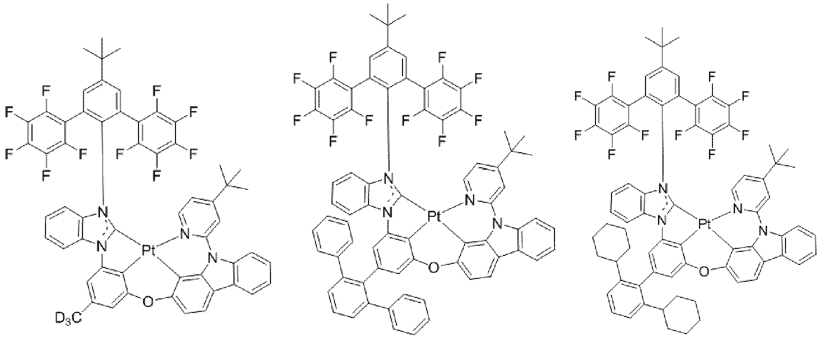

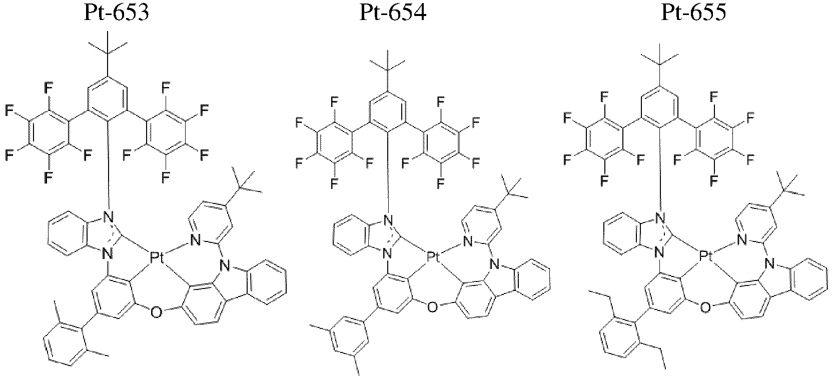

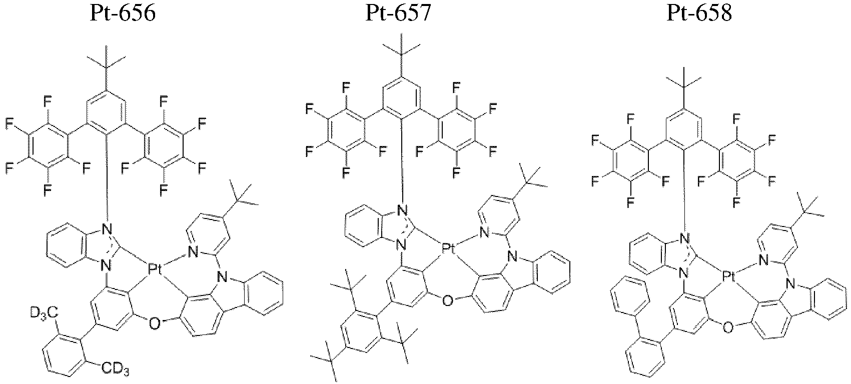

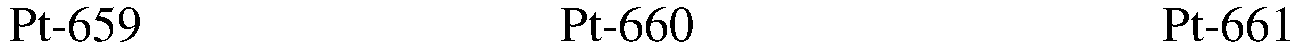

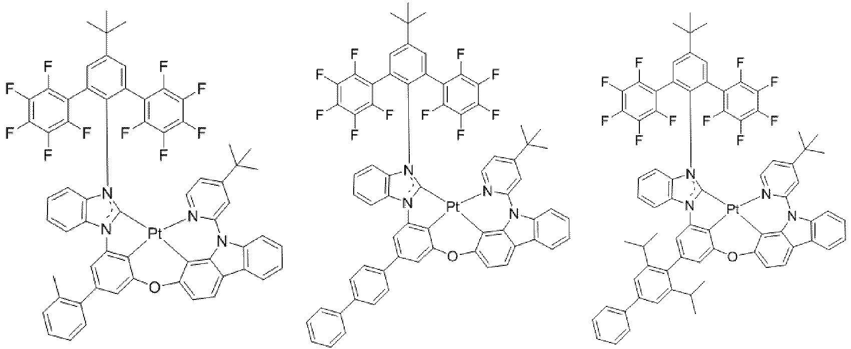

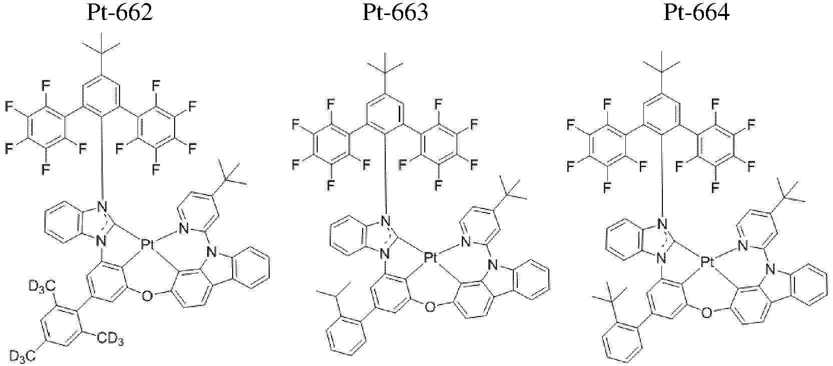

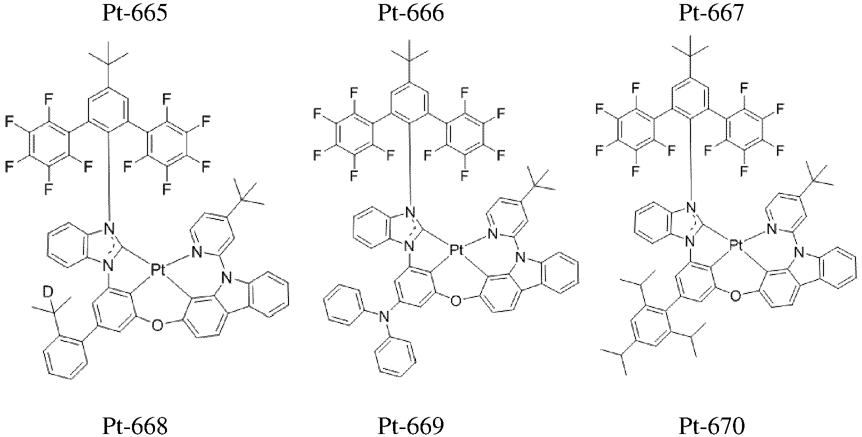

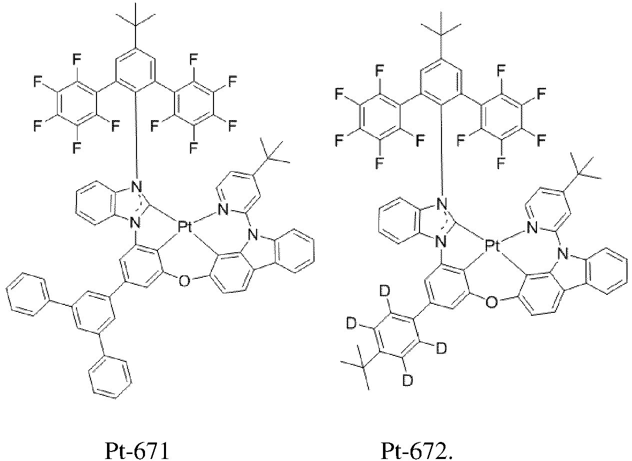

3. An application of the fluorinated tetradentate platinum (II) complex according to claim 1 or 2 in electronic devices.

4. The application according to claim 3, wherein the electronic device comprises an organic electroluminescent device, an organic integrated circuit, an organic field-effect transistor, an organic thin-film transistor, an organic light-emitting transistor, an organic solar cell, an organic optical detector, an organic photoreceptor, an organic field quenching device, a luminescent electrochemical cell, and an organic laser diode.

5. An organic electroluminescent device, wherein the organic electroluminescent device comprises a cathode, an anode, and an organic functional layer between the cathode and the anode; the organic functional layer comprises the fluorinated tetradentate platinum (II) complex according to claim 1 or 2.

6. The organic electroluminescent device according to claim 5, wherein the organic functional layer comprises a luminescent layer, wherein the luminescent layer comprises the fluorinated tetradentate platinum (II) complex according to of claim 1 or 2.

7. The organic electroluminescent device according to claim 5, wherein the luminescent layer further comprises a fluorescent doped material; the fluorescent doped material is a compound represented by Formula (BN1) or Formula (BN2): 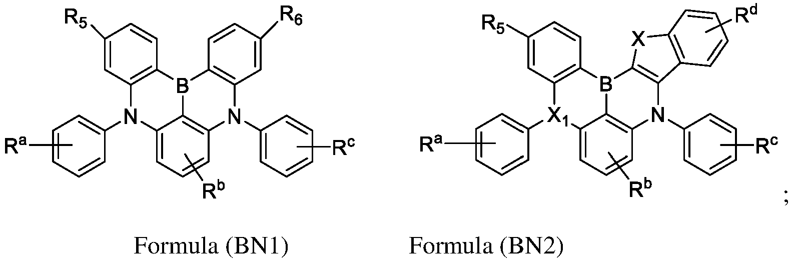
where X represents O, S, Se or NR³⁰⁰, and X₁ represents Se or N;
R^{a}-R^{d} are each independently represented as mono-substitution, bi-substitution, tri-substitution, tetra-substitution, or unsubstitution; R^{a}-R^{d} are each independently selected from the group consisting of hydrogen, deuterium, N, a C1-C30 alkyl, and a C6-C60 aryl; and
R₅ and R₆ are independently selected from the group consisting of a substituted or unsubstituted diphenylamine group, and a substituted or unsubstituted carbazole group; when a substituent is present, the substituent is selected from the group consisting of deuterium, a C1-C30 alkyl, and a C6-C30 aryl.

8. The organic electroluminescent device according to the claim 5, wherein the fluorescent doped material has any one of the following chemical structures, where Ph represents a phenyl group:

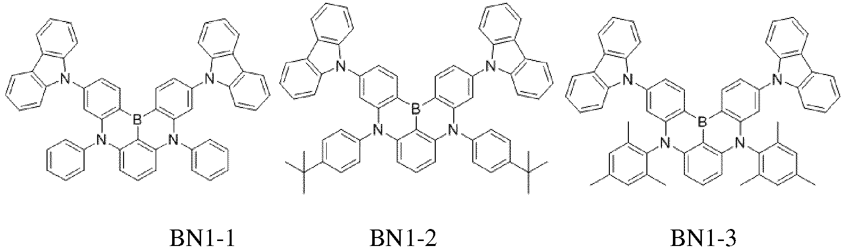

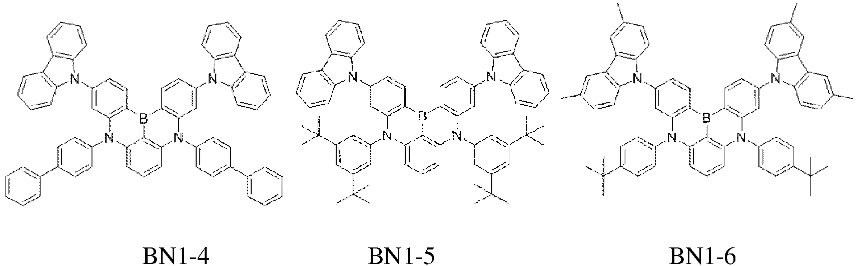

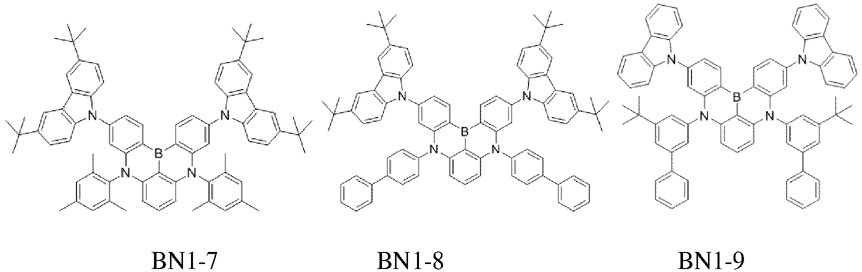

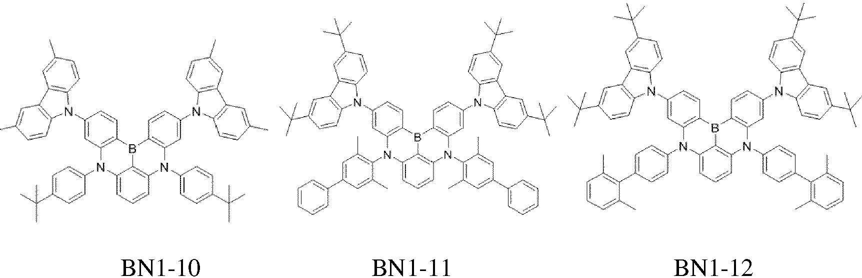

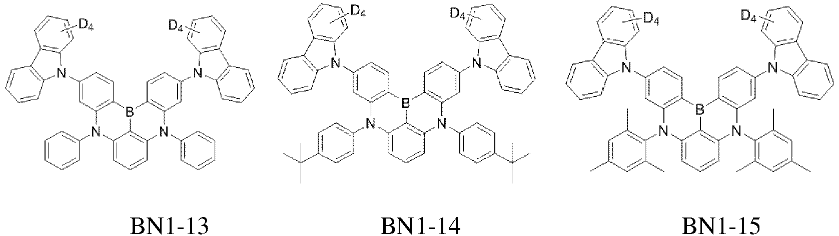

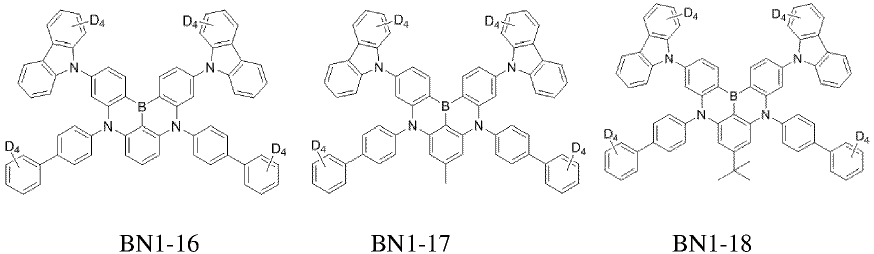

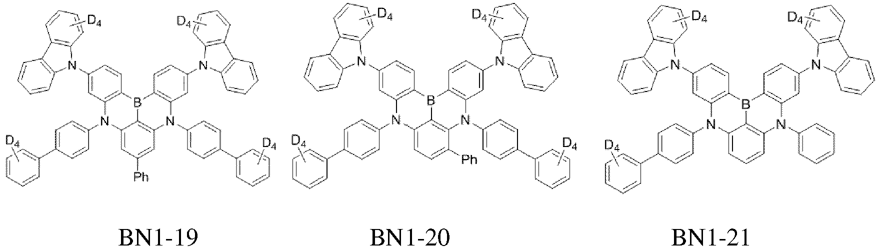

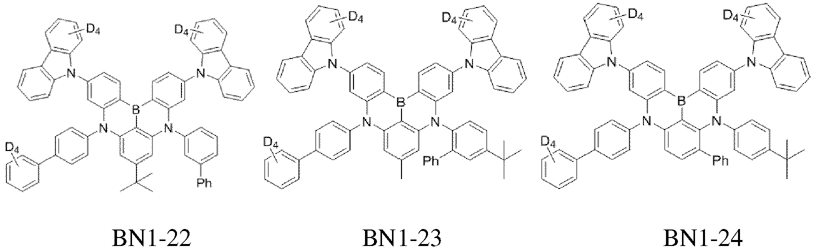

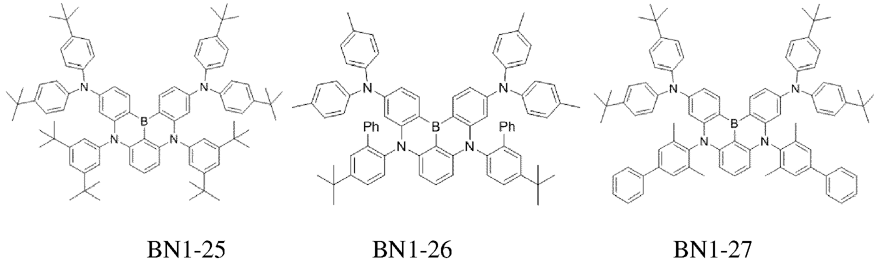

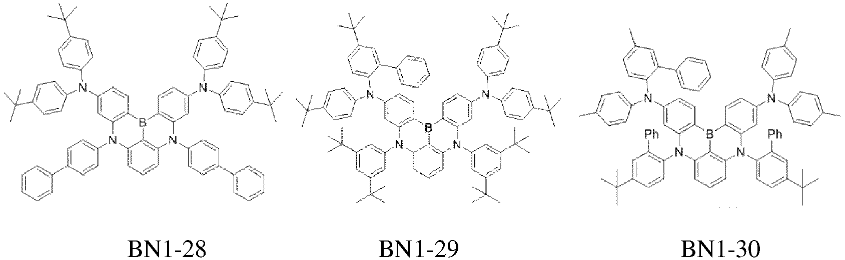

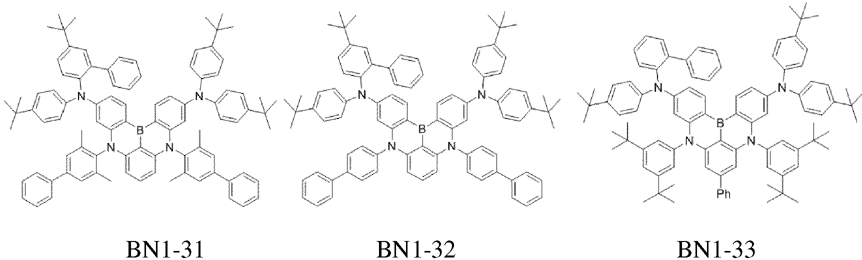

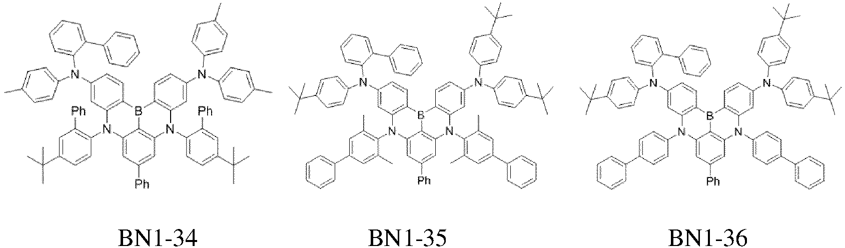

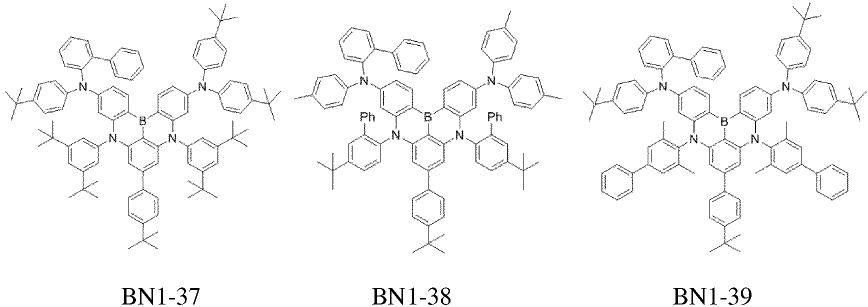

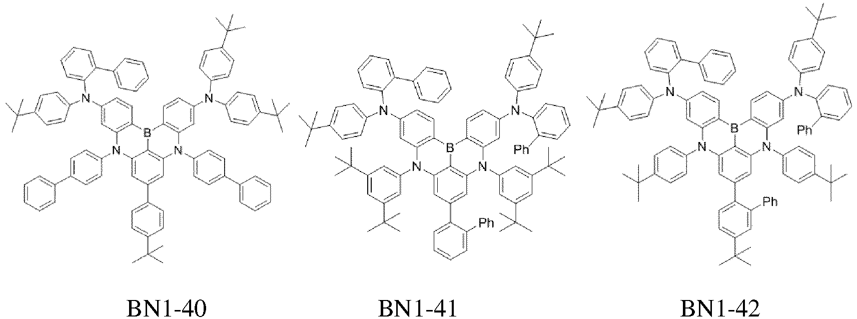

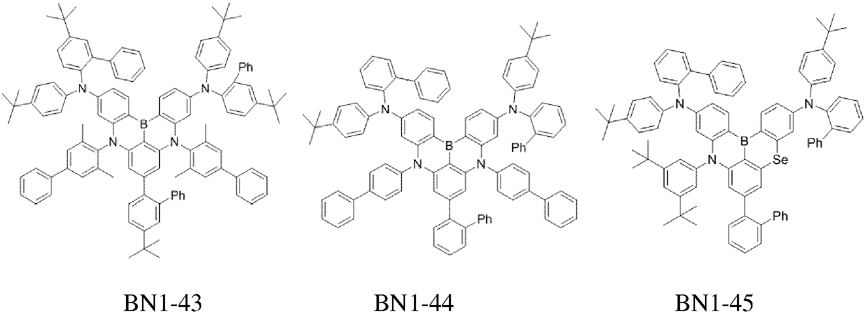

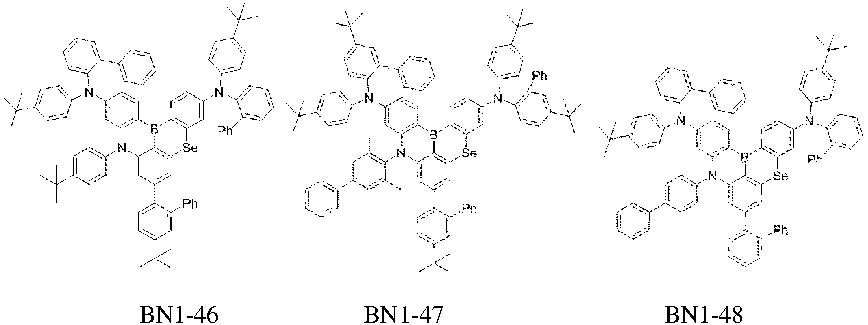

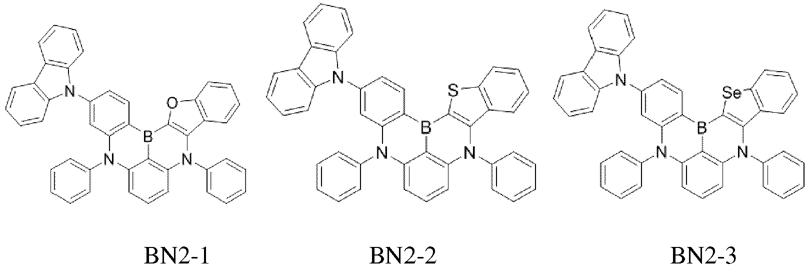

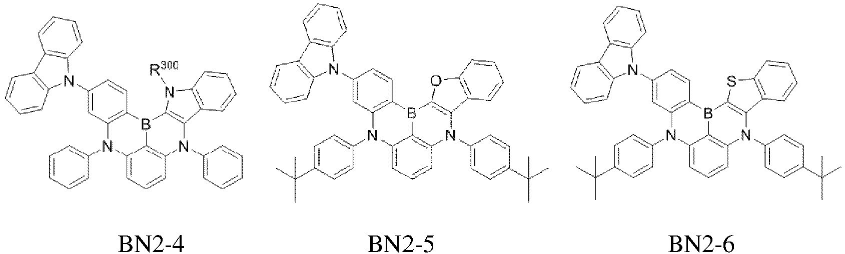

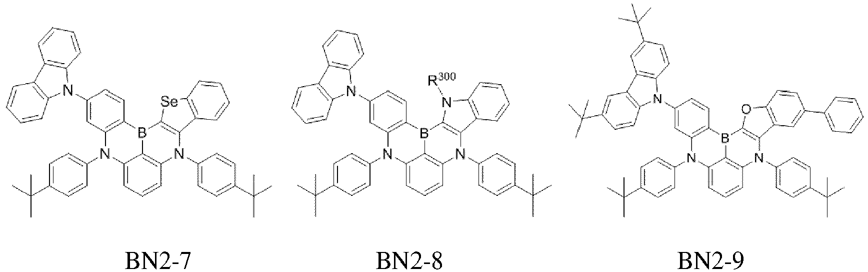

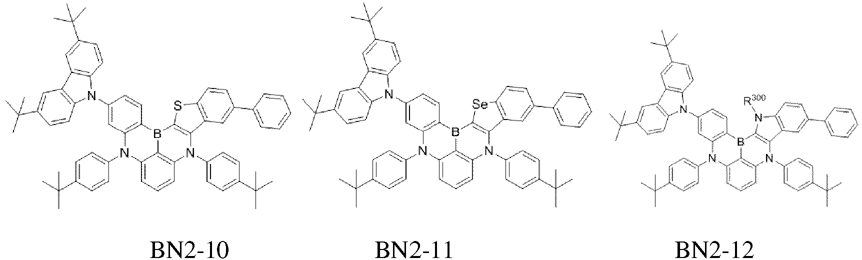

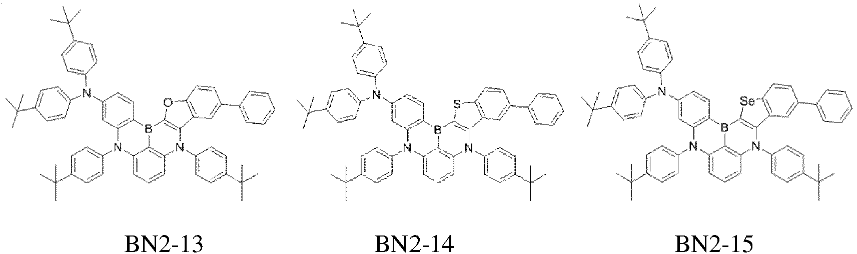

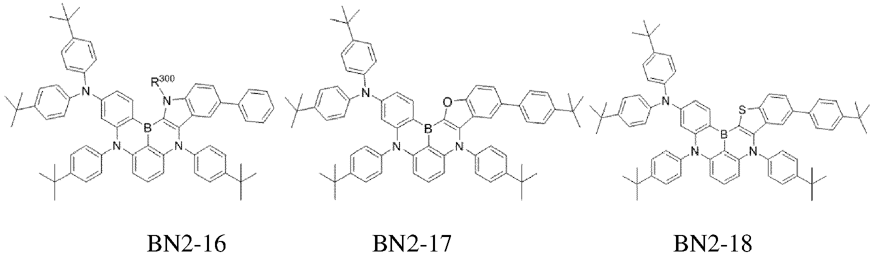

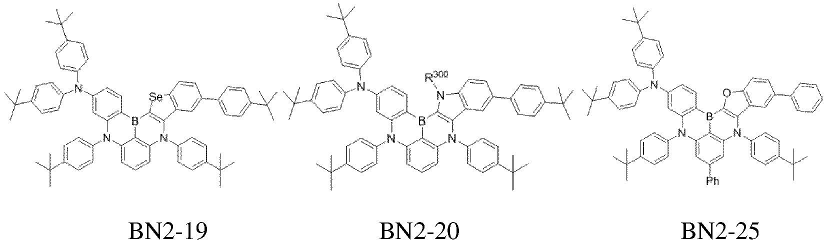

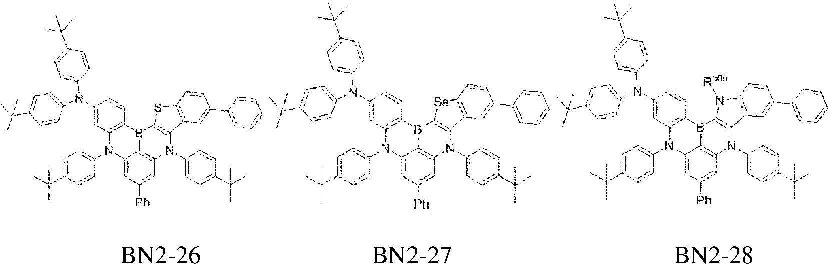

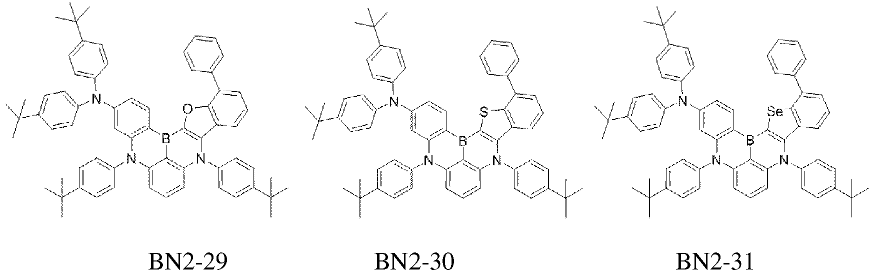

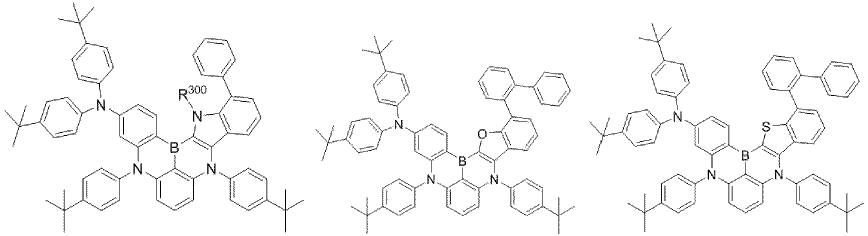

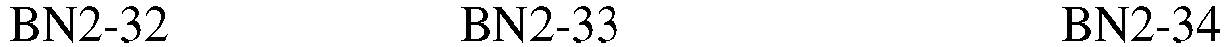

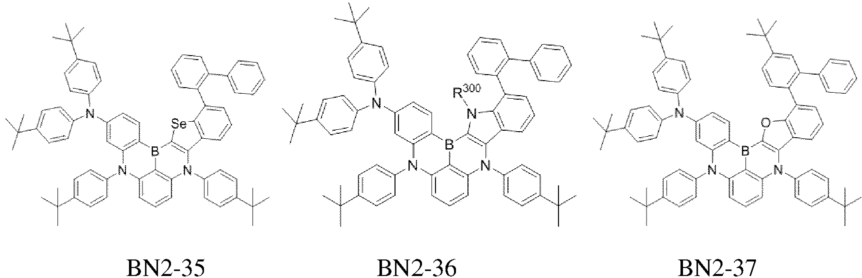

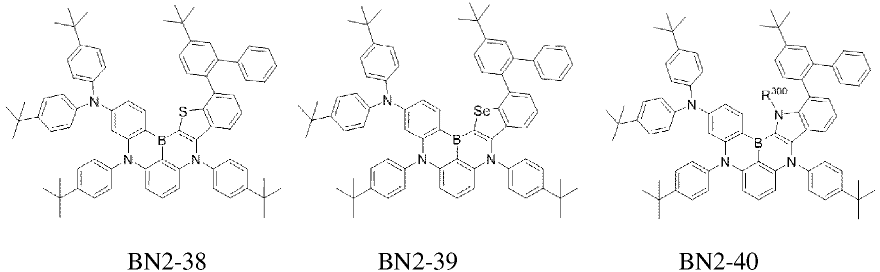

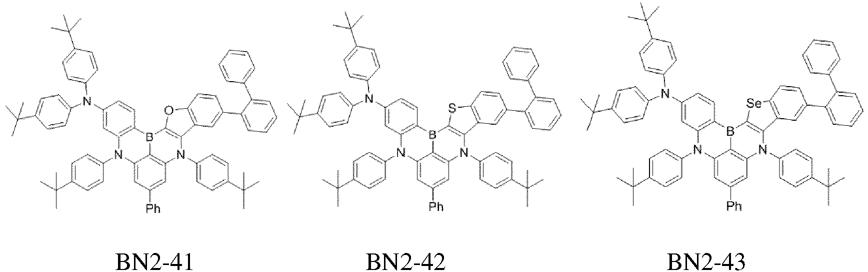

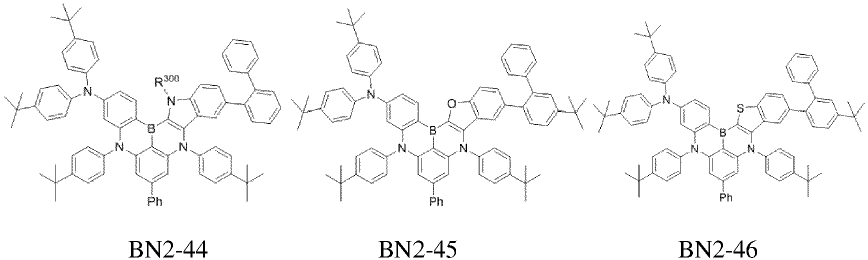

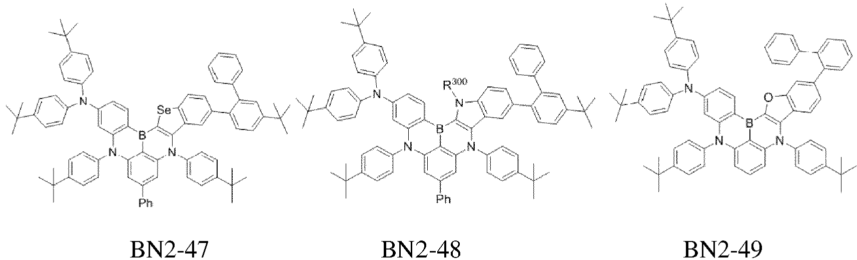

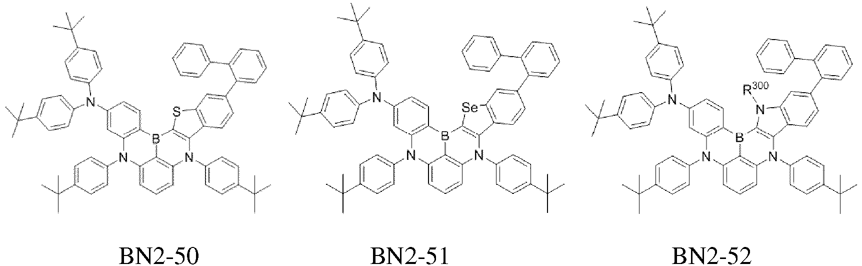

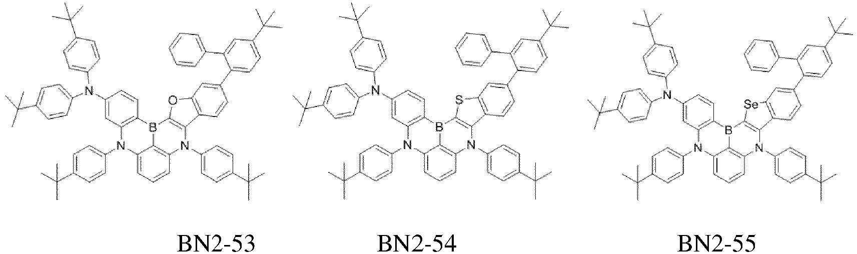

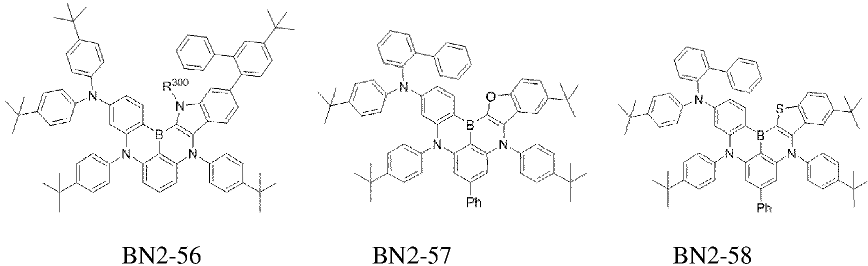

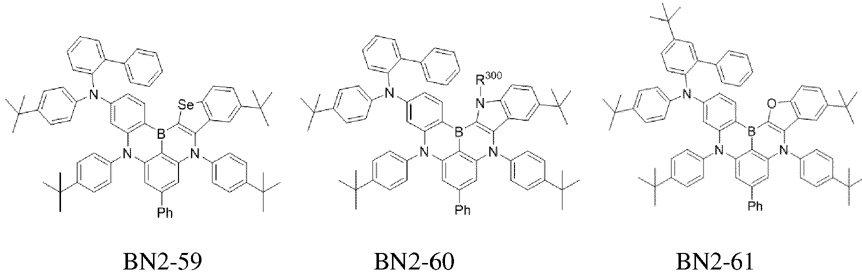

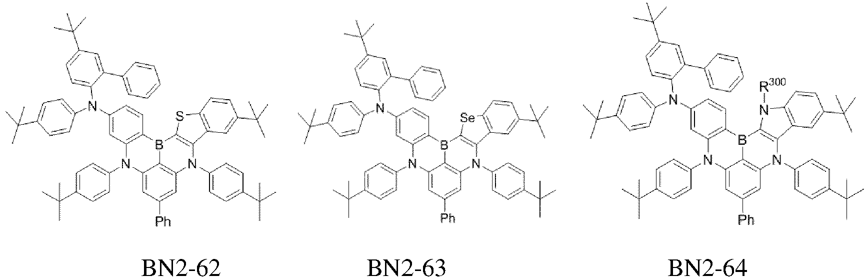

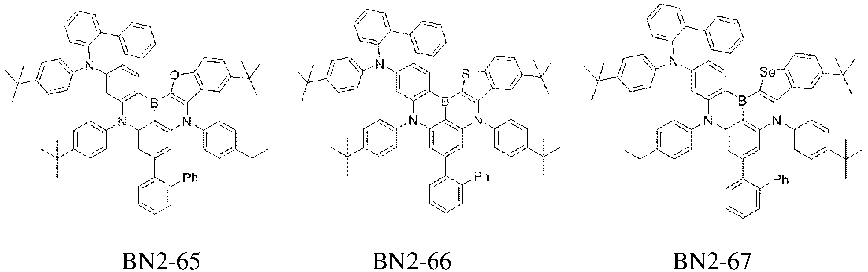

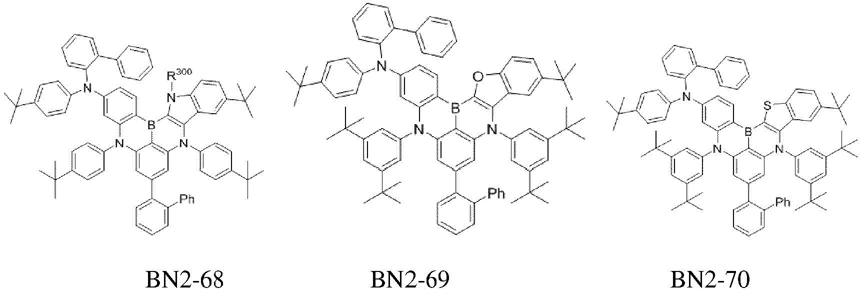

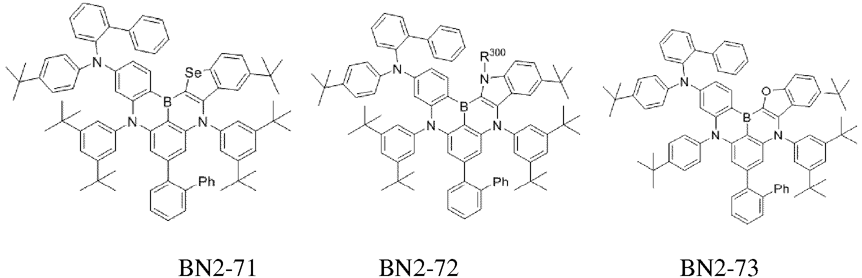

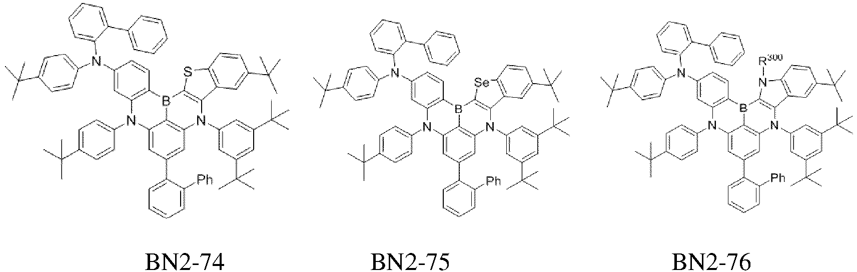

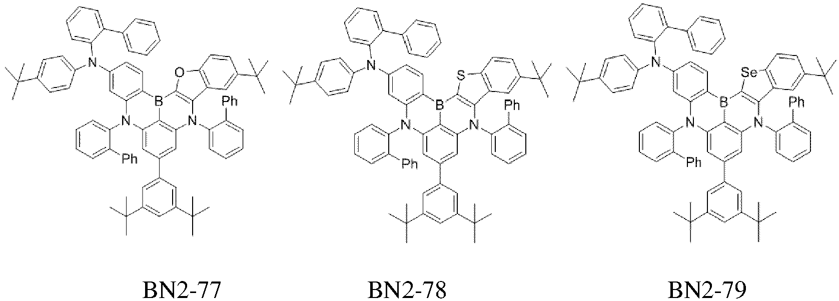

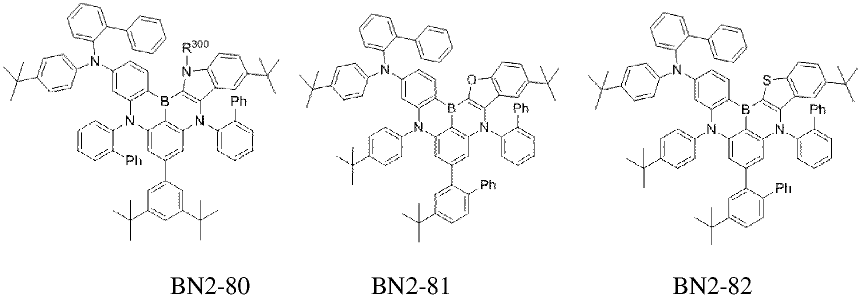

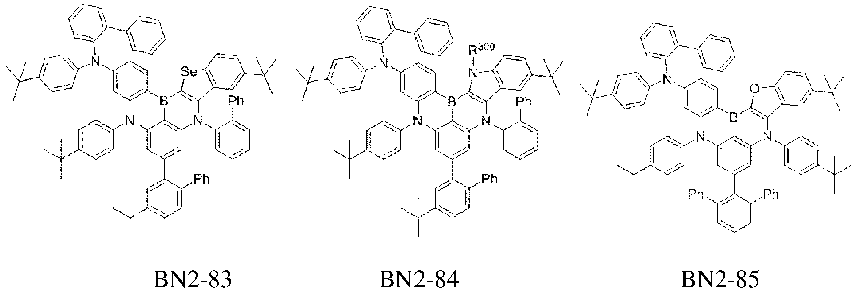

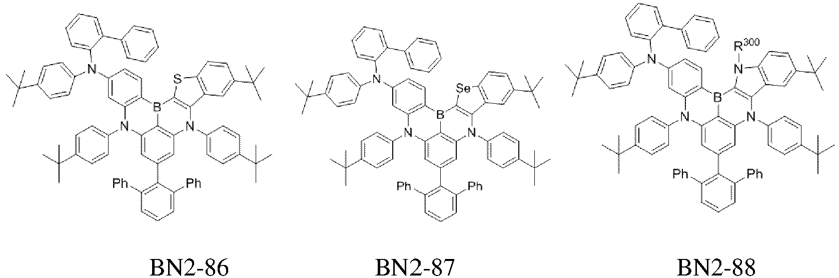

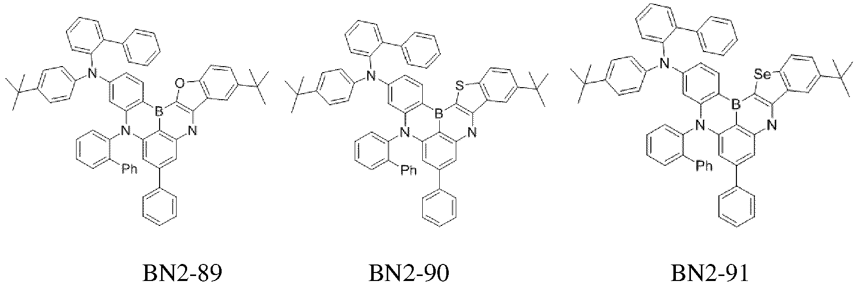

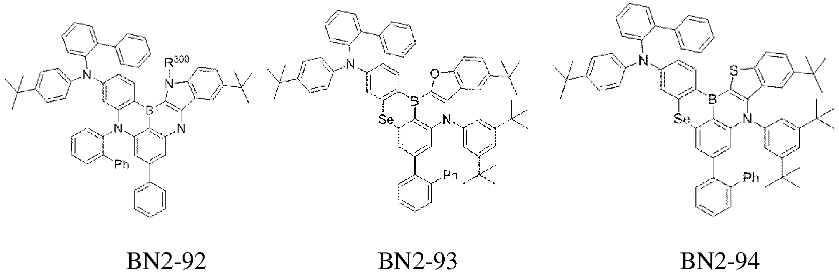

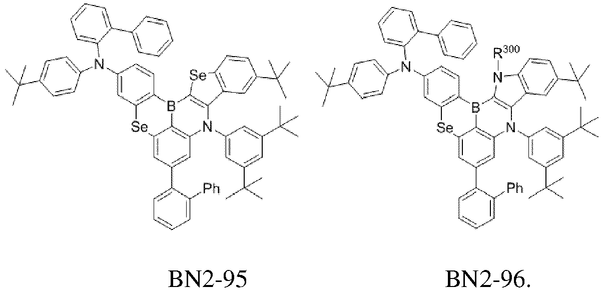

9. An organic optoelectronic device, wherein the organic optoelectronic device comprises: a substrate layer; a first electrode, wherein the first electrode is above the substrate; an organic luminescent functional layer, wherein the organic luminescent functional layer is above the first electrode; a second electrode, wherein the second electrode is above the organic luminescent functional layer; wherein the organic luminescent functional layer comprises the fluorinated tetradentate platinum (II) complex according to claim 1 or 2.

10. The organic optoelectronic device according to claim 9, wherein the organic luminescent functional layer further comprises a fluorescent doped material; the fluorescent doped material is a compound represented by Formula (BN1) or Formula (BN2): 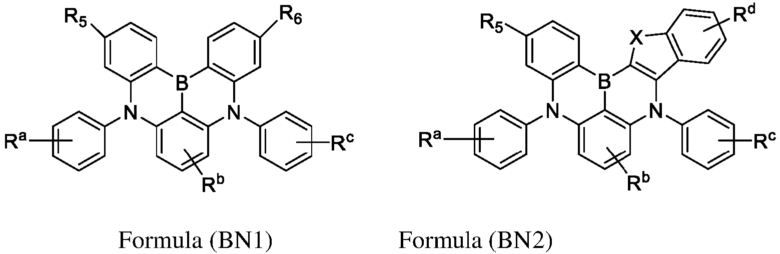
where X represents O, S, Se or NR³⁰⁰, and X₁ represents Se or N;
R^{a}-R^{d} are each independently represented as mono-substitution, bi-substitution, tri-substitution, tetra-substitution, or unsubstitution; R^{a}-R^{d} are each independently selected from the group consisting of hydrogen, deuterium, N, a C1-C30 alkyl, and a C6-C60 aryl; and
R₅ and R₆ are each independently selected from the group consisting of a substituted or unsubstituted diphenylamine group, and a substituted or unsubstituted carbazole group; when a substituent is present, the substituent is selected from the group consisting of deuterium, a C1-C30 alkyl, and a C6-C30 aryl.

11. A composition, wherein the composition comprises the fluorinated tetradentate platinum (II) complex according to claim 1 or 2.

12. A device, wherein the device comprises the fluorinated tetradentate platinum (II) complex according to claim 1 or 2.

13. A display or lighting equipment, wherein the equipment comprises one or more of the organic electroluminescent device according to any one of claims 5-8.

## Patentansprüche

1. Fluorierter vierzähniger Platin (II)-Komplex, wobei der Komplex eine Struktur gemäß Formel (I) oder Formel (II) aufweist: 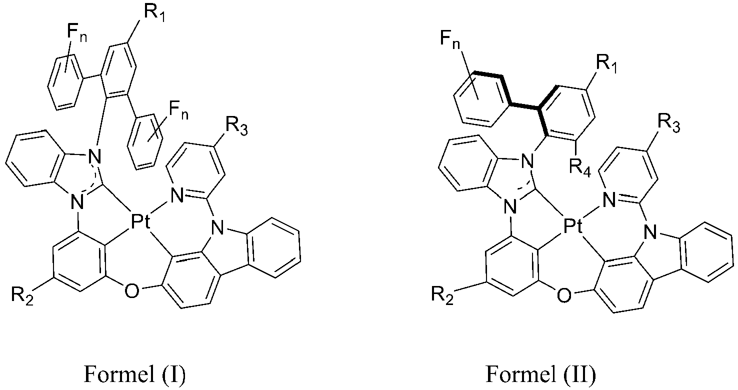 und wobei in Formel (I) oder Formel (II) Fₙ eine oder mehrere F-Substitutionen an dem Benzolring darstellt, an dem es angeordnet ist, und wobei n eine positive ganze Zahl von 1 bis 5 ist; und wobei R₁, R₂ und R₄ aus der Gruppe ausgewählt sind, die aus Wasserstoff, Deuterium, einem C1-C30-Alkyl, einem C1-C30-Cycloalkyl, einem C6-C60-Aryl, einem C1-C30-Heterocycloalkyl, einer C6-C18-Arylamingruppe und einer C6-C18-heterocyclischen Amingruppe besteht, und wobei R3 tert-Butyl ist.

2. Fluorierter vierzähniger Platin (II)-Komplex, wobei der fluorierte vierzähnige Platin (II)-Komplex eine beliebige der folgenden chemischen Strukturen aufweist, wobei "D" Deuterium darstellt:

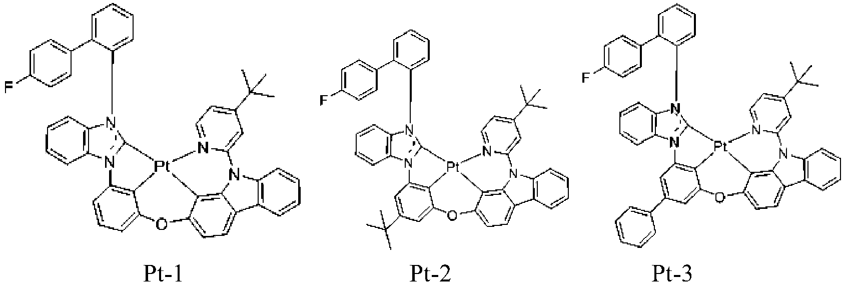

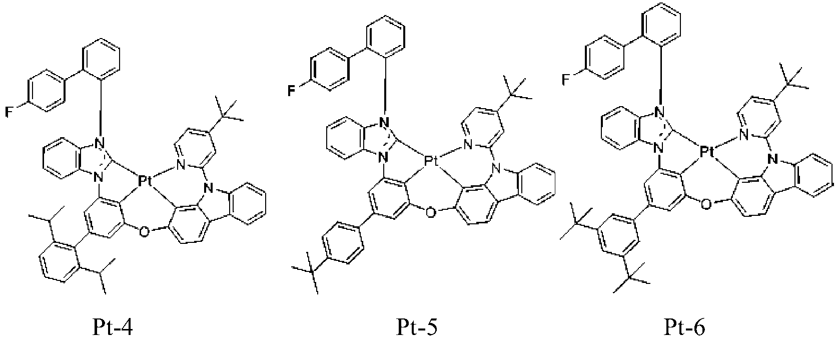

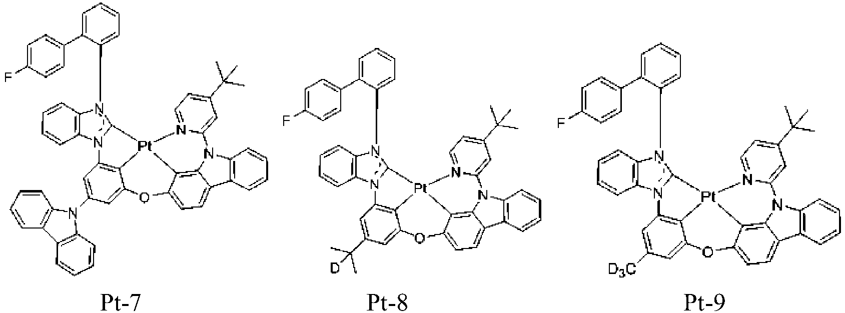

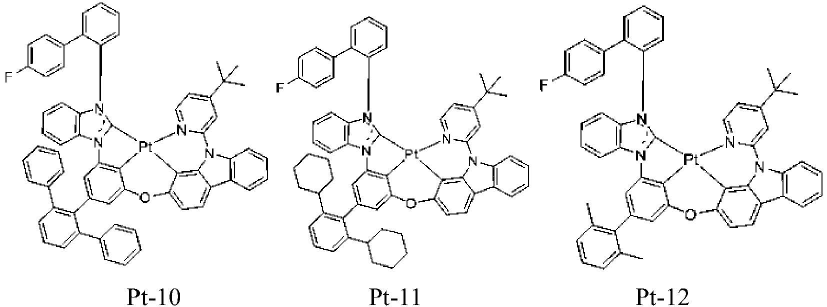

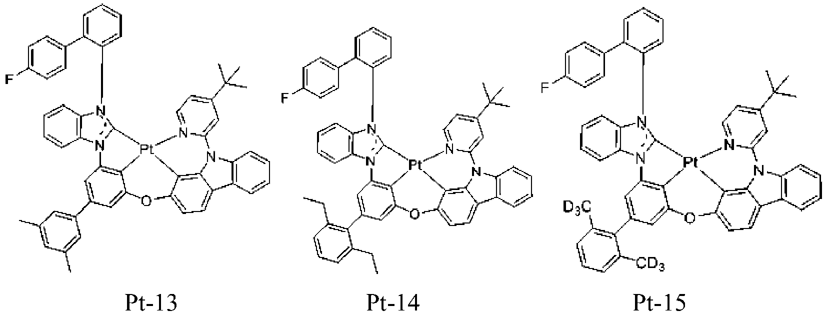

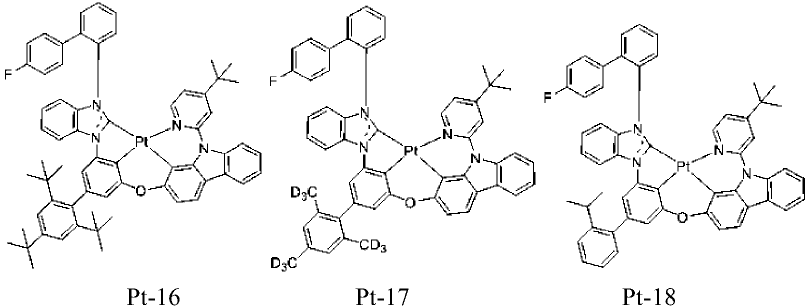

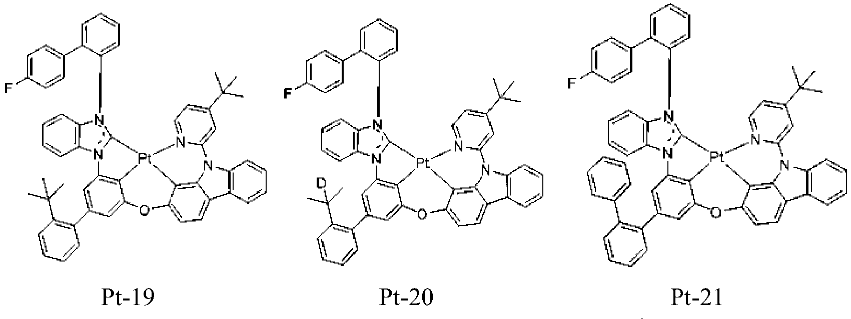

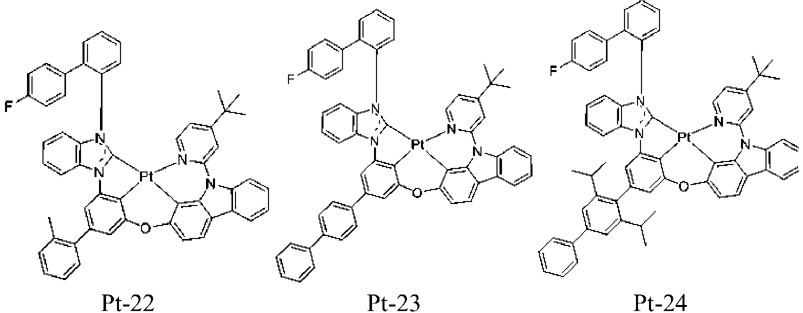

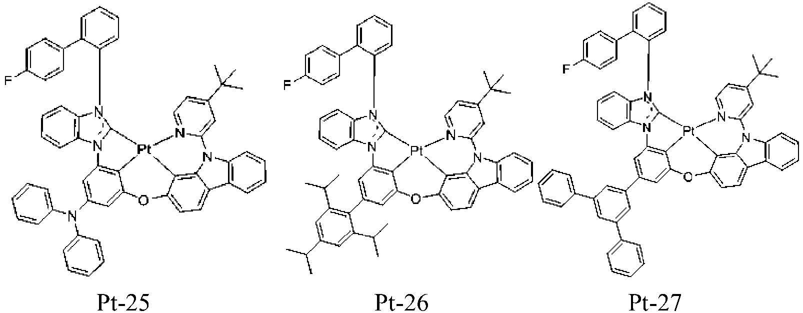

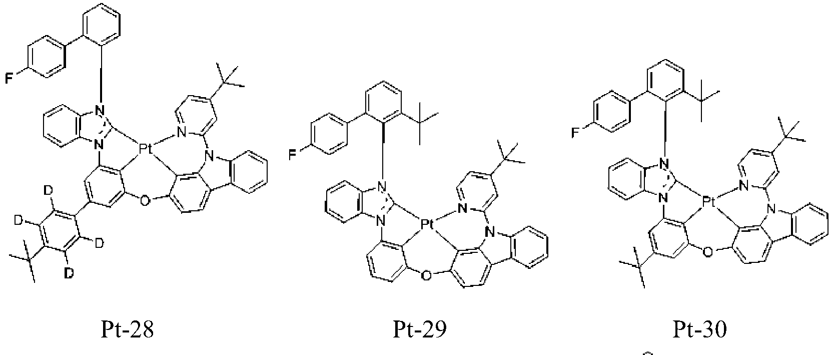

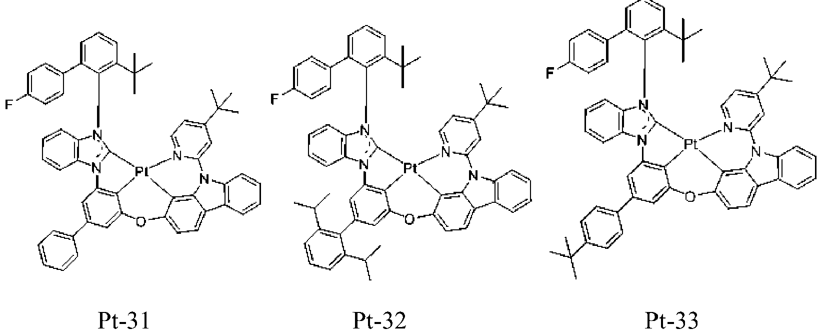

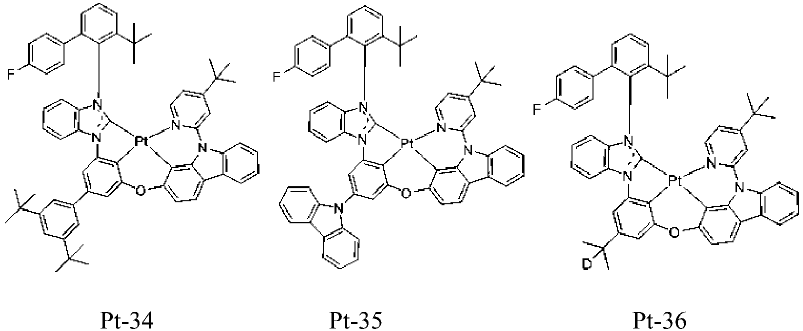

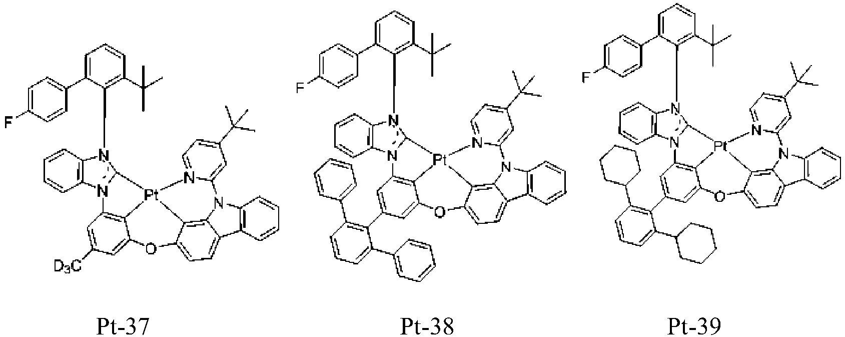

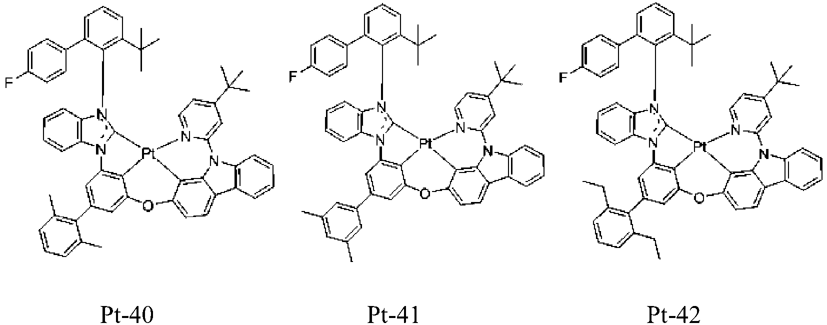

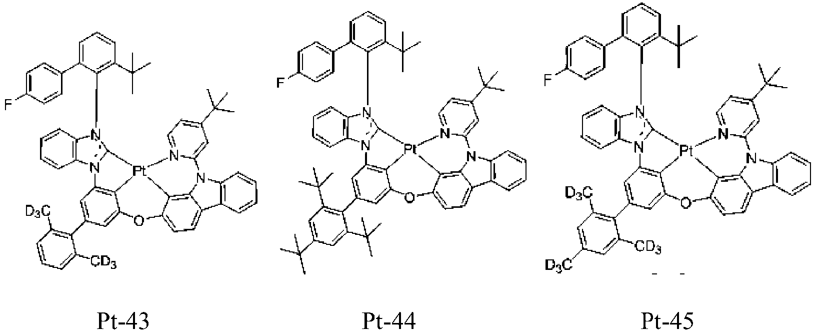

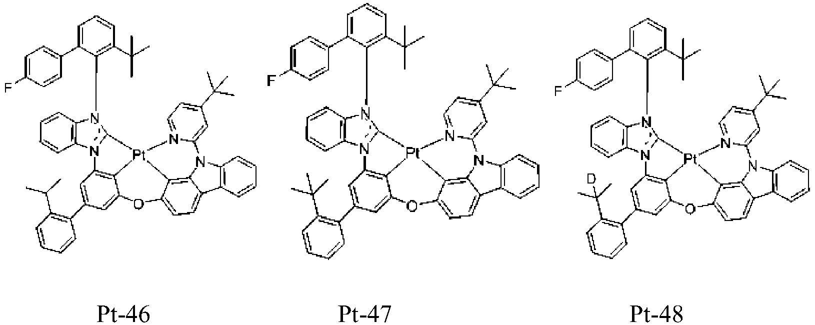

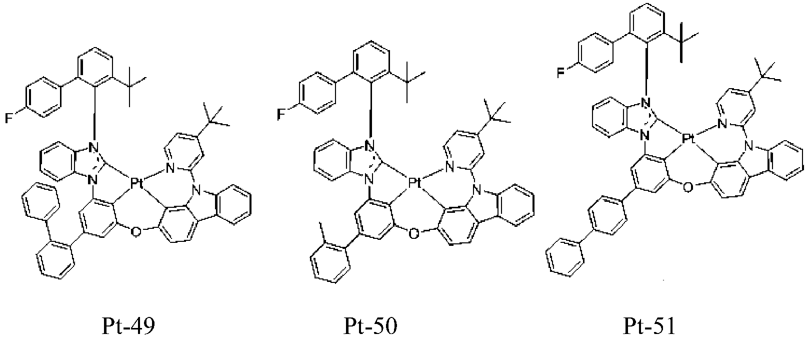

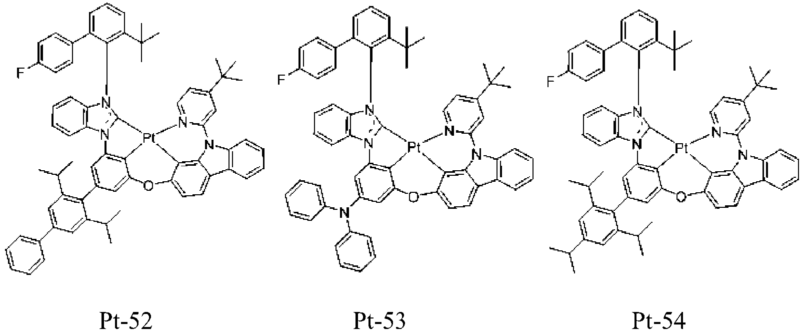

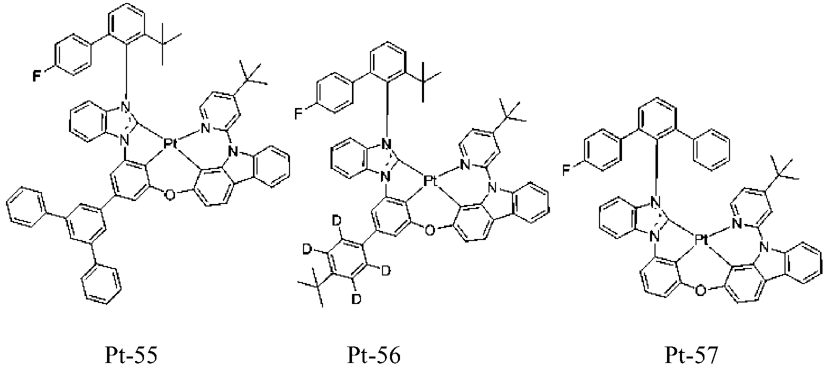

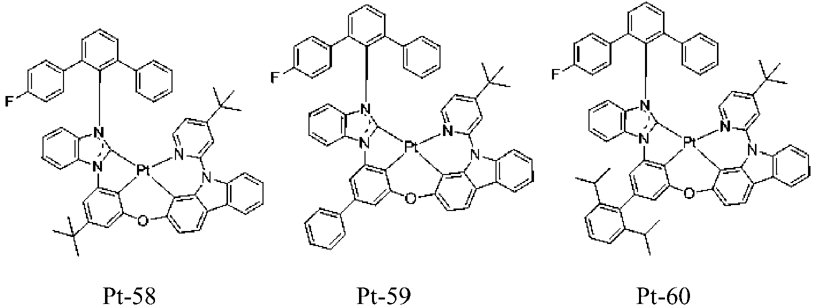

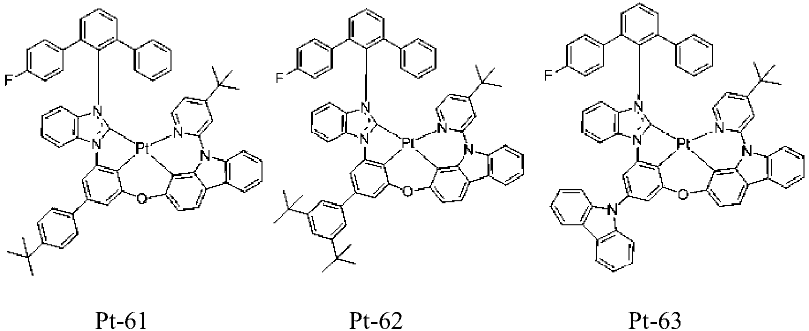

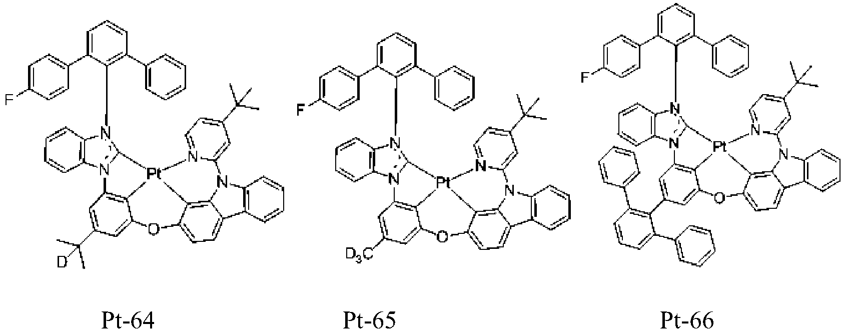

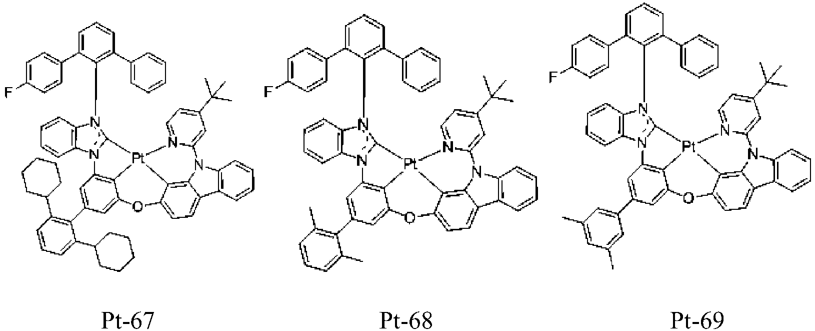

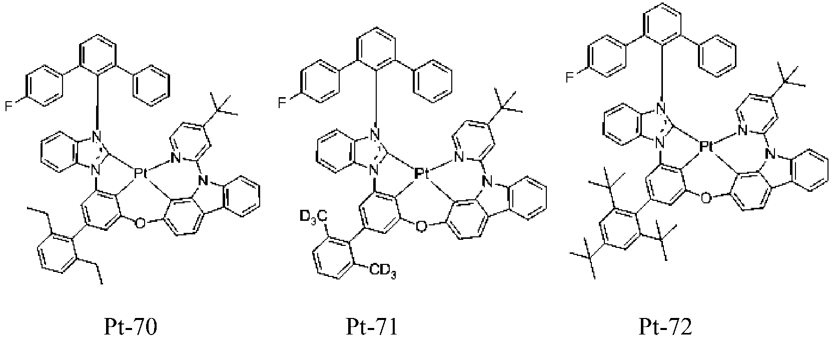

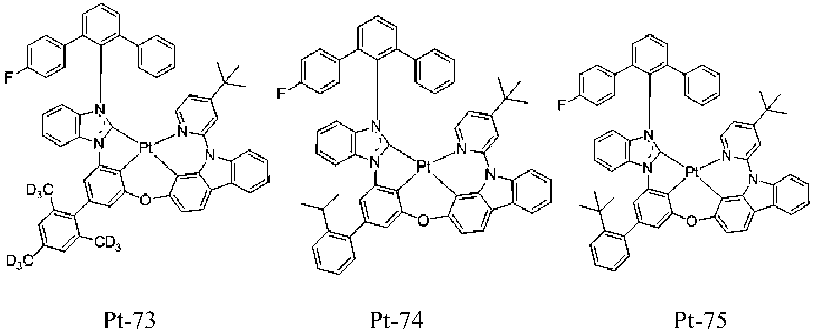

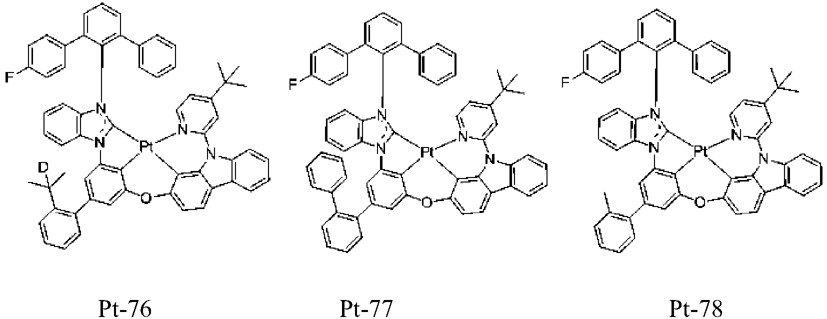

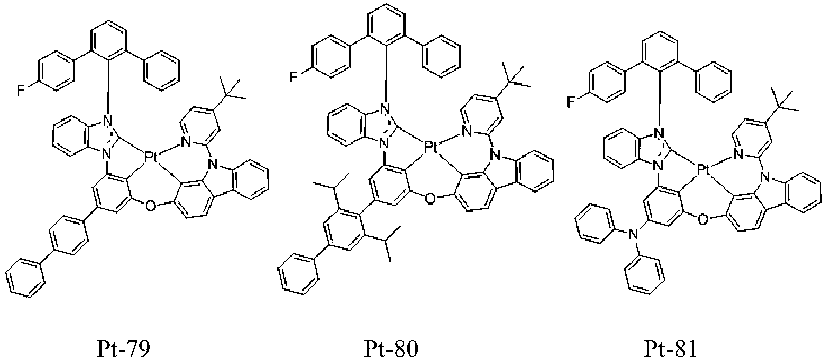

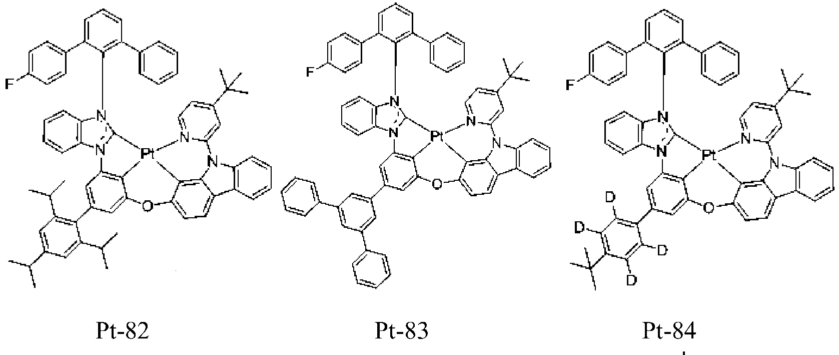

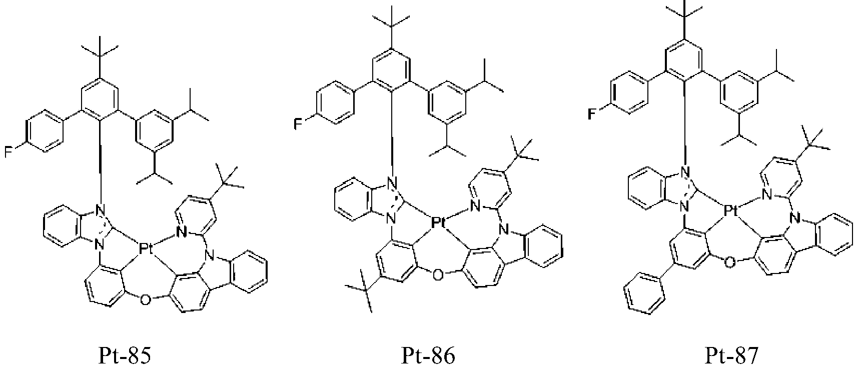

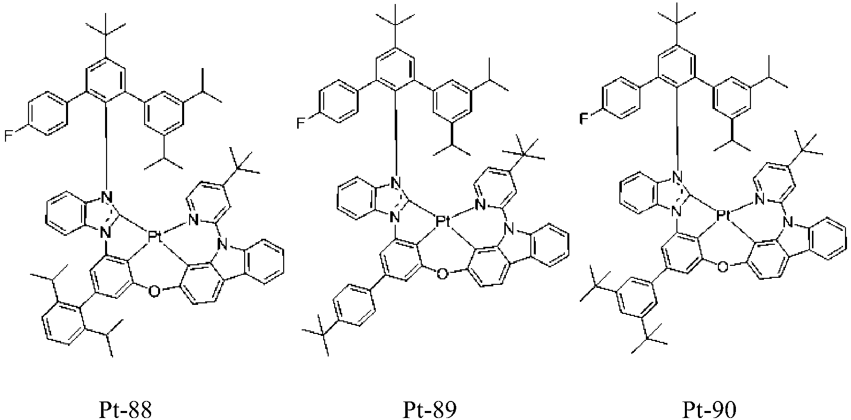

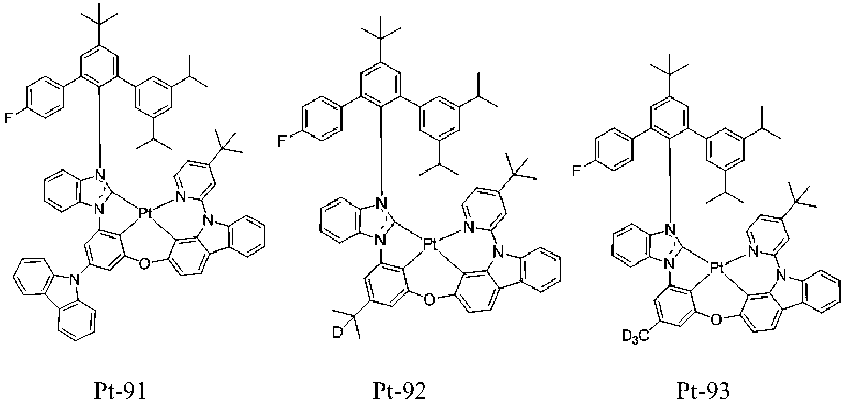

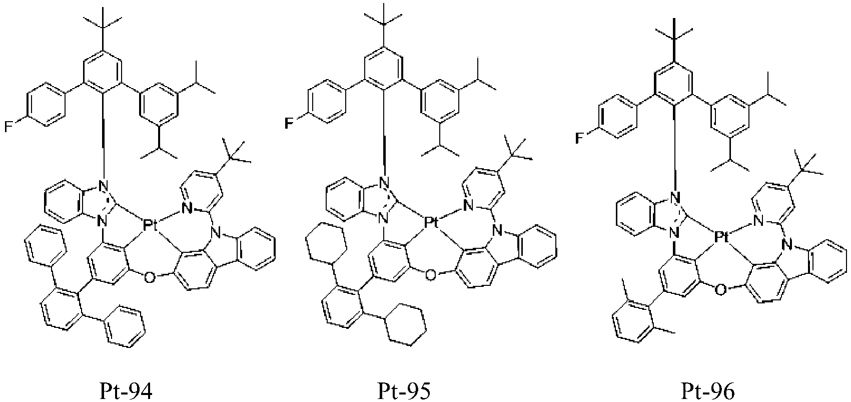

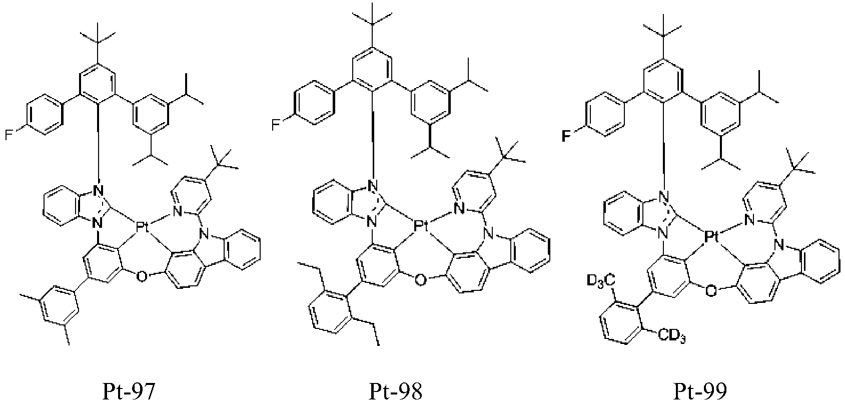

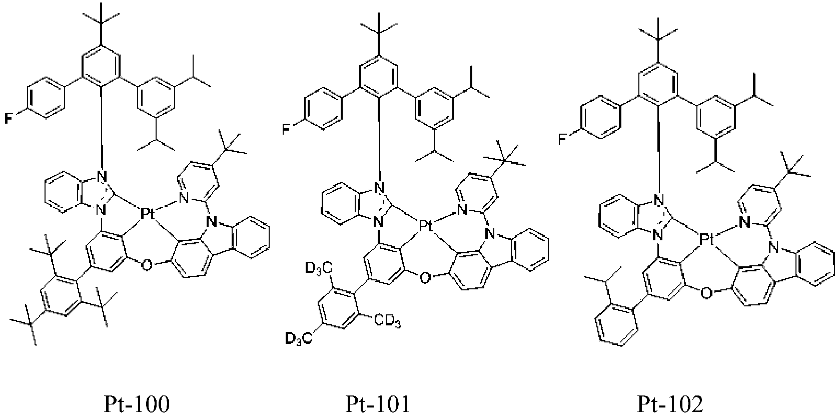

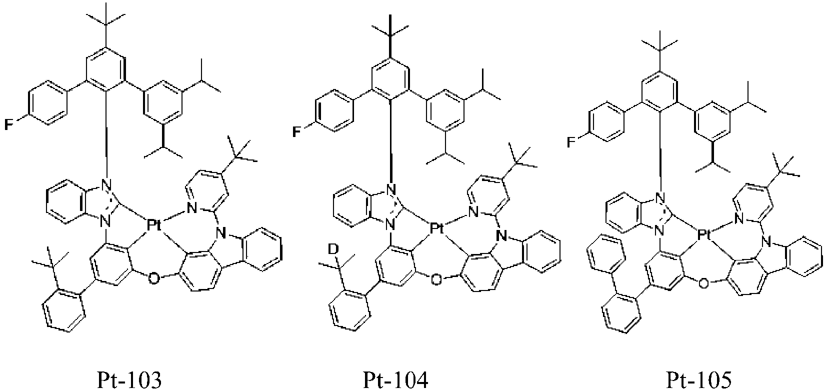

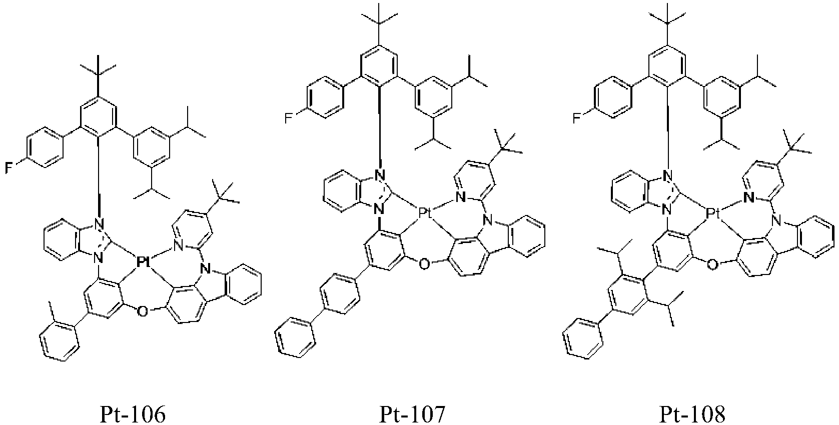

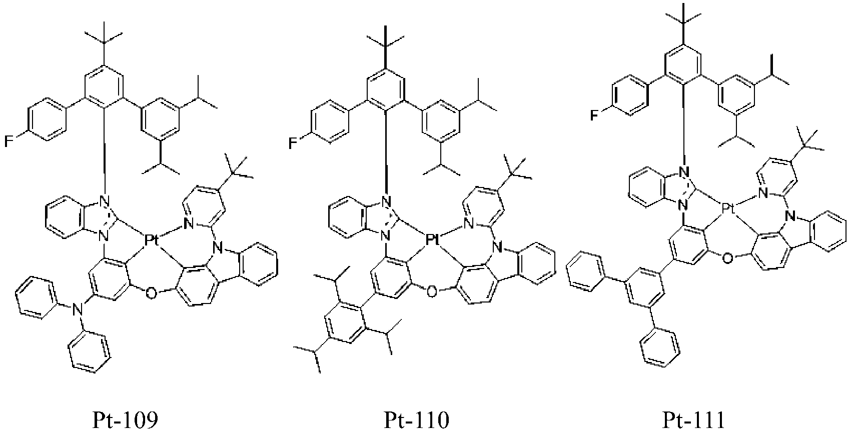

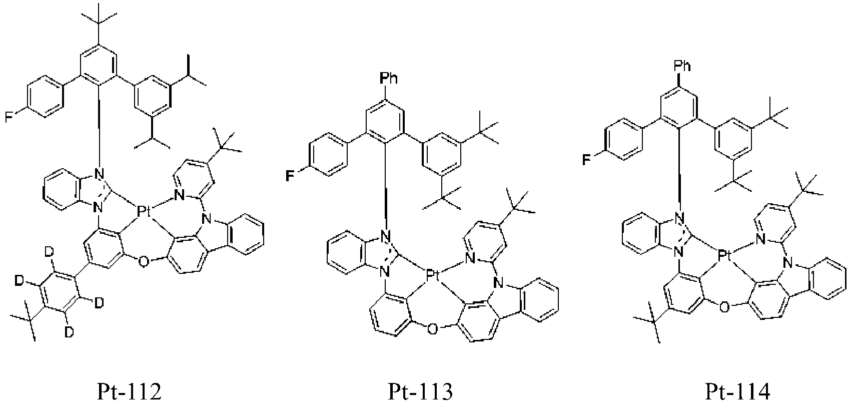

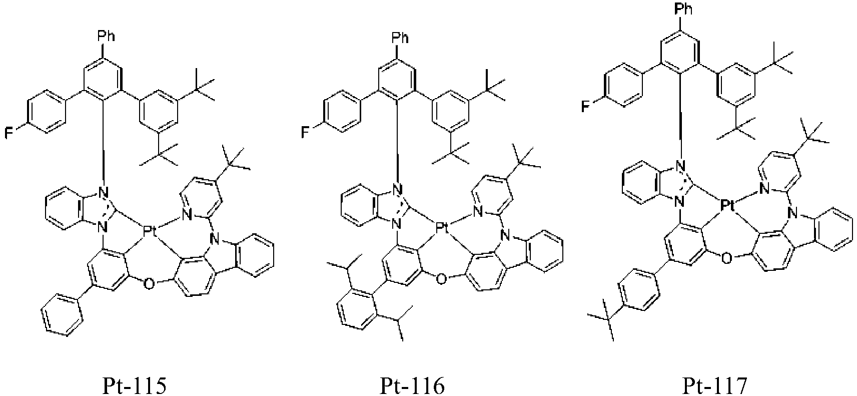

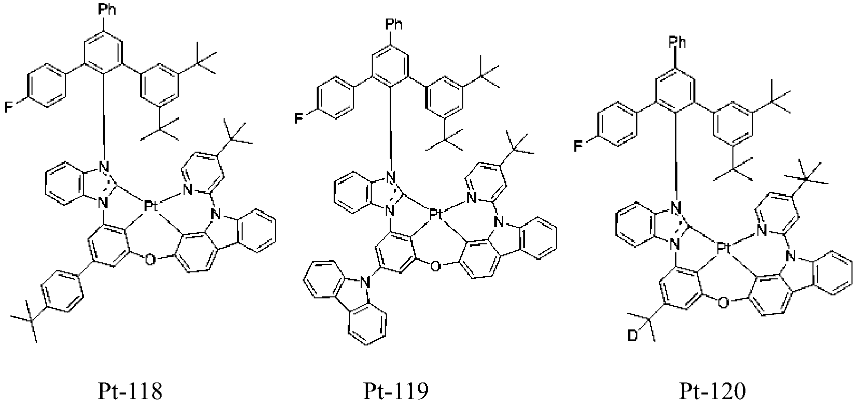

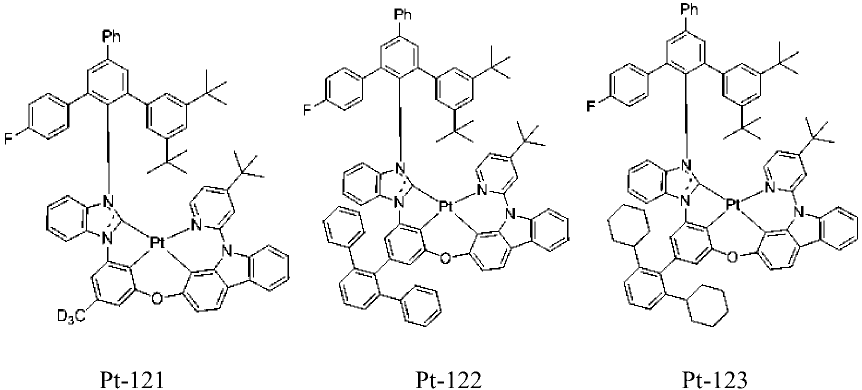

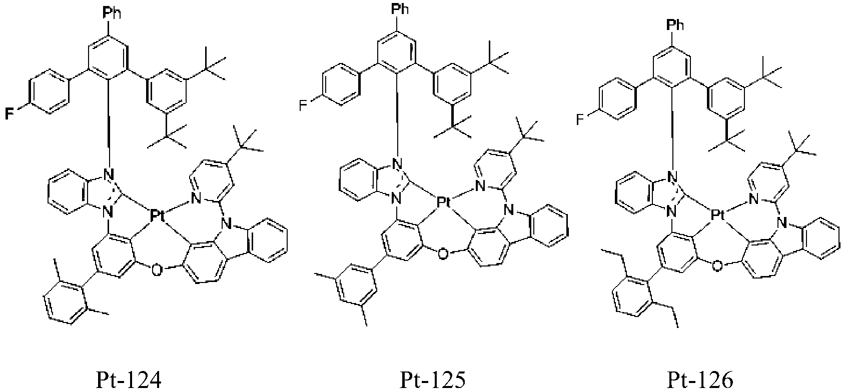

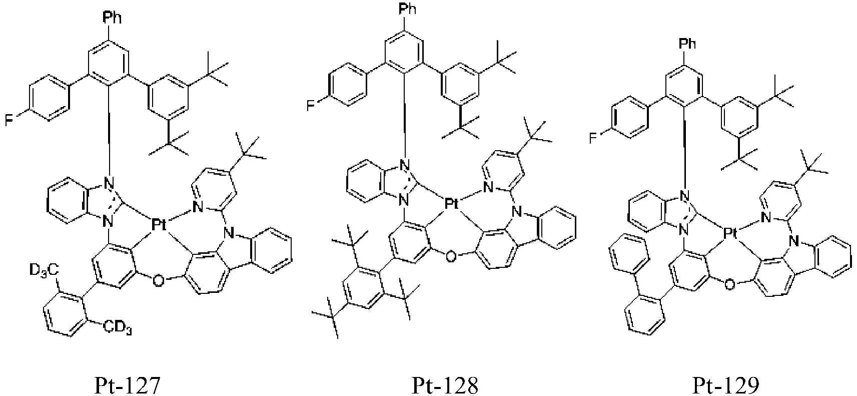

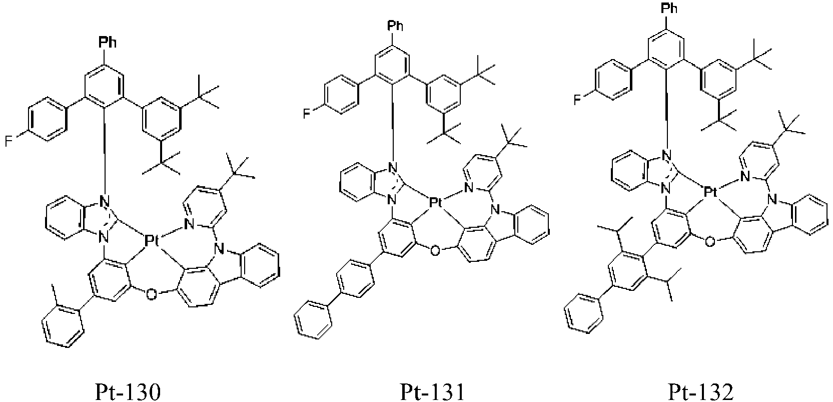

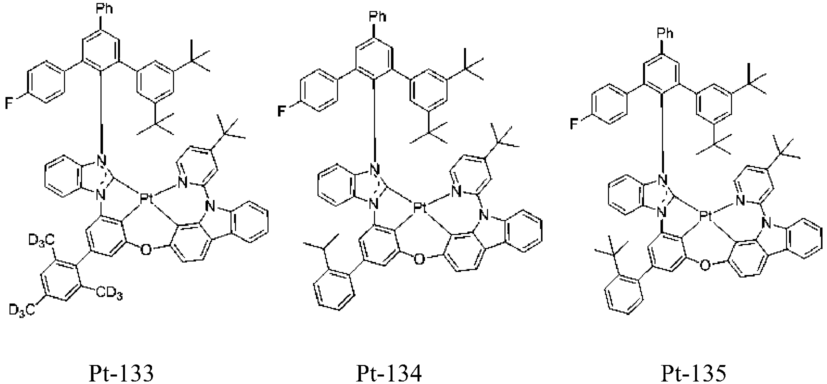

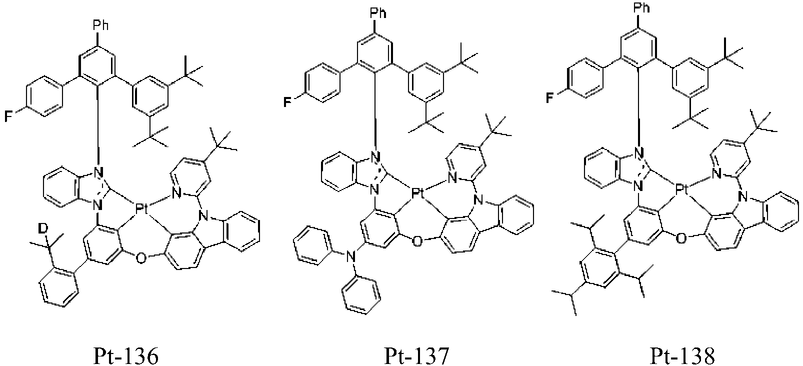

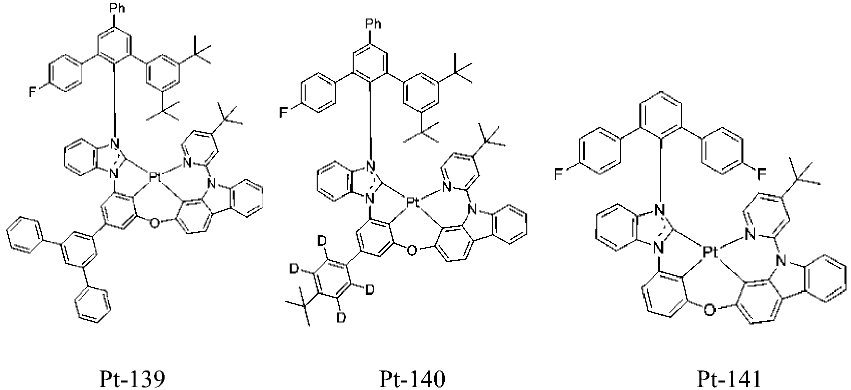

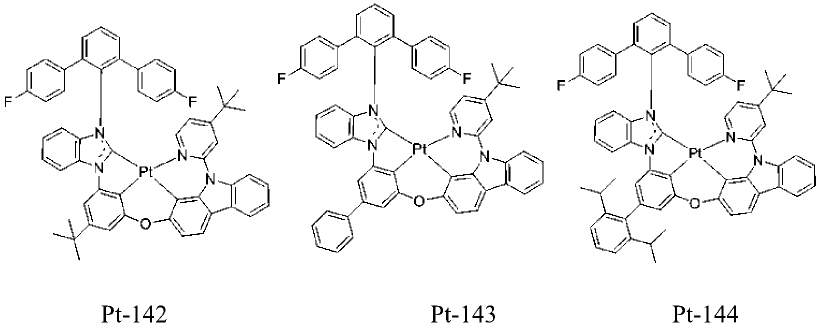

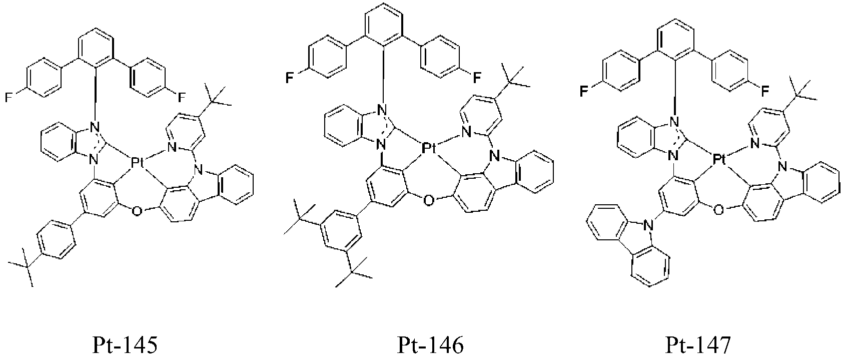

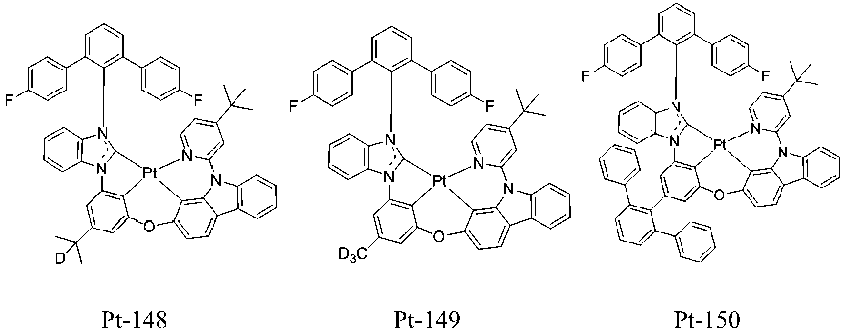

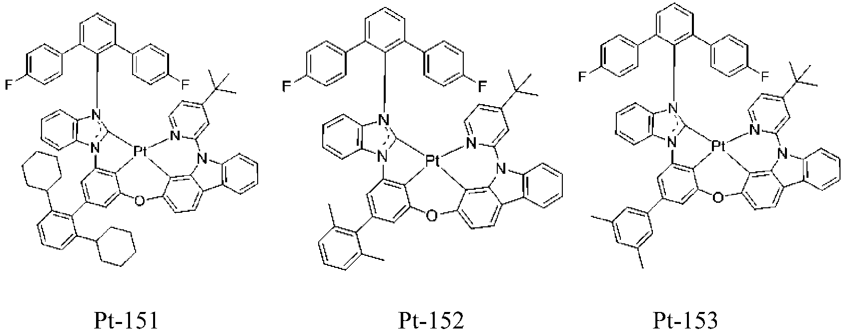

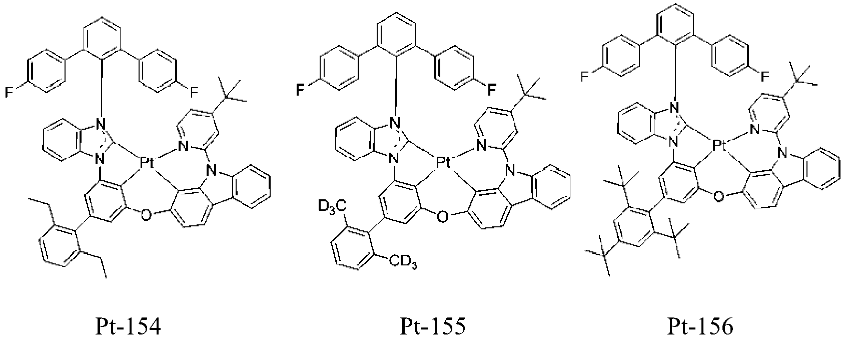

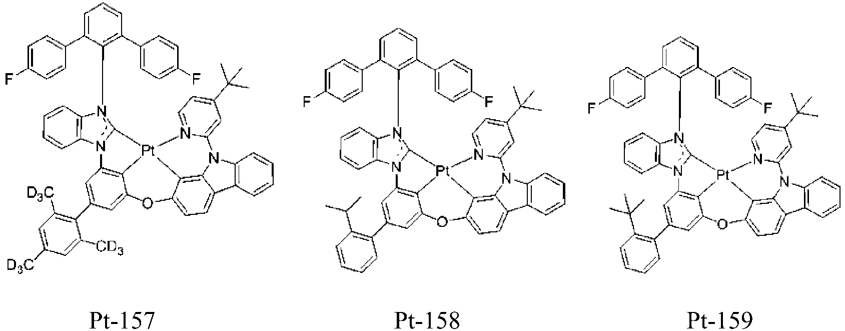

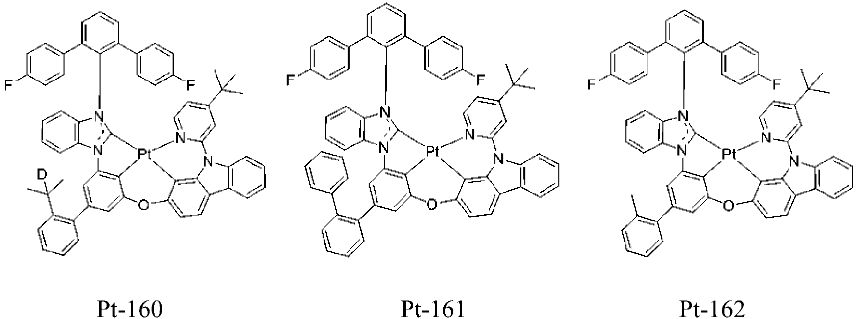

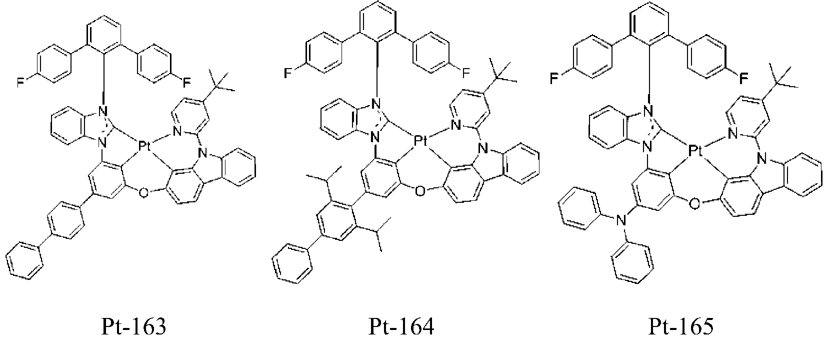

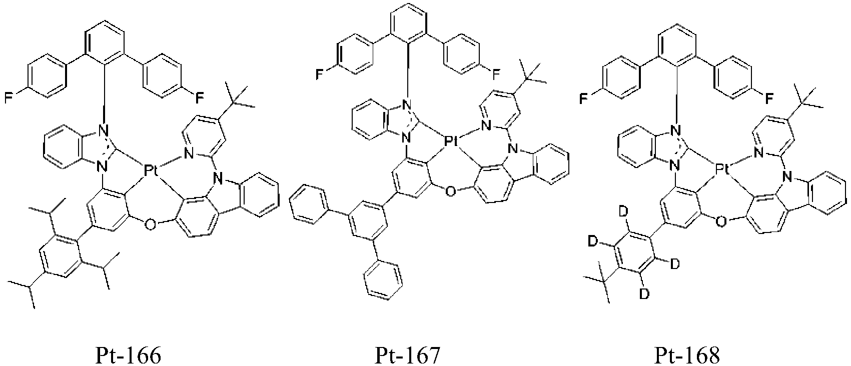

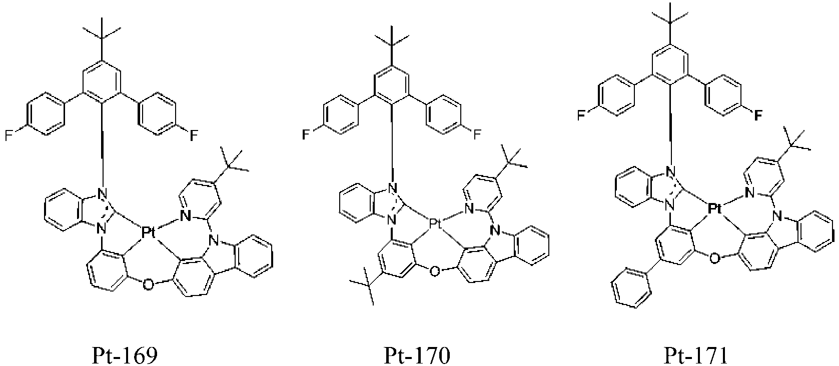

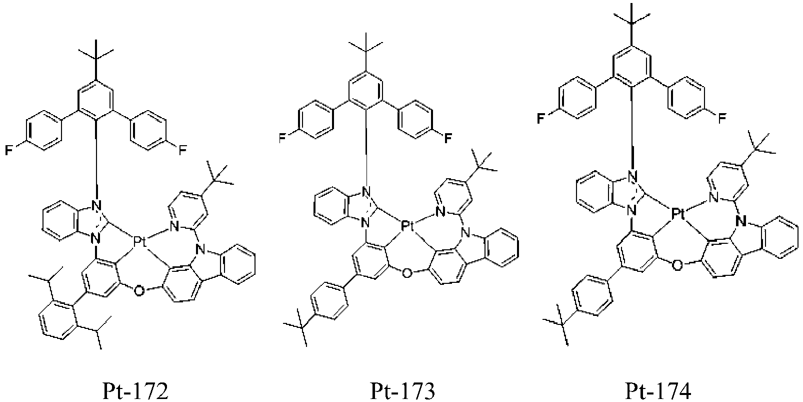

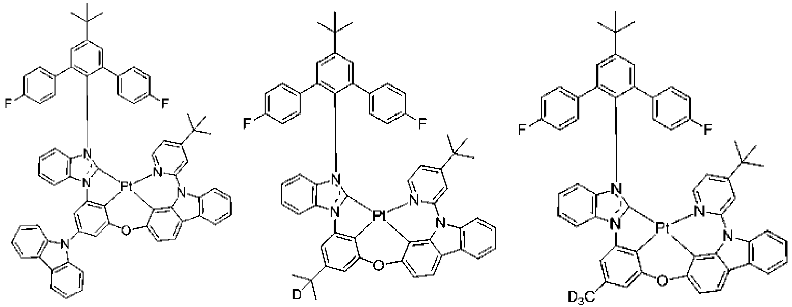

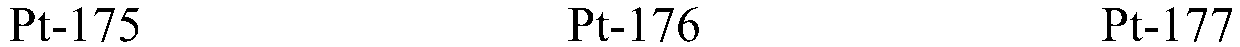

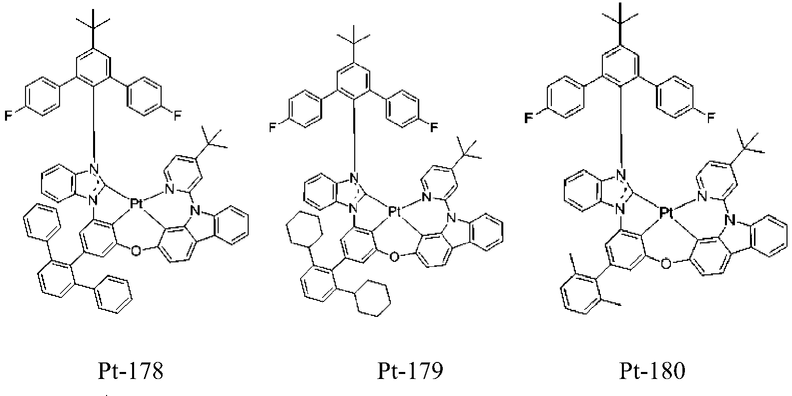

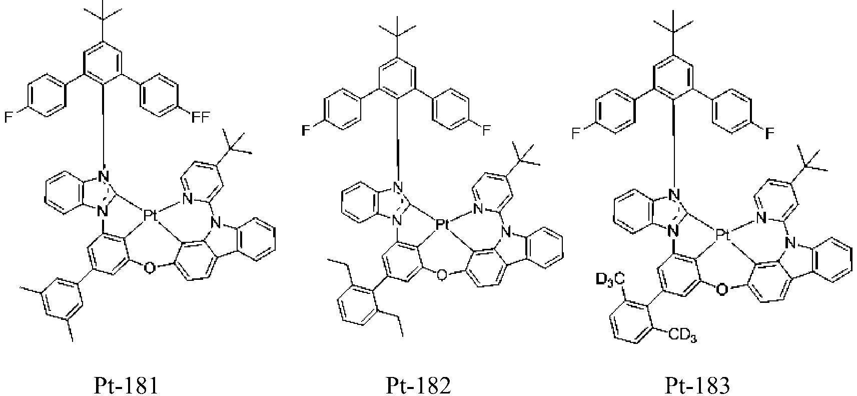

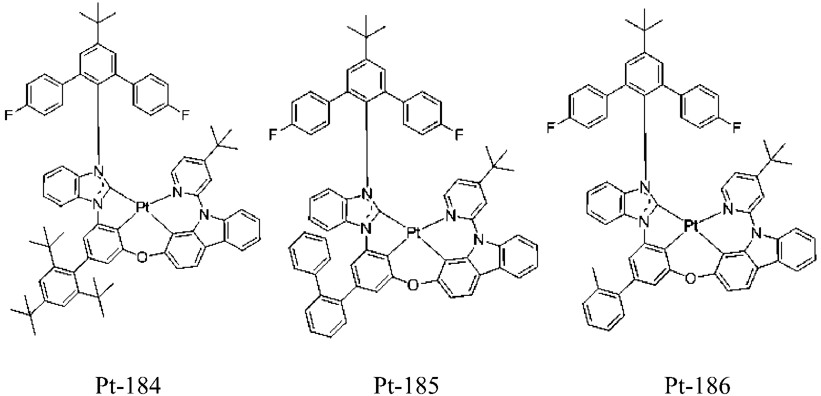

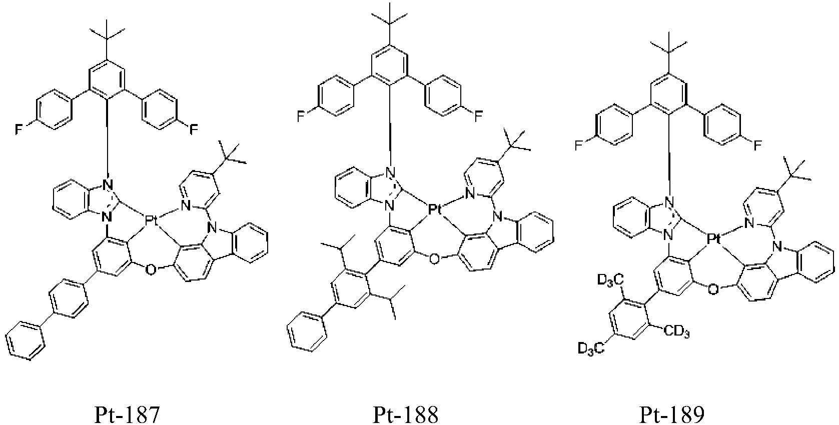

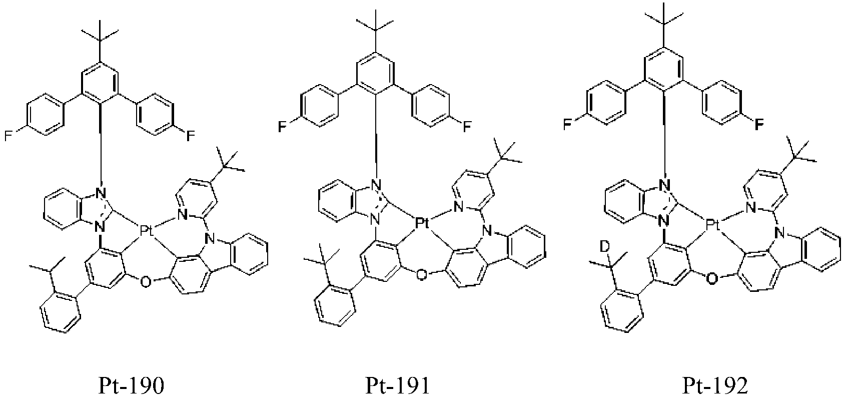

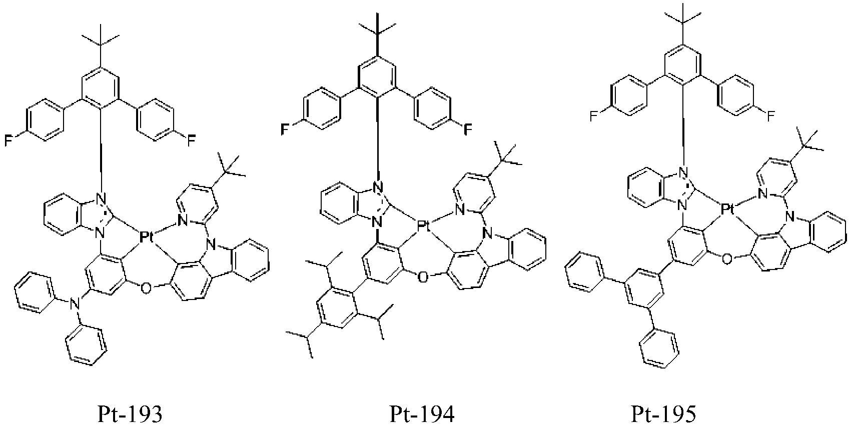

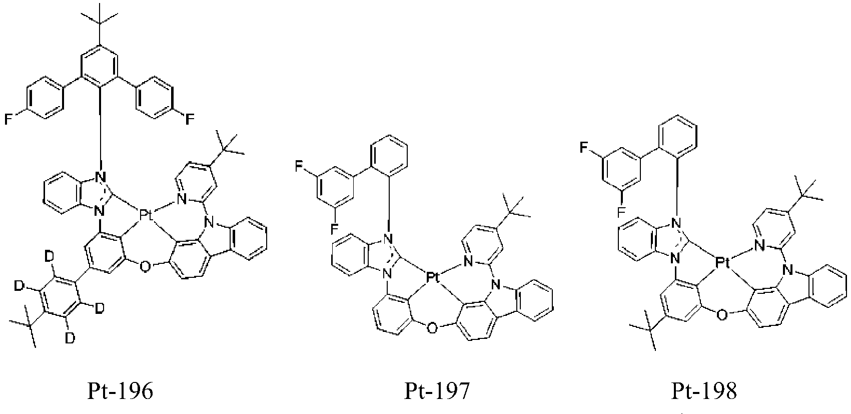

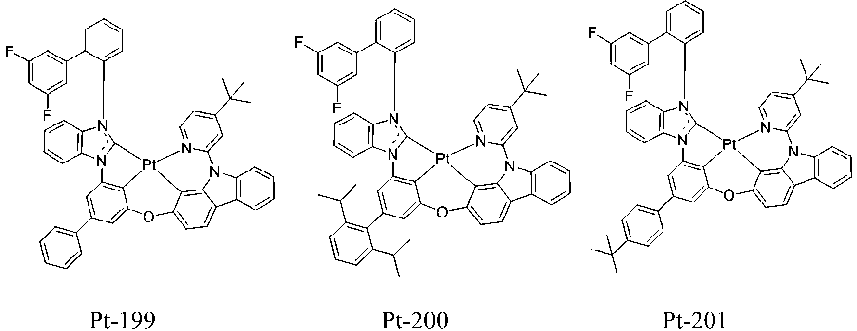

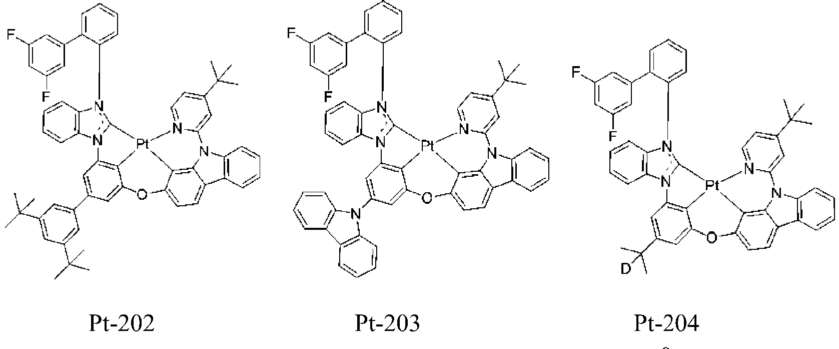

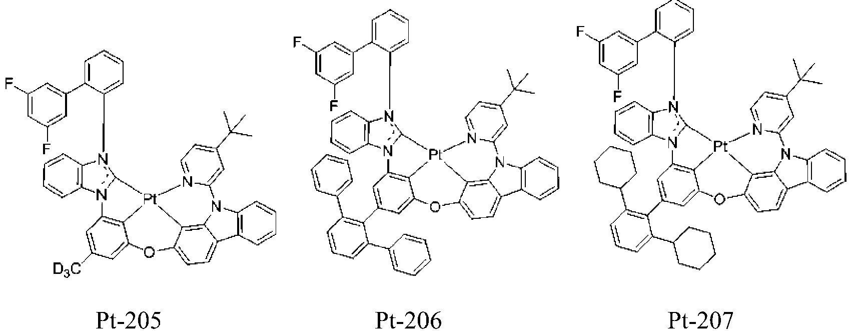

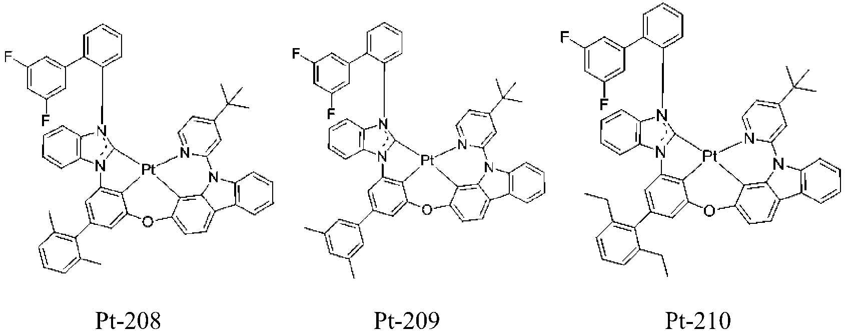

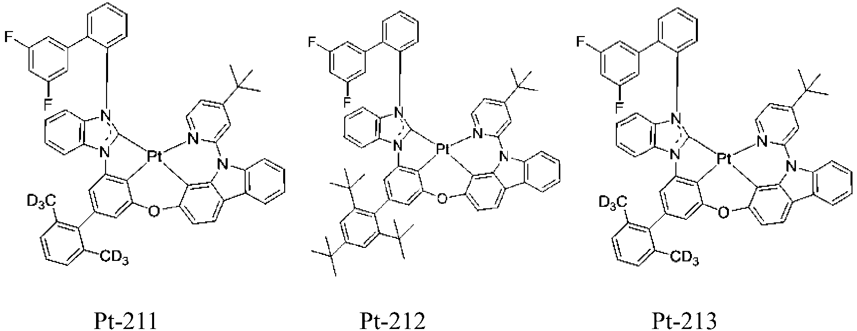

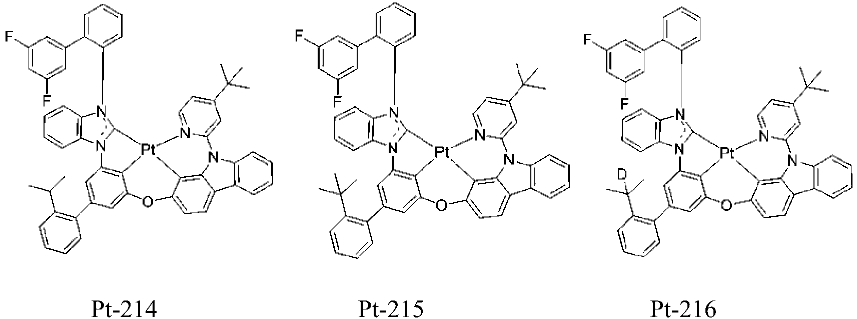

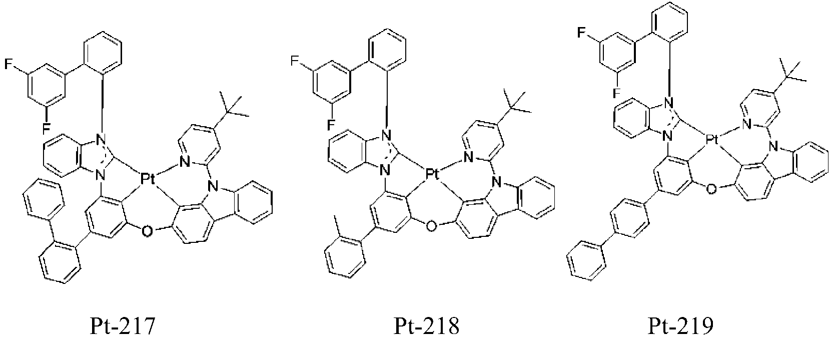

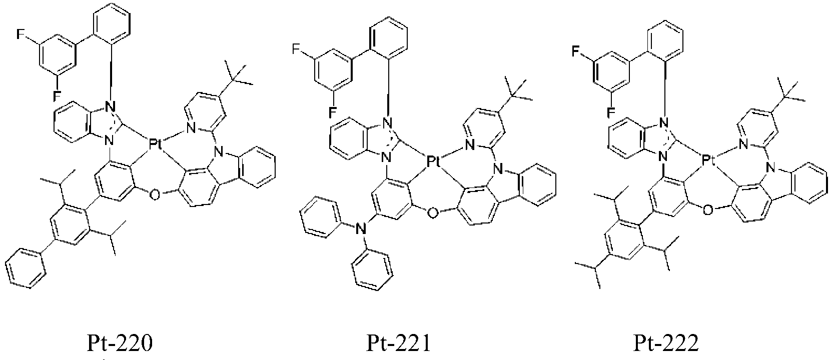

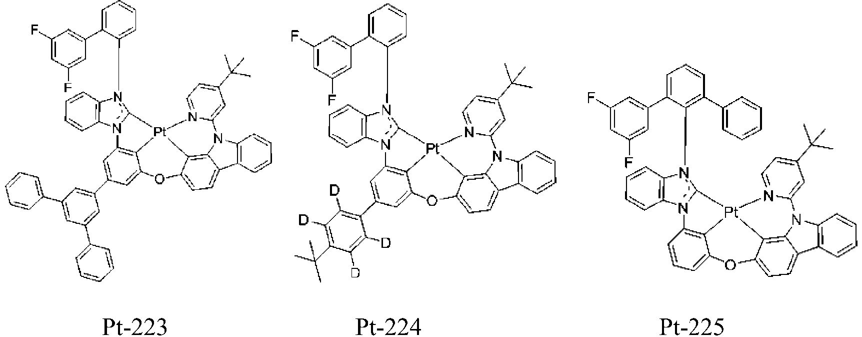

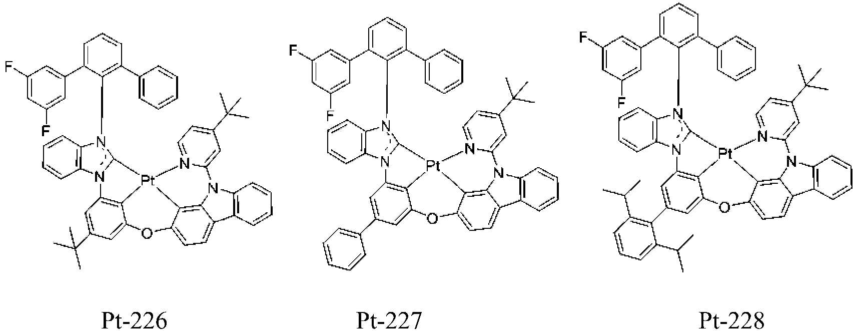

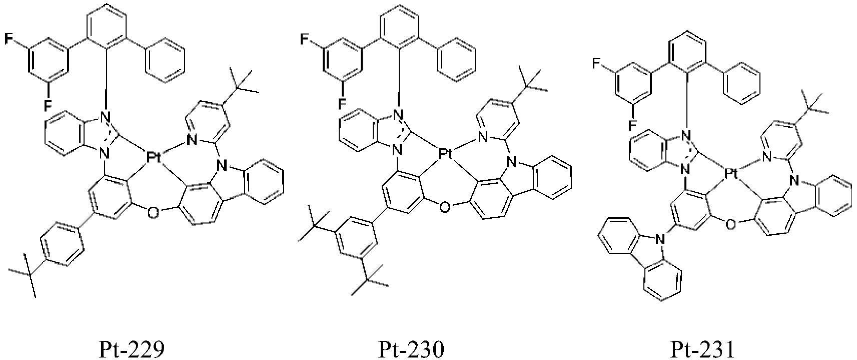

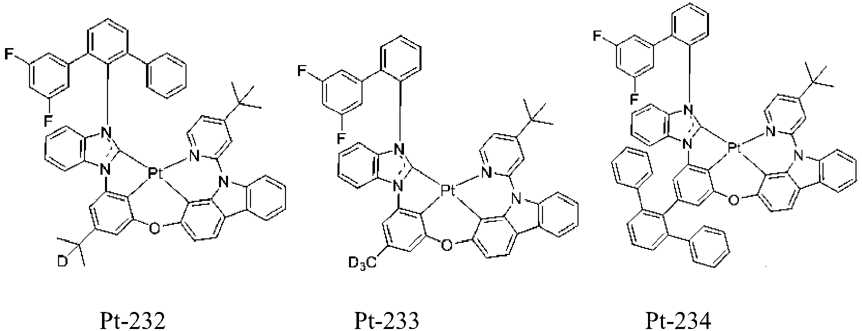

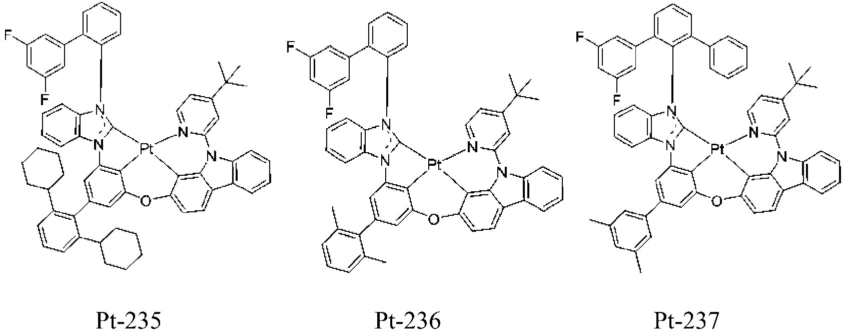

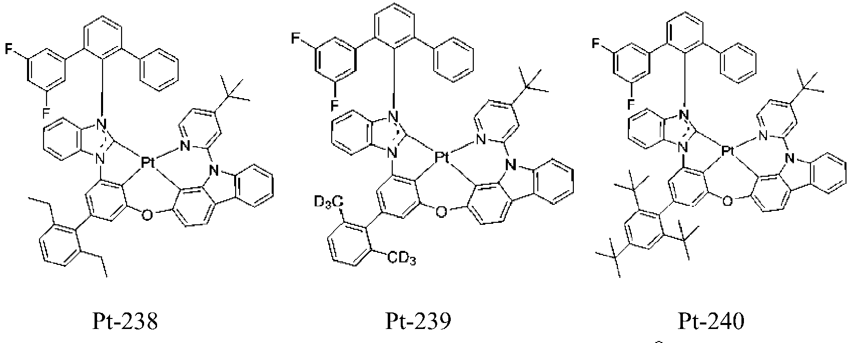

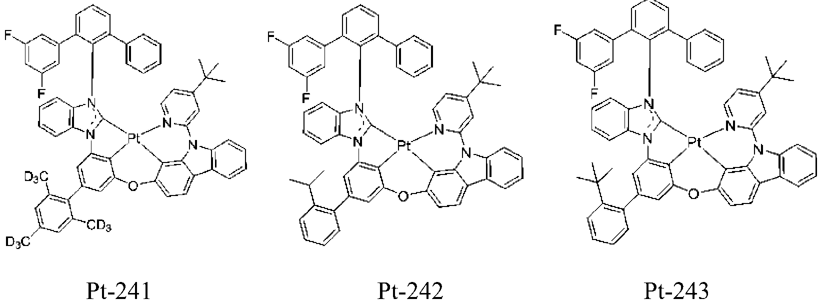

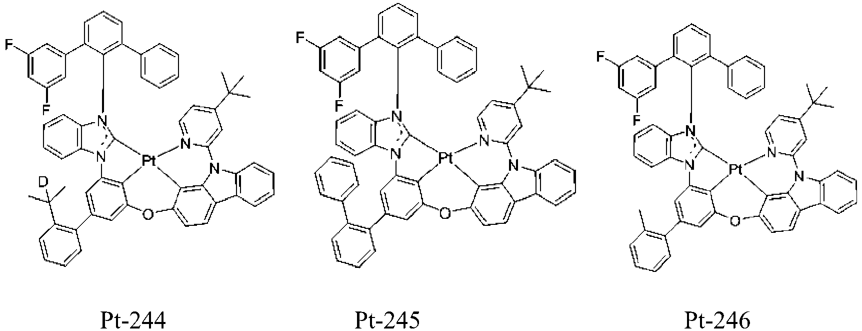

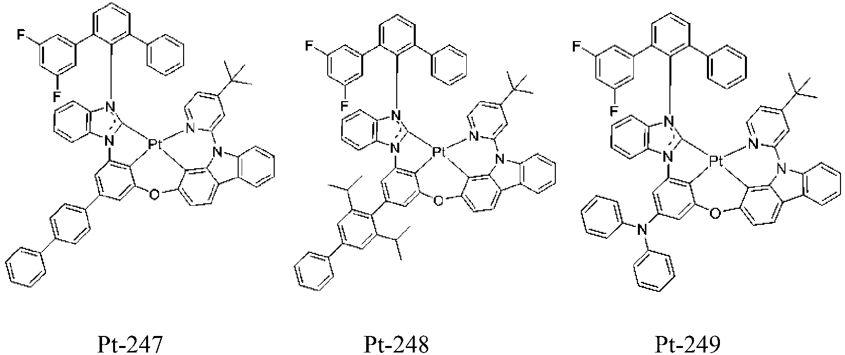

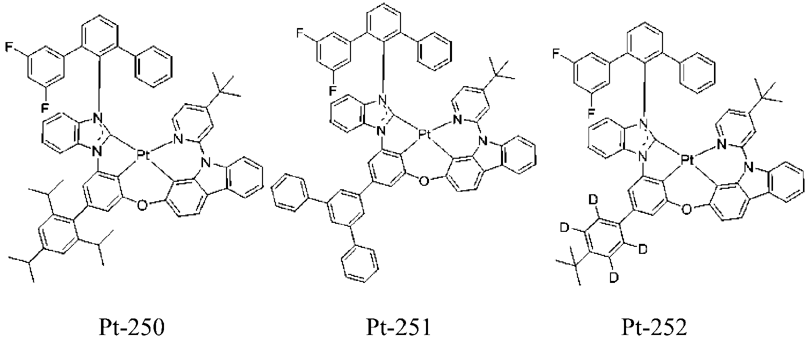

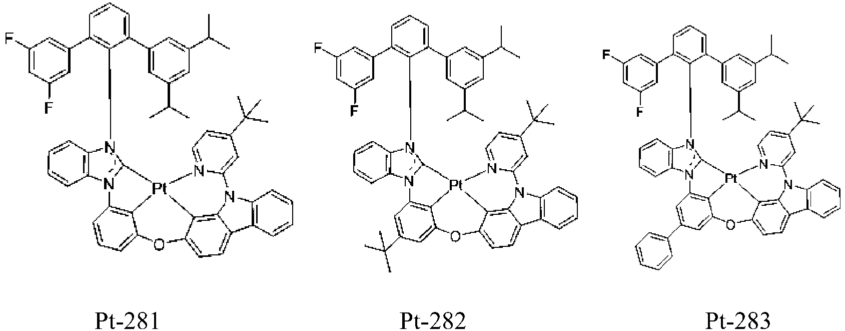

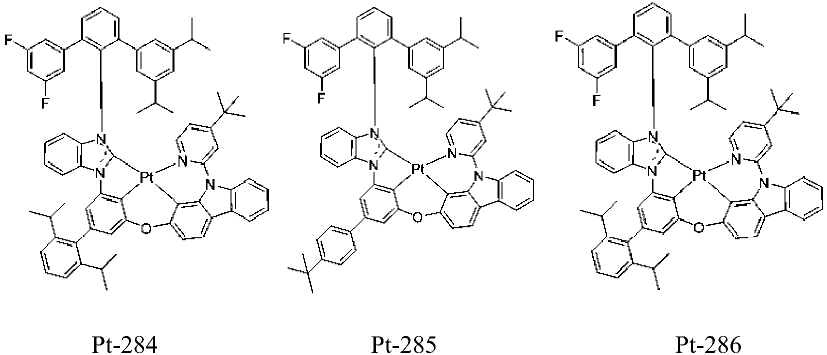

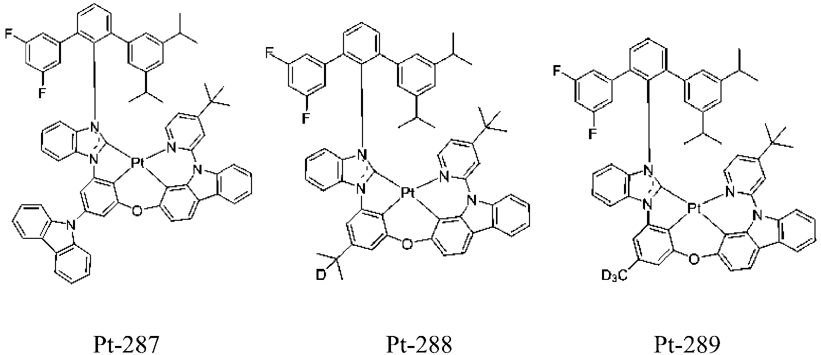

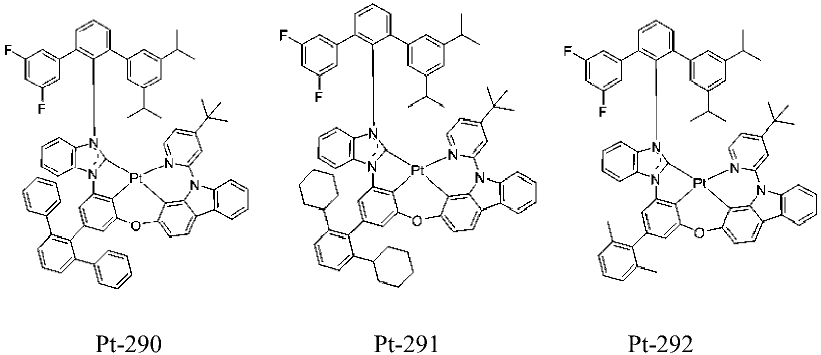

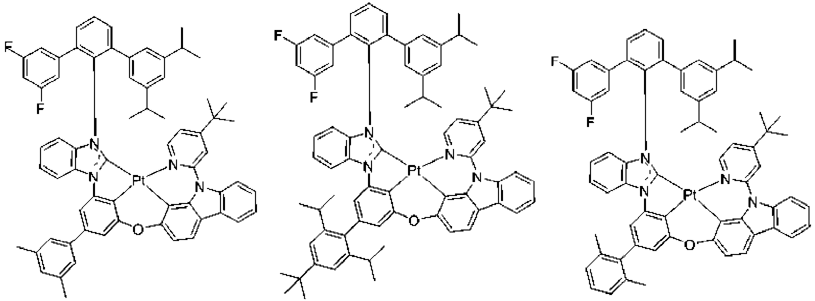

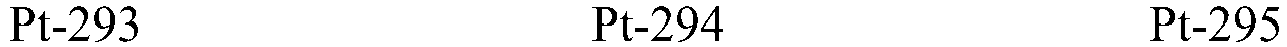

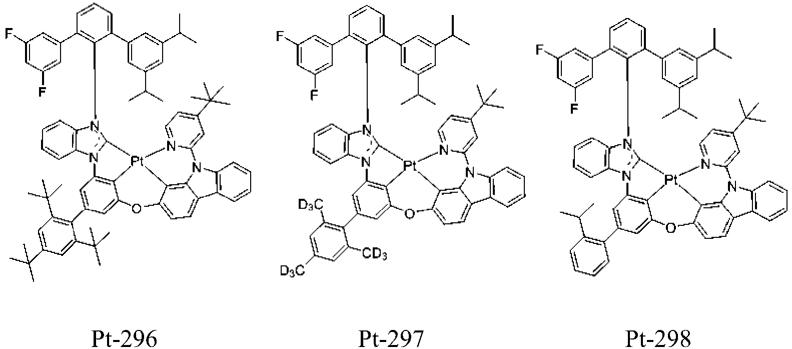

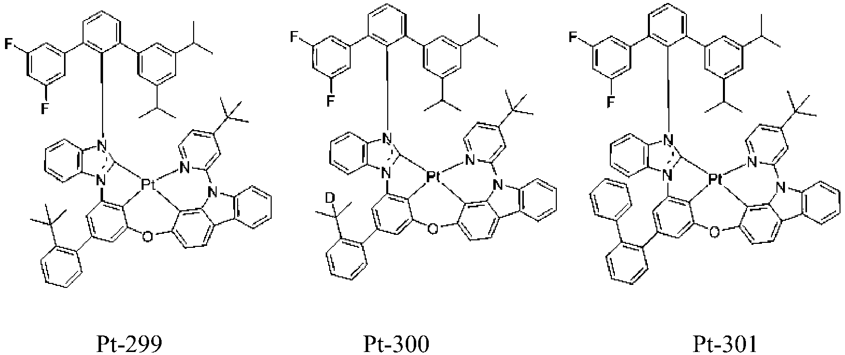

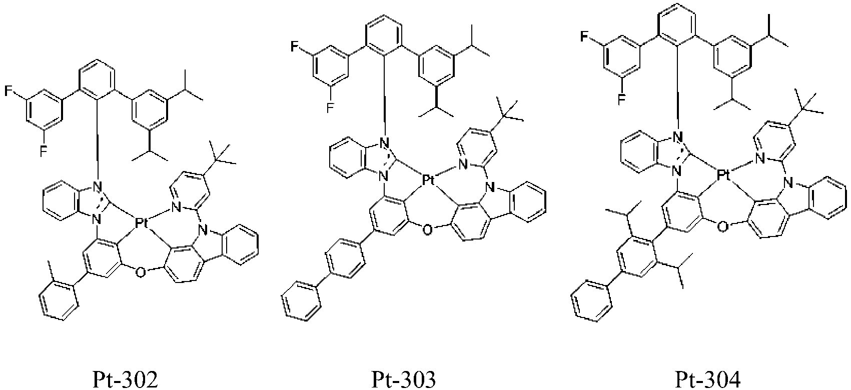

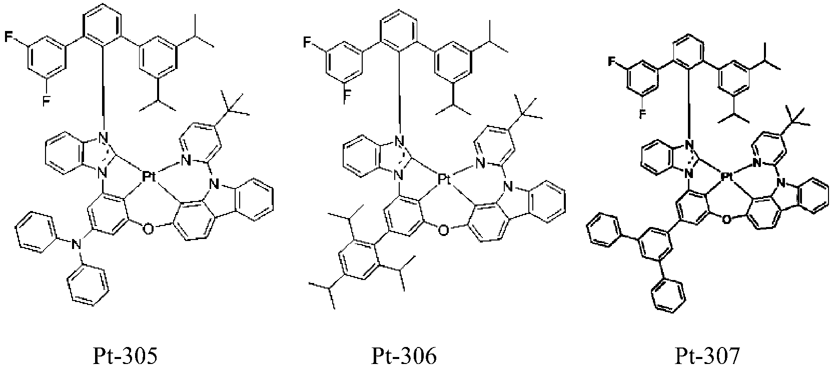

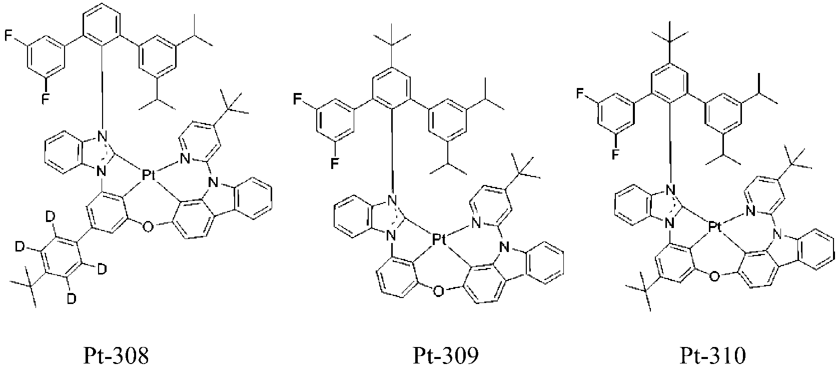

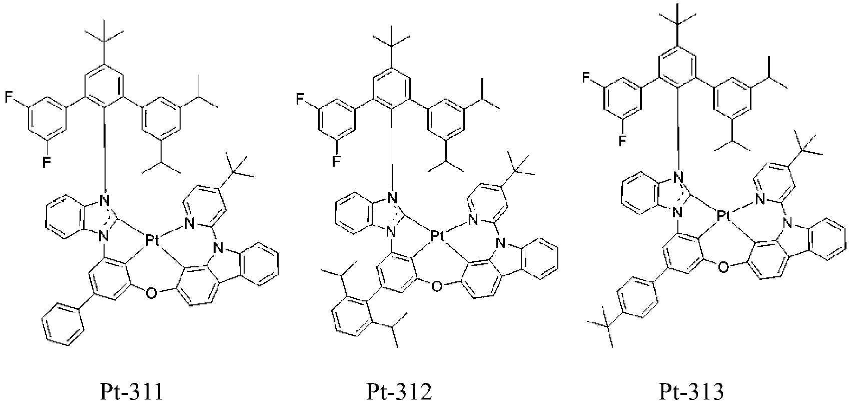

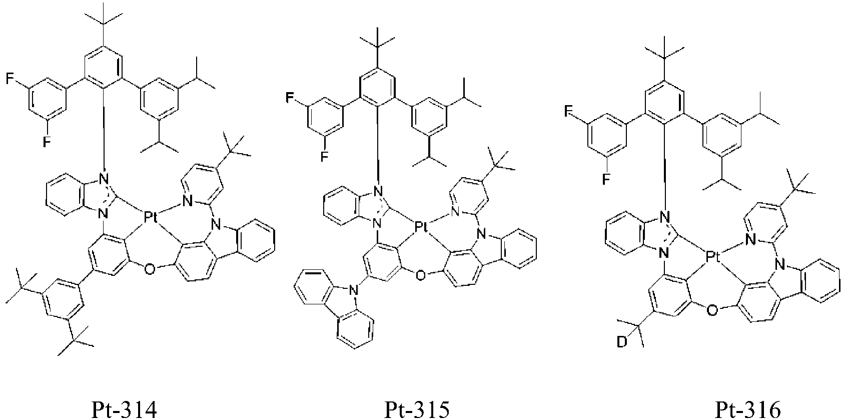

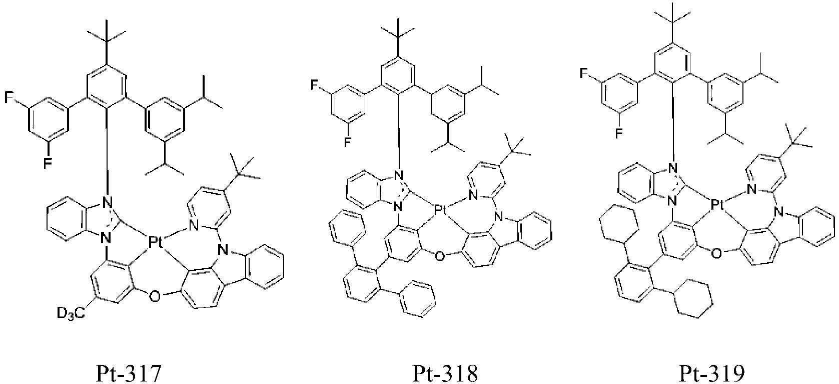

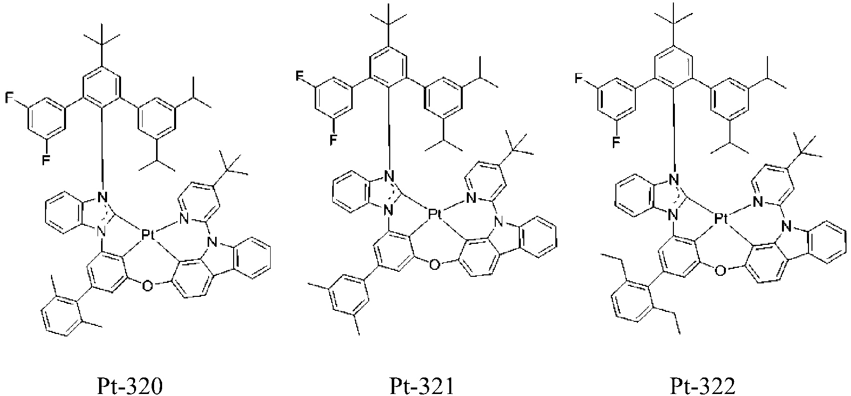

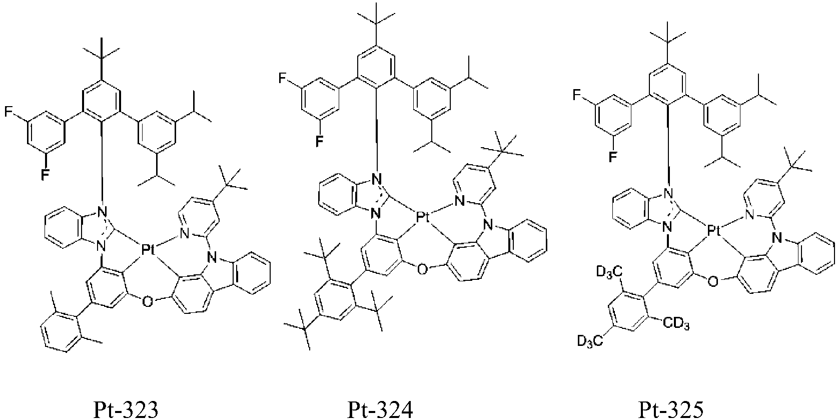

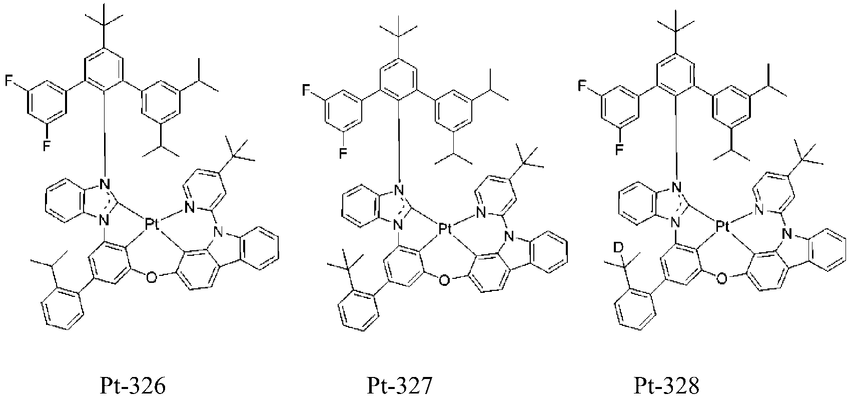

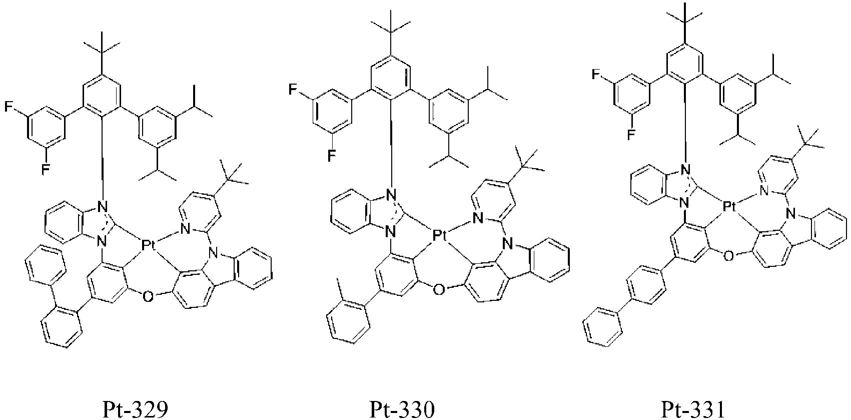

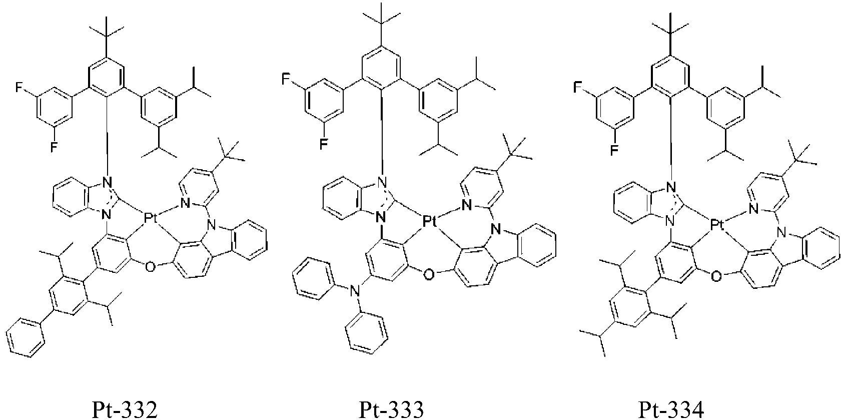

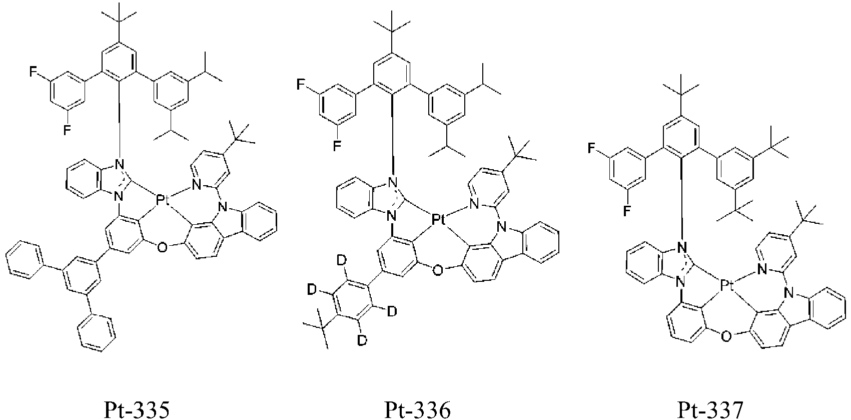

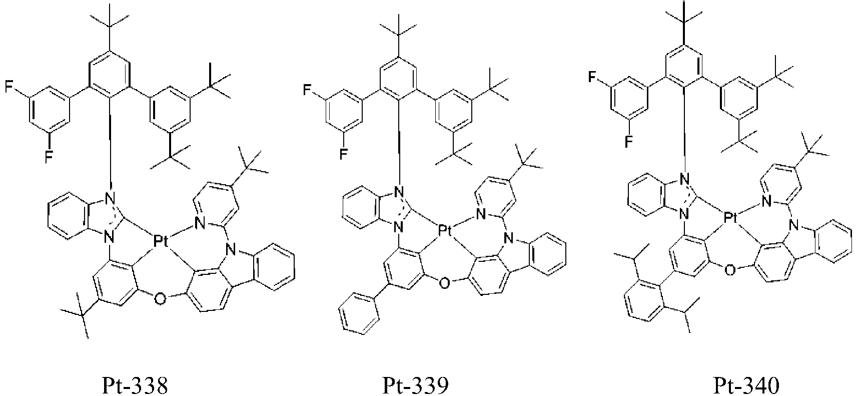

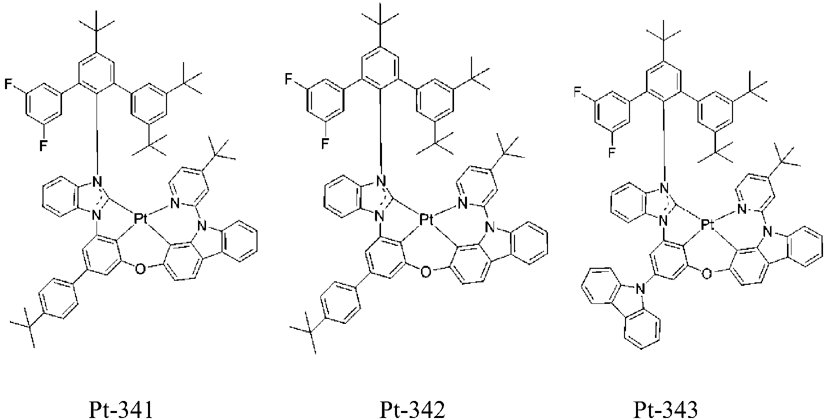

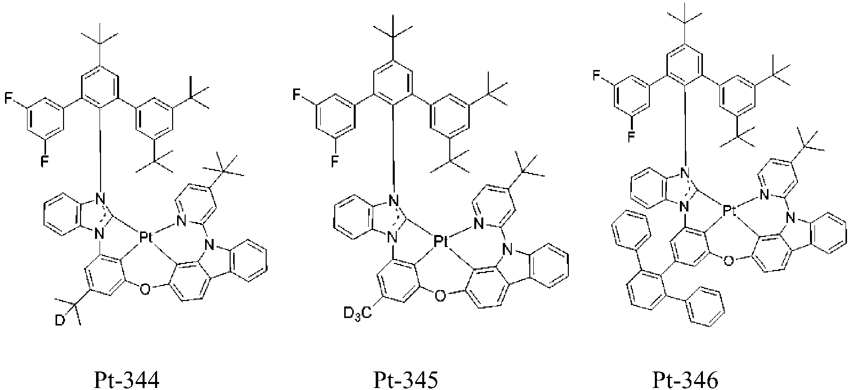

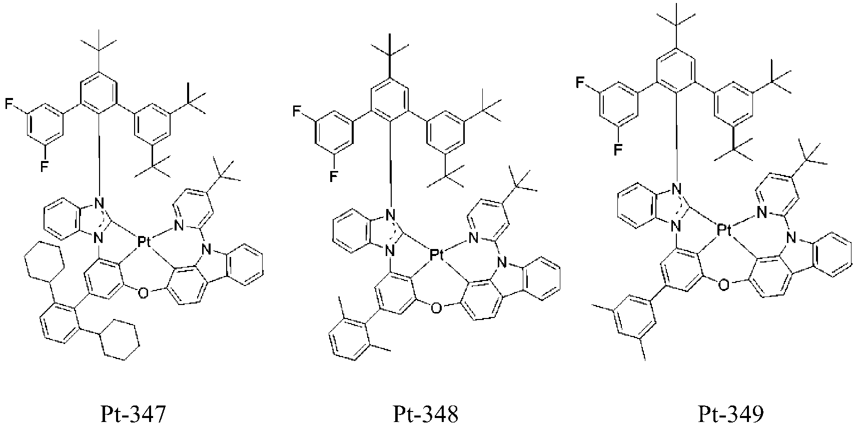

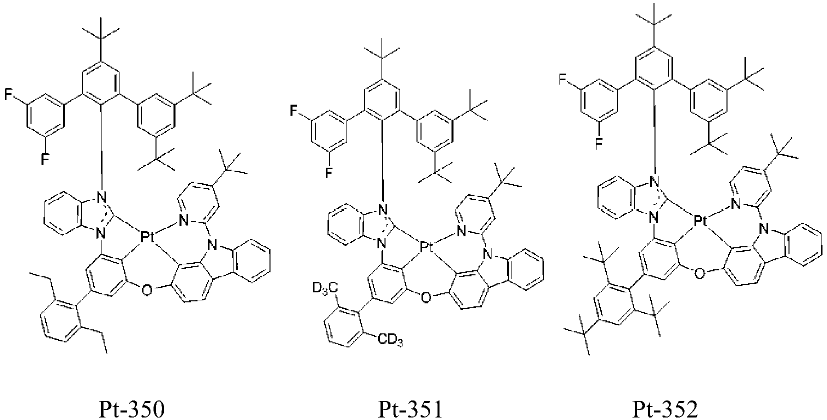

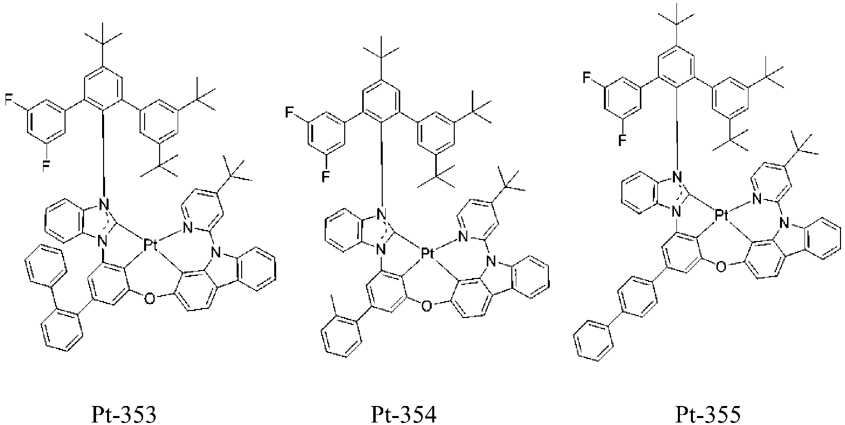

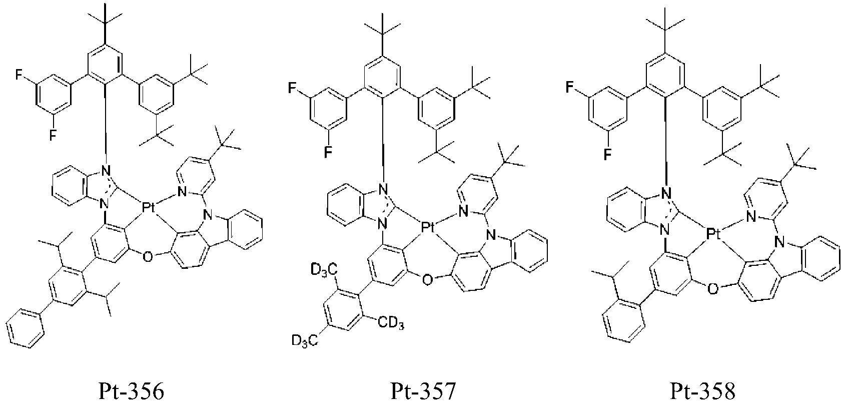

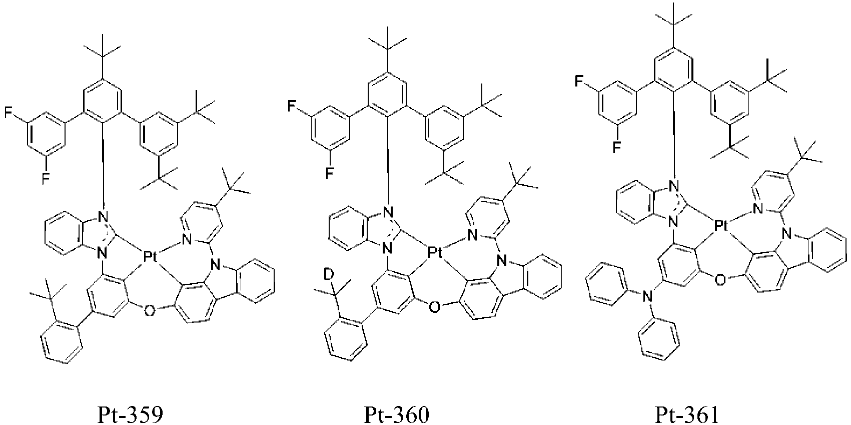

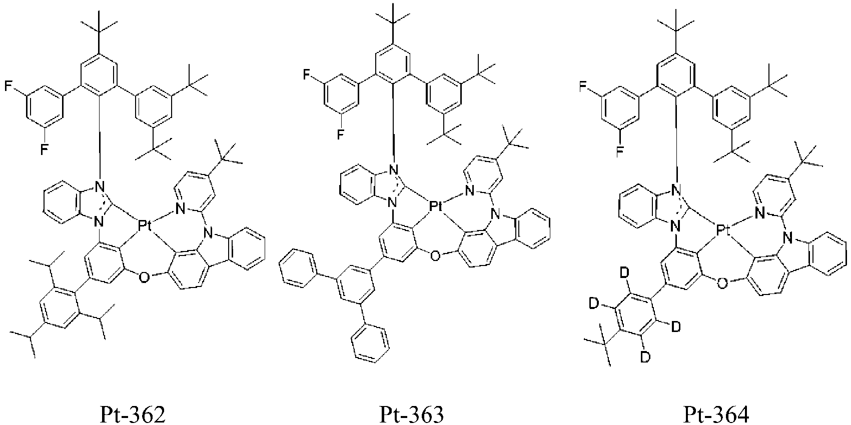

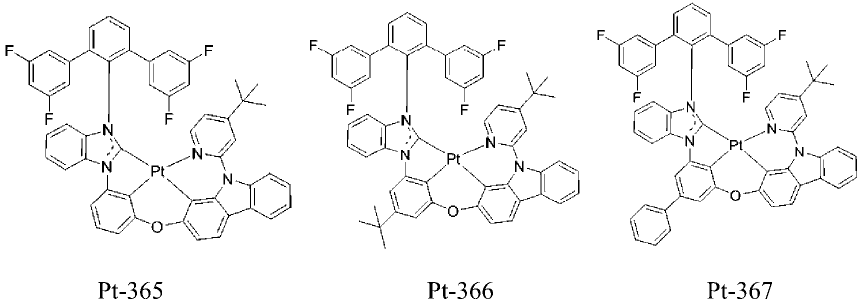

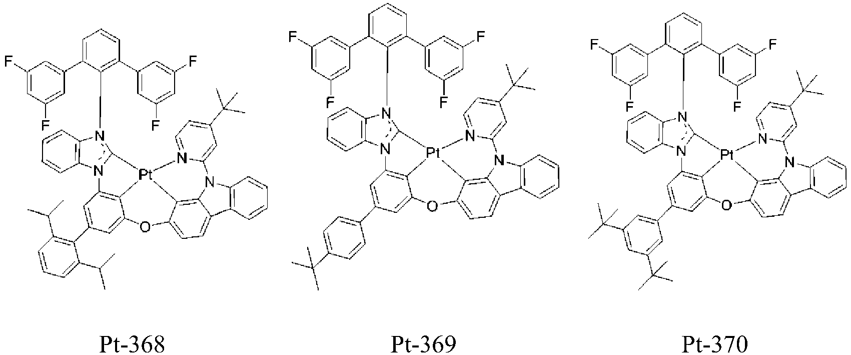

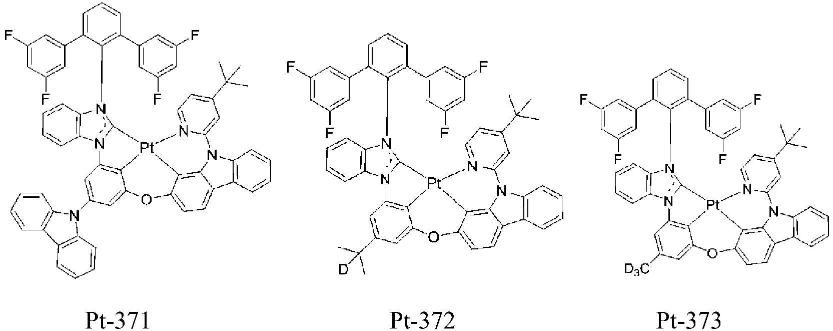

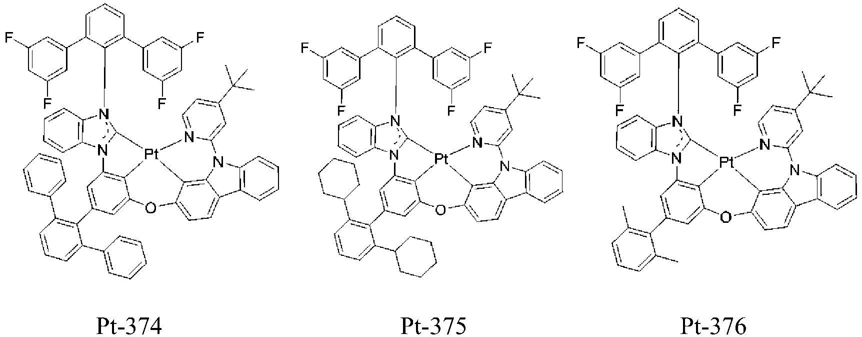

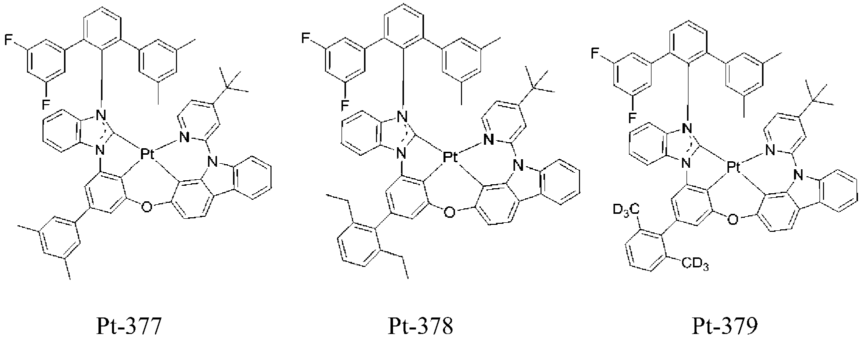

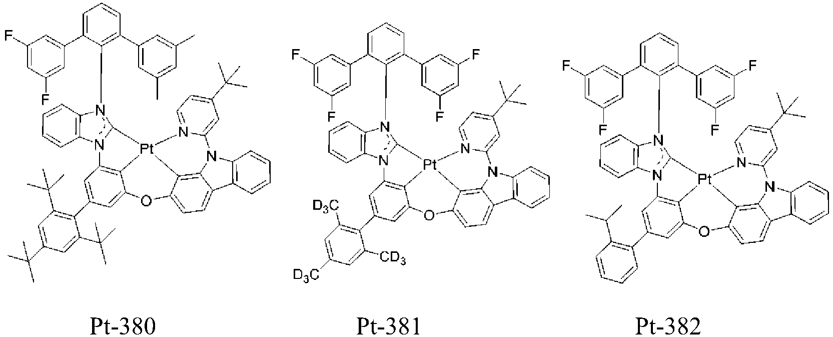

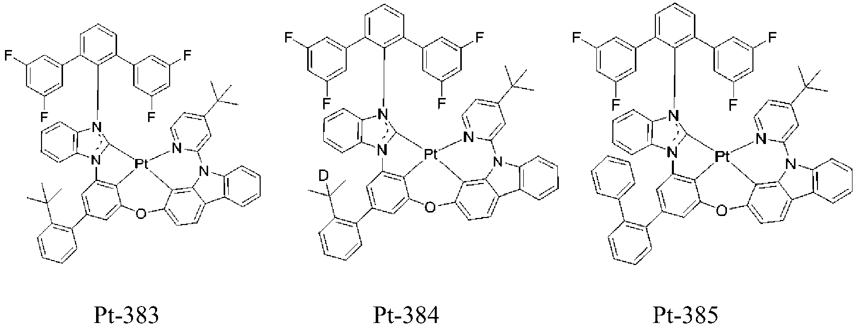

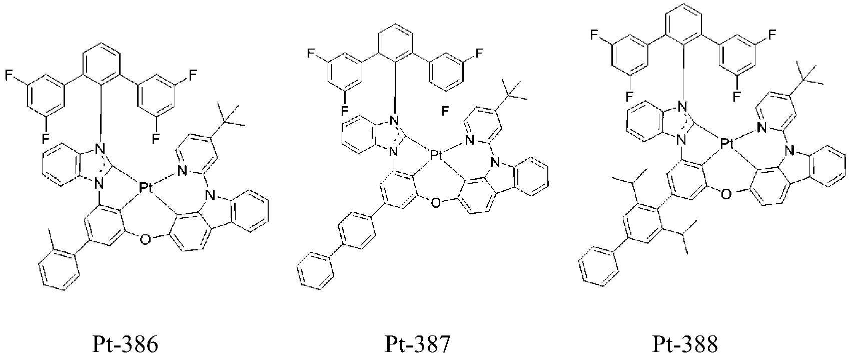

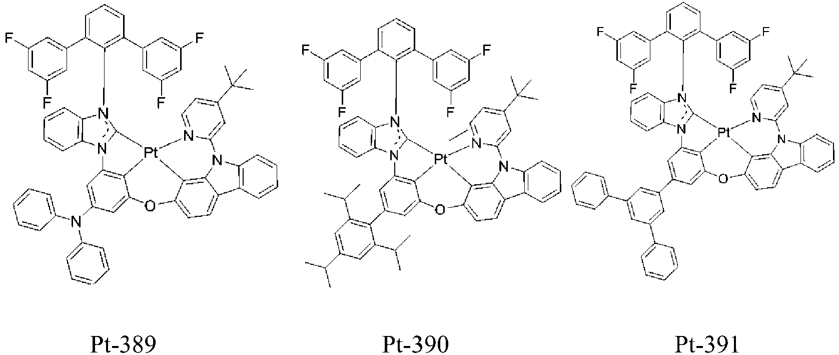

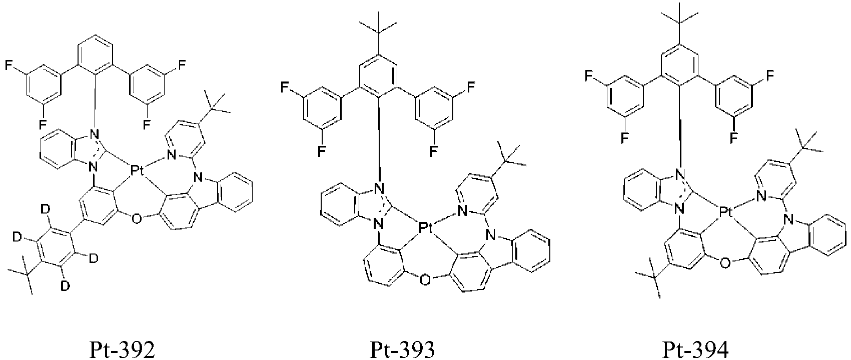

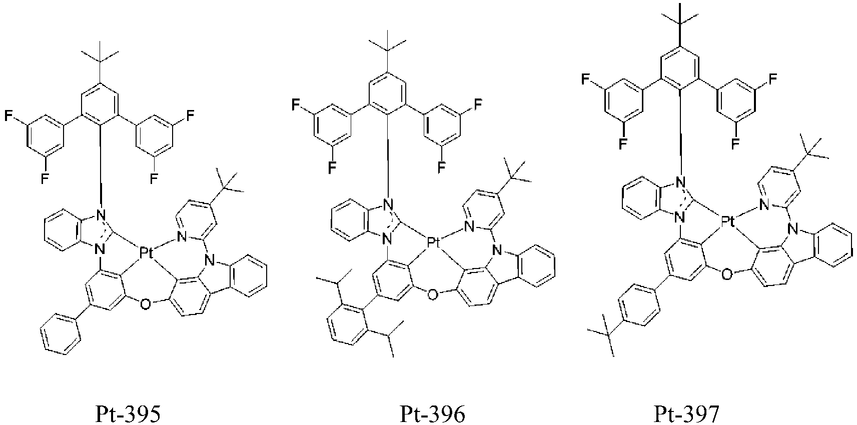

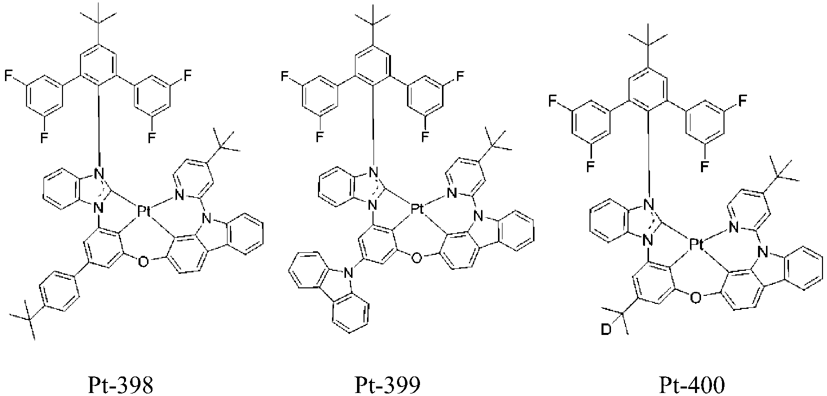

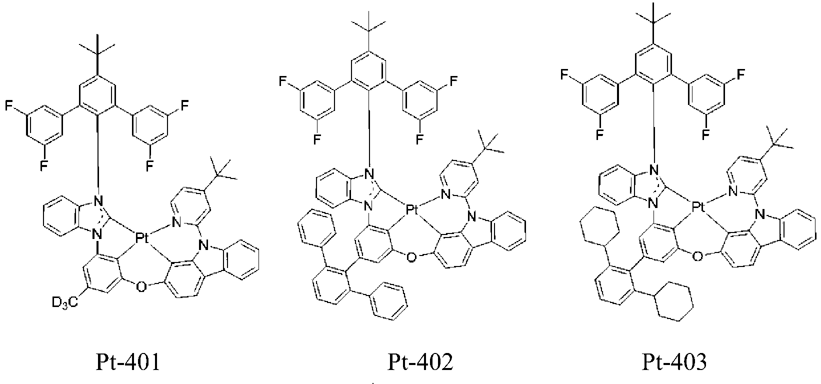

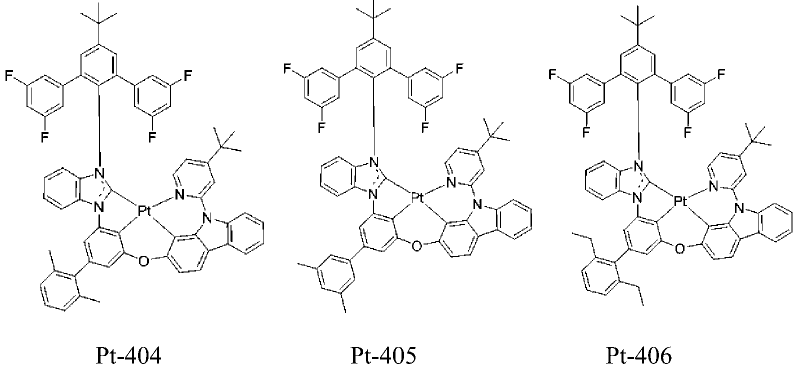

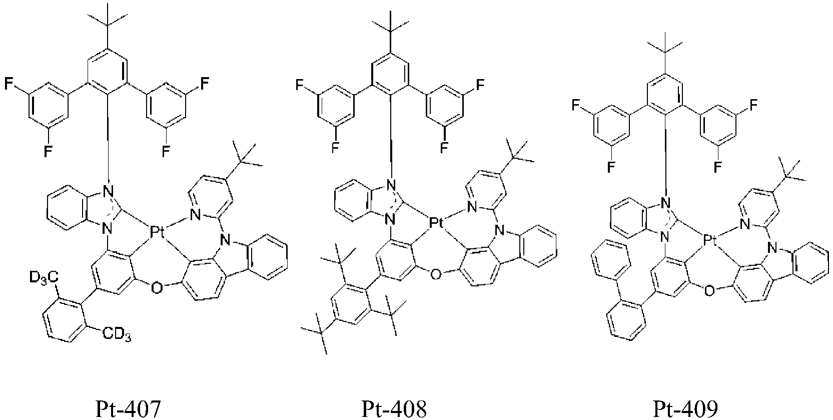

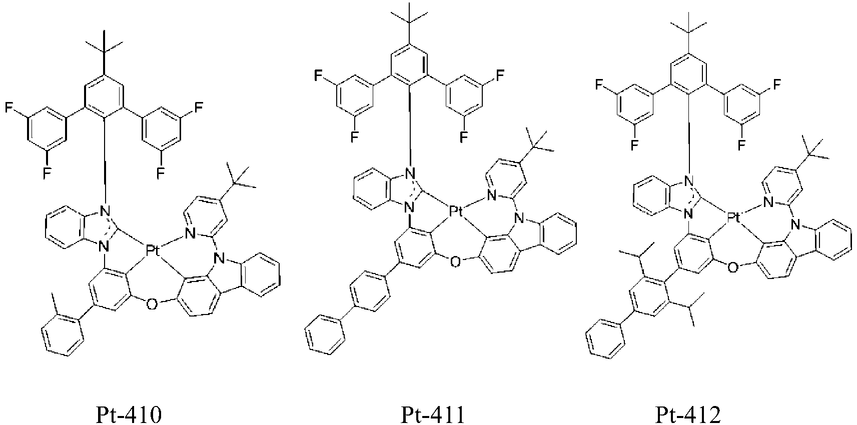

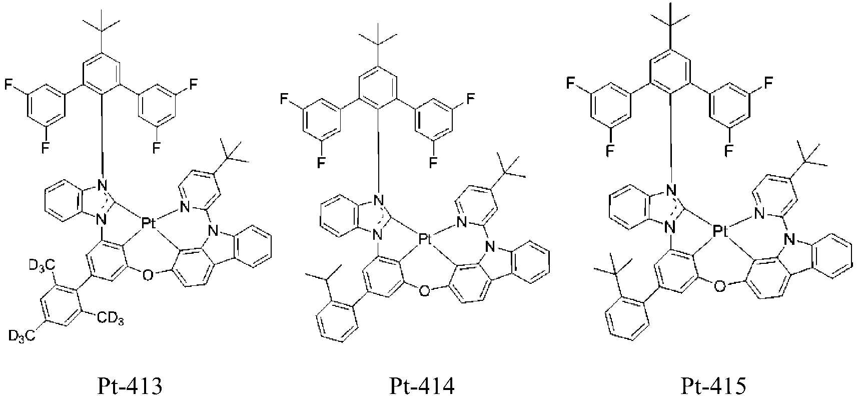

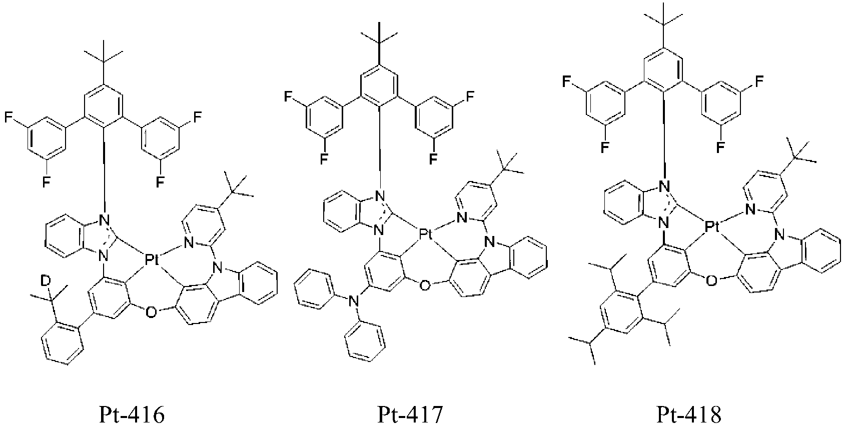

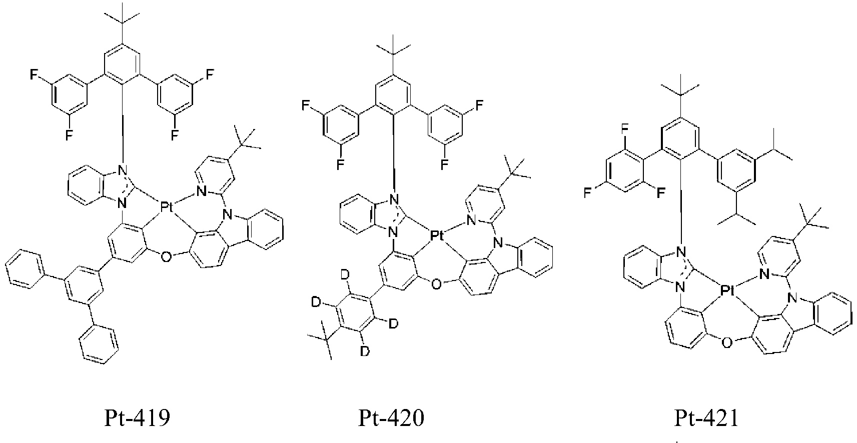

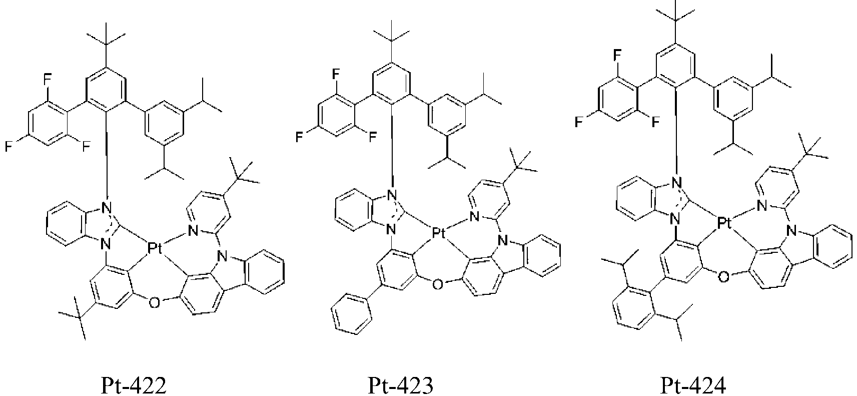

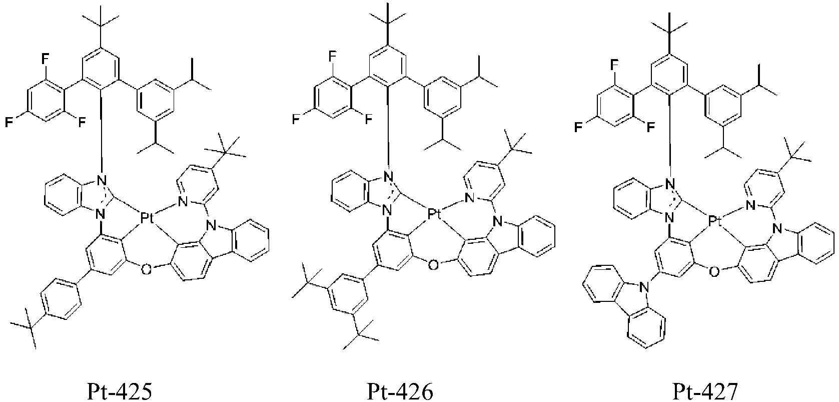

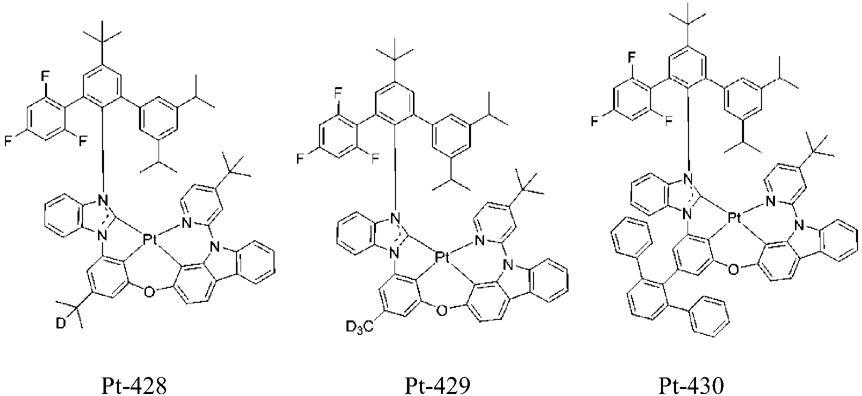

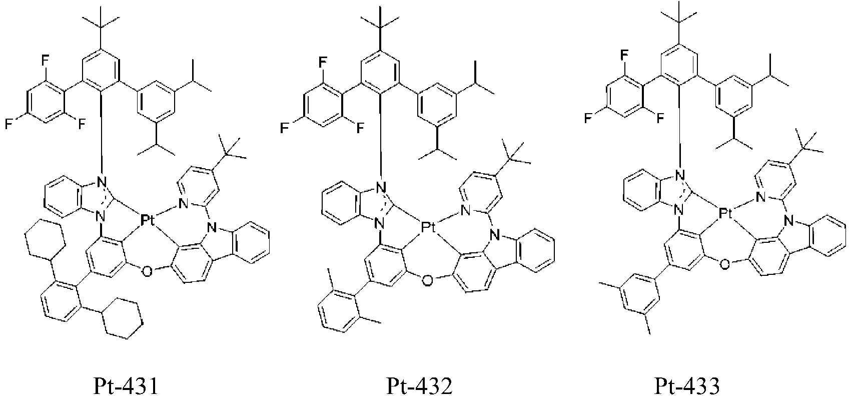

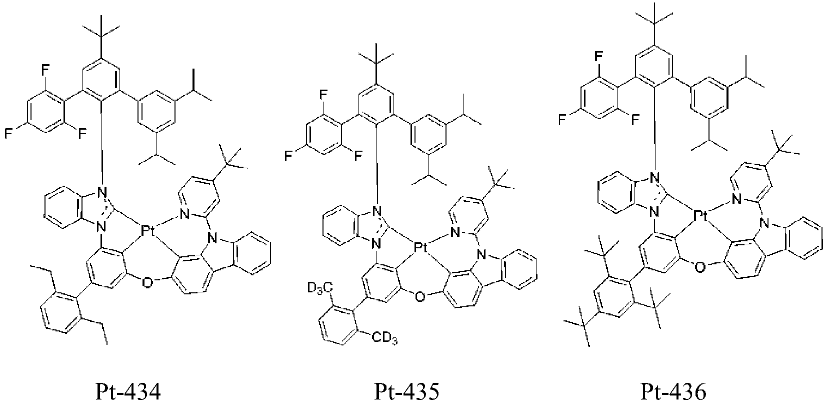

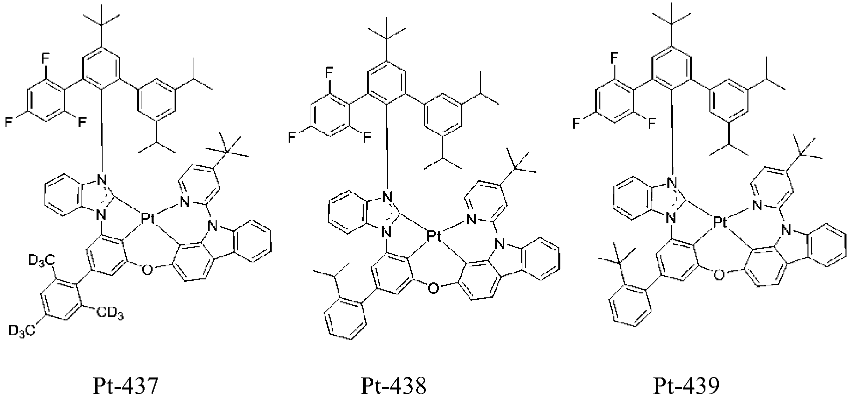

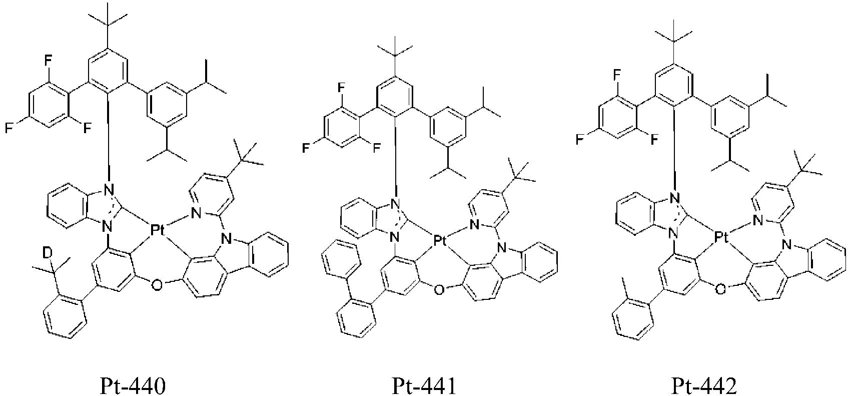

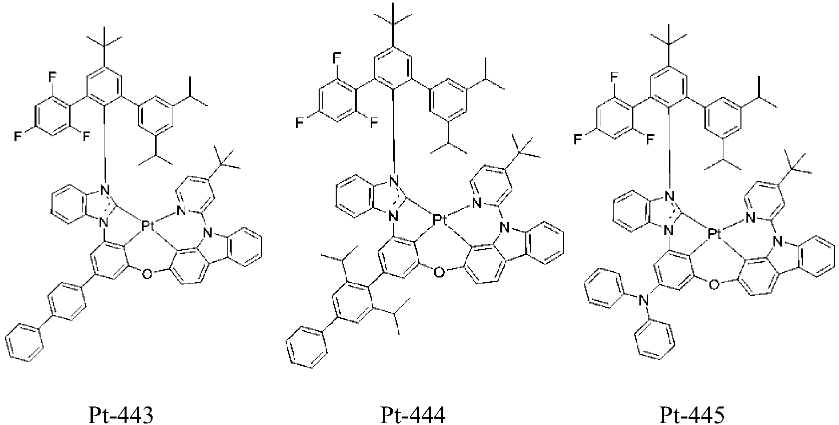

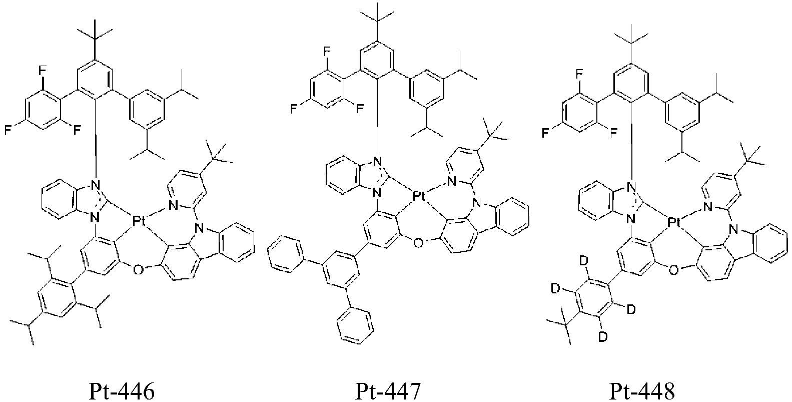

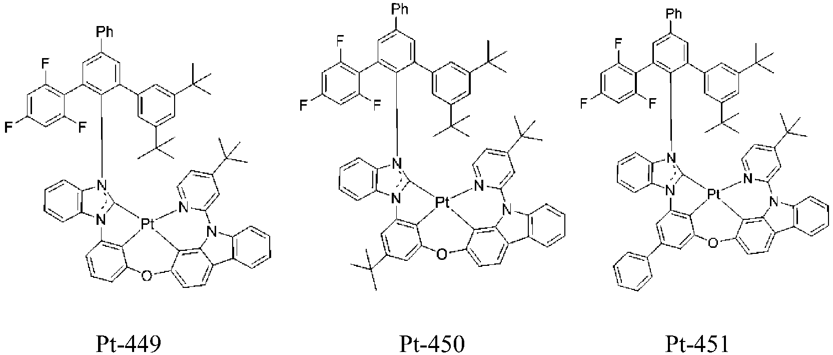

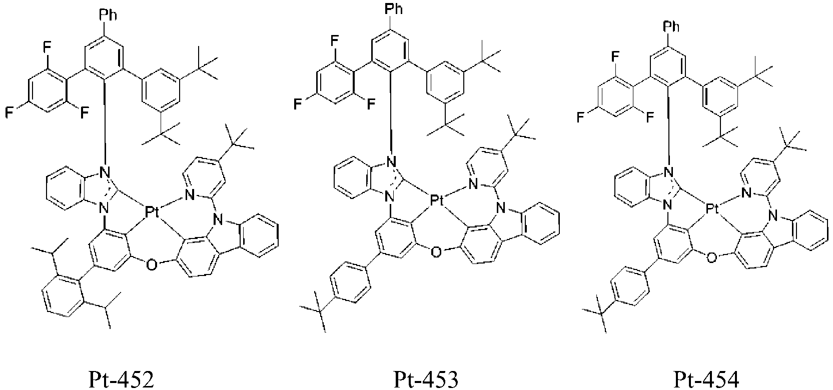

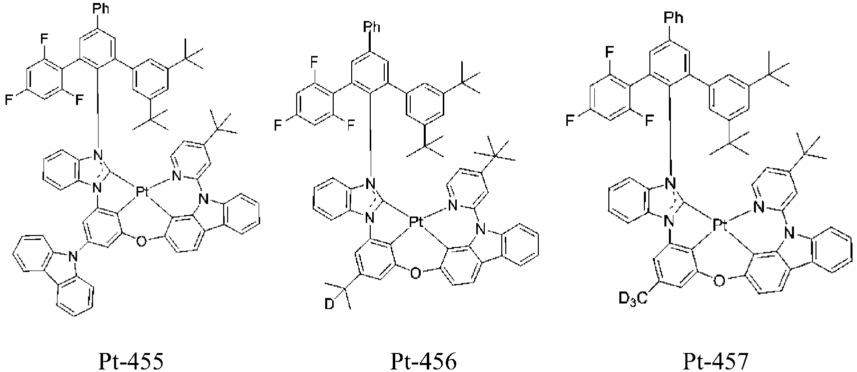

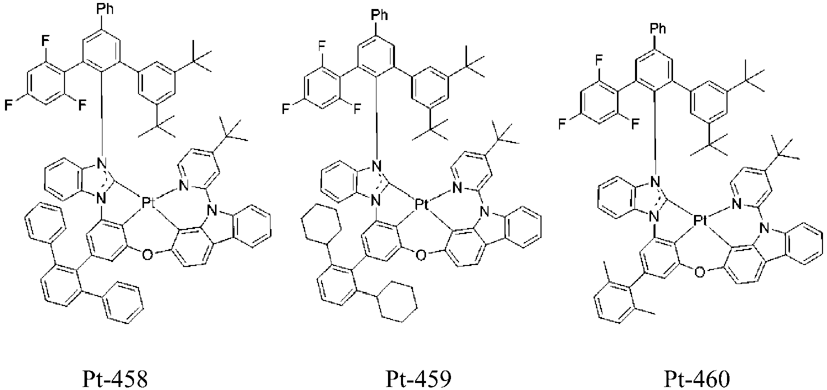

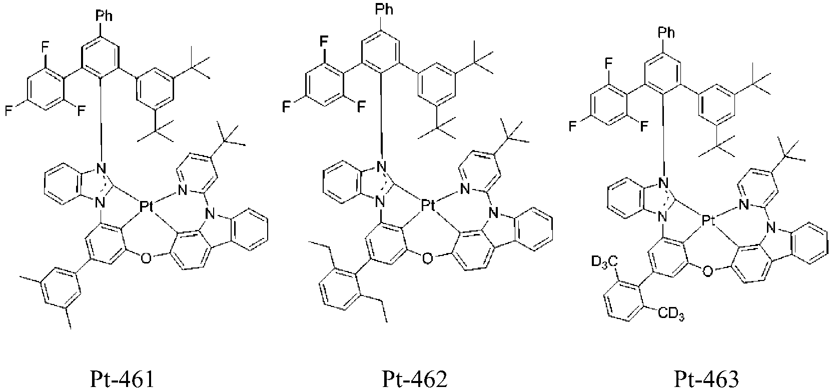

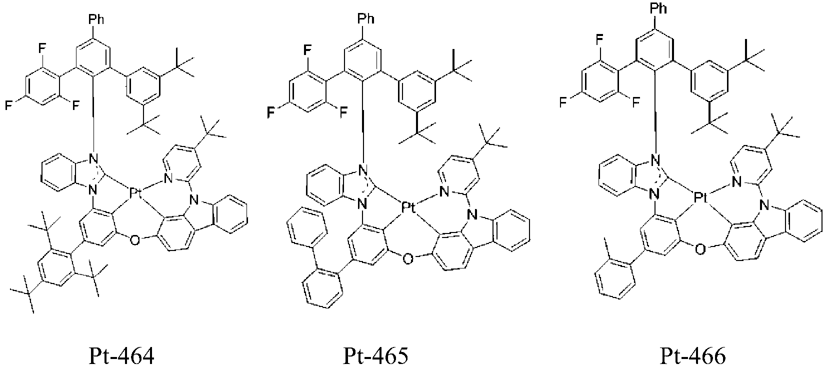

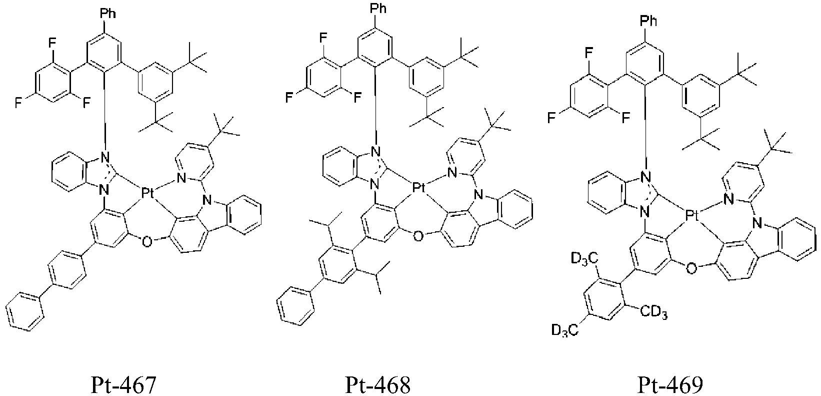

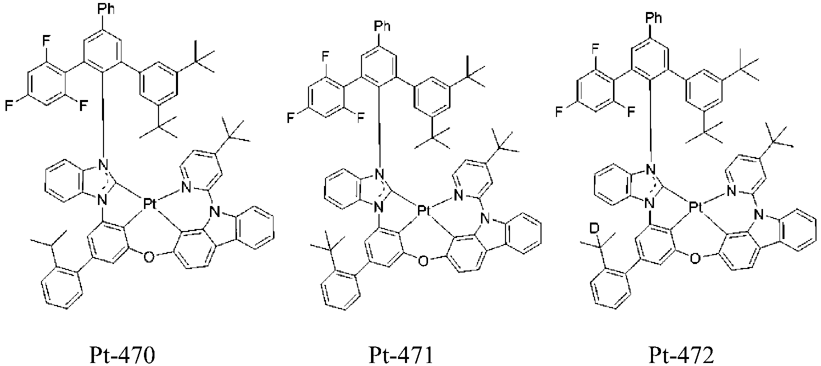

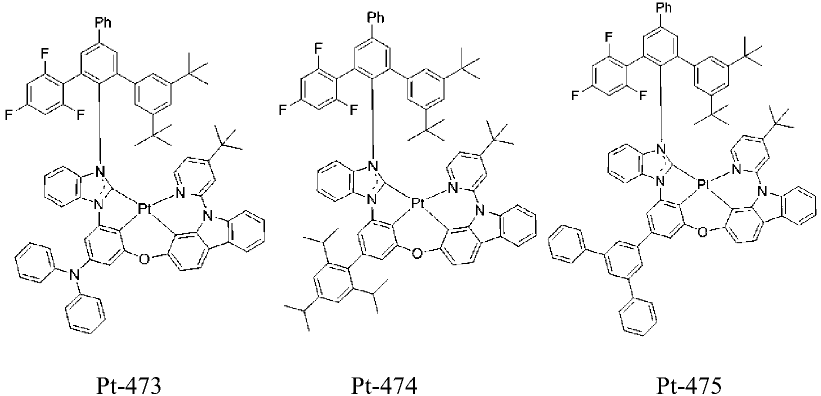

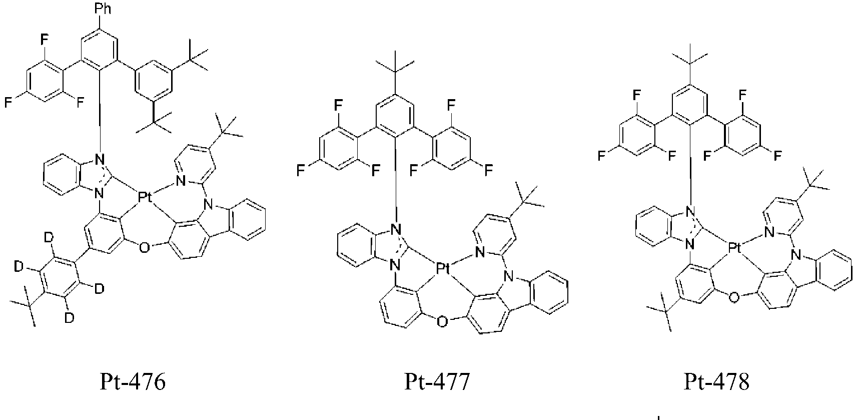

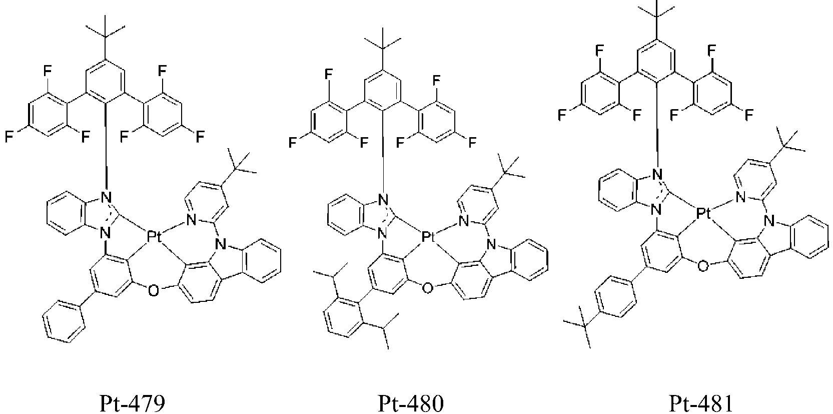

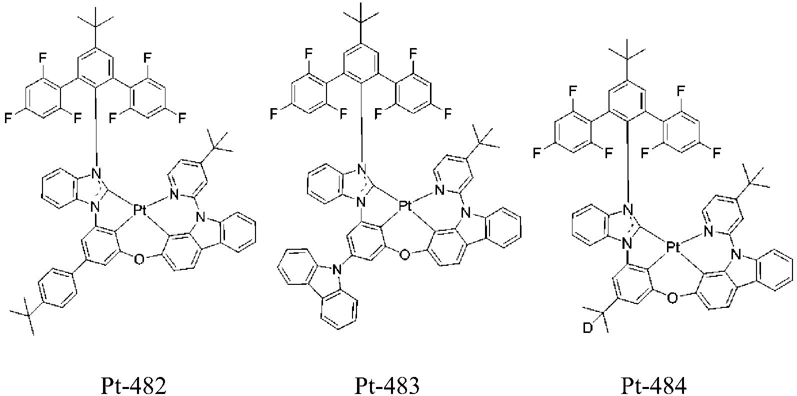

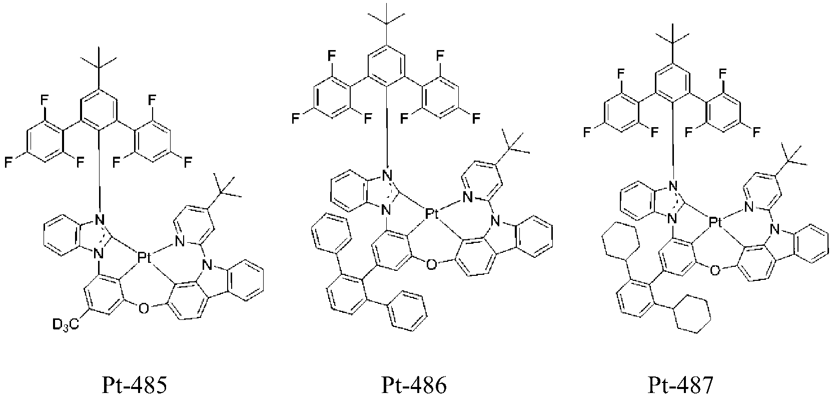

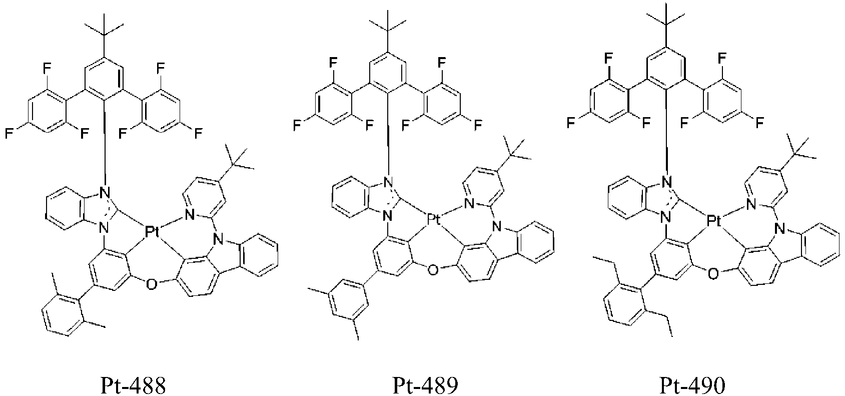

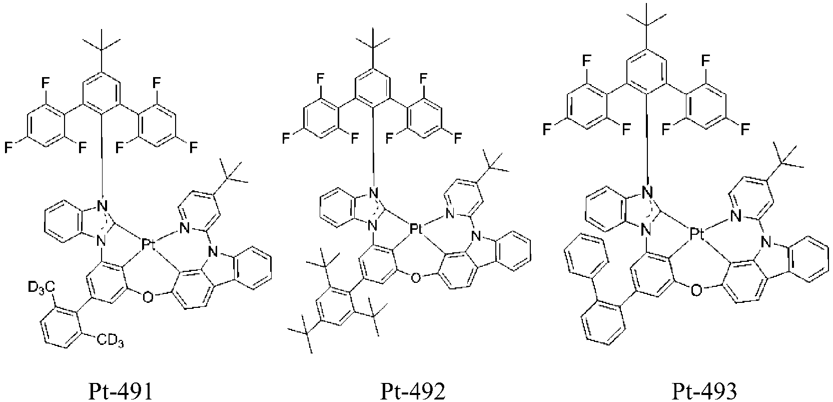

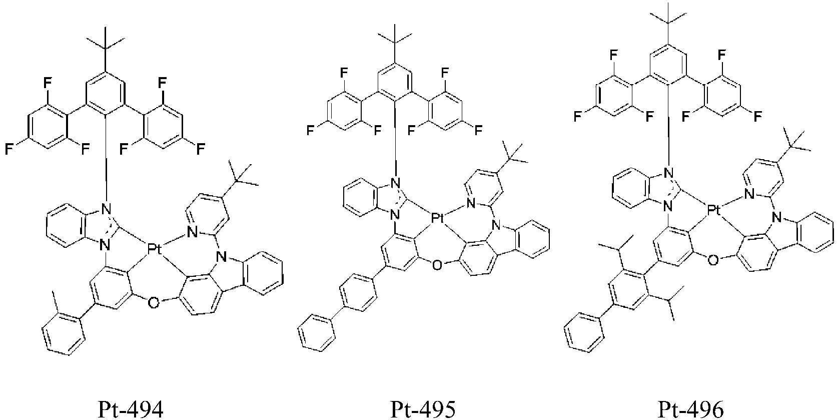

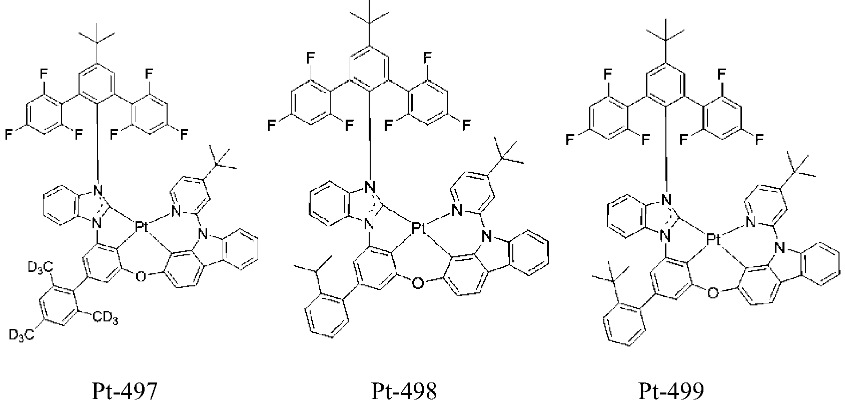

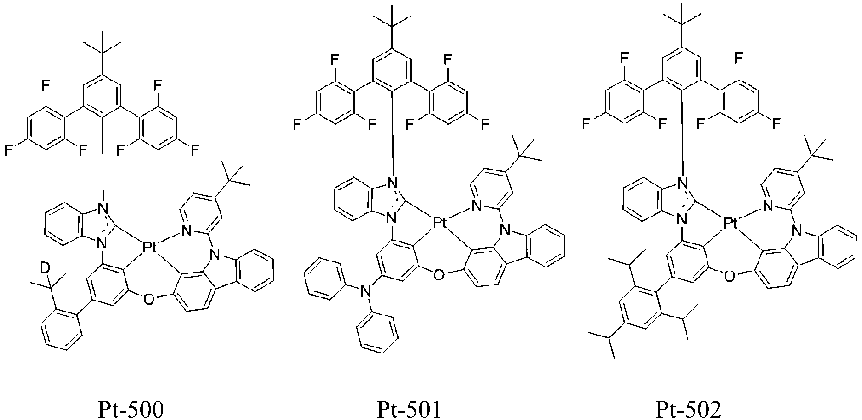

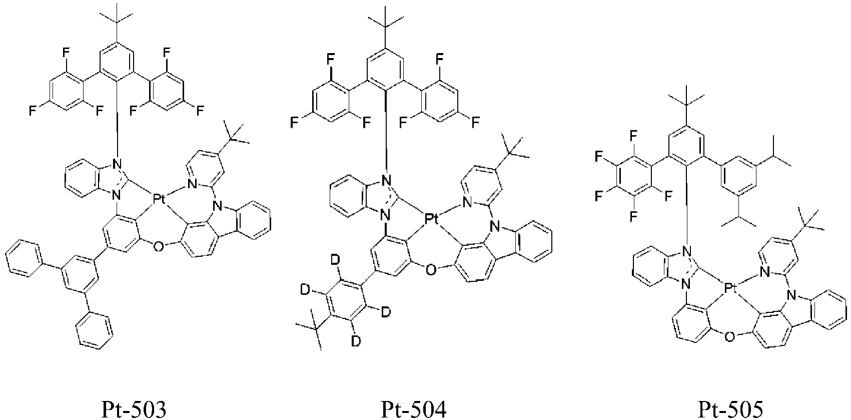

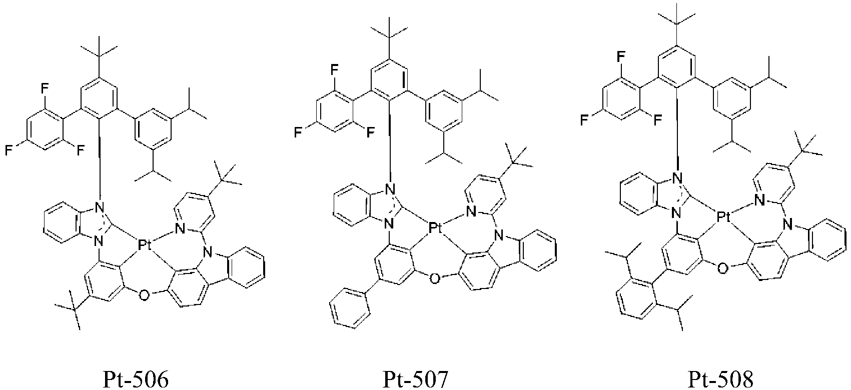

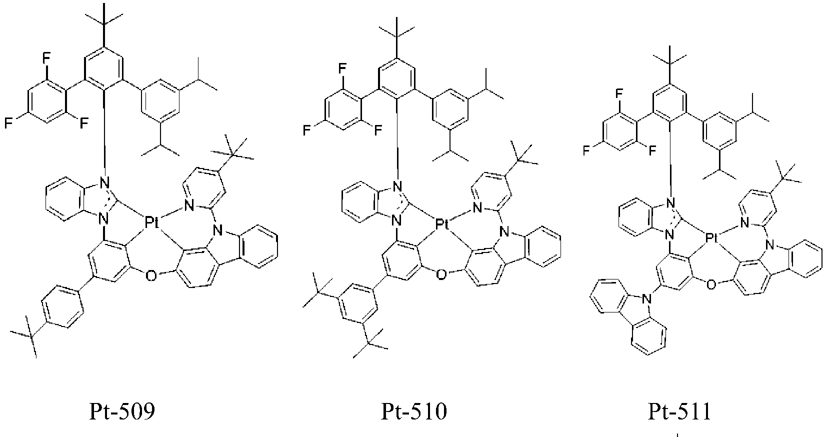

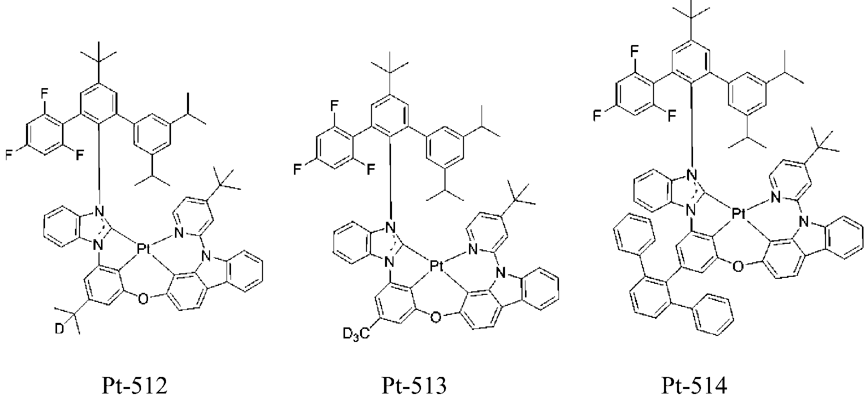

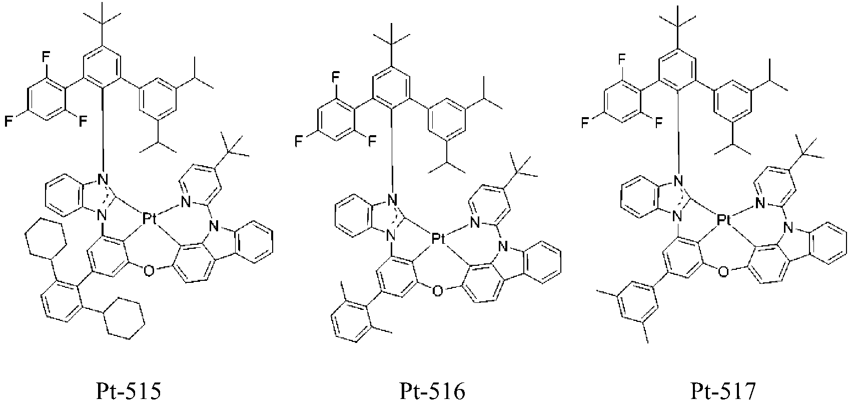

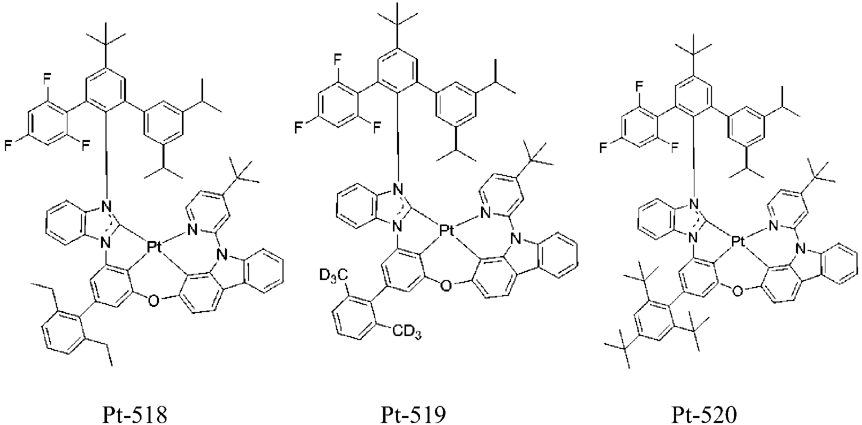

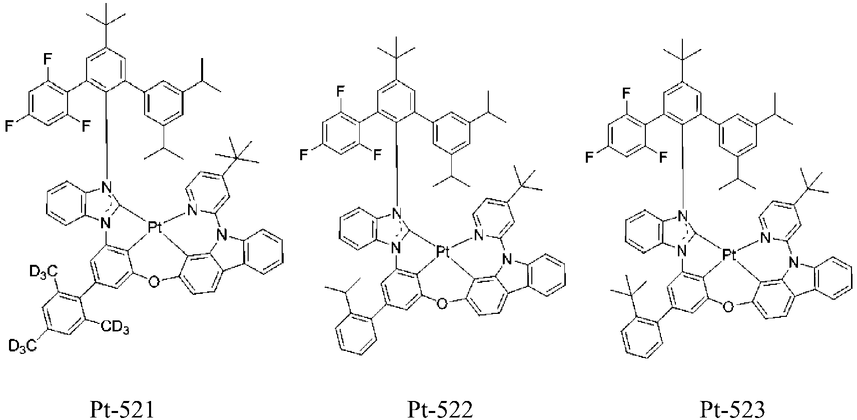

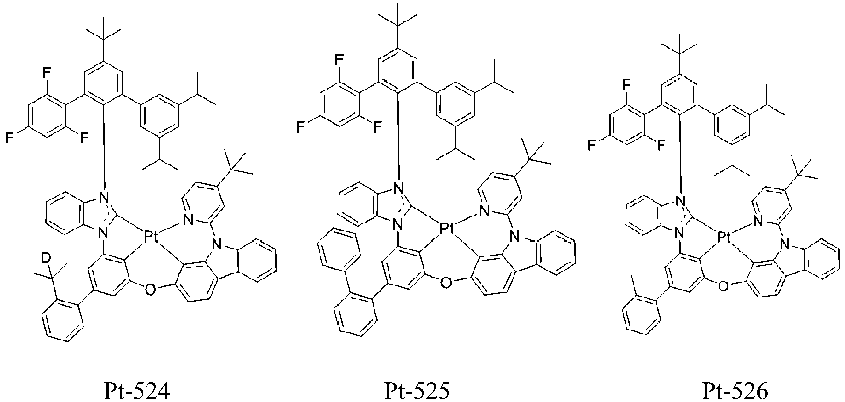

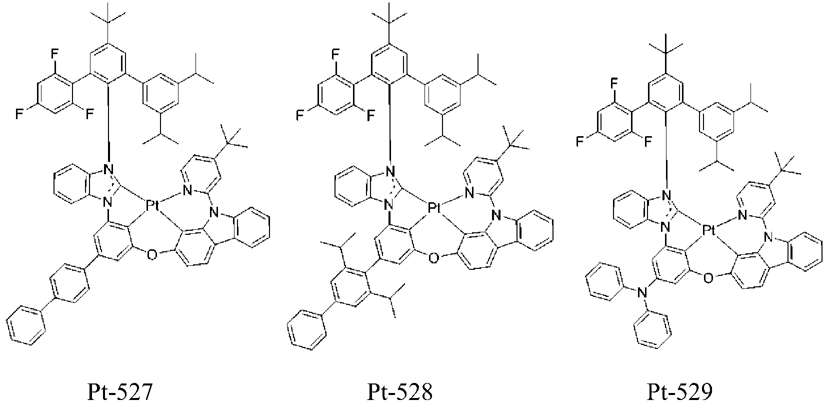

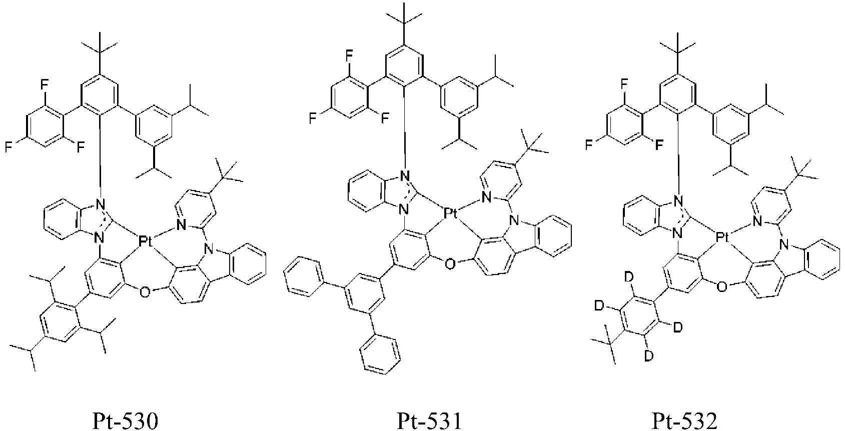

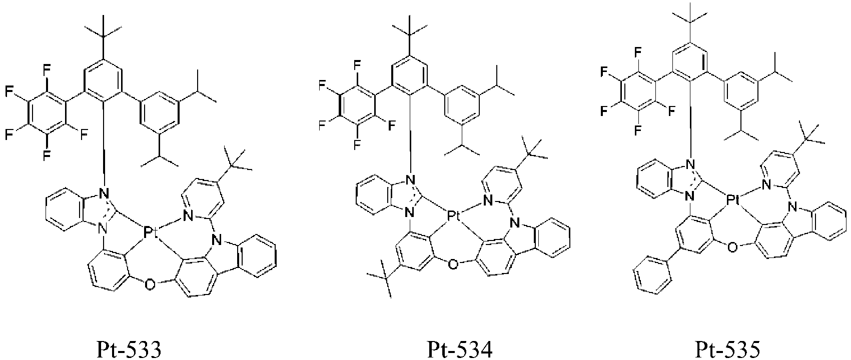

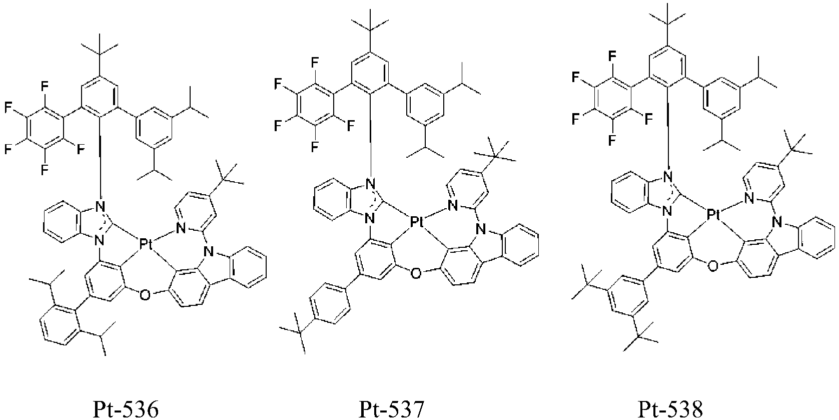

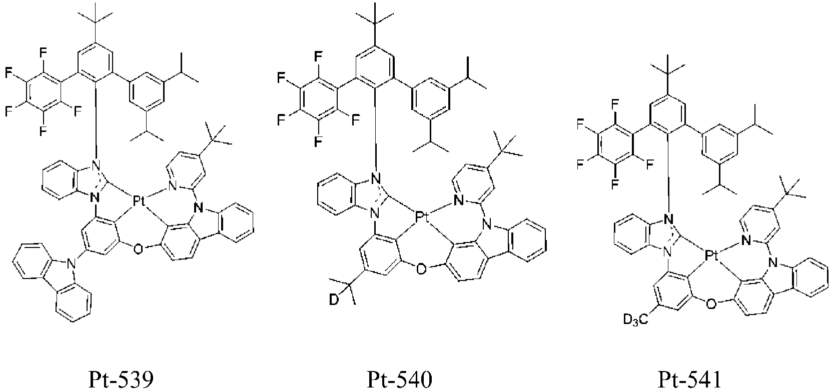

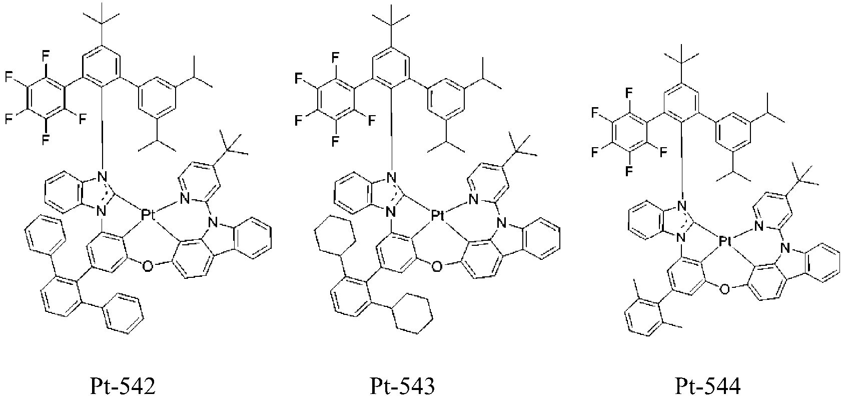

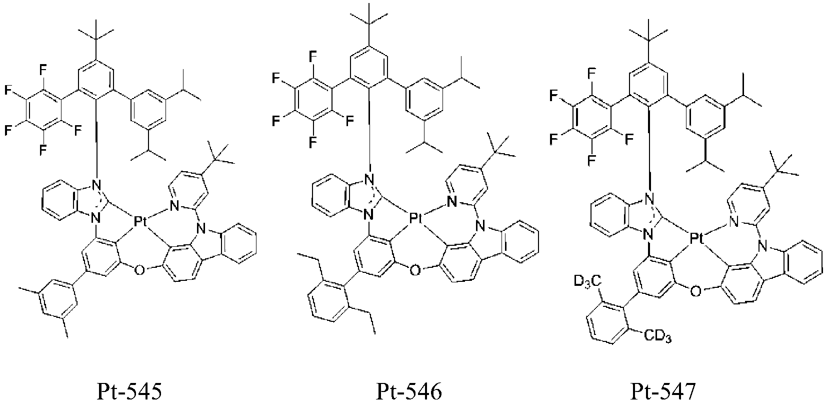

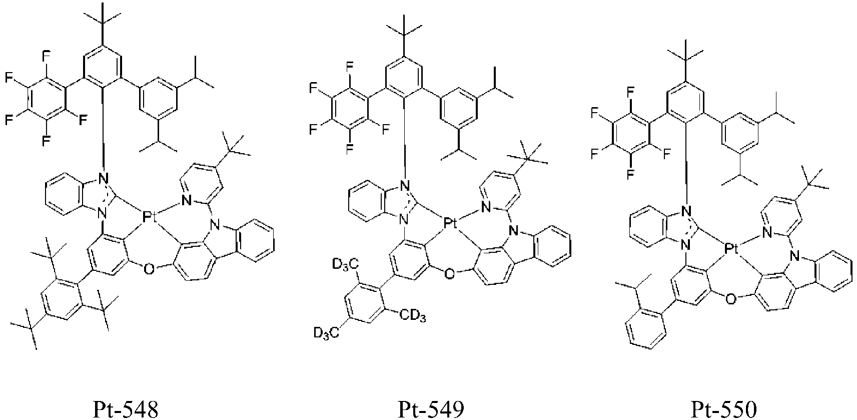

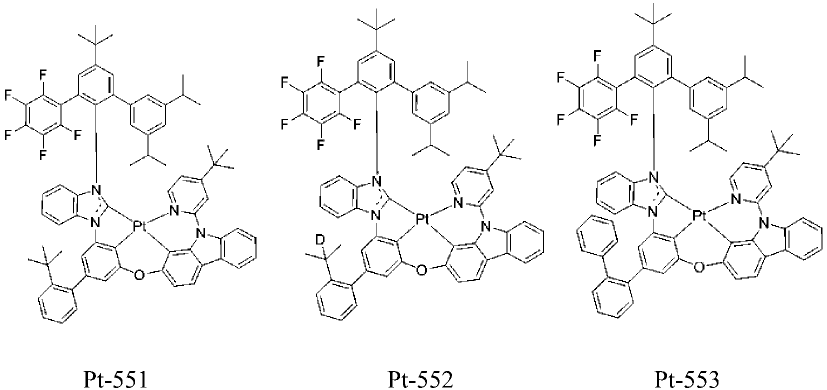

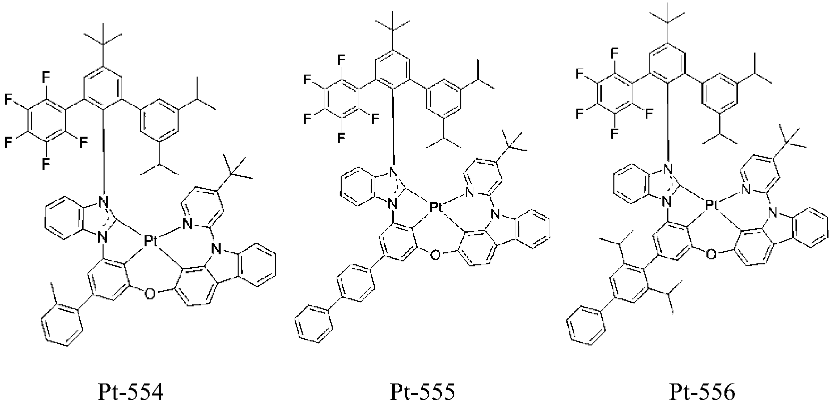

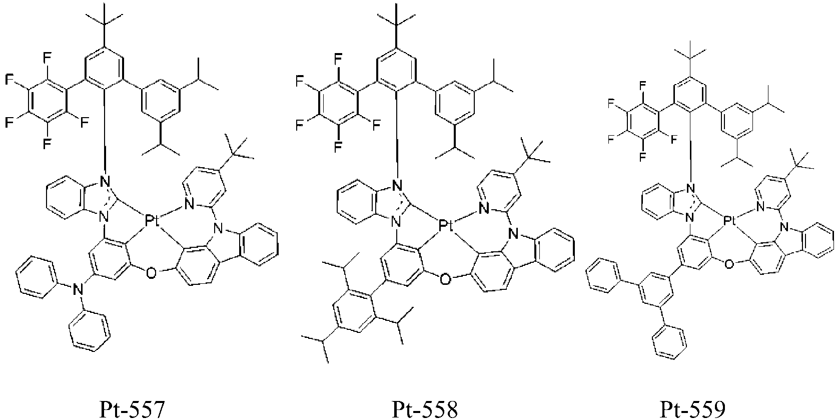

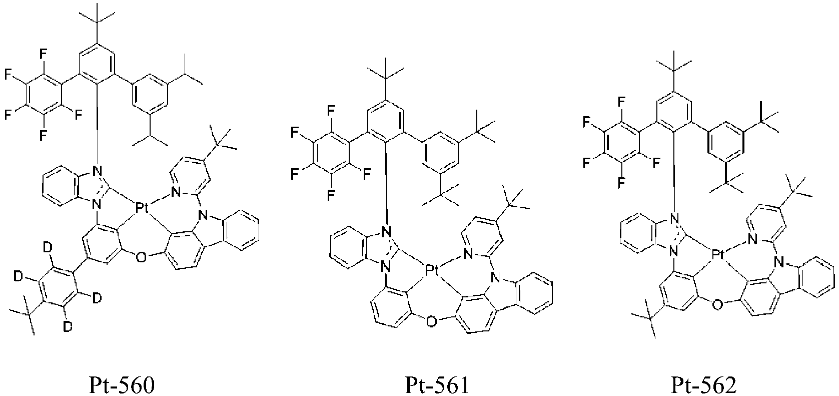

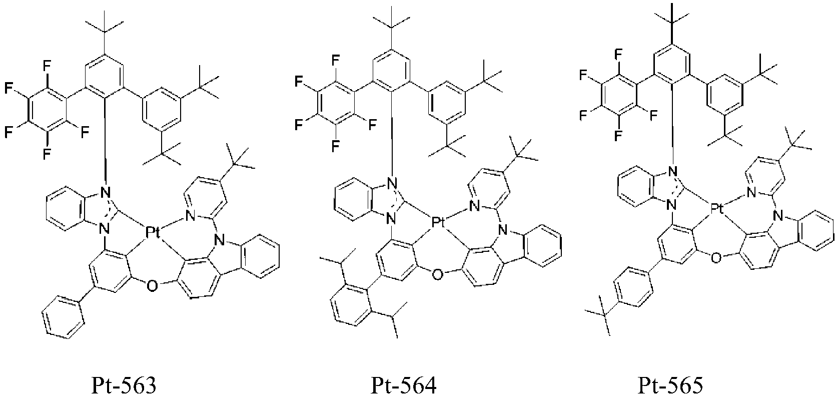

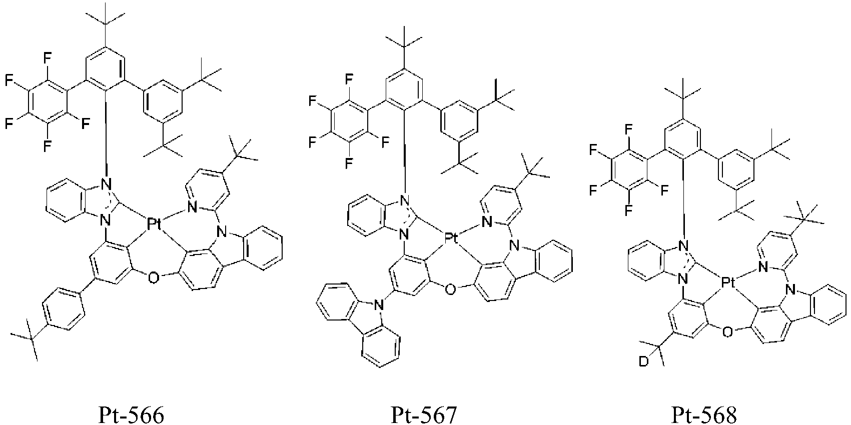

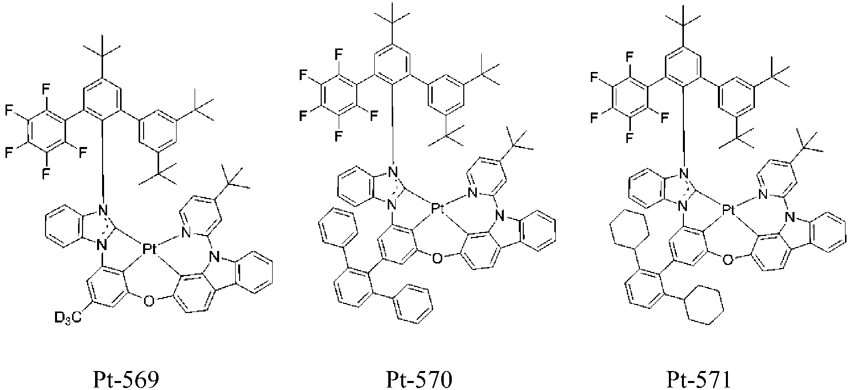

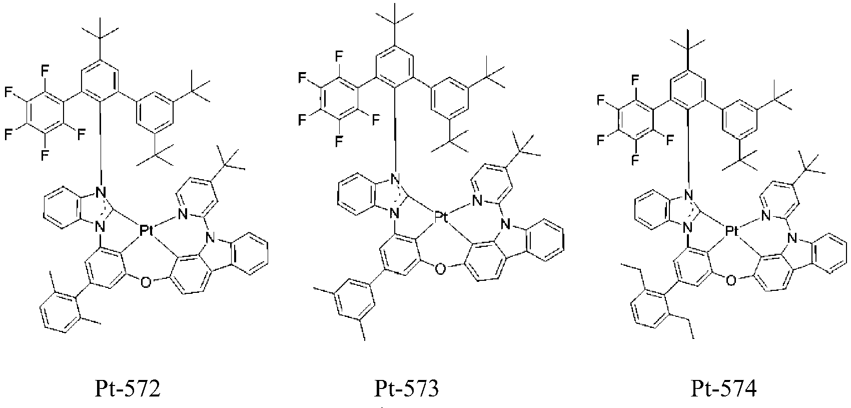

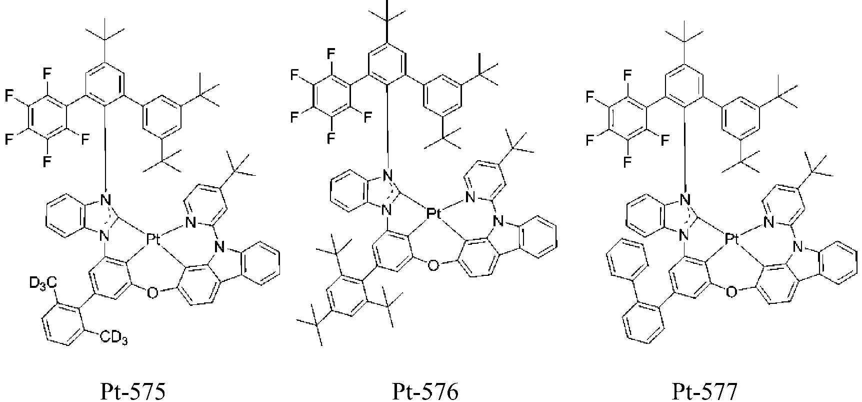

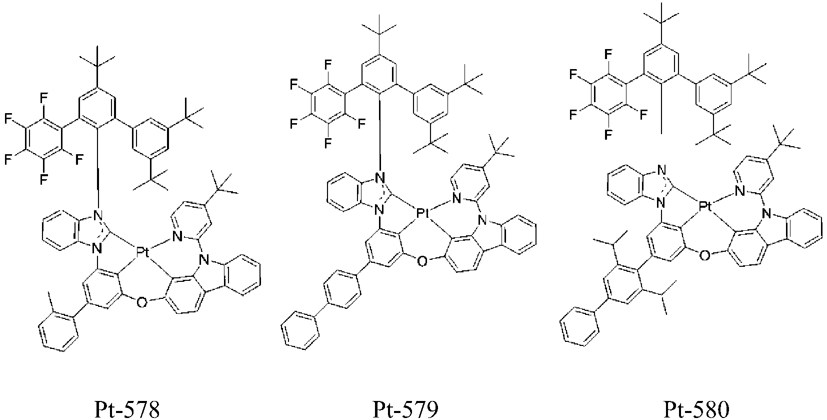

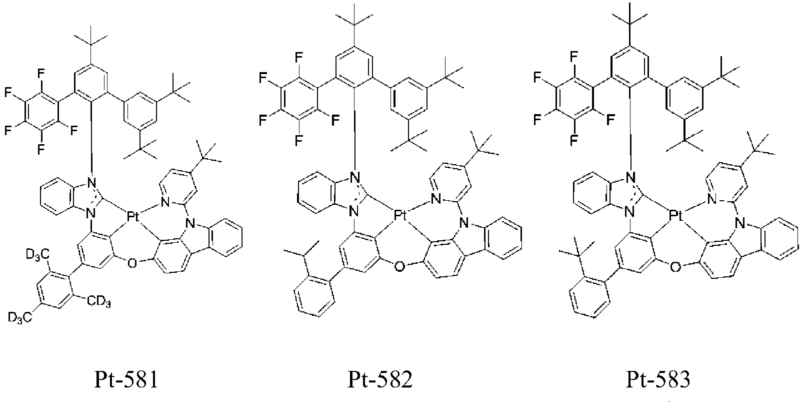

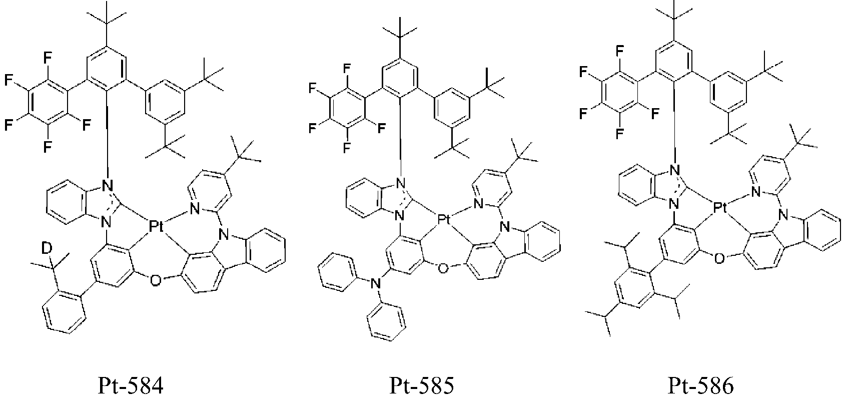

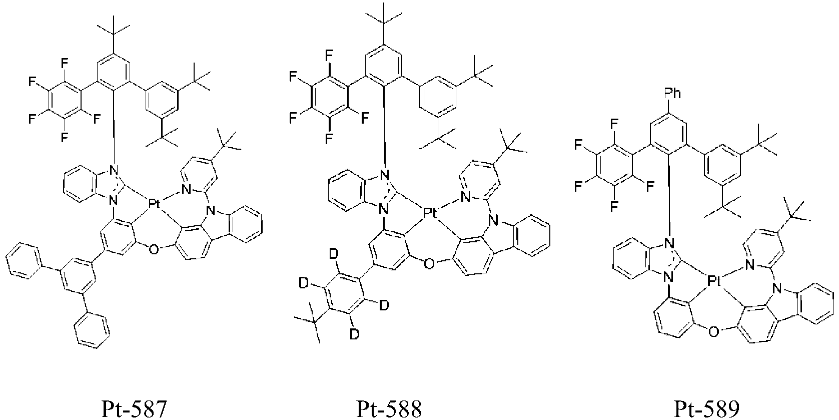

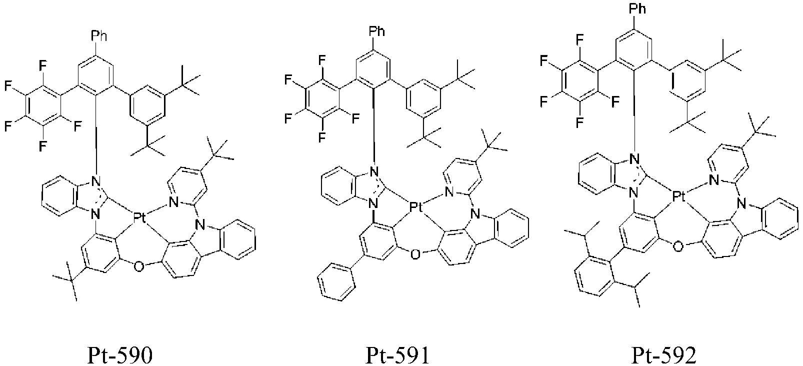

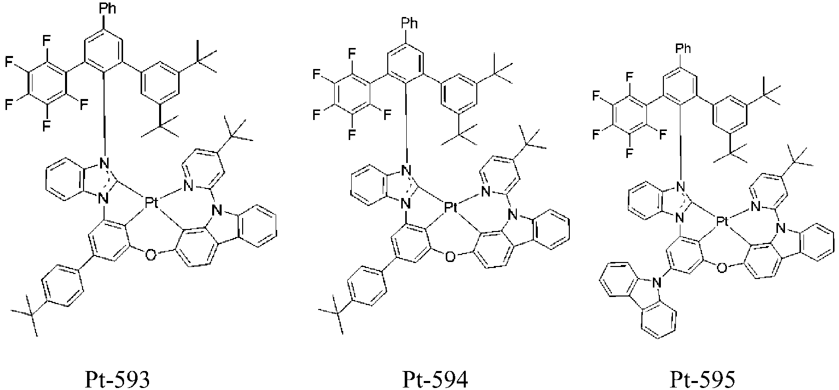

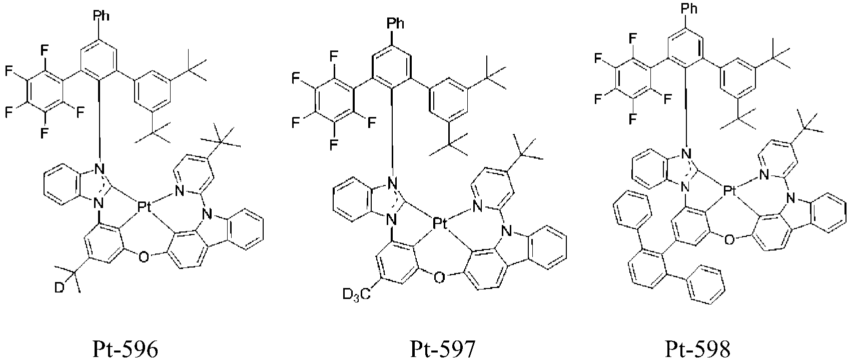

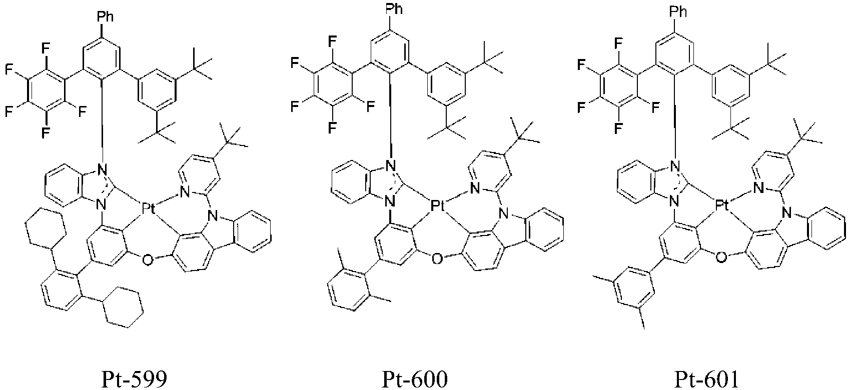

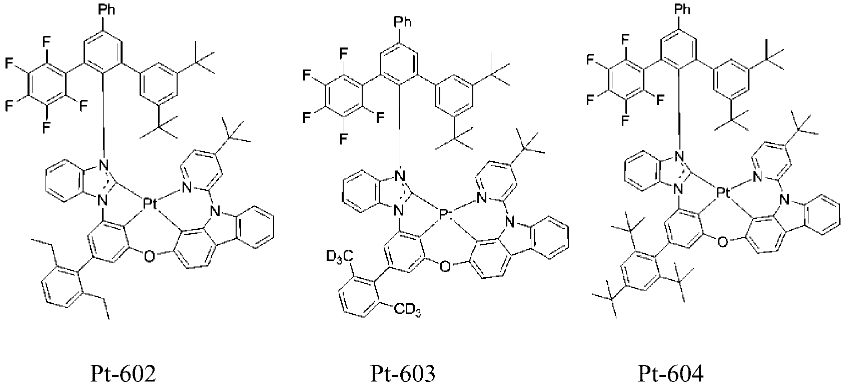

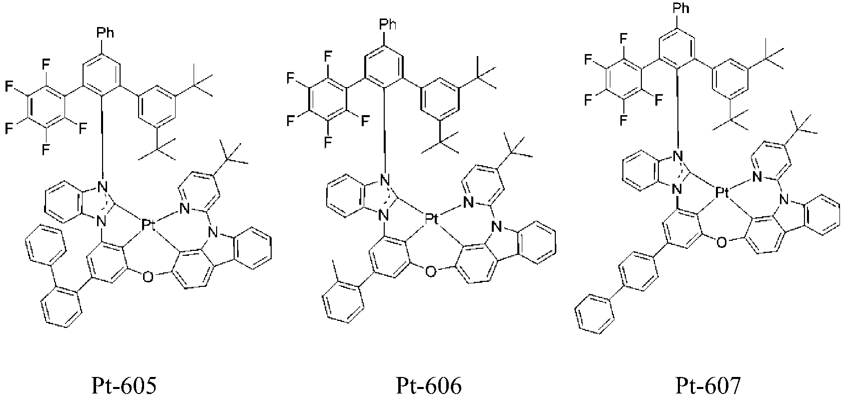

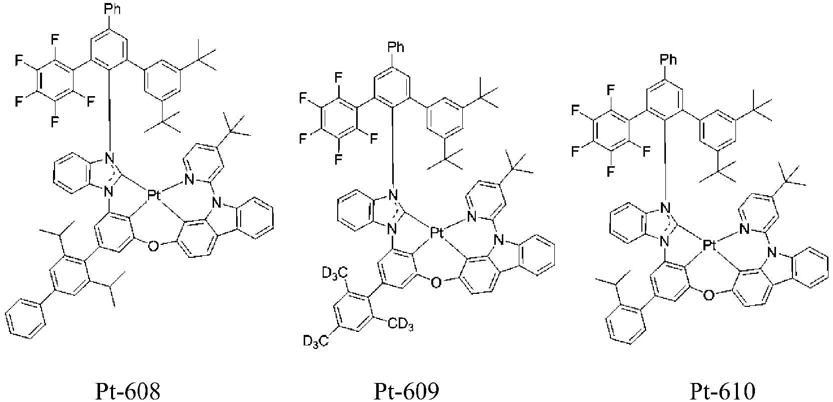

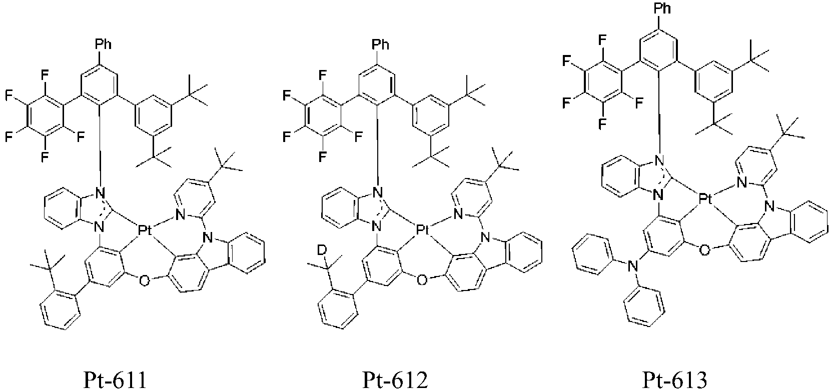

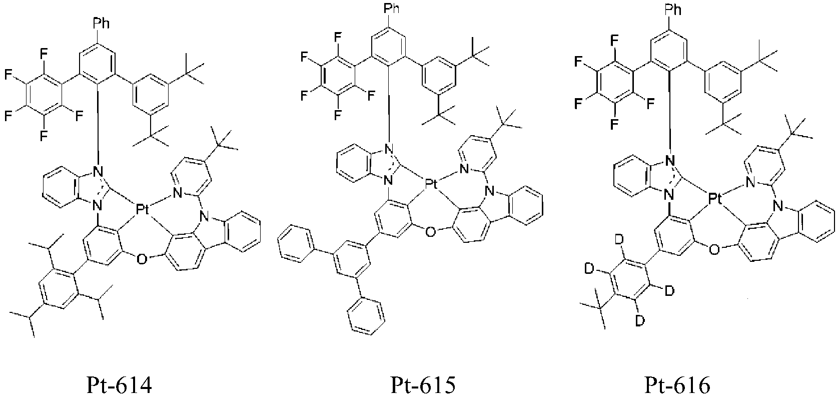

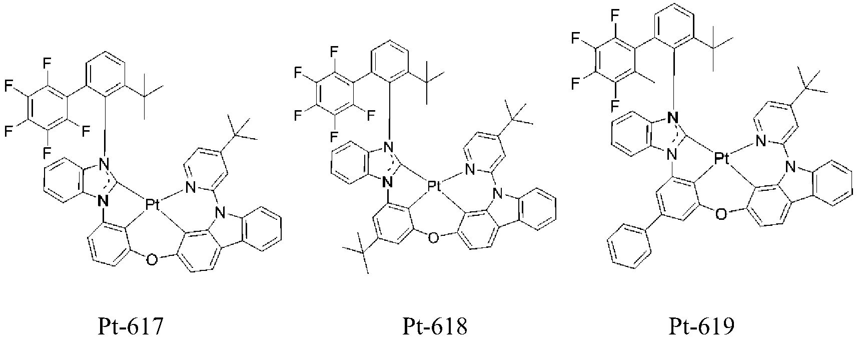

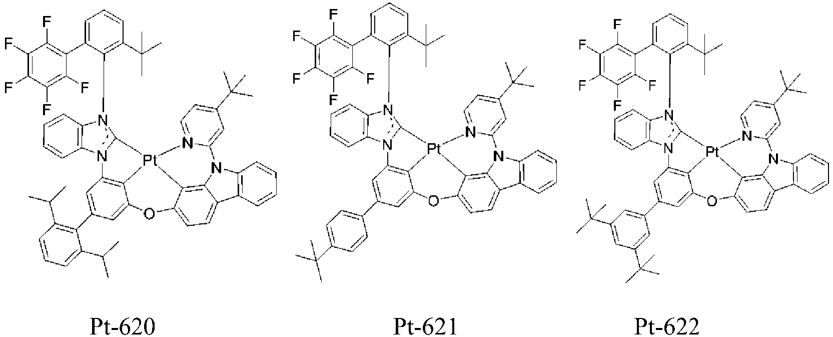

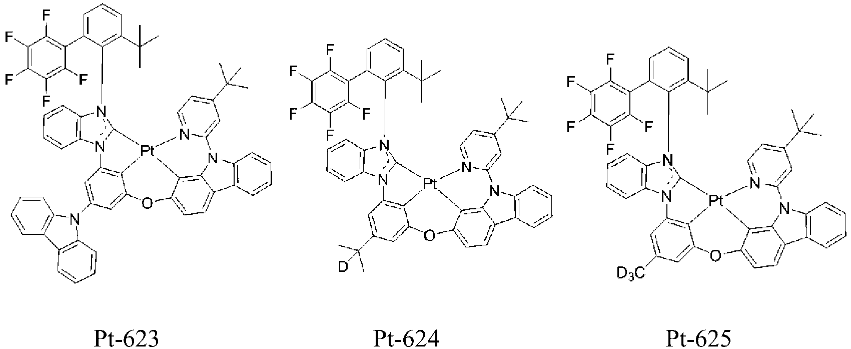

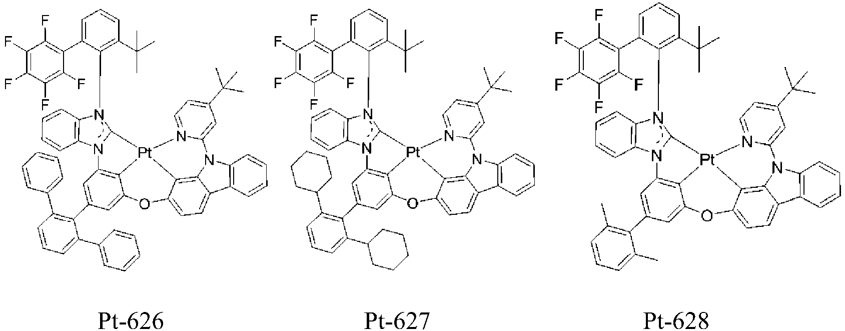

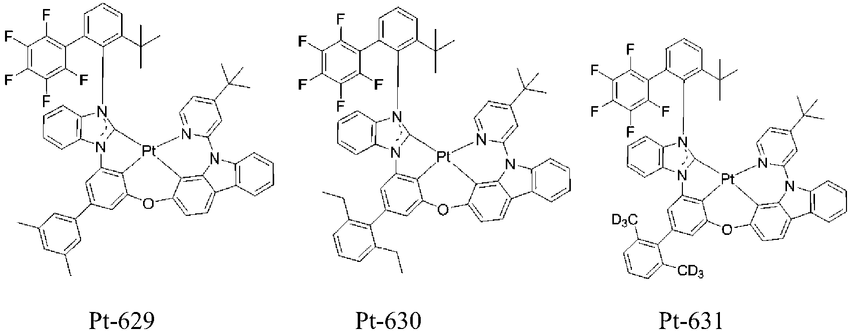

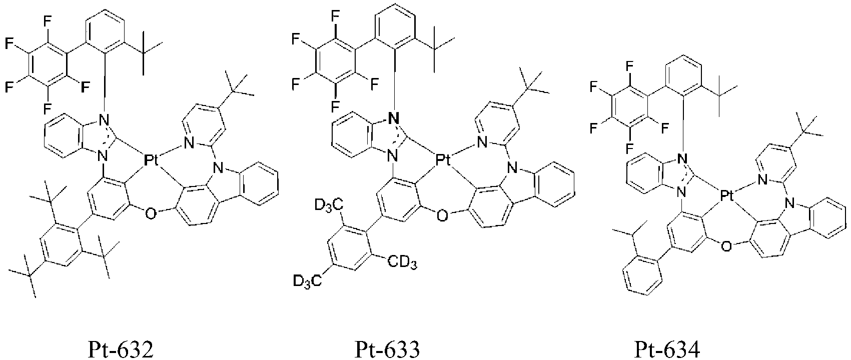

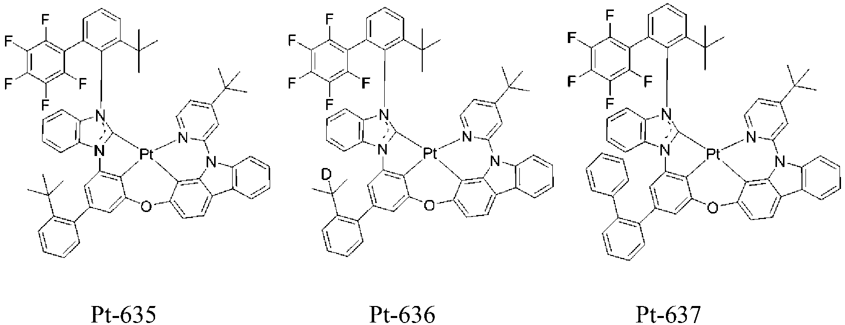

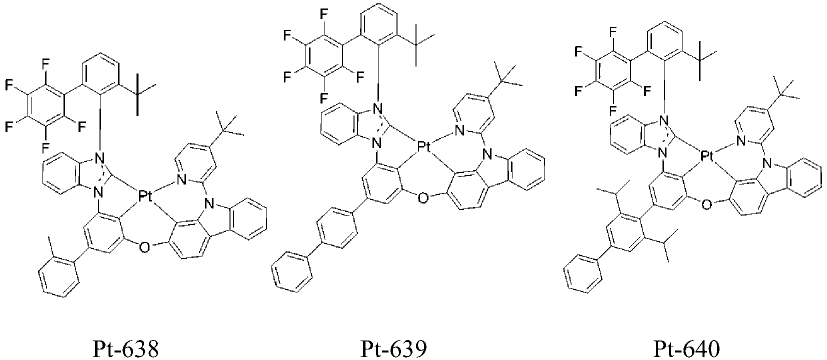

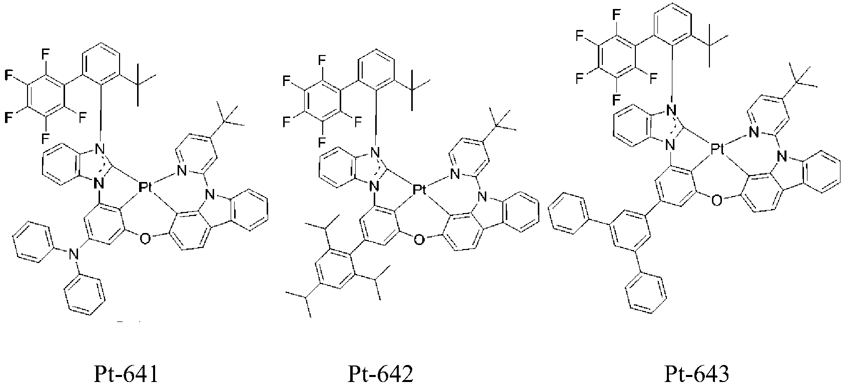

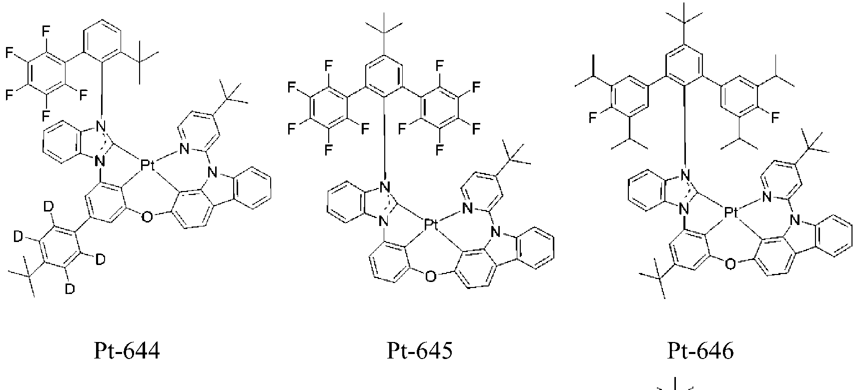

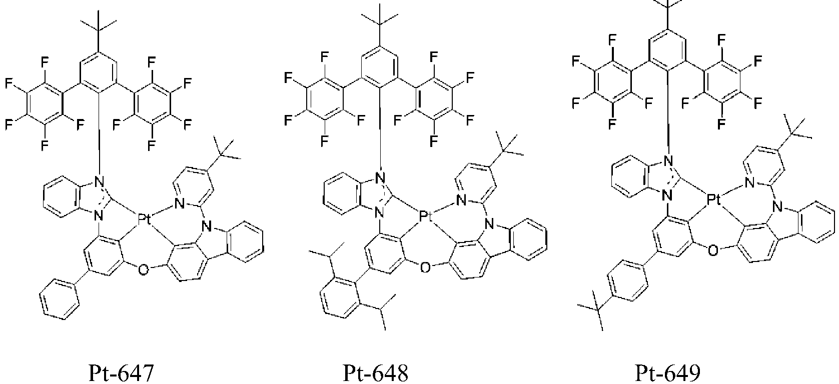

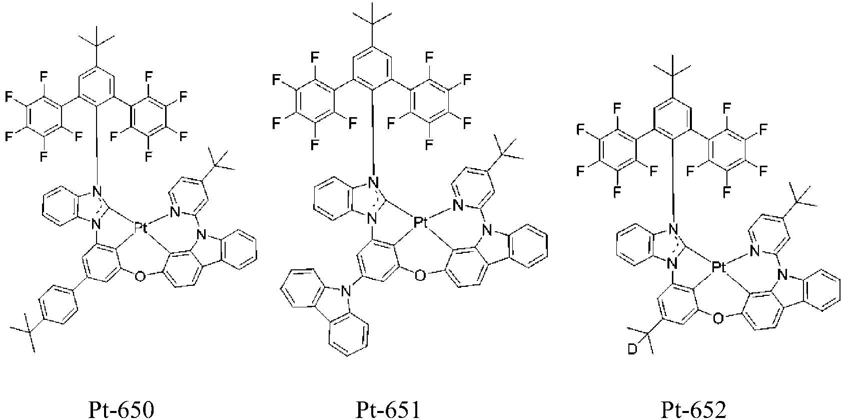

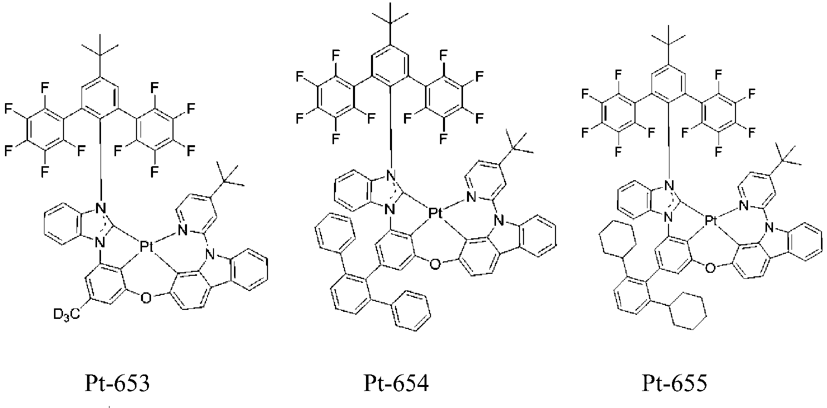

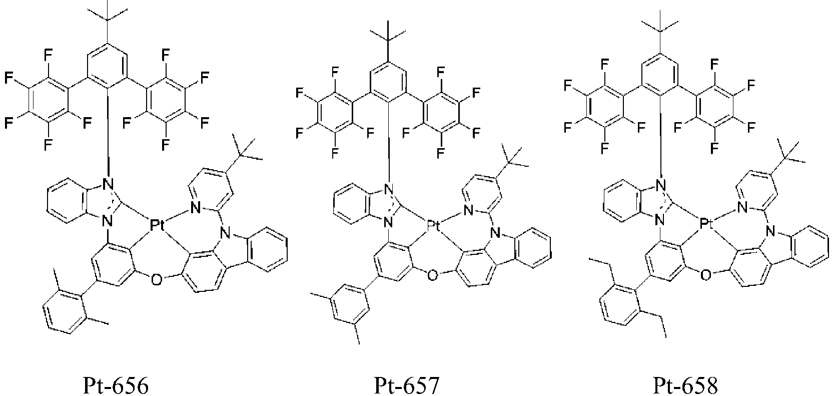

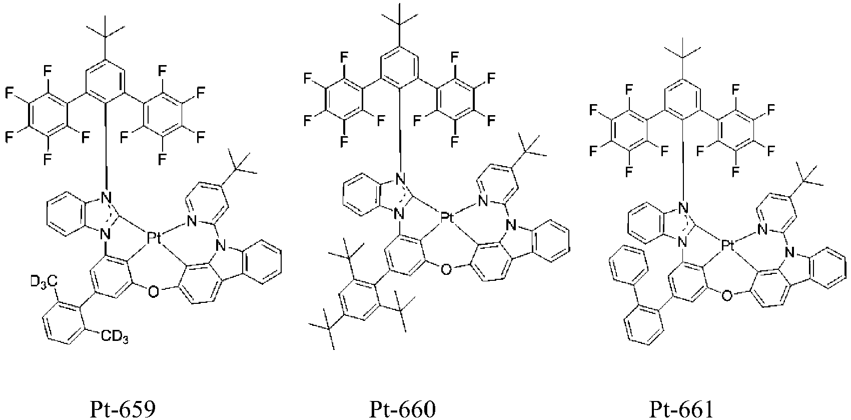

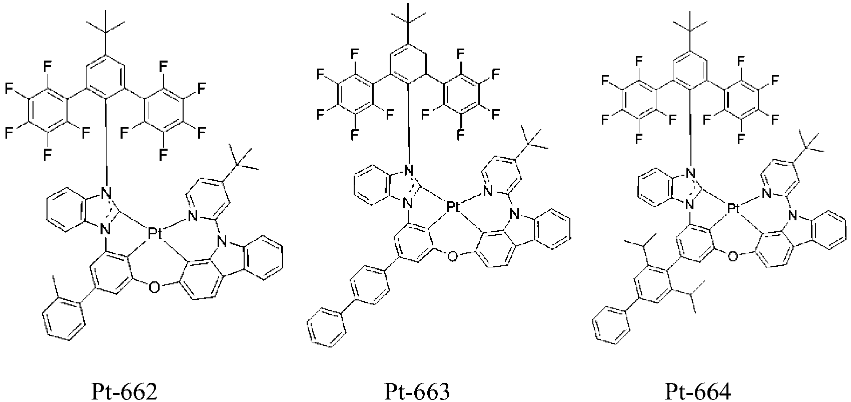

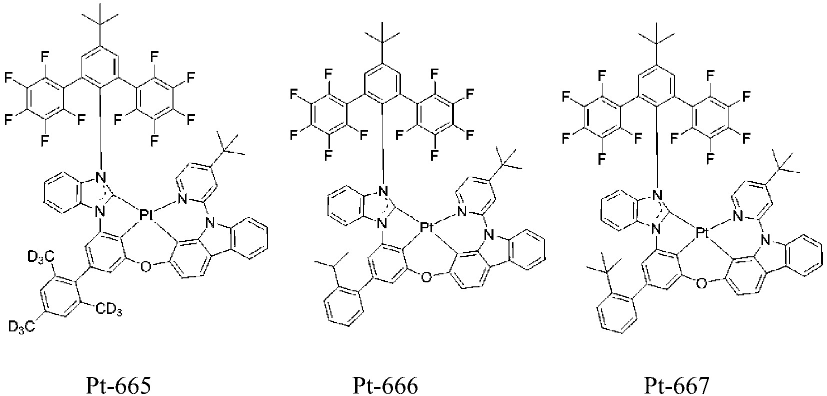

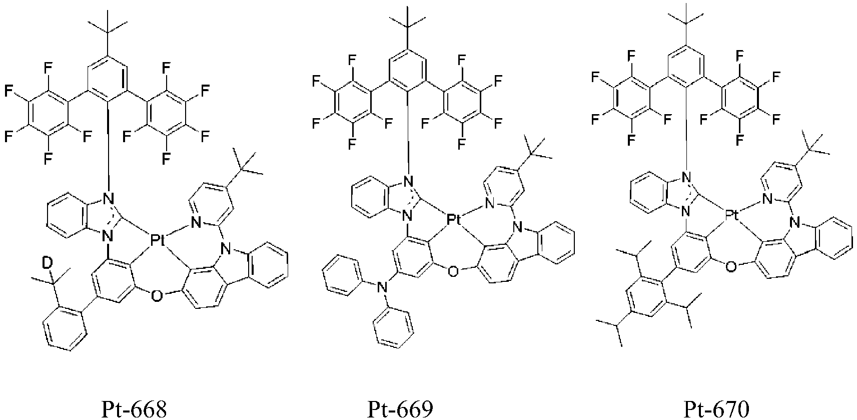

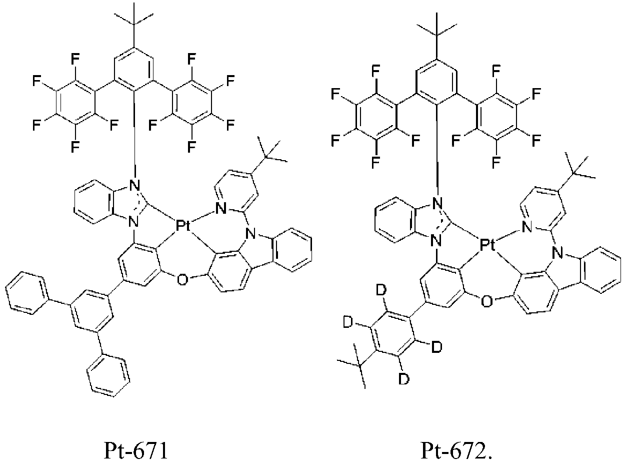

3. Anwendung des fluorierten vierzähnigen Platin (II)-Komplexes nach Anspruch 1 oder 2 in elektronischen Vorrichtungen.

4. Anwendung nach Anspruch 3, wobei die elektronische Vorrichtung eine organische Elektrolumineszenzvorrichtung, eine organische integrierte Schaltung, einen organischen Feldeffekttransistor, einen organischen Dünnschichttransistor, einen organischen lichtemittierenden Transistor, eine organische Solarzelle, einen organischen optischen Detektor, einen organischen Photorezeptor, eine organische Feld-Quenching-Vorrichtung, eine lumineszierende elektrochemische Zelle und eine organische Laserdiode umfasst.

5. Organische Elektrolumineszenzvorrichtung, wobei die organische Elektrolumineszenzvorrichtung eine Kathode, eine Anode und eine organische Funktionsschicht zwischen der Kathode und der Anode umfasst, und wobei die organische Funktionsschicht den fluorierten vierzähnigen Platin (II)-Komplex nach Anspruch 1 oder 2 umfasst.

6. Organische Elektrolumineszenzvorrichtung nach Anspruch 5, wobei die organische Funktionsschicht eine Lumineszenzschicht umfasst, und wobei die Lumineszenzschicht den fluorierten vierzähnigen Platin (II)-Komplex nach Anspruch 1 oder 2 umfasst.

7. Organische Elektrolumineszenzvorrichtung nach Anspruch 5, wobei die Lumineszenzschicht ferner ein Fluoreszenz-Dotiermaterial umfasst; und wobei das Fluoreszenz-Dotiermaterial eine durch Formel (BN1) oder Formel (BN2) dargestellte Verbindung ist: 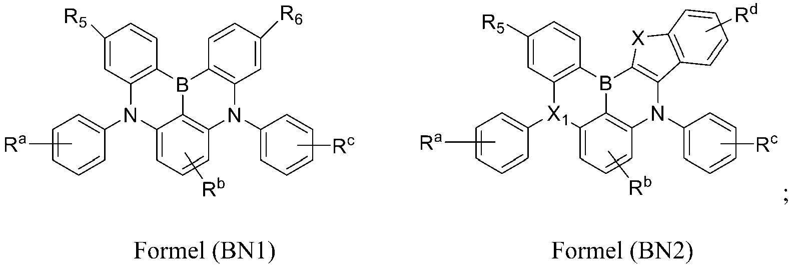
wobei X O, S, Se oder NR³⁰⁰ darstellt und X₁ Se oder N darstellt;
wobei R^{a}-R^{d} jeweils unabhängig einfach substituiert, zweifach substituiert, dreifach substituiert, vierfach substituiert oder unsubstituiert sind; und wobei R^{a}-R^{d} jeweils unabhängig aus der Gruppe ausgewählt sind, die aus Wasserstoff, Deuterium, N, einem C1-C30-Alkyl und einem C6-C60-Aryl besteht; und
wobei R₅ und R₆ unabhängig voneinander aus der Gruppe ausgewählt sind, die aus einer substituierten oder unsubstituierten Diphenylamingruppe und einer substituierten oder unsubstituierten Carbazolgruppe besteht; und wobei, wenn ein Substituent vorhanden ist, der Substituent aus der Gruppe ausgewählt ist, die aus Deuterium, einem C1-C30-Alkyl und einem C6-C30-Aryl besteht.

8. Organische Elektrolumineszenzvorrichtung nach Anspruch 5, wobei das Fluoreszenz-Dotiermaterial eine beliebige der folgenden chemischen Strukturen aufweist, und wobei Ph eine Phenylgruppe darstellt:

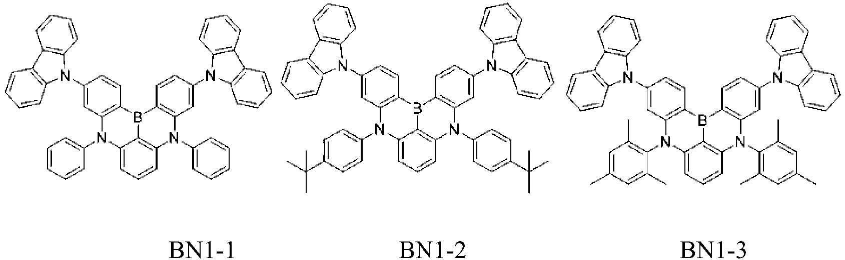

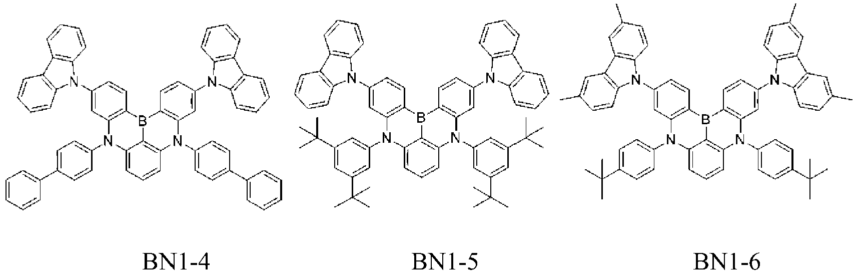

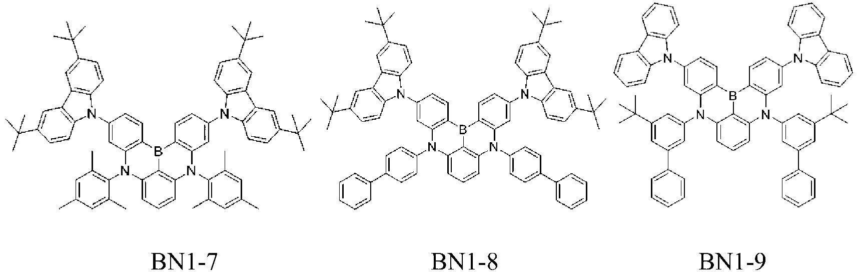

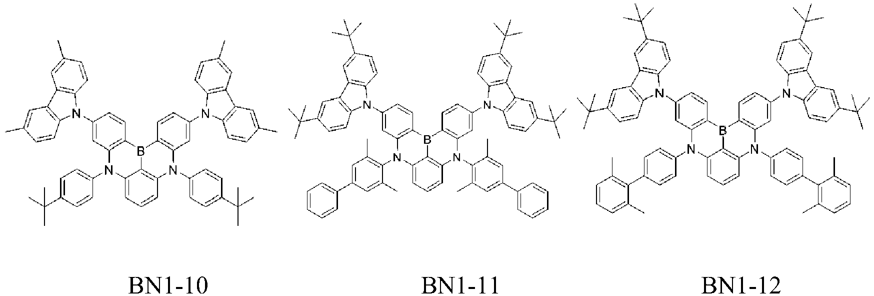

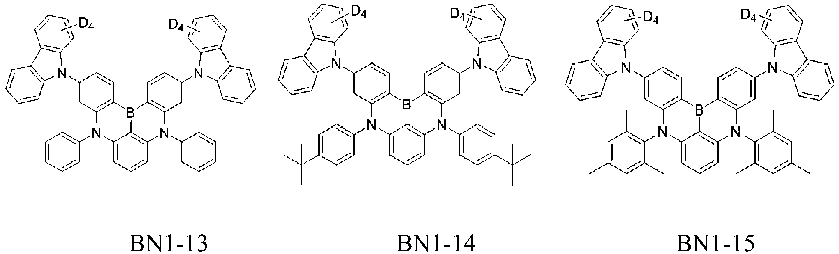

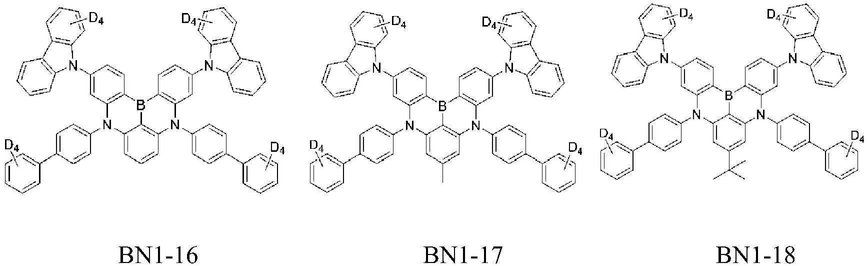

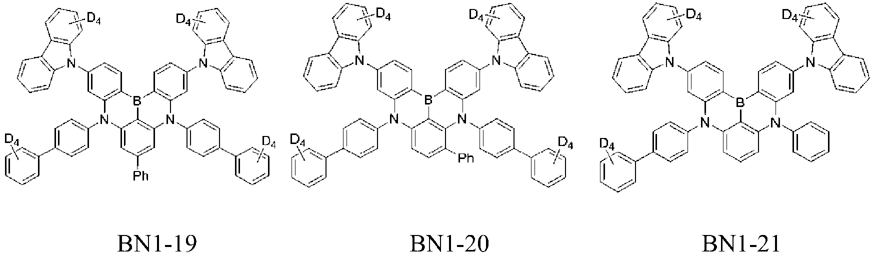

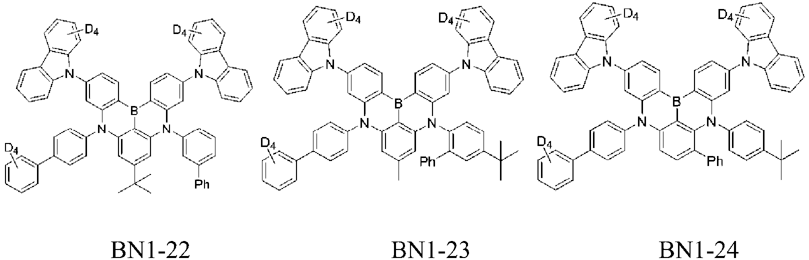

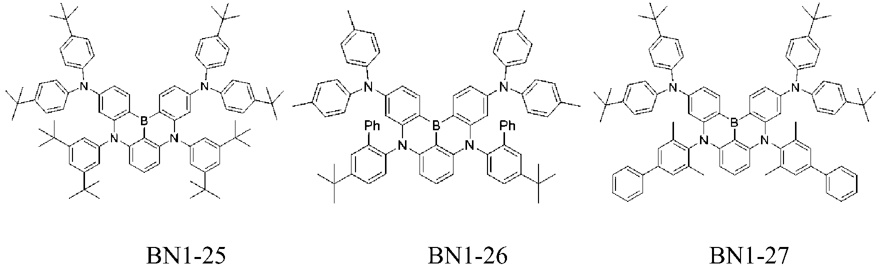

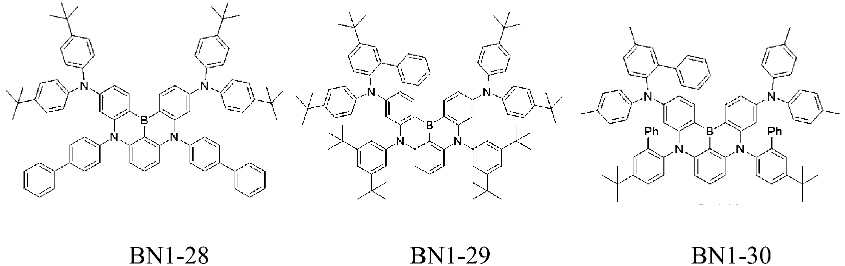

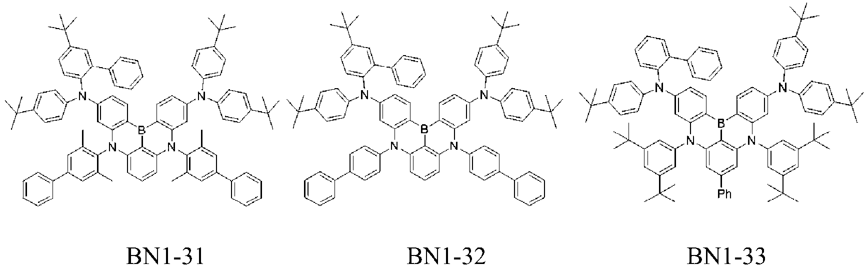

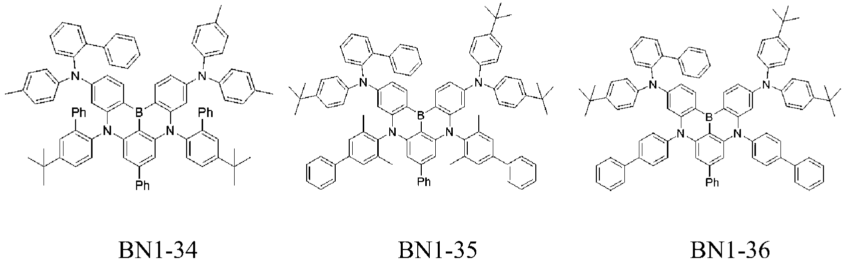

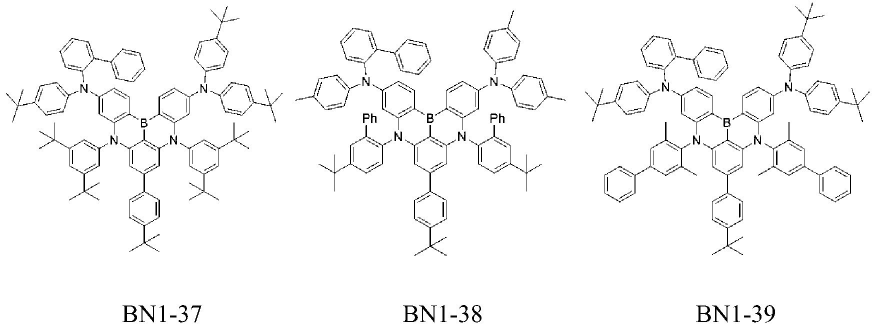

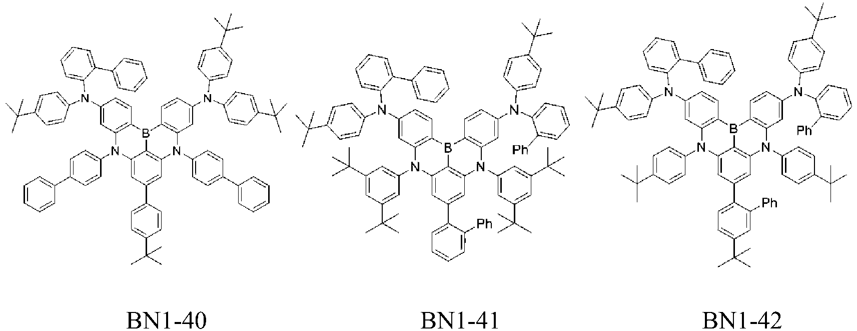

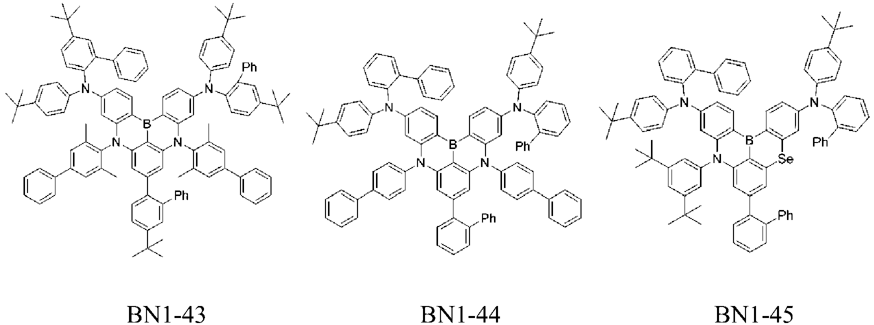

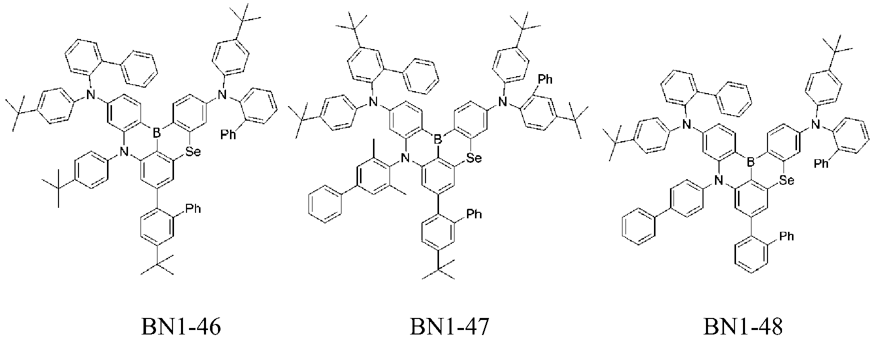

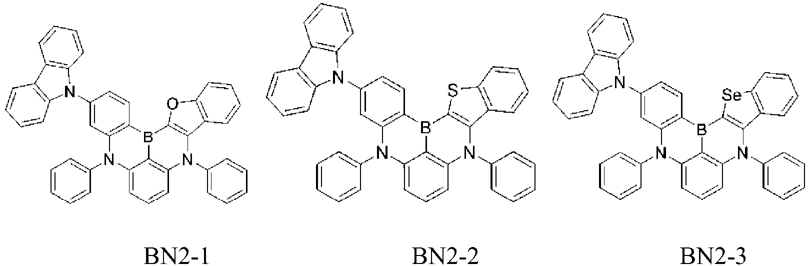

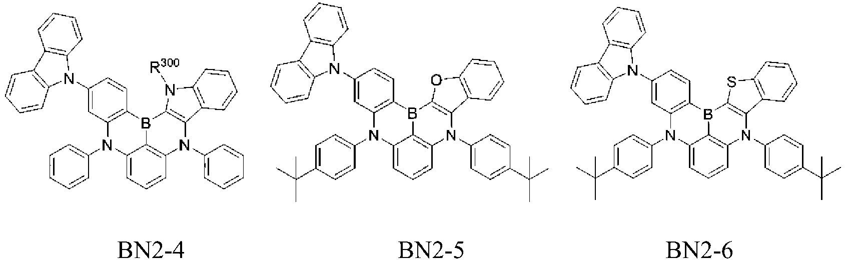

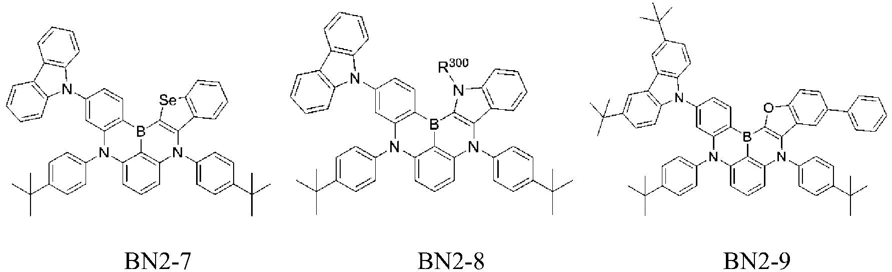

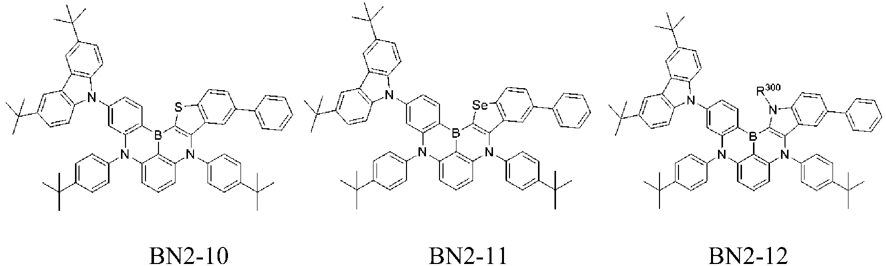

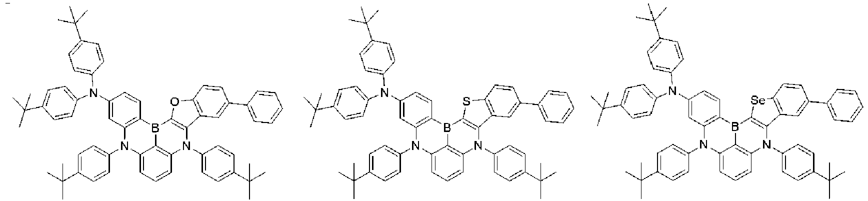

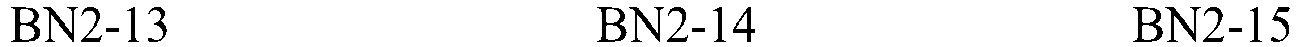

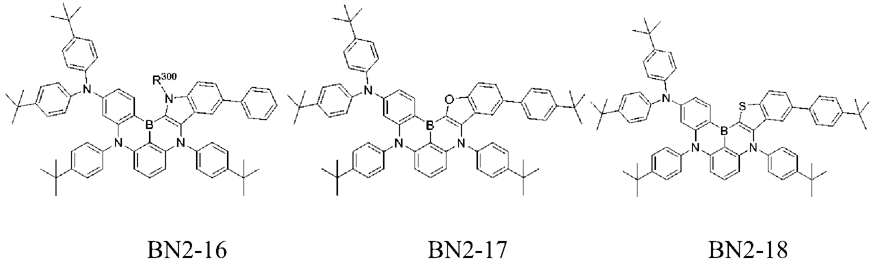

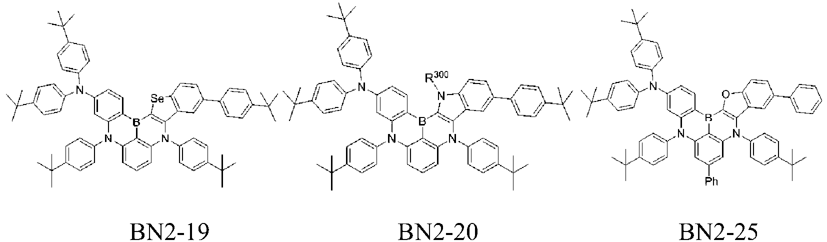

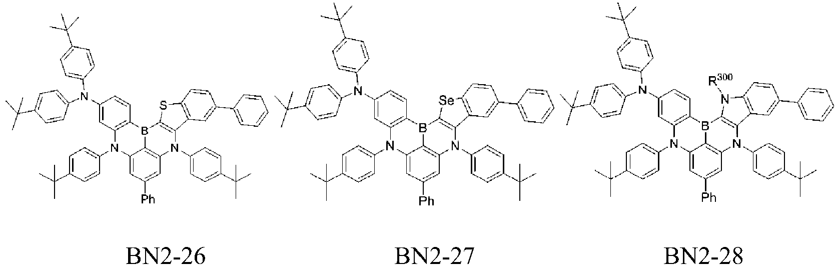

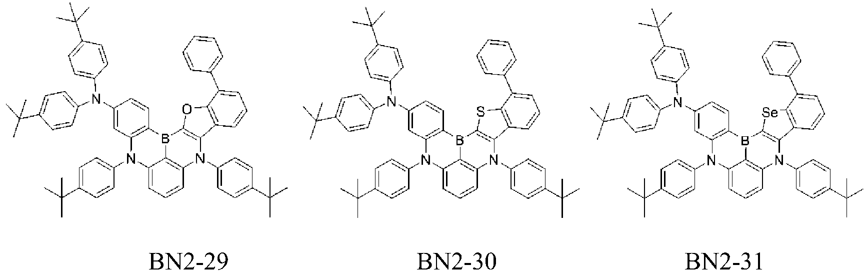

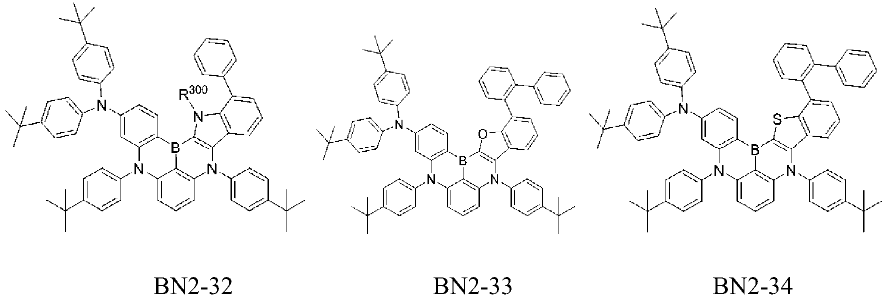

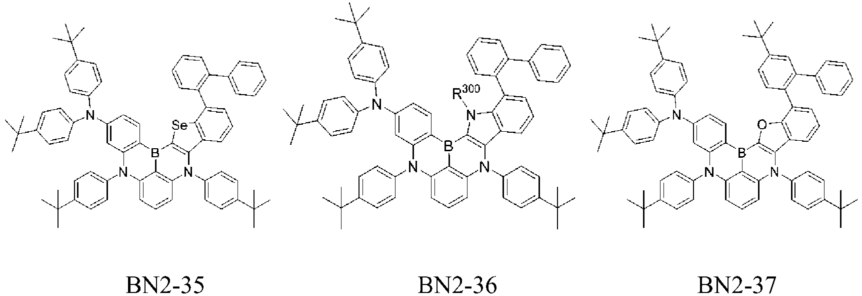

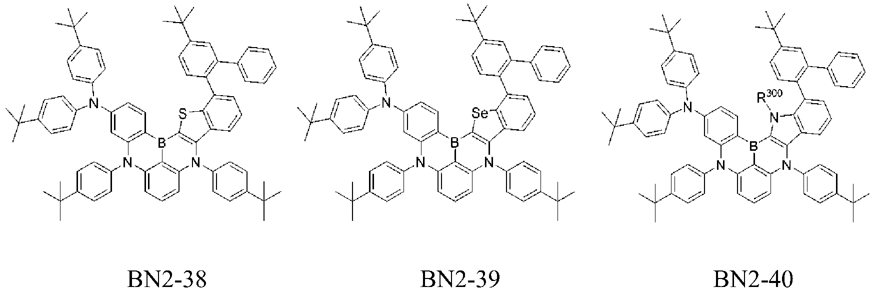

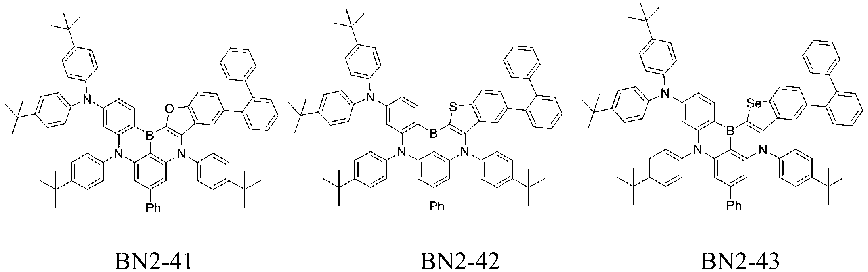

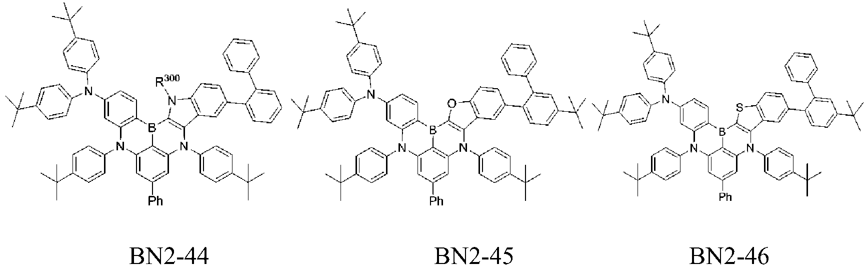

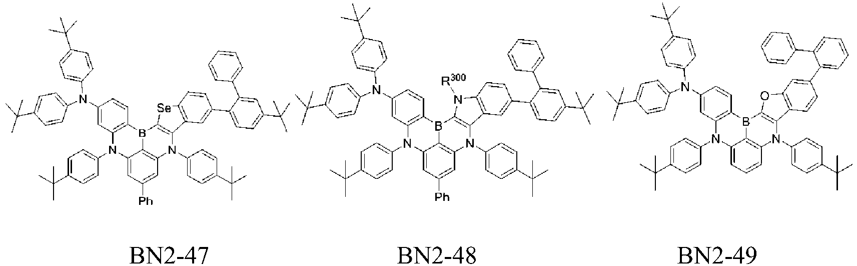

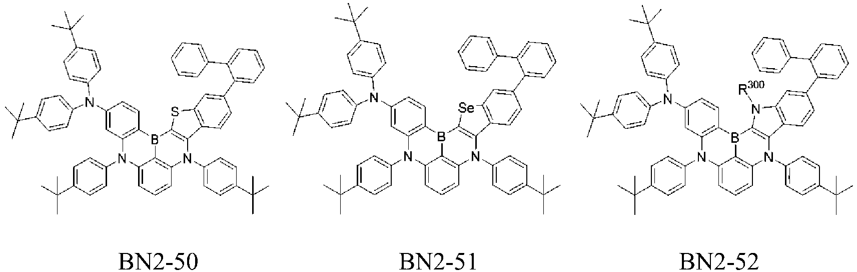

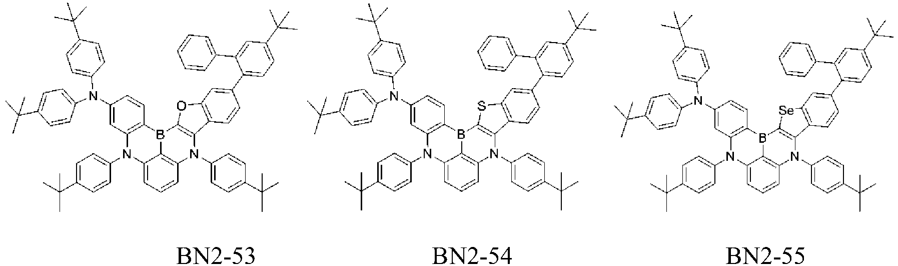

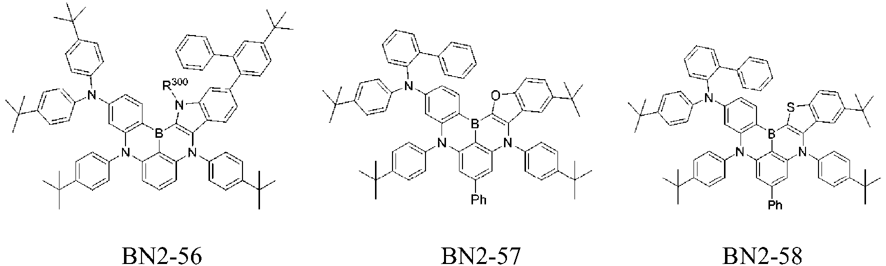

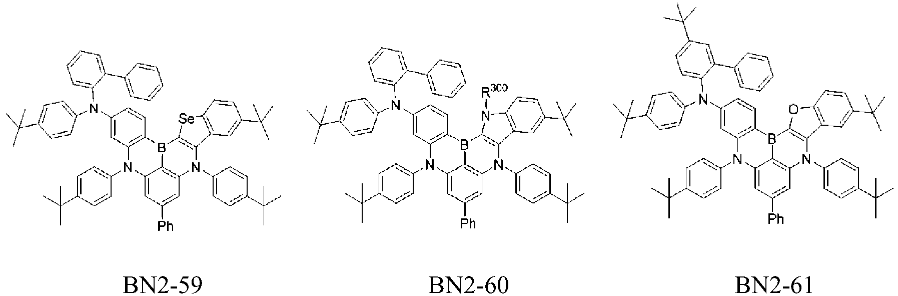

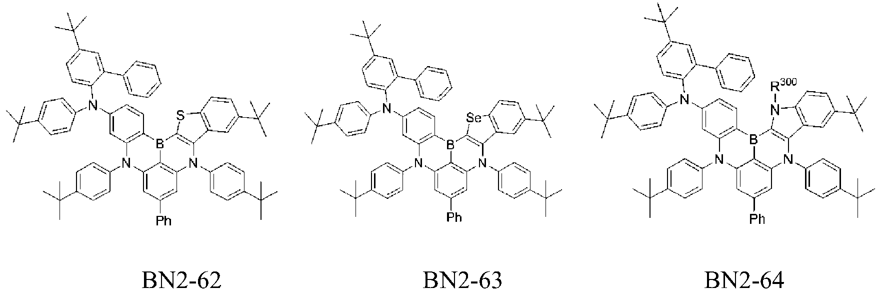

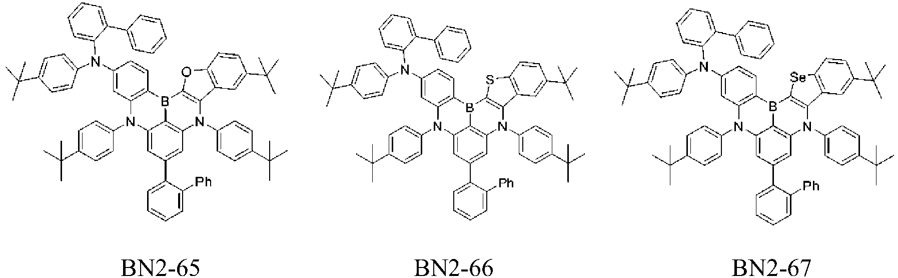

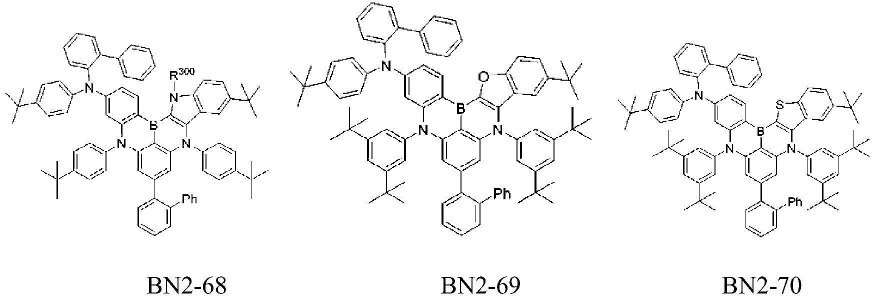

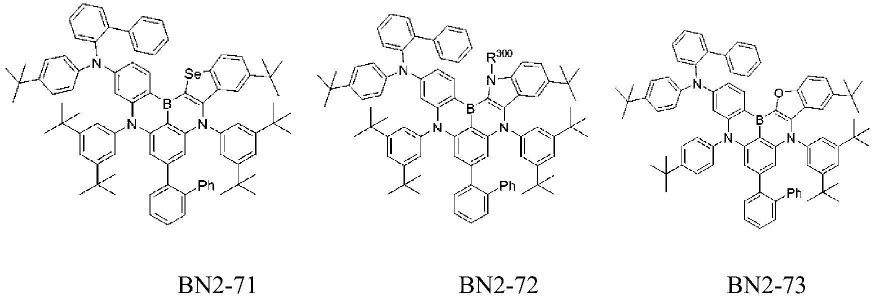

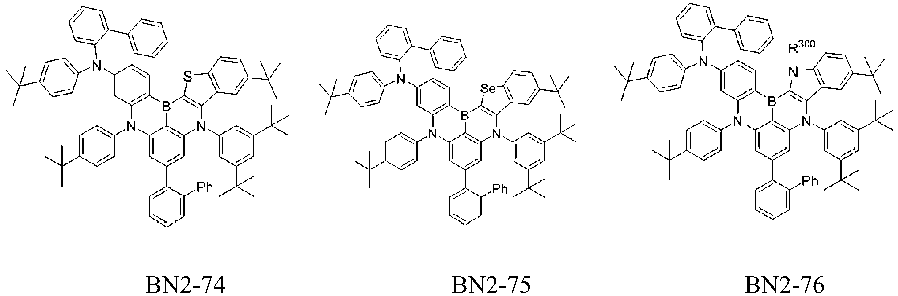

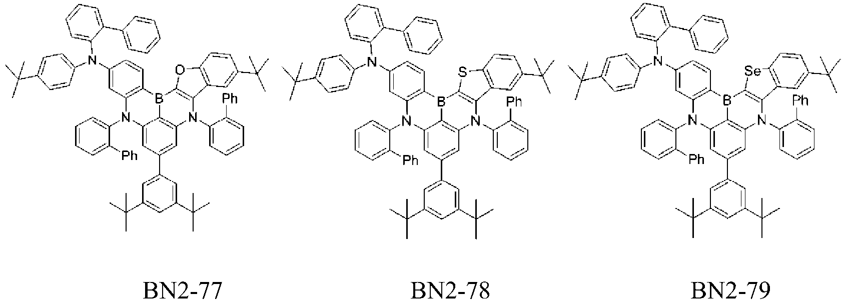

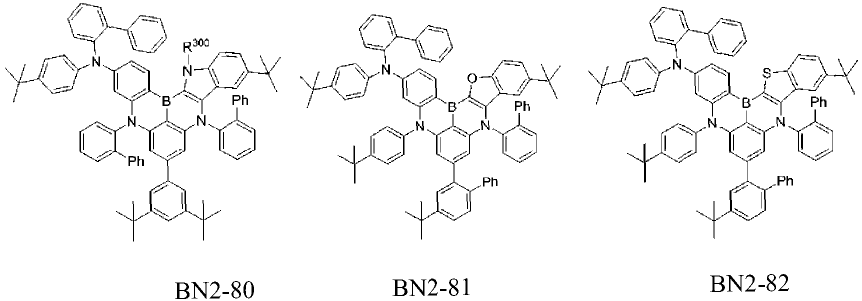

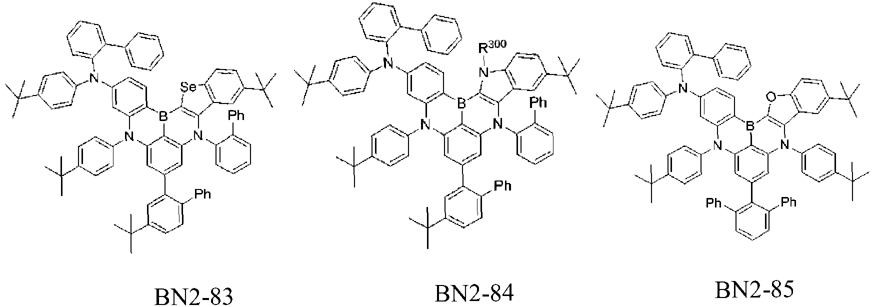

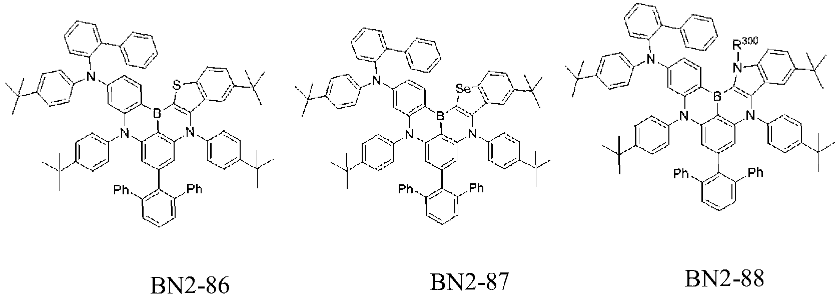

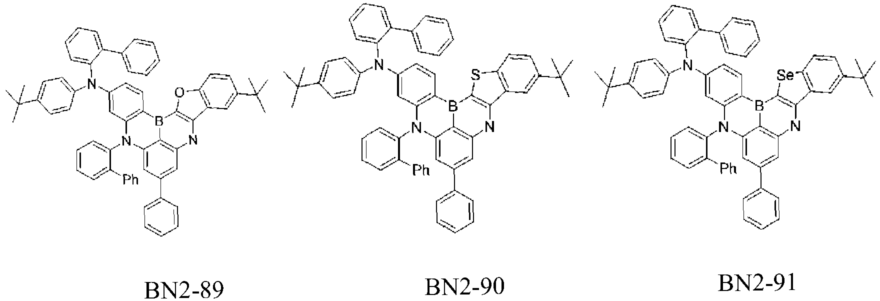

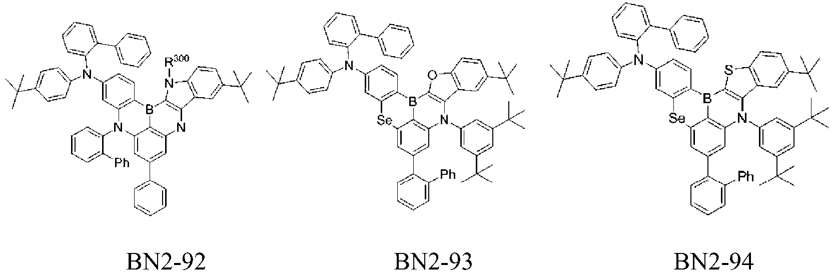

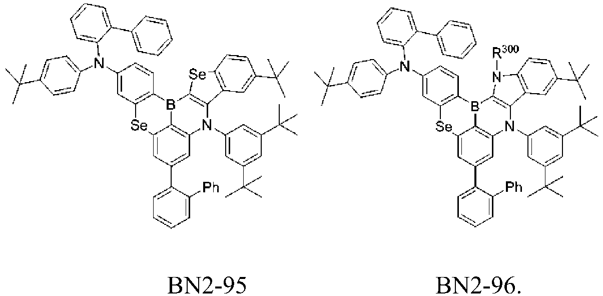

9. Organische optoelektronische Vorrichtung, wobei die organische optoelektronische Vorrichtung Folgendes umfasst: eine Substratschicht; eine erste Elektrode, wobei sich die erste Elektrode über dem Substrat befindet; eine organische lichtemittierende Funktionsschicht, wobei sich die organische lichtemittierende Funktionsschicht über der ersten Elektrode befindet; eine zweite Elektrode, wobei sich die zweite Elektrode über der organischen lichtemittierenden Funktionsschicht befindet; und wobei die organische lichtemittierende Funktionsschicht den fluorierten vierzähnigen Platin (II)-Komplex nach Anspruch 1 oder 2 umfasst.

10. Organische optoelektronische Vorrichtung nach Anspruch 9, wobei die organische lichtemittierende Funktionsschicht ferner ein Fluoreszenz-Dotiermaterial umfasst; und wobei das Fluoreszenz-Dotiermaterial eine durch Formel (BN1) oder Formel (BN2) dargestellte Verbindung ist: 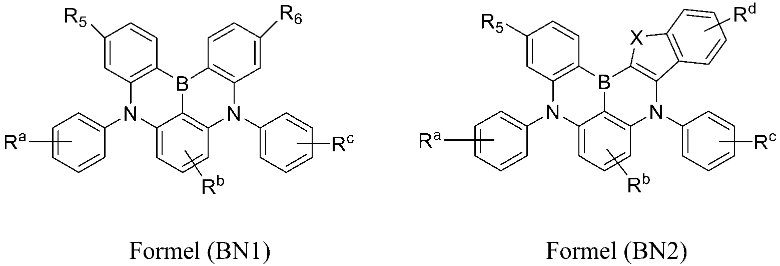
wobei X O, S, Se oder NR³⁰⁰ darstellt und X₁ Se oder N darstellt;
wobei R^{a}-R^{d} jeweils unabhängig einfach substituiert, zweifach substituiert, dreifach substituiert, vierfach substituiert oder unsubstituiert sind; und wobei R^{a}-R^{d} jeweils unabhängig aus der Gruppe ausgewählt sind, die aus Wasserstoff, Deuterium, N, einem C1-C30-Alkyl und einem C6-C60-Aryl besteht; und
wobei R₅ und R₆ jeweils unabhängig aus der Gruppe ausgewählt sind, die aus einer substituierten oder unsubstituierten Diphenylamingruppe und einer substituierten oder unsubstituierten Carbazolgruppe besteht; und wobei, wenn ein Substituent vorhanden ist, der Substituent aus der Gruppe ausgewählt ist, die aus Deuterium, einem C1-C30-Alkyl und einem C6-C30-Aryl besteht.

11. Zusammensetzung, wobei die Zusammensetzung den fluorierten vierzähnigen Platin (II)-Komplex nach Anspruch 1 oder 2 umfasst.

12. Vorrichtung, wobei die Vorrichtung den fluorierten vierzähnigen Platin (II)-Komplex nach Anspruch 1 oder 2 umfasst.

13. Anzeige- oder Beleuchtungsausrüstung, wobei die Ausrüstung eine oder mehrere der organischen Elektrolumineszenzvorrichtungen nach einem der Ansprüche 5 bis 8 umfasst.

## Revendications

1. Complexe de platine tétradentate fluoré (II), dans lequel le complexe possède une structure telle que présentée dans la formule (I) ou la formule (II) : 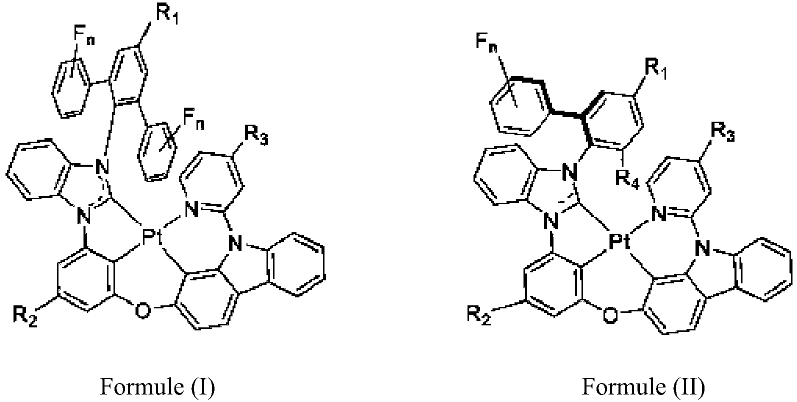 dans la formule (I) ou la formule (II), Fₙ représente une ou plusieurs substitutions F sur l'anneau benzénique où il est (ils sont) situé(s), où n est un entier positif de 1 à 5 ; R₁, R₂ et R₄ sont sélectionnés parmi le groupe composé d'hydrogène, de deutérium, d'un alkyle C1-C30, d'un cycloalkyle C1-C30, d'un aryle C6-C60, d'un hétérocycloalkyle C1-C30, d'un groupe arylamine C6-C18 et d'un groupe amine hétérocyclique C6-C18, et R3 est un tert-butyl.

2. Un complexe de platine tétradentate fluoré (II), dans lequel le complexe de platine tétradentate fluoré (II) possède l'une des structures chimiques suivantes, où « D » représente le deutérium :

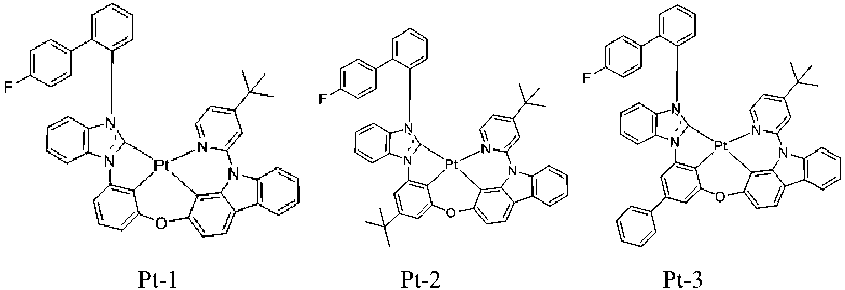

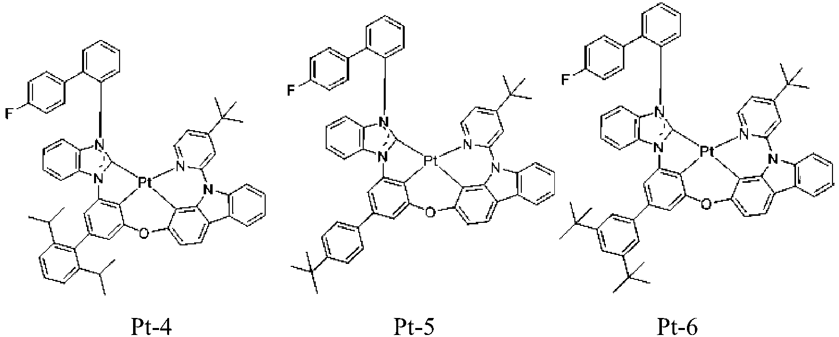

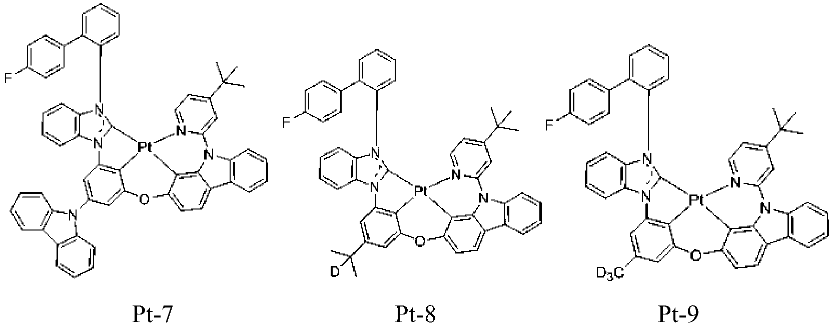

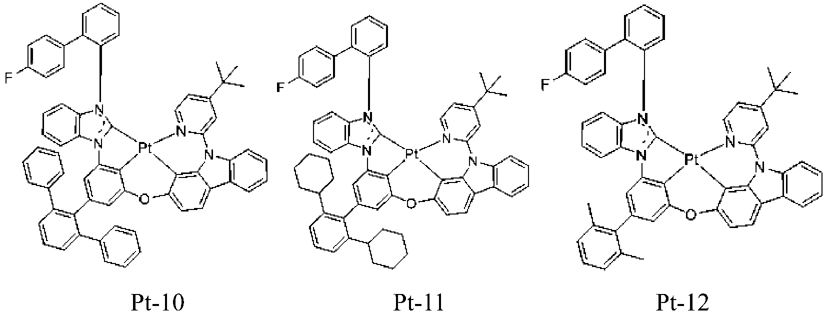

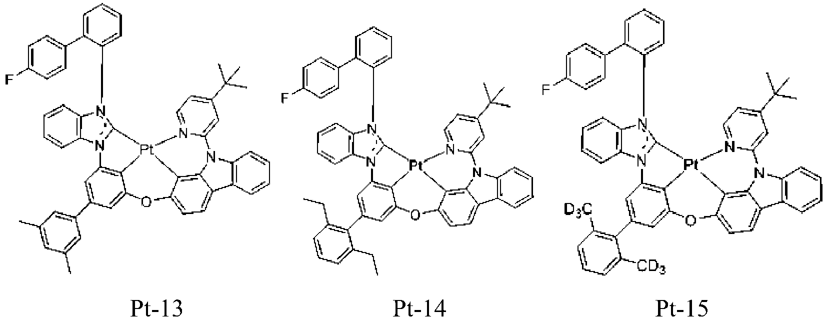

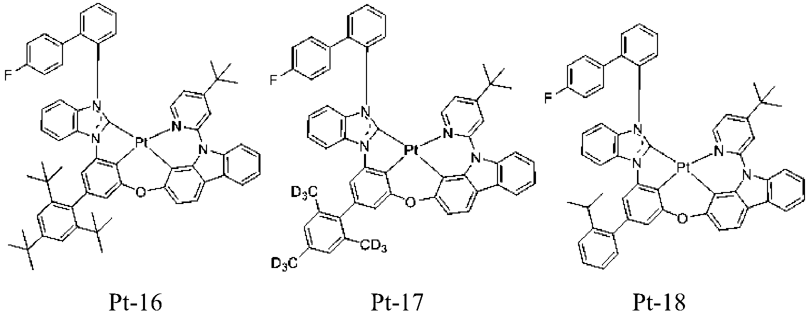

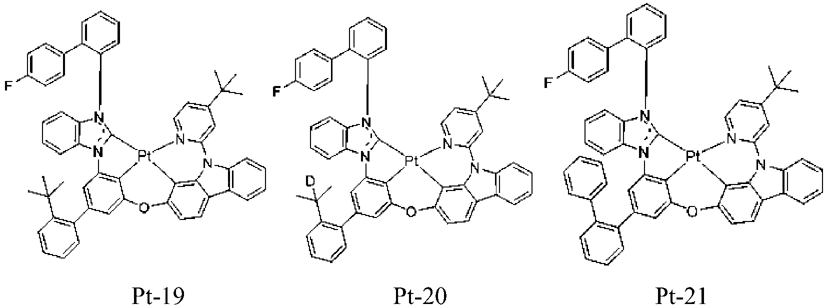

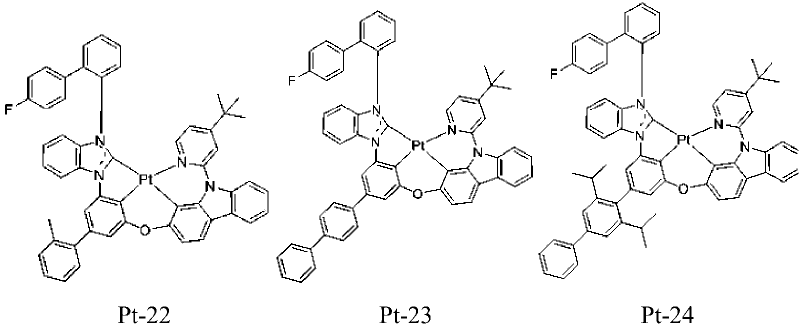

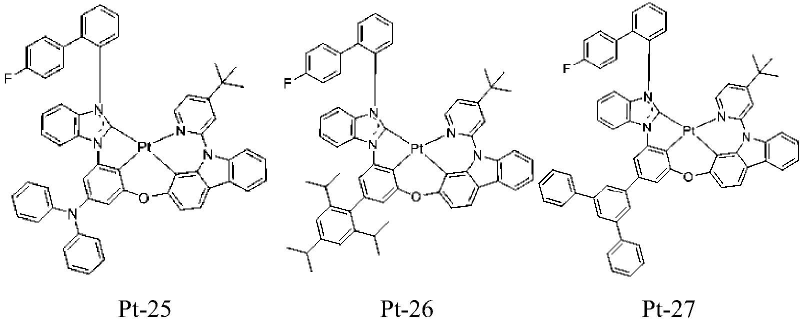

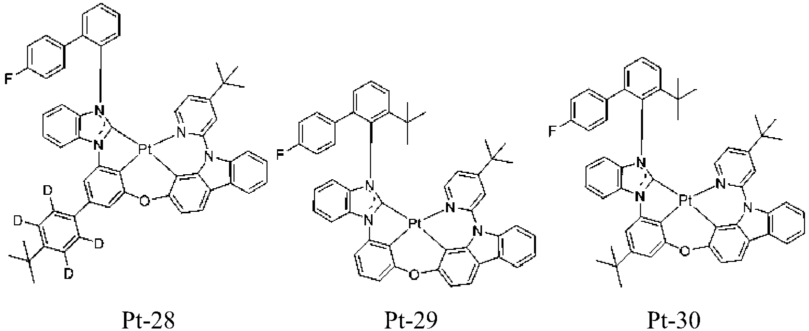

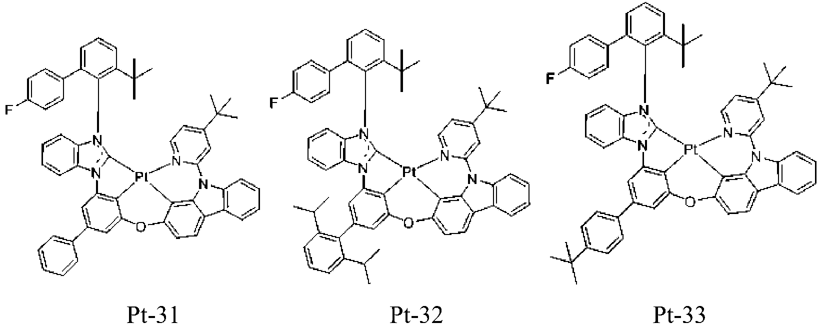

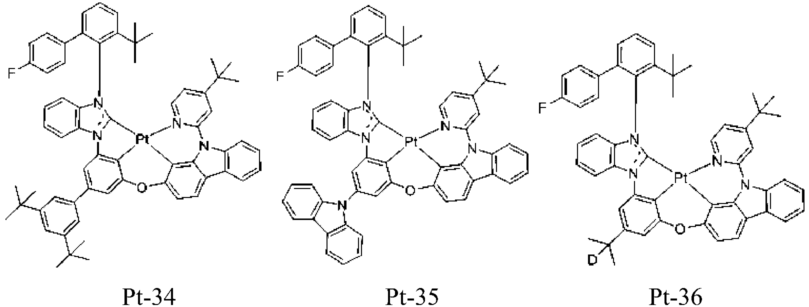

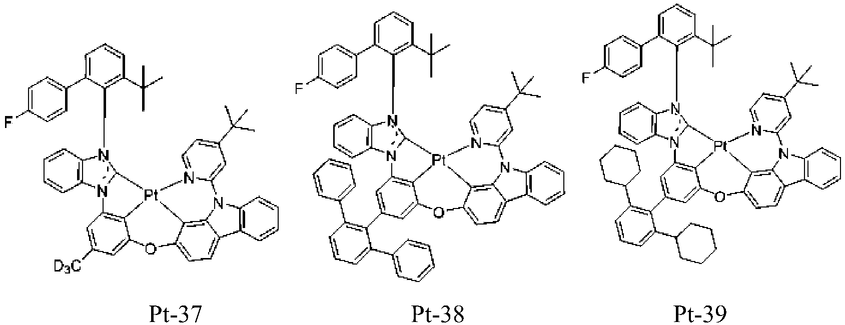

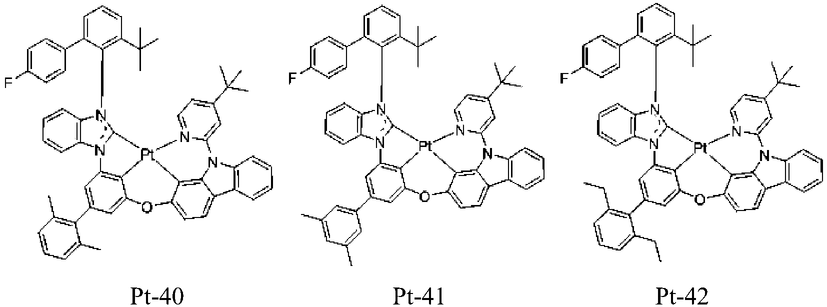

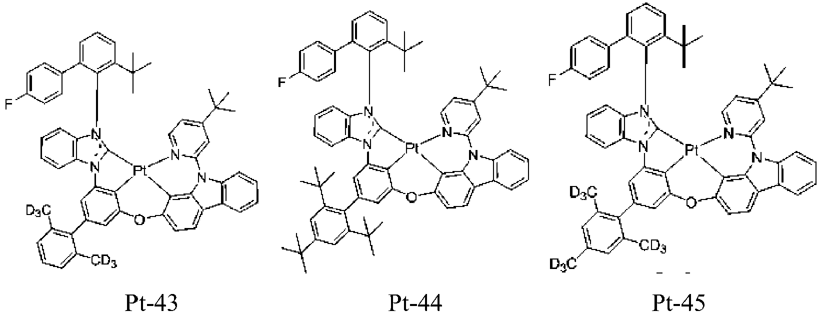

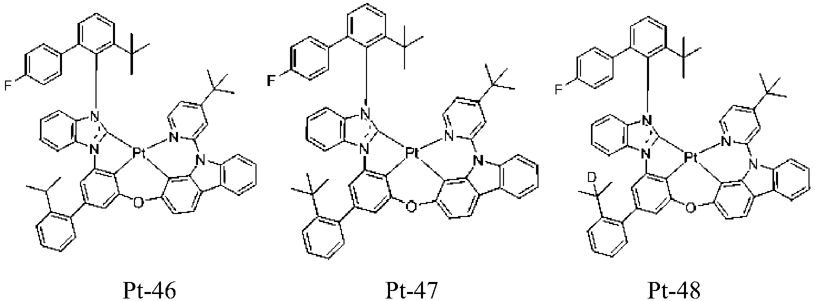

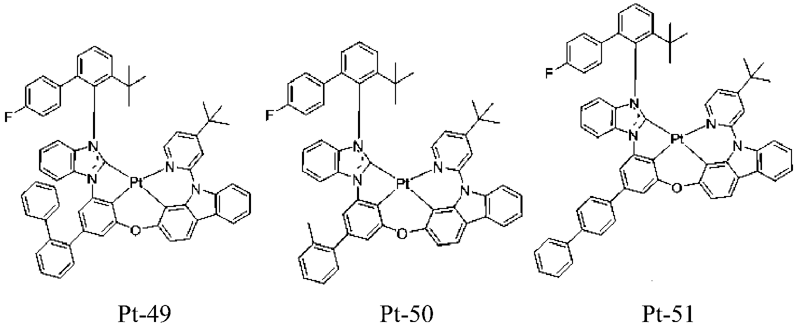

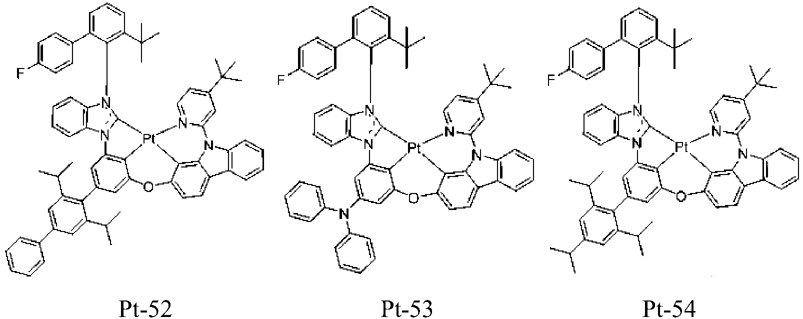

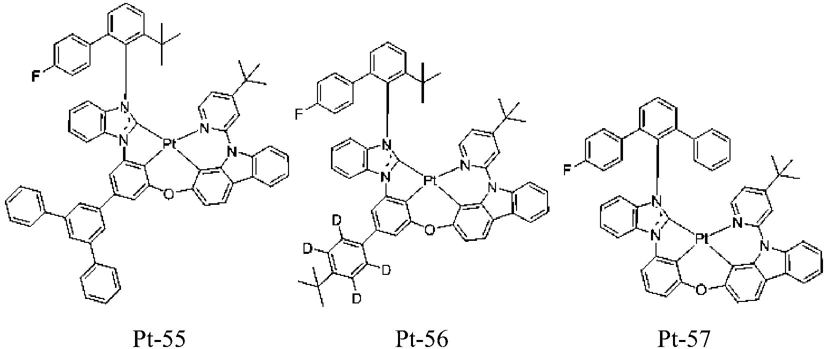

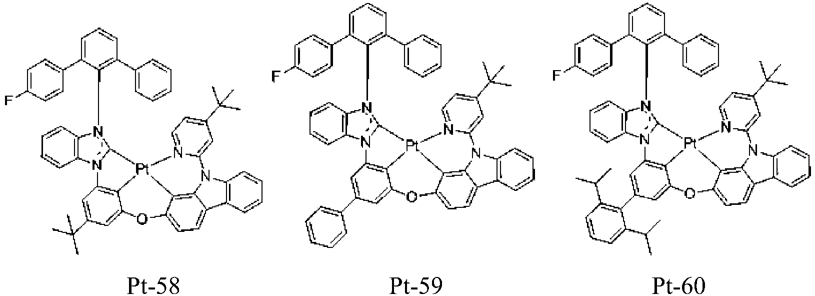

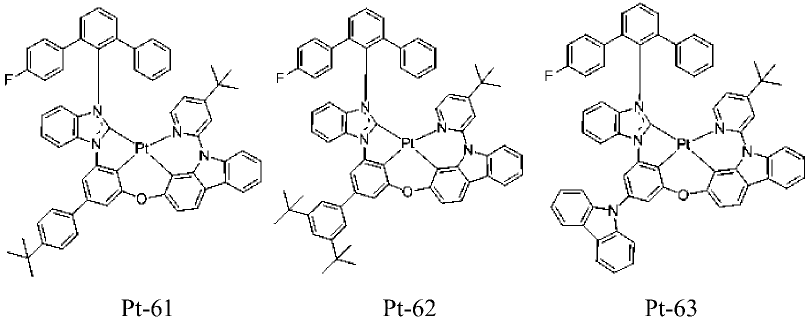

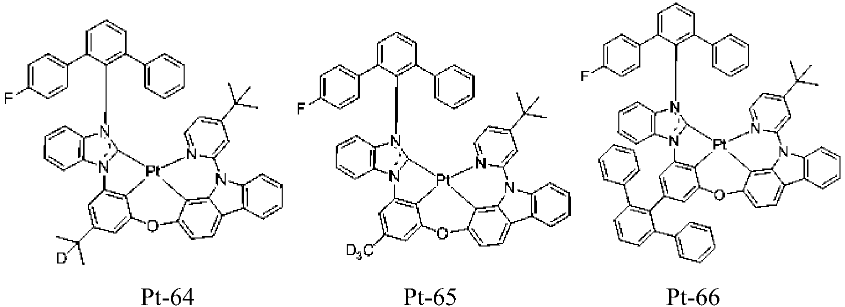

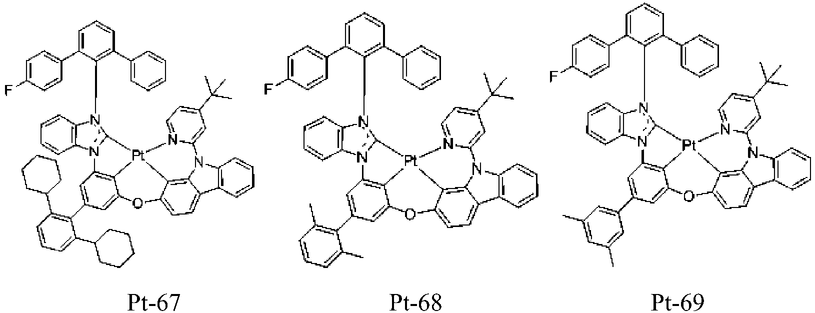

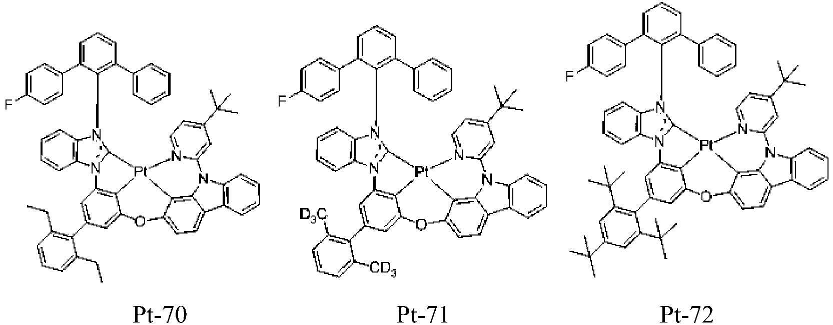

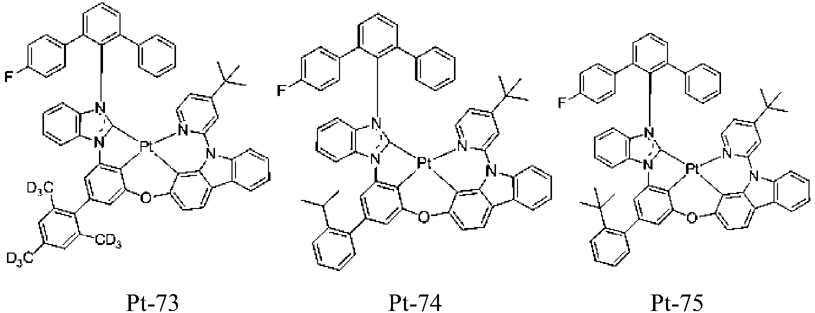

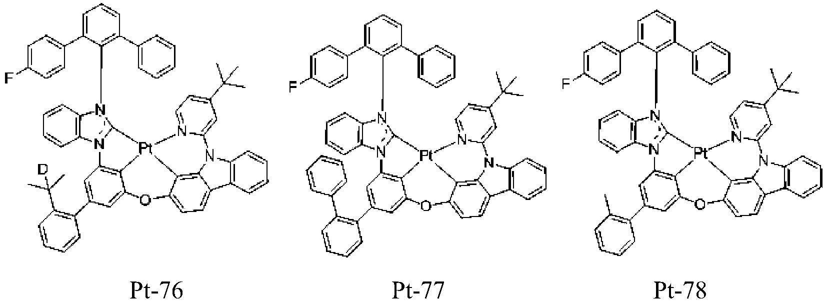

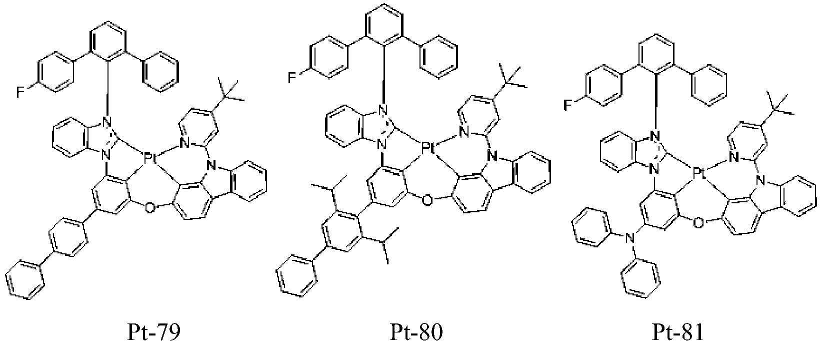

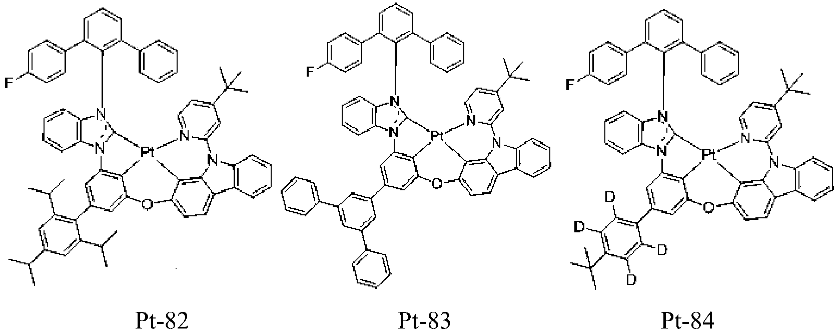

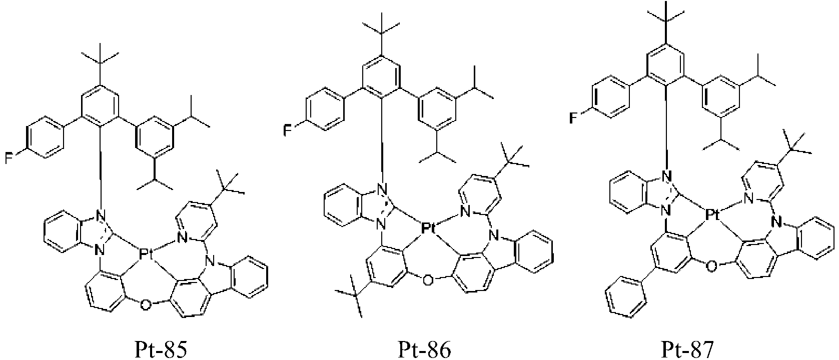

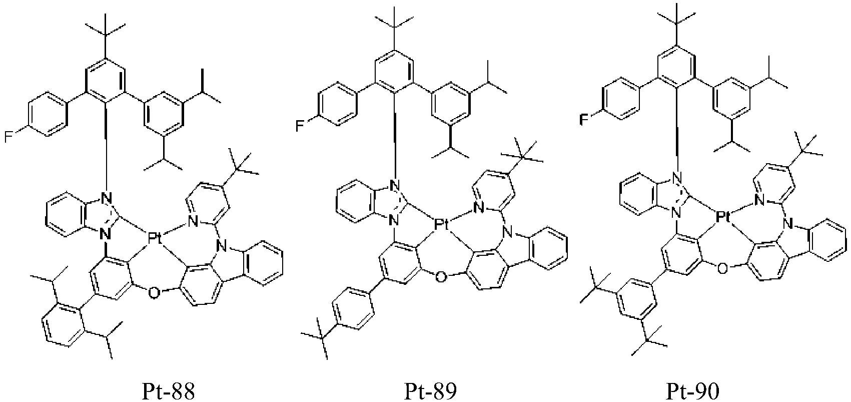

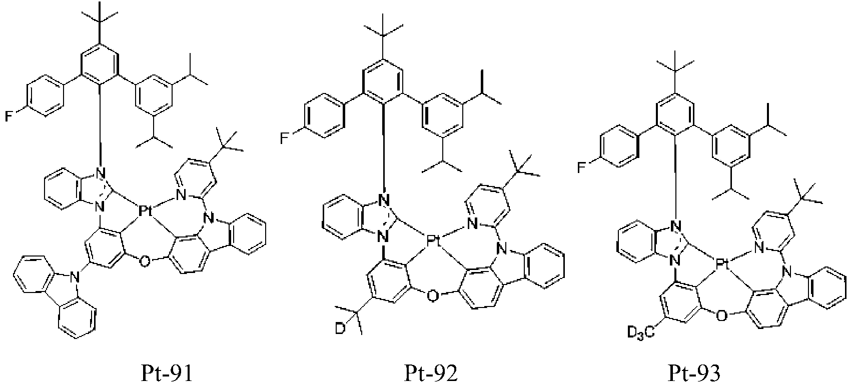

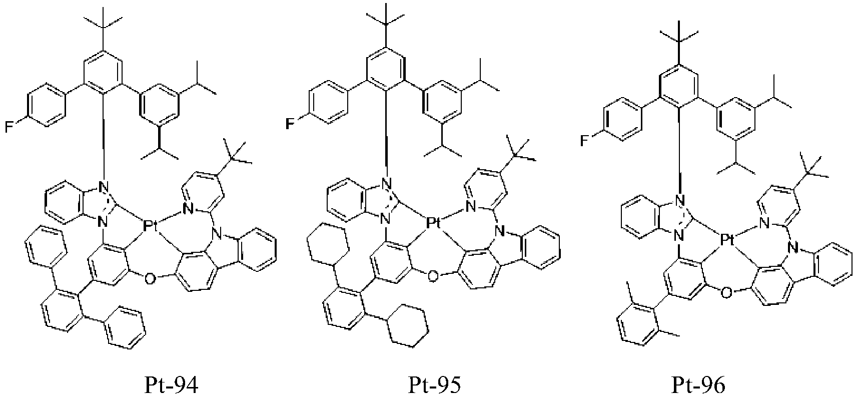

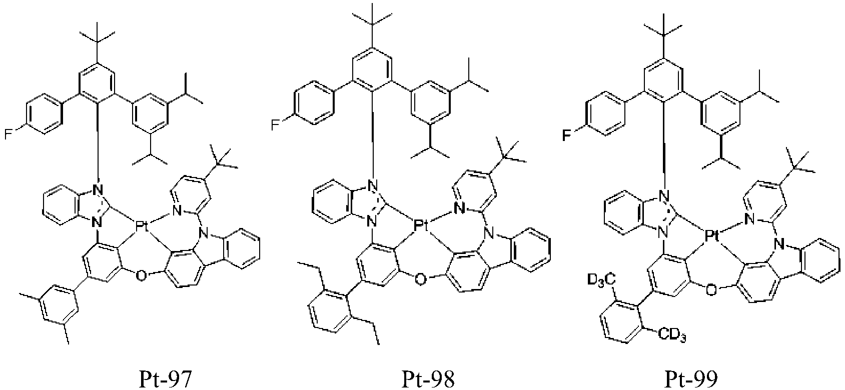

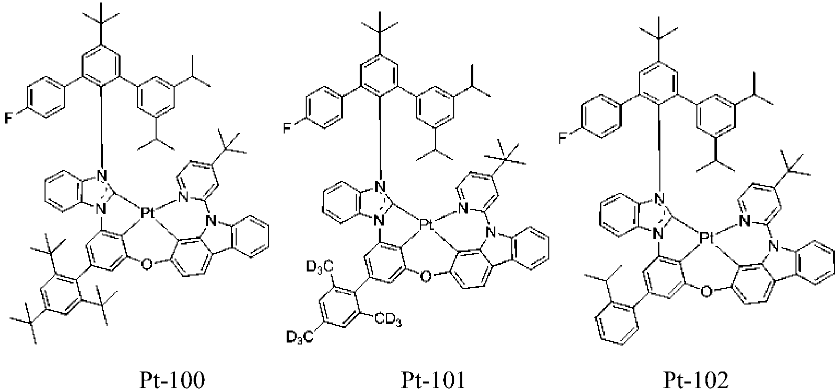

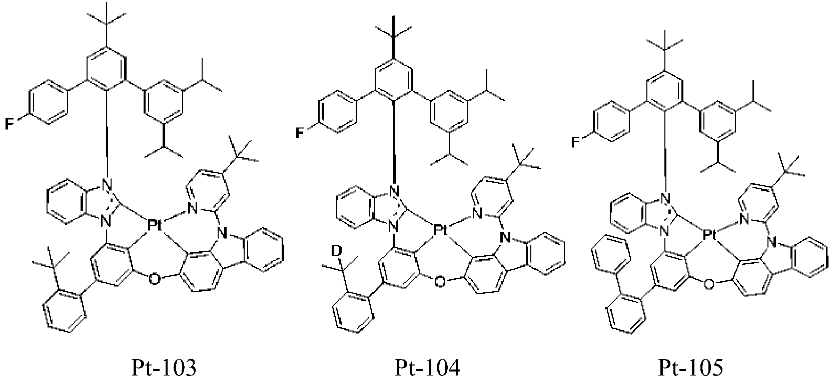

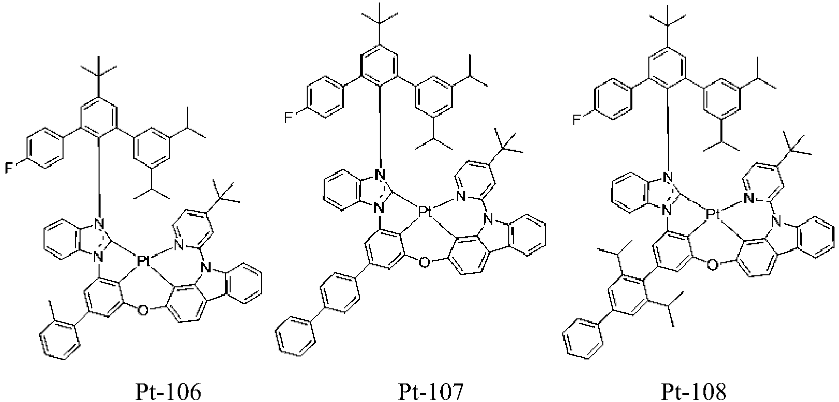

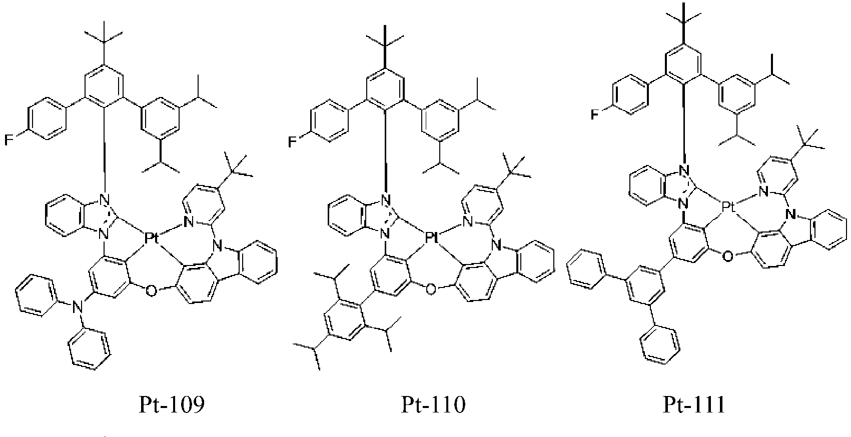

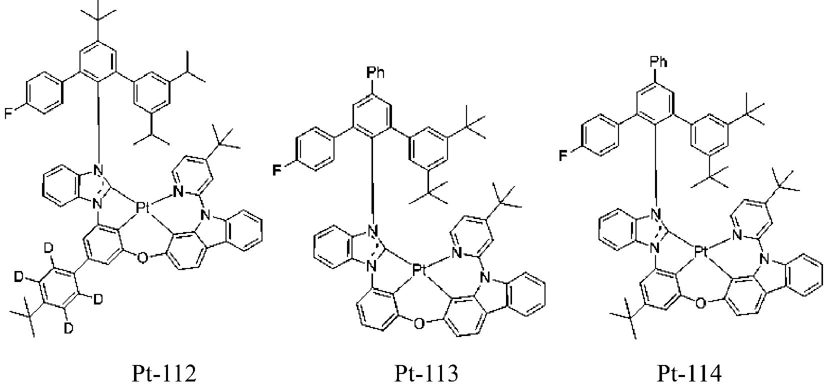

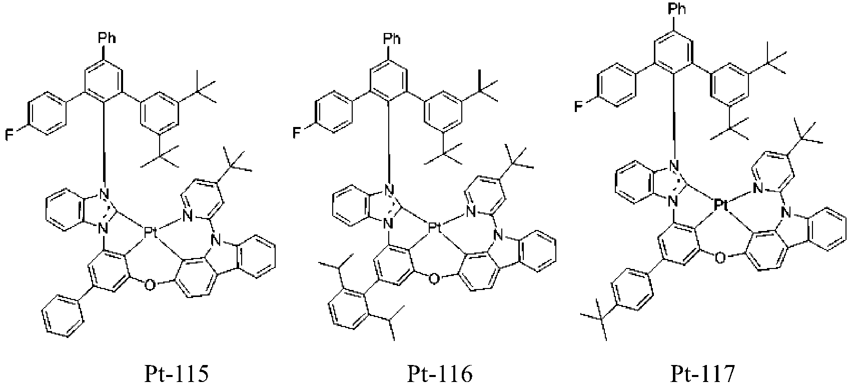

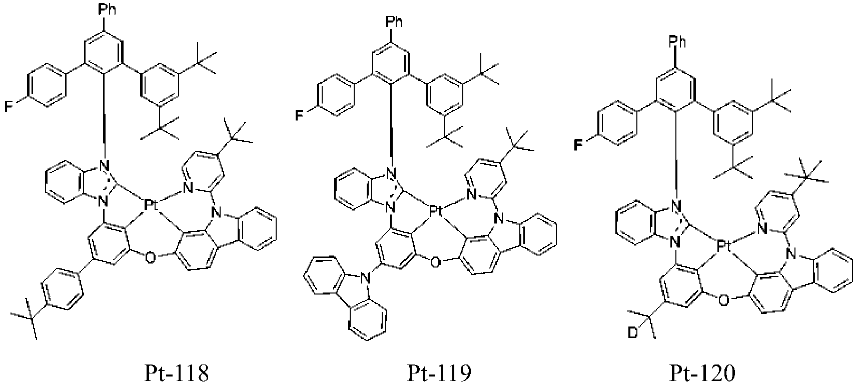

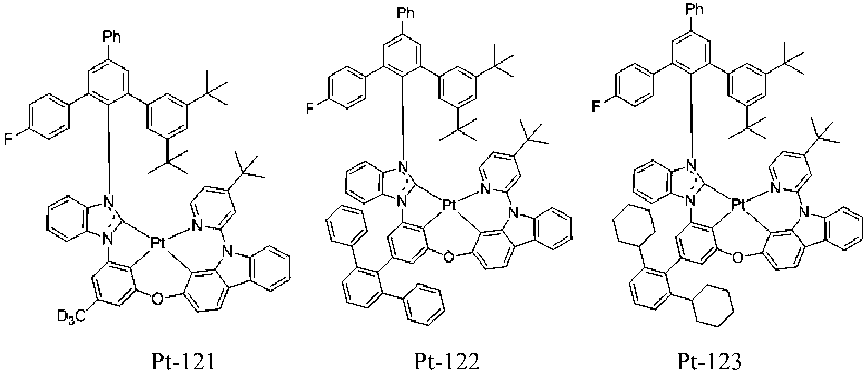

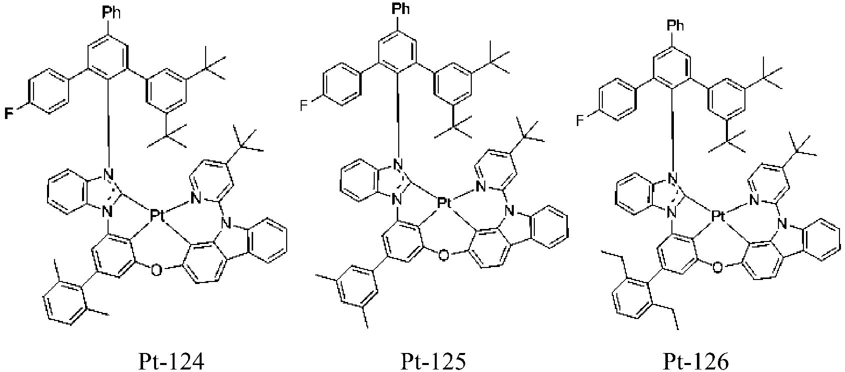

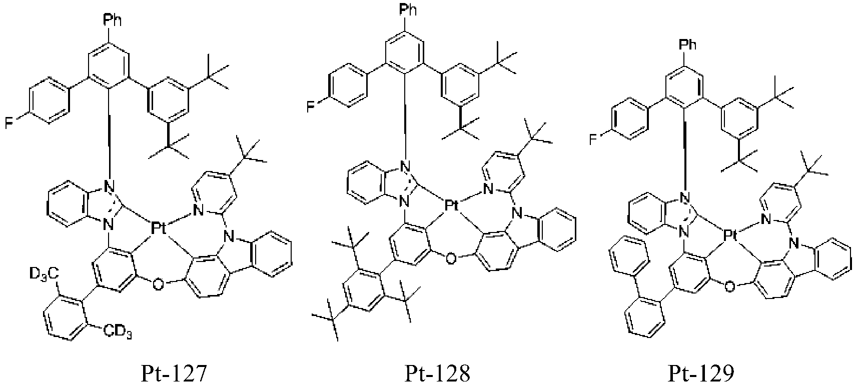

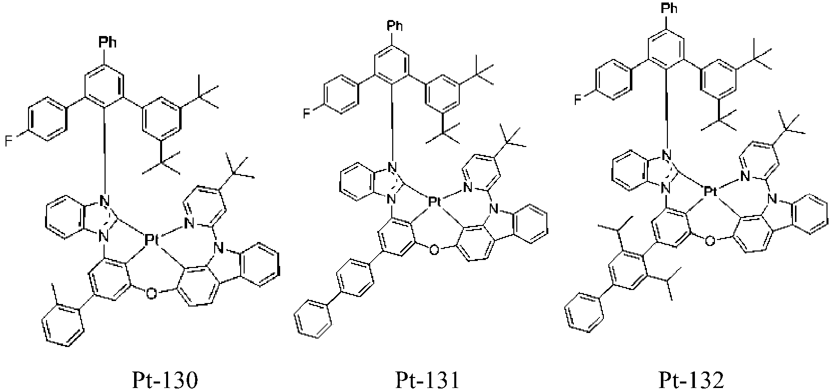

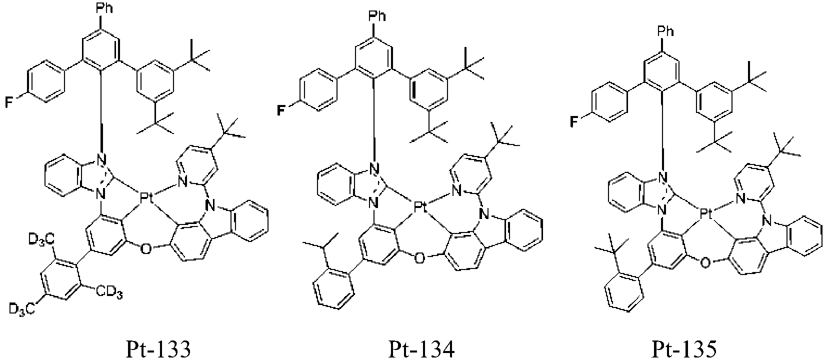

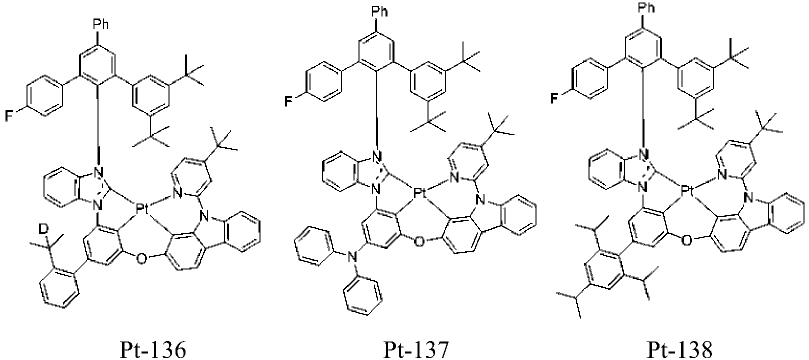

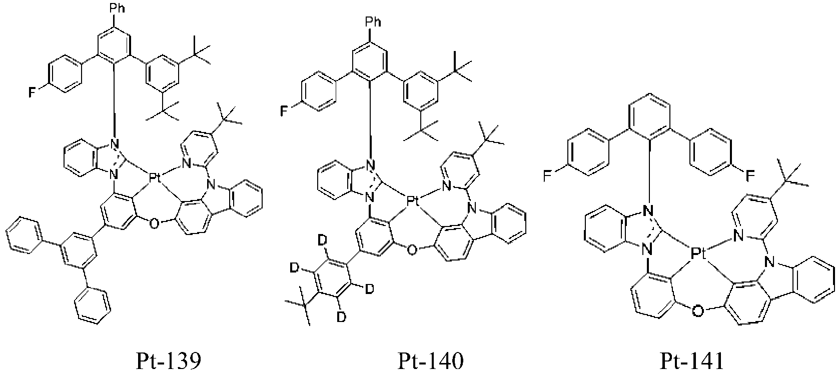

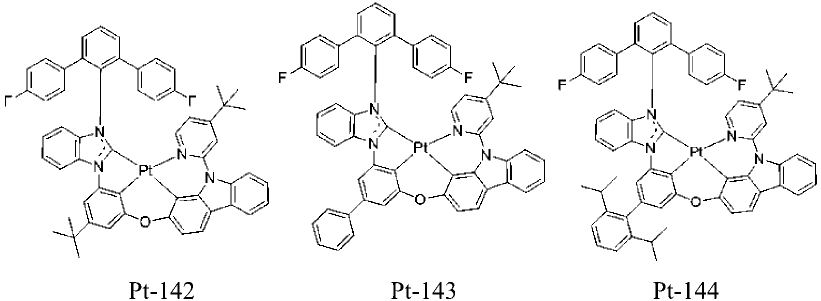

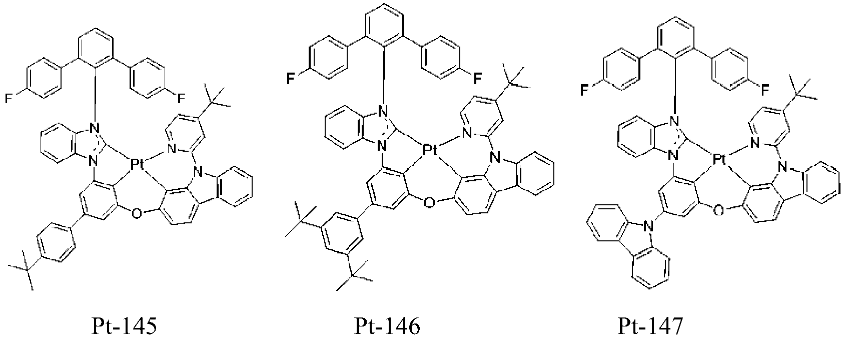

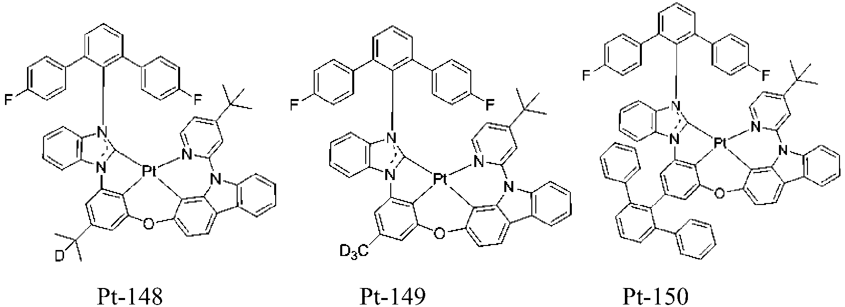

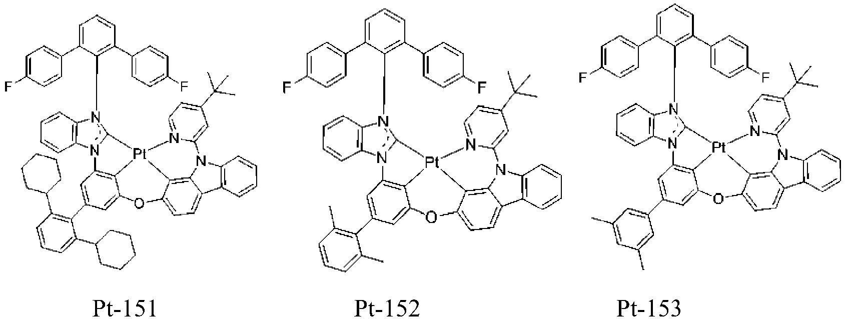

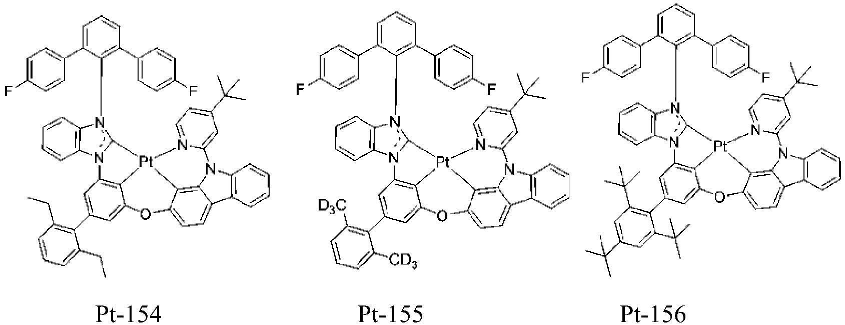

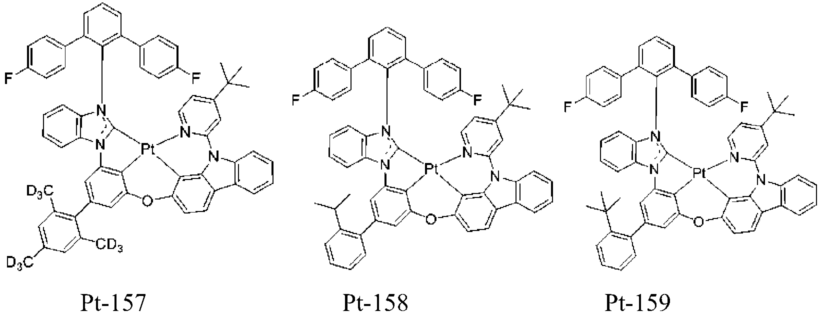

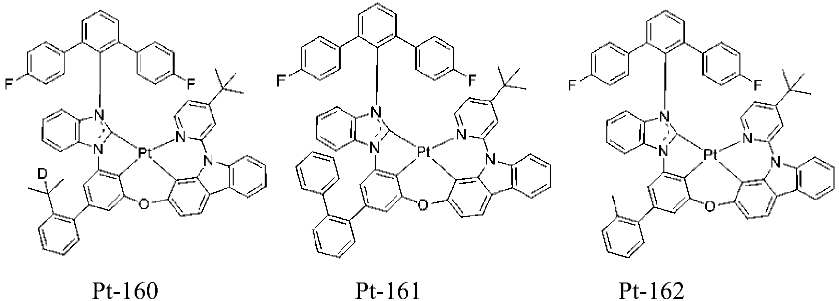

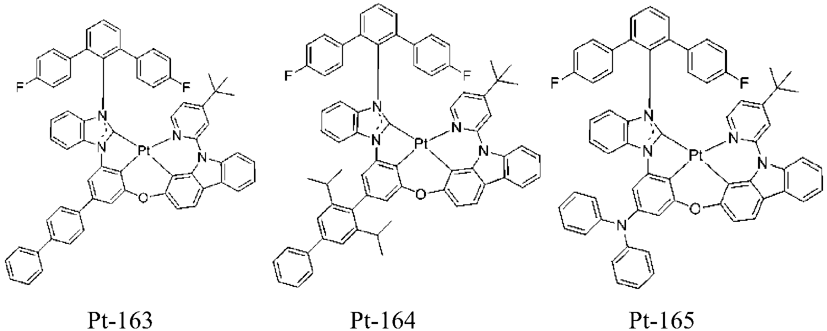

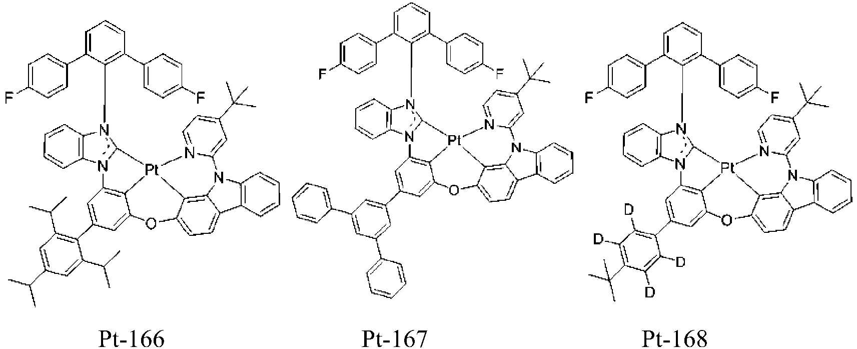

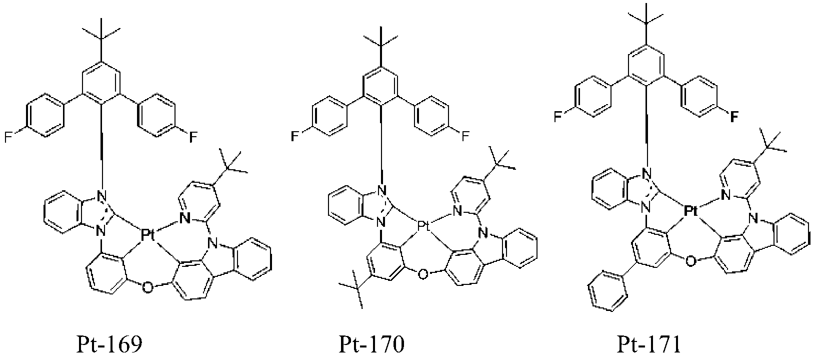

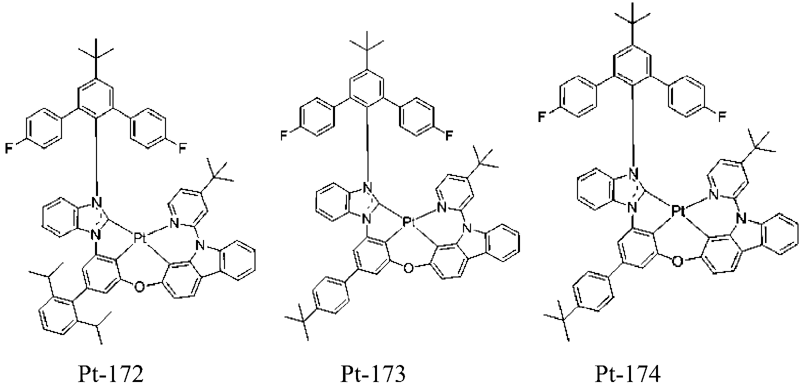

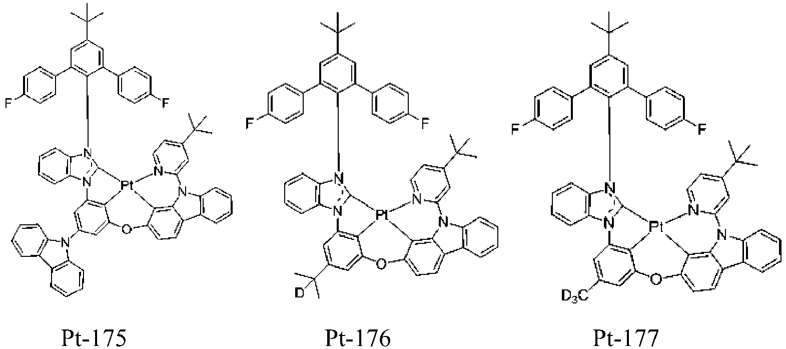

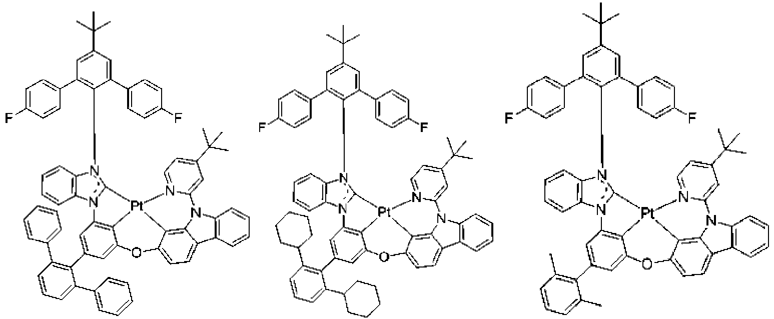

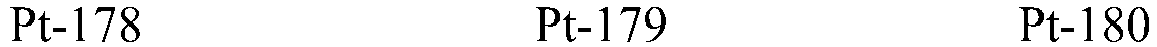

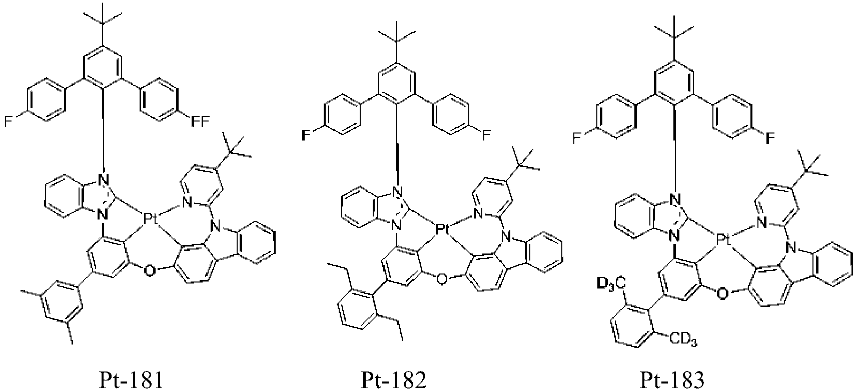

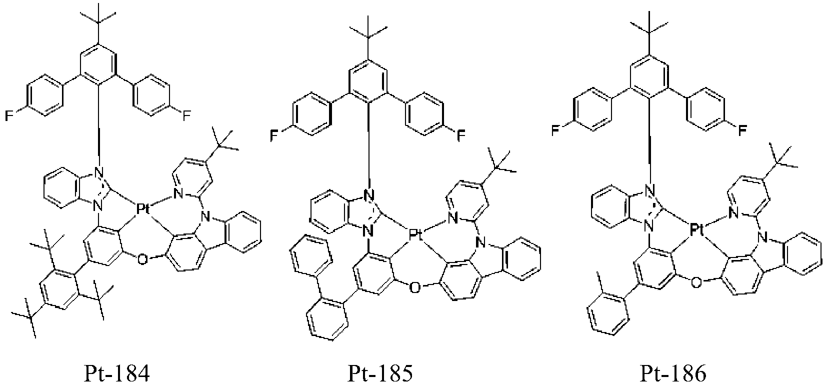

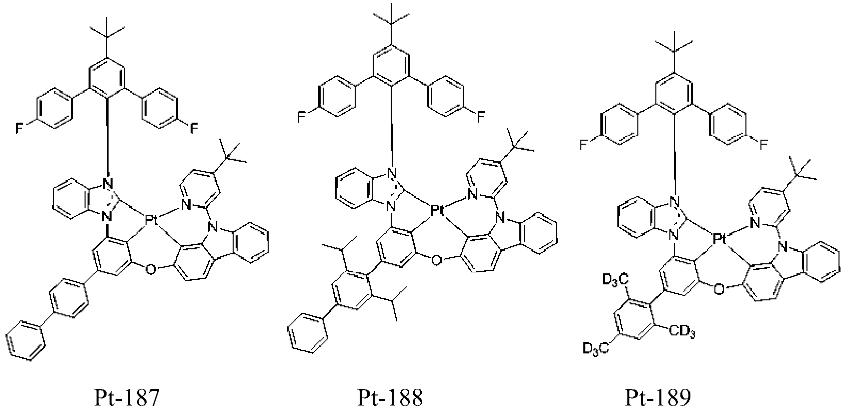

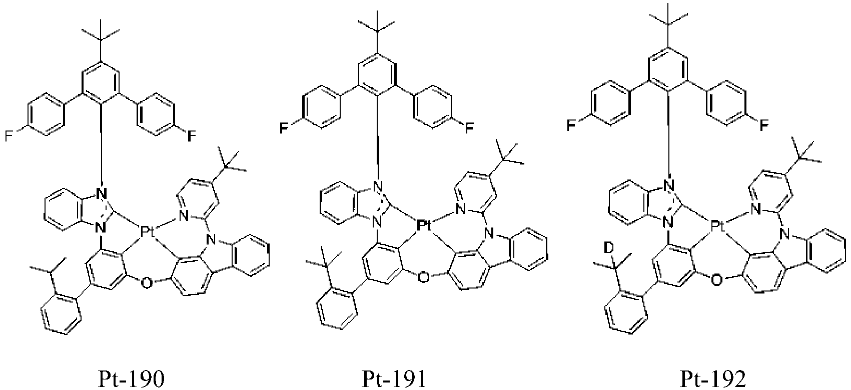

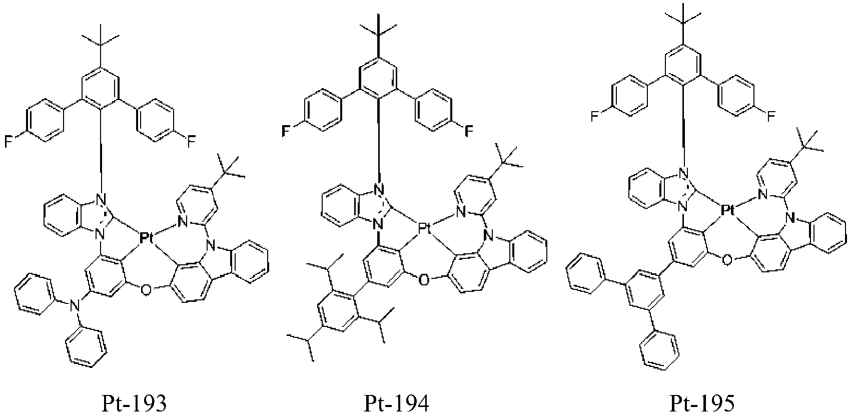

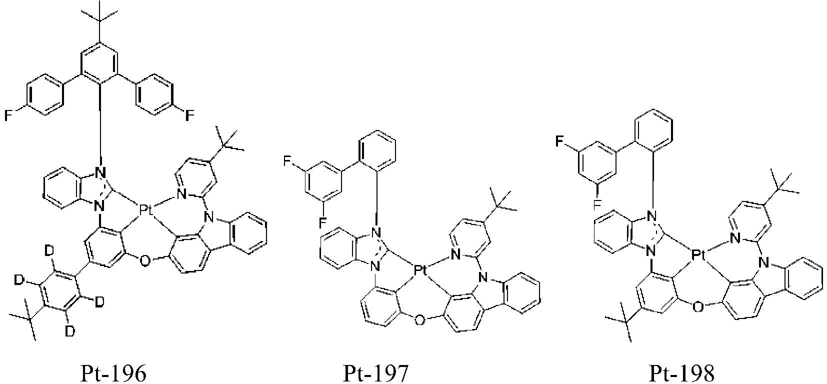

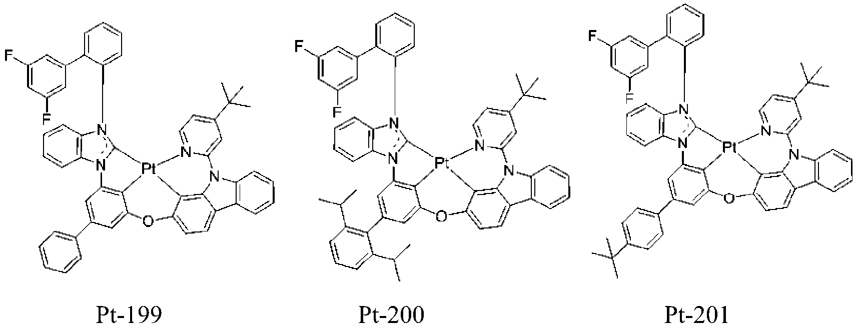

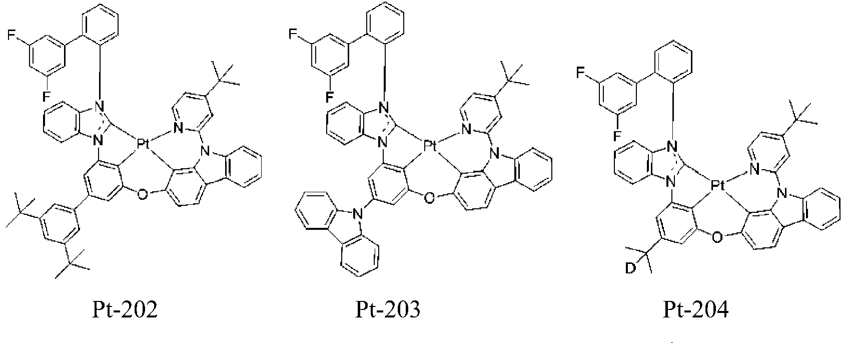

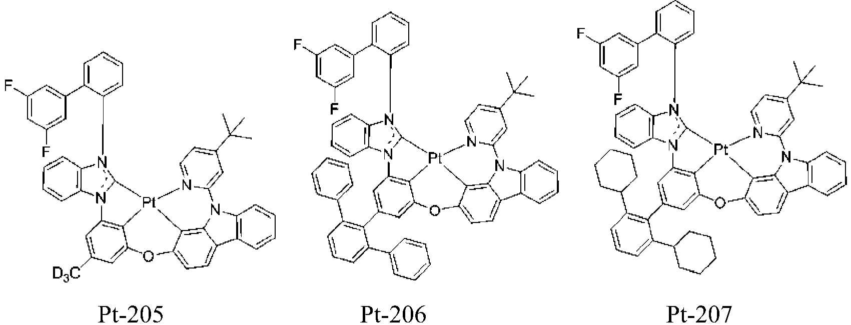

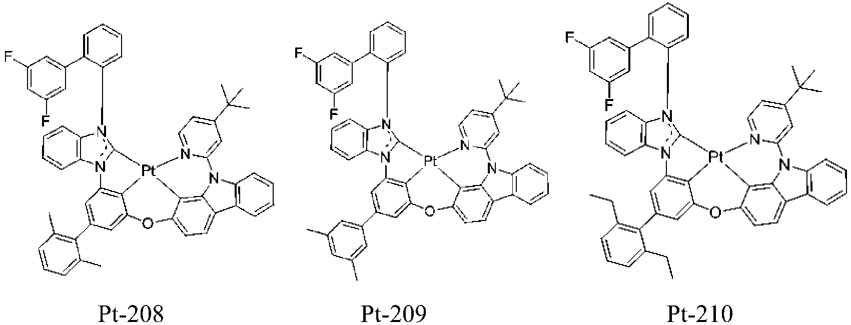

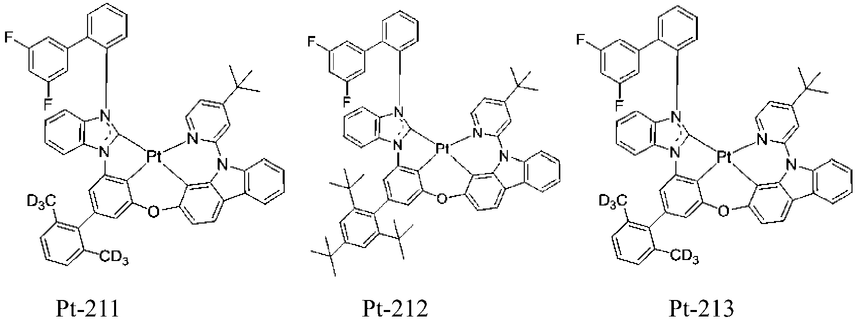

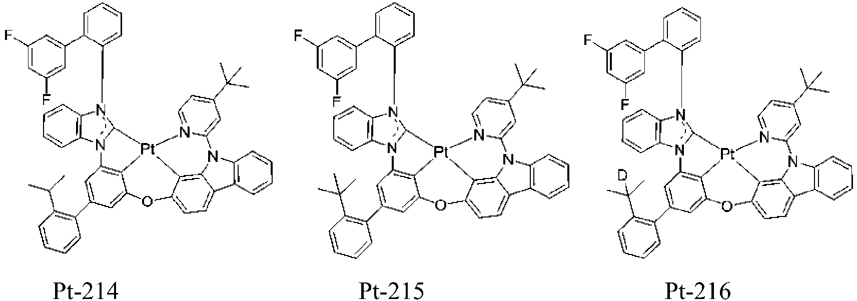

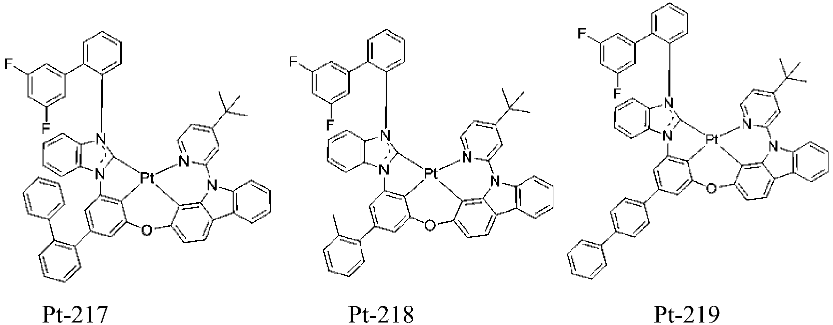

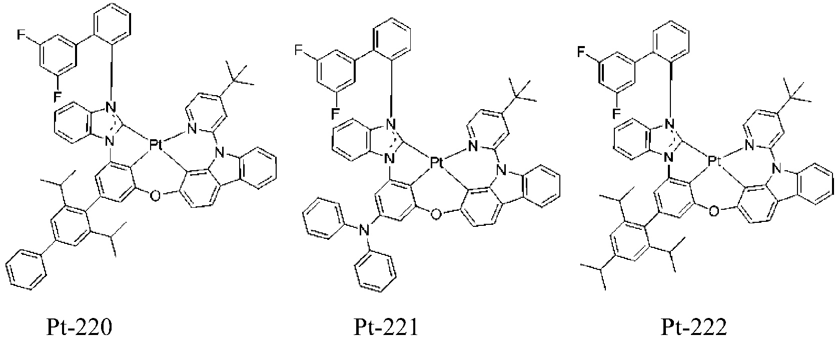

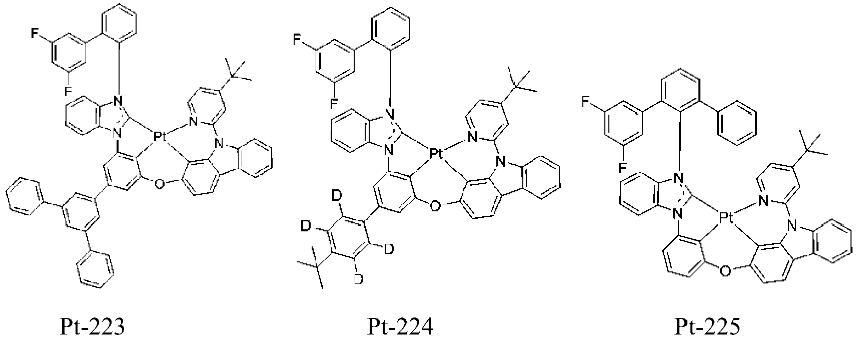

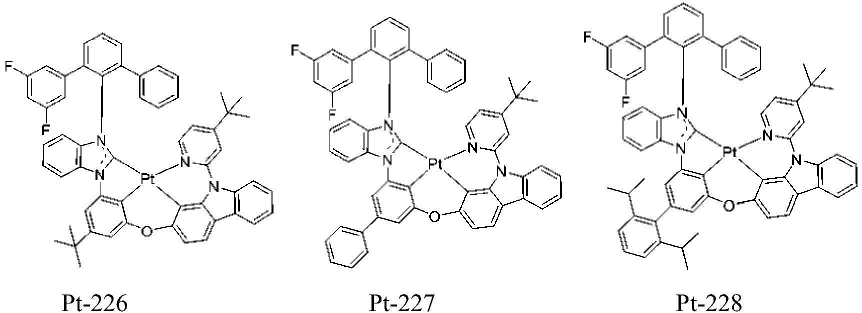

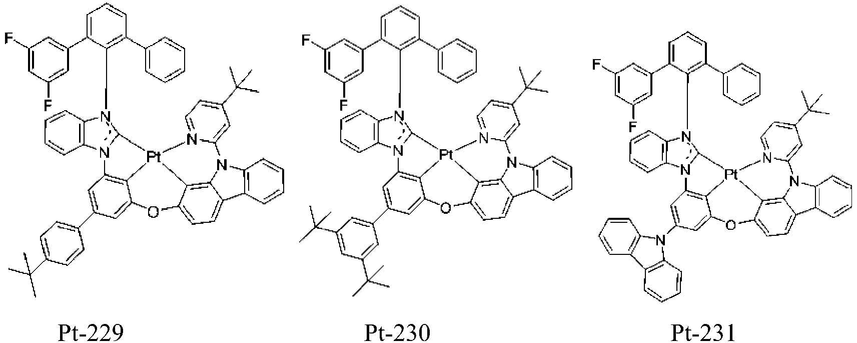

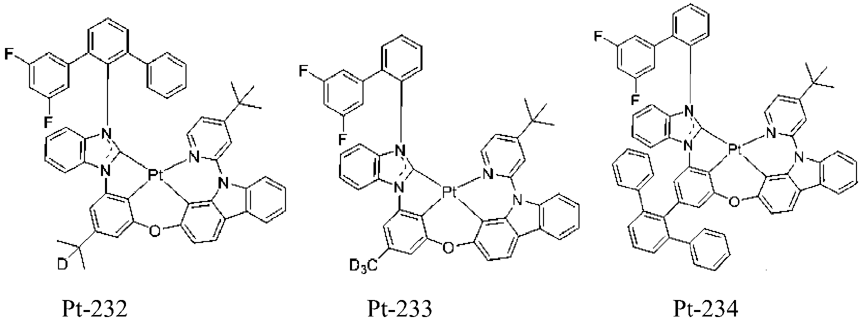

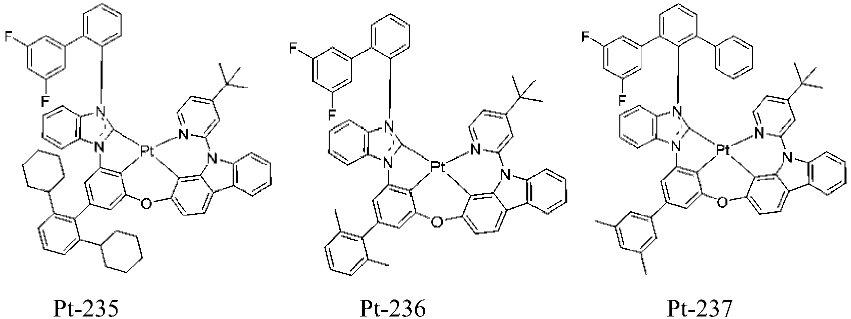

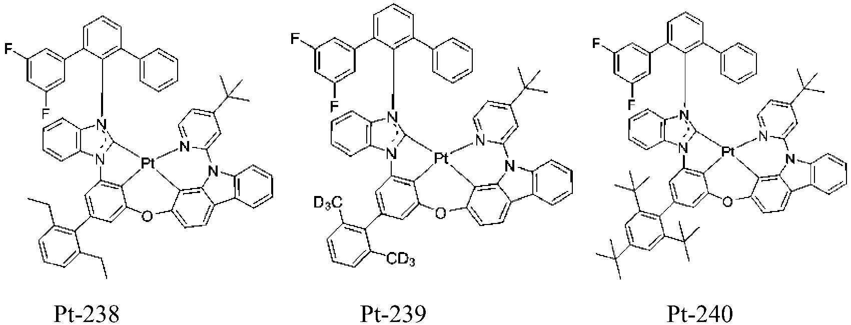

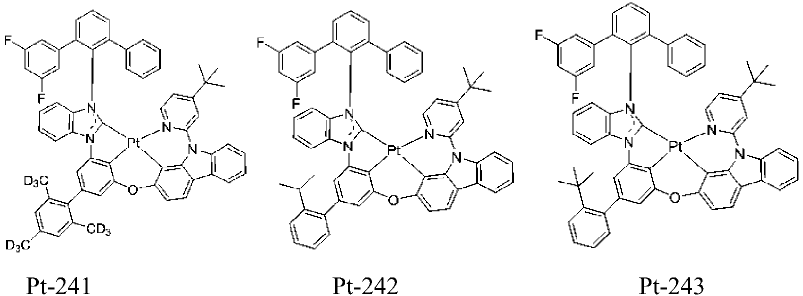

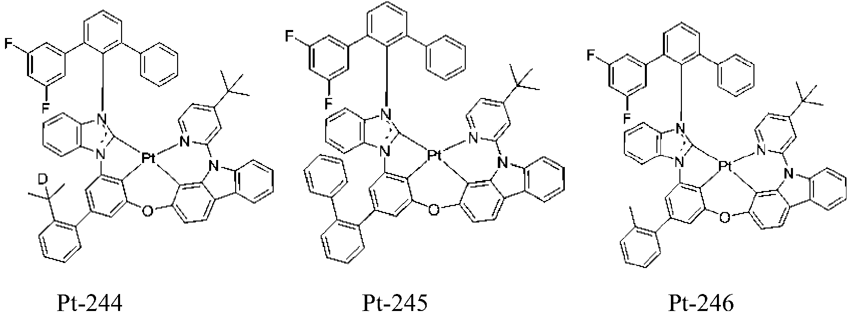

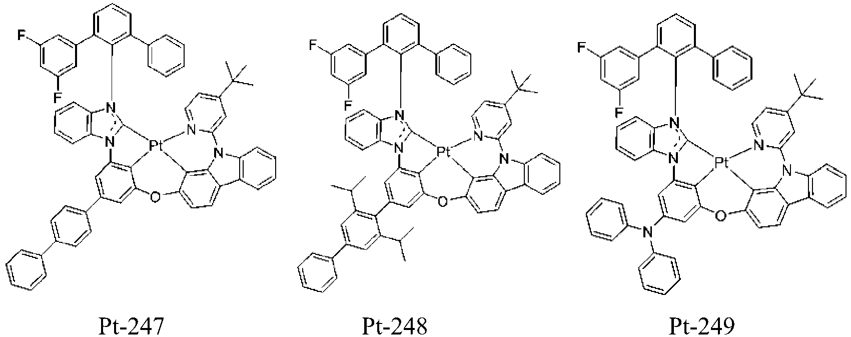

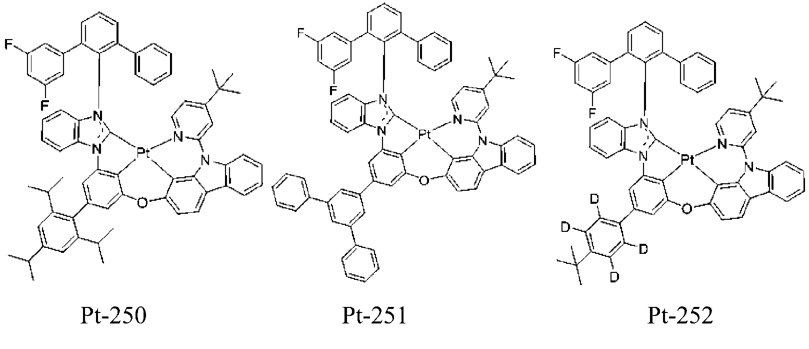

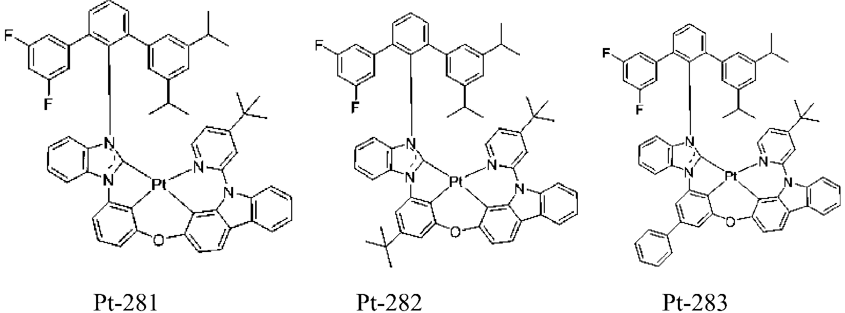

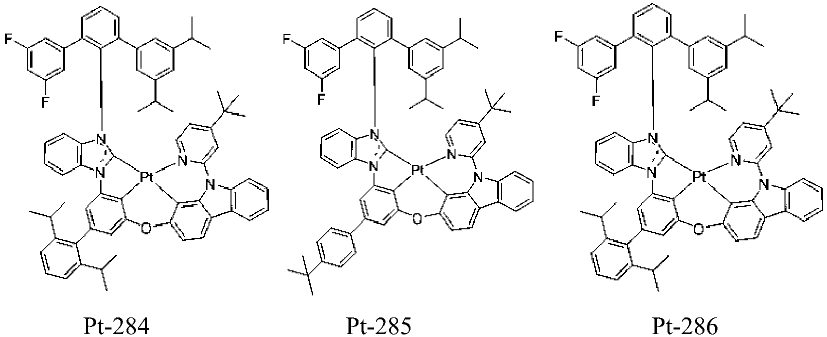

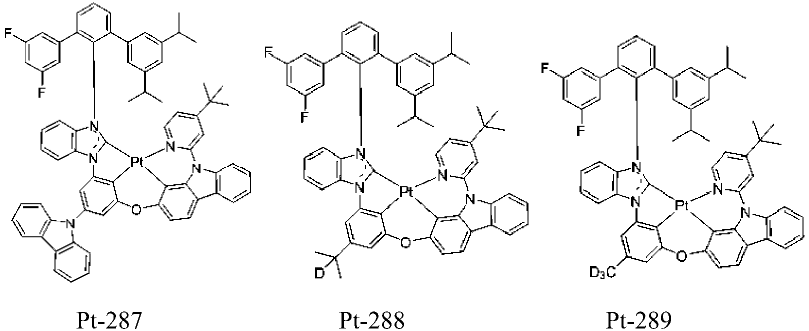

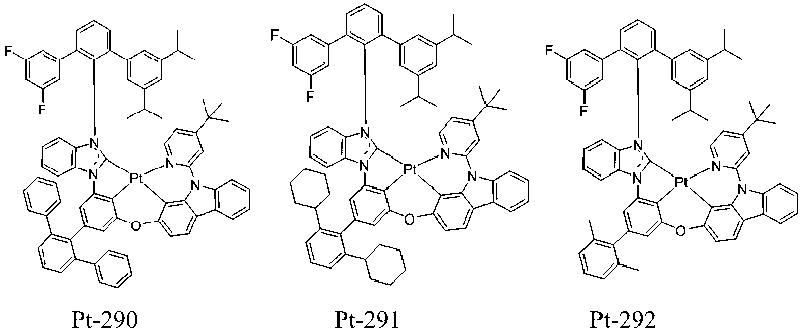

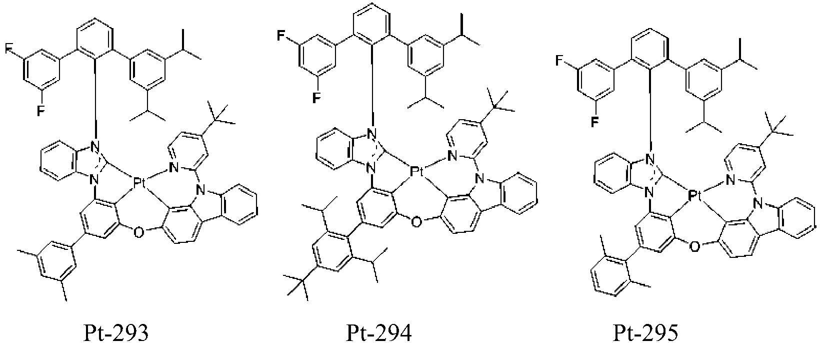

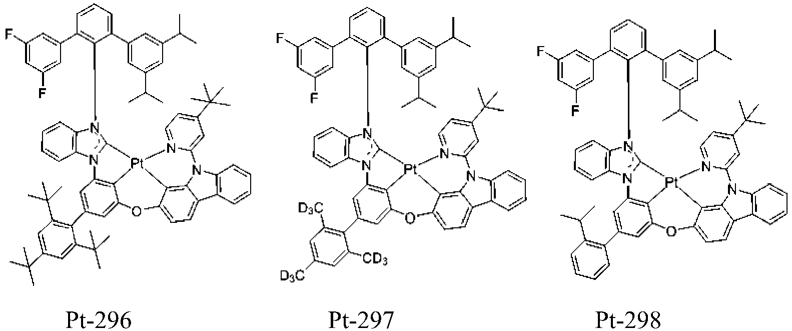

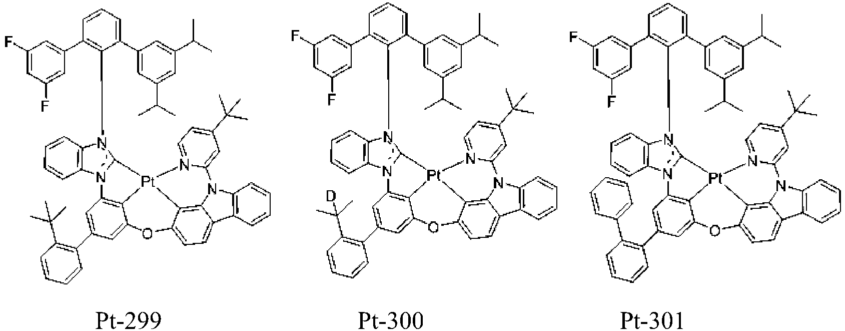

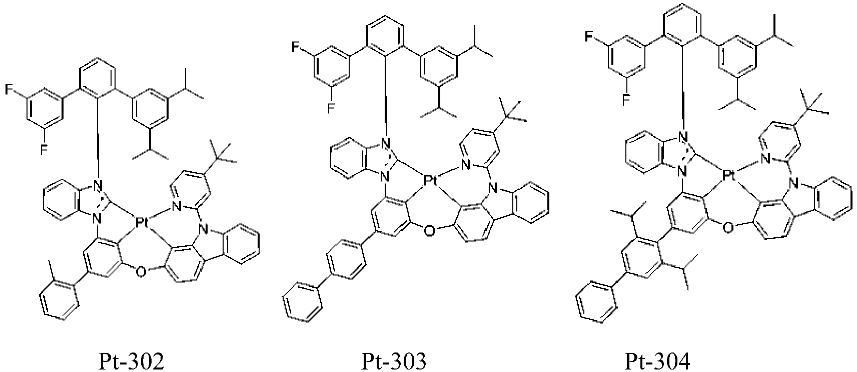

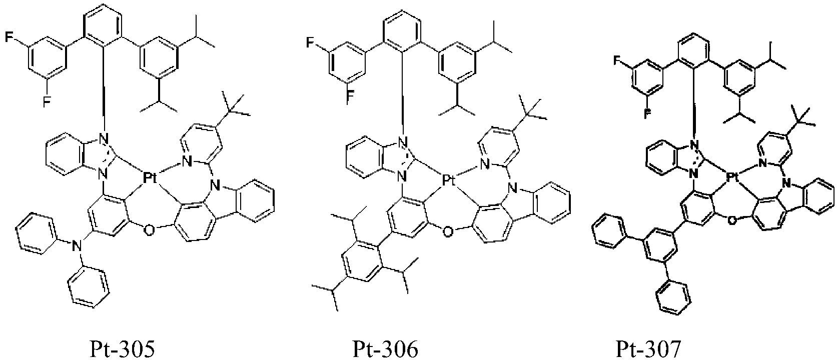

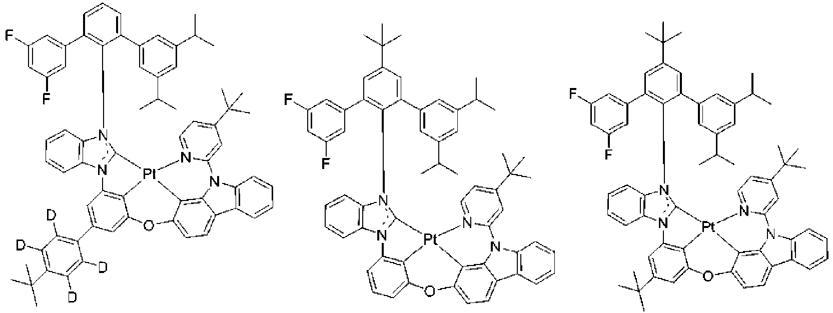

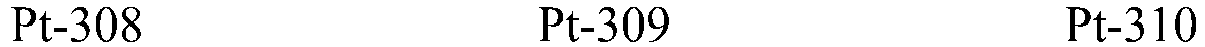

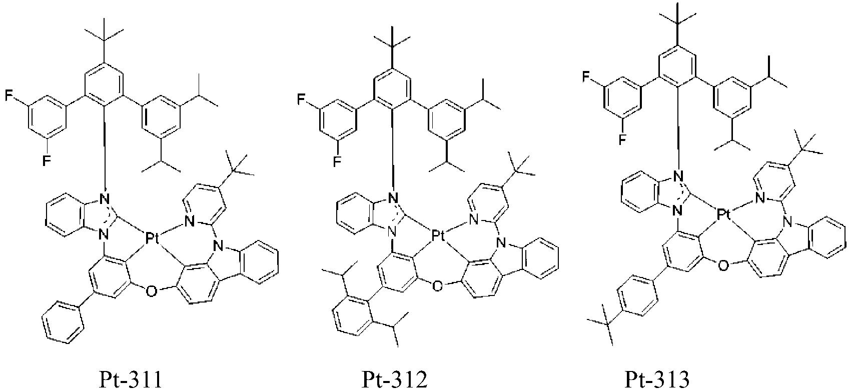

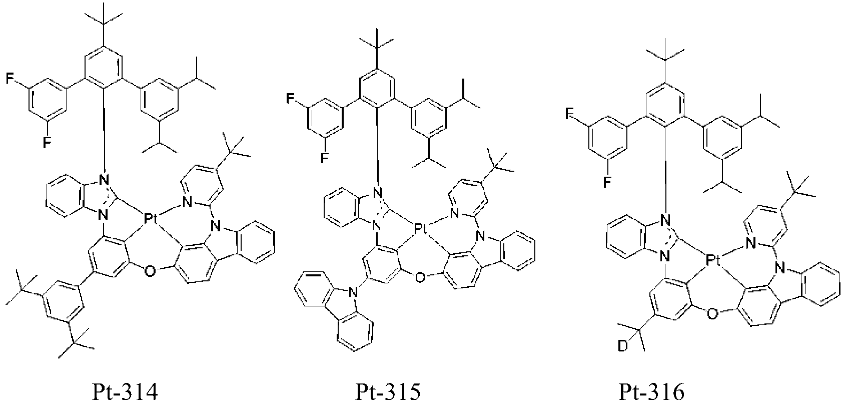

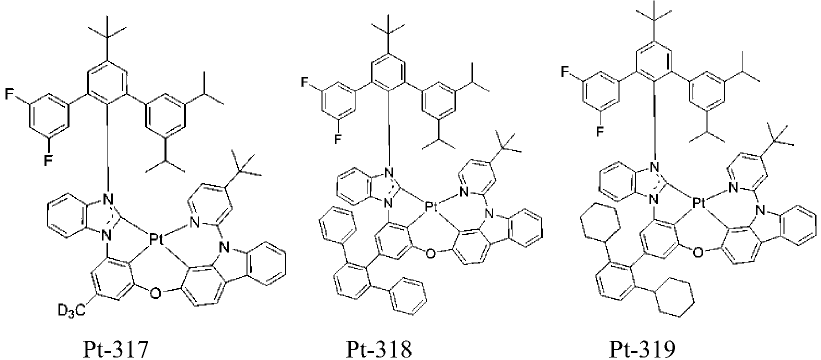

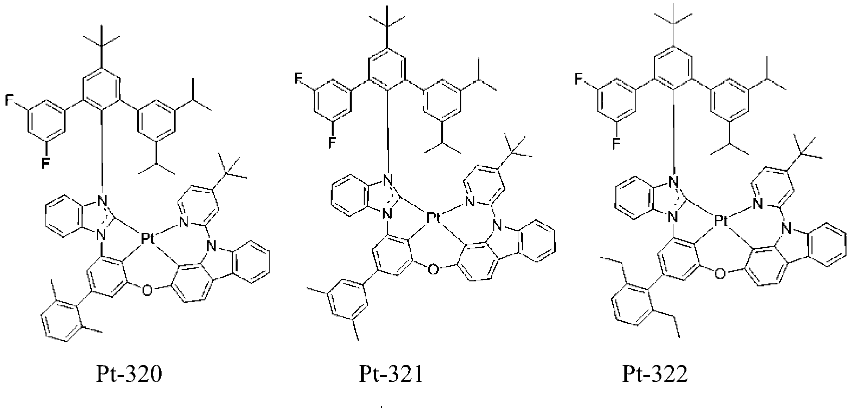

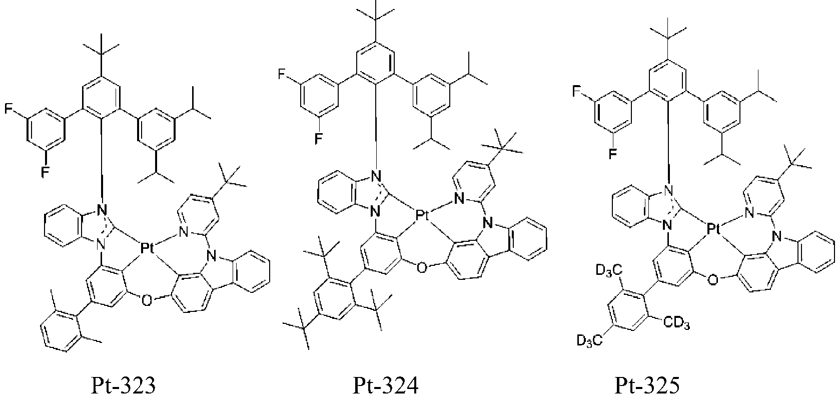

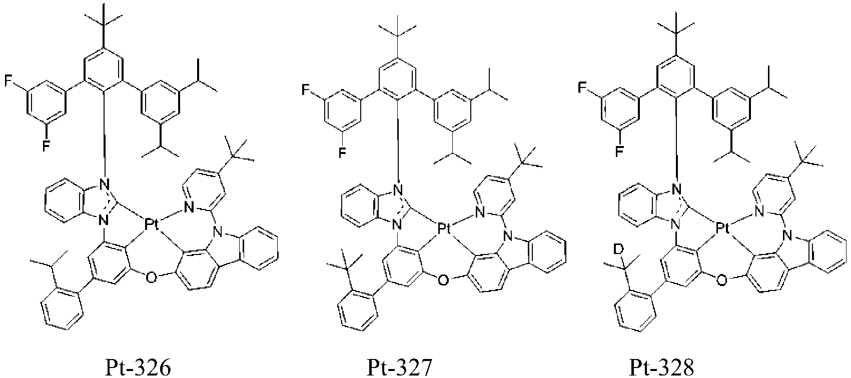

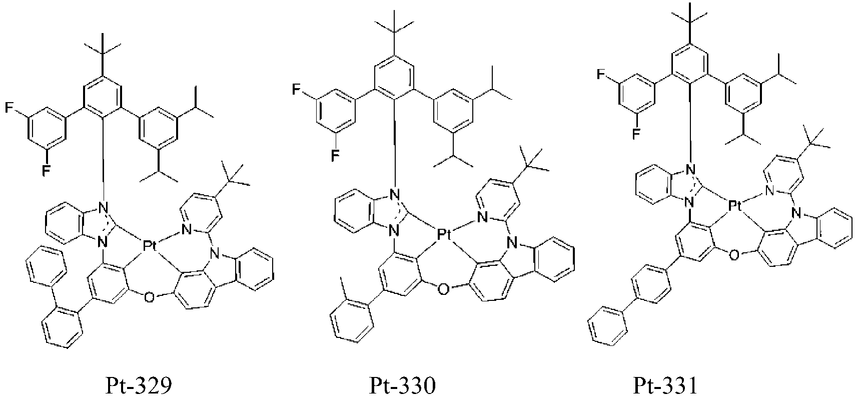

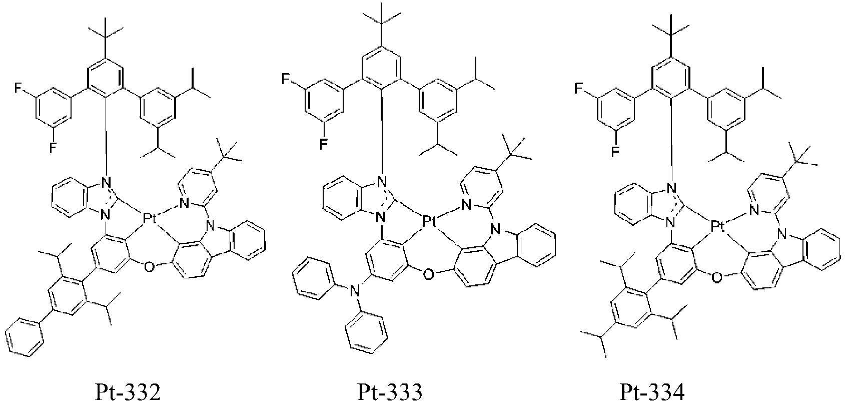

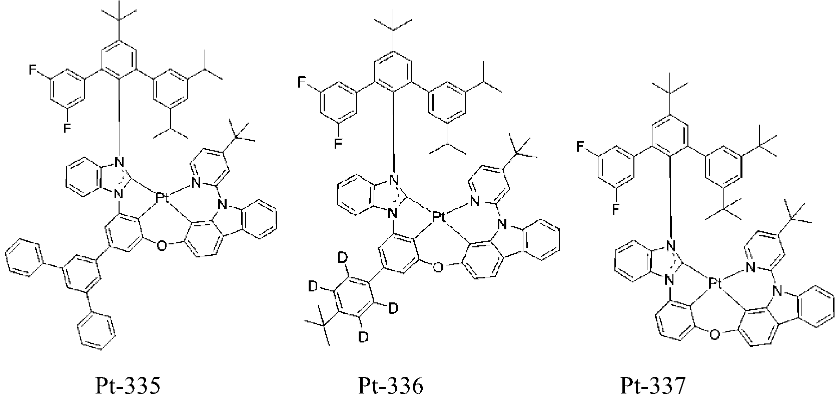

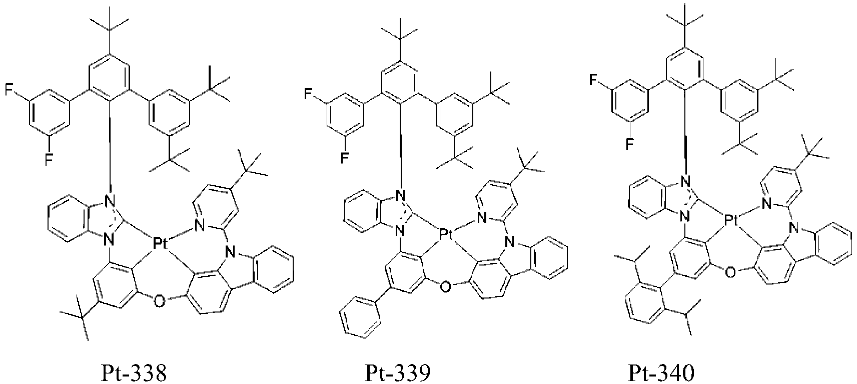

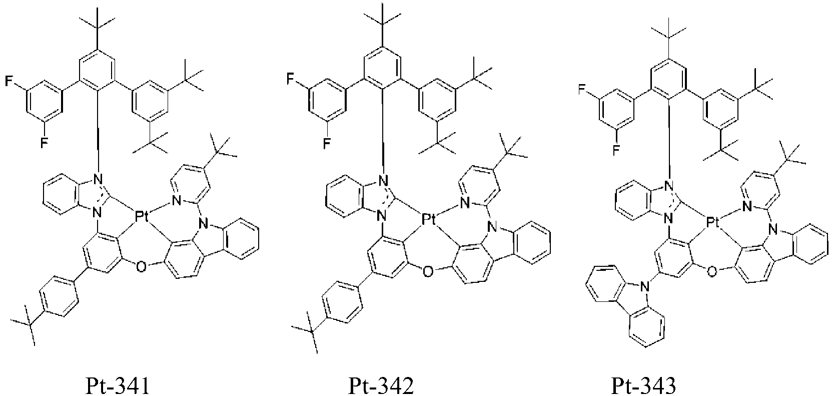

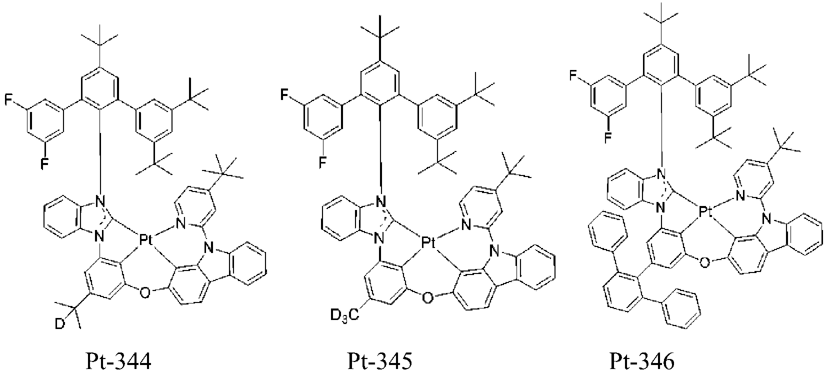

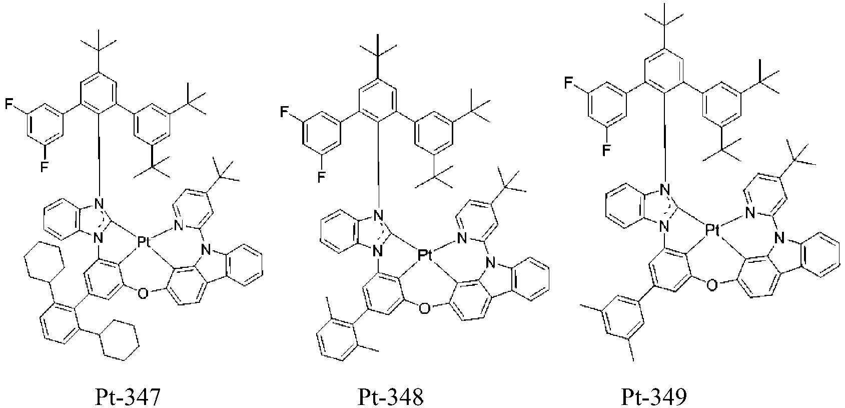

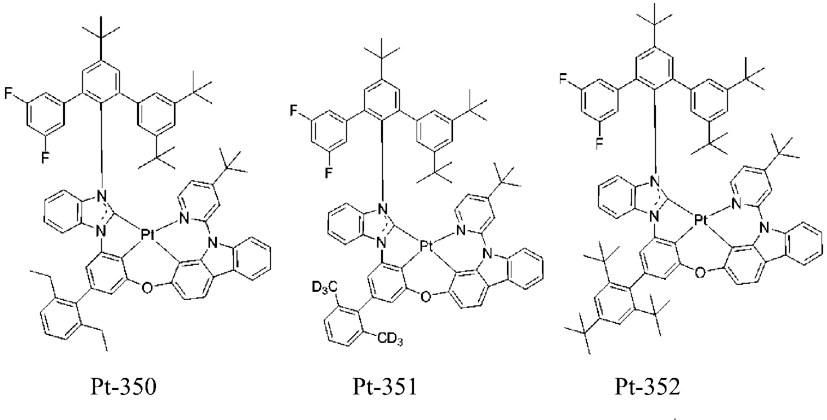

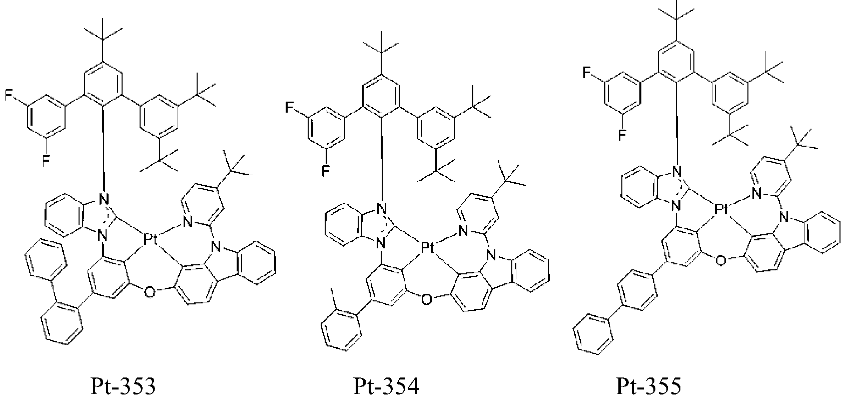

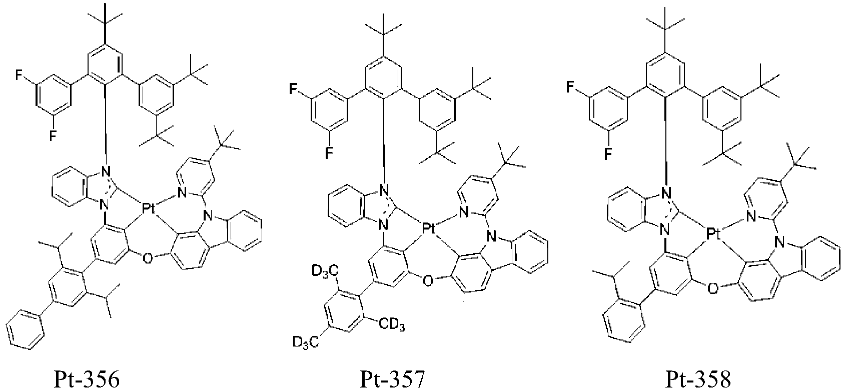

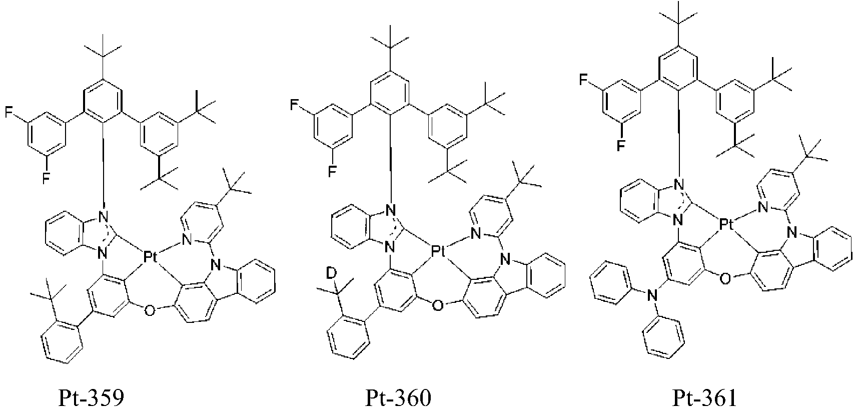

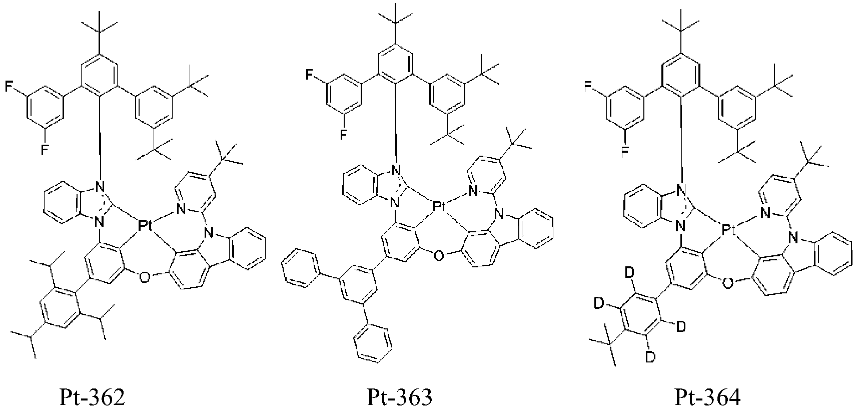

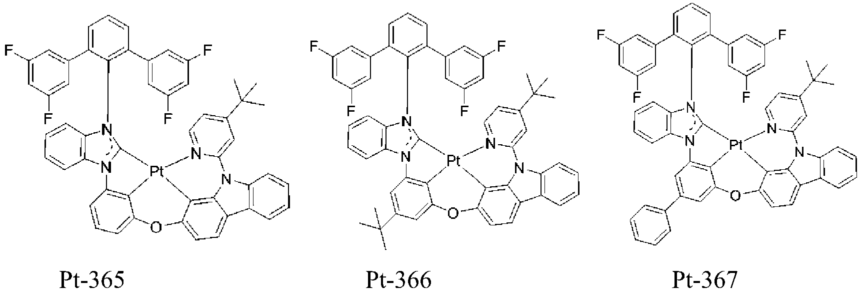

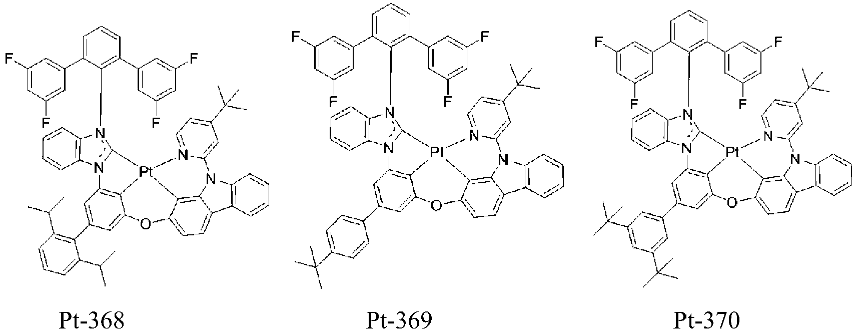

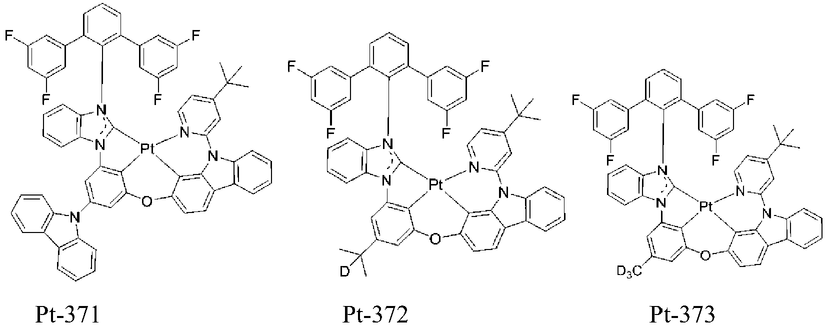

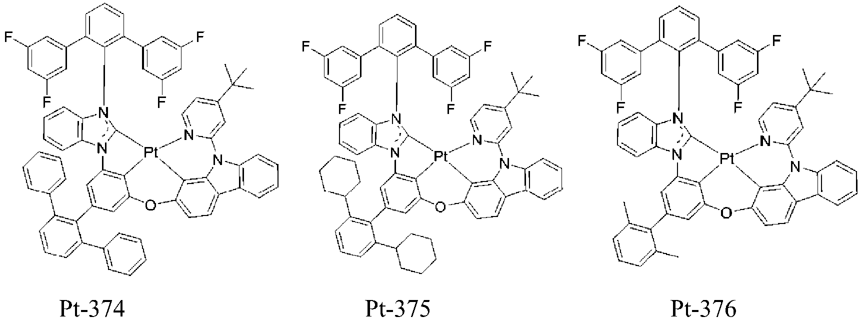

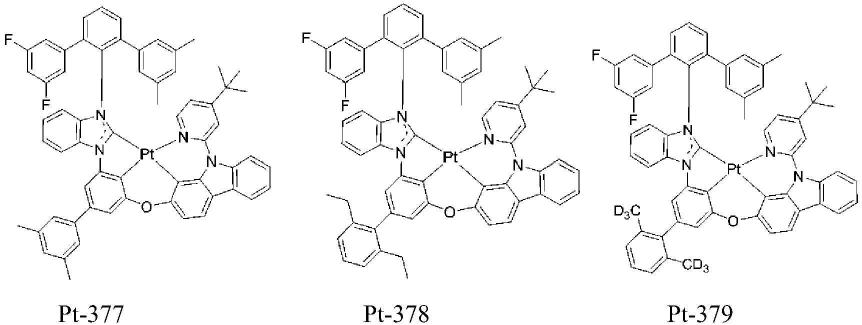

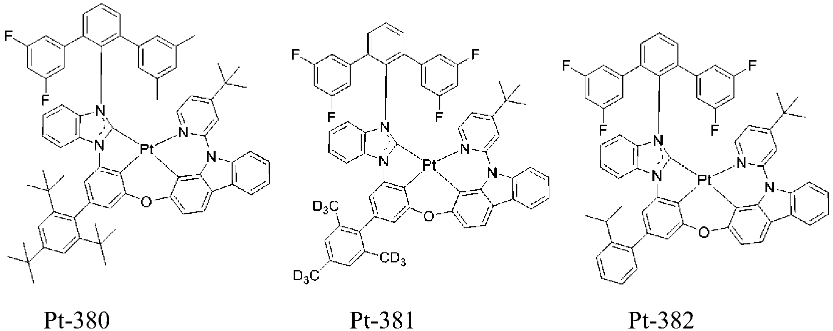

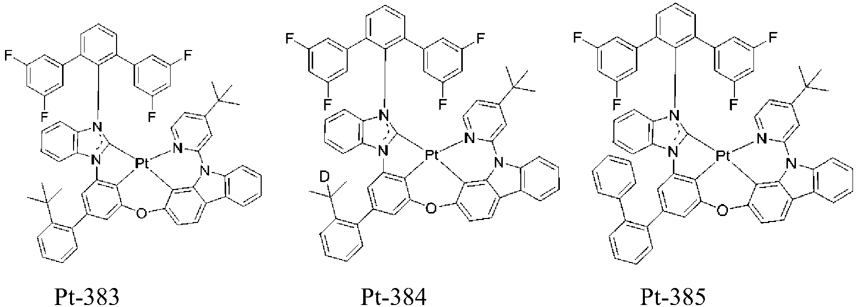

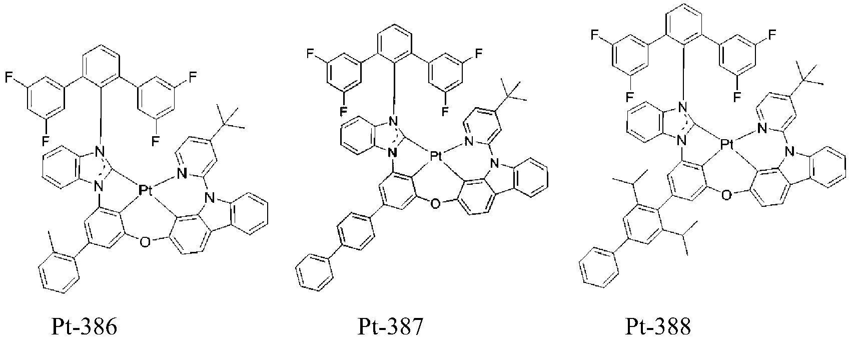

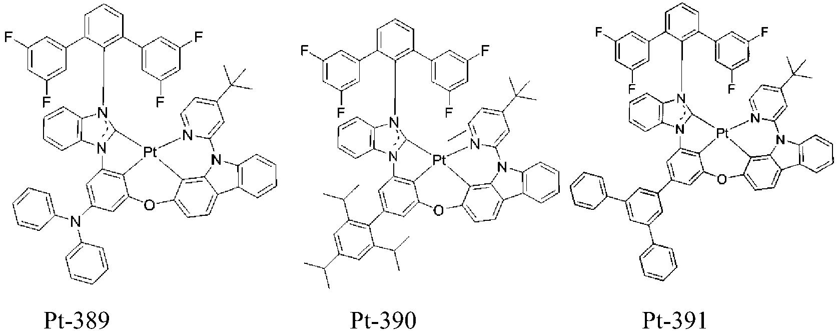

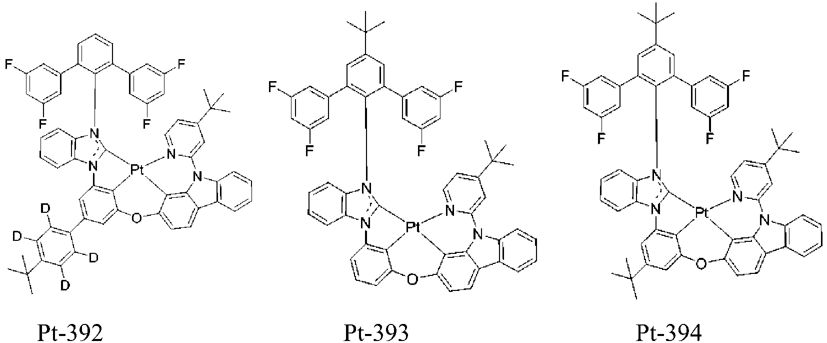

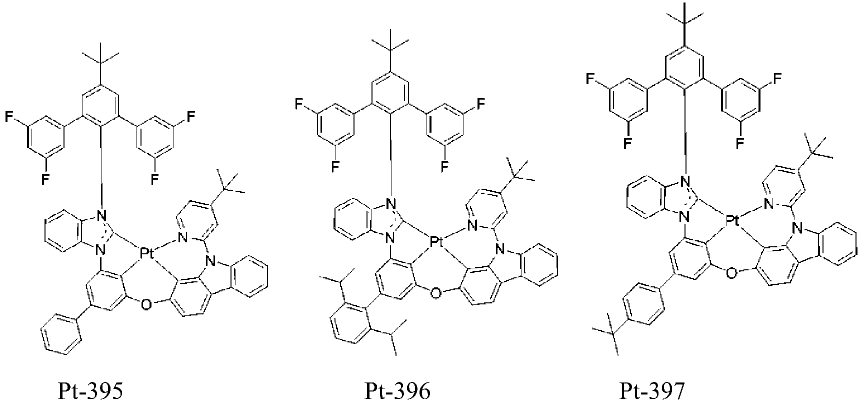

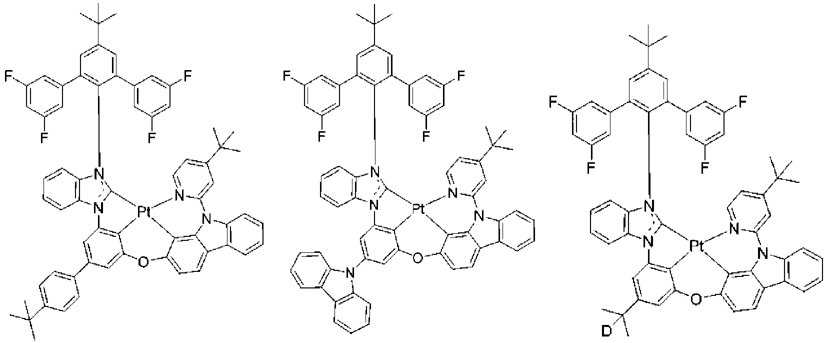

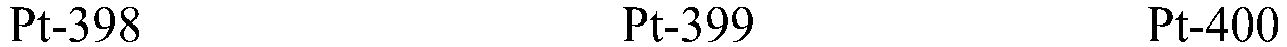

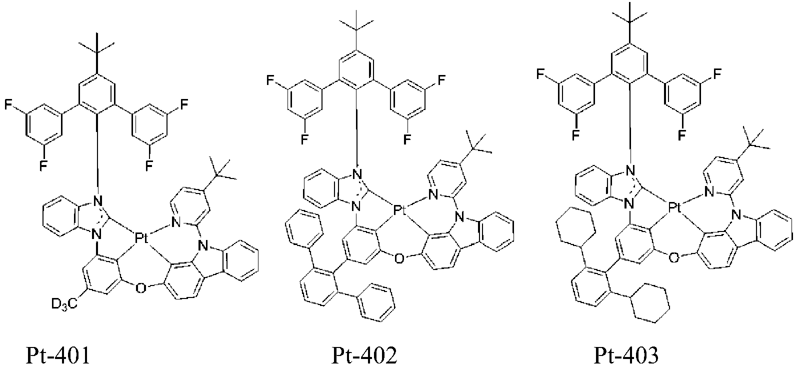

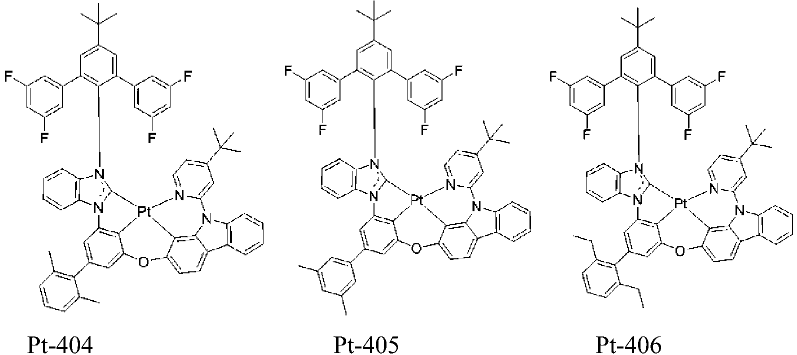

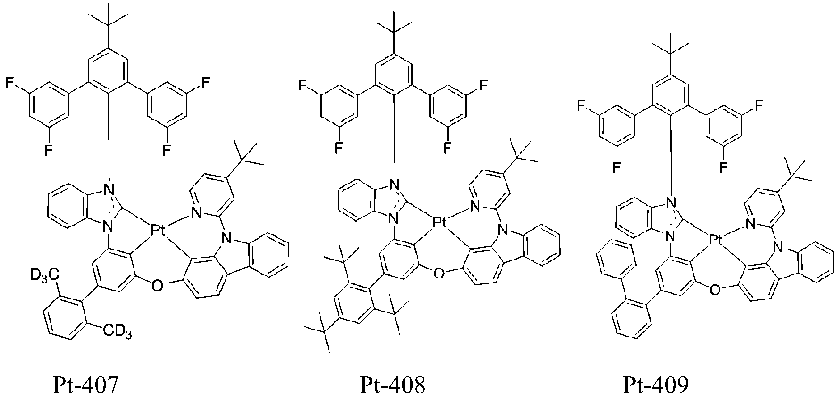

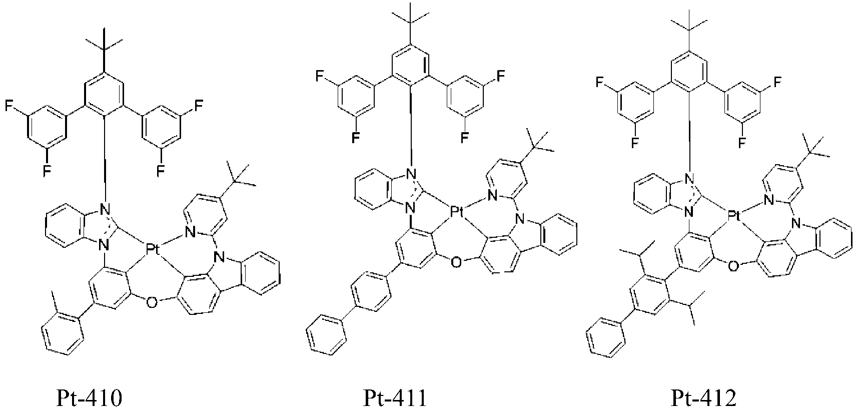

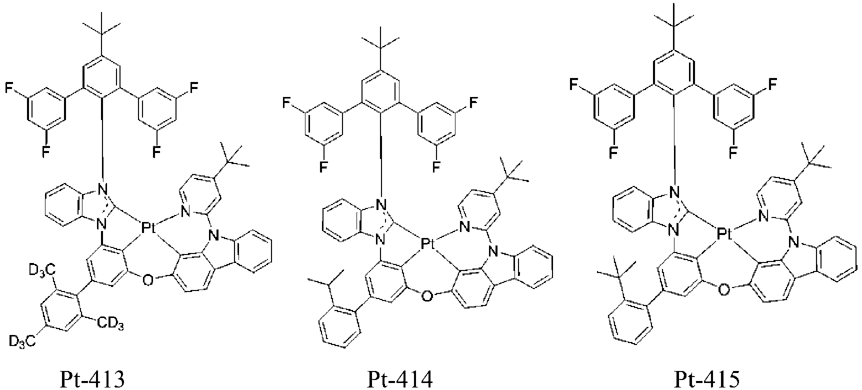

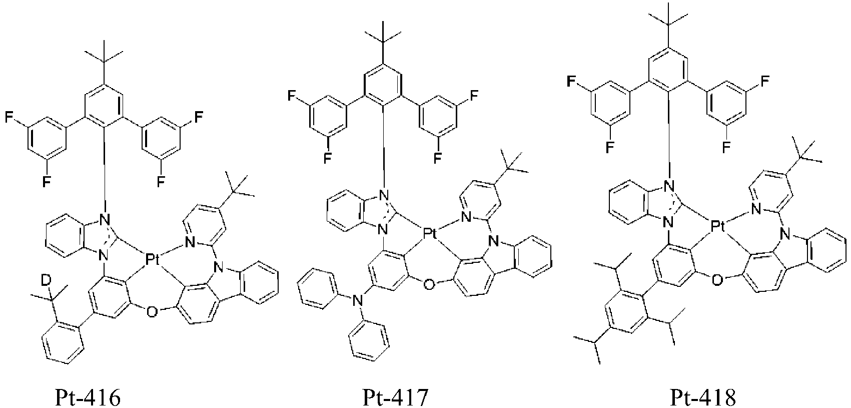

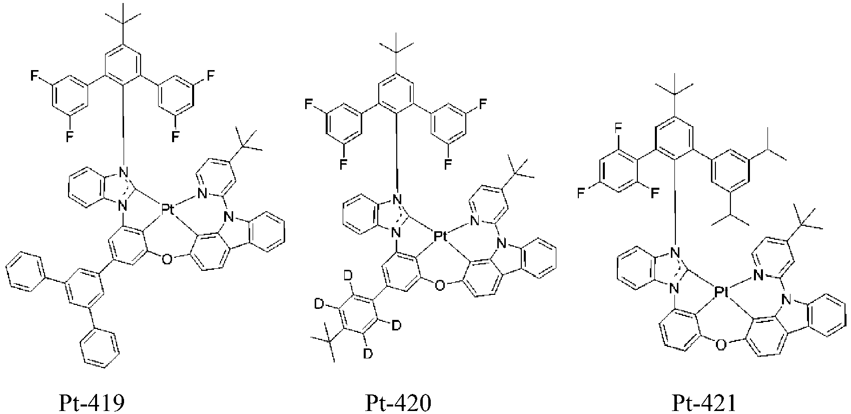

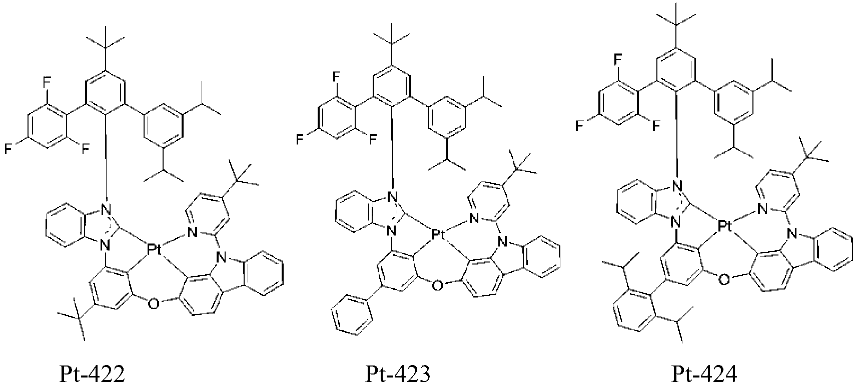

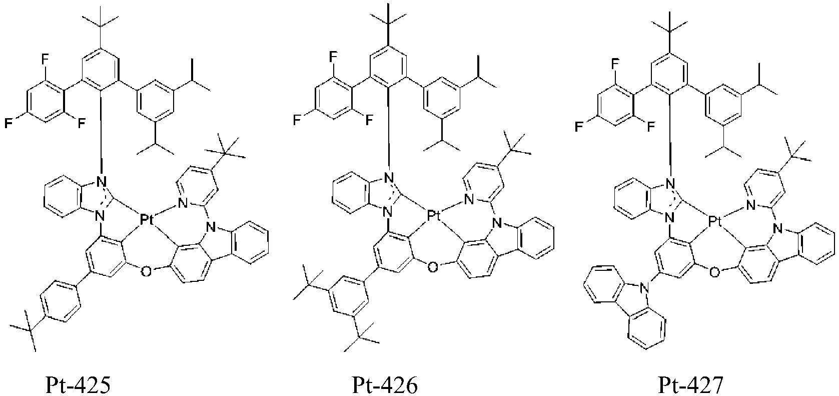

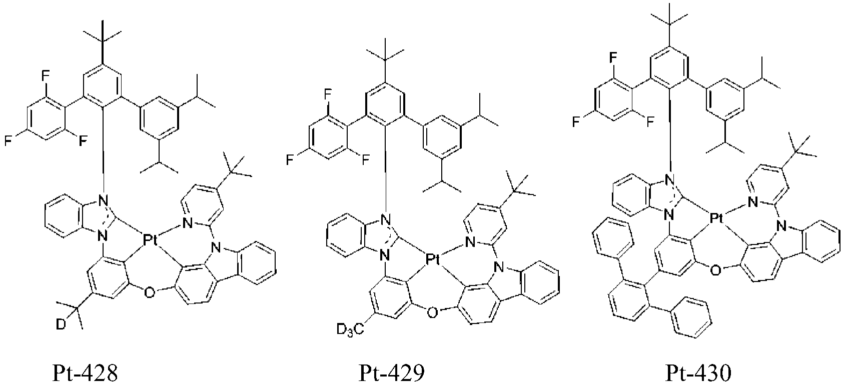

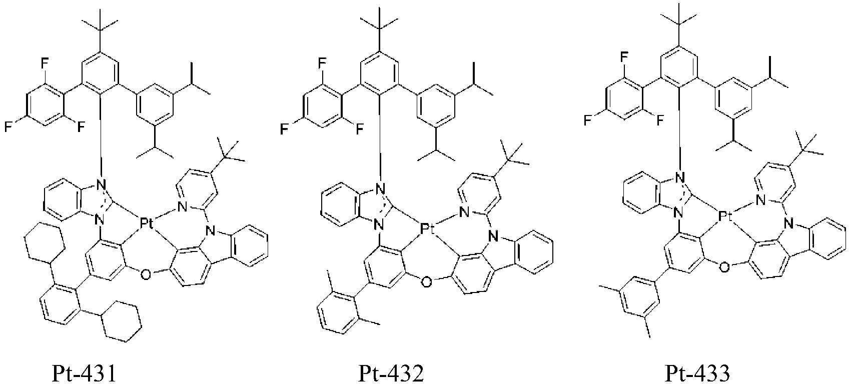

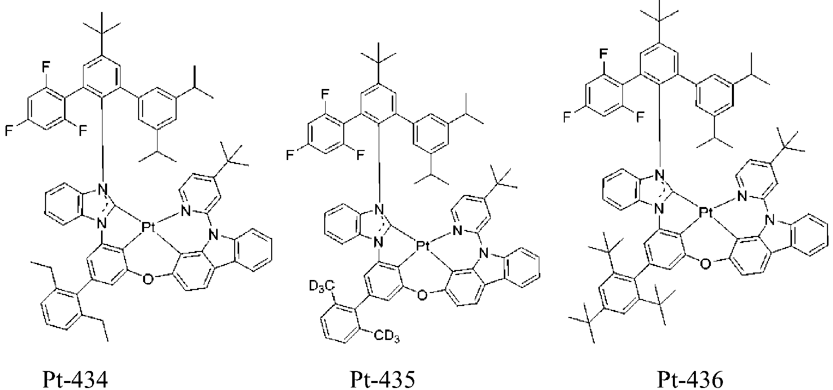

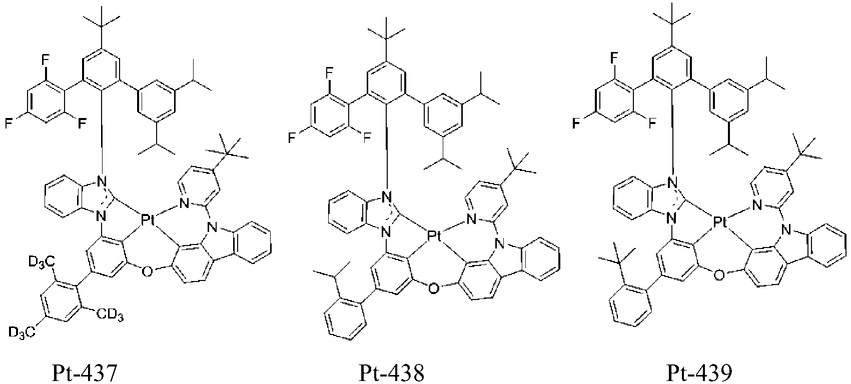

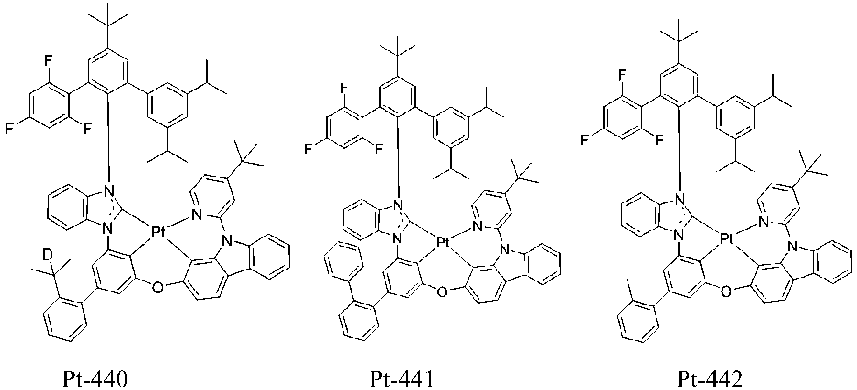

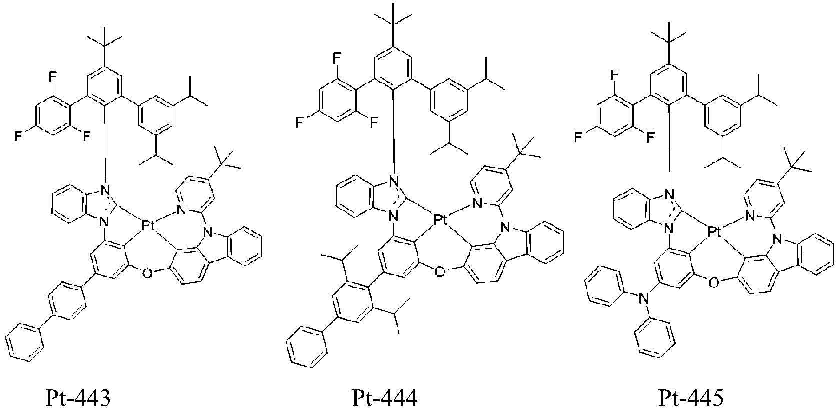

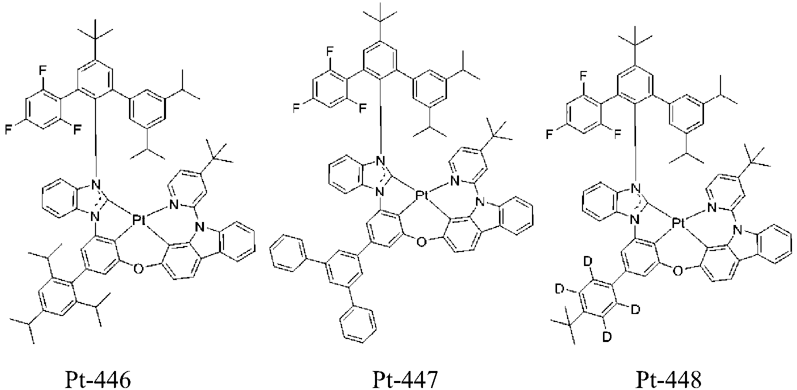

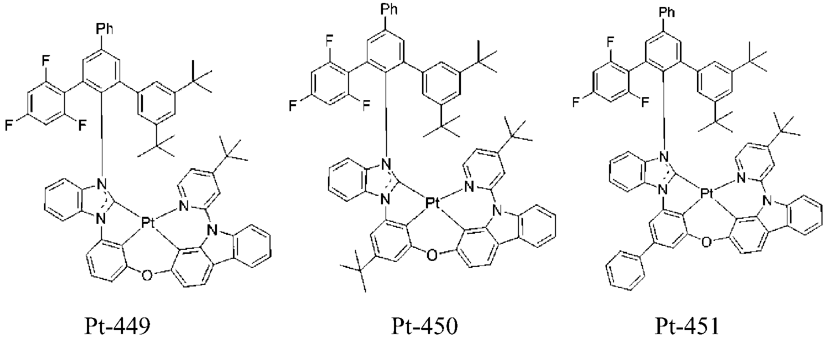

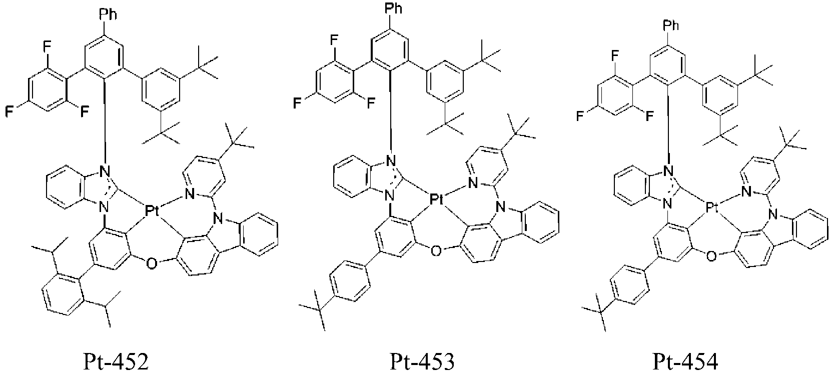

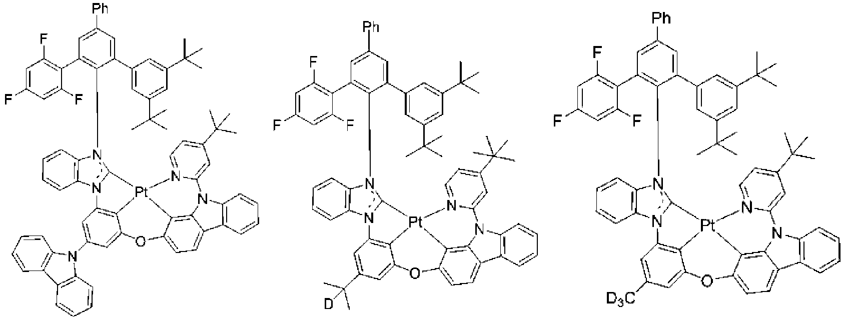

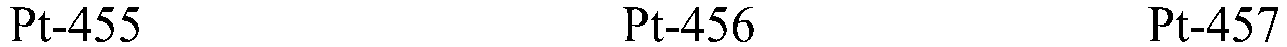

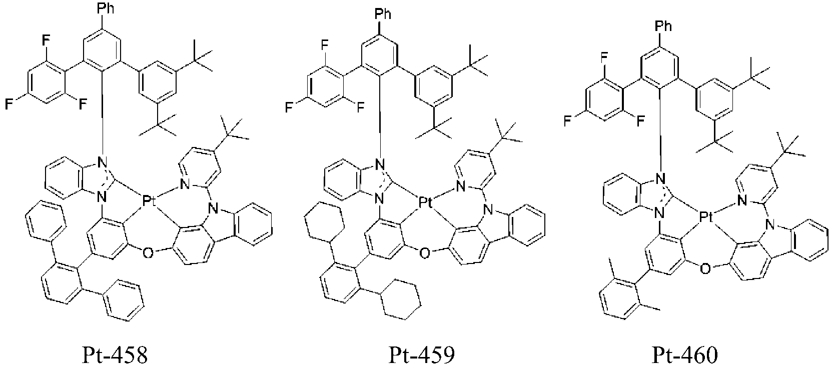

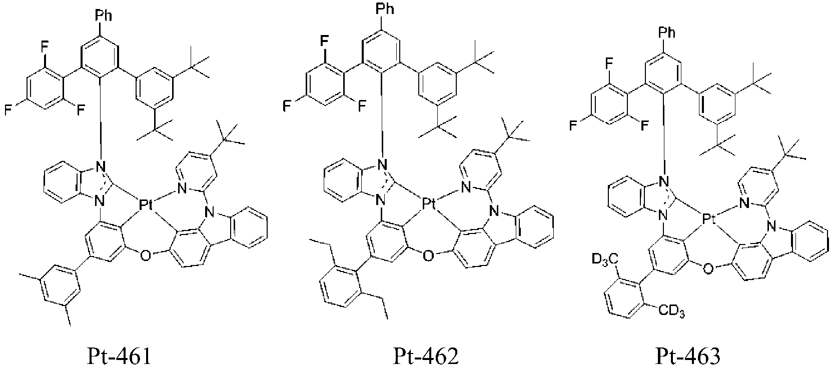

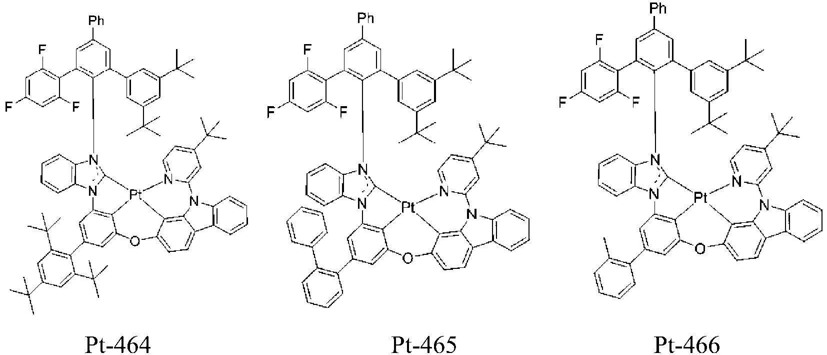

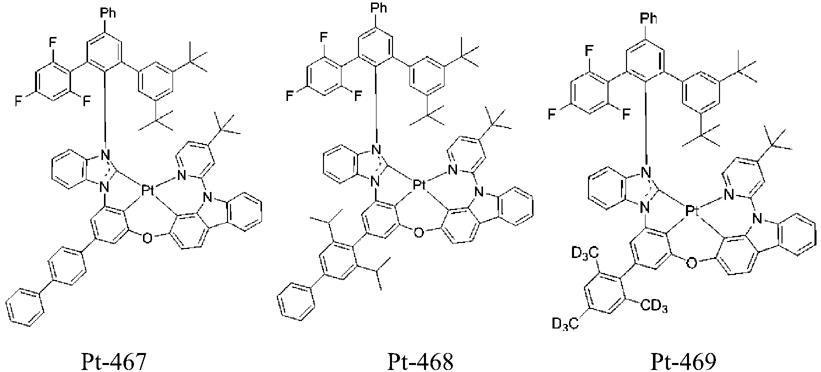

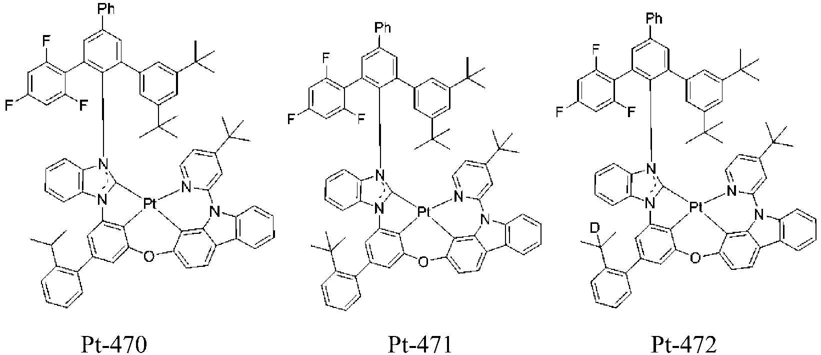

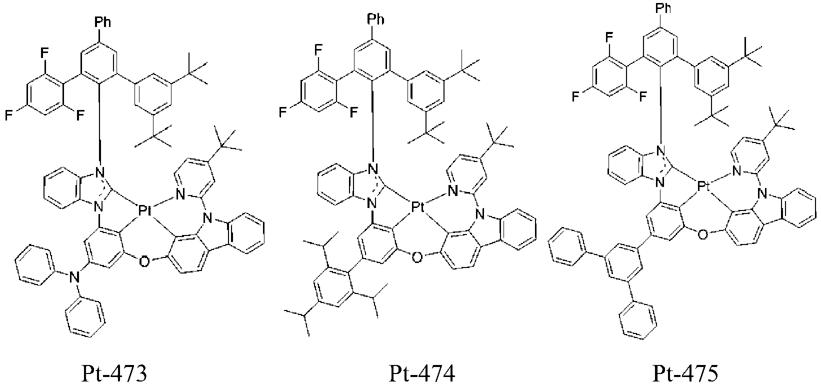

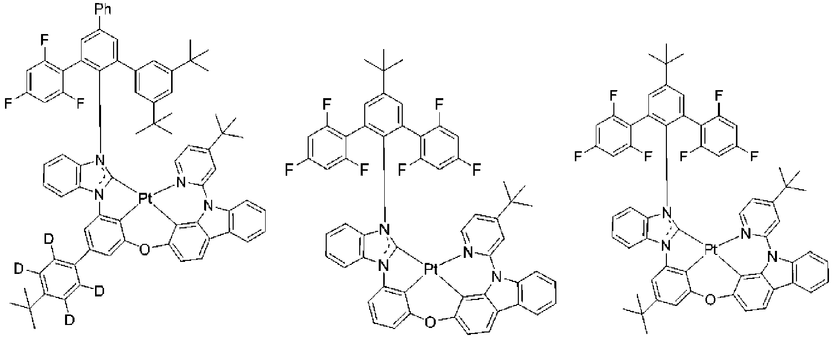

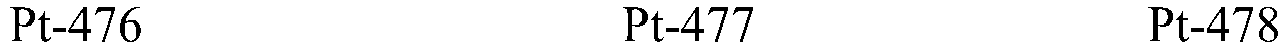

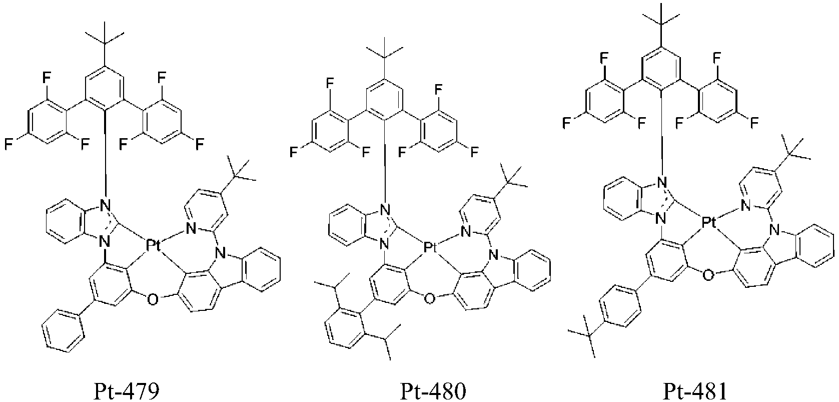

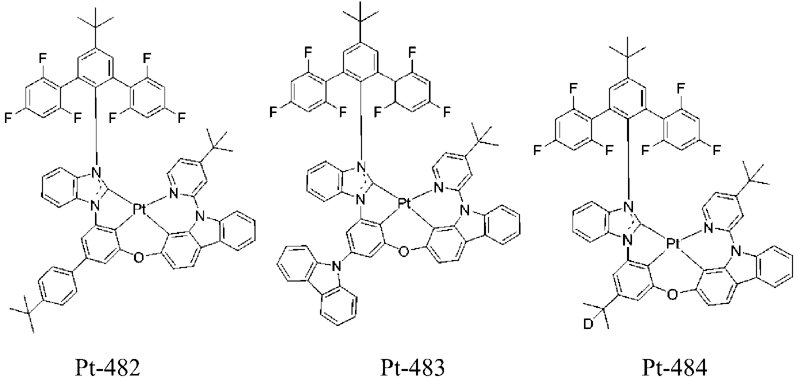

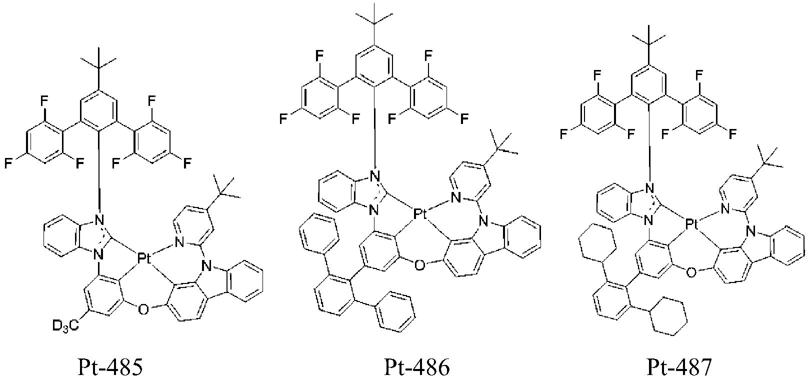

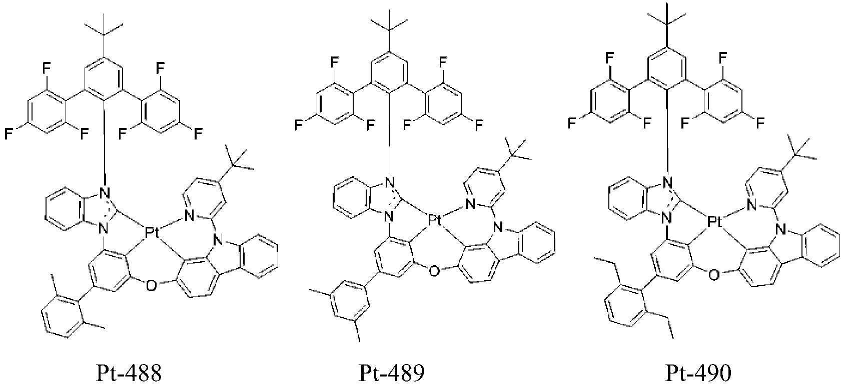

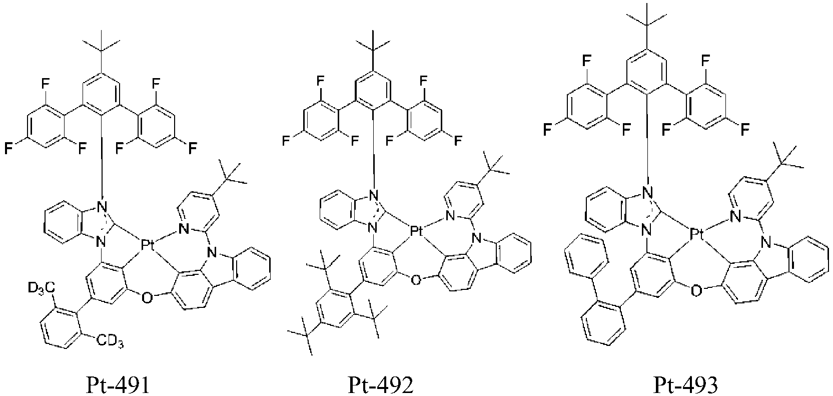

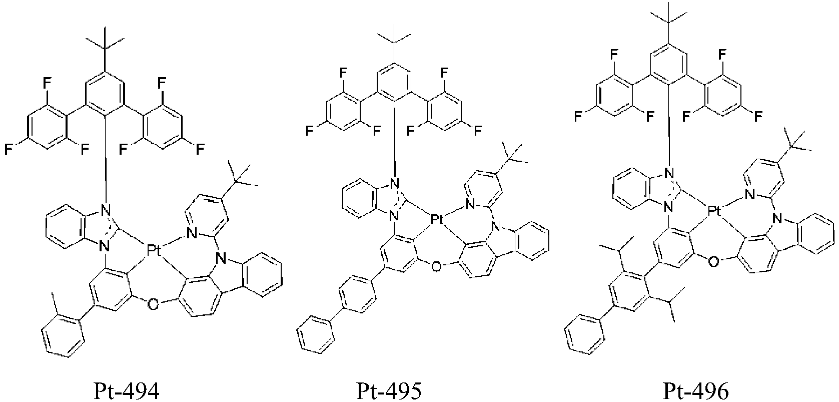

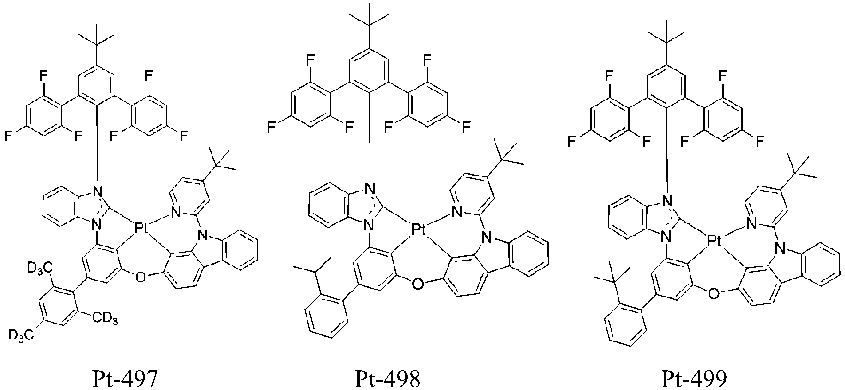

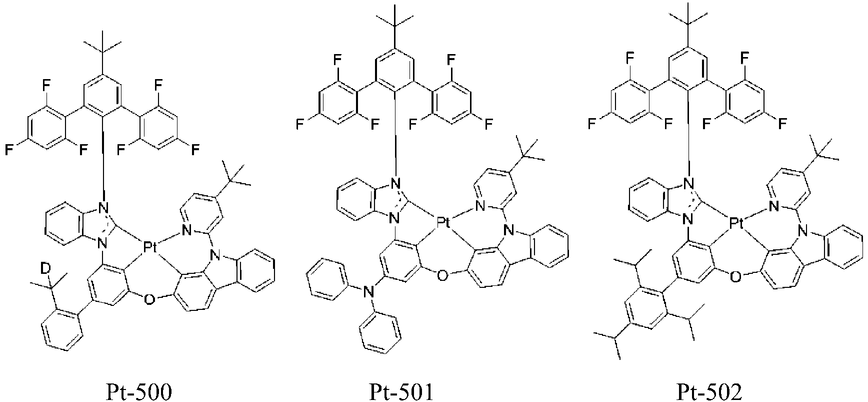

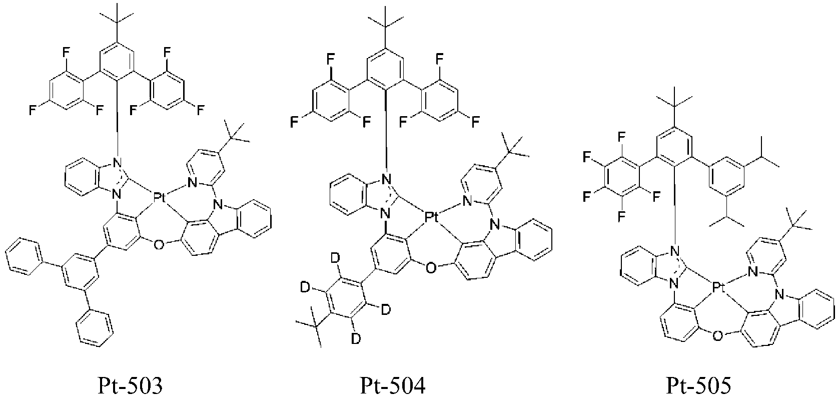

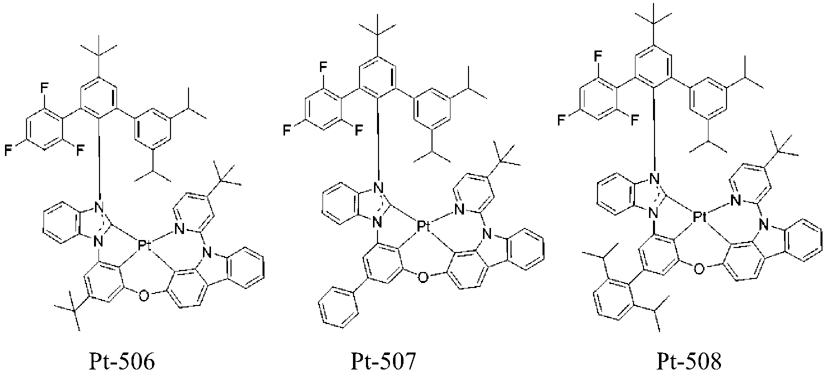

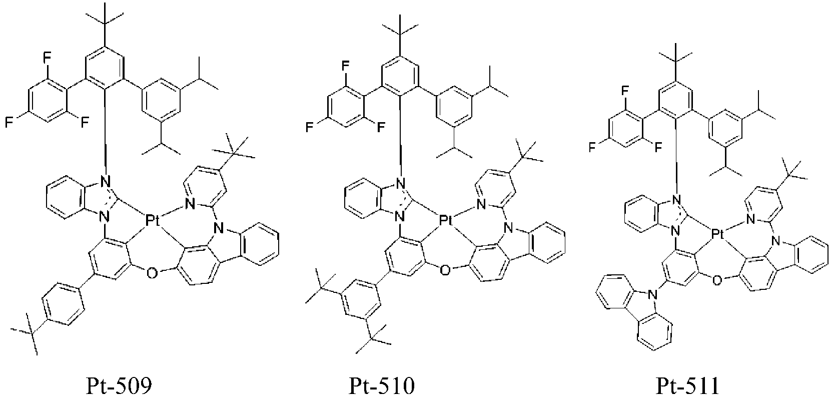

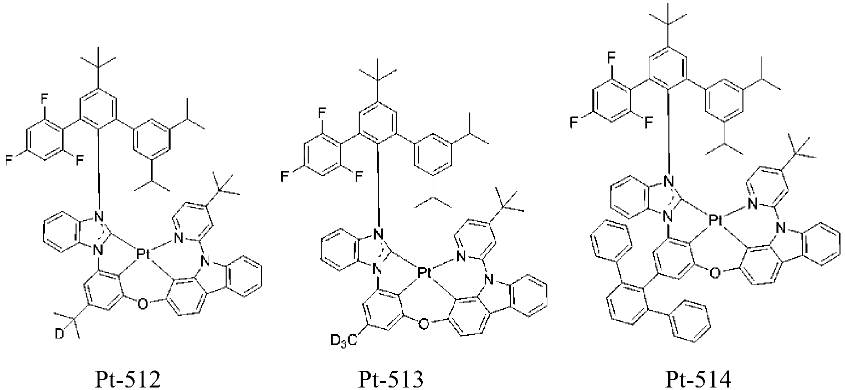

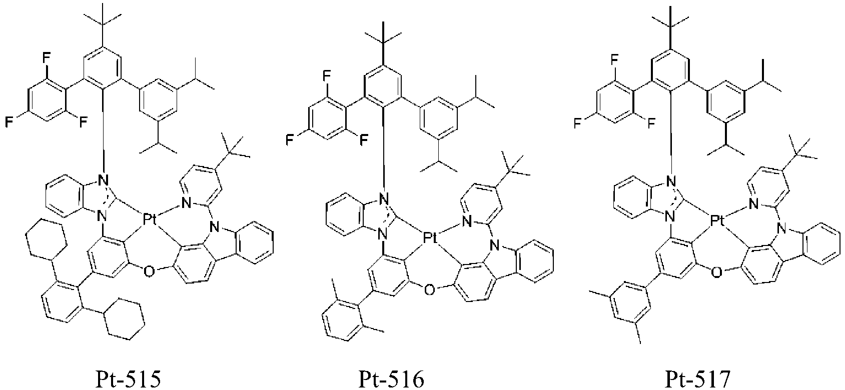

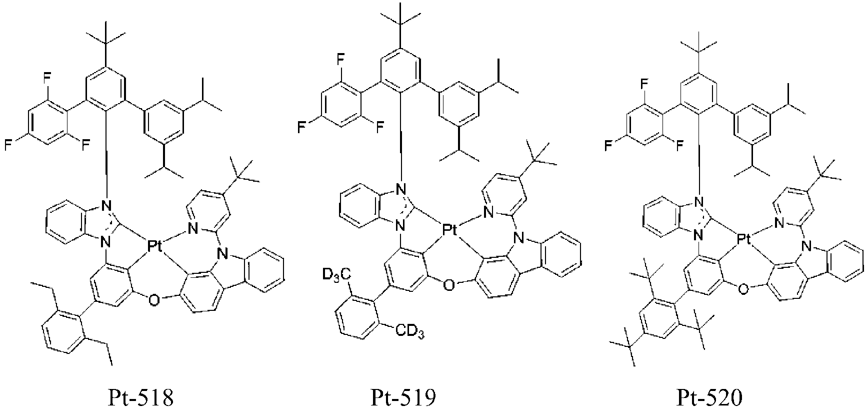

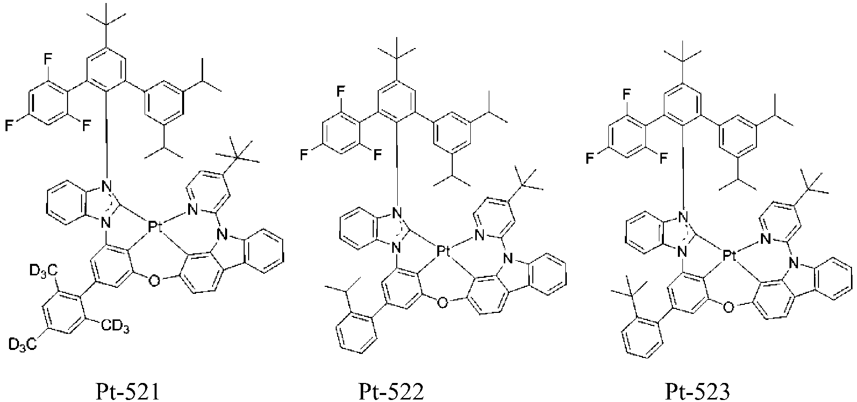

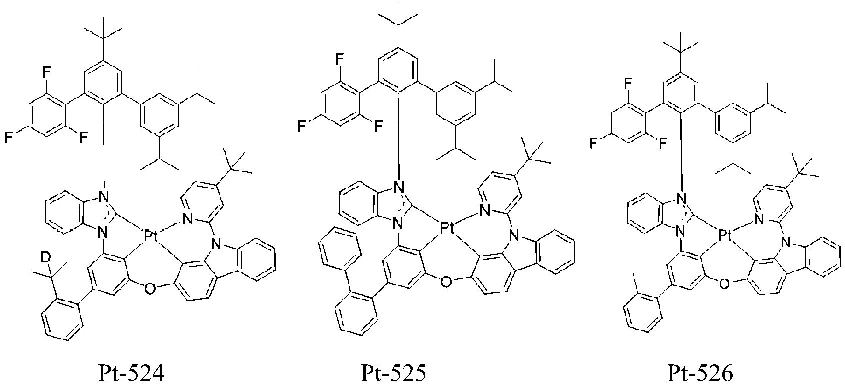

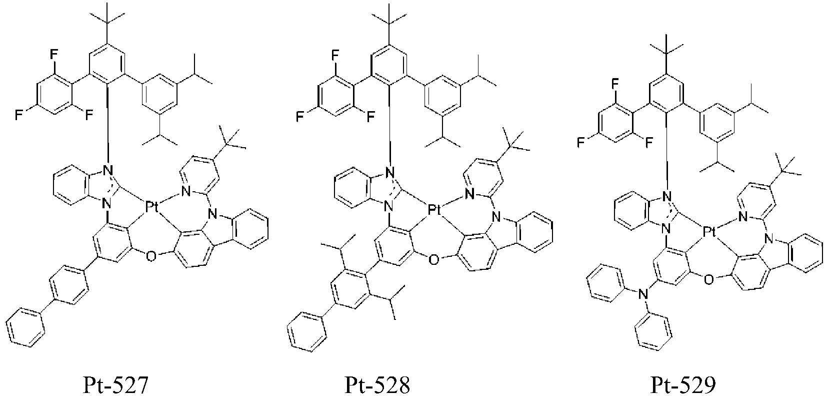

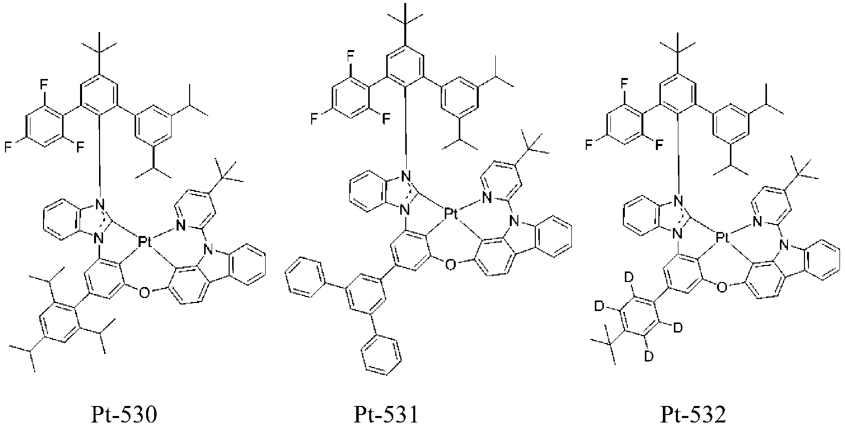

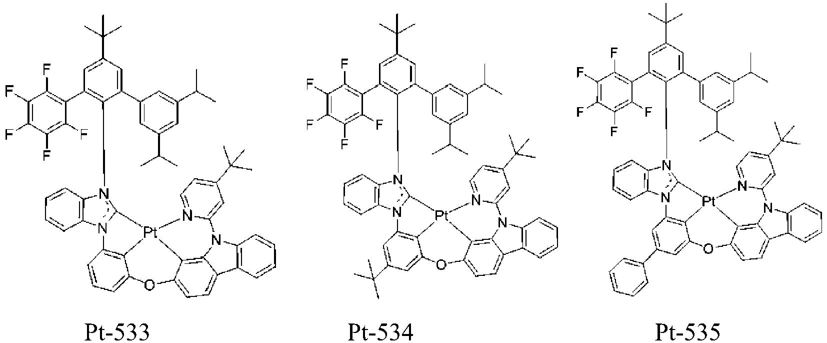

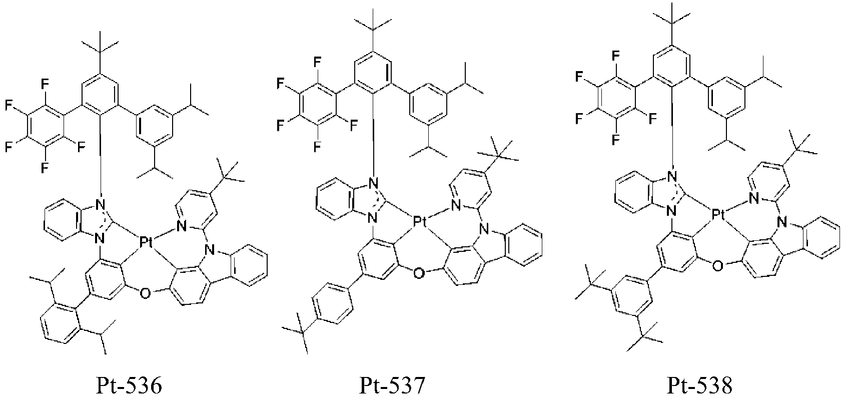

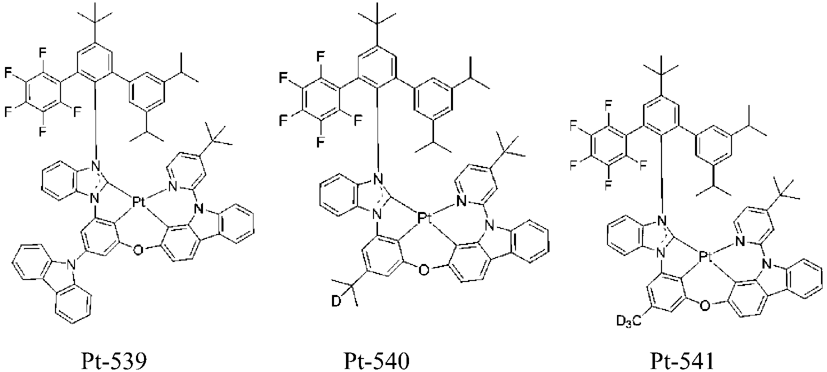

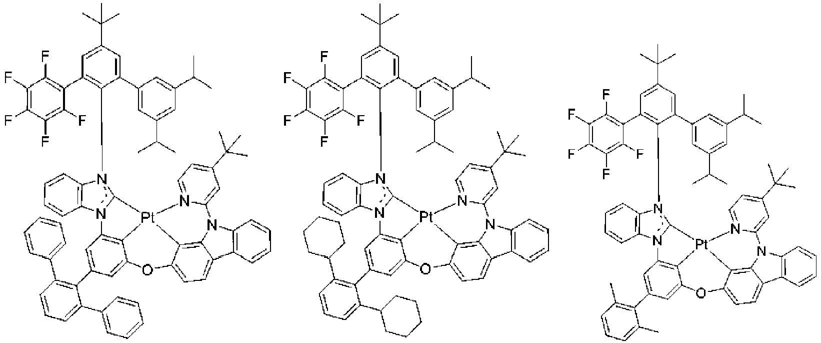

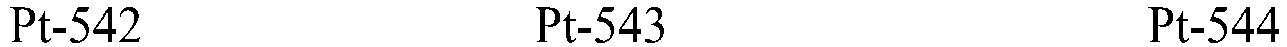

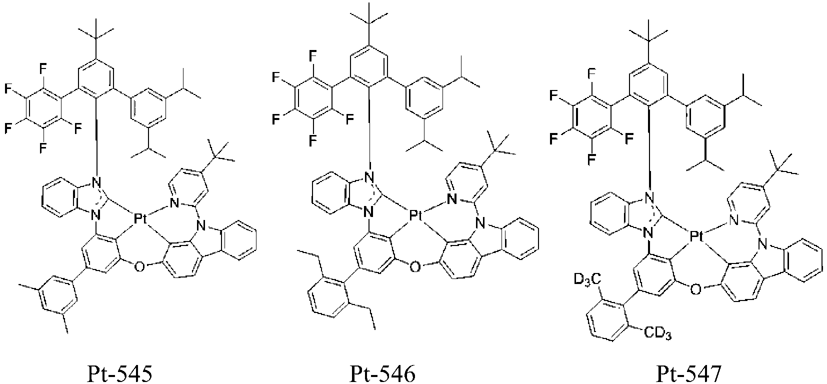

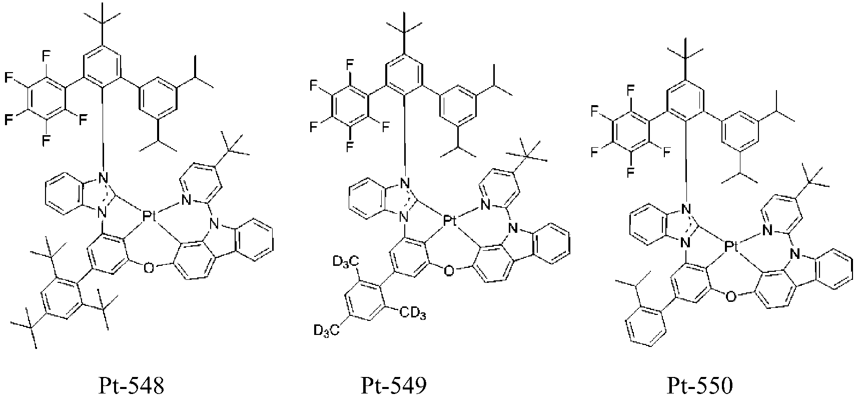

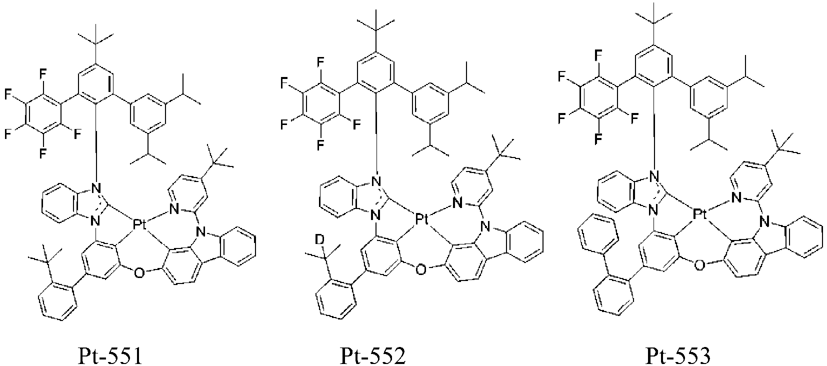

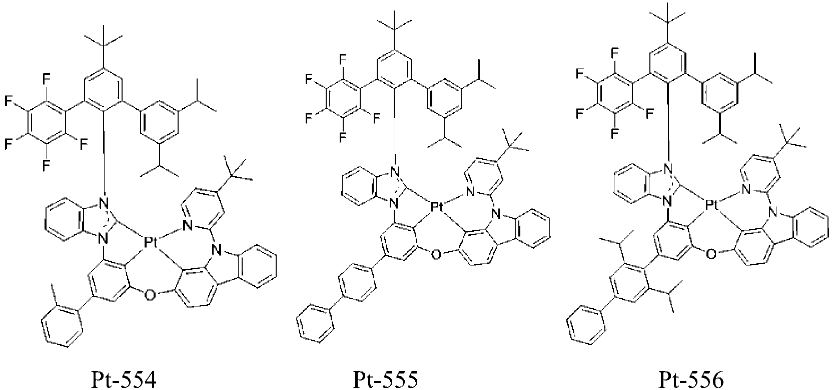

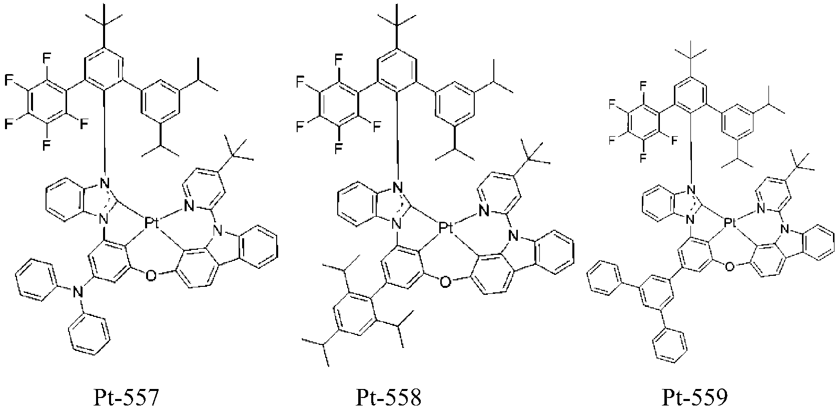

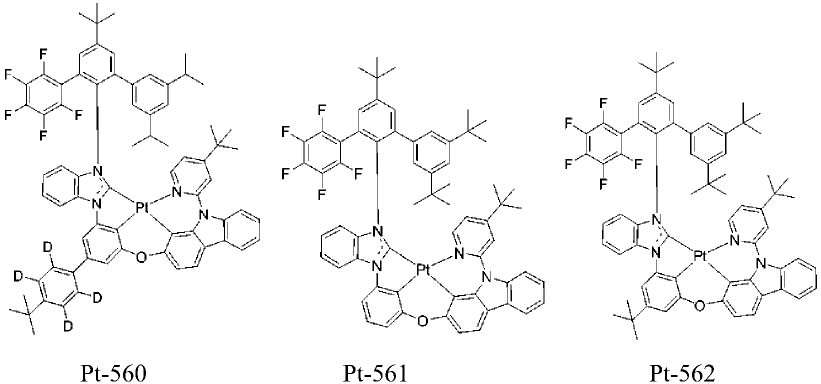

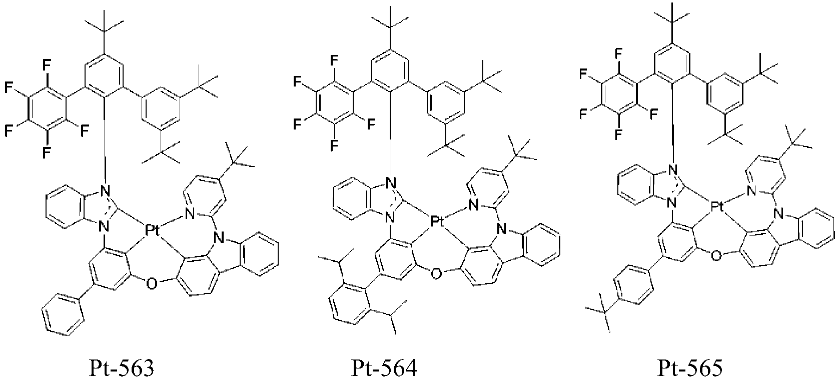

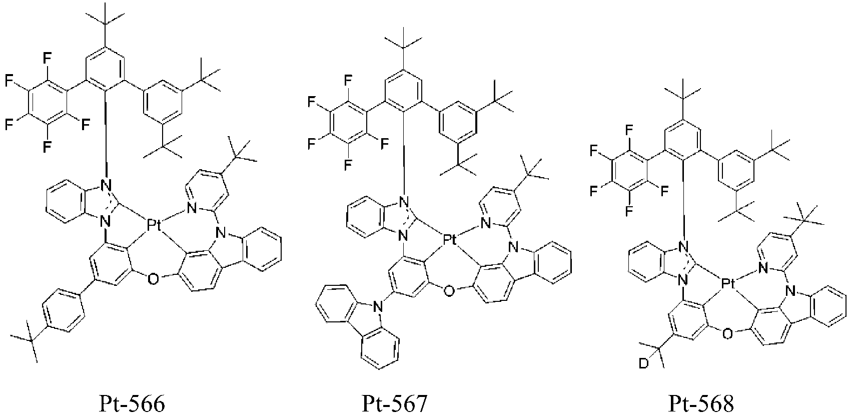

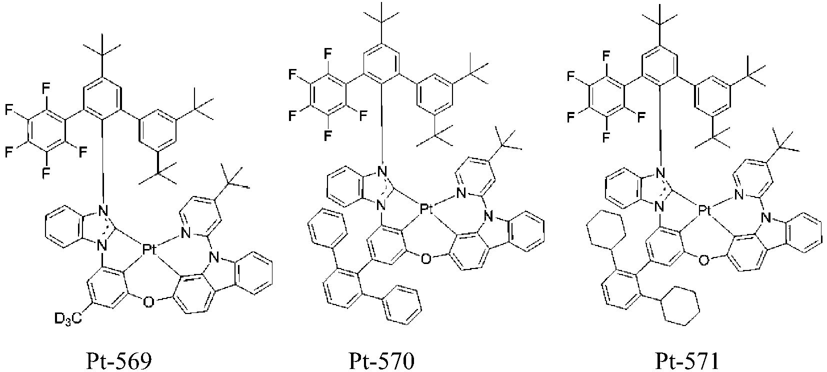

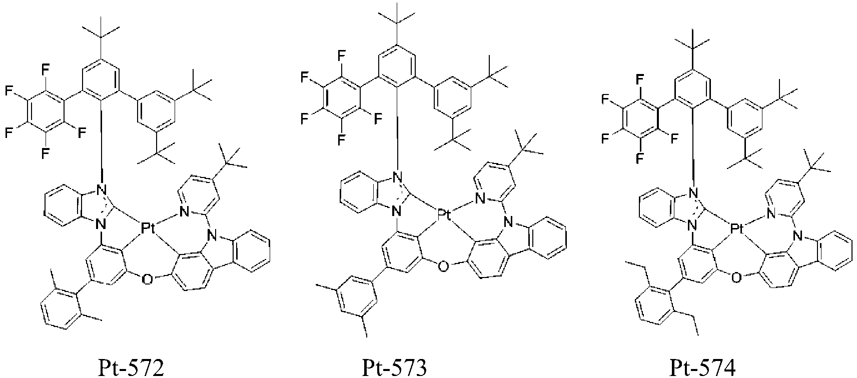

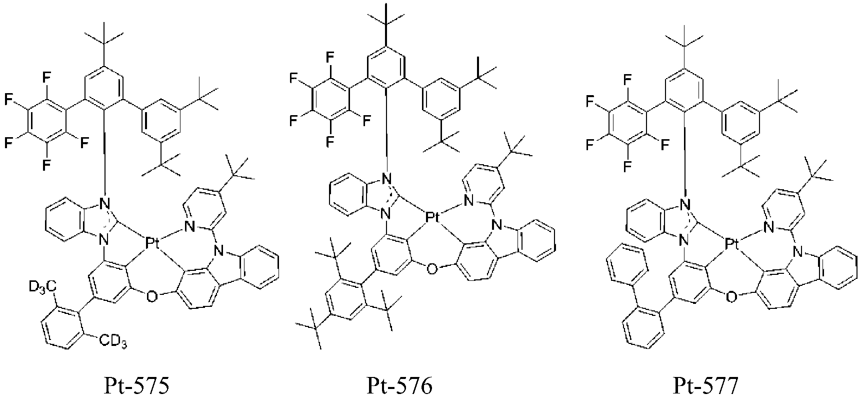

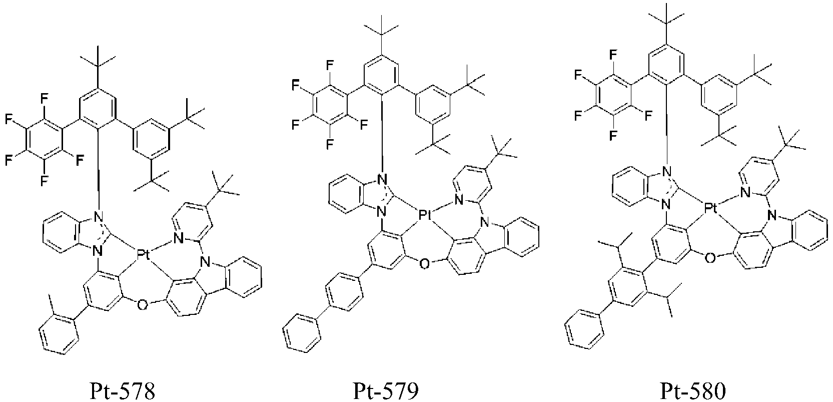

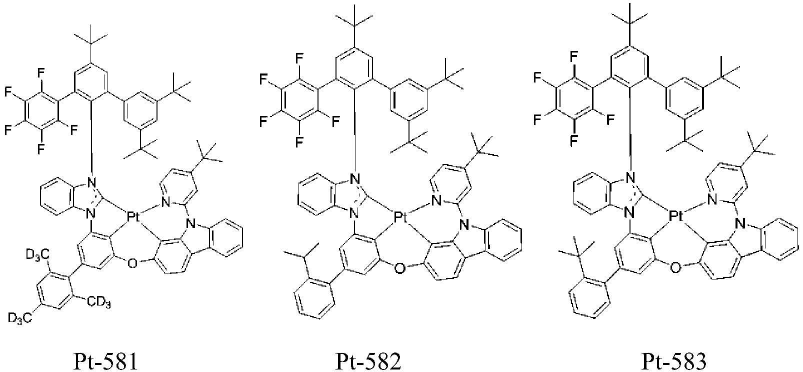

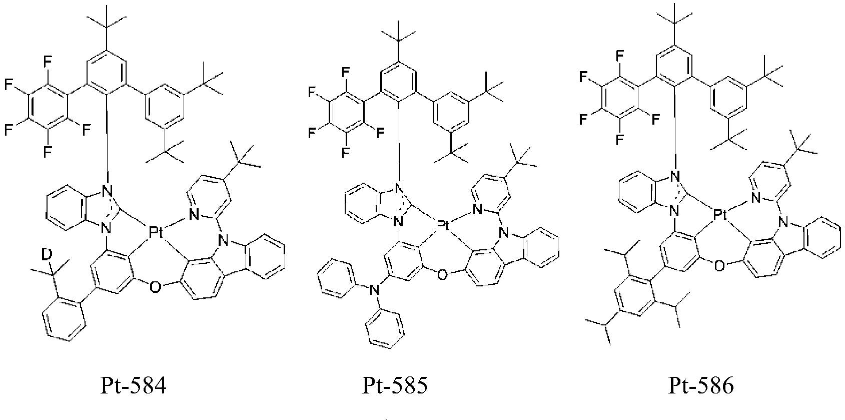

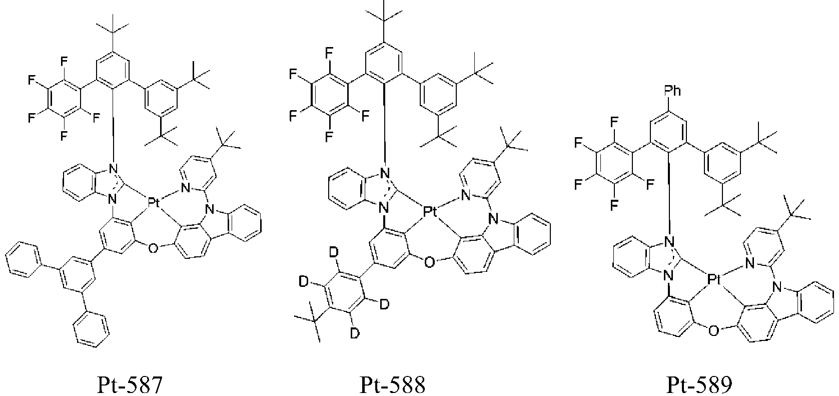

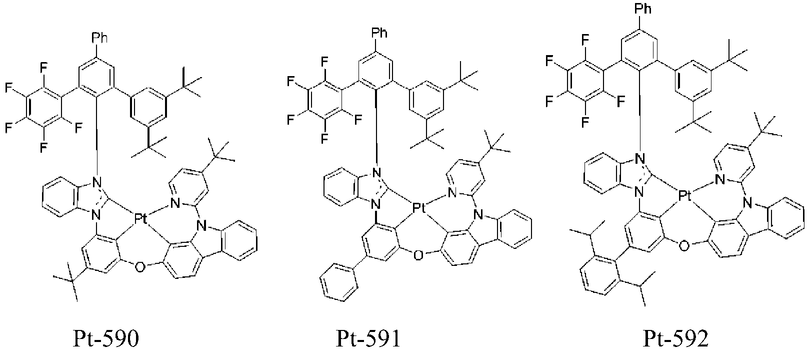

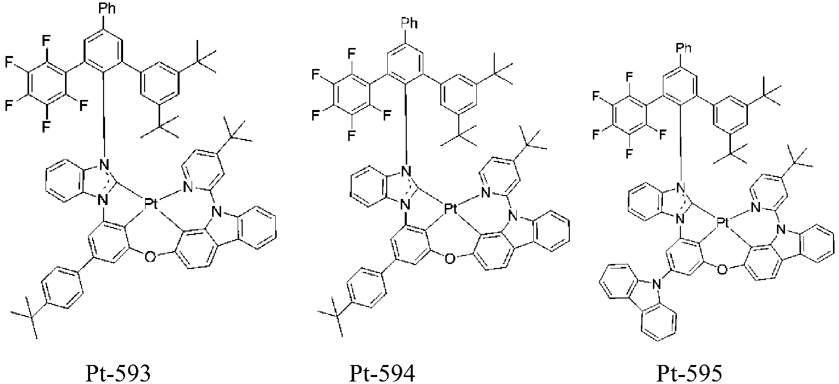

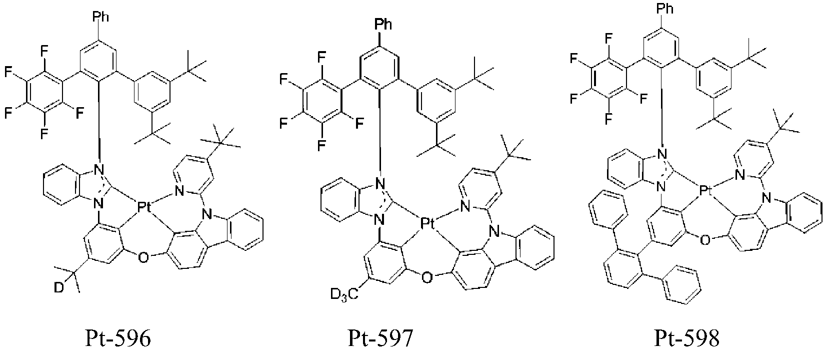

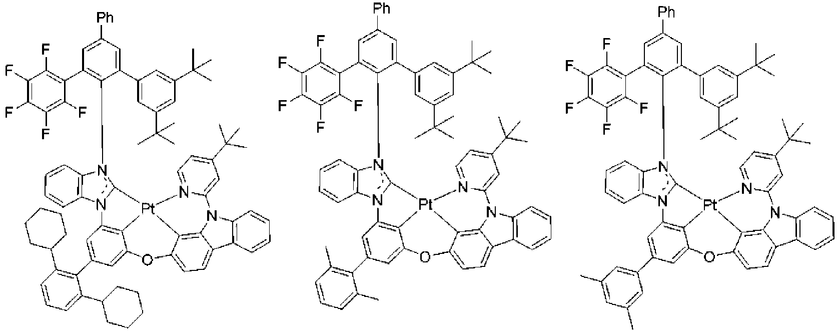

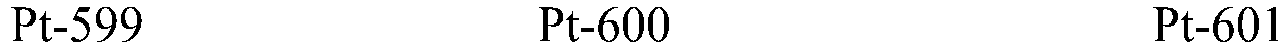

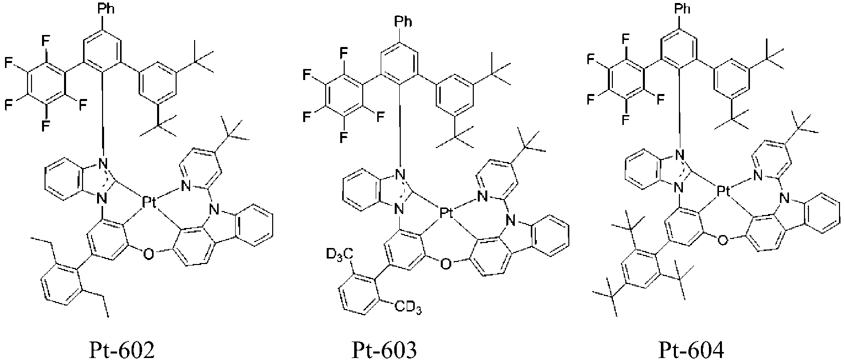

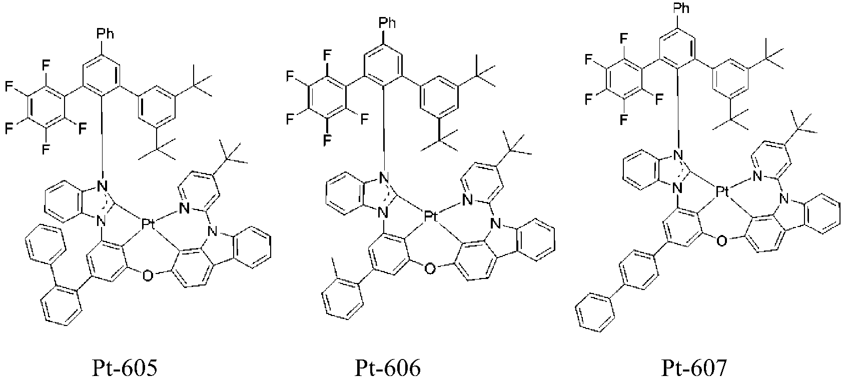

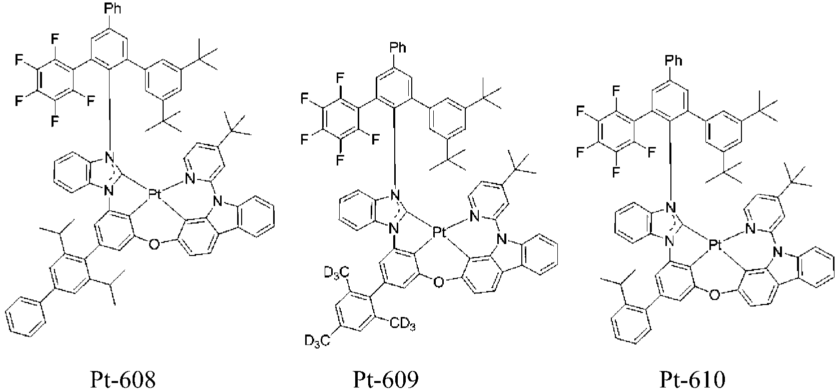

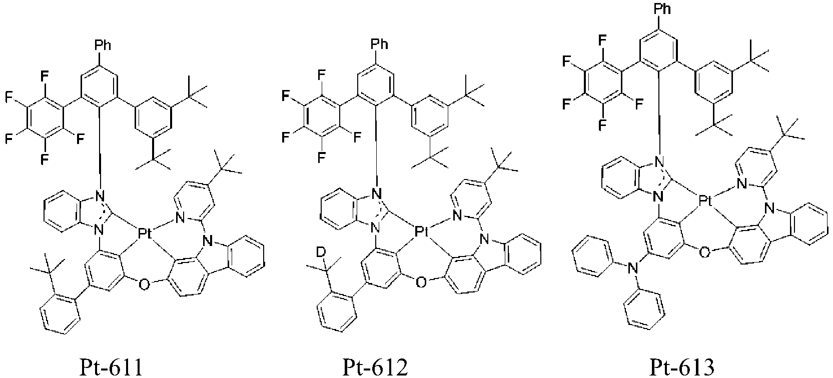

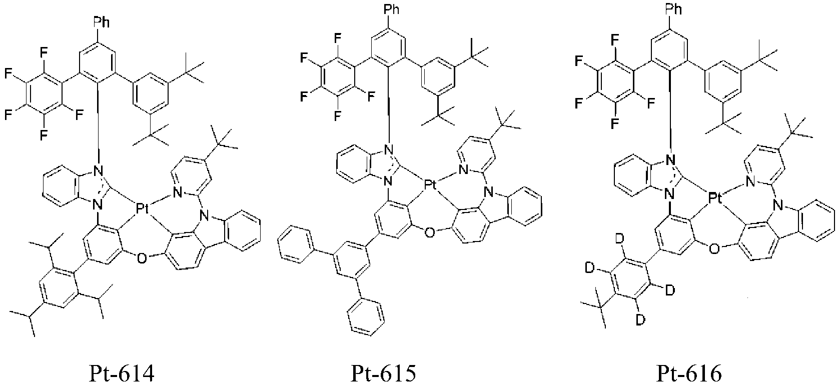

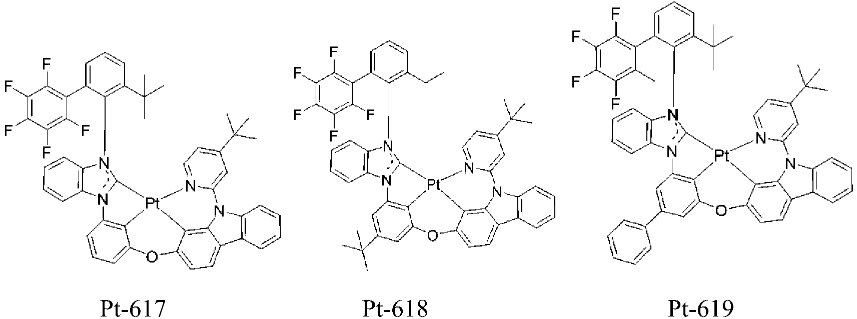

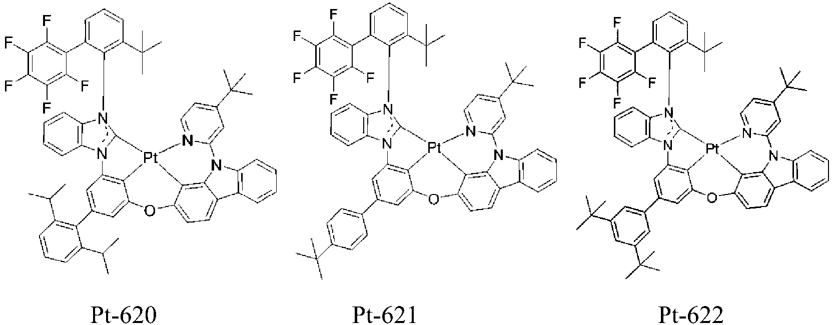

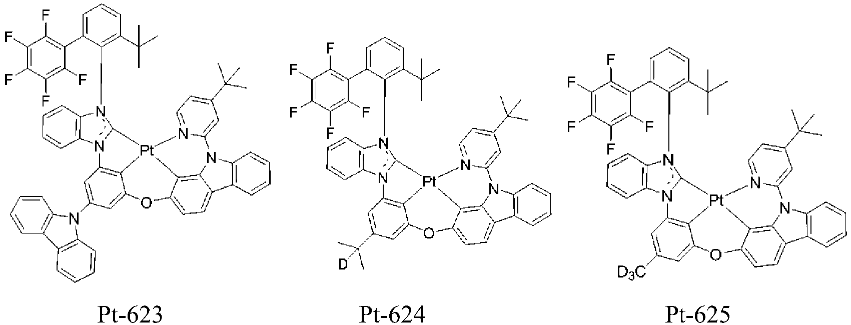

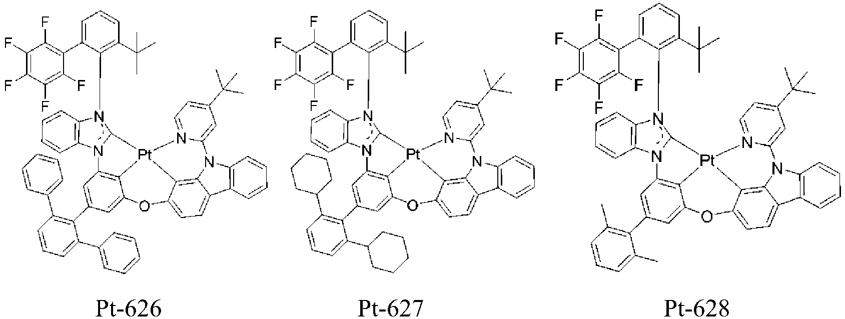

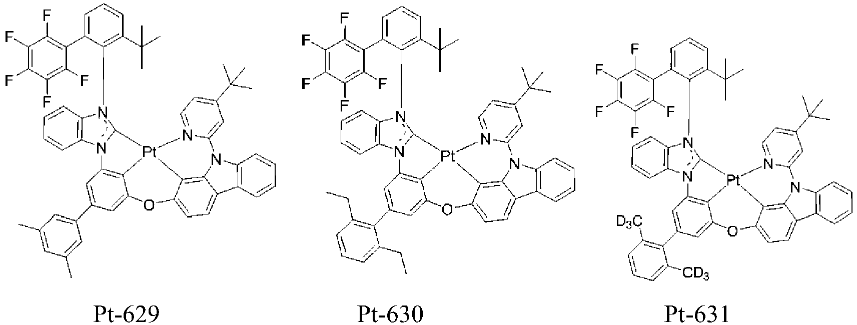

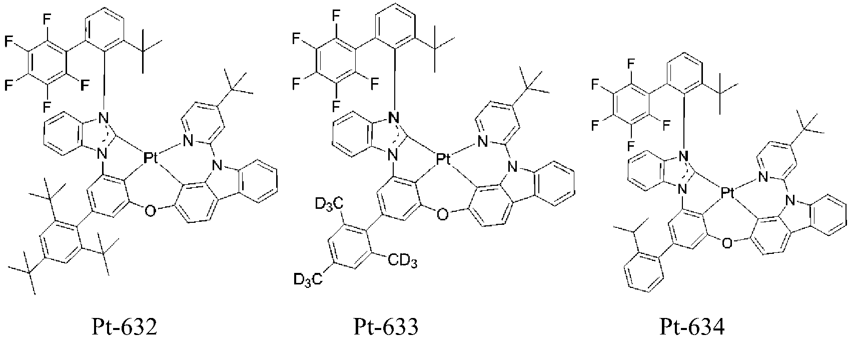

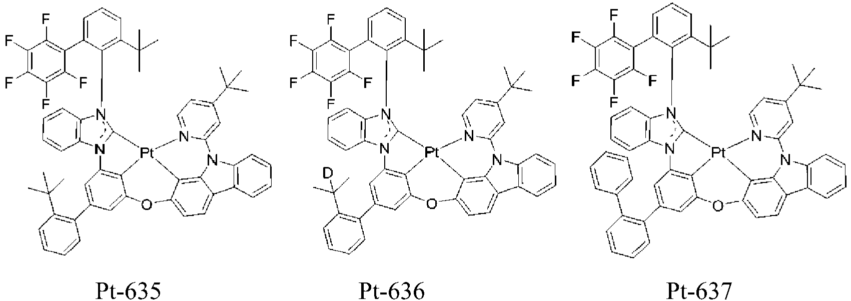

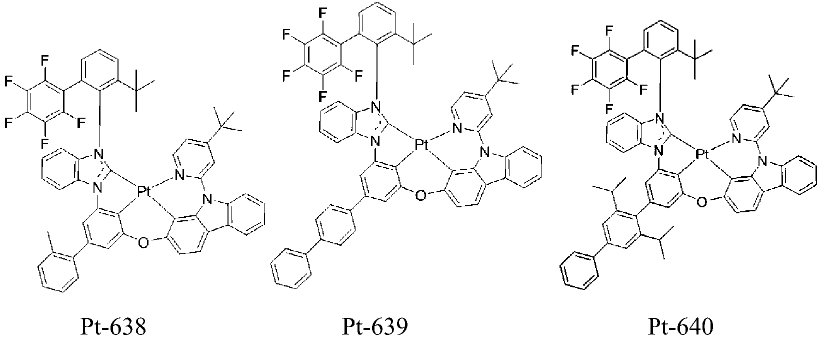

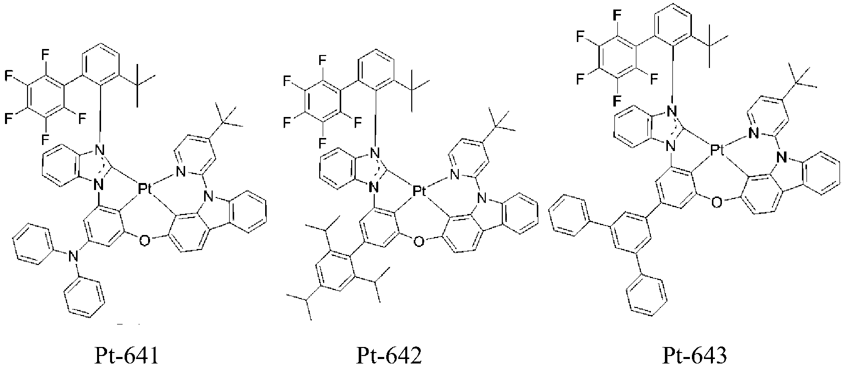

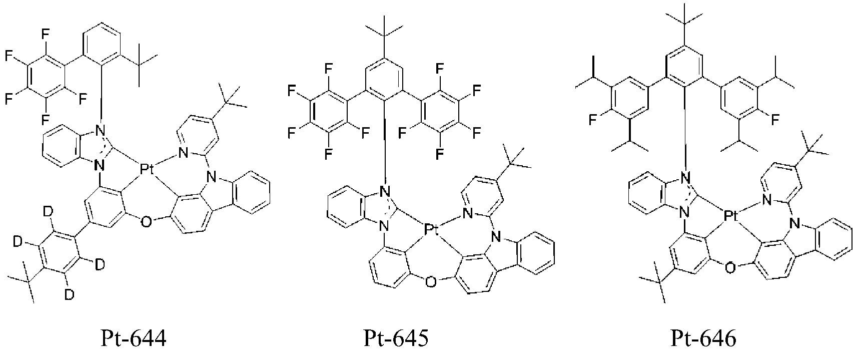

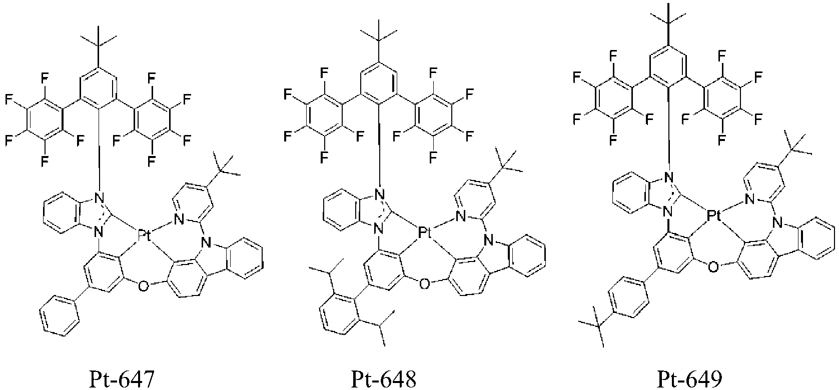

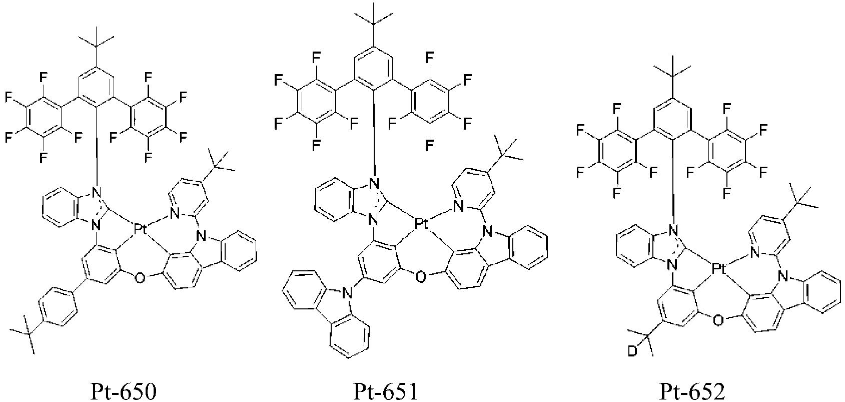

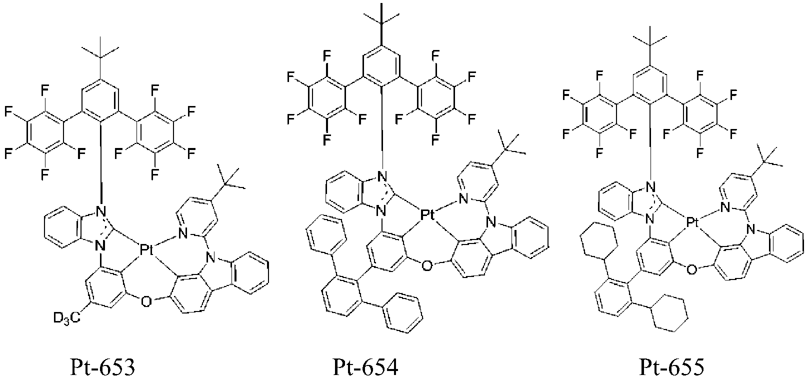

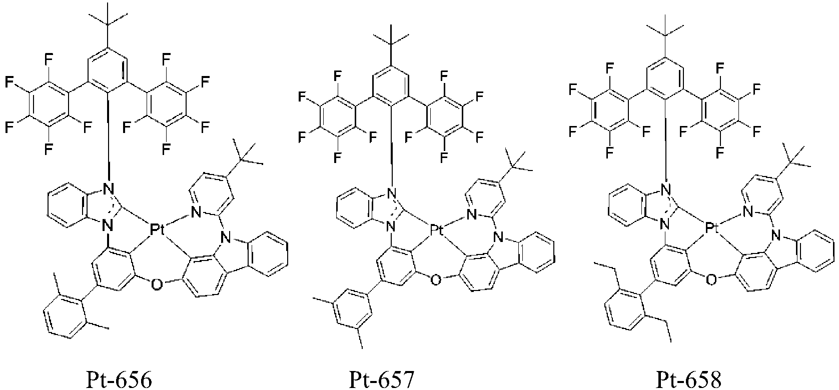

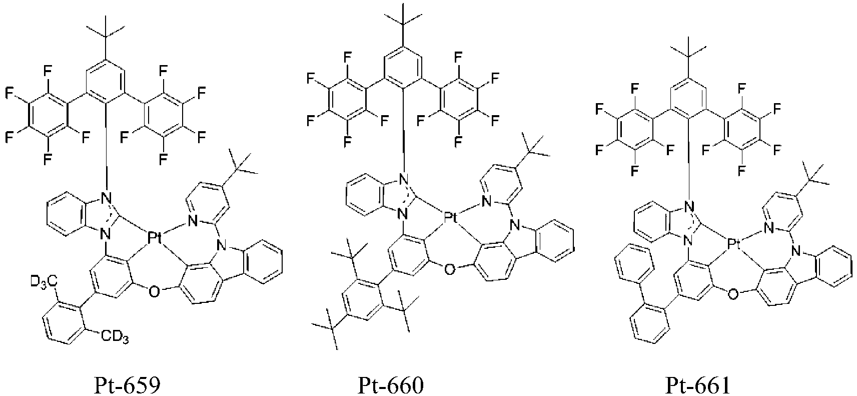

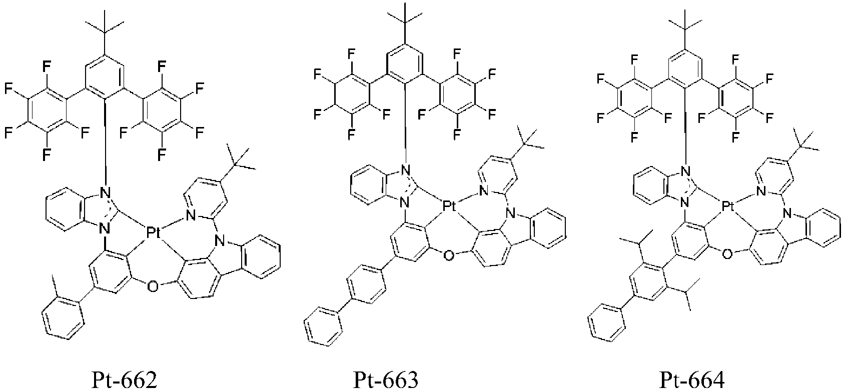

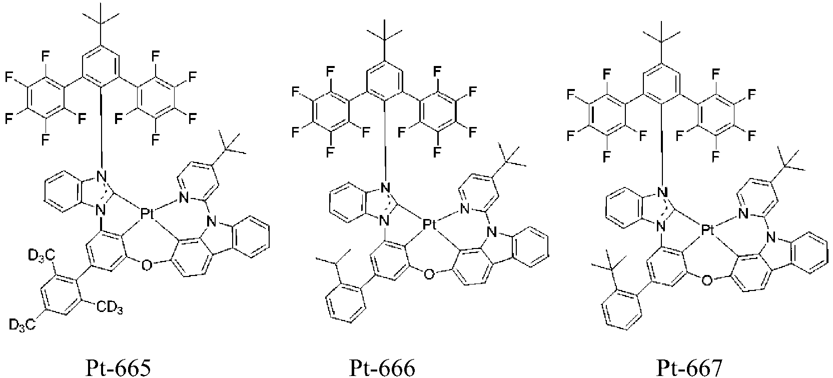

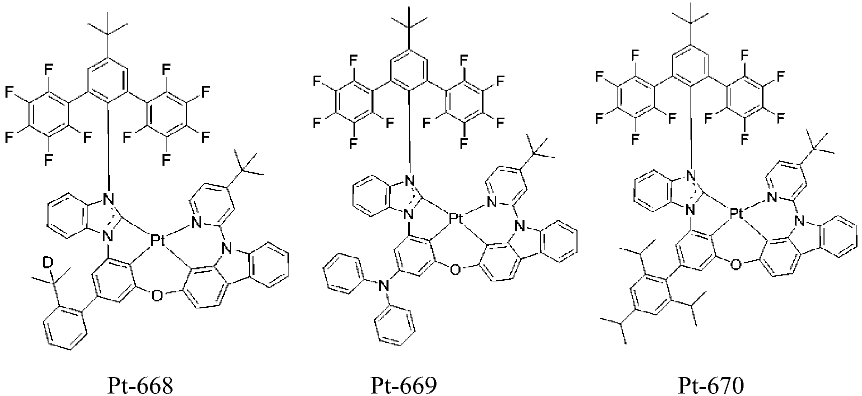

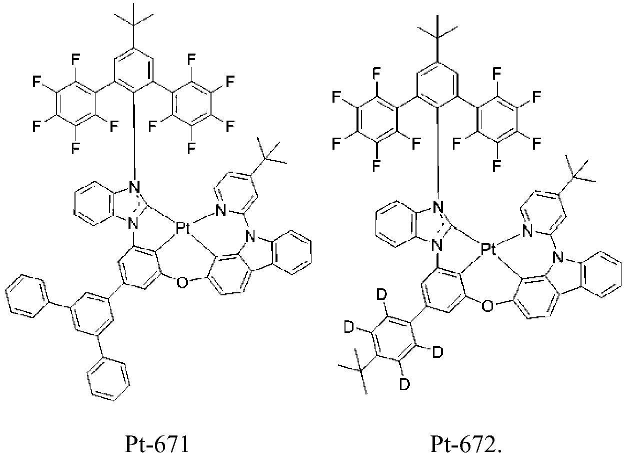

3. Application du complexe de platine tétradentate fluoré (II) selon la revendication 1 ou 2 dans des dispositifs électroniques.

4. Application selon la revendication 3, dans laquelle le dispositif électronique comprend un dispositif électroluminescent organique, un circuit intégré organique, un transistor à effet de champ organique, un transistor à film mince organique, un transistor électrolumineux organique, une cellule solaire organique, un détecteur optique organique, un photorécepteur organique, un dispositif de trempe de champ organique, une cellule électrochimique luminescente et une diode laser organique.

5. Dispositif électroluminescent organique, dans lequel l'appareil électroluminescent organique comprend une cathode, une anode et une couche fonctionnelle organique entre la cathode et l'anode ; la couche fonctionnelle organique comprend le complexe de platine tétradentate fluoré (II) selon la revendication 1 ou 2.

6. Dispositif électroluminescent organique selon la revendication 5, dans lequel la couche fonctionnelle organique comprend une couche luminescente, la couche luminescente comprenant le complexe de platine tétradentate fluoré (II) selon la revendication 1 ou 2.

7. Dispositif électroluminescent organique selon la revendication 5, dans lequel la couche luminescente comprend en outre un matériau dopé fluorescent ; le matériau dopé fluorescent est un composé représenté par la formule (BN1) ou la formule (BN2) : 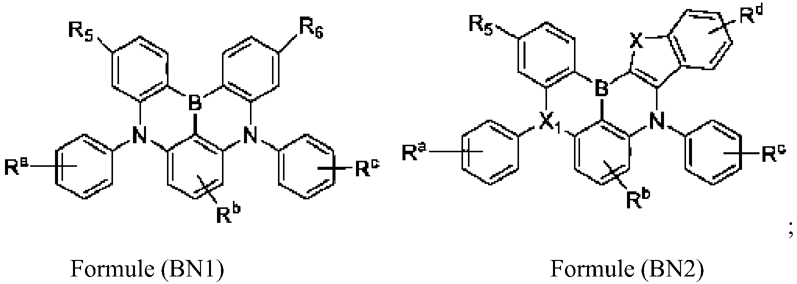
où X représente O, S, Se ou NR³⁰⁰, et X₁ représente Se ou N ;
R^{a}-R^{d} sont chacun représentés indépendamment comme une mono-substitution, bi-substitution, trisubstitution, tétra-substitution ou non-substitution; R^{a}-R^{d} sont chacun sélectionnés indépendamment parmi le groupe composé d'hydrogène, de deutérium, N, d'un alkyle C1-C30 et d'un aryle C6-C60 ; et
R₅ et R₆ sont sélectionnés indépendamment parmi le groupe constitué d'un groupe diphénylamine substitué ou non substitué, et d'un groupe carbazole substitué ou non-substitué ; lorsqu'un substituant est présent, celui-ci est sélectionné parmi le groupe constitué du deutérium, d'un alkyle C1-C30 et d'un aryle C6-C30.

8. Dispositif électroluminescent organique selon la revendication 5, dans lequel le matériau dopé fluorescent possède l'une des structures chimiques suivantes, où Ph représente un groupe phényle :

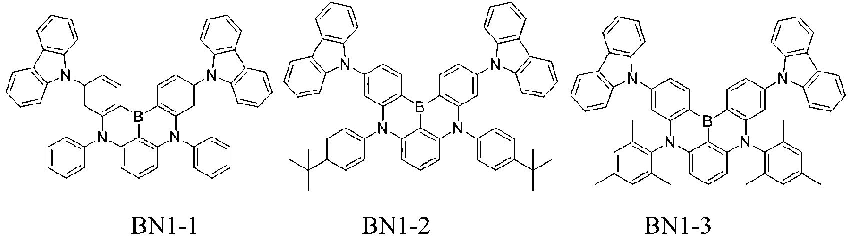

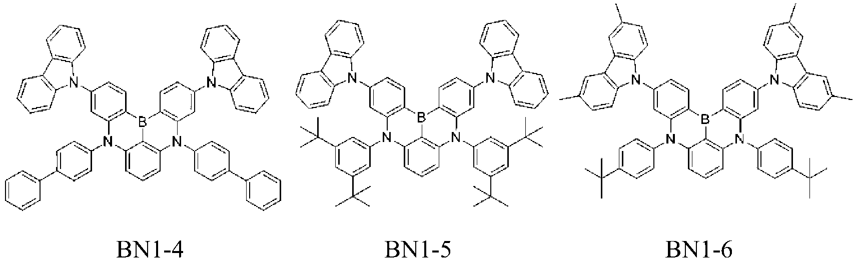

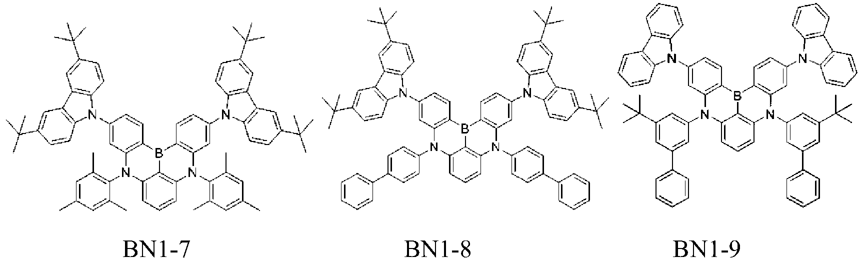

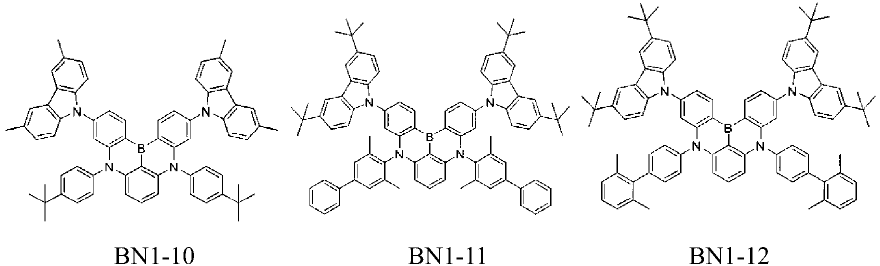

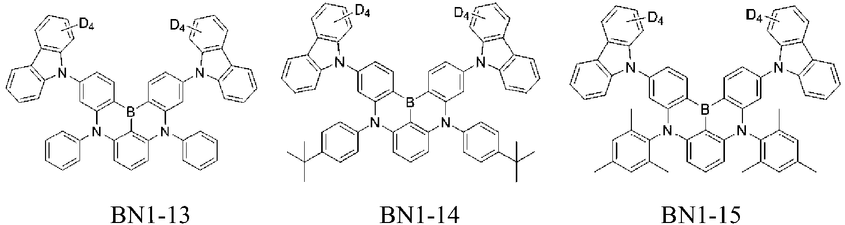

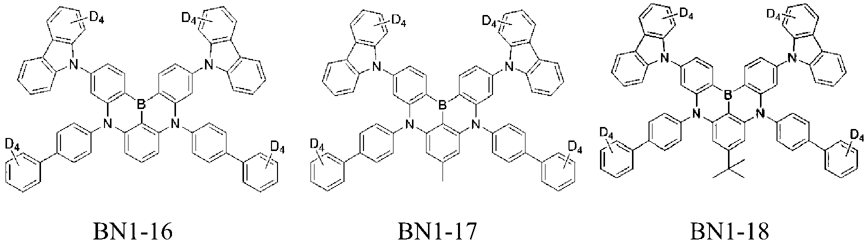

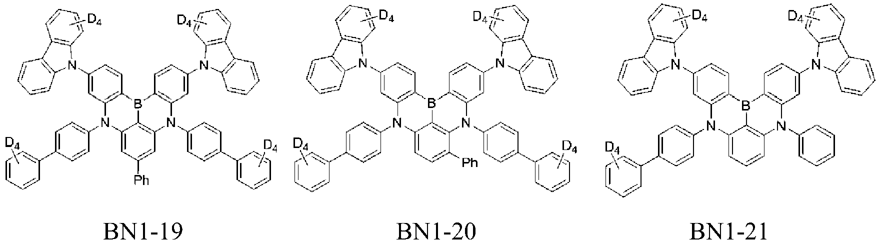

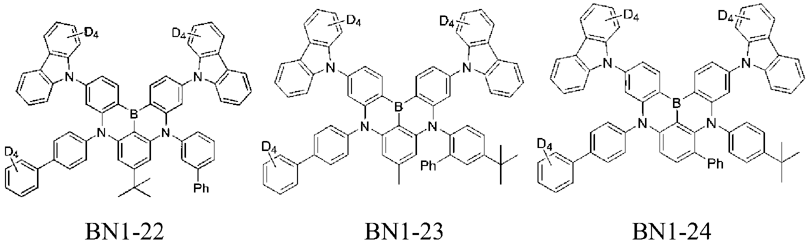

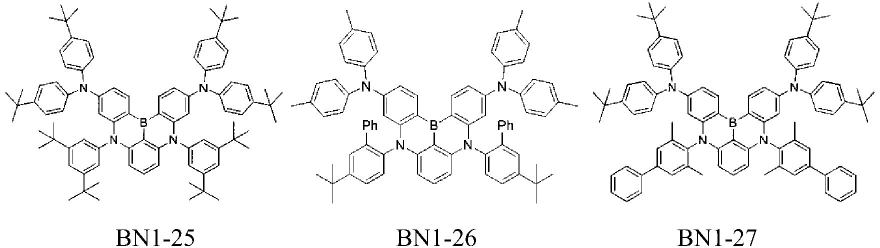

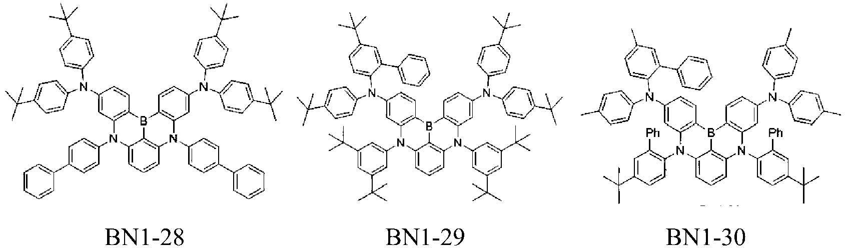

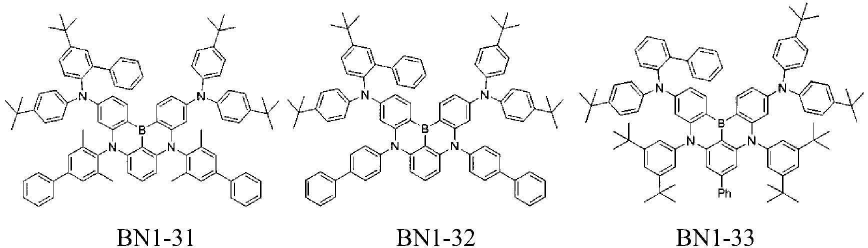

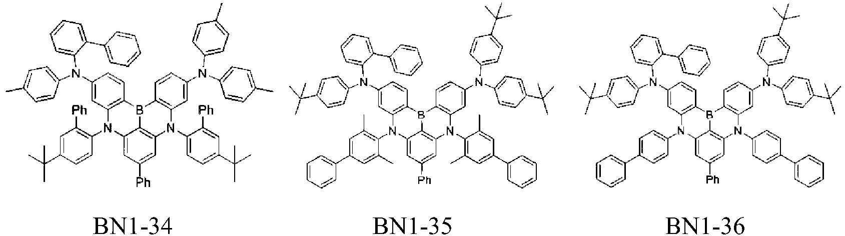

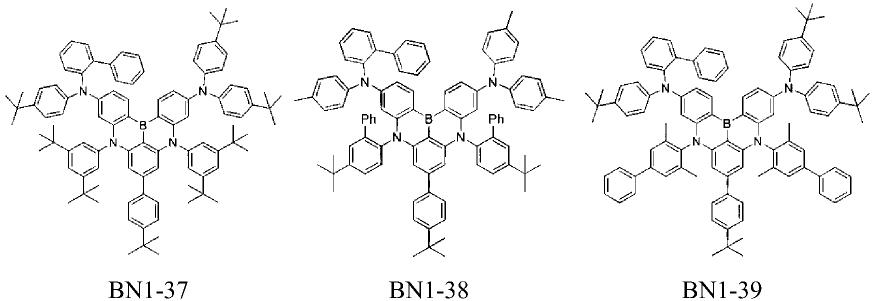

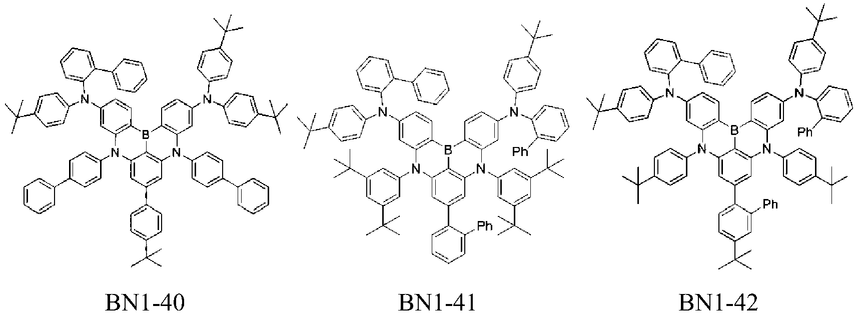

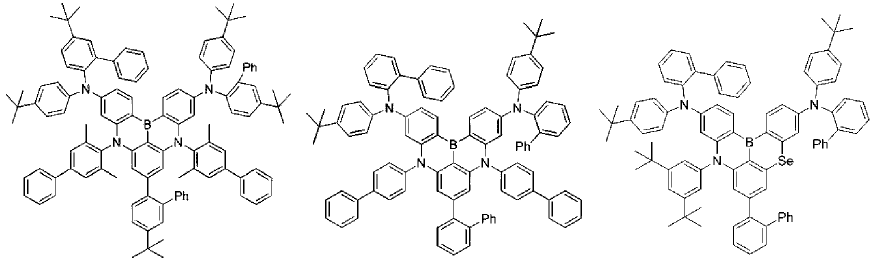

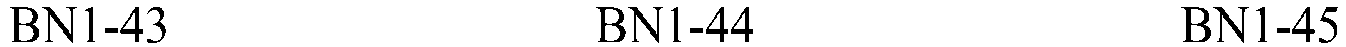

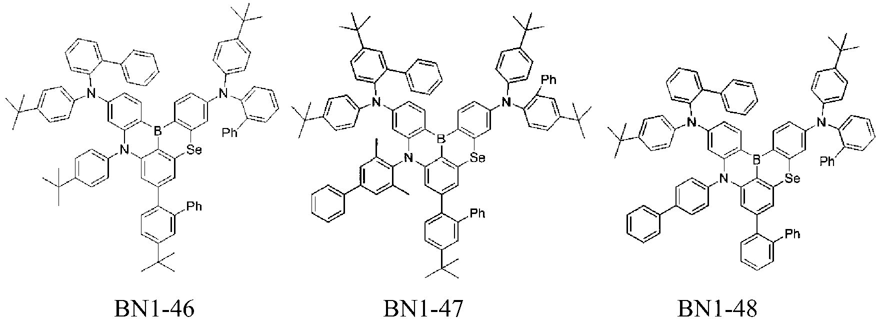

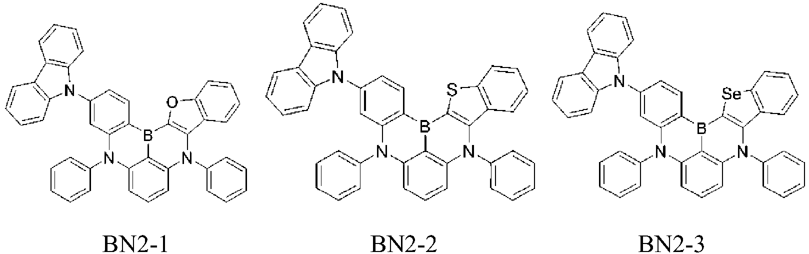

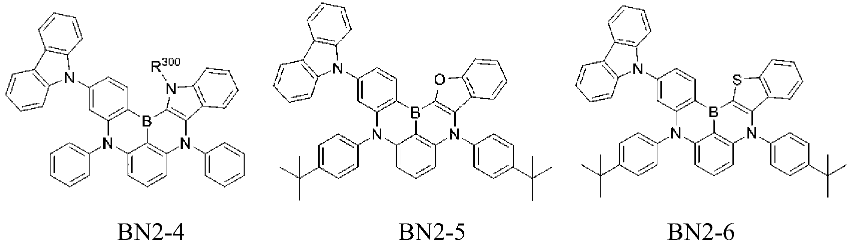

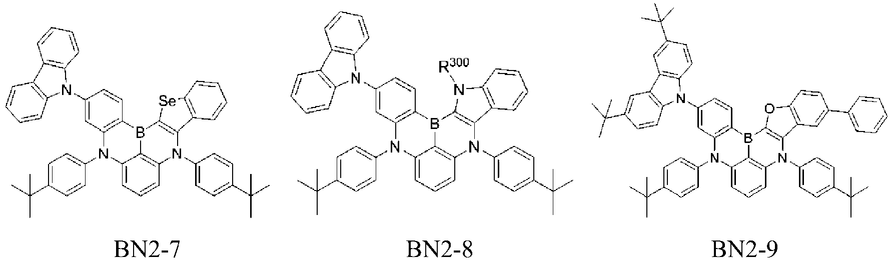

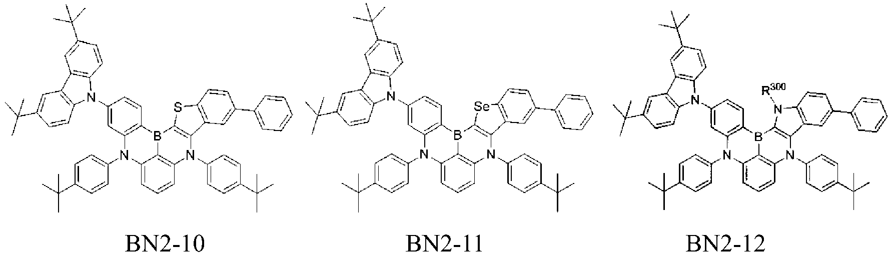

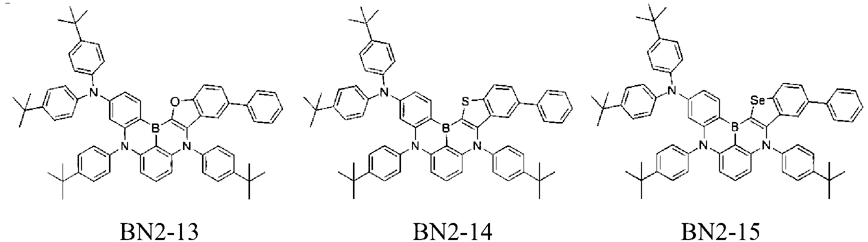

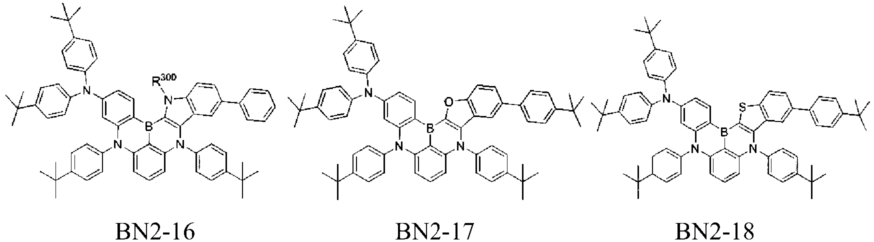

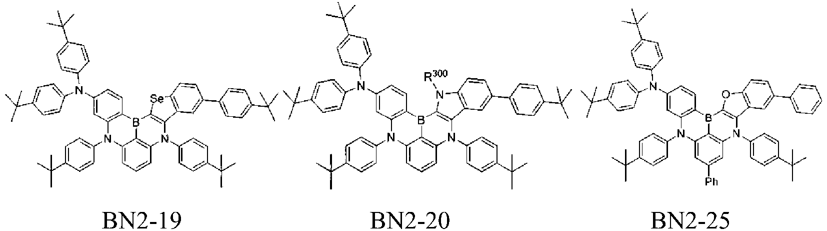

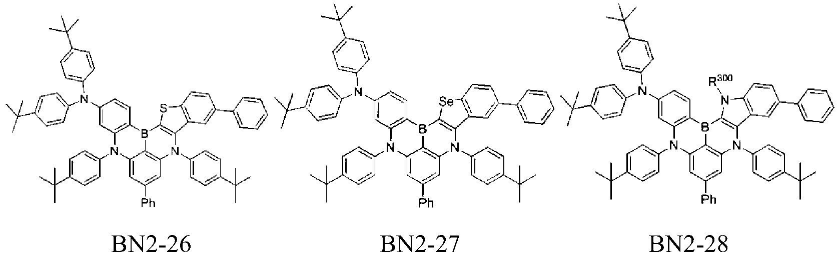

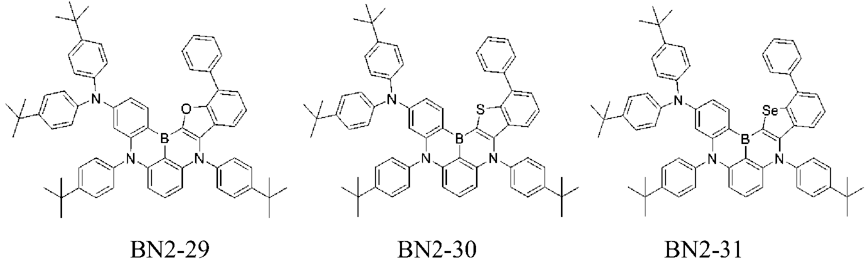

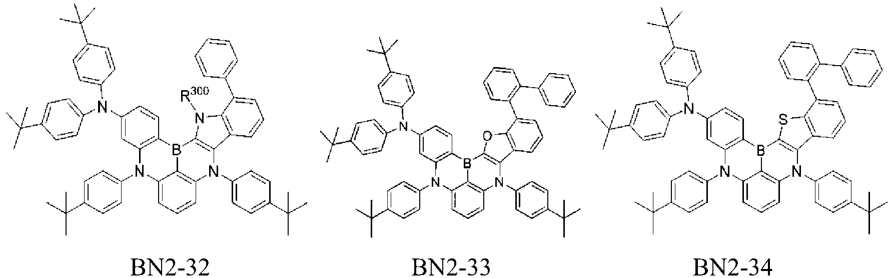

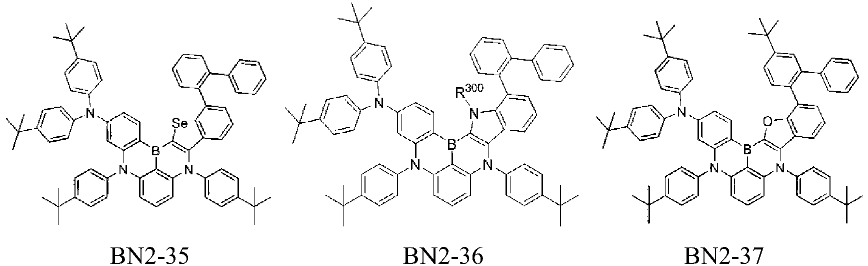

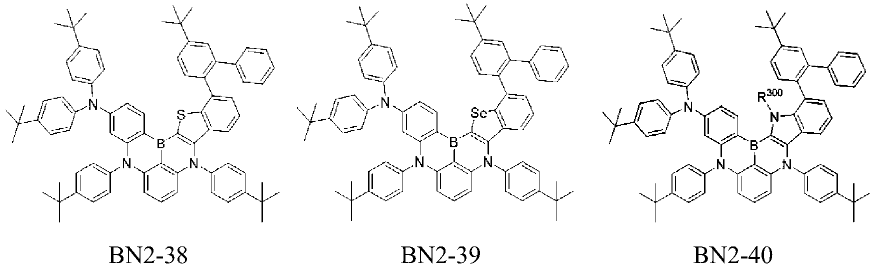

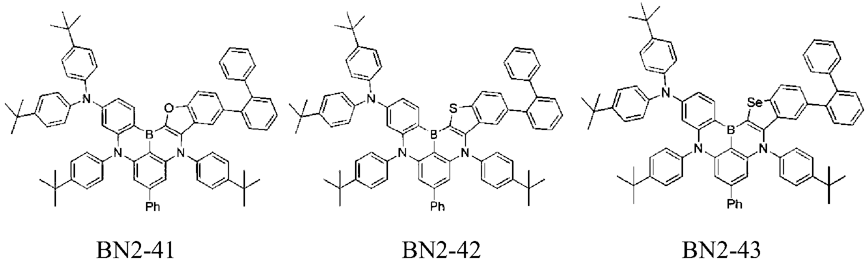

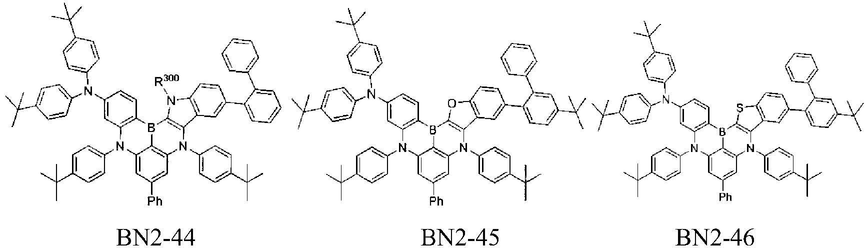

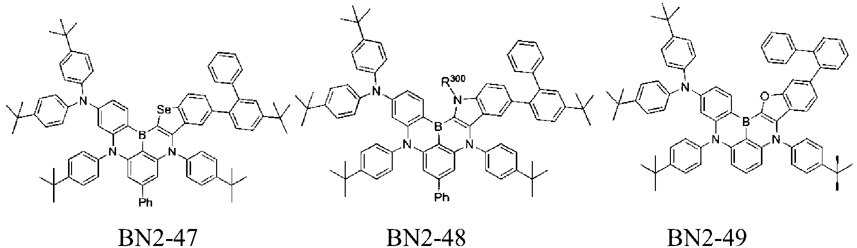

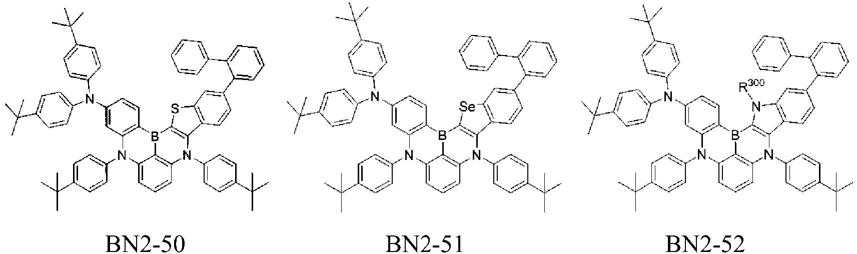

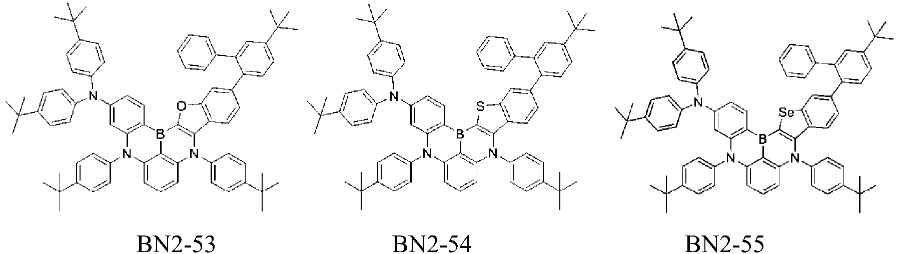

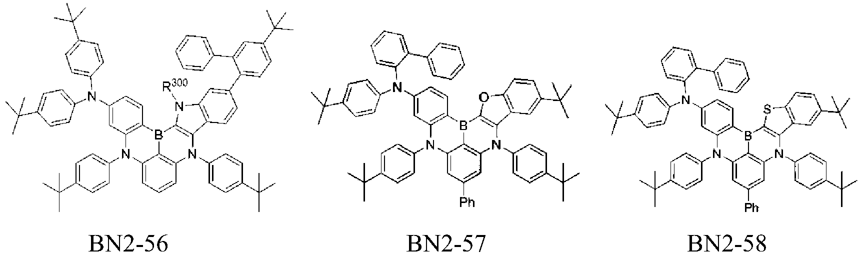

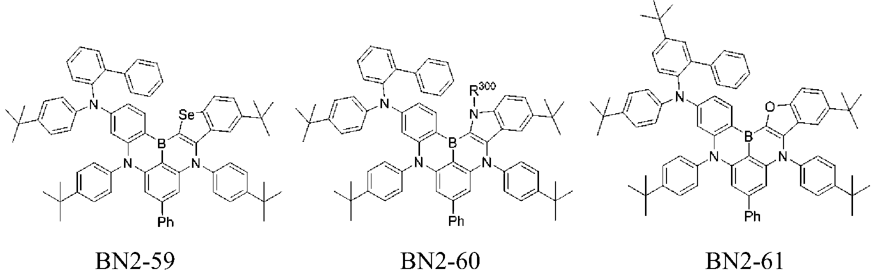

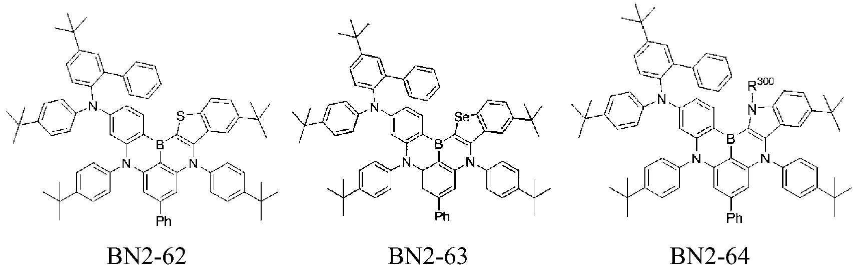

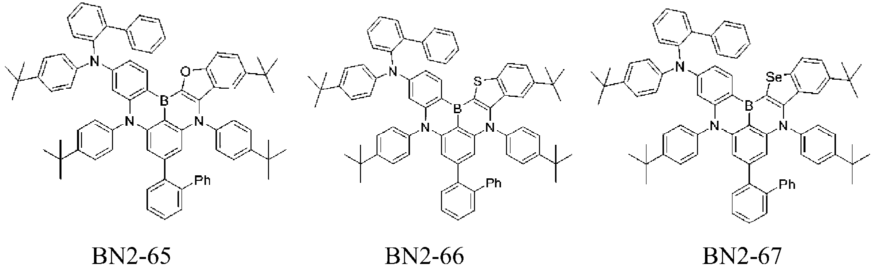

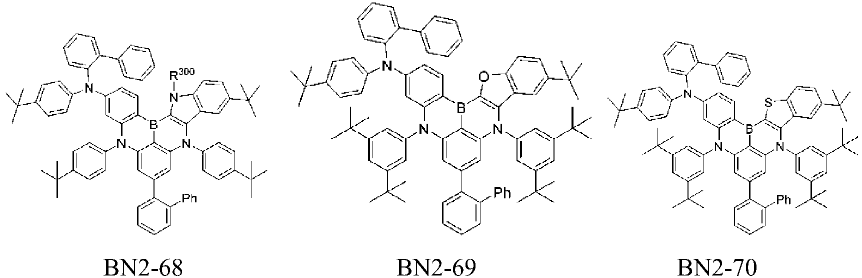

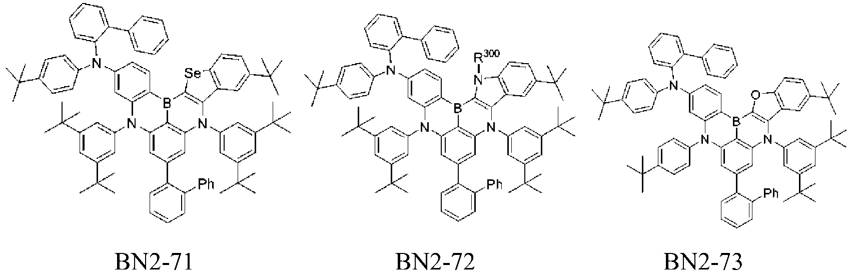

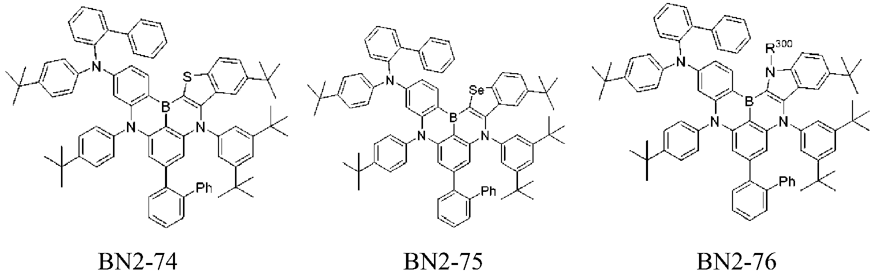

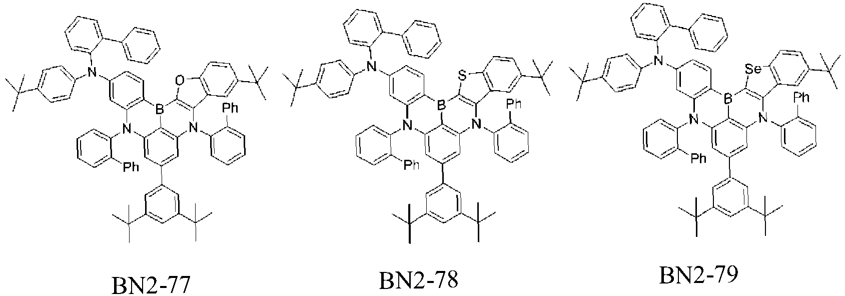

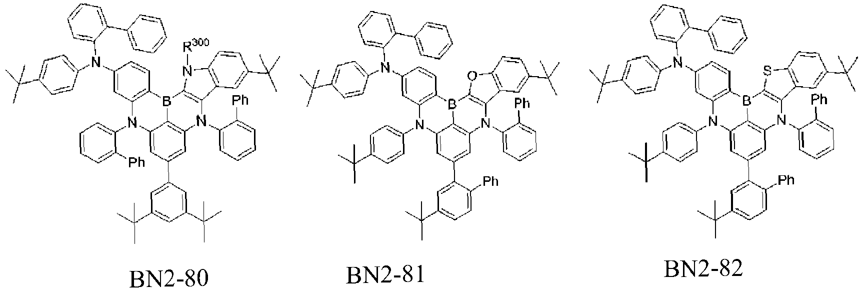

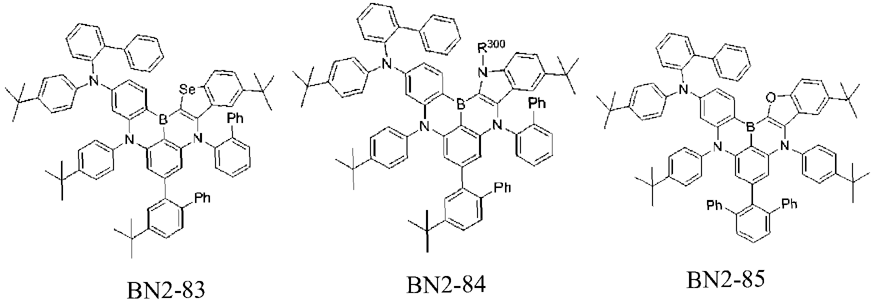

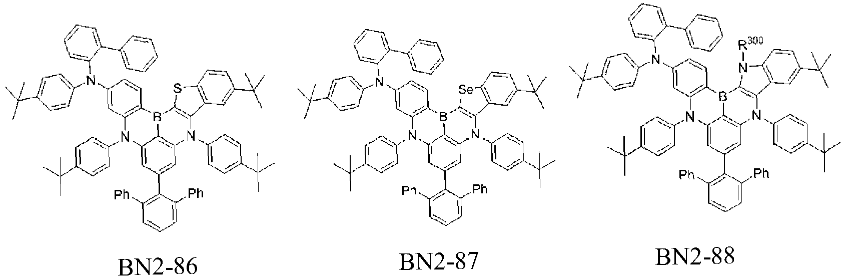

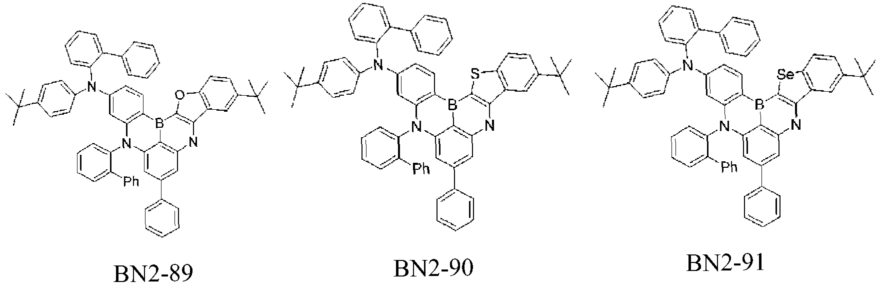

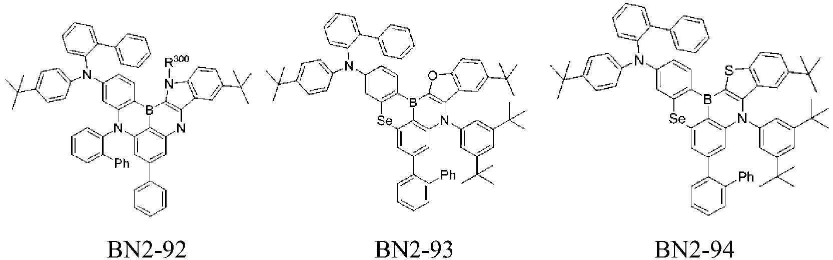

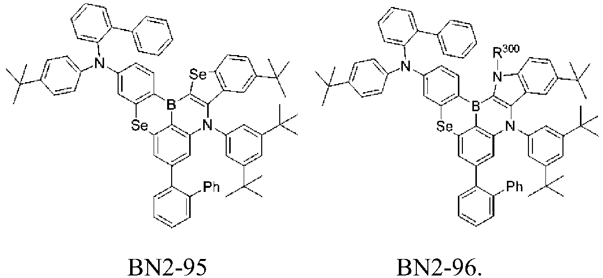

9. Dispositif optoélectronique organique, dans lequel l'appareil optoélectronique organique comprend : une couche de substrat ; une première électrode, la première électrode se trouvant au-dessus du substrat ; une couche fonctionnelle luminescente organique, la couche fonctionnelle luminescente se trouvant au-dessus de la première électrode ; une deuxième électrode, la deuxième électrode se trouvant au-dessus de la couche fonctionnelle luminescente organique ; la couche fonctionnelle luminescente organique comprenant le complexe de platine tétradentate fluoré (II) selon la revendication 1 ou 2.

10. Dispositif optoélectronique organique selon la revendication 9, dans lequel la couche fonctionnelle luminescente organique comprend en outre un matériau dopé fluorescent ; le matériau dopé fluorescent est un composé représenté par la formule (BN1) ou la formule (BN2) : 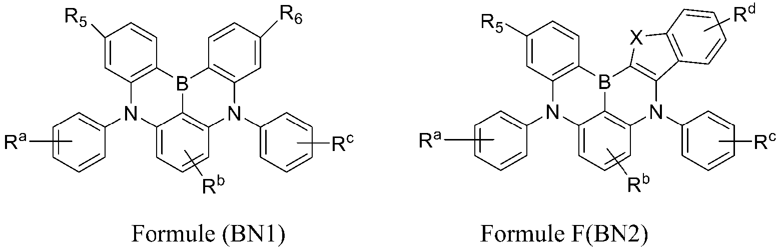
où X représente O, S, Se ou NR³⁰⁰, et X₁ représente Se ou N ;
R^{a}-R^{d} sont chacun représentés indépendamment comme mono-substitution, bi-substitution, tri-substitution, tétra-substitution ou non-substitution ; R^{a}-R^{d} sont chacun sélectionnés indépendamment parmi le groupe composé d'hydrogène, de deutérium, N, d'un alkyle C1-C30 et d'un aryle C6-C60 ; et
R₅ et R₆ sont chacun sélectionnés indépendamment dans le groupe constitué d'un groupe diphénylamine substitué ou non-substitué, et d'un groupe carbazole substitué ou non-substitué ; lorsqu'un substituant est présent, celui-ci est sélectionné parmi le groupe constitué du deutérium, d'un alkyle C1-C30 et d'un aryle C6-C30.

11. Composition comprenant le complexe de platine tétradentate fluoré (II) selon la revendication 1 ou 2.

12. Dispositif comprenant le complexe de platine tétradentate fluoré (II) selon la revendication 1 ou 2.

13. Équipement d'affichage ou d'éclairage, dans lequel l'équipement comprend un ou plusieurs dispositifs électroluminescents organiques selon l'une des revendications 5 à 8.
